# EUROPEAN PATENT SPECIFICATION

(11) **EP 4 001 287 B1**
(45) Date of publication and mention of the grant of the patent: **17.01.2024**
(21) Application number: 21209946.9
(22) Date of filing: 23.11.2021
(51) Int. Cl.: C07F 15/00, H10K 85/30

(54) **ORGANIC ELECTROLUMINESCENT MATERIALS AND DEVICES**
ORGANISCHE ELEKTROLUMINESZENTE MATERIALIEN UND VORRICHTUNGEN
MATÉRIAUX ET DISPOSITIFS ÉLECTROLUMINESCENTS ORGANIQUES

(30) Priority: 24.11.2020 US 202063117727 P; 26.02.2021 US 202163154188 P; 31.03.2021 US 202163168419 P; 24.05.2021 US 202163192228 P; 01.11.2021 US 202117516647
(43) Date of publication of application: 25.05.2022
(73) Proprietor: Universal Display Corporation, Ewing, NJ 08618 (US)
(72) Inventor: JI, Zhiqiang, Ewing, NJ 08618 (US); LU, Tongxiang, Ewing, NJ 08618 (US); SHIH, Wei-Chun, Ewing, NJ 08618 (US); BOUDREAULT, Pierre-Luc T., Ewing, NJ 08618 (US); FITZGERALD, George, Ewing, NJ 08618 (US)
(74) Representative: Maiwald GmbH

(56) References cited:
- CN-A- 107 474 075
- CN-A- 107 501 335
- CN-A- 107 573 386

## Description

### FIELD

The present disclosure generally relates to organometallic compounds and formulations and their various uses including as emitters in devices such as organic light emitting diodes and related electronic devices.

### BACKGROUND

Opto-electronic devices that make use of organic materials are becoming increasingly desirable for various reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials.

OLEDs make use of thin organic films that emit light when voltage is applied across the device. OLEDs are becoming an increasingly interesting technology for use in applications such as flat panel displays, illumination, and backlighting.

One application for phosphorescent emissive molecules is a full color display. Industry standards for such a display call for pixels adapted to emit particular colors, referred to as "saturated" colors. In particular, these standards call for saturated red, green, and blue pixels. Alternatively, the OLED can be designed to emit white light. In conventional liquid crystal displays emission from a white backlight is filtered using absorption filters to produce red, green and blue emission. The same technique can also be used with OLEDs. The white OLED can be either a single emissive layer (EML) device or a stack structure. Color may be measured using CIE coordinates, which are well known to the art. CN 107474075 A and CN 107501335 A relate to transition metal complexes used as phosphorescent materials, as well as preparation methods and applications thereof. CN107573386 A discloses iridium complexes containing thieno-[2,3-d] pyrimidine group and their application in electroluminescence devices.

### SUMMARY

In one aspect, the present disclosure provides organometallic complexes comprising 5-membered heterocyclic rings. These complexes can be used as emissive dopants in OLEDs to show narrow emission compared to the analogues with phenyl substituent. The narrow emission bands for these complexes arise from the small geometry changes at the corresponding excited states. The predicted B peak heights for these analogs are inversely proportional to the largest bond length change for each dopant. Preferably, the largest bond length changes for these compounds at the excited states should be less than or equal to 0.7 Å.

In some embodiments, the compound comprises a ligand L_{A} of a structure of Formula I, 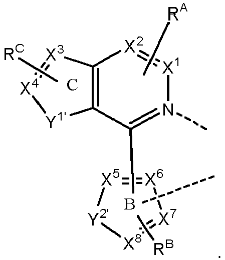 In the structure of Formula I:
each of X¹, X², X³, X⁴, X⁵, X⁶, X⁷, and X⁸ is independently C or N;
each of Y^{1'} and Y^{2'} is independently selected from the group consisting of O, S, and Se;
each of R^{A}, R^{B}, and R^{C} is independently represent mono to the maximum allowable substitution, or no substitution;
each of R^{A}, R^{B}, and R^{C} is independently a hydrogen or a substituent selected from the group consisting of deuterium, halogen, alkyl, cycloalkyl, heteroalkyl, heterocycloalkyl, boryl, selenyl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof;
L_{A} is coordinated to metal M through the indicated dashed lines to form a 5-membered chelate ring;
metal M is selected from the group consisting of Ru, Os, Ir, Pd, Pt, Cu, Ag, and Au;
Ring B is coordinated to M by a C-M bond;
M may be coordinated to other ligands;
L_{A} can be joined with other ligands to form a tridentate, tetradentate, pentadentate, or hexadentate ligand; and
any two adjacent R^{A} and R^{C} can be joined or fused to form a ring.

### BRIEF DESCRIPTION OF THE DRAWINGS

FIG. 1 shows an organic light emitting device.
FIG. 2 shows an inverted organic light emitting device that does not have a separate electron transport layer.

### DETAILED DESCRIPTION

### A. Terminology

Unless otherwise specified, the below terms used herein are defined as follows:
As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

The terms "halo," "halogen," and "halide" are used interchangeably and refer to fluorine, chlorine, bromine, and iodine.

The term "acyl" refers to a substituted carbonyl radical (C(O)-Rₛ).

The term "ester" refers to a substituted oxycarbonyl (-O-C(O)-Rₛ or -C(O)-O-Rₛ) radical.

The term "ether" refers to an -ORₛ radical.

The terms "sulfanyl" or "thio-ether" are used interchangeably and refer to a -SRₛ radical.

The term "selenyl" refers to a-SeRₛ radical.

The term "sulfinyl" refers to a -S(O)-Rₛ radical.

The term "sulfonyl" refers to a -SO₂-Rₛ radical.

The term "phosphino" refers to a -P(Rₛ)₃ radical, wherein each Rₛ can be same or different.

The term "silyl" refers to a-Si(Rₛ)₃ radical, wherein each Rₛ can be same or different.

The term "germyl" refers to a-Ge(Rₛ)₃ radical, wherein each Rₛ can be same or different.

The term "boryl" refers to a -B(Rₛ)₂ radical or its Lewis adduct -B (Rₛ)₃ radical, wherein Rₛ can be same or different.

In each of the above, Rₛ can be hydrogen or a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. Preferred Rₛ is selected from the group consisting of alkyl, cycloalkyl, aryl, heteroaryl, and combination thereof.

The term "alkyl" refers to and includes both straight and branched chain alkyl radicals. Preferred alkyl groups are those containing from one to fifteen carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group may be optionally substituted.

The term "cycloalkyl" refers to and includes monocyclic, polycyclic, and spiro alkyl radicals. Preferred cycloalkyl groups are those containing 3 to 12 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group maybe optionally substituted.

The terms "heteroalkyl" or "heterocycloalkyl" refer to an alkyl or a cycloalkyl radical, respectively, having at least one carbon atom replaced by a heteroatom. Optionally the at least one heteroatom is selected from O, S, N, P, B, Si and Se, preferably, O, S or N. Additionally, the heteroalkyl or heterocycloalkyl group may be optionally substituted.

The term "alkenyl" refers to and includes both straight and branched chain alkene radicals. Alkenyl groups are essentially alkyl groups that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl radical having at least one carbon atom replaced by a heteroatom. Optionally the at least one heteroatom is selected from O, S, N, P, B, Si, and Se, preferably, O, S, or N. Preferred alkenyl, cycloalkenyl, or heteroalkenyl groups are those containing two to fifteen carbon atoms. Additionally, the alkenyl, cycloalkenyl, or heteroalkenyl group may be optionally substituted.

The term "alkynyl" refers to and includes both straight and branched chain alkyne radicals. Alkynyl groups are essentially alkyl groups that include at least one carbon-carbon triple bond in the alkyl chain. Preferred alkynyl groups are those containing two to fifteen carbon atoms. Additionally, the alkynyl group may be optionally substituted.

The terms "aralkyl" or "arylalkyl" are used interchangeably and refer to an alkyl group that is substituted with an aryl group. Additionally, the aralkyl group may be optionally substituted.

The term "heterocyclic group" refers to and includes aromatic and non-aromatic cyclic radicals containing at least one heteroatom. Optionally the at least one heteroatom is selected from O, S, N, P, B, Si, and Se, preferably, O, S, or N. Heteroaromatic cyclic radicals may be used interchangeably with heteroaryl. Preferred hetero-non-aromatic cyclic groups are those containing 3 to 7 ring atoms which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group may be optionally substituted.

The term "aryl" refers to and includes both single-ring aromatic hydrocarbyl groups and polycyclic aromatic ring systems. The polycyclic rings may have two or more rings in which two carbons are common to two adjoining rings (the rings are "fused") wherein at least one of the rings is an aromatic hydrocarbyl group, e.g., the other rings can be cycloalkyls, cycloalkenyls, aryl, heterocycles, and/or heteroaryls. Preferred aryl groups are those containing six to thirty carbon atoms, preferably six to twenty carbon atoms, more preferably six to twelve carbon atoms. Especially preferred is an aryl group having six carbons, ten carbons or twelve carbons. Suitable aryl groups include phenyl, biphenyl, triphenyl, triphenylene, tetraphenylene, naphthalene, anthracene, phenalene, phenanthrene, fluorene, pyrene, chrysene, perylene, and azulene, preferably phenyl, biphenyl, triphenyl, triphenylene, fluorene, and naphthalene. Additionally, the aryl group may be optionally substituted.

The term "heteroaryl" refers to and includes both single-ring aromatic groups and polycyclic aromatic ring systems that include at least one heteroatom. The heteroatoms include, but are not limited to O, S, N, P, B, Si, and Se. In many instances, O, S, or N are the preferred heteroatoms. Hetero-single ring aromatic systems are preferably single rings with 5 or 6 ring atoms, and the ring can have from one to six heteroatoms. The hetero-polycyclic ring systems can have two or more rings in which two atoms are common to two adjoining rings (the rings are "fused") wherein at least one of the rings is a heteroaryl, e.g., the other rings can be cycloalkyls, cycloalkenyls, aryl, heterocycles, and/or heteroaryls. The hetero-polycyclic aromatic ring systems can have from one to six heteroatoms per ring of the polycyclic aromatic ring system. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group may be optionally substituted.

Of the aryl and heteroaryl groups listed above, the groups of triphenylene, naphthalene, anthracene, dibenzothiophene, dibenzofuran, dibenzoselenophene, carbazole, indolocarbazole, imidazole, pyridine, pyrazine, pyrimidine, triazine, and benzimidazole, and the respective aza-analogs of each thereof are of particular interest.

The terms alkyl, cycloalkyl, heteroalkyl, heterocycloalkyl, alkenyl, cycloalkenyl, heteroalkenyl, alkynyl, aralkyl, heterocyclic group, aryl, and heteroaryl, as used herein, are independently unsubstituted, or independently substituted, with one or more general substituents.

In many instances, the general substituents are selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, and combinations thereof.

In some instances, the preferred general substituents are selected from the group consisting of deuterium, fluorine, alkyl, cycloalkyl, heteroalkyl, alkoxy, aryloxy, amino, silyl, alkenyl, cycloalkenyl, heteroalkenyl, aryl, heteroaryl, nitrile, isonitrile, sulfanyl, selenyl, and combinations thereof.

In some instances, the more preferred general substituents are selected from the group consisting of deuterium, fluorine, alkyl, cycloalkyl, alkoxy, aryloxy, amino, silyl, boryl, aryl, heteroaryl, sulfanyl, and combinations thereof.

In yet other instances, the most preferred general substituents are selected from the group consisting of deuterium, fluorine, alkyl, cycloalkyl, aryl, heteroaryl, and combinations thereof.

The terms "substituted" and "substitution" refer to a substituent other than H that is bonded to the relevant position, e.g., a carbon or nitrogen. For example, when R¹ represents mono-substitution, then one R¹ must be other than H (i.e., a substitution). Similarly, when R¹ represents di-substitution, then two of R¹ must be other than H. Similarly, when R¹ represents zero or no substitution, R¹, for example, can be a hydrogen for available valencies of ring atoms, as in carbon atoms for benzene and the nitrogen atom in pyrrole, or simply represents nothing for ring atoms with fully filled valencies, e.g., the nitrogen atom in pyridine. The maximum number of substitutions possible in a ring structure will depend on the total number of available valencies in the ring atoms.

As used herein, "combinations thereof' indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include up to forty atoms that are not hydrogen or deuterium, or those that include up to thirty atoms that are not hydrogen or deuterium. In many instances, a preferred combination of substituent groups will include up to twenty atoms that are not hydrogen or deuterium.

The "aza" designation in the fragments described herein, i.e. aza-dibenzofuran, aza-dibenzothiophene, etc. means that one or more of the C-H groups in the respective aromatic ring can be replaced by a nitrogen atom, for example, and without any limitation, azatriphenylene encompasses both dibenzo[*f*,*h*]quinoxaline and dibenzo[*f*,*h*]quinoline. One of ordinary skill in the art can readily envision other nitrogen analogs of the aza-derivatives described above, and all such analogs are intended to be encompassed by the terms as set forth herein.

As used herein, "deuterium" refers to an isotope of hydrogen. Deuterated compounds can be readily prepared using methods known in the art. For example, U.S. Pat. No. 8,557,400, Patent Pub. No. WO 2006/095951, and U.S. Pat. Application Pub. No. US 2011/0037057, describe the making of deuterium-substituted organometallic complexes. Further reference is made to Ming Yan, et al., Tetrahedron 2015, 71, 1425-30 and Atzrodt et al., Angew. Chem. Int. Ed. (Reviews) 2007, 46, 7744-65, describe the deuteration of the methylene hydrogens in benzyl amines and efficient pathways to replace aromatic ring hydrogens with deuterium, respectively.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

In some instance, a pair of adjacent substituents can be optionally joined or fused into a ring. The preferred ring is a five, six, or seven-membered carbocyclic or heterocyclic ring, includes both instances where the portion of the ring formed by the pair of substituents is saturated and where the portion of the ring formed by the pair of substituents is unsaturated. As used herein, "adjacent" means that the two substituents involved can be on the same ring next to each other, or on two neighboring rings having the two closest available substitutable positions, such as 2, 2' positions in a biphenyl, or 1, 8 position in a naphthalene, as long as they can form a stable fused ring system.

### B. The Compounds of the Present Disclosure

Novel organometallic complexes with 5 membered heterocyclic rings coordinated to the metal atom are disclosed. These complexes show narrower emissions that phenyl analogs. According to simulations, it appears that the narrow emission bands for these complexes arise from the small geometry changes at the corresponding excited states. It is found that the predicted B peak heights for these analogs are inversely proportional to the largest bond length change for each dopant. Based on the unexpected results and subsequent analysis, the largest bond length changes for these compounds at the excited states should be less than or equal to 0.7 Å.

In one aspect, the present disclosure provides a compound comprising a ligand L_{A} having a structure of Formula I, 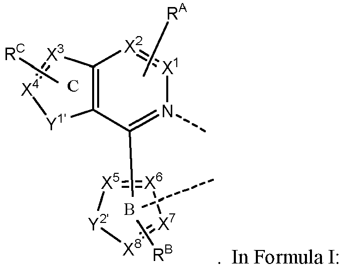
each of X¹, X², X³, X⁴, X⁵, X⁶, X⁷, and X⁸ is independently C or N;
each of Y^{1'} and Y^{2'} is independently selected from the group consisting of O, S, and Se;
each of R^{A}, R^{B}, and R^{C} is independently represent mono to the maximum allowable substitution, or no substitution;
each of R^{A}, R^{B}, and R^{C} is independently a hydrogen or a substituent selected from the group consisting of the General Substituents defined herein;
L_{A} is coordinated to metal M through the indicated dashed lines to form a 5-membered chelate ring;
metal M is selected from the group consisting of Ru, Os, Ir, Pd, Pt, Cu, Ag, and Au;
Ring B is coordinated to M by a C-M bond;
M may be coordinated to other ligands;
L_{A} can be joined with other ligands to form a tridentate, tetradentate, pentadentate, or hexadentate ligand; and
   any two adjacent R^{A} and R^{C} can be joined or fused to form a ring.

In some embodiments, each of R^{A}, R^{B}, and R^{C} is independently a hydrogen or a substituent selected from the group consisting of the Preferred General Substituents defined herein. In some embodiments, each of R^{A}, R^{B}, and R^{C} is independently a hydrogen or a substituent selected from the group consisting of the More Preferred General Substituents defined herein. In some embodiments, each of R^{A}, R^{B}, and R^{C} is independently a hydrogen or a substituent selected from the group consisting of the Most Preferred General Substituents defined herein.

In some embodiments, at least one of X¹, X², X³, X⁴, X⁵, X⁶, X⁷, and X⁸ is N.

In some embodiments, each of X¹, X², X³, X⁴, X⁵, X⁶, X⁷, and X⁸ is C.

In some embodiments, one of X¹ and X² is N. In some embodiments, one of X³ and X⁴ is N. In some embodiments, at least one of X⁵ to X⁸ is N.

In some embodiments, at least one of Y^{1'} and Y^{2'} is selected from the group consisting of O, S, and Se. In some embodiments, each of Y^{1'} and Y^{2'} is independently selected from the group consisting of O, S, and Se. In some embodiments, each of Y^{1'} and Y^{2'} is independently selected from the group consisting of O and S.

In some embodiments, X³ and X⁴ are C, and two R^{C} are joined to form a ring system fused with ring C. In such some embodiments, the ring system comprises one ring fused to ring C. In some such embodiments, the ring system comprises at least two rings fused to ring C. In some such embodiments, the ring system comprises at least three rings fused to ring C. In some such embodiments, at least one of the at least two rings fused to ring C is a 5-membered ring. In some embodiments, at least one of the at least two rings fused to ring C is a 6-membered ring.

In some embodiments, at least one R^{C} comprises alkyl or cycloalkyl comprising at least 3 carbon atoms.

In some embodiments, at least one R^{B} comprises alkyl or cycloalkyl. In some embodiments, at least one R^{B} comprises alkyl or cycloalkyl comprising at least 3 carbon atoms.

In some embodiments, the maximum number of N atoms that can connect to each other within a ring is two.

In some embodiments, ligand L_{A} has a structure of Formula II, 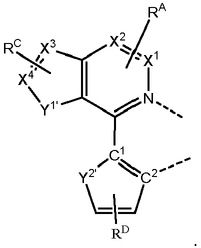 In Formula II:
wherein C¹ and C² are carbon atoms joined by a double bond;
wherein R^{D} represents mono- or di- substitution, or no substitution; and
each R^{D} is independently a hydrogen or a substituent selected from the group consisting of the General Substituents defined herein.

In some embodiments of Formula II, at least one R^{D} comprises alkyl or cycloalkyl.

In some embodiments of Formula II, at least one R^{D} comprises alkyl or cycloalkyl comprising at least 3 carbon atoms.

In some embodiments of Formula II, the C¹=C² bond distance in the compound's ground state is x; wherein the C¹=C² bond distance in the compound's first excited triplet state is y; and wherein the absolute value of the difference betweeny and x is less than or equal to 0.070 Å. In some embodiments, the absolute value of the difference between y and x is less than or equal to 0.065 Å or less than or equal to 0.060 Å.

In some embodiments, the ligand L_{A} is selected from the group consisting of the structures of the following LIST 1: 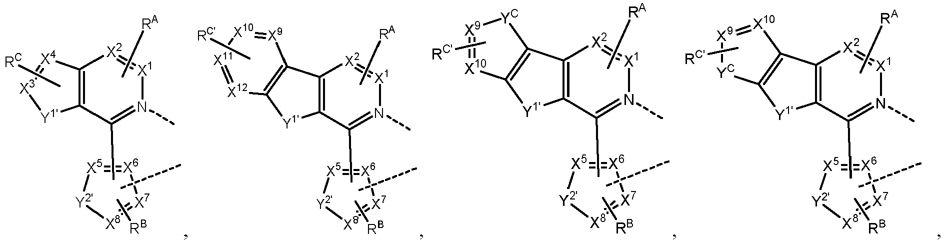 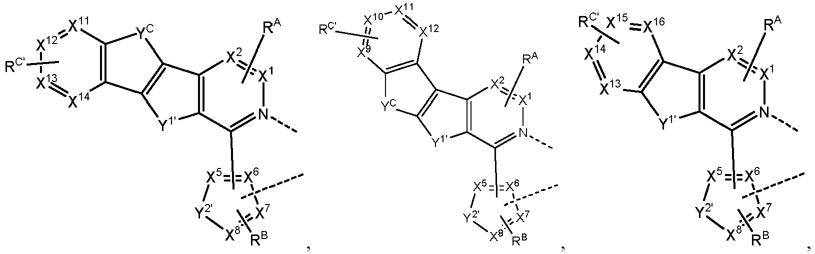 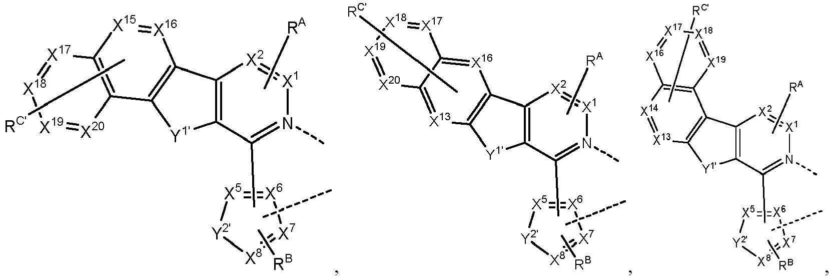 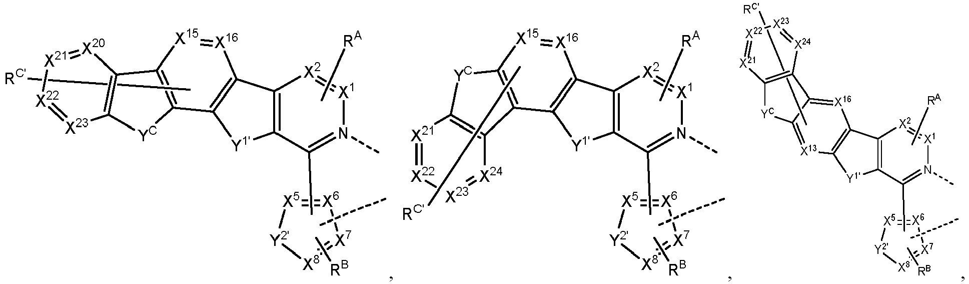 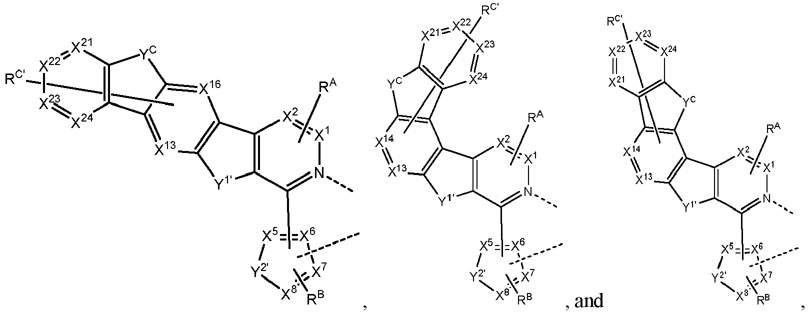 wherein
each of X⁹ to X²⁴ is independently C or N;
Y^{C} is selected from the group consisting of O, S, CR'R", SiR'R", BR', and NR';
R^{C'} represents mono to the maximum allowable substitution, or no substitution; and
each R^{C'} is independently a hydrogen or a substituent selected from the group consisting of the General Substituents defined herein.

In some embodiments, the ligand L_{A} is selected from the group consisting of L_{Ai-m-X}, wherein *i* is an integer from 1 to 2610, *m* is an integer from 1 to 108, and X is from 1 to 3, with 1 being for O, 2 for S, and 3 for Se, wherein each of L*_{Ai-1-X}* to L*_{Ai-108-X}* has the structure in the following LIST 2:

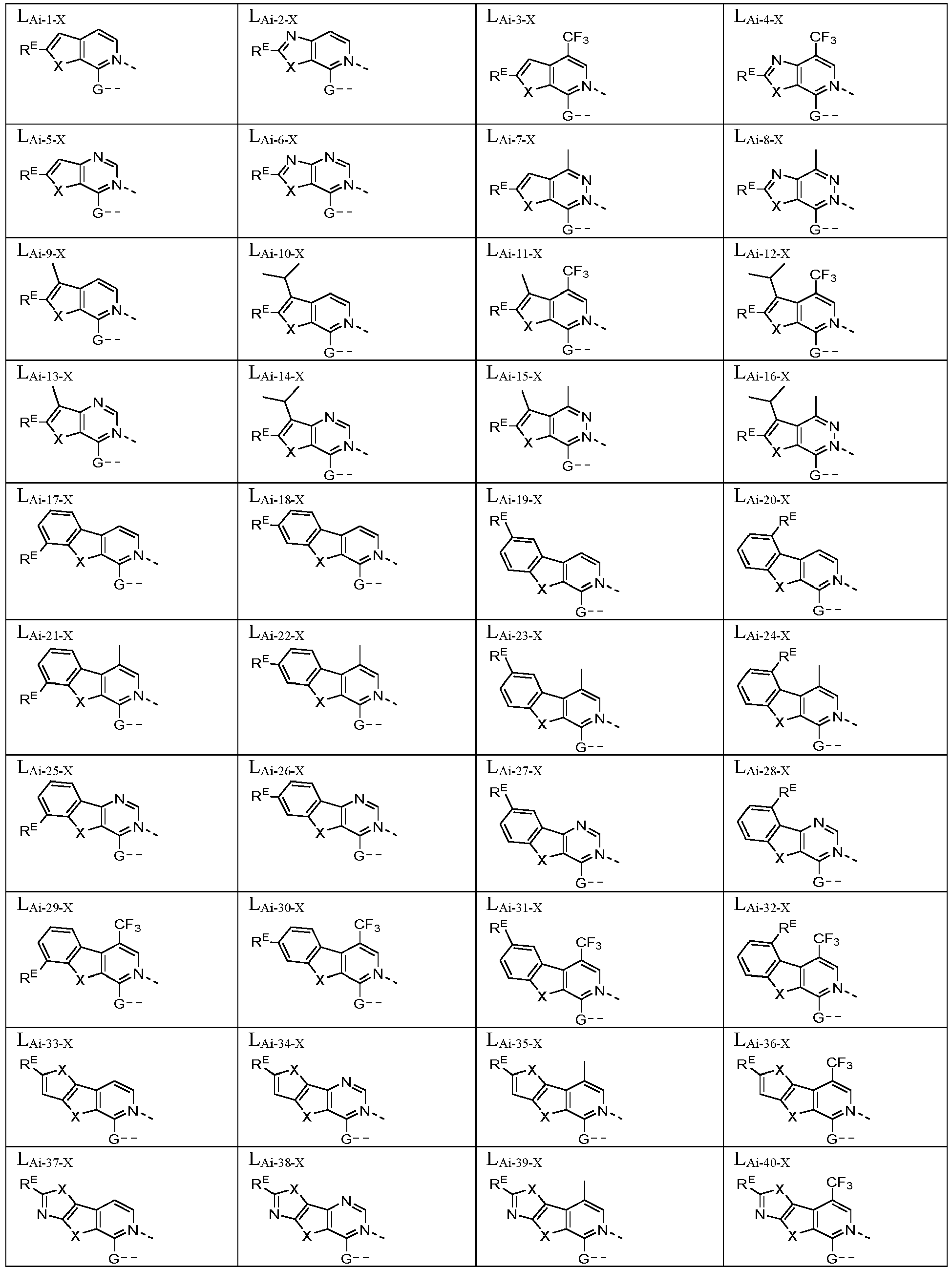

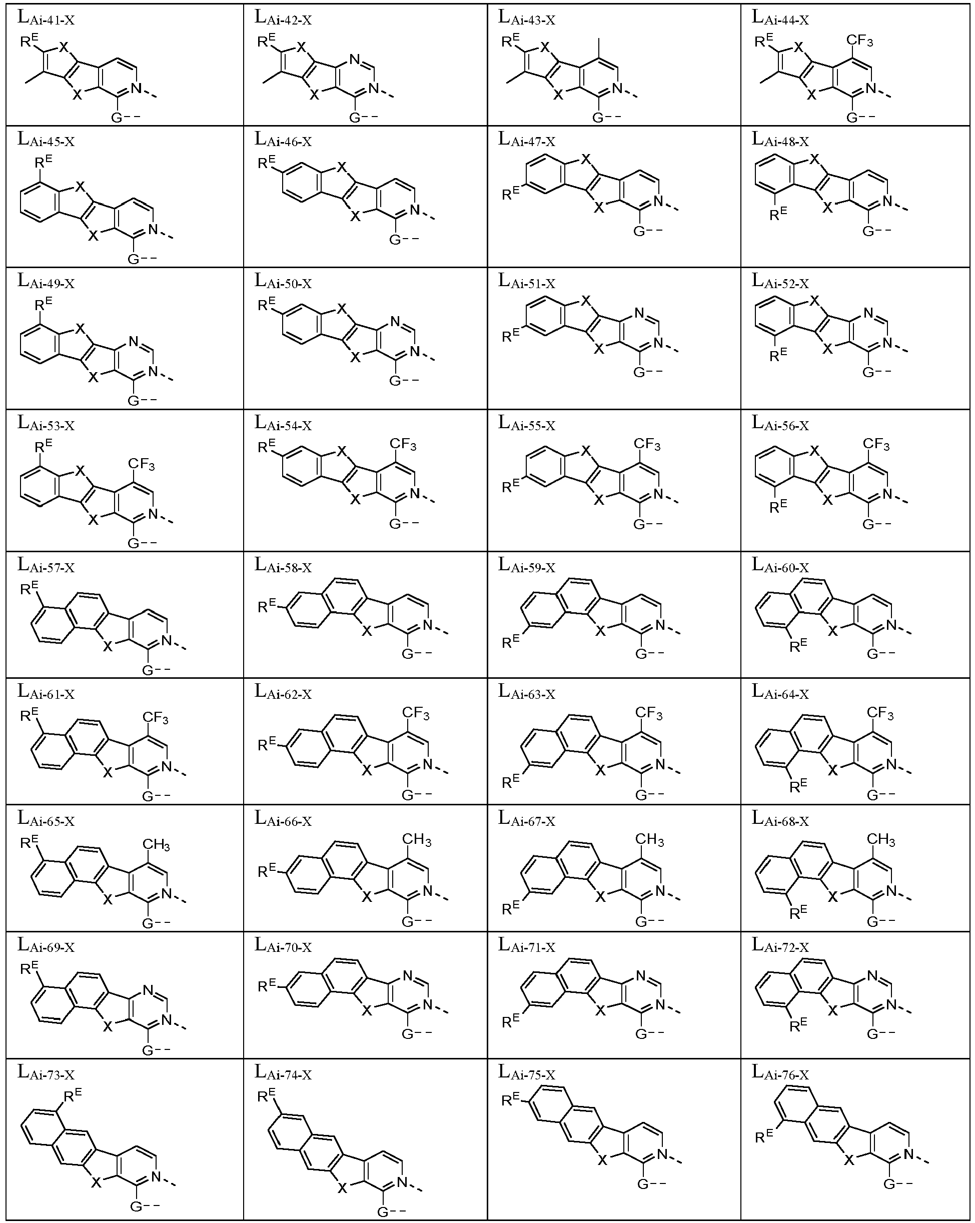

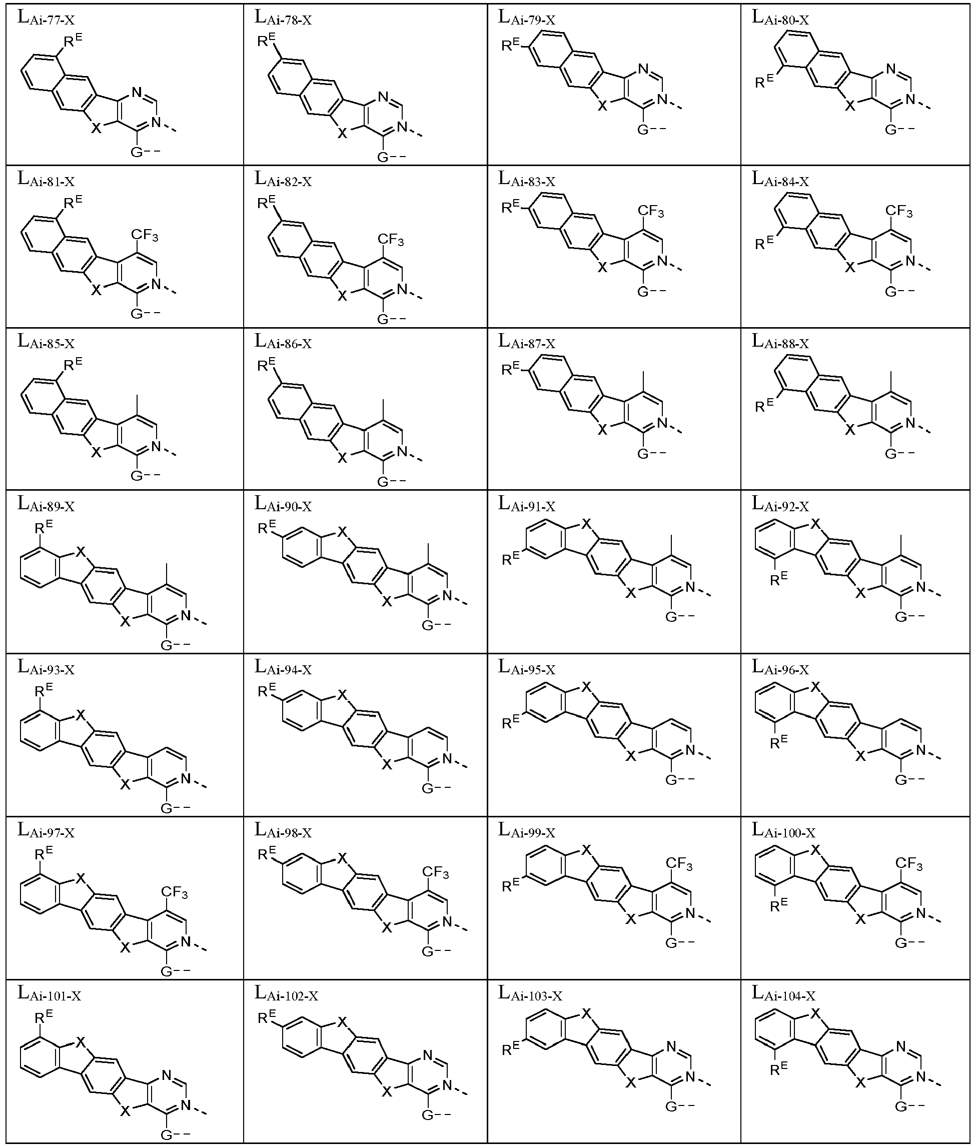

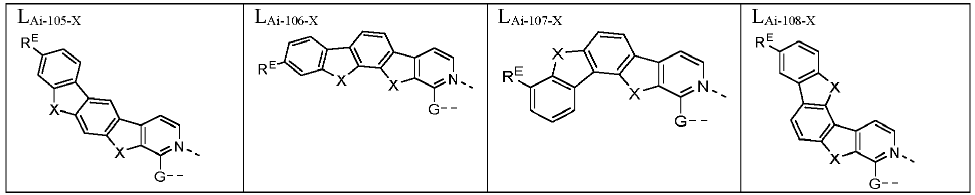

wherein for each of L_{A1} to L_{A2610}, R^{E} and G are defined in the following LIST 3:

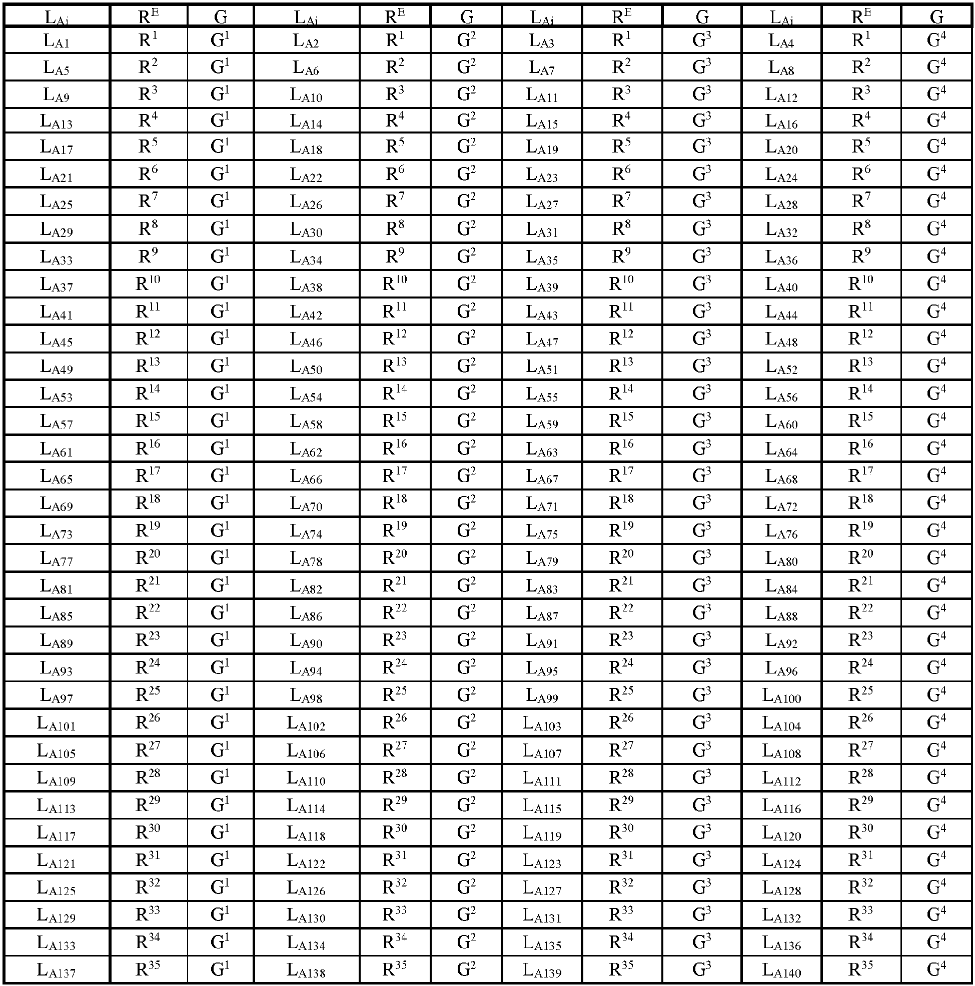

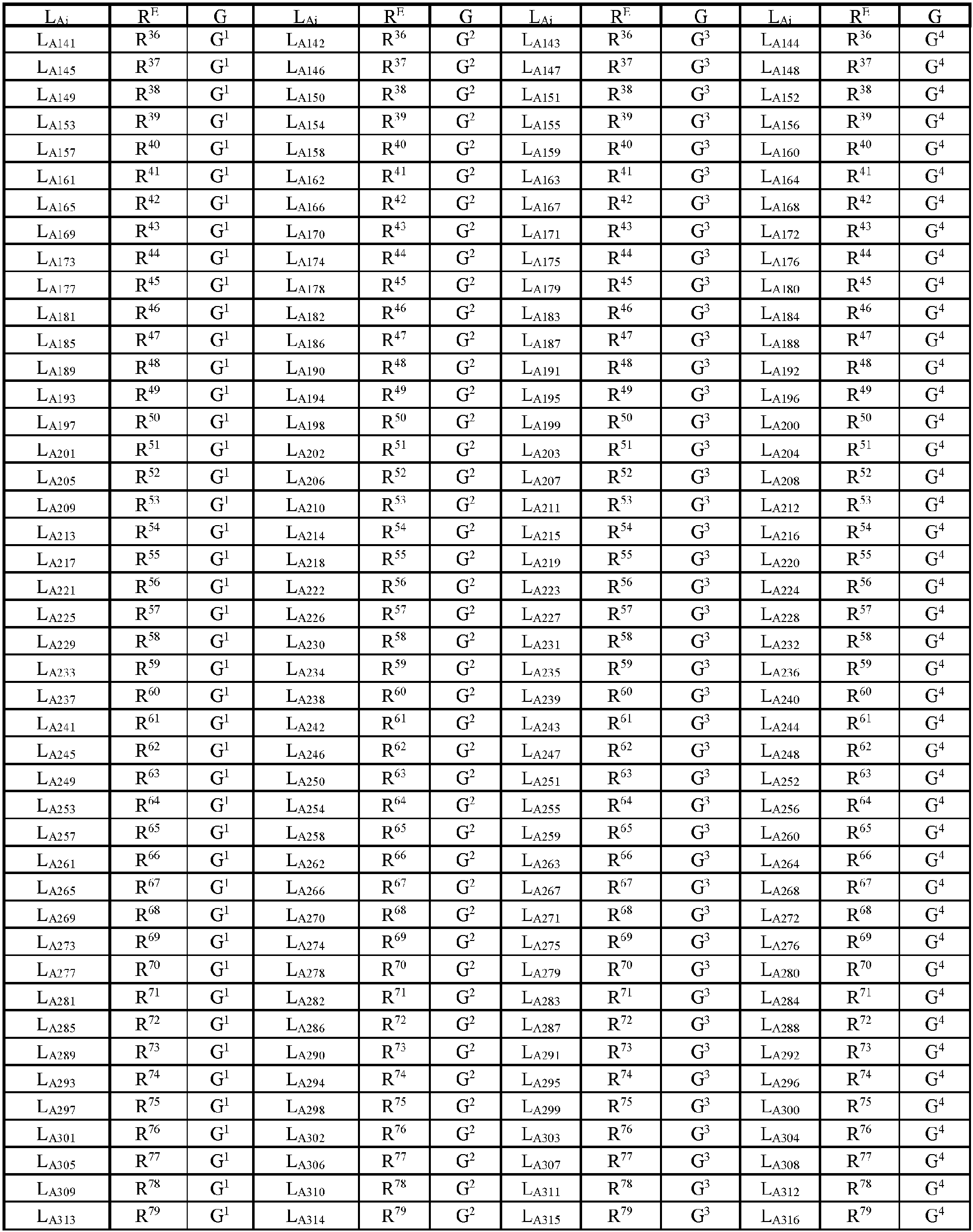

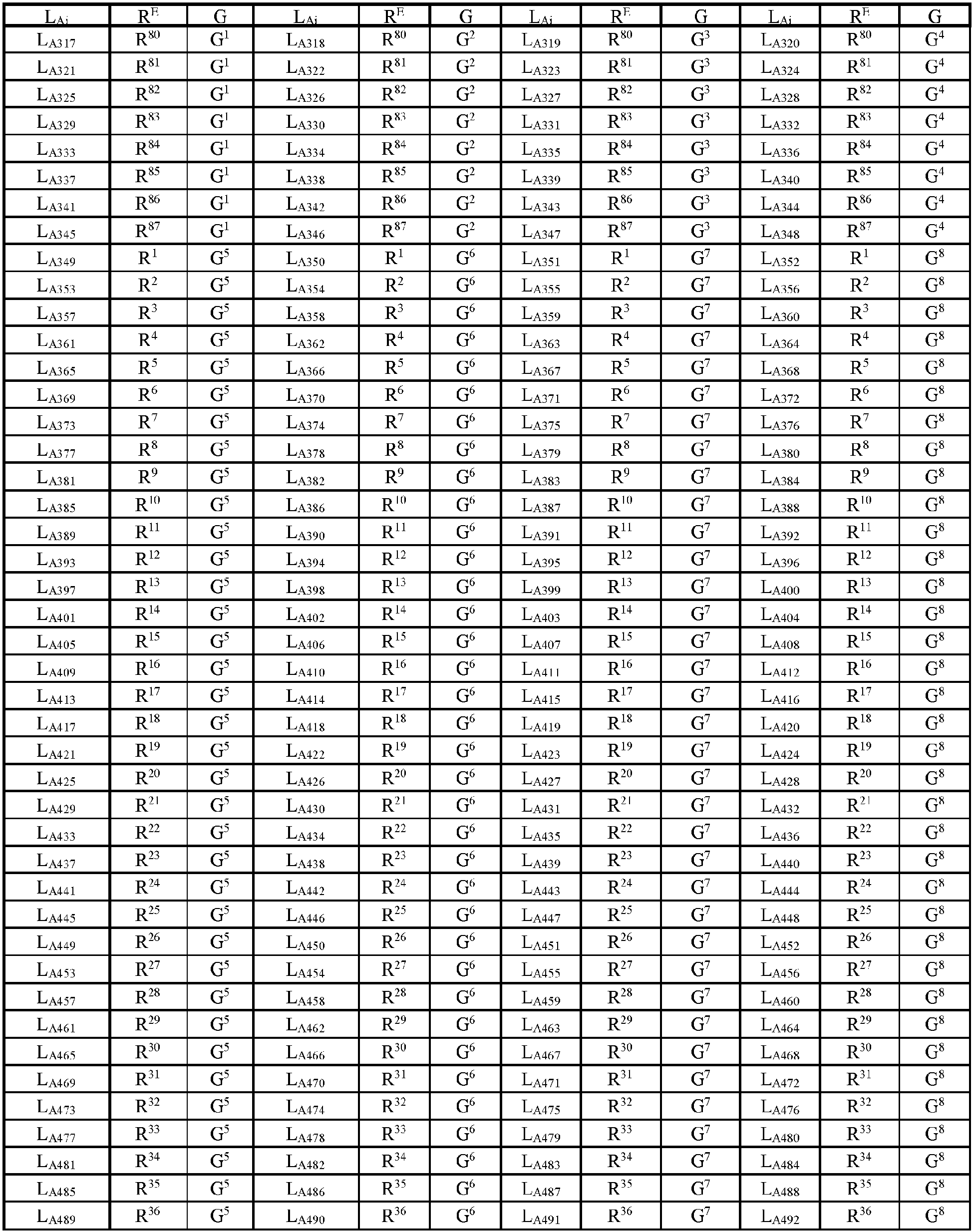

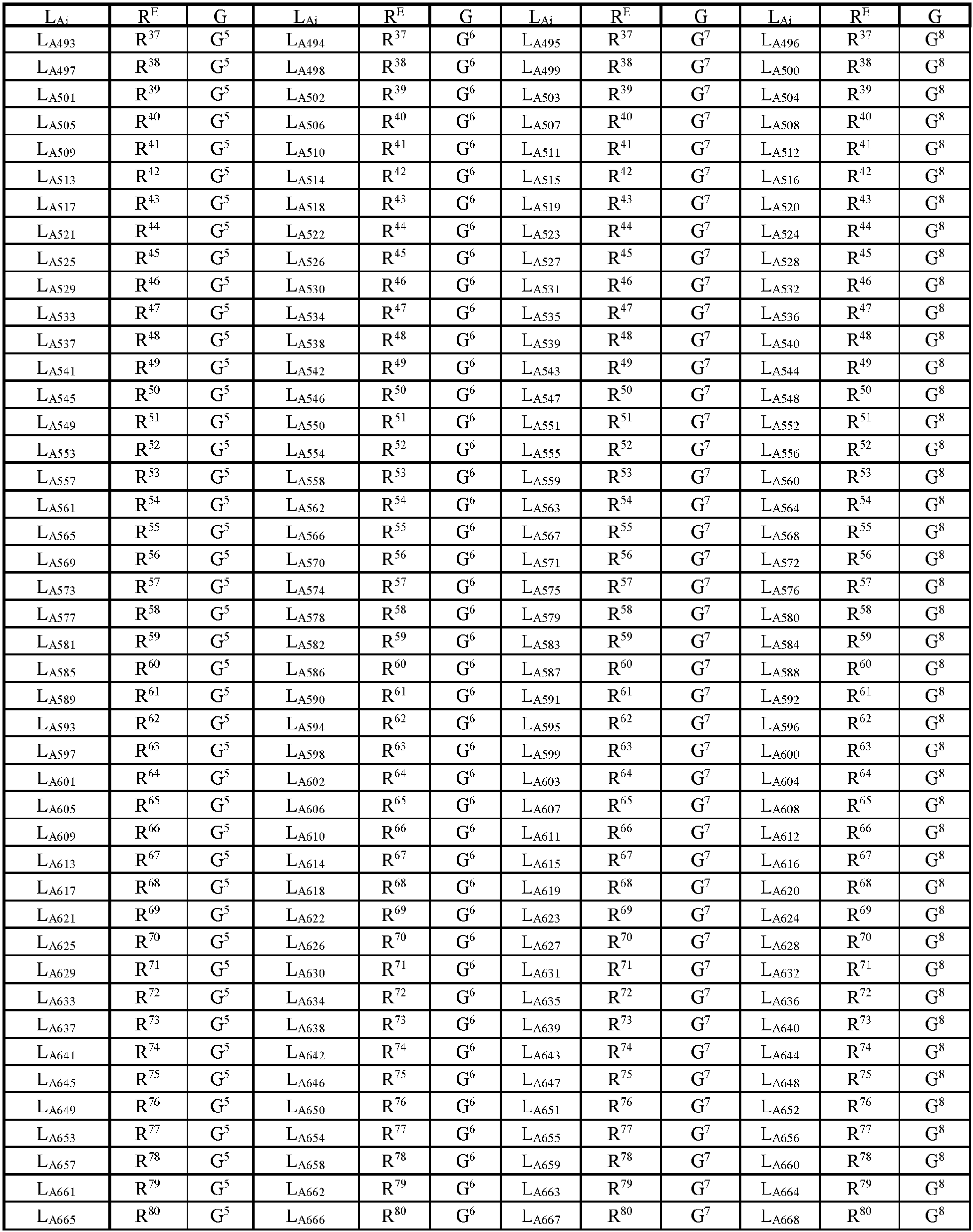

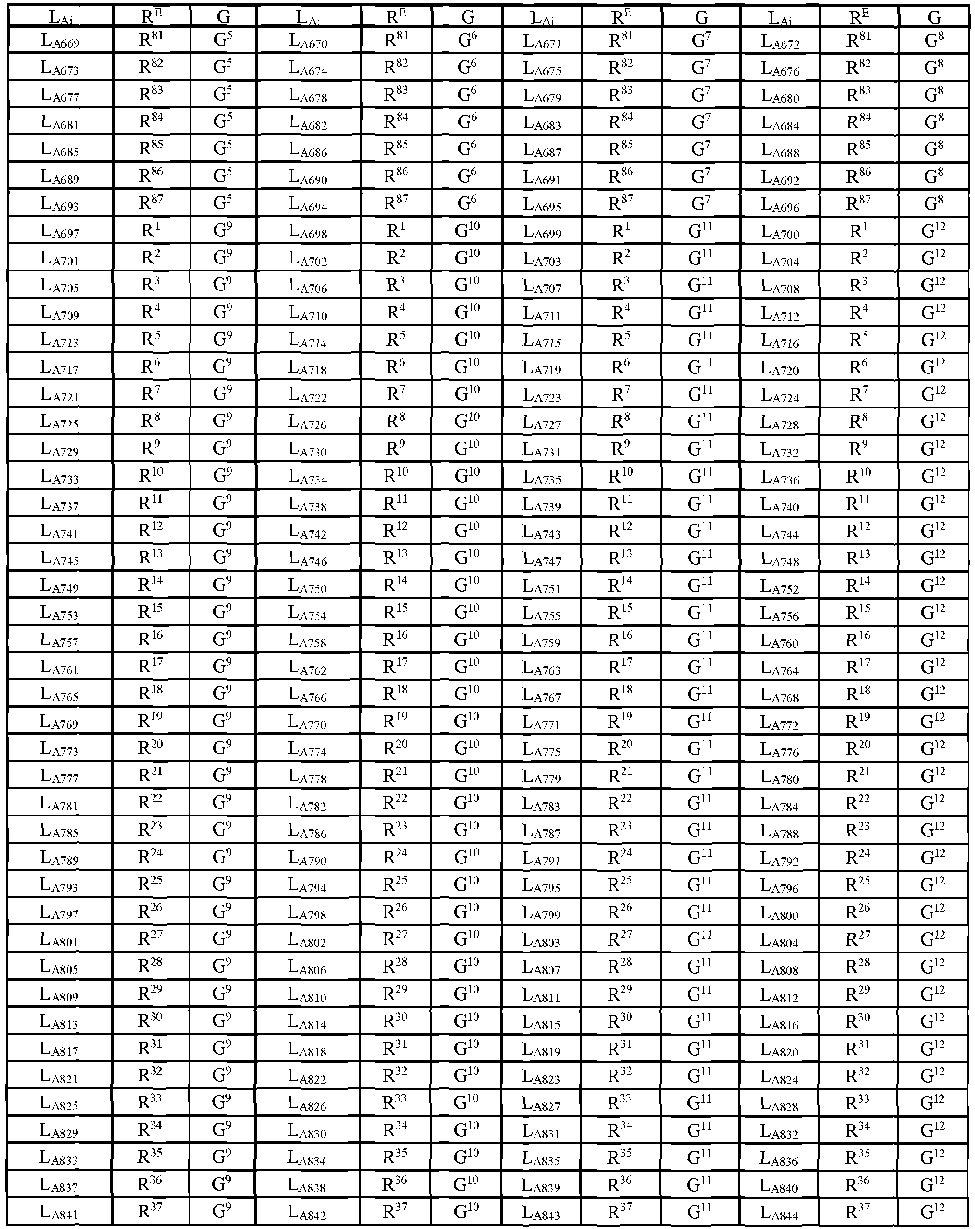

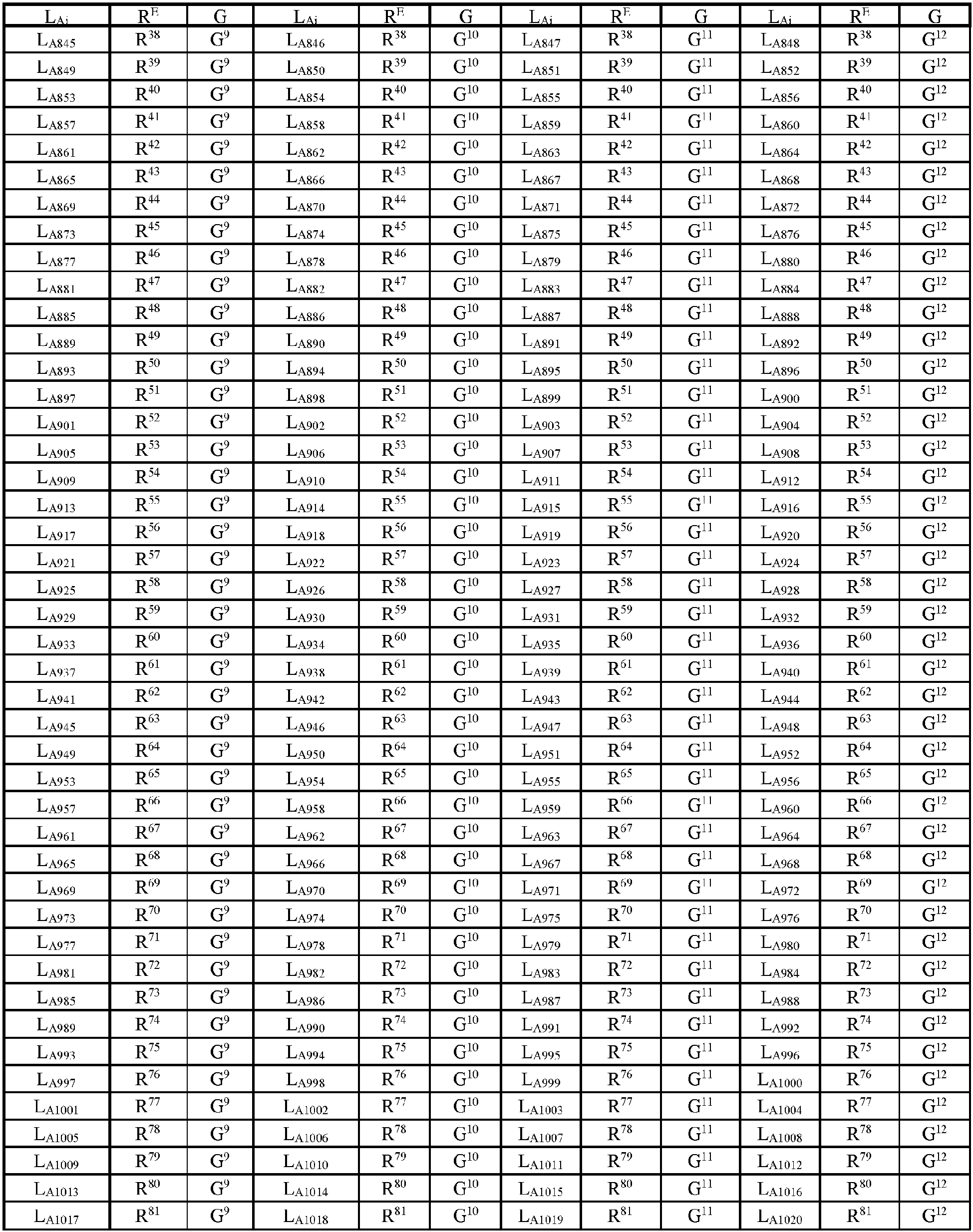

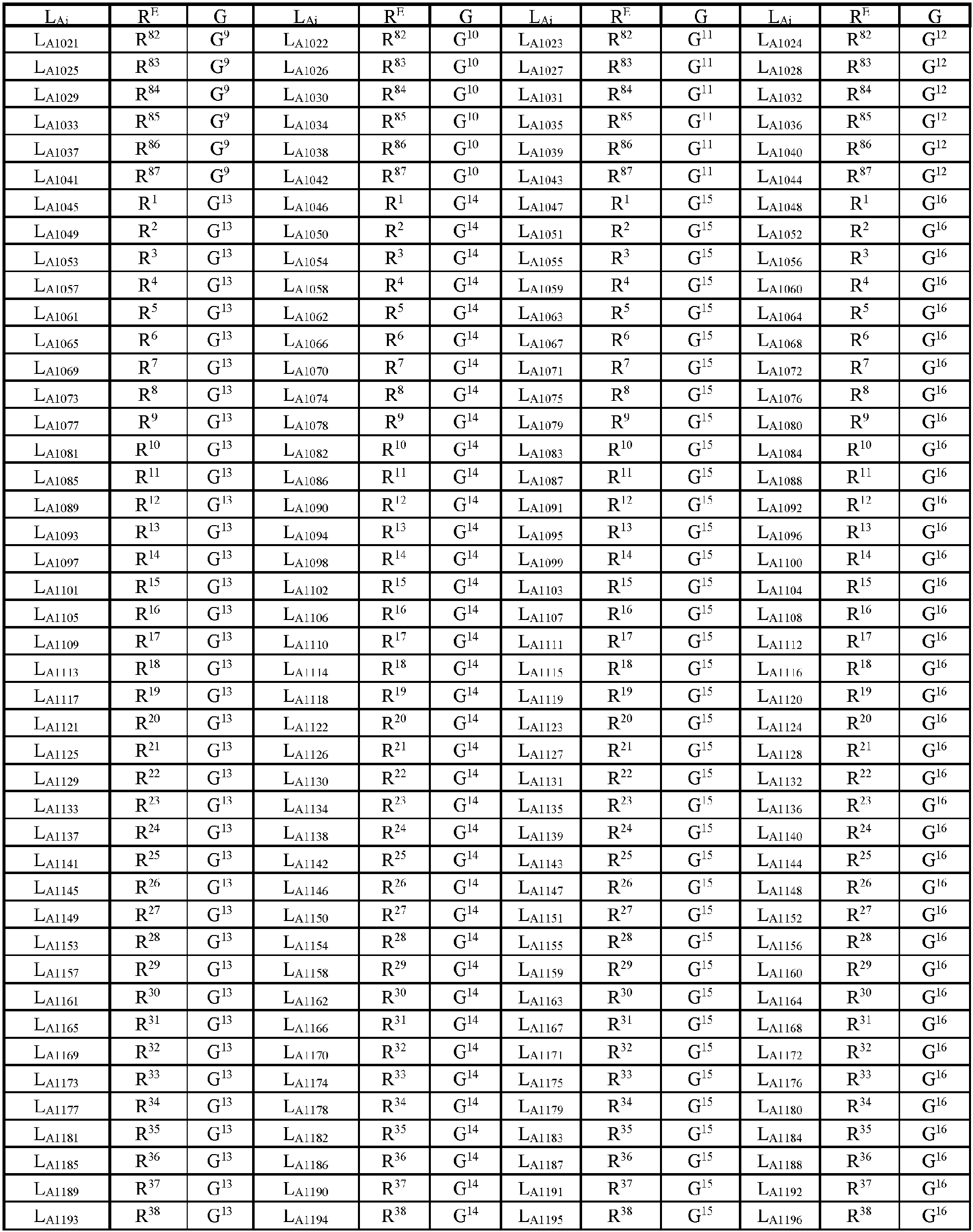

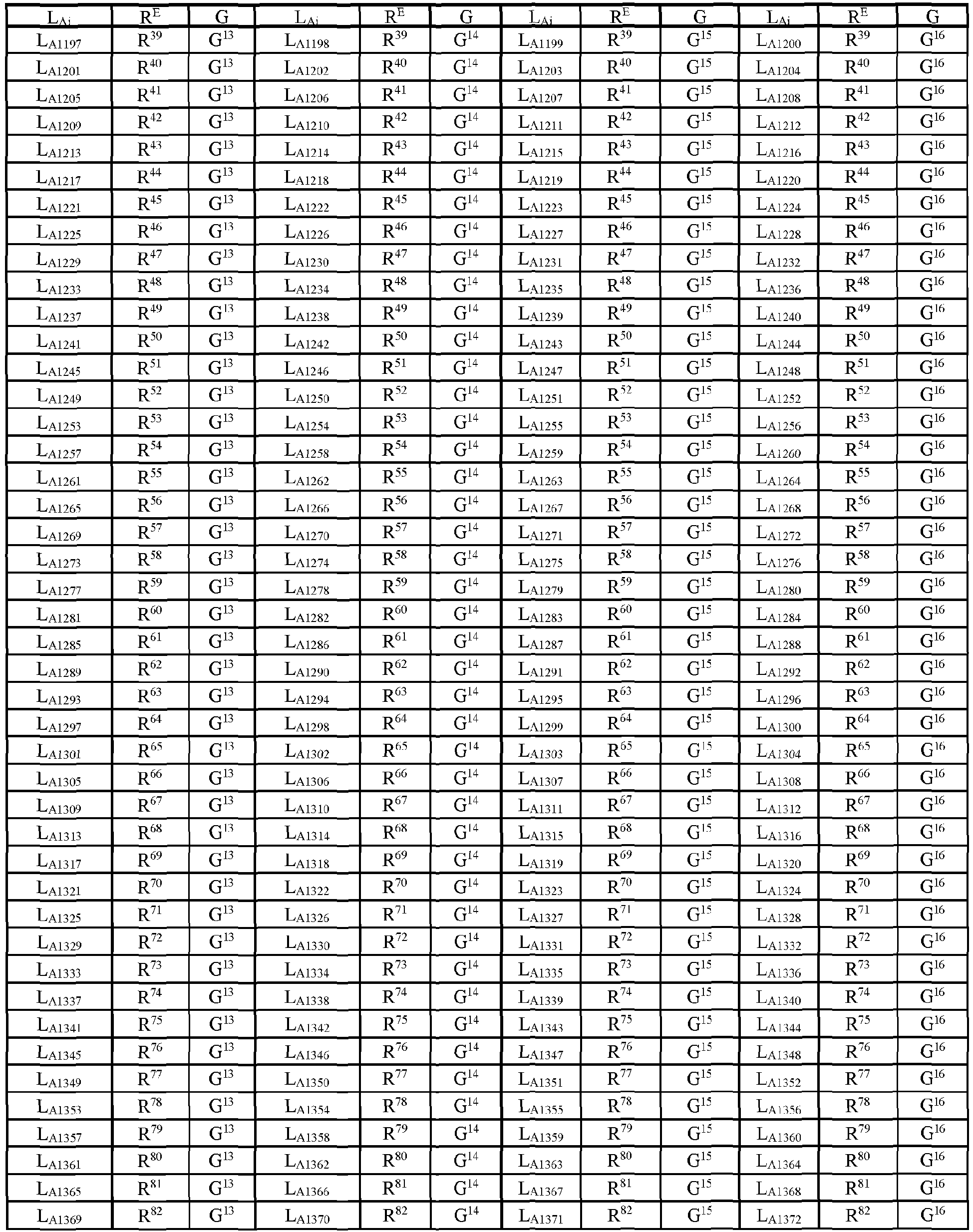

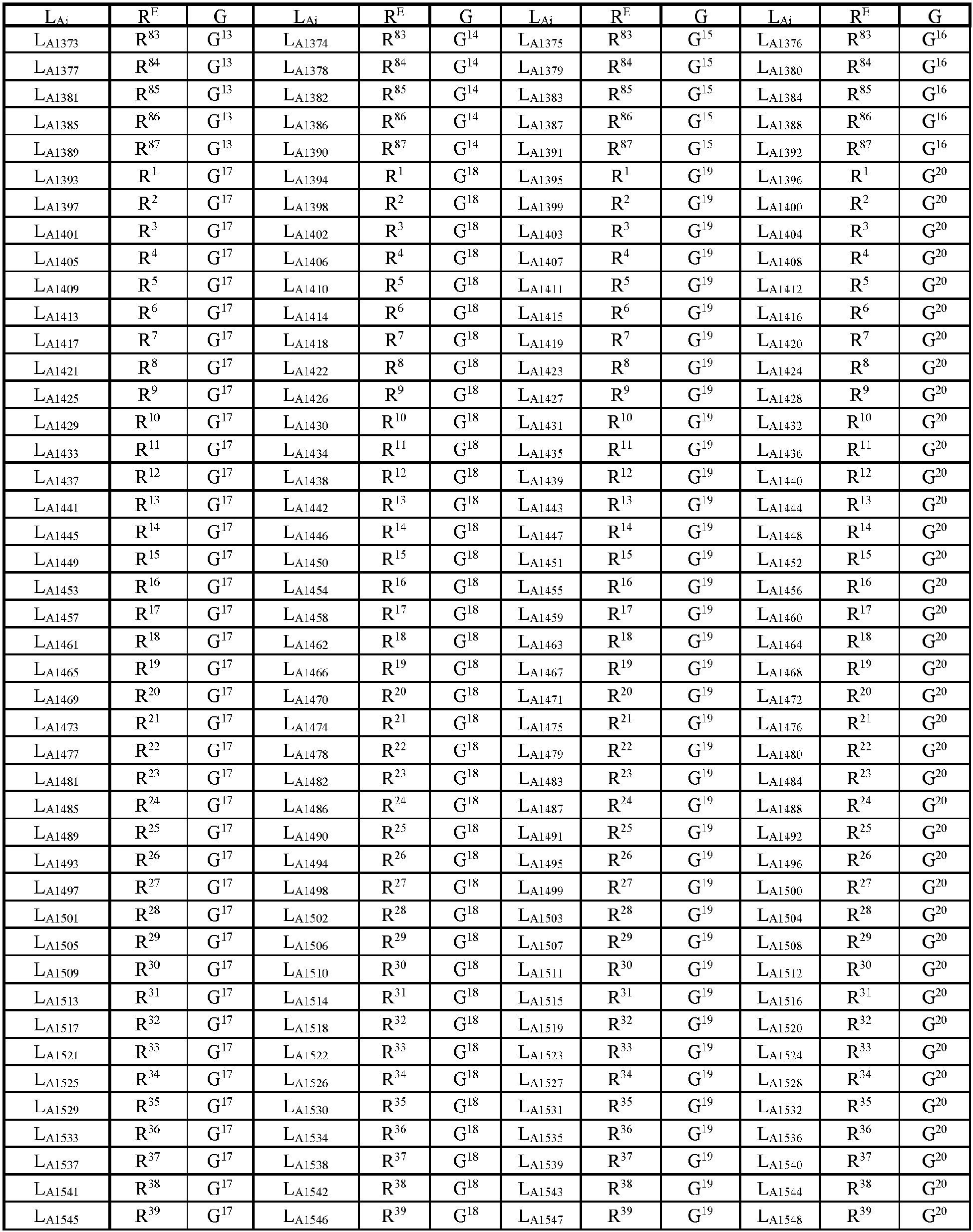

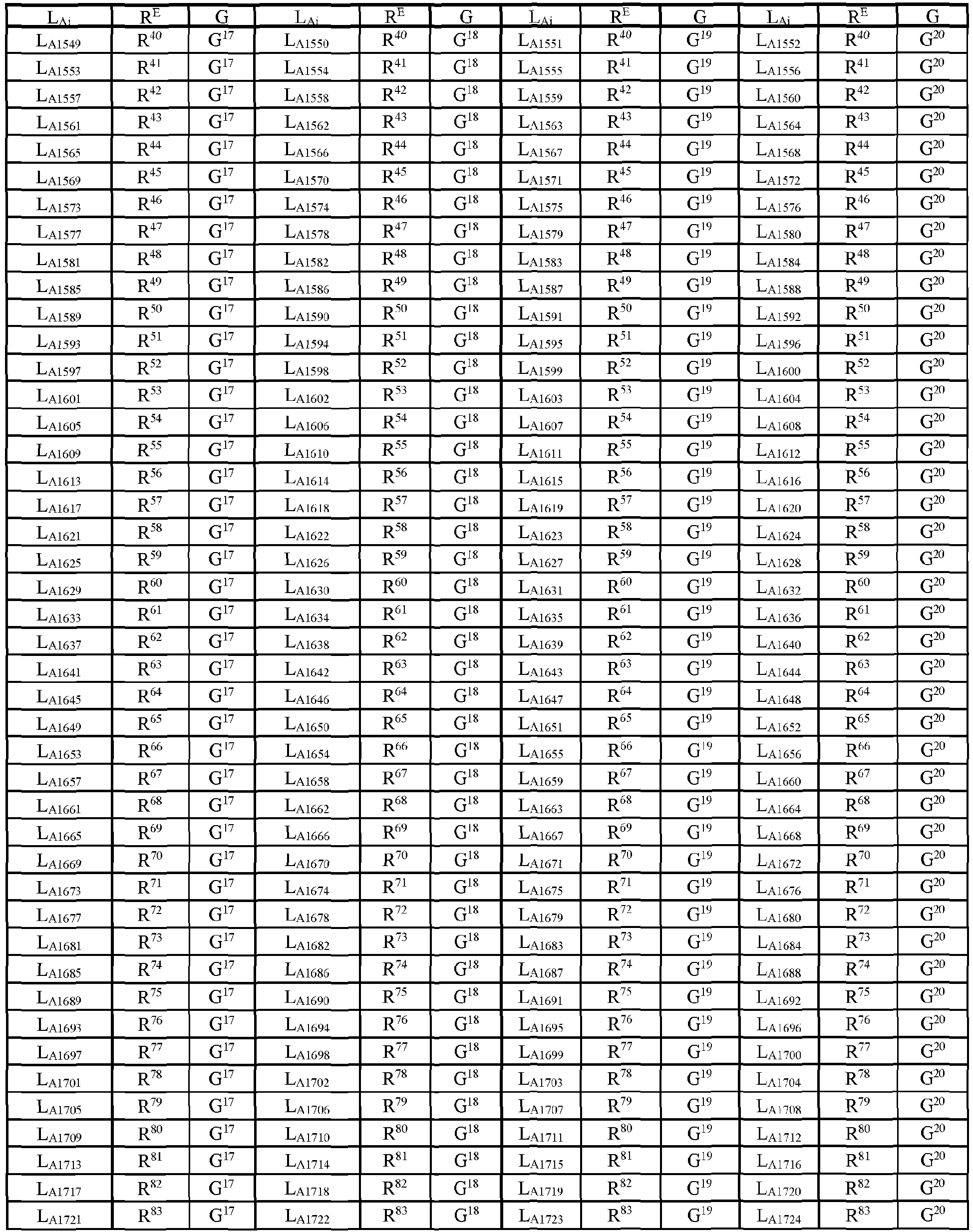

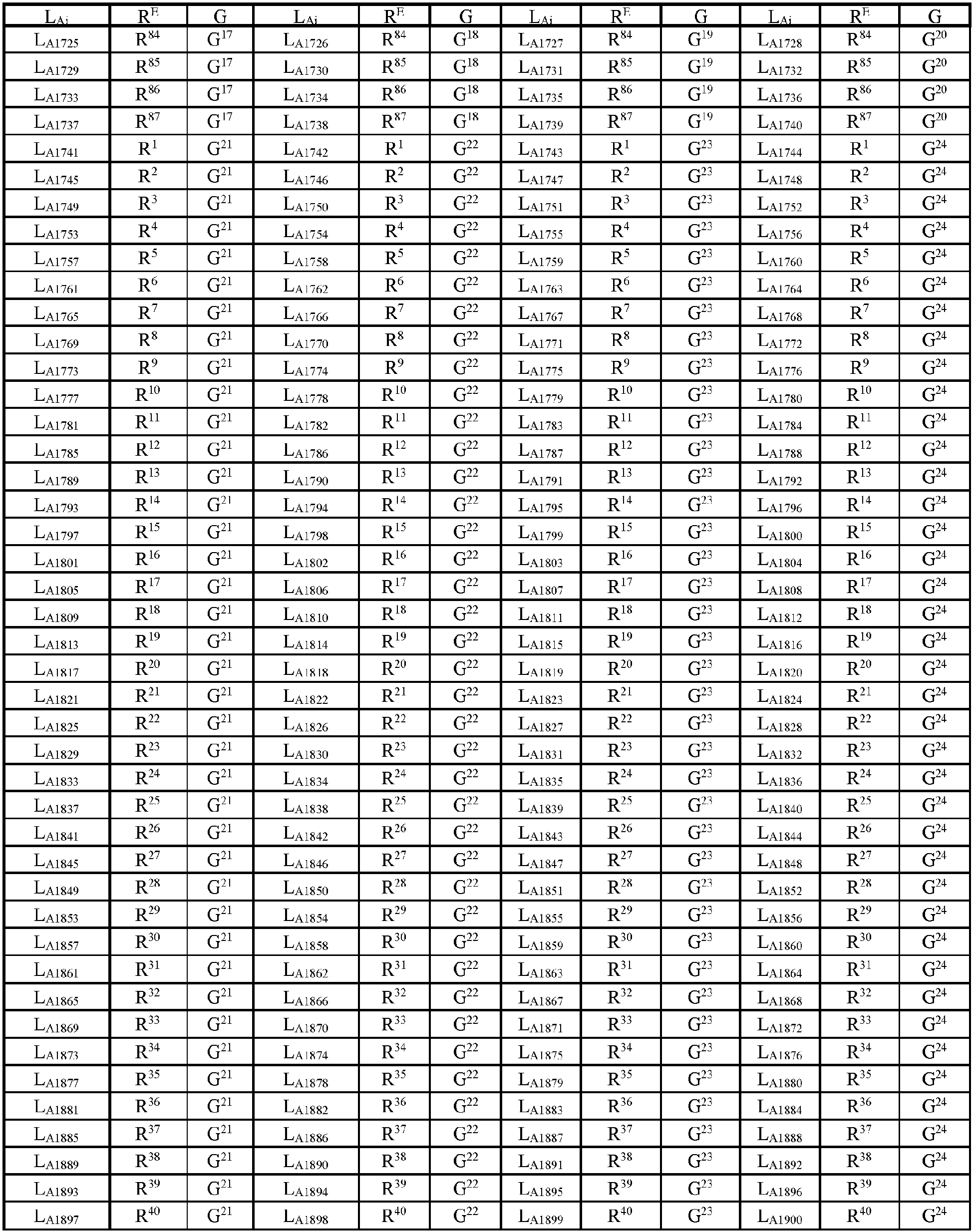

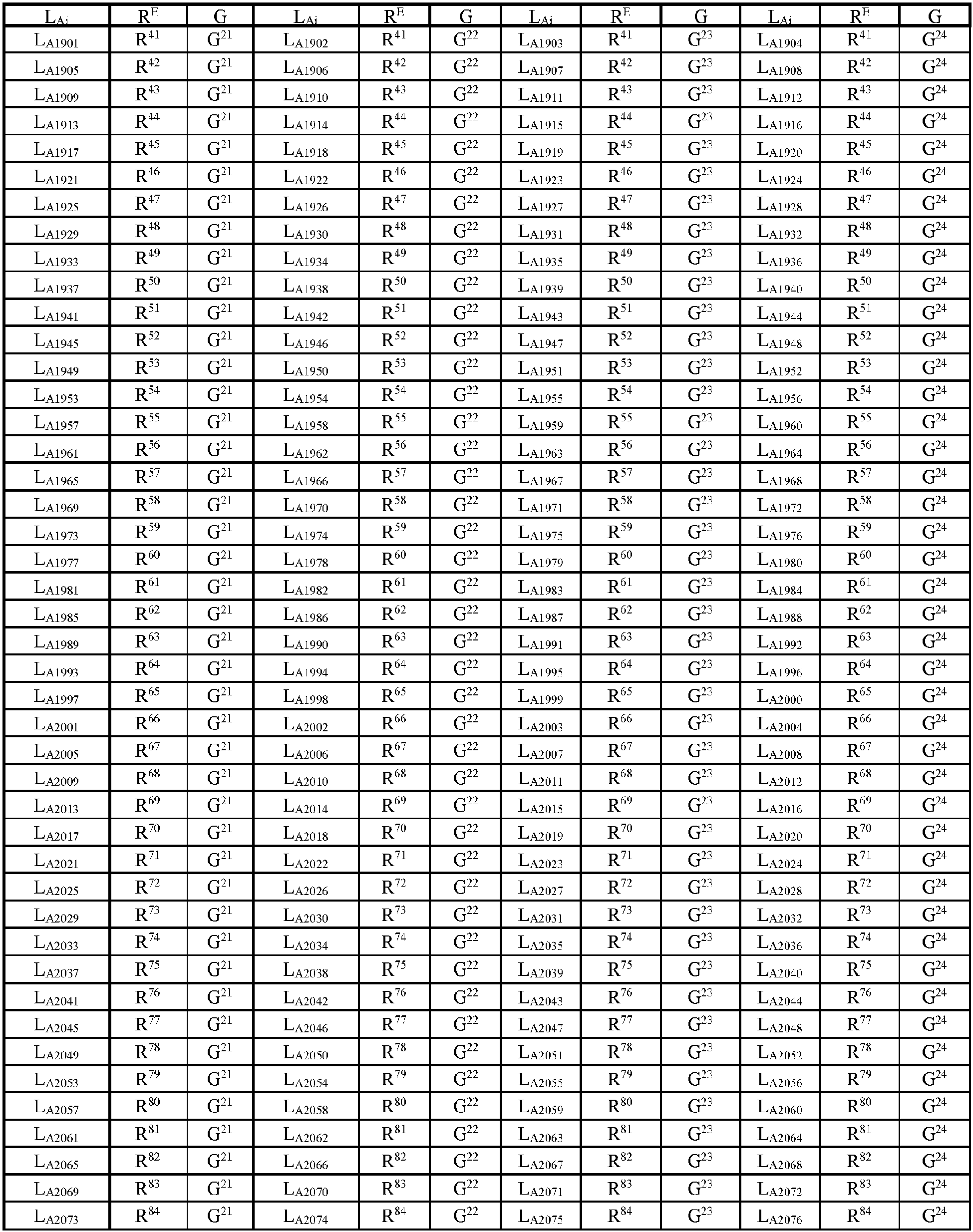

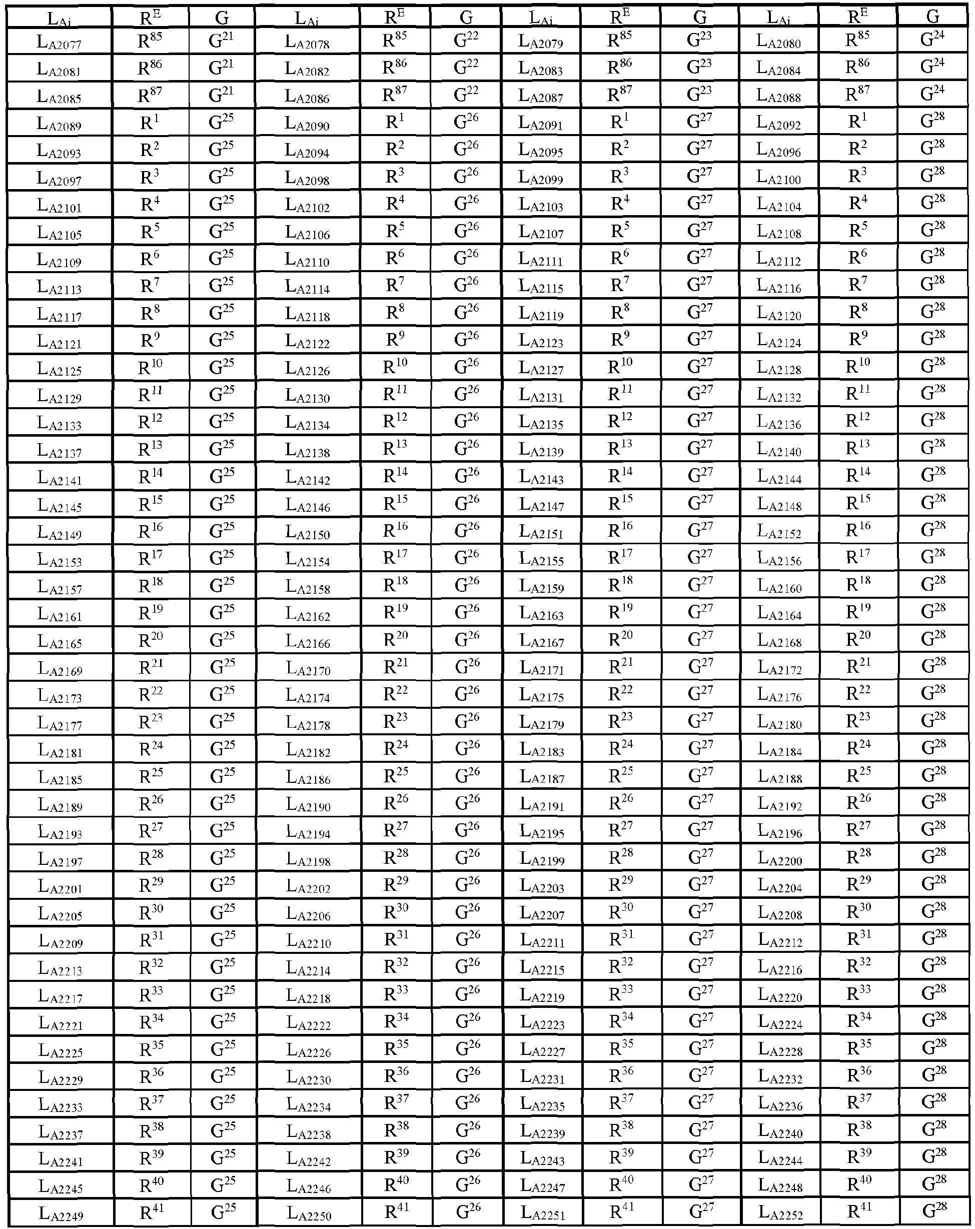

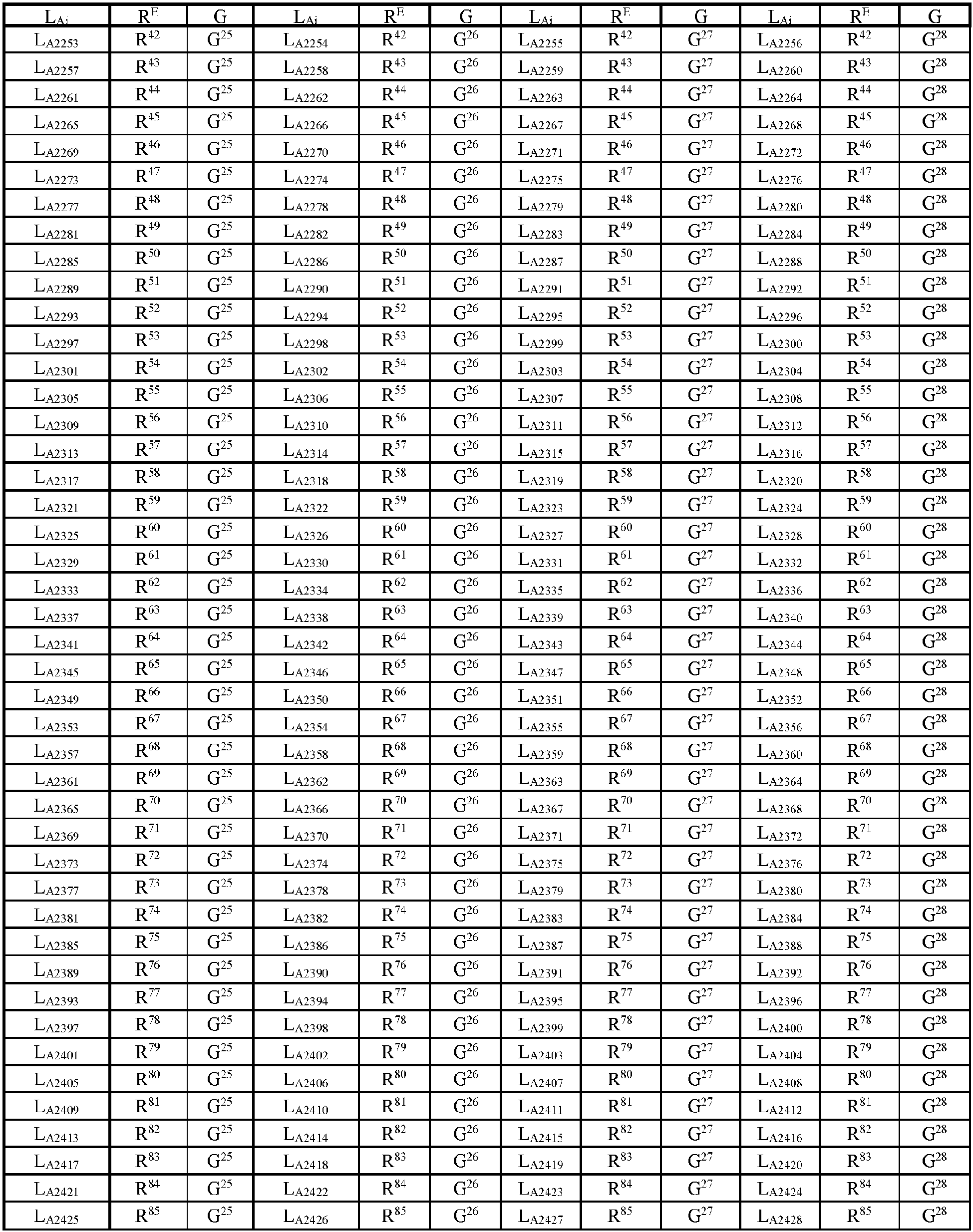

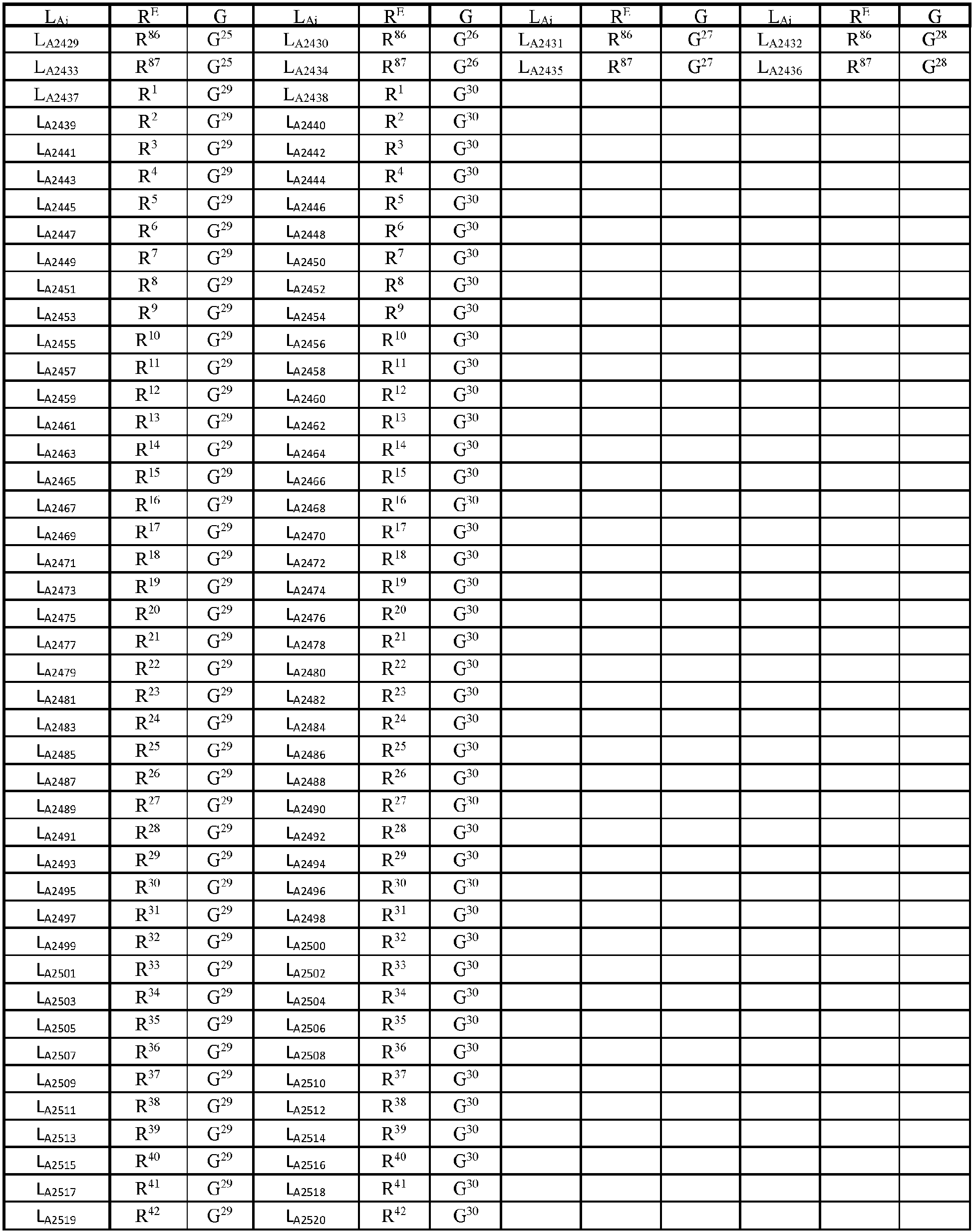

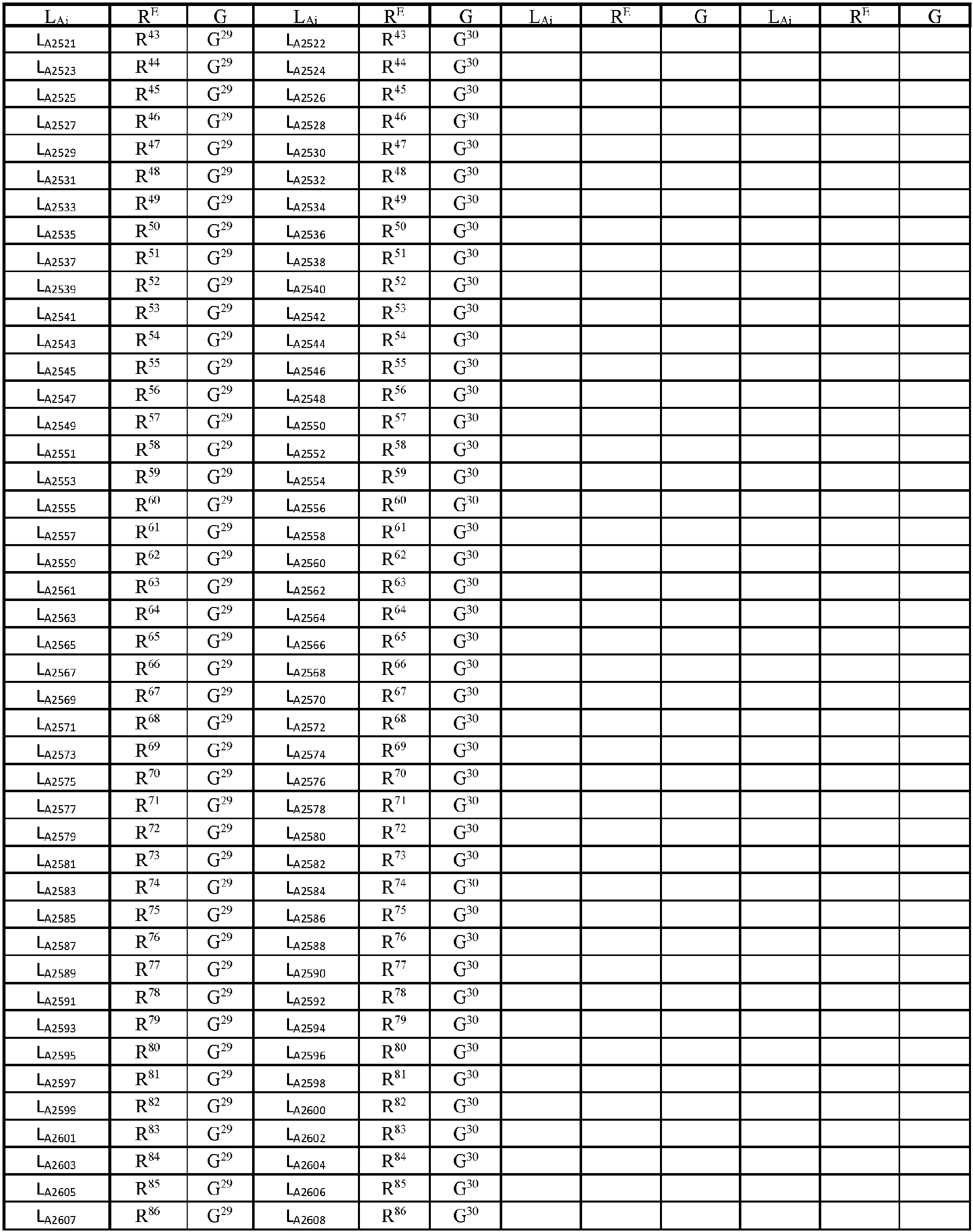

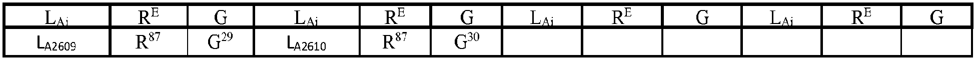

wherein R¹ to R⁸⁷ have structures defined in the following LIST 4: 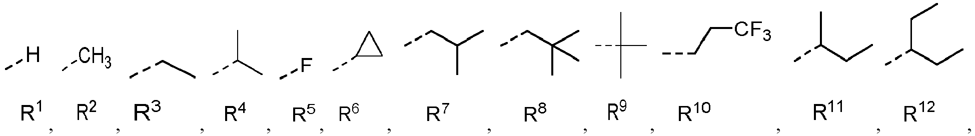 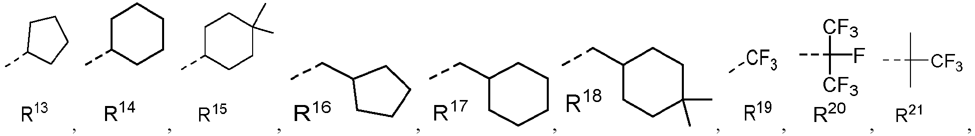 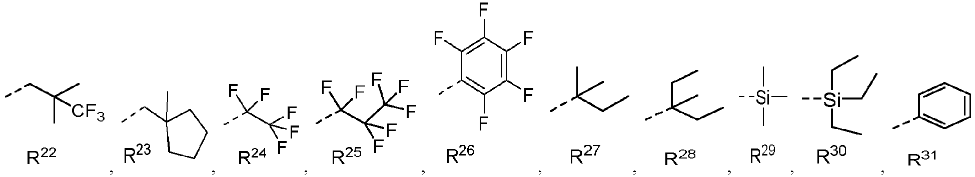 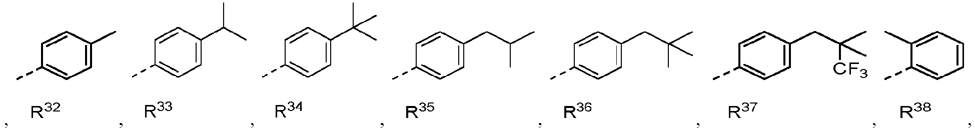 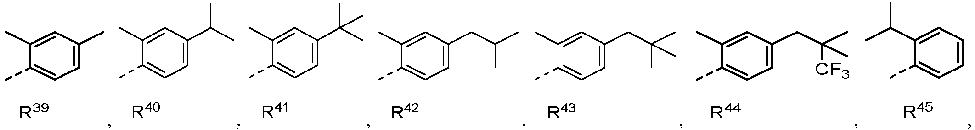 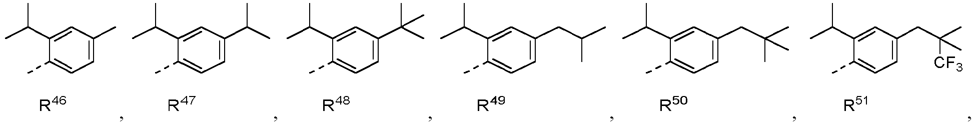 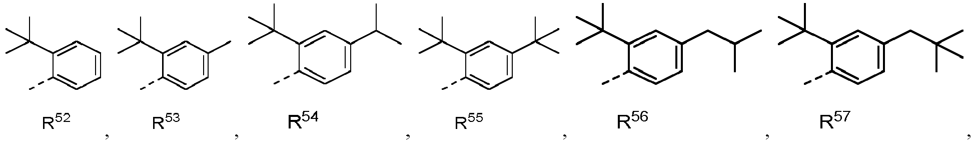 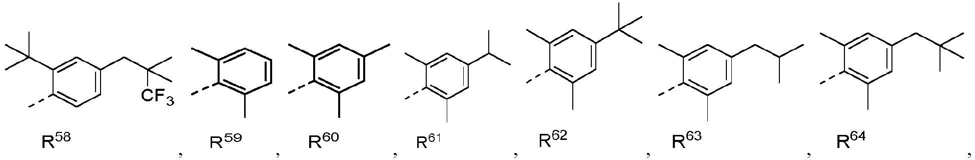 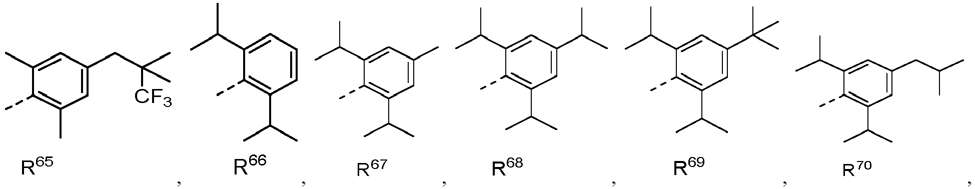 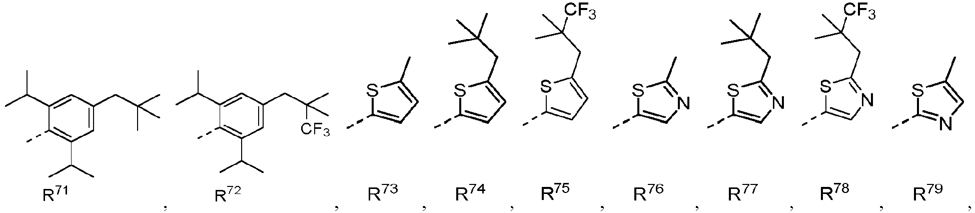 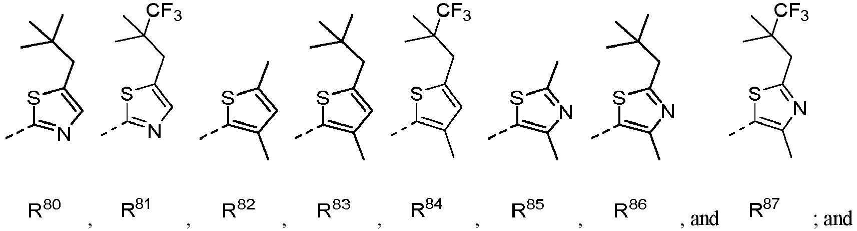 wherein G¹ to G³⁰ have structures defined in the following LIST 5:

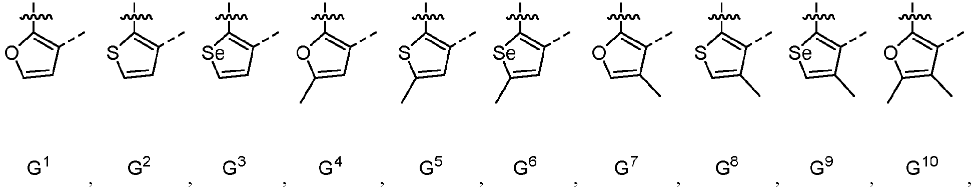

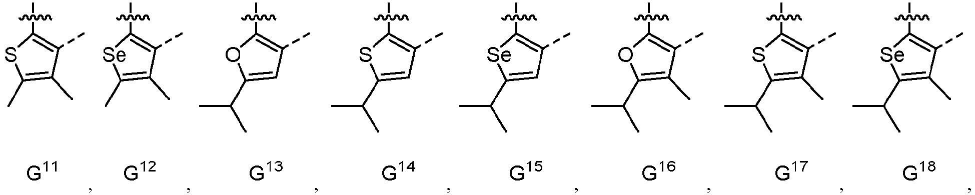

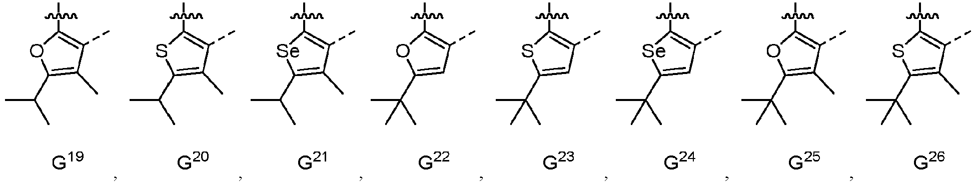

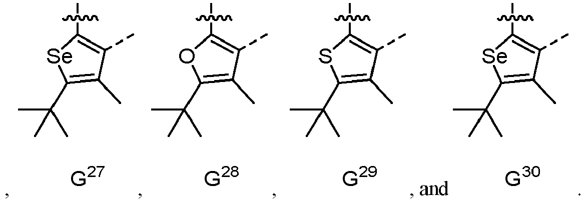

In some embodiments, the compound has a formula of M(L_{A})ₚ(L_{B})_{q}(L_{C})ᵣ wherein L_{B} and L_{C} are each a bidentate ligand; and wherein p is 1, 2, or 3; q is 0, 1, or 2; r is 0, 1, or 2; and p+q+r is the oxidation state of the metal M.

In one embodiment, when M is Ir, L_{B} is a substituted or unsubstituted phenylpyridine, and L_{C} is a substituted or unsubstituted acetylacetonate.

In some embodiments, the compound has a formula selected from the group consisting of Ir(L_{A})₃, Ir(L_{A})(L_{B})₂, Ir(L_{A})₂(L_{B}), Ir(L_{A})₂(L_{C}), and Ir(L_{A})(L_{B})(L_{C}); and wherein L_{A}, L_{B}, and L_{C} are different from each other

In some embodiments, the compound has a formula of Pt(L_{A})(L_{B}), and wherein L_{A} and L_{B} can be same or different. In some embodiments of having a formula of Pt(L_{A})(L_{B}), L_{A} and L_{B} are connected to form a tetradentate ligand.

In some embodiments, L_{B} and L_{C} are each independently selected from the group consisting of the structures of the following LIST 6: 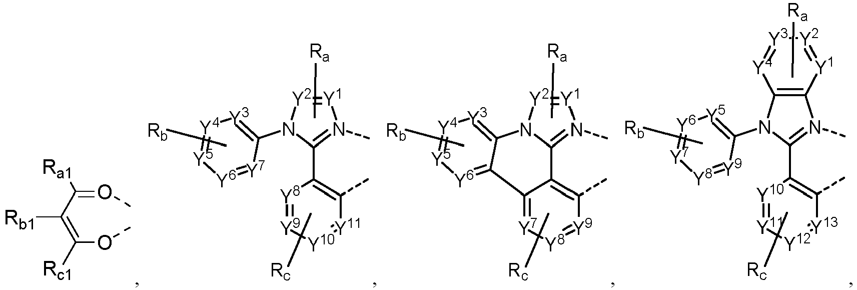 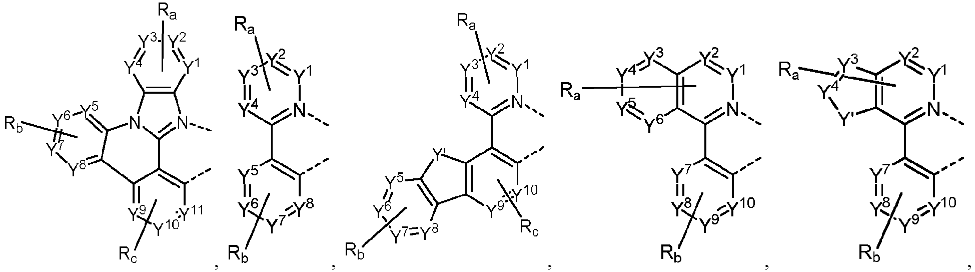 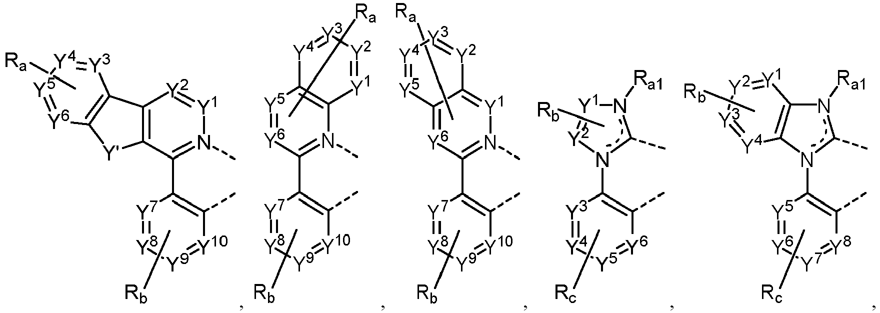 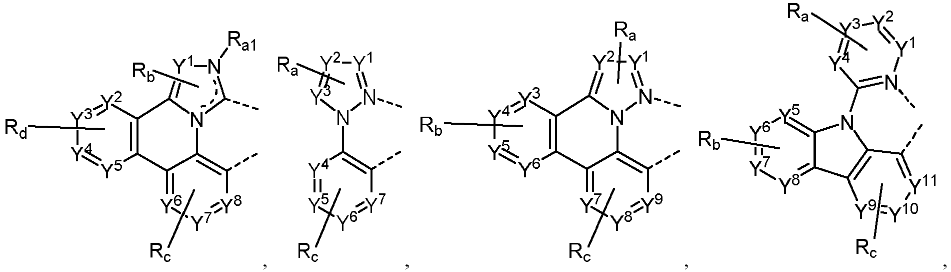 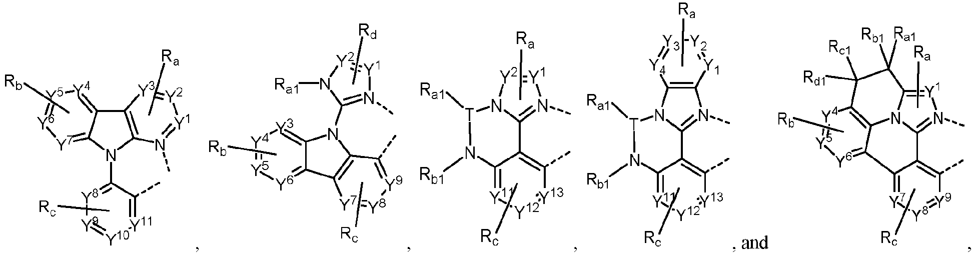 wherein:
T is selected from the group consisting of B, Al, Ga, and In;
each of Y¹ to Y¹³ is independently selected from the group consisting of carbon and nitrogen;
Y' is selected from the group consisting of BRₑ, NRₑ, PRₑ, O, S, Se, C=O, S=O, SO₂, CRₑR_{f}, SiRₑR_{f}, and GeRₑR_{f};
each Rₐ, R_{b}, R_{c}, and R_{d} independently represent zero, mono, or up to a maximum allowed number of substitutions;
each of Rₐ₁, R_{b1}, R_{c1}, R_{d1}, Rₐ, R_{b}, R_{c}, R_{d}, Rₑ and R_{f} is independently a hydrogen or a substituent selected from the group consisting of the General Substituents defined herein; and
any two adjacent Rₐ, R_{b}, R_{c}, R_{d}, Rₑ and Rf can be fused or joined to form a ring or form a multidentate ligand.

In some embodiments, L_{B} and L_{C} are each independently selected from the group consisting of the structures of the following LIST 7: 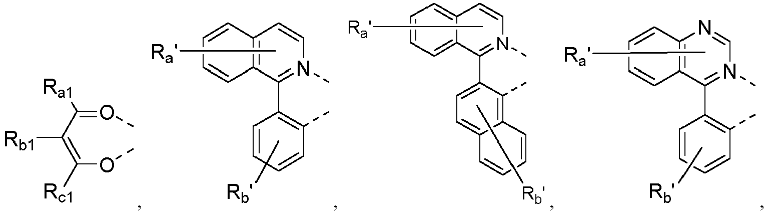 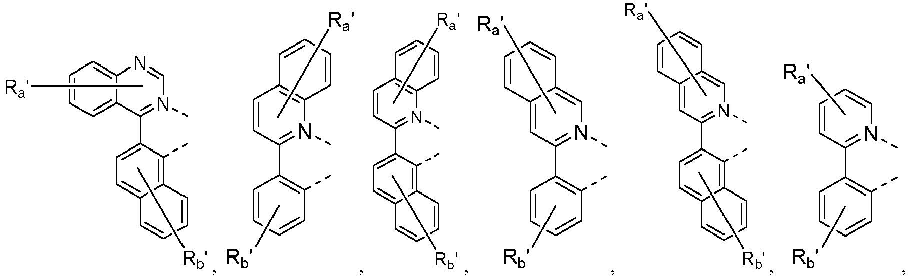 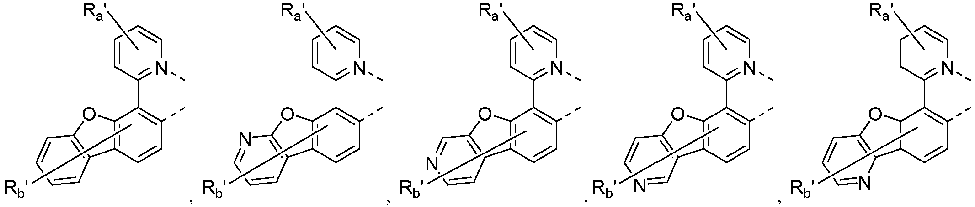 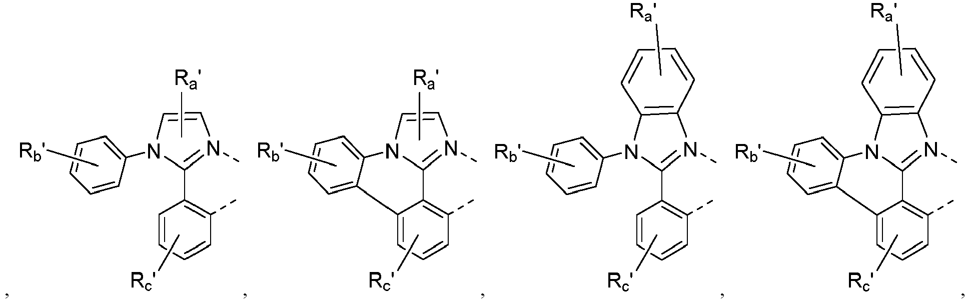 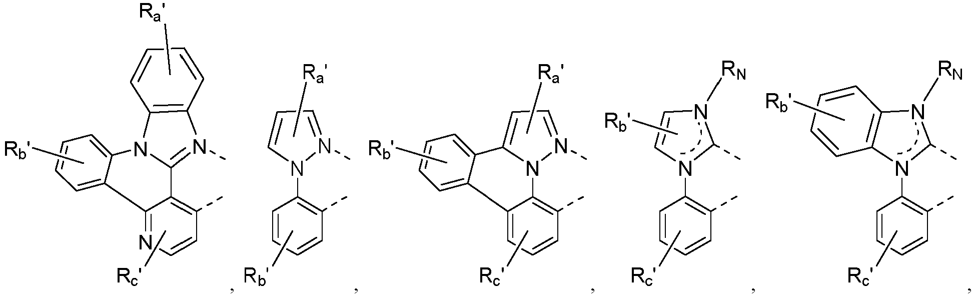 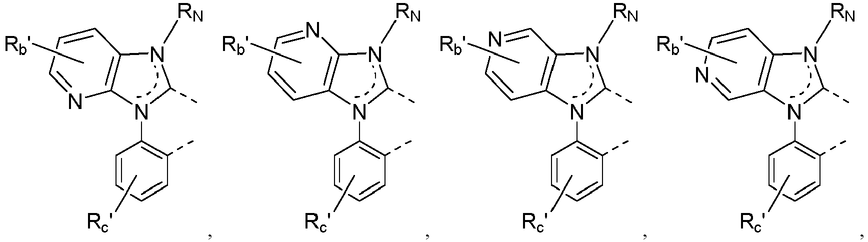 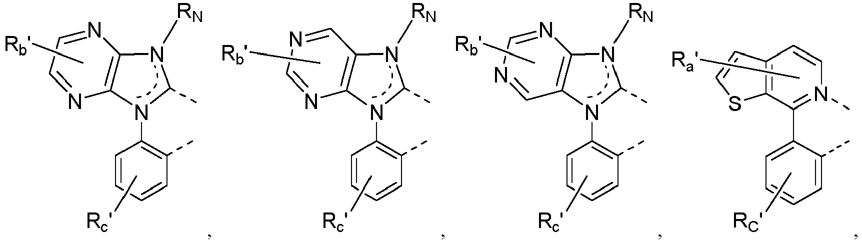 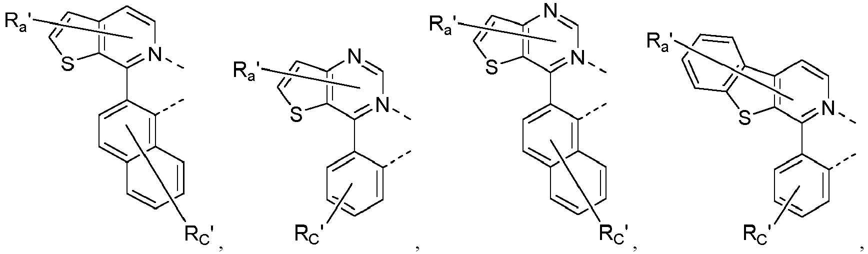 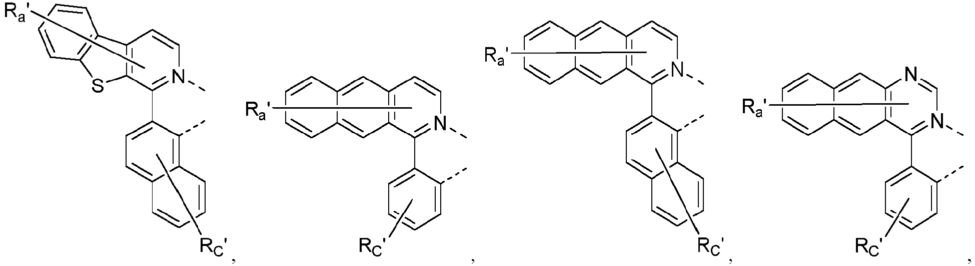 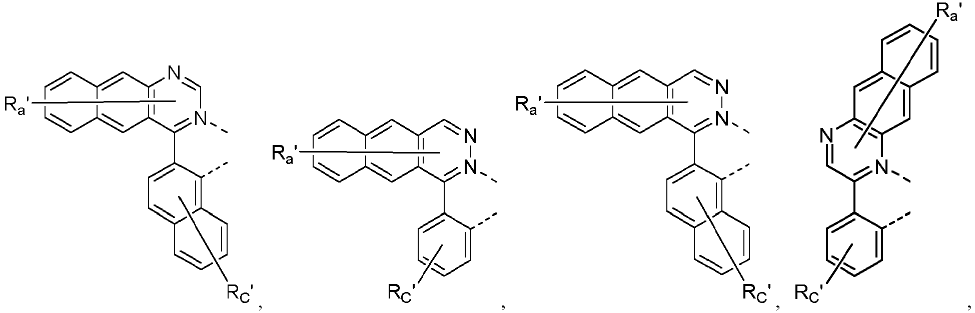 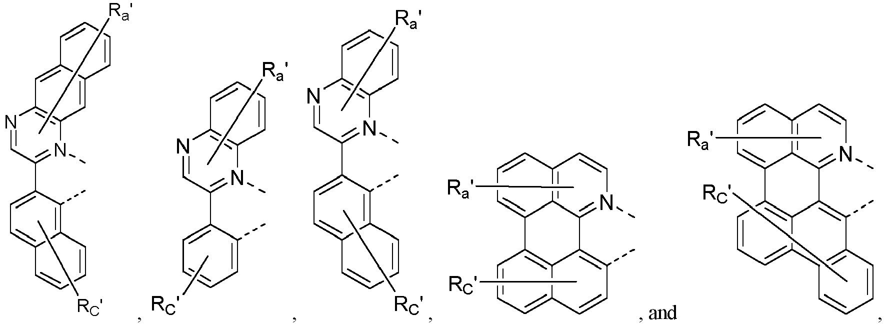 wherein:
Rₐ', R_{b}', and R_{c}' each independently represent zero, mono, or up to a maximum allowed substitution to its associated ring;
each of Rₐ₁, R_{b1}, R_{c1}, R_{N}, Rₐ', R_{b}', and R_{c}' is independently hydrogen or a substituent selected from the group consisting of the General Substituents defined herein; and
two adjacent Rₐ', R_{b}', and R_{c}' can be fused or joined to form a ring or form a multidentate ligand.

In some embodiments, the compound can have the formula Ir(L_{A})₃, the formula Ir(L_{A})(L_{B*k*})₂, the formula Ir(L_{A})₂(L_{Bk}), the formula Ir(L_{A})₂(L_{*Cj*-*I*}), the formula Ir(L_{A})₂(L_{*Cj*-*II*}), the formula Ir(L_{A})(L_{B*k*})(L_{*Cj*-*I*}), or the formula Ir(L_{A})(L_{B*k*})(L_{*Cj*-*II*}), wherein L_{A} is a ligand with respect to Formula I as defined here; L_{B*k*} is defined herein; and *L_{Cj-I}* and *L_{Cj-II}* are each defined herein.

In some embodiments, when the compound has formula Ir(L_{*Ai*-*m*-*X*})₃, *i* is an integer from 1 to 2610; *m* is an integer from 1 to 108; and the compound is selected from the group consisting of Ir(L_{A*1-1-1*})₃ to Ir(LA_{*2610*-*108*-*4*})₃;
when the compound has formula Ir(L_{*Ai*-*m*-*X*})(L_{B*k*})₂, *i* is an integer from 1 to 4542; *m* is an integer from 1 to 108; *k* is an integer from 1 to 324; and the compound is selected from the group consisting of Ir(L_{A*1-1-1*})(L_{B*1*})₂ to Ir(L_{A*2610-108-4*})(L_{B*324*})₂;
when the compound has formula Ir(L_{*Ai*-*m*-*X*})₂(L_{B*k*}), *i* is an integer from 1 to 2610; *m* is an integer from 1 to 108; *k* is an integer from 1 to 324; and the compound is selected from the group consisting of Ir(L_{A*1-1-1*})₂(L_{B*1*}) to Ir(L_{A*2610-108-4*})*₂*(L_{B*324*});
when the compound has formula Ir(L_{*Ai*-*m*-*X*})₂(L_{*Cj*-*I*}), *i* is an integer from 1 to 2610; *m* is an integer from 1 to 108; *j* is an integer from 1 to 1416; and the compound is selected from the group consisting of Ir(L_{A*1-1-1*})₂(L_{*C1*-I}) to Ir(L_{A*2610*-*108-4*})₂(L_{C*1416*-I}); and
when the compound has formula Ir(L_{*Ai*-*m*-*X*})₂(L_{*Cj*-II}), *i* is an integer from 1 to 2610; *m* is an integer from 1 to 108; *j* is an integer from 1 to 1416; and the compound is selected from the group consisting of Ir(L_{A*1-1-1*})₂(L_{C*1*-II}) to Ir(L_{*A2610*-*108*-*4*})₂(L_{C*1416*-II});
wherein each L_{B*k*} is defined by the structures in the following LIST 8: 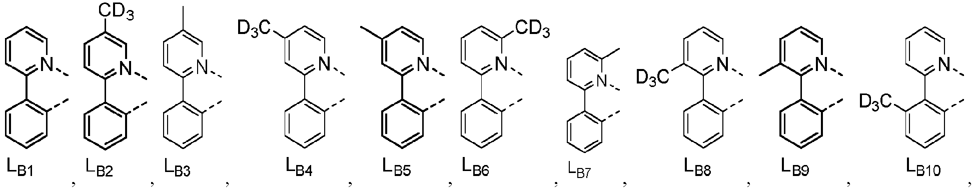 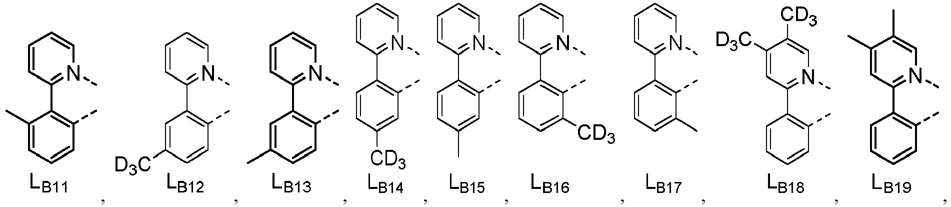 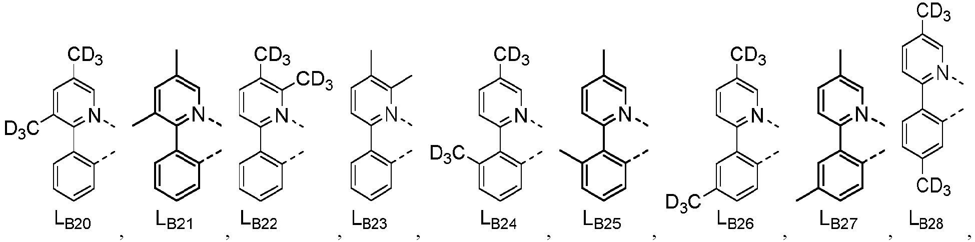 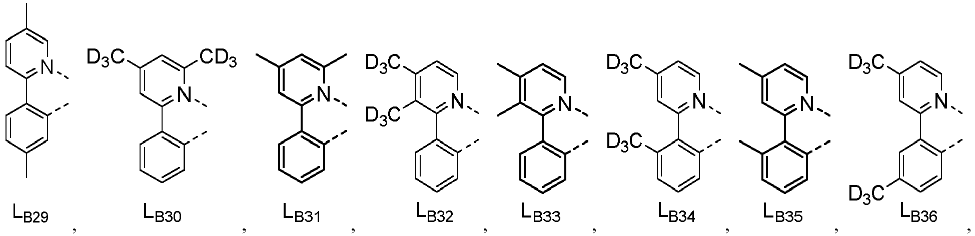 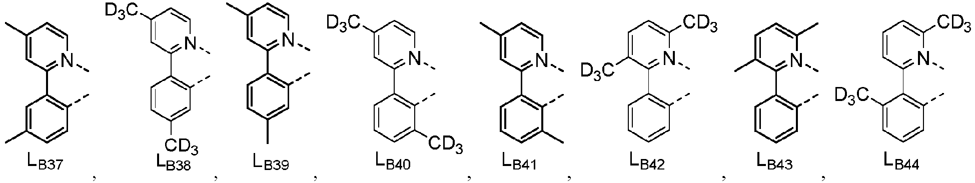 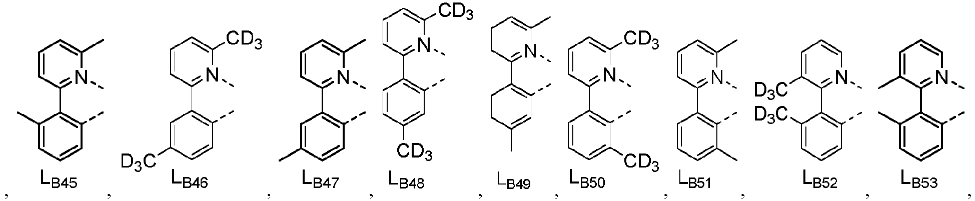 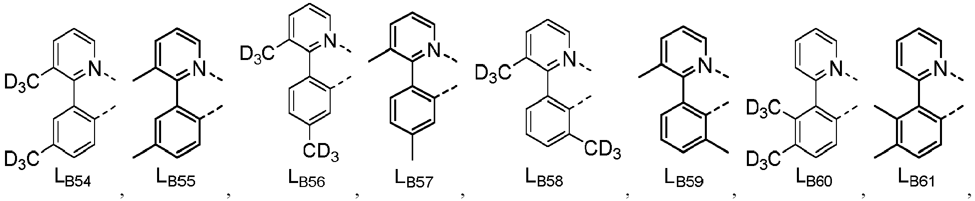 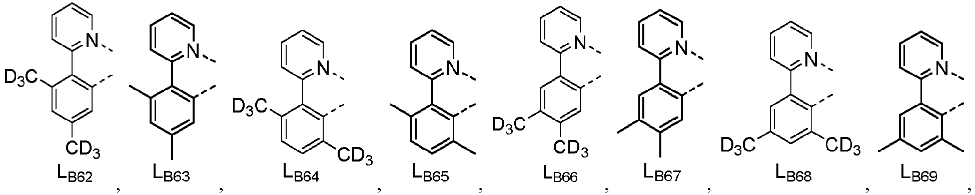 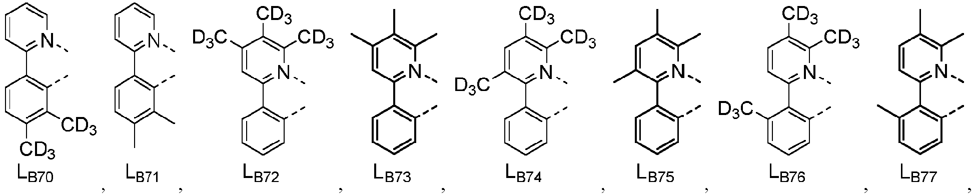 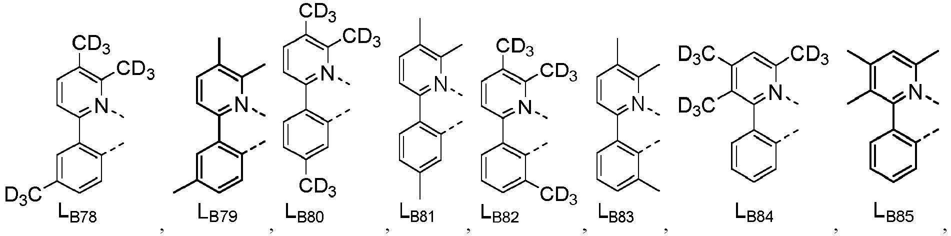 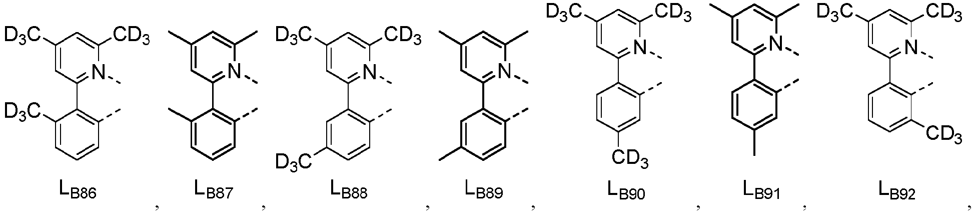 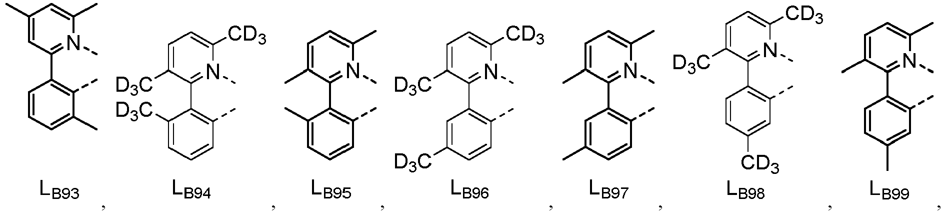 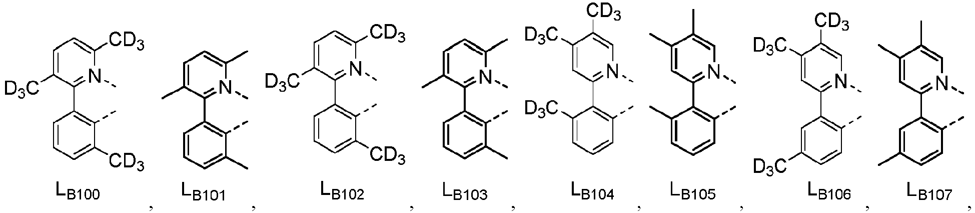 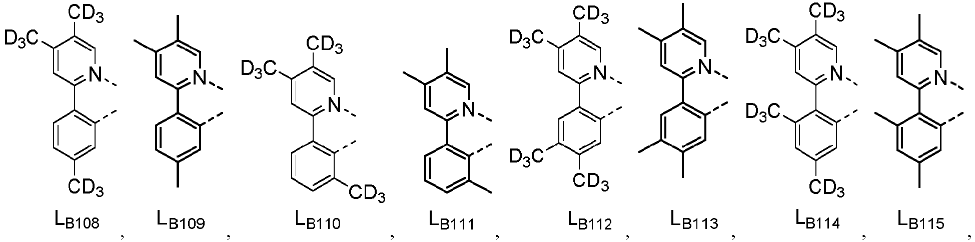 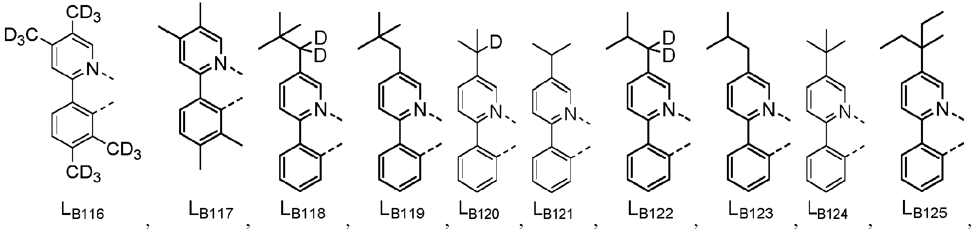 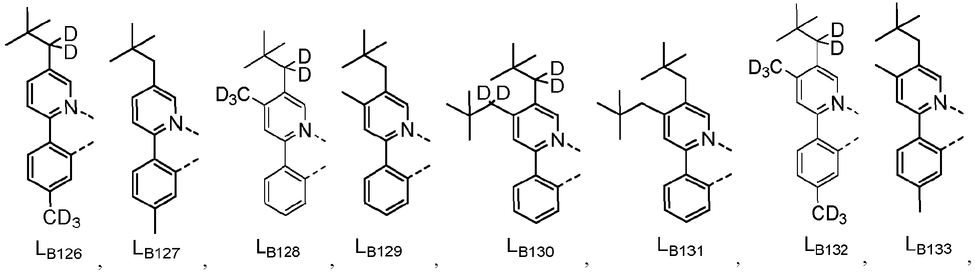 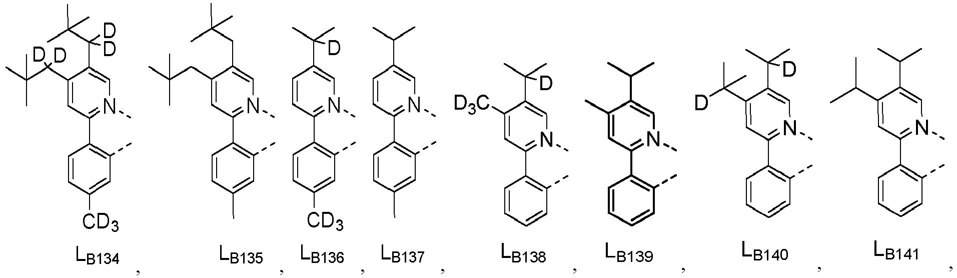 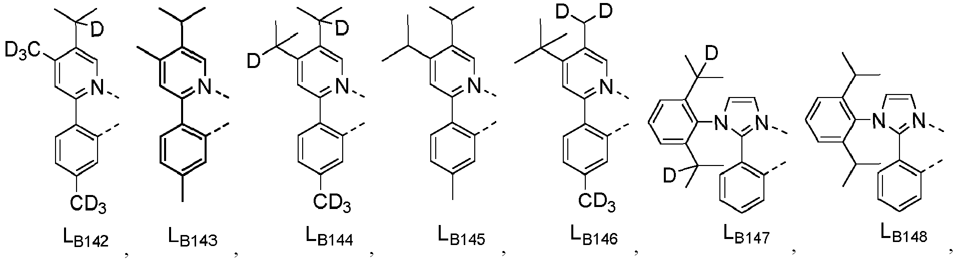 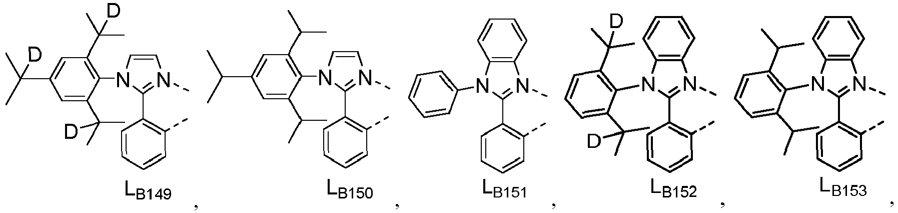 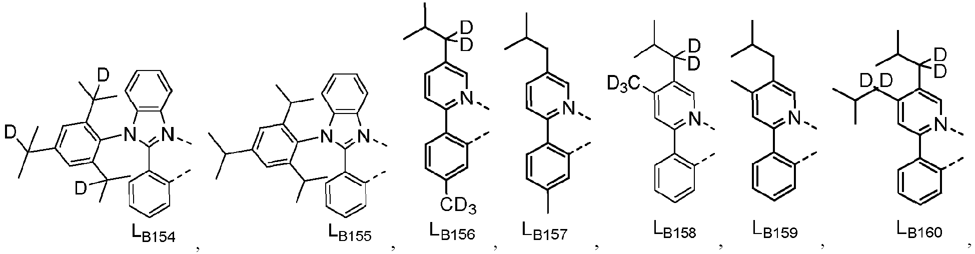 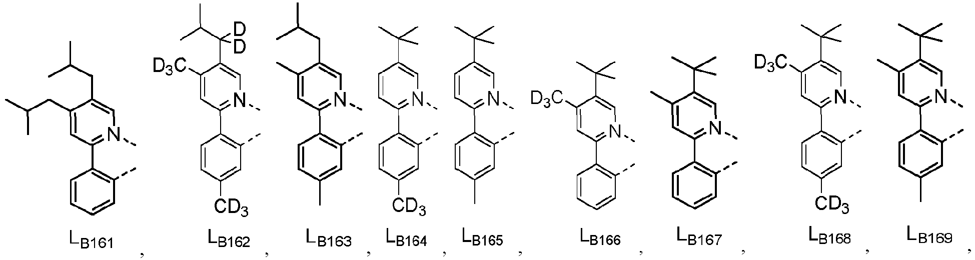 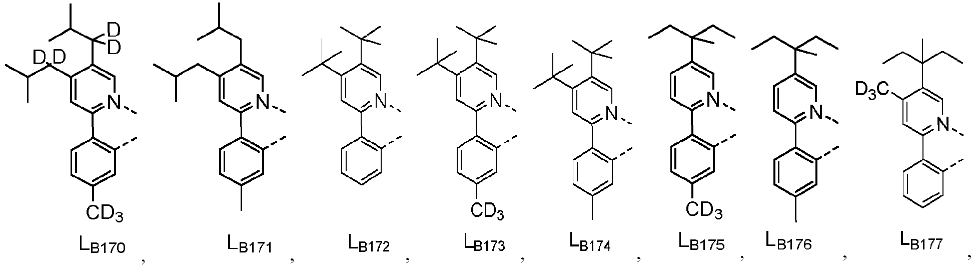 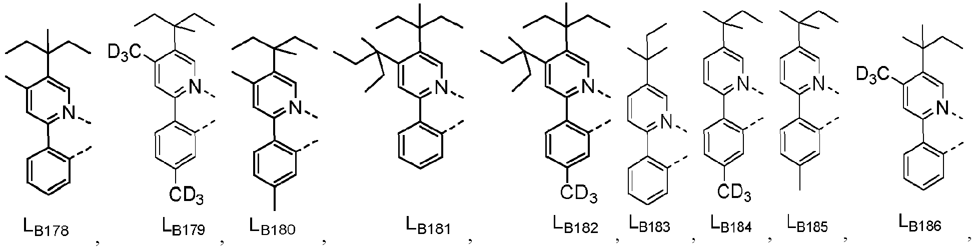 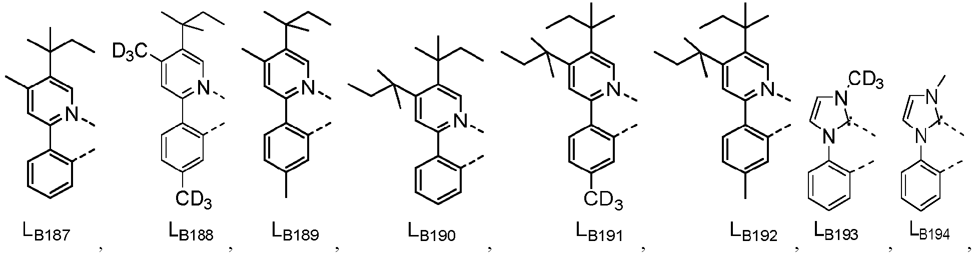 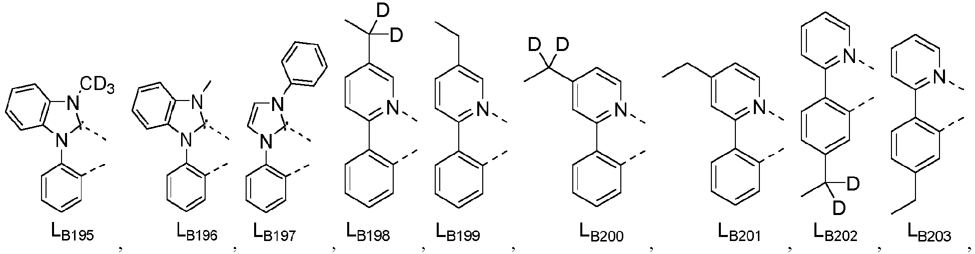 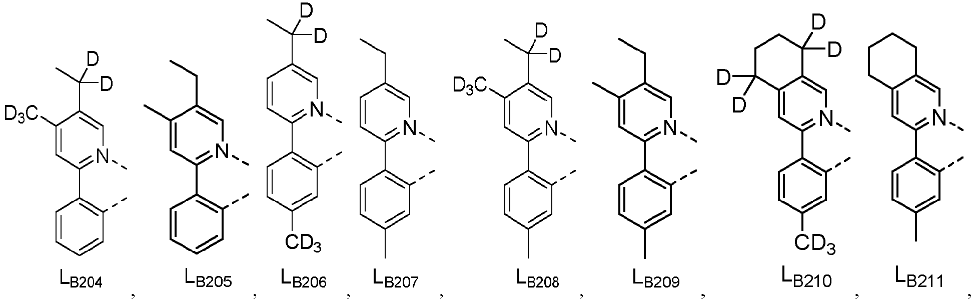 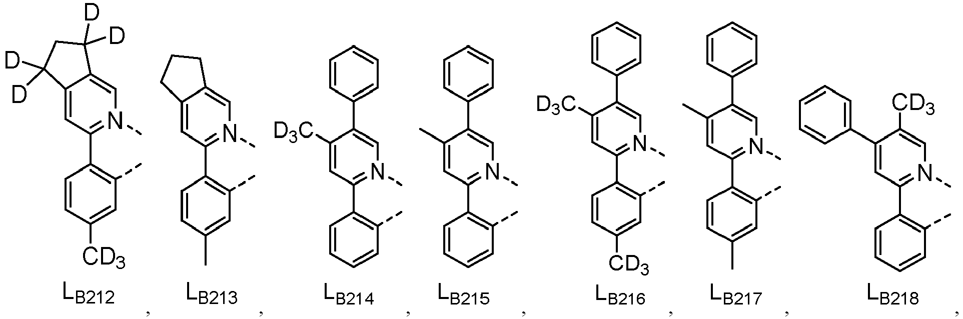 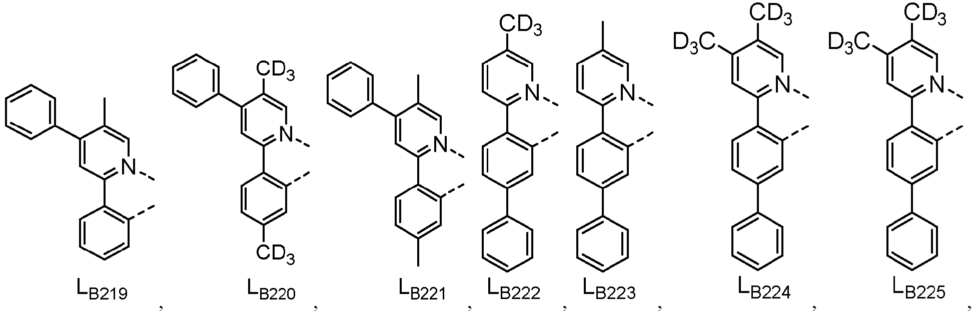 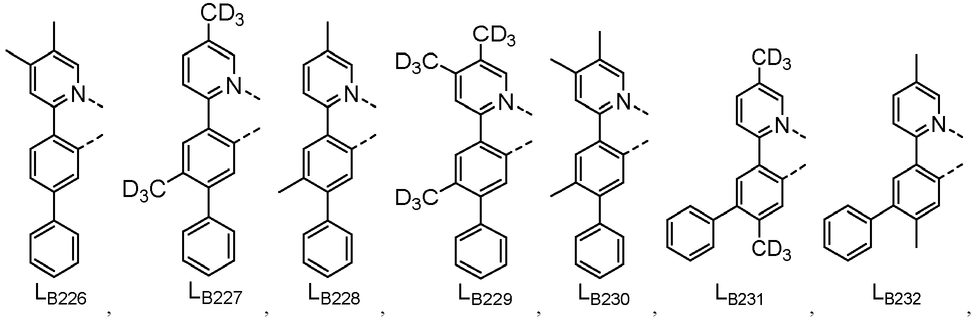 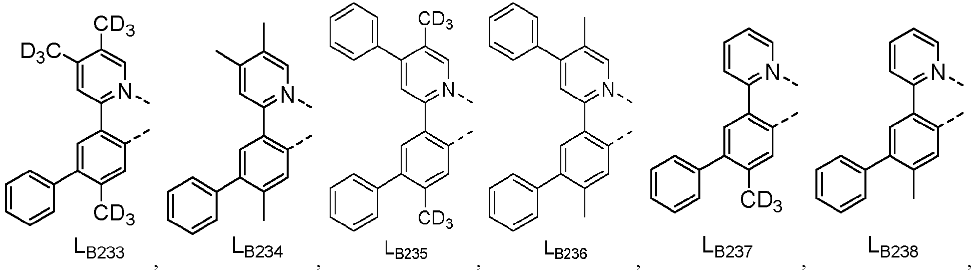 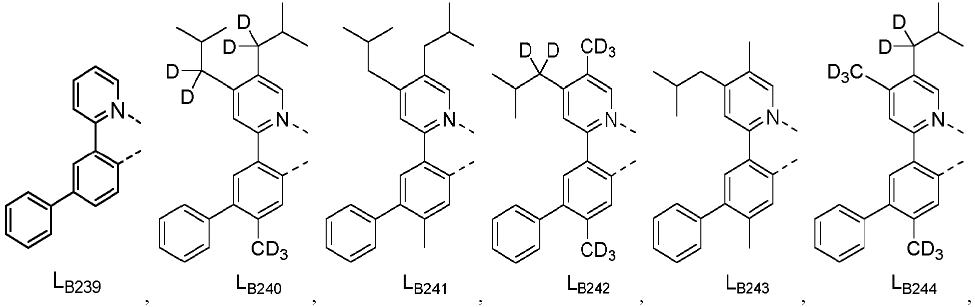 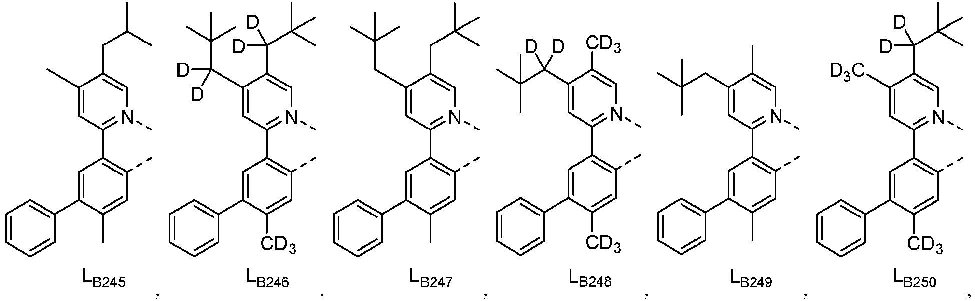 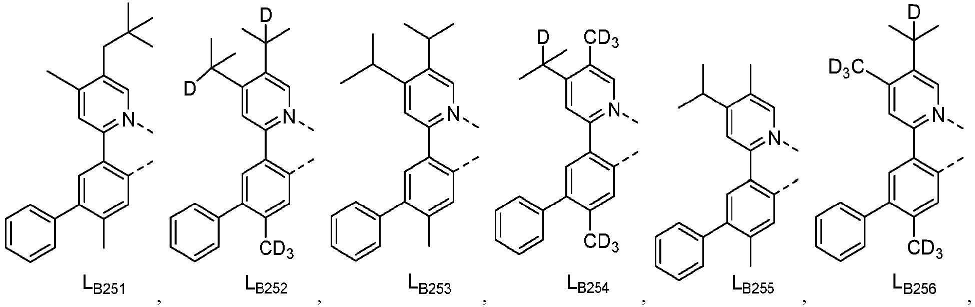 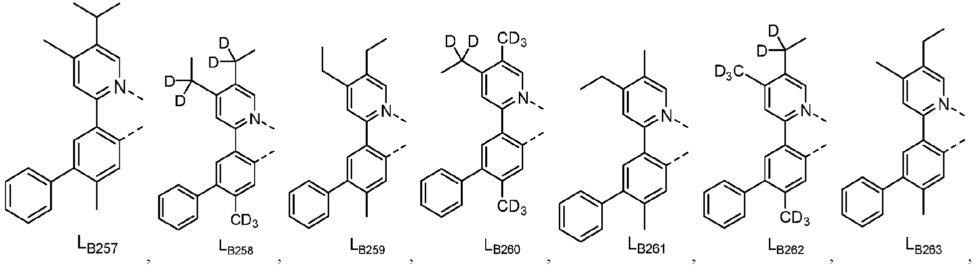 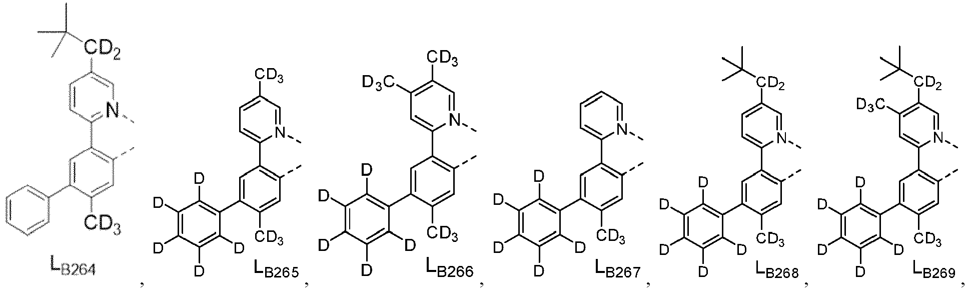 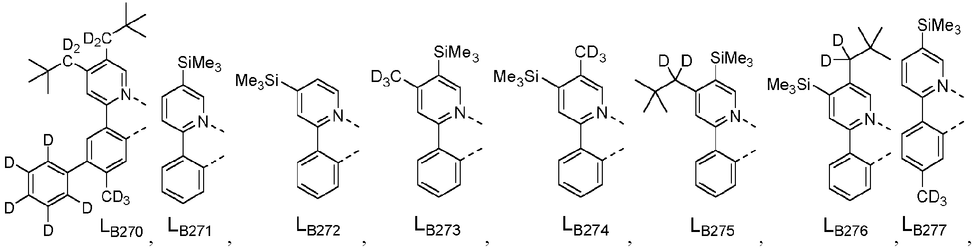 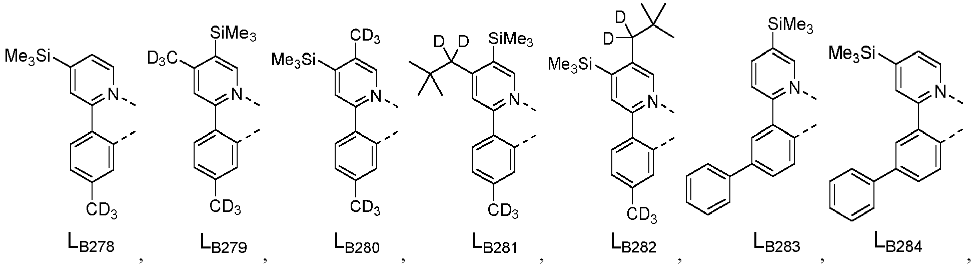 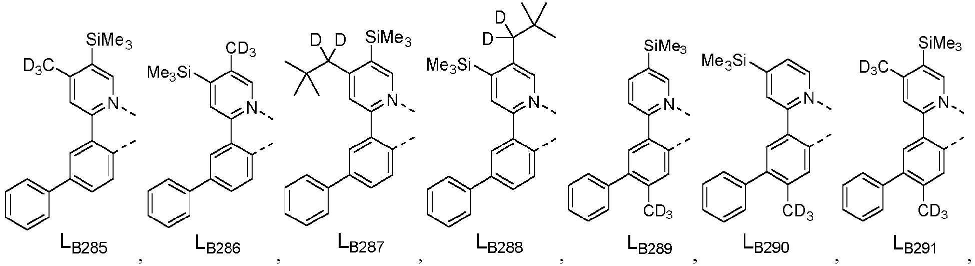 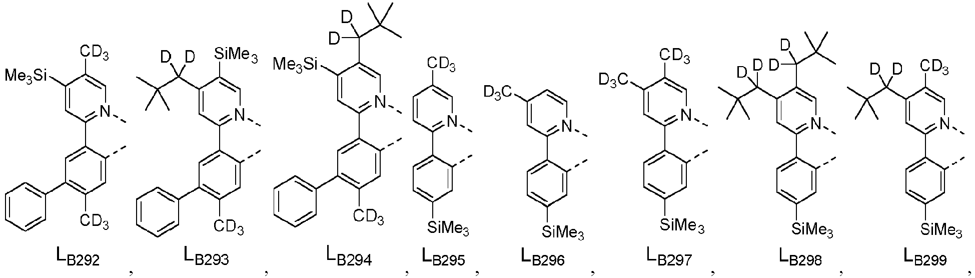 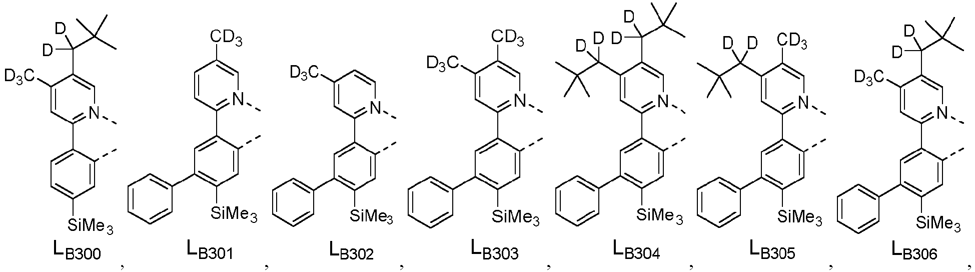 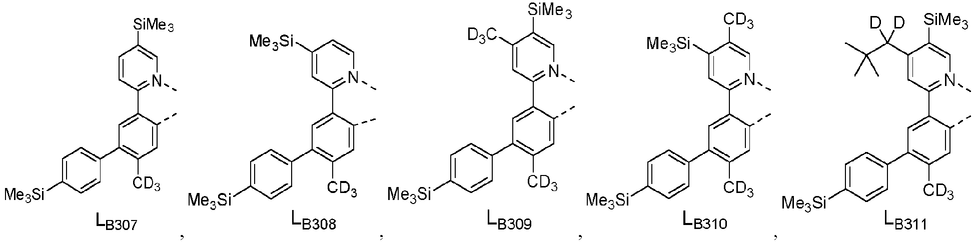 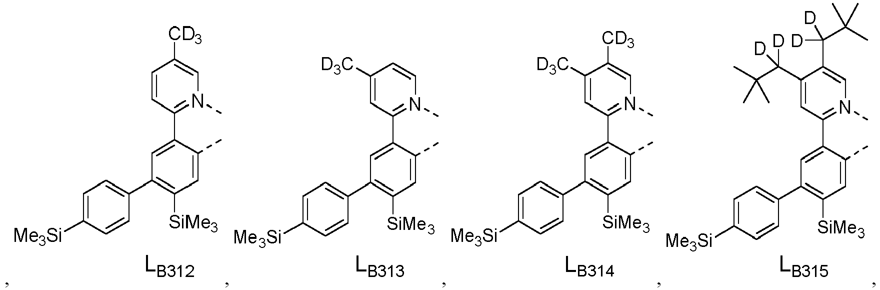 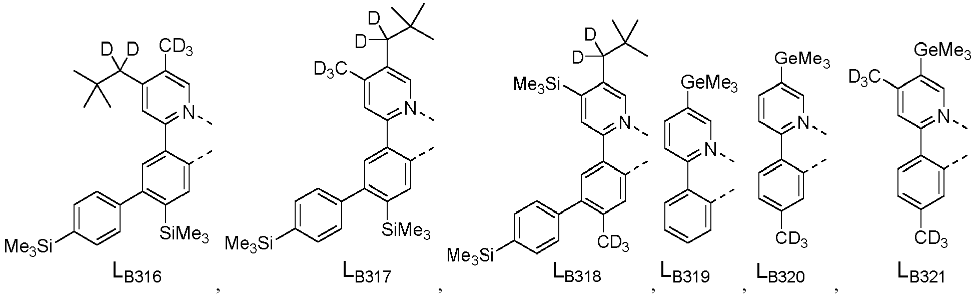 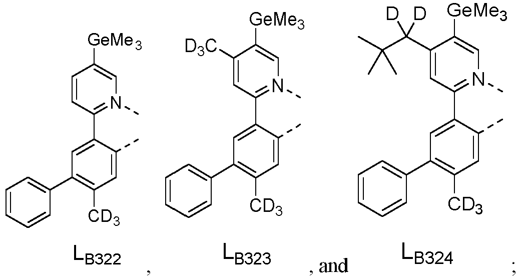
wherein each L_{*Cj*-I} has a structure based on formula 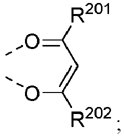 and
each L_{*Cj*-II} has a structure based on formula 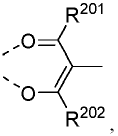 wherein for each L*_{Cj}* in L_{*Cj*-I} and L_{*Cj*-II}, R²⁰¹ and R²⁰² are each independently defined in the following LIST 9: 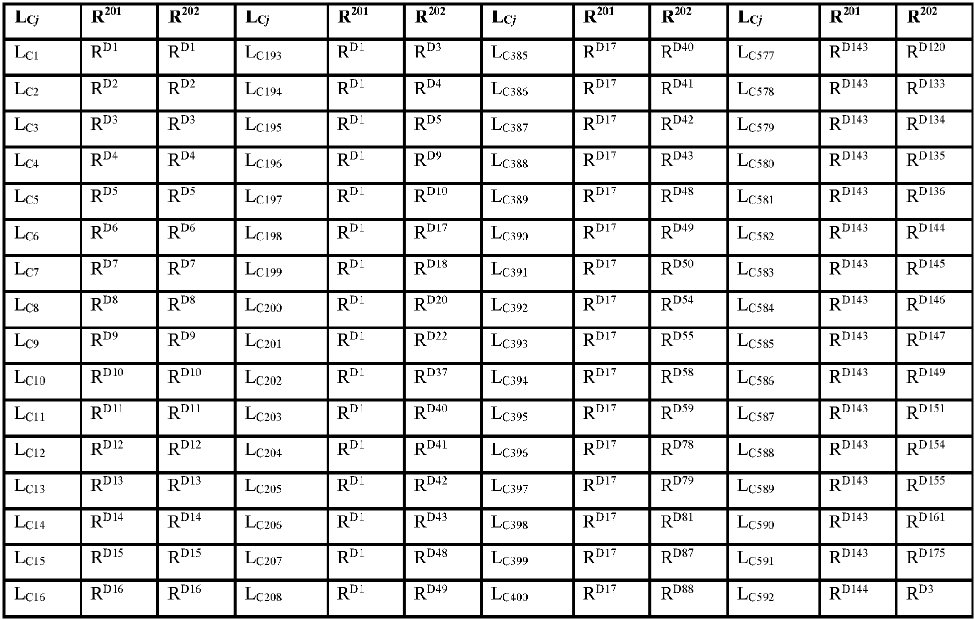 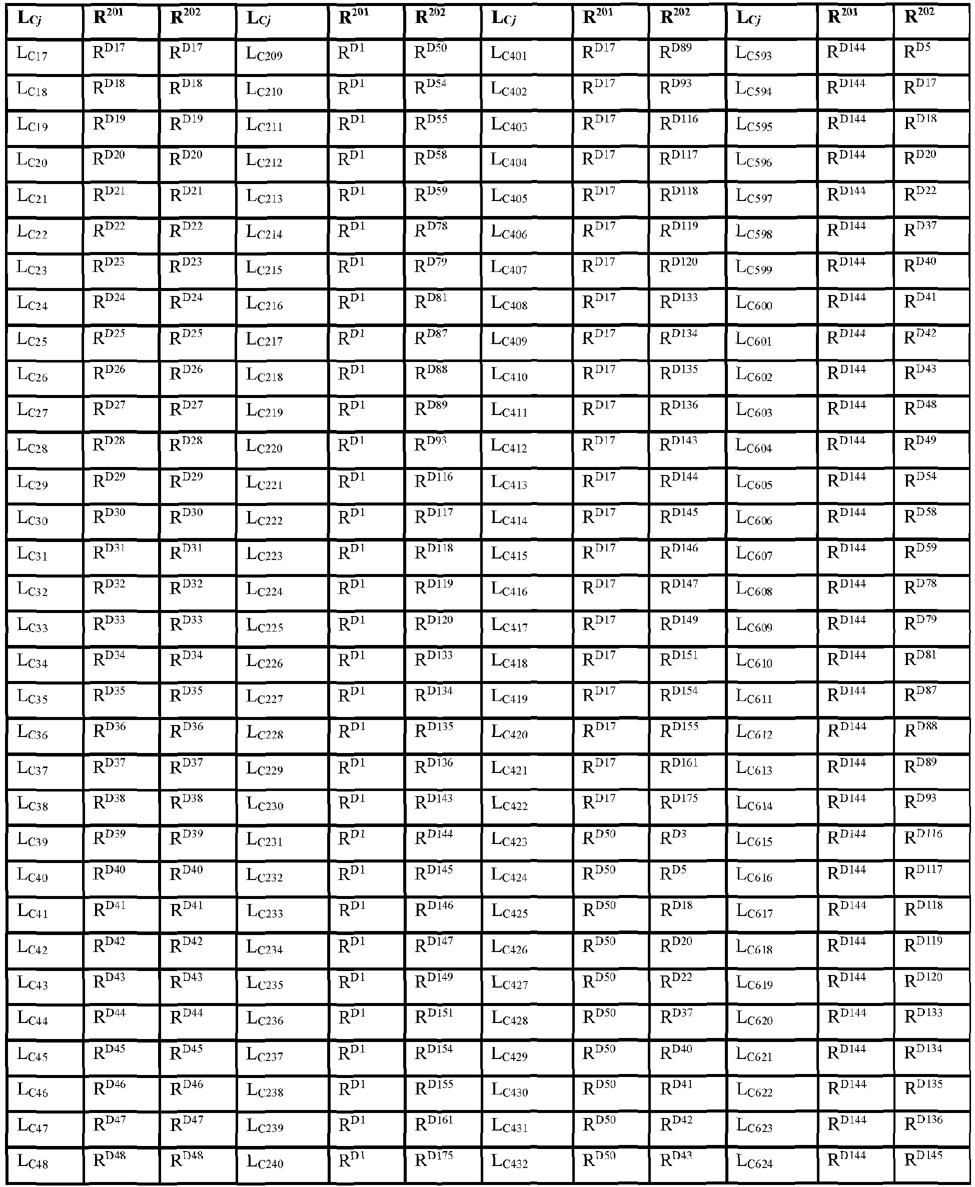 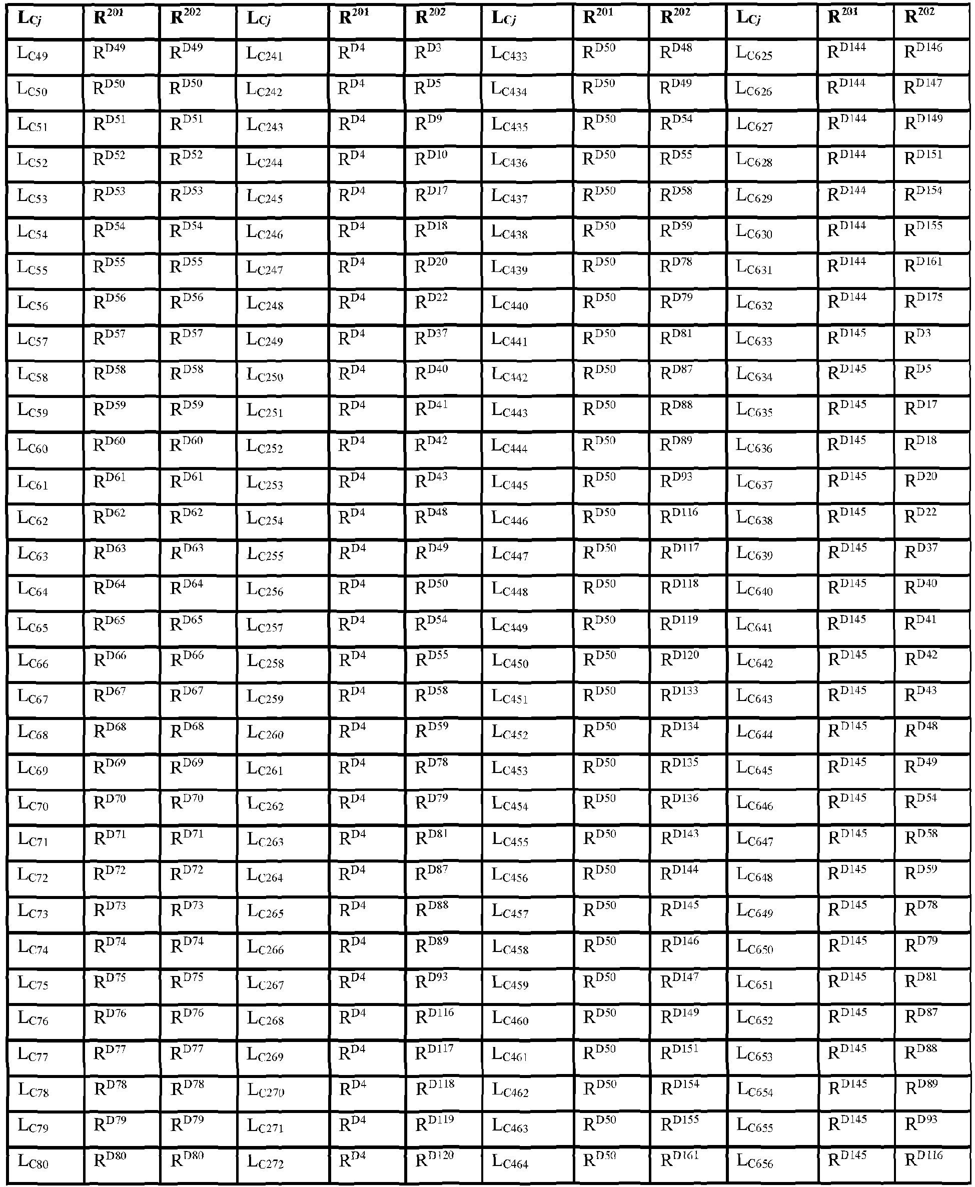 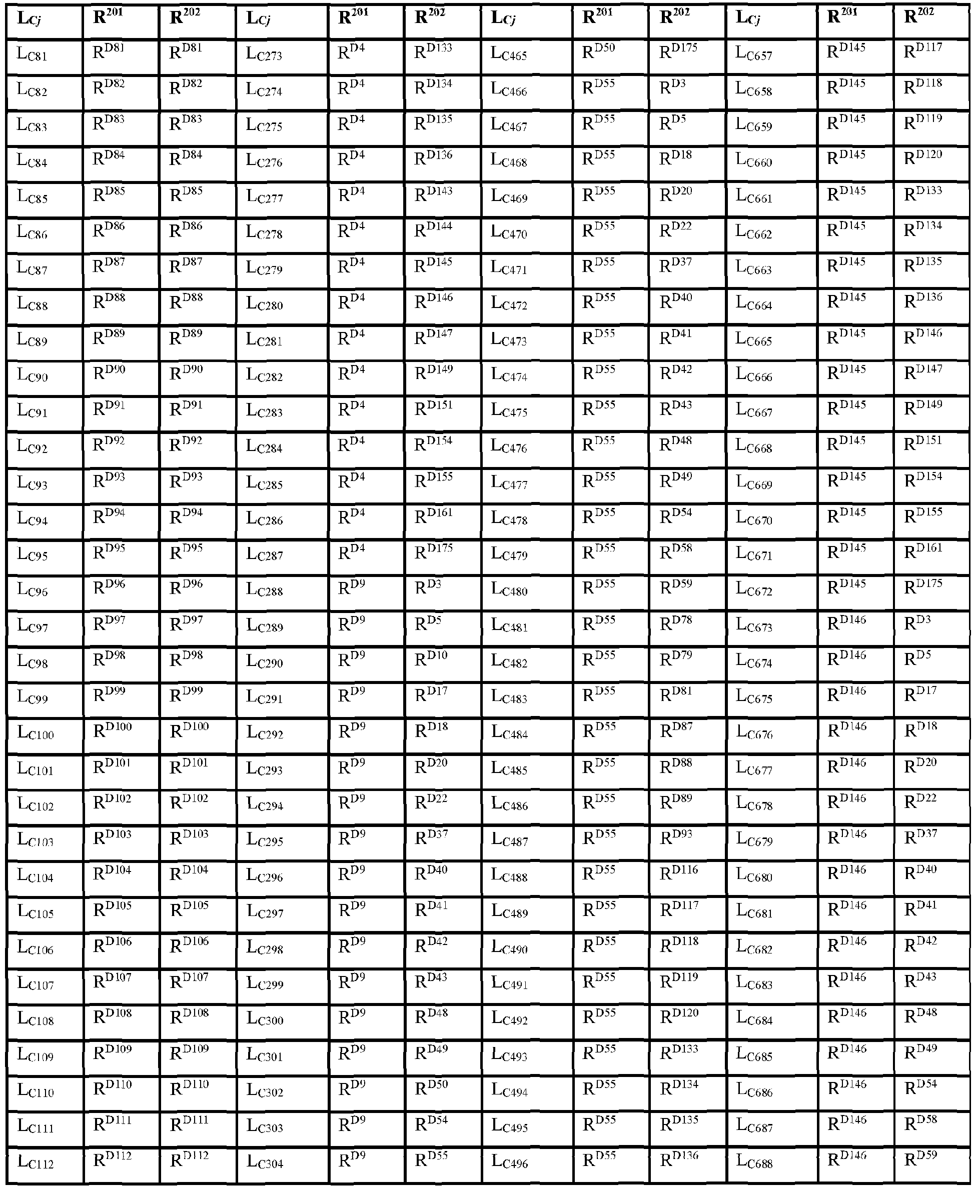 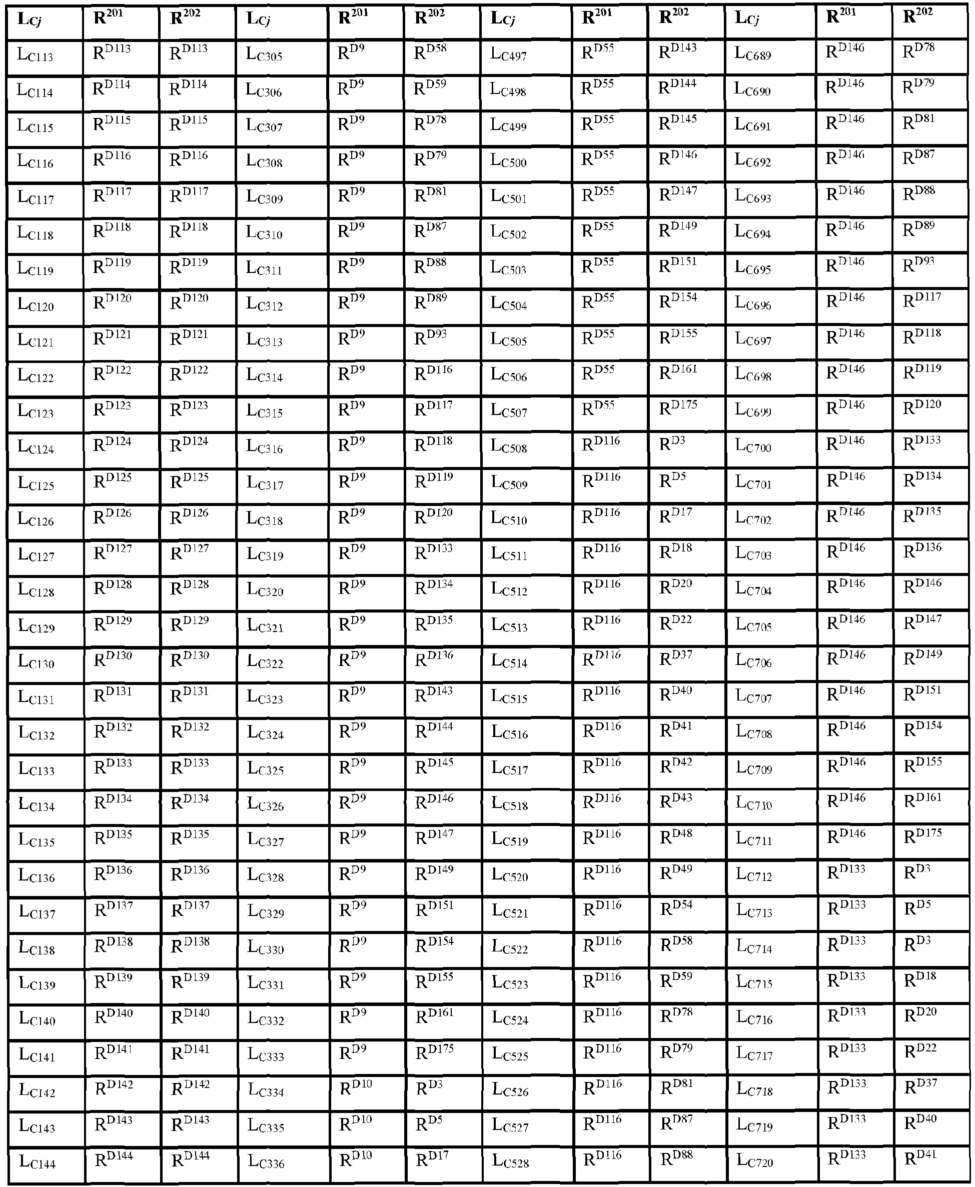 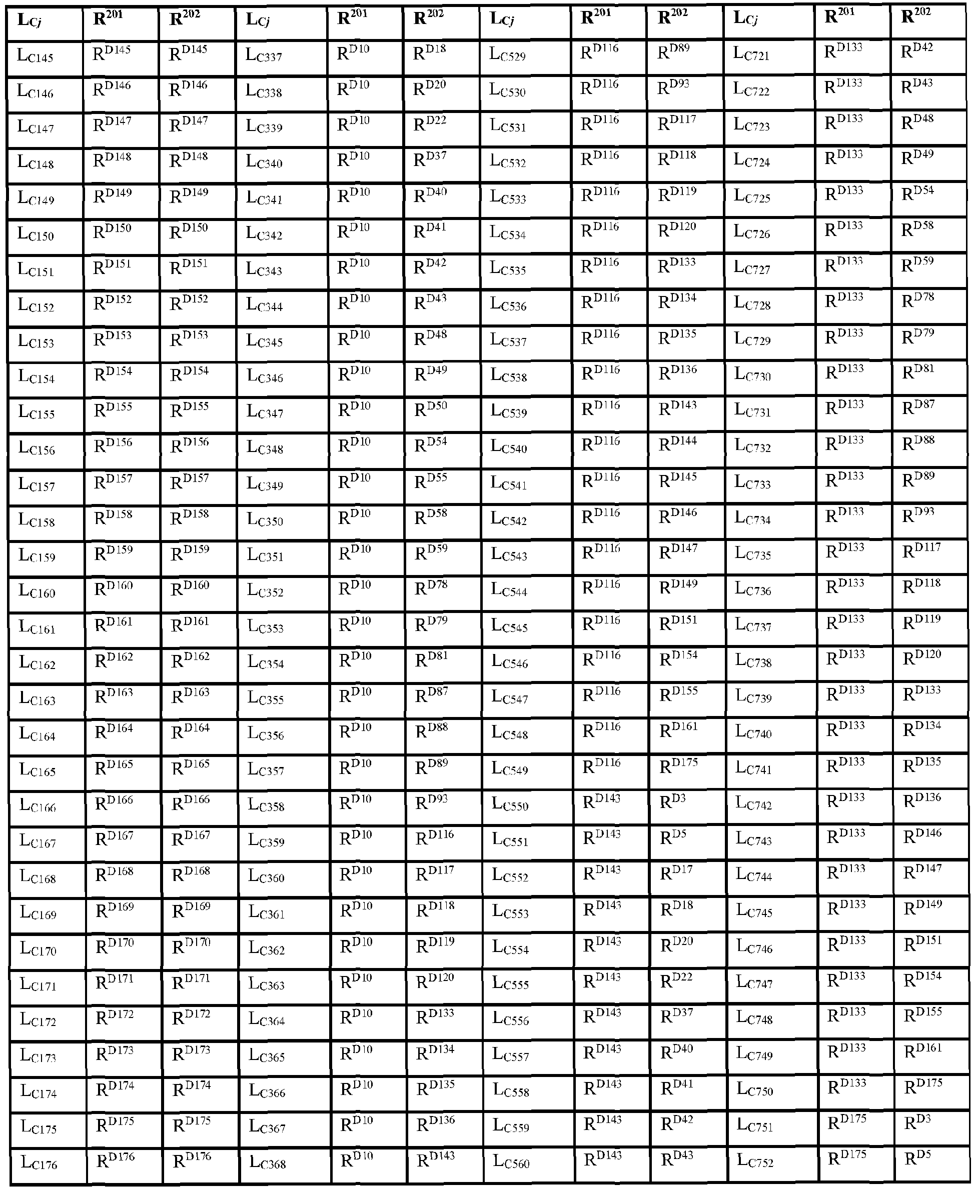 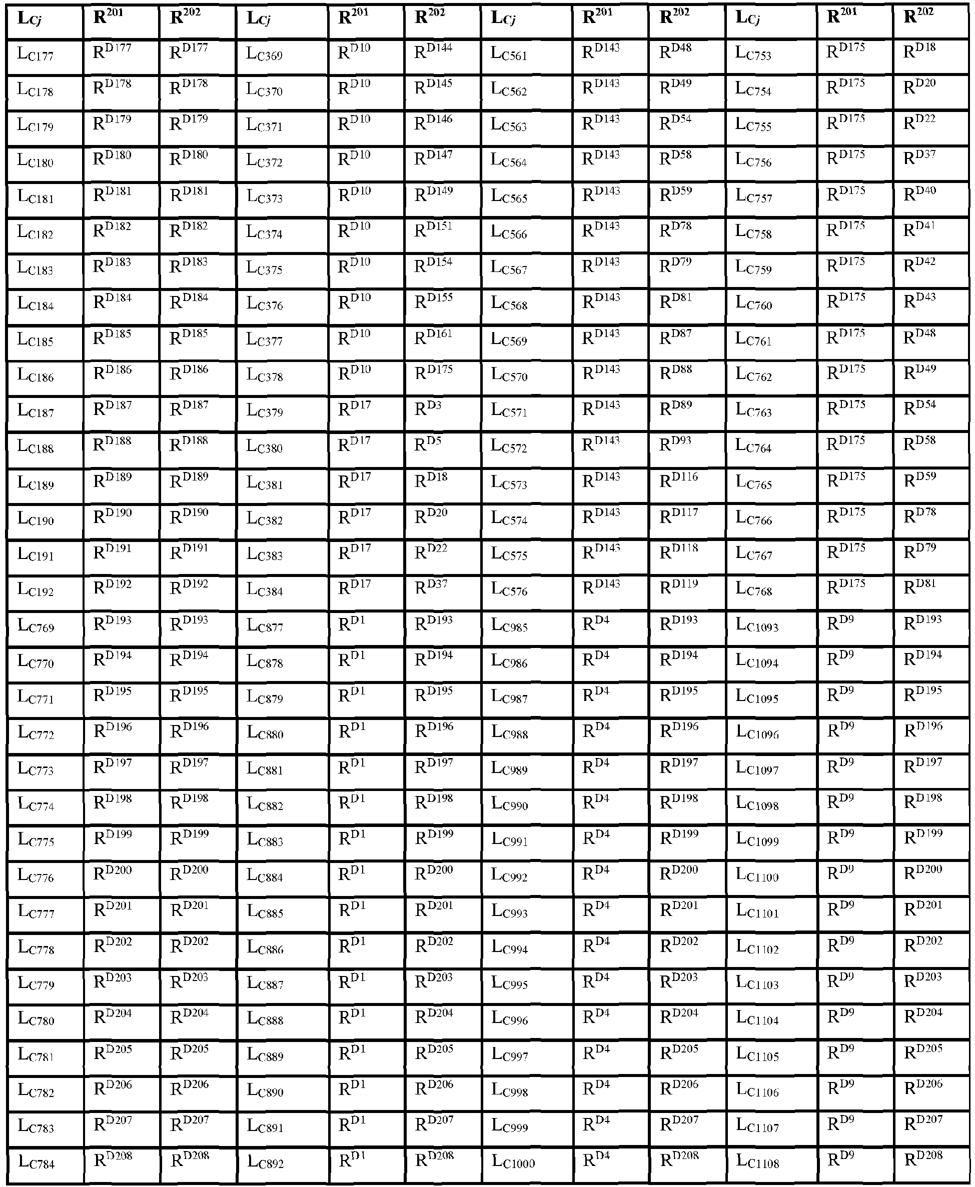 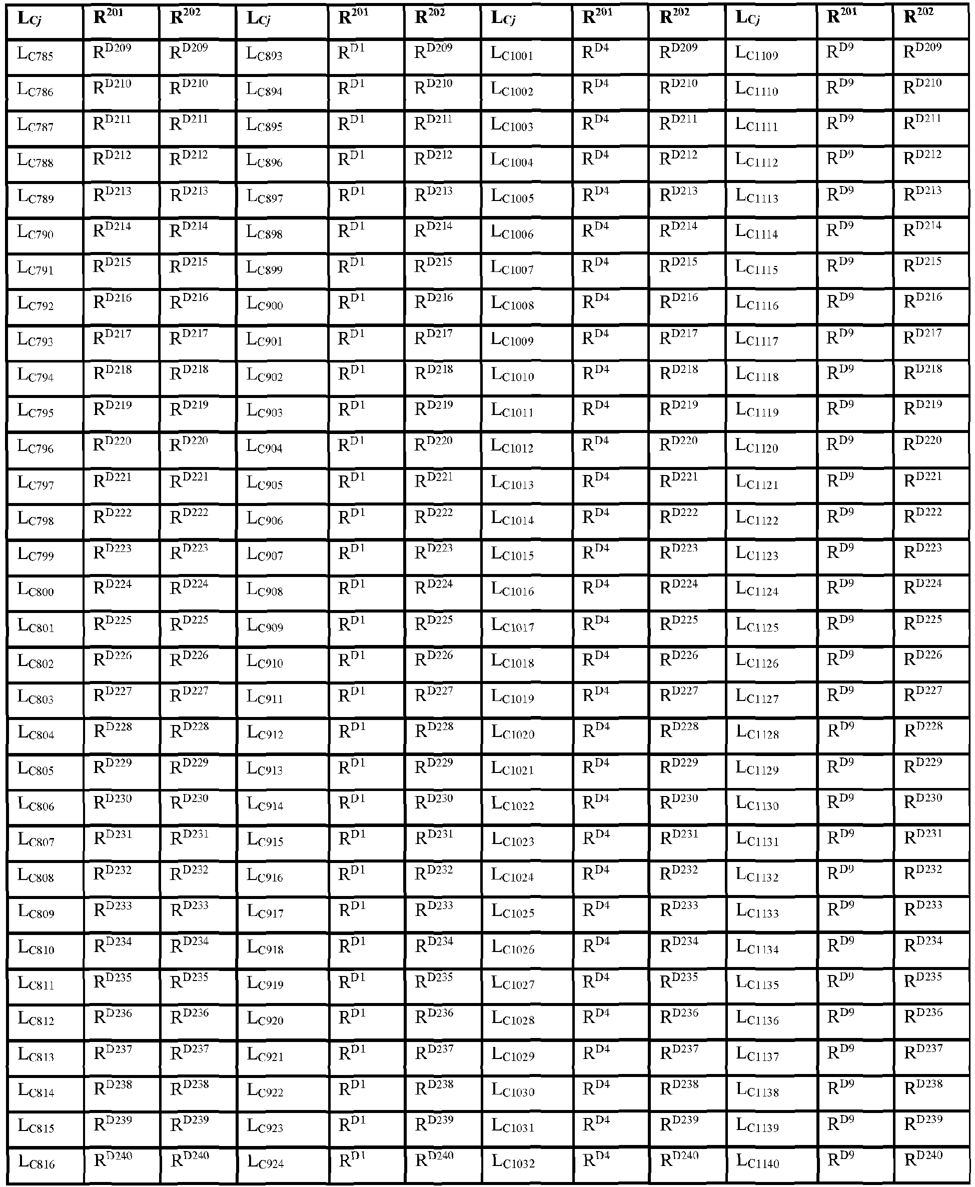 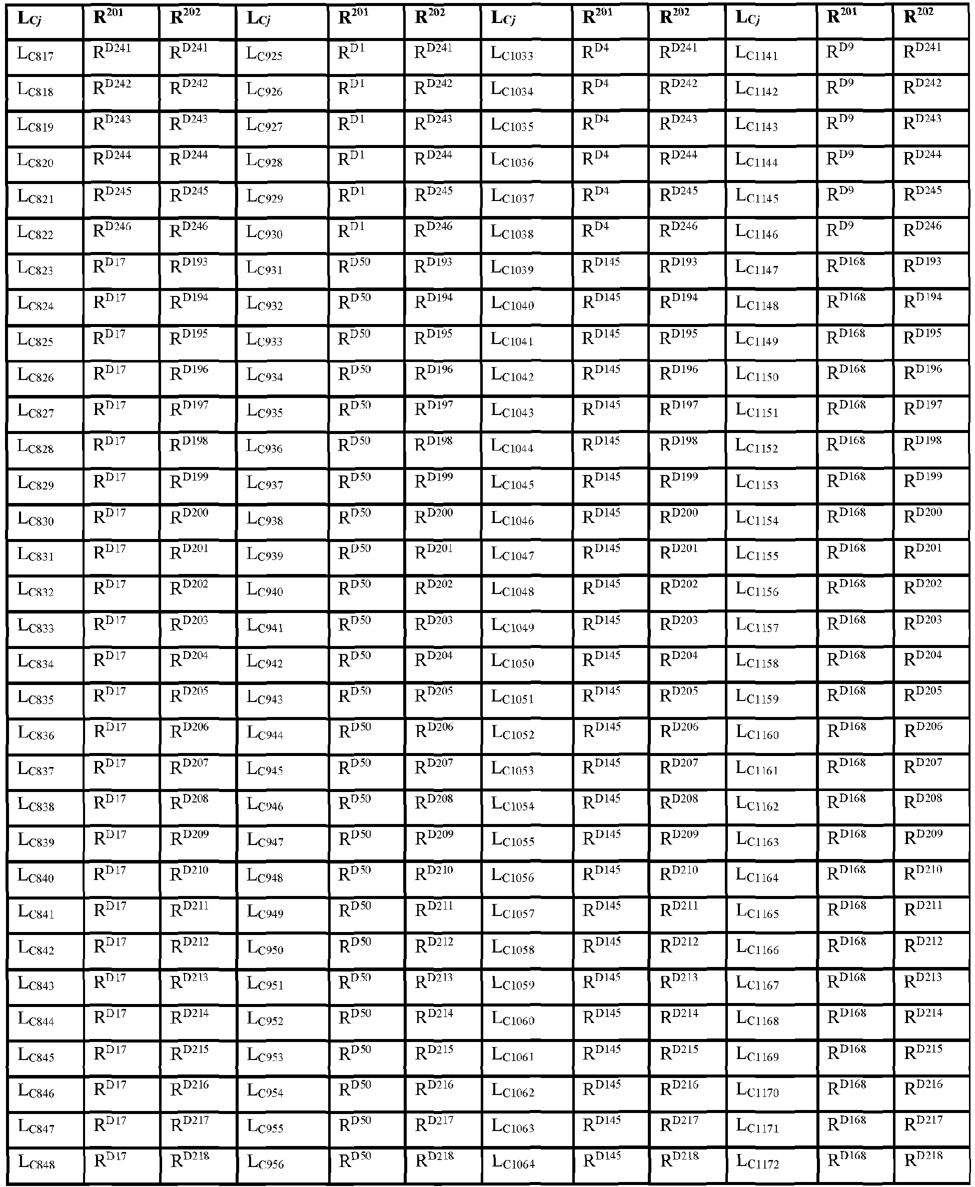 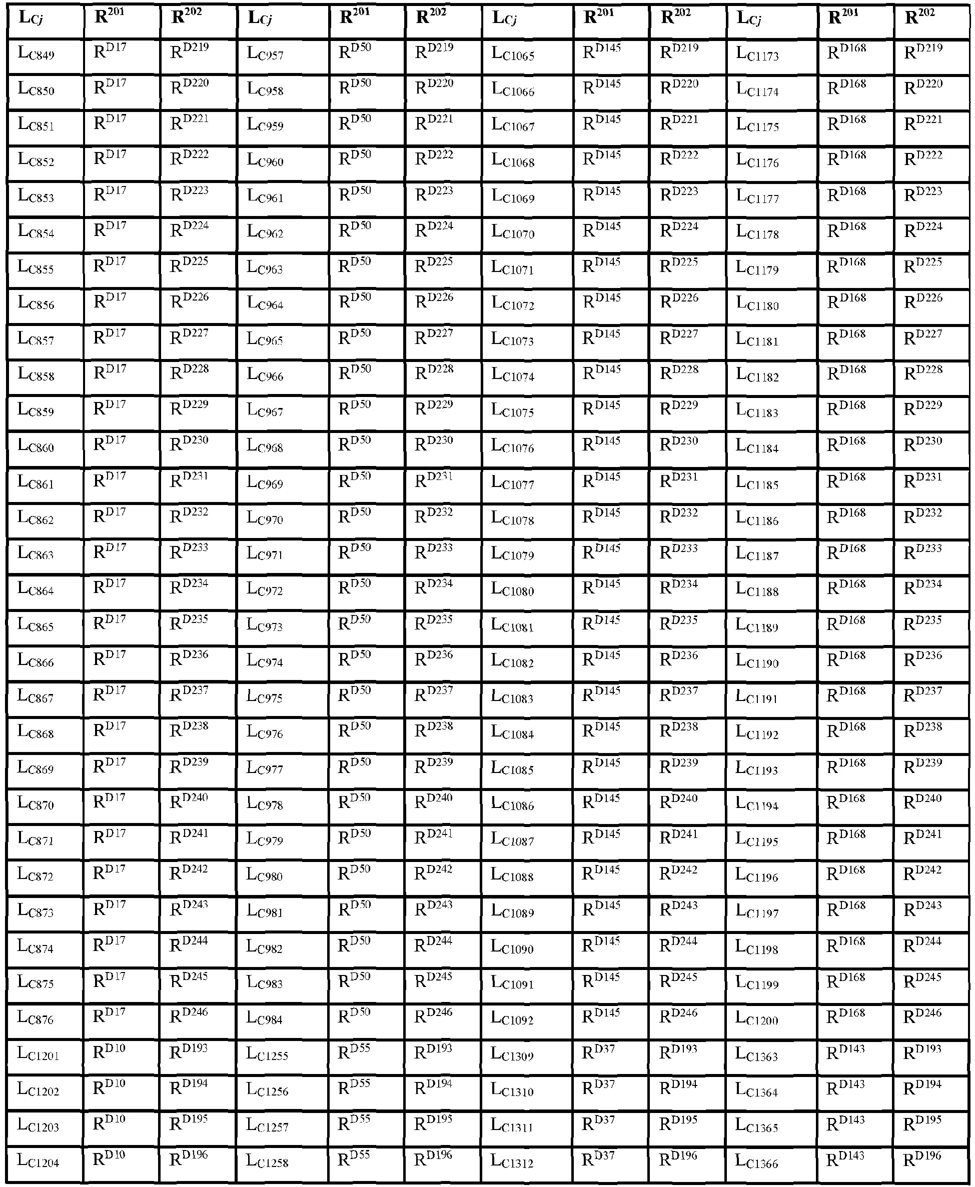 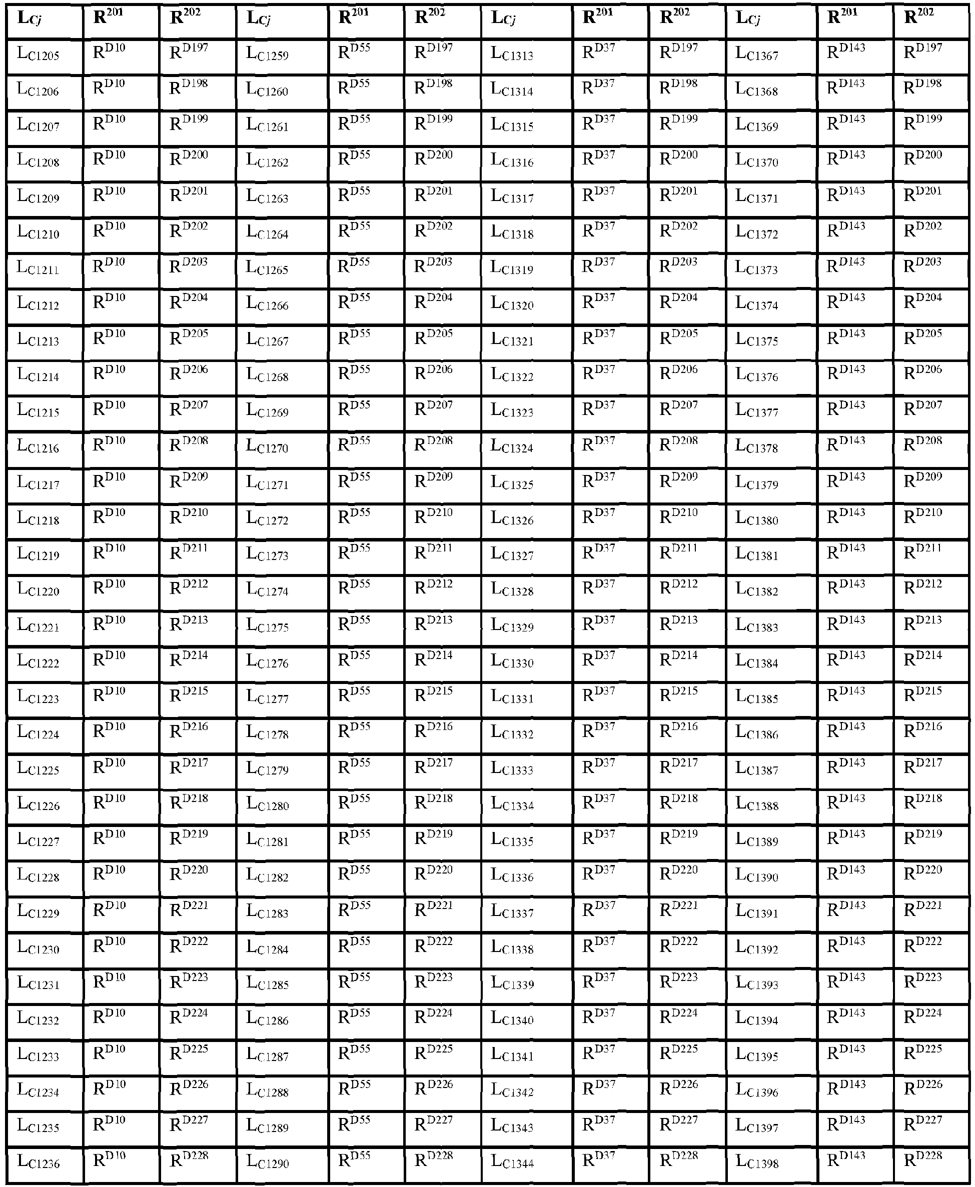 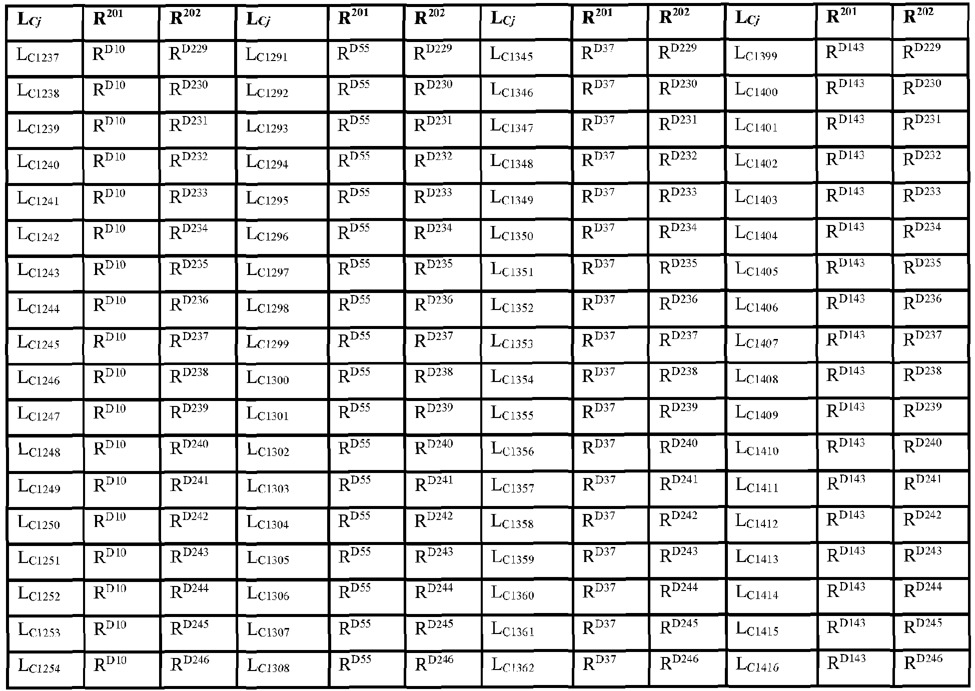
wherein R^{D1} to R^{D246} have the structures of the following LIST 10:

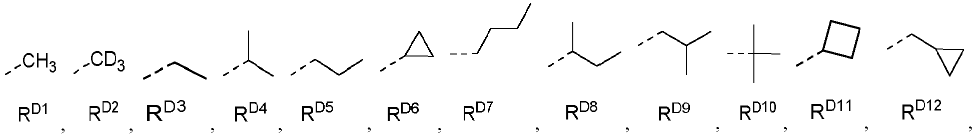

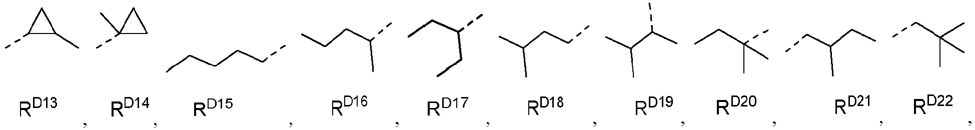

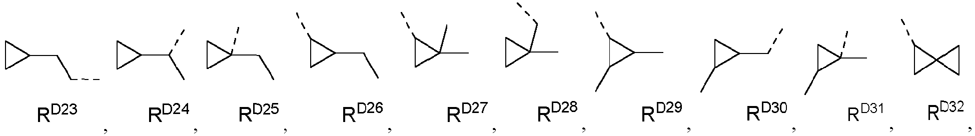

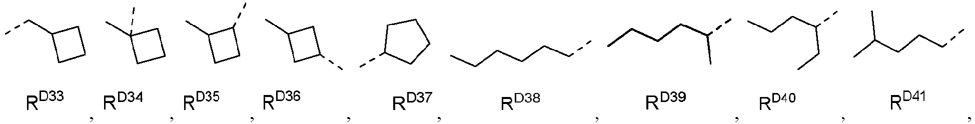

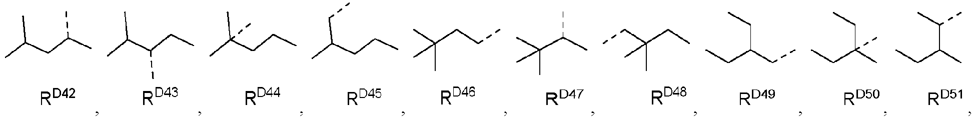

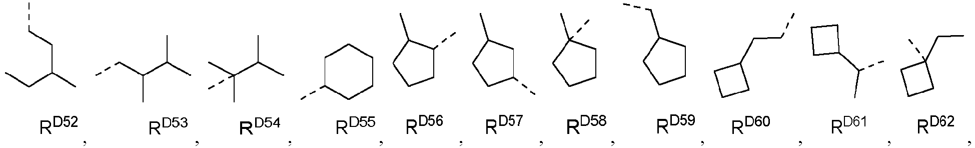

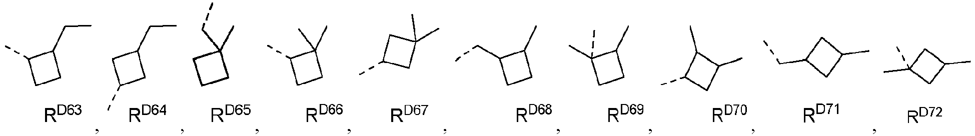

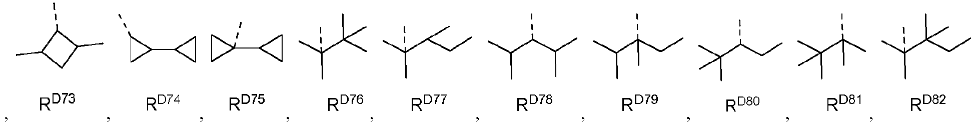

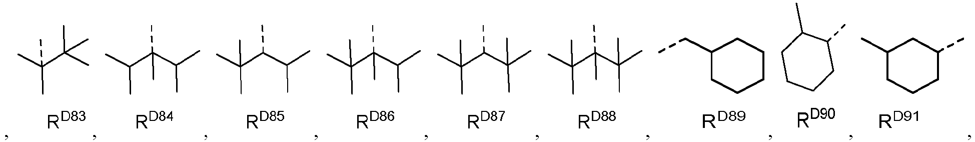

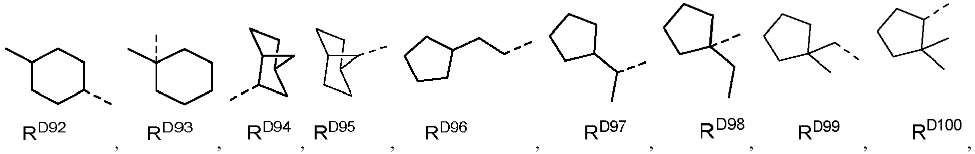

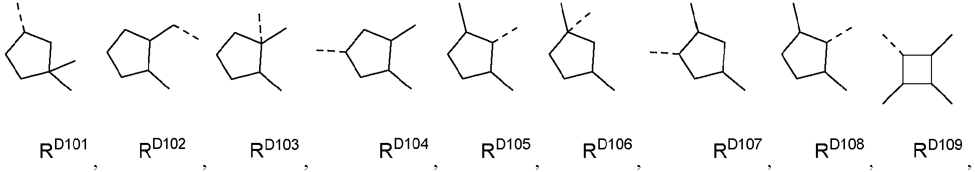

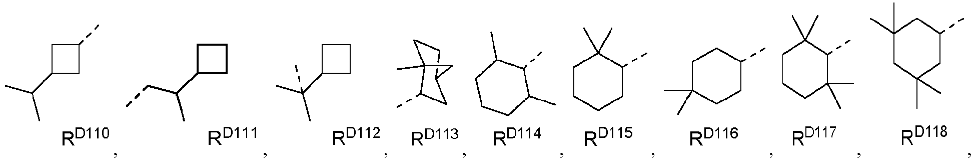

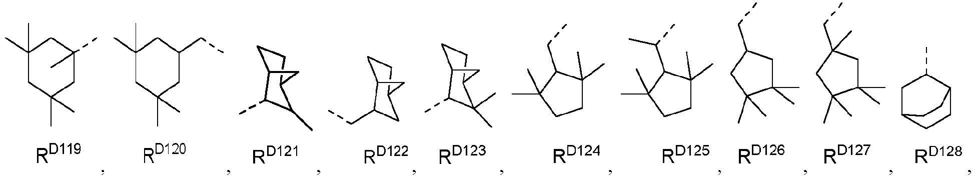

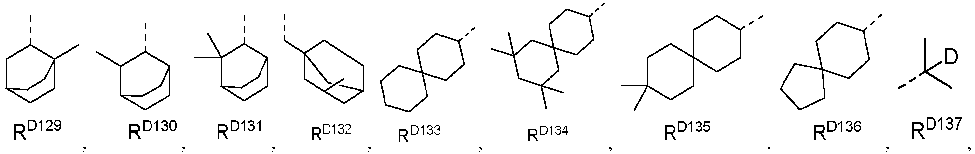

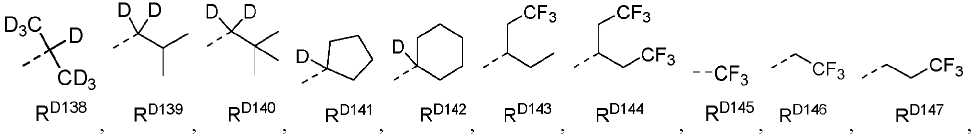

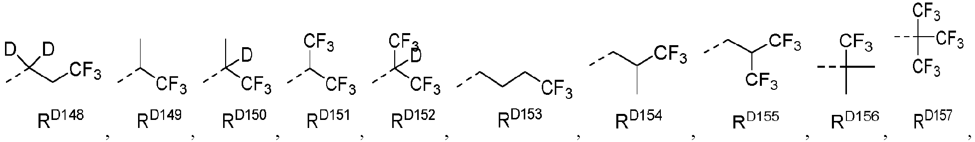

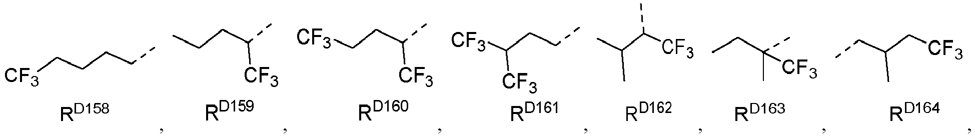

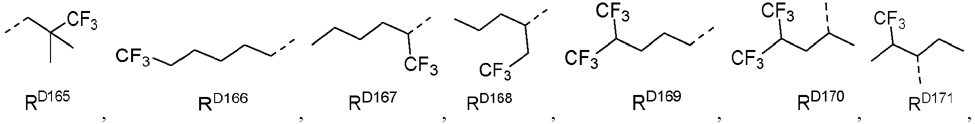

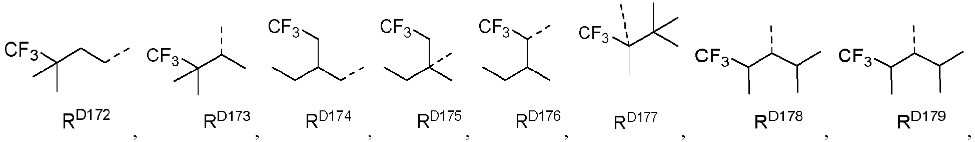

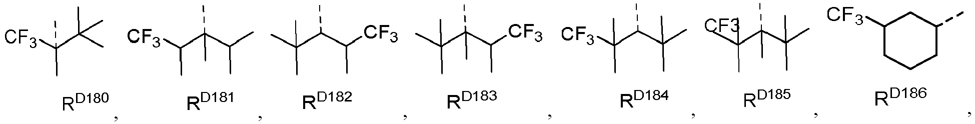

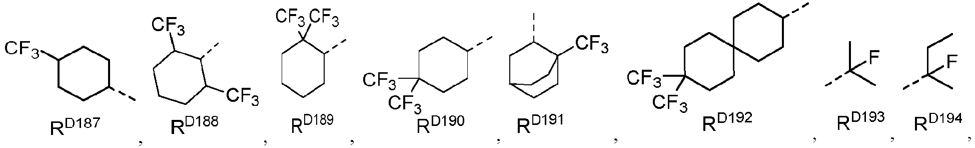

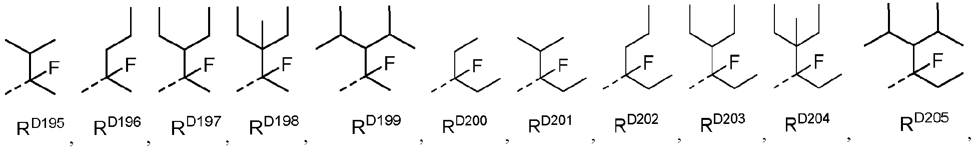

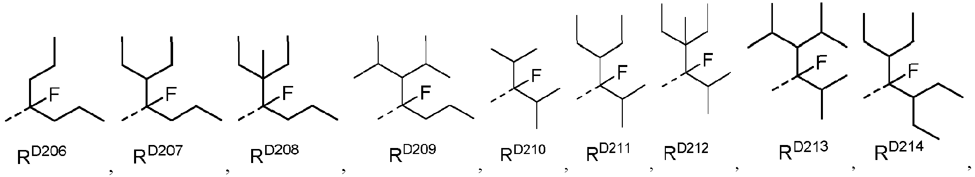

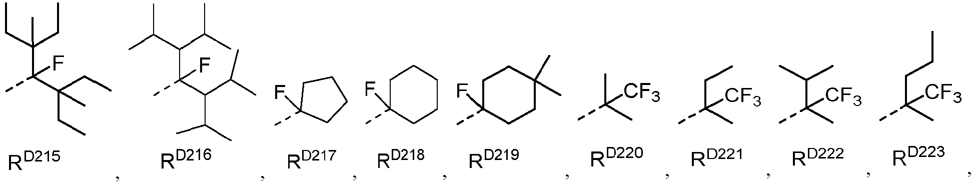

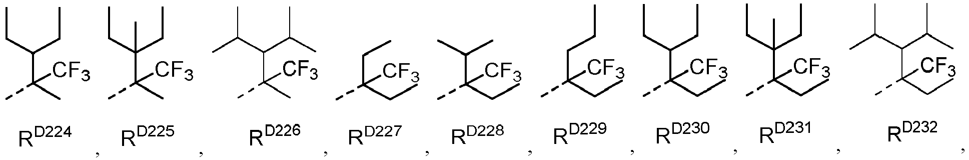

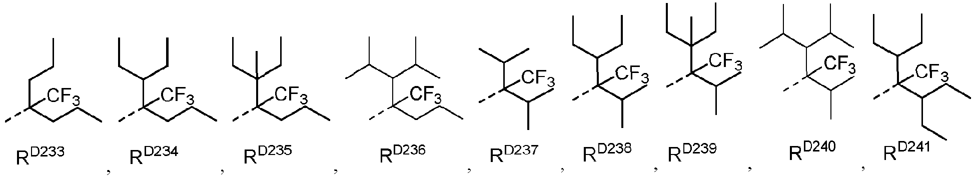

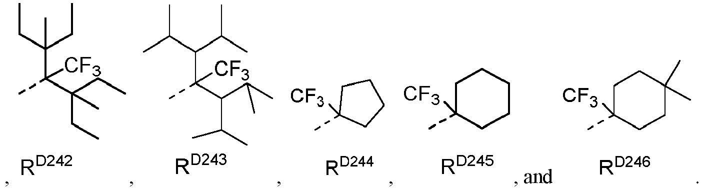

In some embodiments, the compound has the formula Ir(L_{*Ai*-*m*-*X*})(L_{B*k*})₂ or Ir(L_{*Ai-m*-*X*})₂(L_{B*k*}), wherein the compound is selected from the group consisting of only those compounds having one of the following structures for the L_{B*k*} ligand: L_{B1}, L_{B2}, L_{B18}, L_{B28}, L_{B38}, L_{B108}, L_{B118}, L_{B122}, L_{B124}, L_{B126}, L_{B128}, L_{B130}, L_{B32}, L_{B134}, L_{B136}, L_{B138}, L_{B140}, L_{B142}, L_{B144}, L_{B156}, L_{B38}, L_{B160}, L_{B162}, L_{B164}, L_{B168}, L_{B172}, L_{B175}, L_{B204}, L_{B206}, L_{B214}, L_{B216}, L_{B218}, L_{B220}, L_{B222}, L_{B231}, L_{B233}, L_{B235}, L_{B237}, L_{B240}, L_{B242}, L_{B244}, L_{B246}, L_{B248}, L_{B250}, L_{B252}, L_{B254}, L_{B256}, L_{B258}, L_{B260}, L_{B262}, L_{B263}, L_{B264}, L_{B265}, L_{B266}, L_{B267}, L_{B268}, L_{B269}, and L_{B270}.

In some embodiments, the compound has the formula Ir(L*_{Ai-m-X}*)(LB*k*)₂ or Ir(L_{*Ai-m*-*X*})₂(L_{B*k*}), wherein the compound is selected from the group consisting of only those compounds having one of the following structures for the L_{B*k*} ligand: L_{B1}, L_{B2}, L_{B18}, L_{B28}, L_{B38}, L_{B108}, L_{B118}, L_{B122}, L_{B124}, L_{B126}, L_{B128}, L_{B132}, L_{B136}, L_{B138}, L_{B142}, L_{B156}, L_{B162}, L_{B204}, L_{B206}, L_{B214}, L_{B216}, L_{B218}, L_{B220}, L_{B231}, LB233, LB237, L_{B265}, L_{B266}, LB₂₆₇, LB₂₆₉, LB₂₆₉, and LB₂₇₀.

In some embodiments, the compound has the formula Ir(L_{*Ai*-*m*-*X*})₂(L_{*Cj*-I}) or Ir(L*_{Ai-m-X}*)₂(L_{*Cj*-II}), wherein the compound is selected from the group consisting of only those compounds having L_{*Cj-*I} or L_{*Cj*-II} ligand whose corresponding R²⁰¹ and R²⁰² are defined to be one the structures of the following LIST 11:

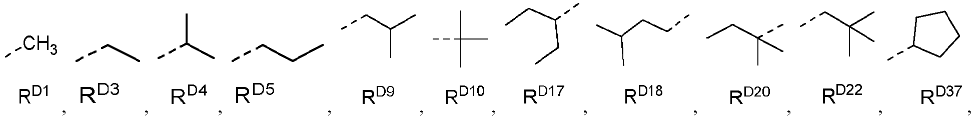

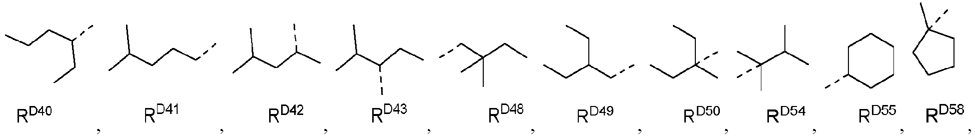

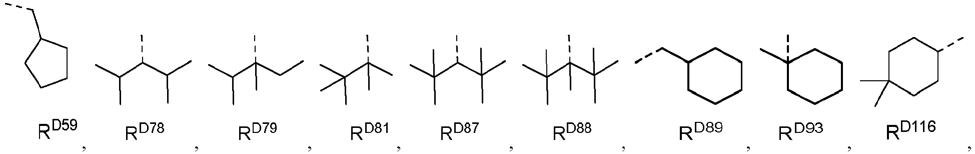

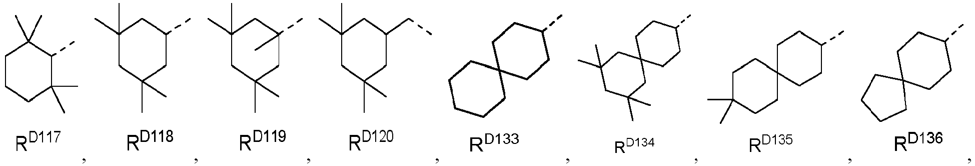

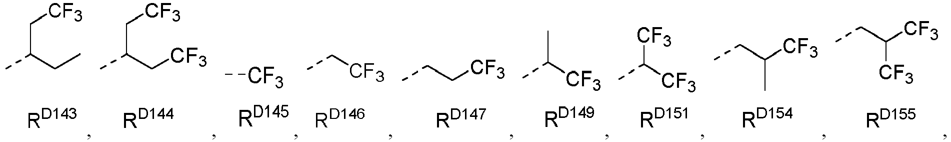

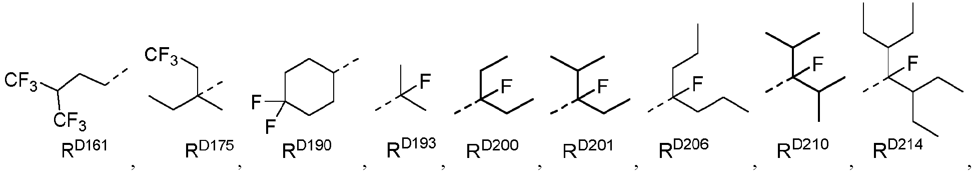

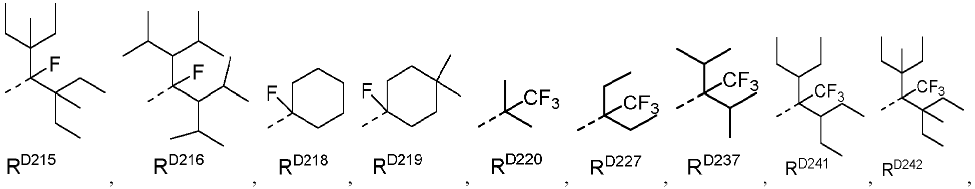

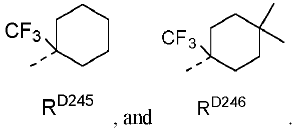

In some embodiments, the compound has the formula Ir(L_{*Ai*-*m*-*X*})₂(L_{*Cj-*I}) or Ir(L_{*Ai-m*-*X*})₂(L_{*Cj*-II}), wherein the compound is selected from the group consisting of only those compounds having L_{*Cj*-I} or L_{*Cj*-II} ligand whose corresponding R²⁰¹ and R²⁰² are defined to be one of the structures of the following LIST 12:

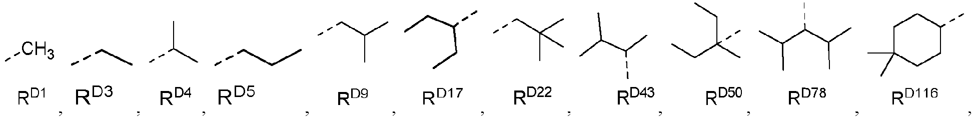

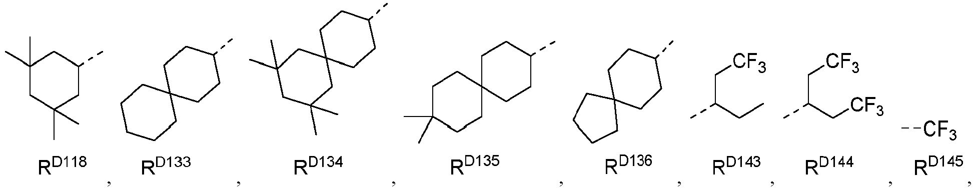

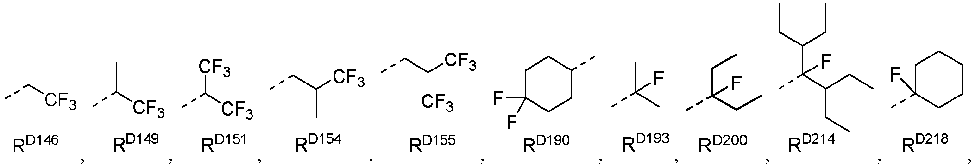

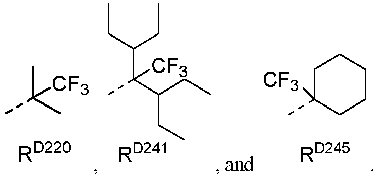

In some embodiments, the compound has the formula Ir(L_{*Ai*-*m*-*X*})₂(L_{*Cj-*I}), and the compound is selected from the group consisting of only those compounds having one of the structures of the following LIST 13 for the L_{*Cj*-I} ligand:

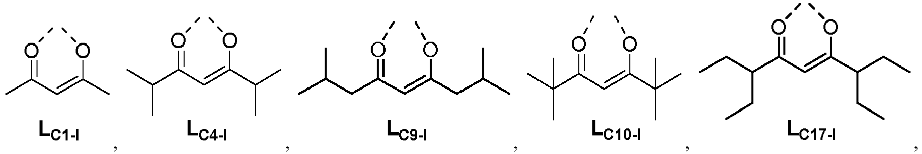

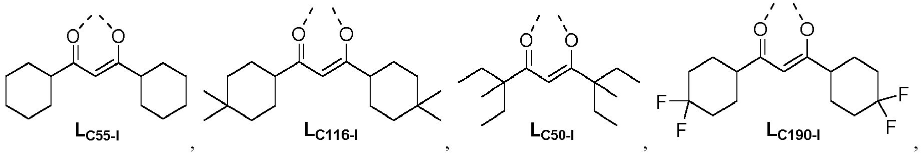

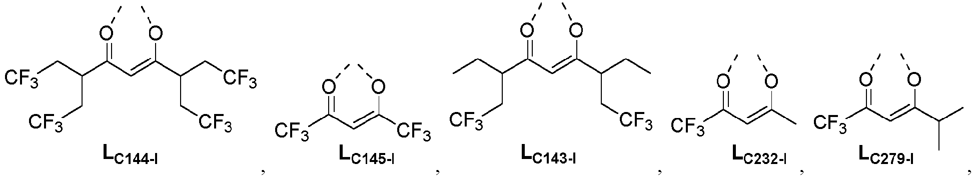

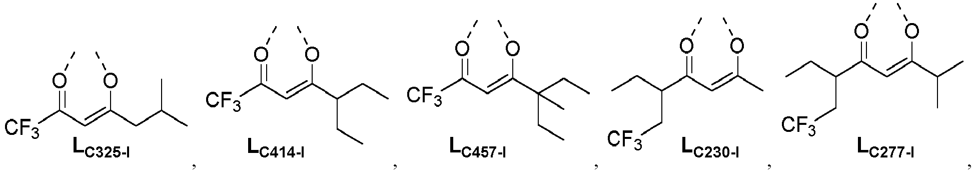

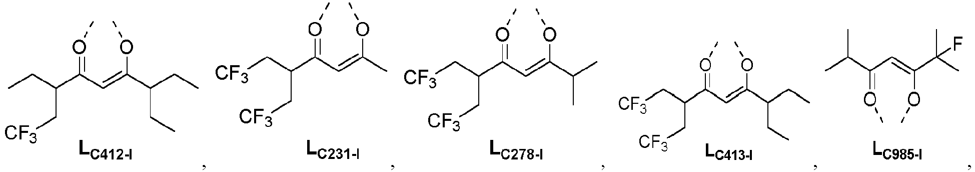

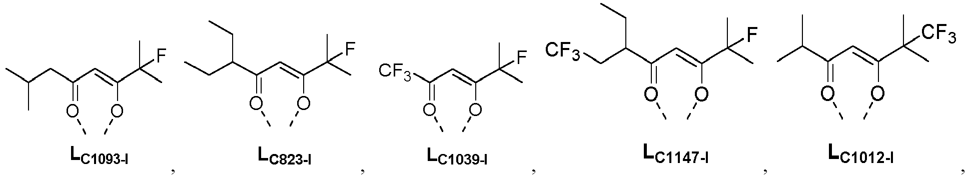

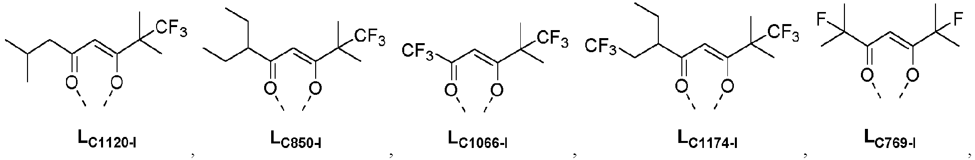

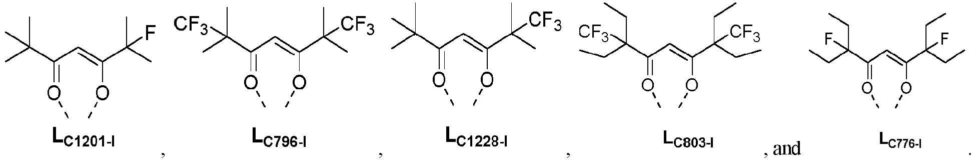

In some embodiments, the compound is selected from the group consisting of the structures of the following LIST 14:

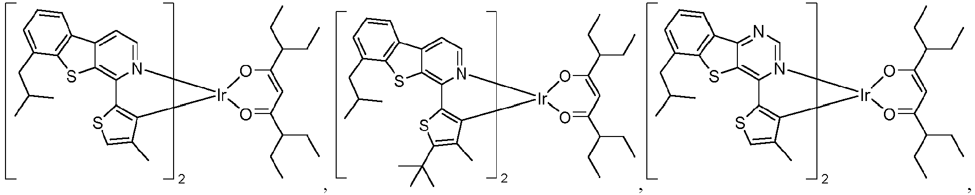

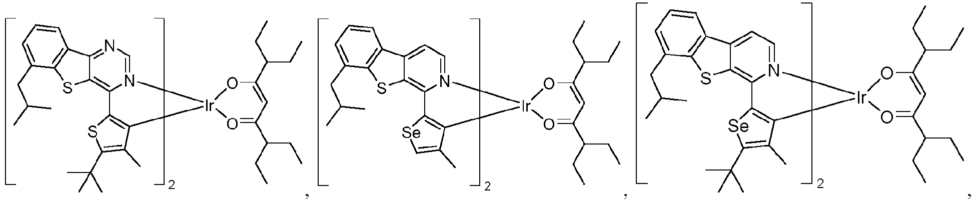

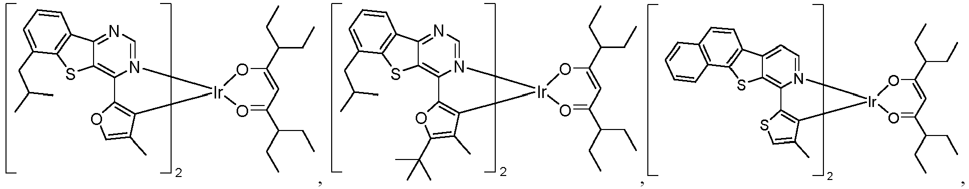

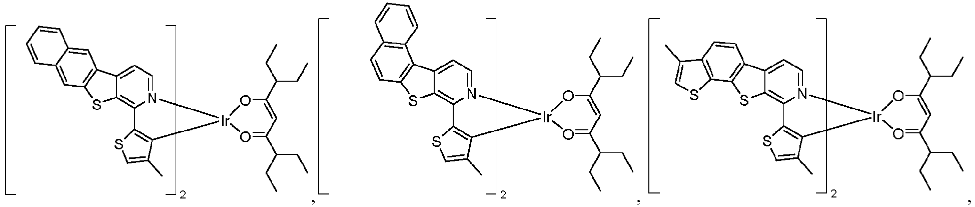

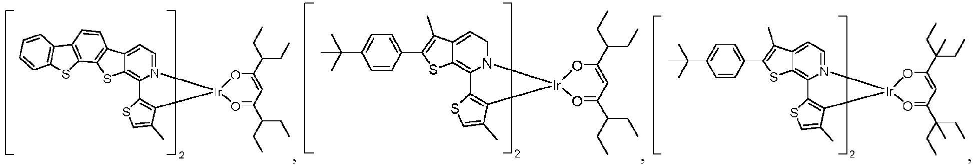

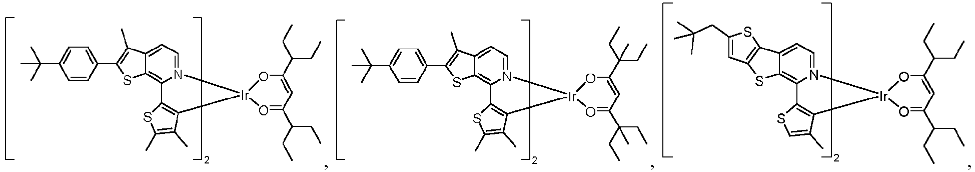

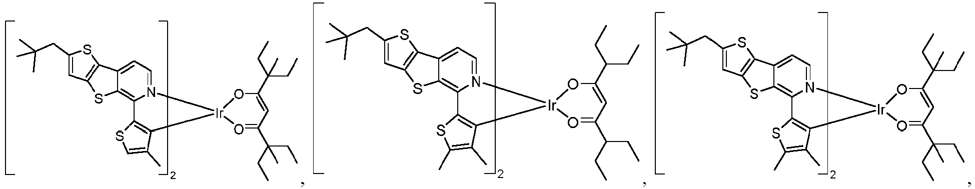

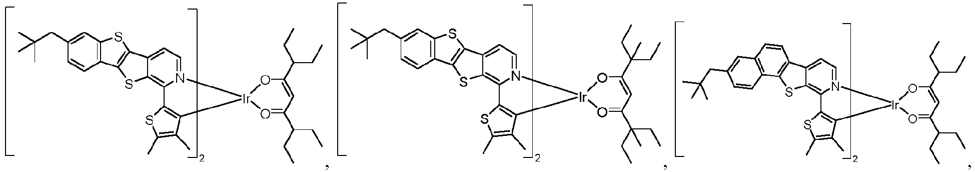

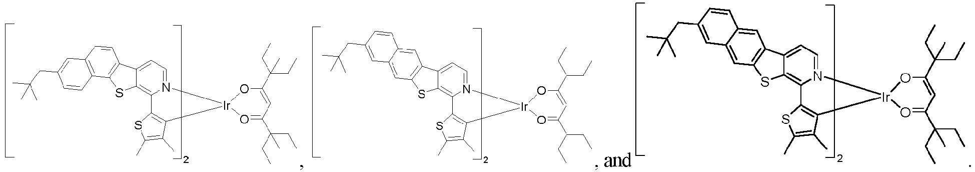

In some embodiments, the compound has a structure of Formula III, 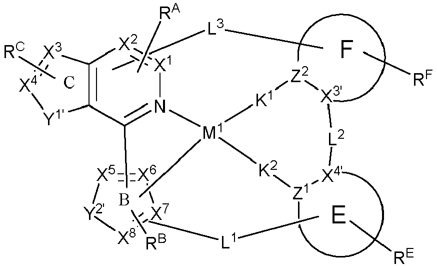 , wherein:
M¹ is Pd or Pt;
moieties E and F are each independently a monocyclic or polycyclic fused ring structure comprising 5-membered and/or 6-membered carbocyclic or heterocyclic rings;
Z¹ and Z² are each independently C or N;
K¹ and K² are each independently selected from the group consisting of a direct bond, O, and S, wherein at least one of K¹ and K² is a direct bond;
L¹, L², and L³ are each independently selected from the group consisting of a single bond, absent a bond, O, S, SO, SO₂, C=O, C=NR', C=CR'R", CR'R", SiR'R", BR', and NR', wherein at least one of L¹ and L² is present;
X^{3'} and X^{4'} are each independently C or N;
R^{E} and R^{F} each independently represent mono, or up to a maximum allowed substitution, or no substitutions;
each of R', R", R^{E}, and R^{F} is independently a hydrogen or a substituent selected from the group consisting of the Preferred General Substituents; and
any two adjacent R, R', R", R^{A}, R^{C}, R^{E}, and R^{F} can be joined or fused together to form a ring.

In some embodiments of Formula III, moiety E and moiety F are both 6-membered aromatic rings.

In some embodiments of Formula III, moiety F is a 5-membered or 6-membered heteroaromatic ring.

In some embodiments of Formula III, L¹ is O or CR'R".

In some embodiments of Formula III, Z² is N and Z¹ is C. In some embodiments of Formula III, Z² is C and Z¹ is N.

In some embodiments of Formula III, L² is a direct bond. In some embodiments of Formula III, L² is NR'. In some embodiments of Formula III, K¹ and K² are both direct bonds. In some embodiments of Formula III, X^{3'} and X^{4'} are both C.

In some embodiments, the compound has the structure 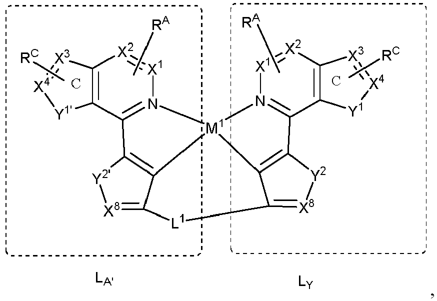 where M¹ is Pt or Pd.

In some embodiments, the compound is selected from the group consisting of the structures of the following LIST 15: 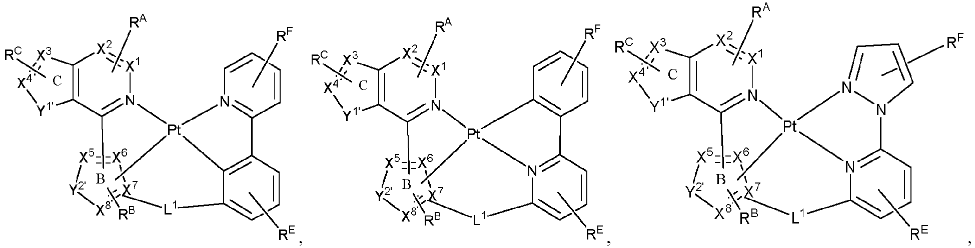 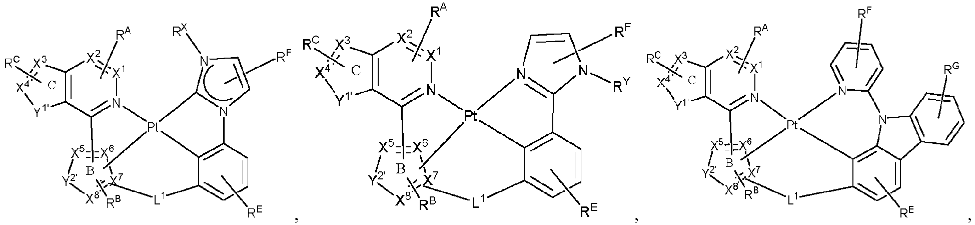 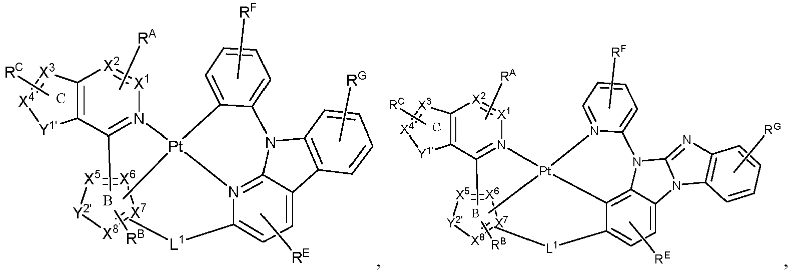 and 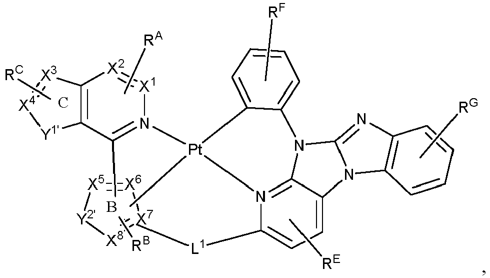 wherein:
R^{x} and R^{y} are each selected from the group consisting of alkyl, cycloalkyl, heteroalkyl, heterocycloalkyl, aryl, heteroaryl, and combinations thereof;
R^{G} represents mono, or up to a maximum allowed substitution, or no substitutions; and
R^{G} for each occurrence is independently a hydrogen or a substituent selected from the group consisting of the Preferred General Substitutions.

In some embodiments, the compound is selected from the group consisting of compounds having the formula of Pt(L_{A'})(L*y*): 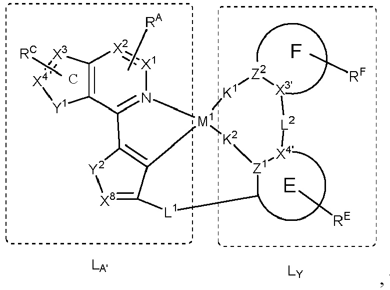 wherein L_{A'} is selected from the group consisting of the structures of the following LIST 16: 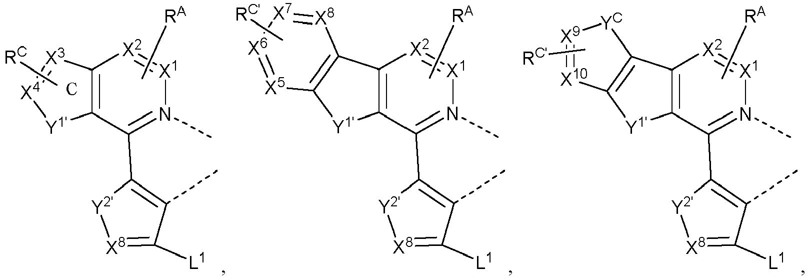 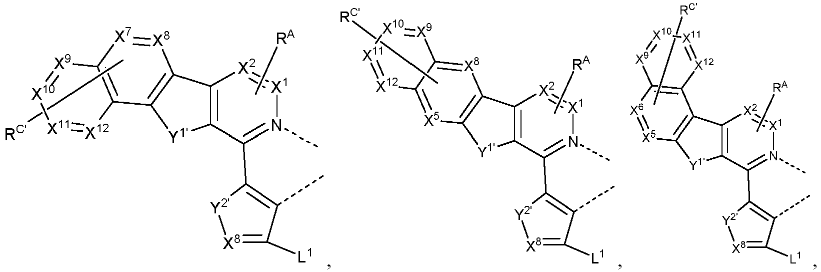 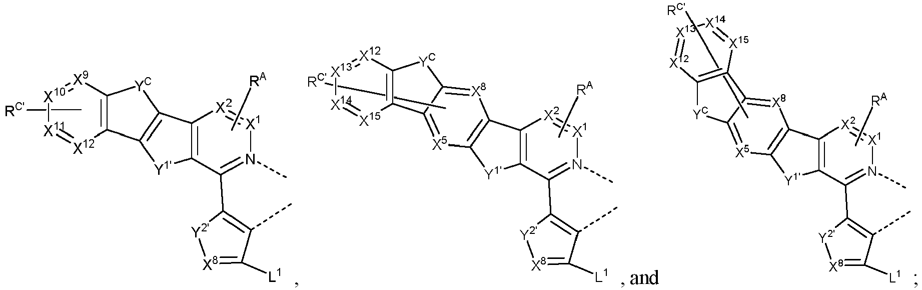 wherein L*_{y}* is selected from the group consisting of the following structures: 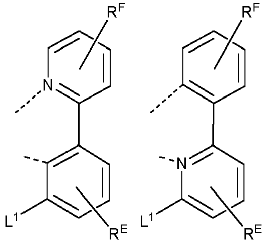 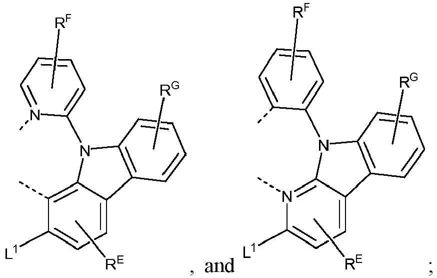 and wherein:
each of X⁹ to X¹⁵ is each independently C or N;
R^{G} represents mono, or up to a maximum allowed substitution, or no substitutions; and
R^{G} for each occurrence is independently a hydrogen or a substituent selected from the group consisting of the Preferred General Substitutions.

In some embodiments, the compound is selected from the group consisting of the compounds having the formula of Pt(L_{A'})(L*y*): 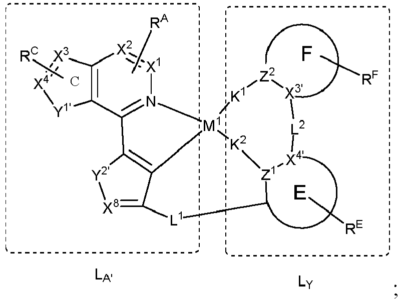
wherein L_{A'} is selected from the group consisting of L_{A'1}(R*^{F}*)(R*^{G}*)(Y*^{H}*)(Y*^{J}*), L_{A'2}(R*^{F}*)(Y*^{H}*)(Y*^{J}*), L_{A'3}(R*^{F}*)(R*^{G}*)(Y*^{H}*)(Y*^{J}*), L_{A'4}(R*^{F}*)(R*^{G}*)(Y*^{H}*)(Y*^{J}*), L_{A'5}(R*^{F}*)(R*^{G}*)(Y*^{H}*)(Y*^{J}*)(Y*^{K}*), L_{A'6}(R*^{F}*)(R*^{G}*)(Y*^{H}*)(Y*^{J}*)(Y*^{K}*), L_{A'7}(R*^{F}*)(R*^{G}*)(Y*^{H}*)(Y*^{J}*)(Y*^{K}*), L_{A'8}(R*^{F}*)(R*^{G}*)(Y*^{H}*)(Y*^{J}*)(Y*^{K}*), L_{A'9}(R*^{F}*)(R*^{G}*)(Y*^{H}*)(Y*^{J}*), L_{A'10}(R*^{F}*)(R*^{G}*)(Y*^{H}*)(Y*^{J}*), L_{A'11}(R*^{F}*)(R*^{G}*)(Y*^{H}*)(Y*^{J}*), L_{A'12}(R*^{F}*)(R*^{G}*)(Y*^{H}*)(Y*^{J}*), L_{A'13}(R*^{F}*)(R*^{G}*)(Y*^{H}*)(Y*^{J}*), L_{A'14}(R*^{F}*)(R*^{G}*)(Y*^{H}*)(Y*^{J}*)(Y*^{K}*), L_{A'15}(R*^{F}*)(R*^{G}*)(Y*^{H}*)(Y*^{J}*)(Y*^{K}*), L_{A'16}(R*^{F}*)(R*^{G}*)(Y*^{H}*)(Y*^{J}*)(Y*^{K}*), and L_{A'17}(R*^{F}*)(R*^{G}*)(Y*^{H}*)(Y*^{J}*)(Y*^{K}*), wherein each of *F* and *G* is independently an integerfrom 1 to 87, each of *H* and *k* is independently an integer from 1 to 4, *J* is an integer from 1 to 3, and L_{A}'₁(R*^{F}*)(R*^{G}*)(Y*^{H}*)(Y*^{J}*) to L_{A'17}(R*^{F}*)(R*^{G}*)(Y*^{H}*)(Y*^{J}*)(Y*^{K}*), are defined by the structures in the following LIST 17: 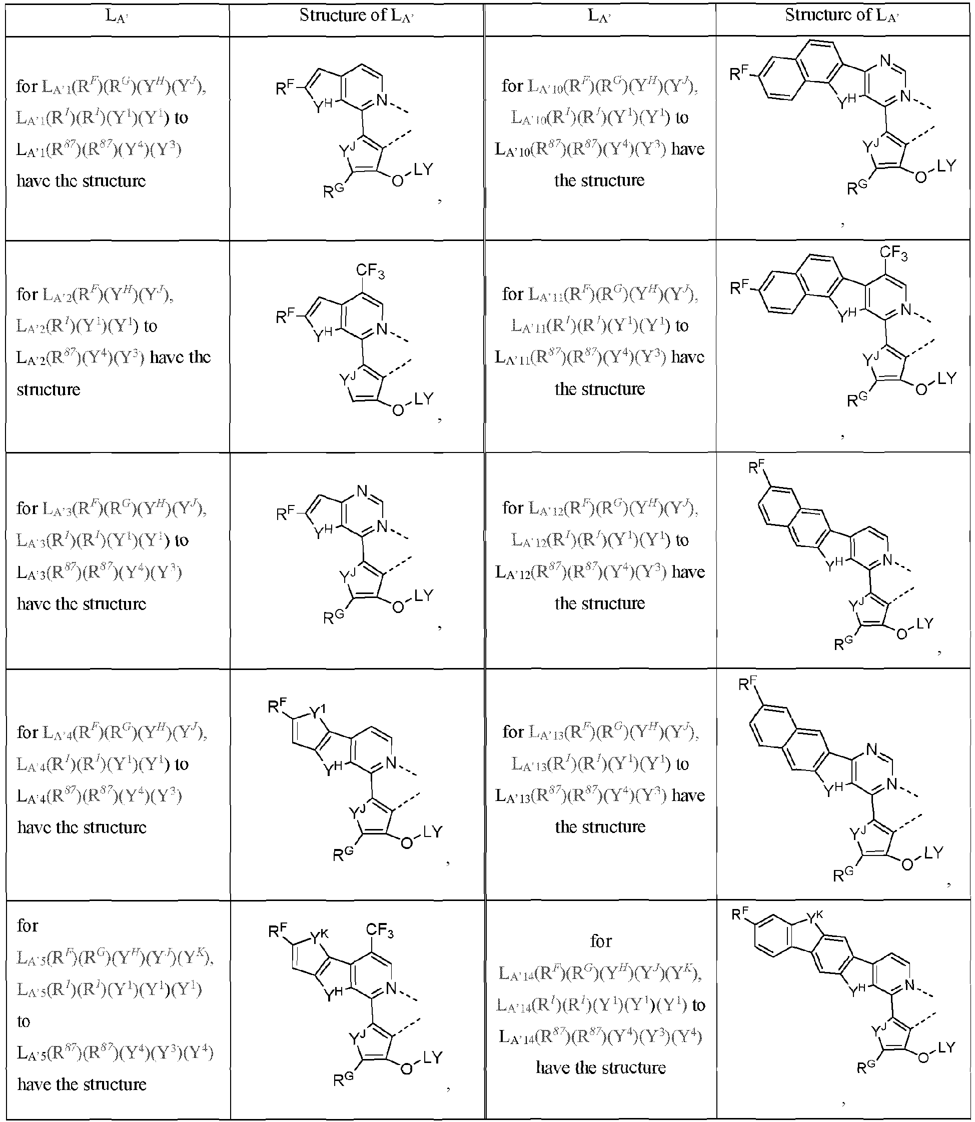 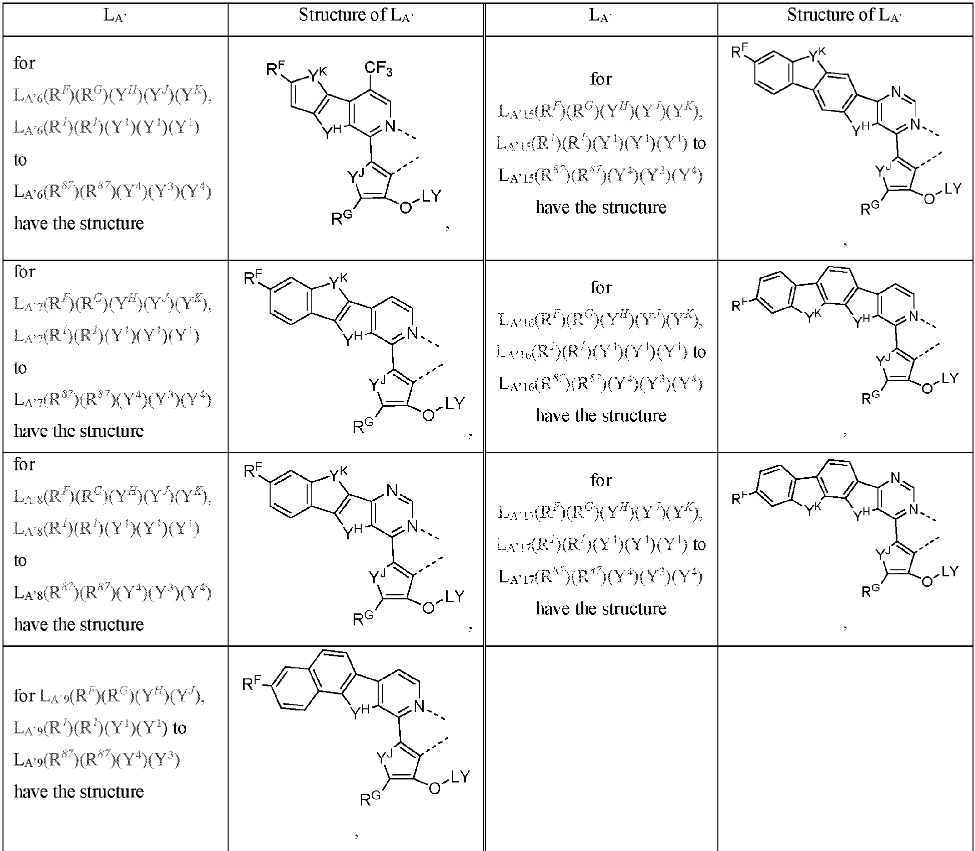
wherein Y¹ is O, Y² is S, Y³ is NCH₃, and Y⁴ is Se;
wherein R¹ to R⁸⁷ have the structures as defined in LIST 4; and
wherein L*_{Y}* is selected from the group consisting of L_{Y1}(R*g*)(R*l*), L_{Y2}(R*g*)(R*l*), L_{Y3}(R*g*)(R*l*)(Y*a*)(Y*b*), L_{Y4}(R*g*)(Y*a*)(Y*b*), L_{Y5}(R*g*)(R*l*)(Y*a*)(Y*b*), L_{Y6}(R*g*)(R*l*)(Y*a*)(Y*b*), L_{Y7}(R*g*)(R*l*)(Y*a*)(Y*b*), L_{Y8}(R*g*)(R*l*)(Y*a*)(Y*b*)(Y*c*), L_{Y9}(R*g*)(R*l*)(Y*a*)(Y*b*)(Y*c*), L_{Y10}(R*g*)(R*l*)(Y*a*)(Y*b*)(Y*c*), L_{Y11}(R*g*)(R*l*)(Y*a*)(Y*b*), L_{Y12}(R*g*)(R*l*)(Y*a*)(Y*b*), L_{Y13}(R*g*)(R*l*)(Y*a*)(Y*b*), L_{Y14}(R*g*)(R*l*)(Y*a*)(Y*b*), L_{Y15}(R*g*)(R*l*)(Y*a*)(Y*b*), L_{Y16}(R*g*)(R*l*)(Y*a*)(Y*b*)(Y*c*), L_{Y17}(R*g*)(R*l*)(Y*a*)(Y*b*)(Y*c*), L_{Y18}(R*g*)(R*l*)(Y*a*)(Y*b*)(Y*c*), and L_{Y19}(R*g*)(R*l*)(Y*a*)(Y*b*)(Y*c*), wherein each of *g* and *l* is independently an integer from 1 to 87, each of *a* and *c* is independently an integer from 1 to 4, *b* is an integer from 1 to 3, and L_{Y1}(R*g*)(R*l*) to L_{Y19}(R*g*)(R*l*)(Y*a*)(Y*b*)(Y*c*), are defined by the structures in the following LIST 18:

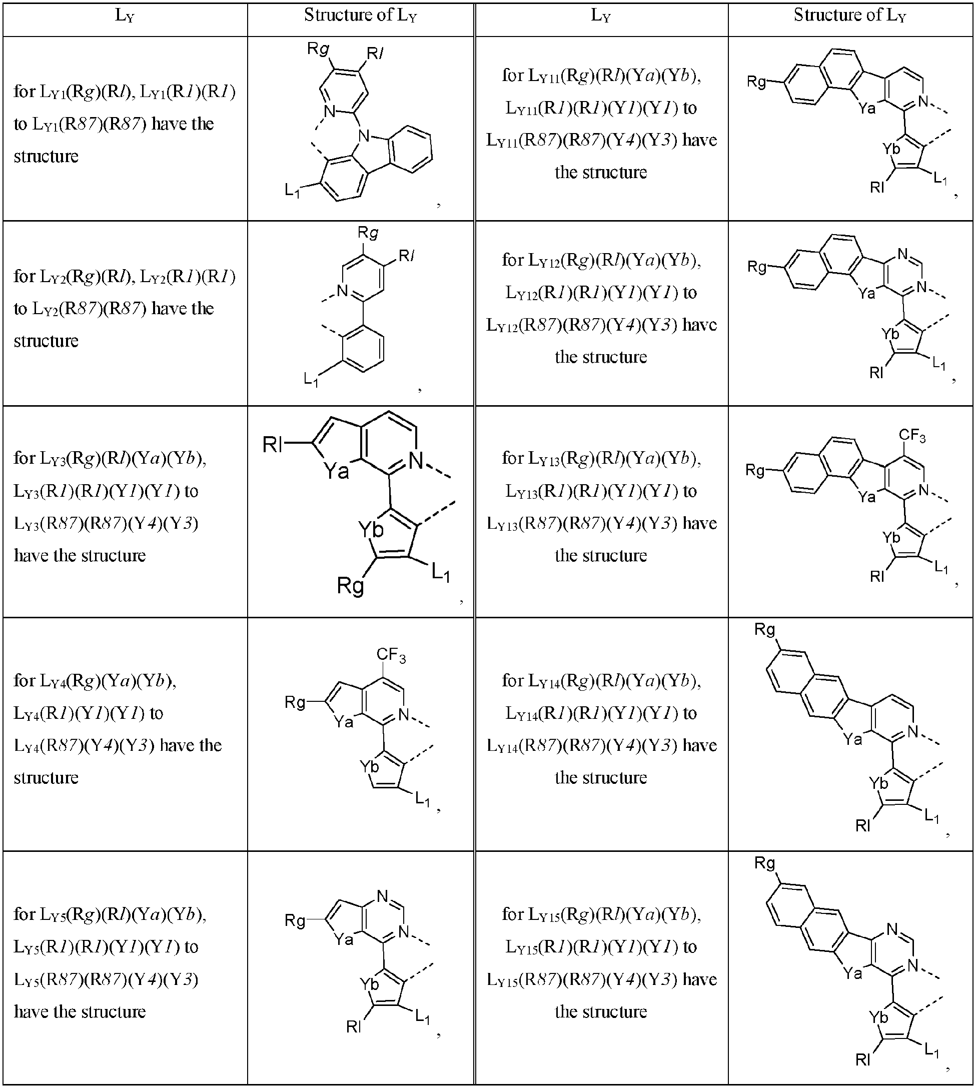

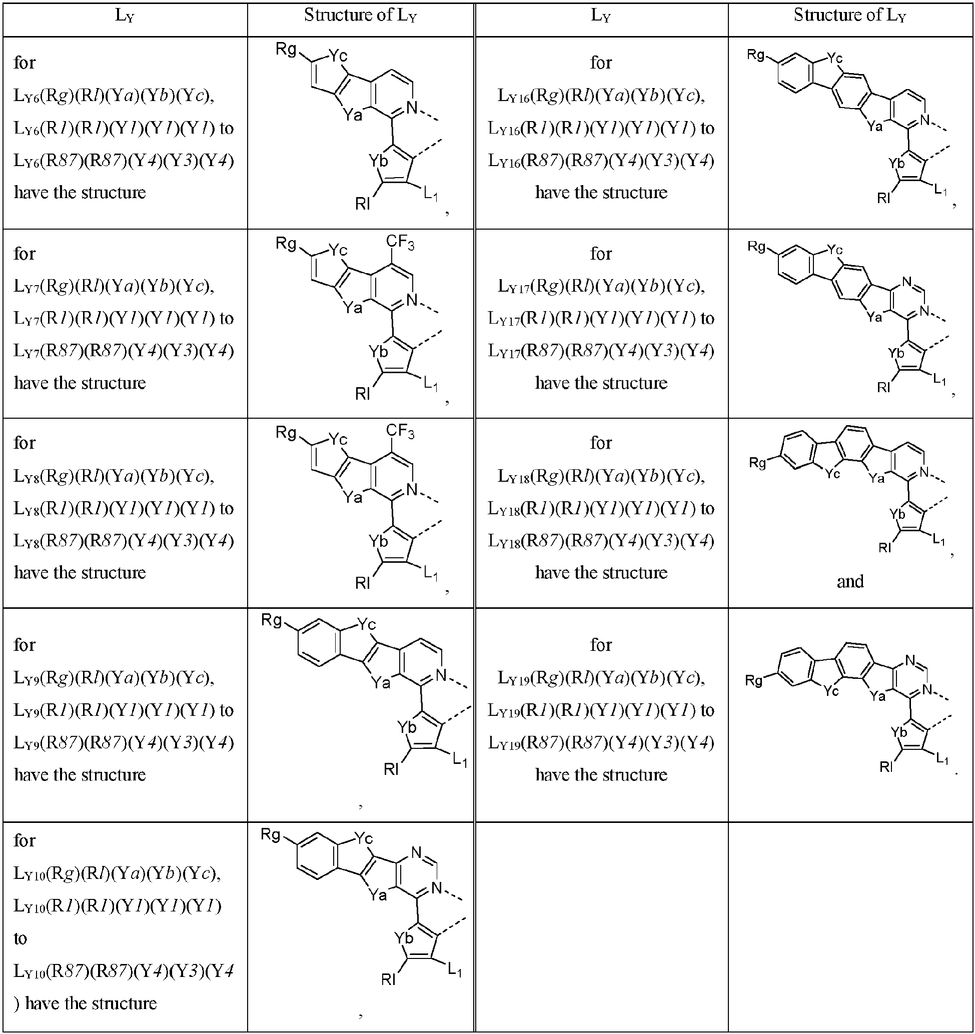

In some embodiments, the compound is selected from the group consisting of the structures of the following LIST 19:

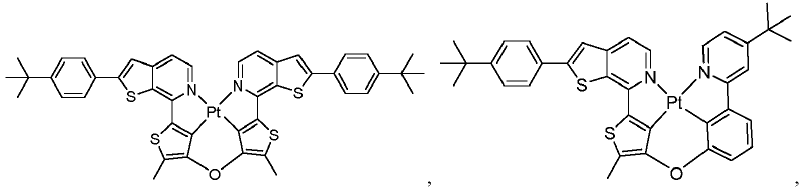

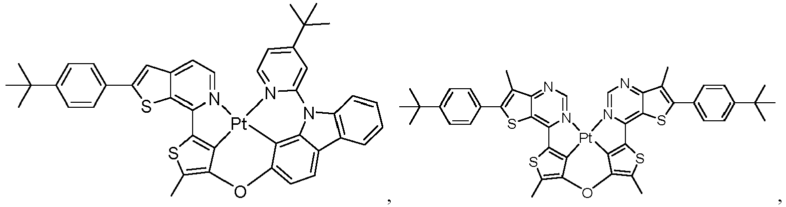

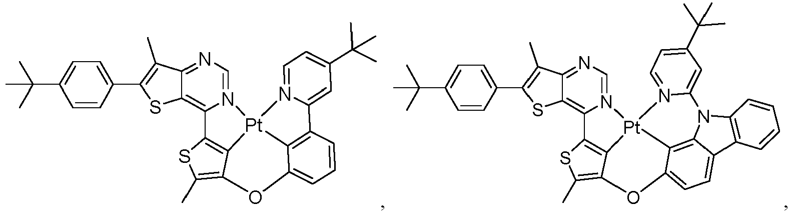

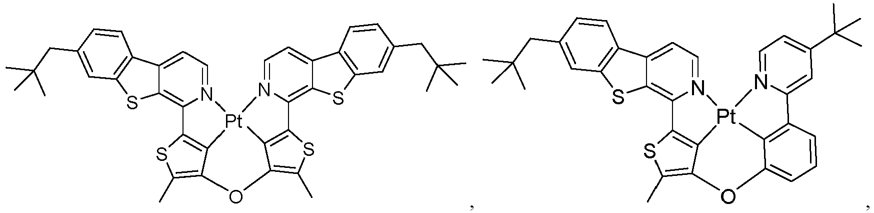

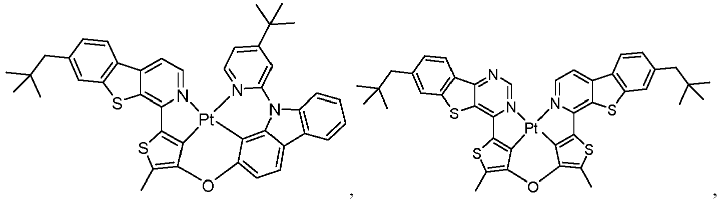

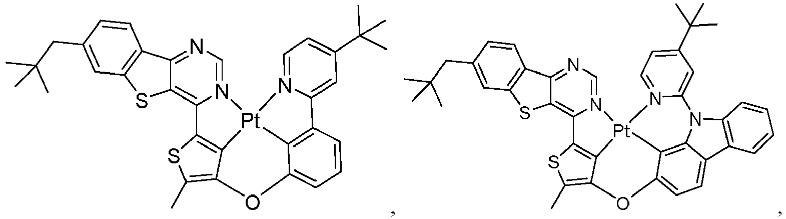

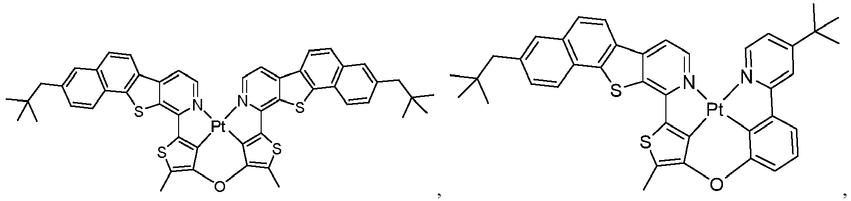

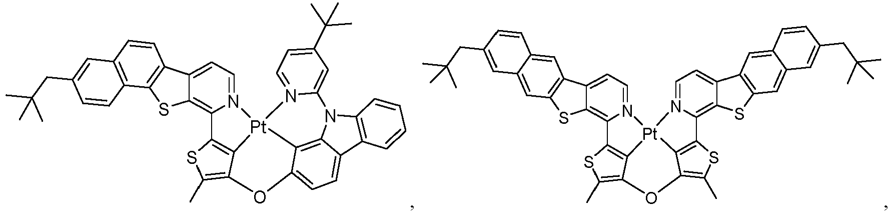

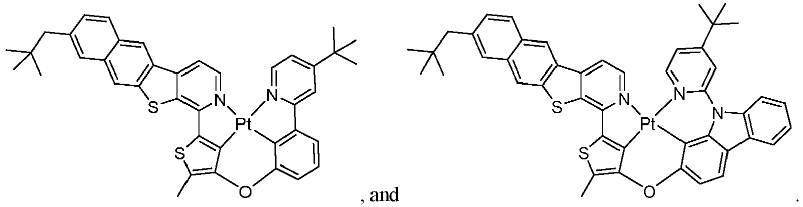

In some embodiments, the compound having a ligand L_{A} of Formula I described herein can be at least 30% deuterated, at least 40% deuterated, at least 50% deuterated, at least 60% deuterated, at least 70% deuterated, at least 80% deuterated, at least 90% deuterated, at least 95% deuterated, at least 99% deuterated, or 100% deuterated. As used herein, percent deuteration has its ordinary meaning and includes the percent of possible hydrogen atoms (*e.g*., positions that are hydrogen, deuterium, or halogen) that are replaced by deuterium atoms.

### C. The OLEDs and the Devices of the Present Disclosure

The present disclosure also provides an OLED device comprising a first organic layer that contains a compound as disclosed in the above compounds section of the present disclosure.

The OLED comprises an anode, a cathode, and a first organic layer disposed between the anode and the cathode. The first organic layer can comprise a compound having a ligand L_{A} having a structure of Formula I 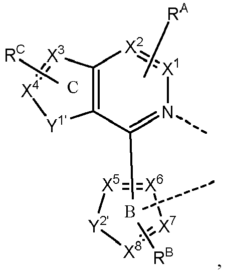 wherein
each of X¹, X², X³, X⁴, X⁵, X⁶, X⁷, and X⁸ is independently C or N;
each of Y^{1'} and Y^{2'} is independently selected from the group consisting of O, S, and Se
each of R^{A}, R^{B}, and R^{C} is independently represent mono to the maximum allowable substitution, or no substitution;
each of R^{A}, R^{B}, and R^{C} is independently a hydrogen or a substituent selected from the group consisting of the General Substituents defined herein;
L_{A} is coordinated to metal M through the indicated dashed lines to form a 5-membered chelate ring;
metal M is selected from the group consisting of Ru, Os, Ir, Pd, Pt, Cu, Ag, and Au;
Ring B is coordinated to M by a C-M bond;
M may be coordinated to other ligands;
L_{A} can be joined with other ligands to form a tridentate, tetradentate, pentadentate, or hexadentate ligand; and any two adjacent R^{A} and R^{C} can be joined or fused to form a ring..

The organic layer may be an emissive layer and the compound as described herein may be an emissive dopant or a non-emissive dopant.

The organic layer may further comprise a host, wherein the host comprises a triphenylene containing benzo-fused thiophene or benzo-fused furan, wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡CCₙH₂ₙ₊₁, Ar₁, Ar₁-Ar₂, CₙH₂ₙ₋Ar₁, or no substitution, wherein n is from 1 to 10; and wherein Ar₁ and Ar₂ are independently selected from the group consisting of benzene, biphenyl, naphthalene, triphenylene, carbazole, and heteroaromatic analogs thereof.

The organic layer may further comprise a host, wherein host comprises at least one chemical group selected from the group consisting of triphenylene, carbazole, indolocarbazole, dibenzothiophene, dibenzofuran, dibenzoselenophene, 5,9-dioxa-13b-boranaphtho[3,2,1-de]anthracene, aza-triphenylene, aza-carbazole, aza-indolocarbazole, aza-dibenzothiophene, aza-dibenzofuran, aza-dibenzoselenophene, and aza-(5,9-dioxa-13b-boranaphtho[3,2,1-de]anthracene).

The host may be selected from the HOST Group consisting of: 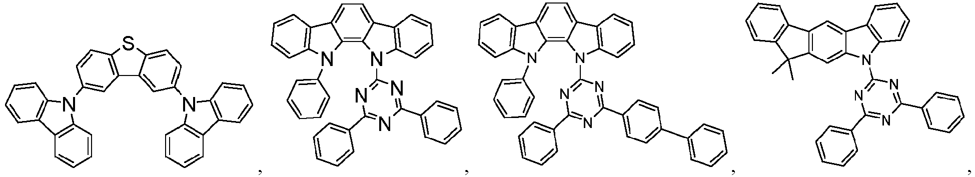 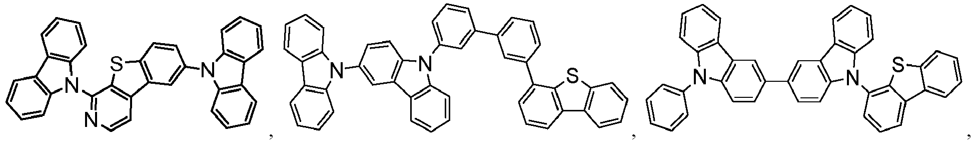 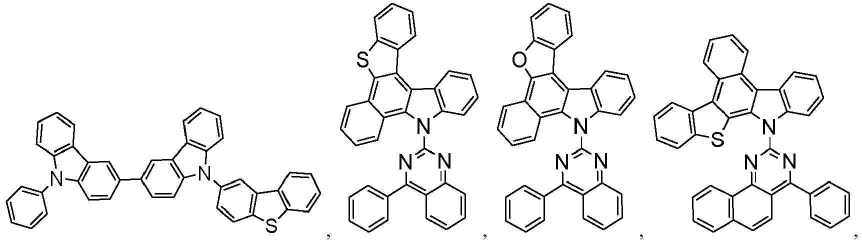 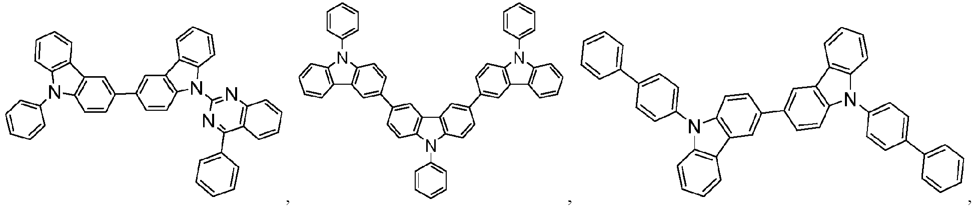 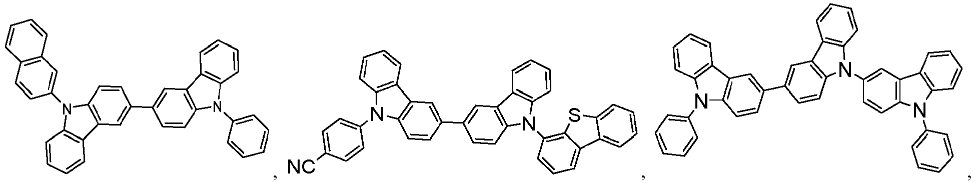 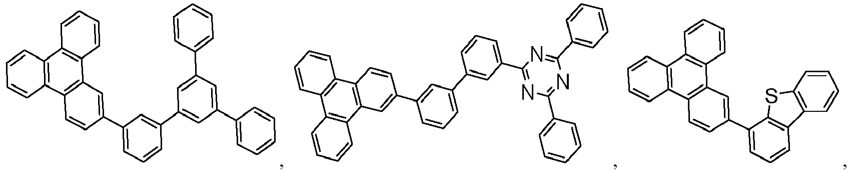 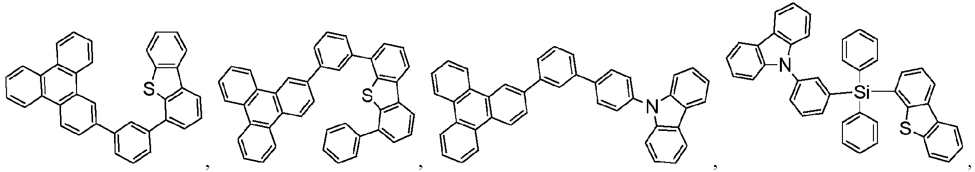 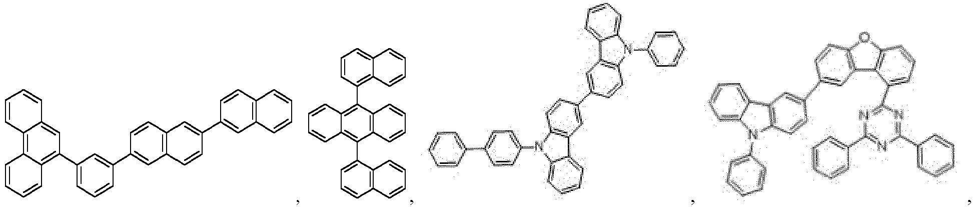 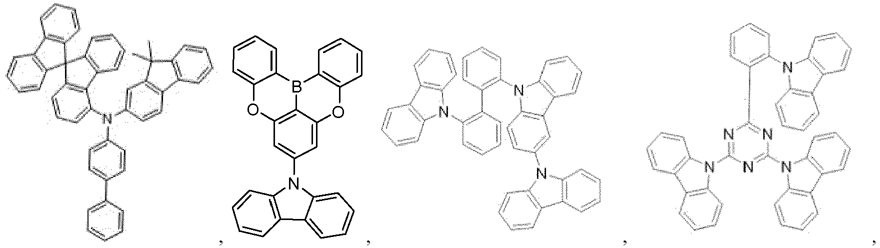 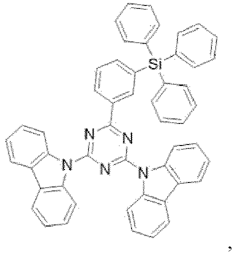 and combinations thereof.

The organic layer may further comprise a host, wherein the host comprises a metal complex.

The compound as described herein may be a sensitizer; wherein the device may further comprise an acceptor; and wherein the acceptor may be selected from the group consisting of fluorescent emitter, delayed fluorescence emitter, and combination thereof.

The OLED of the present disclosure may also comprise an emissive region containing a compound as disclosed in the above compounds section of the present disclosure.

The emissive region can comprise a compound having a ligand L_{A} having a structure of Formula I as described herein.

At least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, wherein the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on opposite side of the emissive layer from the enhancement layer but still outcouples energy from the surface plasmon mode of the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. If energy is scattered to the non-free space mode of the OLED other outcoupling schemes could be incorporated to extract that energy to free space. In some embodiments, one or more intervening layer can be disposed between the enhancement layer and the outcoupling layer. The examples for interventing layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line-shape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

The enhancement layer is provided as a planar layer. The enhancement layer has wavelength-sized features that are arranged periodically, quasi-periodically, or randomly, or sub-wavelength-sized features that are arranged periodically, quasi-periodically, or randomly. The wavelength-sized features and the sub-wavelength-sized features have sharp edges.

The outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a plurality of nanoparticles and the outcoupling layer is composed of a plurality of nanoparticles disposed over a material. The outcoupling may be tunable by at least one of varying a size of the plurality of nanoparticles, varying a shape of the plurality of nanoparticles, changing a material of the plurality of nanoparticles, adjusting a thickness of the material, changing the refractive index of the material or an additional layer disposed on the plurality of nanoparticles, varying a thickness of the enhancement layer, and/or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. The outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. The outcoupling layer also acts as an electrode of the device.

The present disclosure also provides a consumer product comprising an organic light-emitting device (OLED) having an anode; a cathode; and an organic layer disposed between the anode and the cathode, wherein the organic layer may comprise a compound as disclosed in the above compounds section of the present disclosure.

The consumer product comprises an OLED having an anode; a cathode; and an organic layer disposed between the anode and the cathode, wherein the organic layer can comprise a compound having a ligand L_{A} having a structure of Formula I as described herein.

The consumer product can be one of a flat panel display, a computer monitor, a medical monitor, a television, a billboard, a light for interior or exterior illumination and/or signaling, a heads-up display, a fully or partially transparent display, a flexible display, a laser printer, a telephone, a cell phone, tablet, a phablet, a personal digital assistant (PDA), a wearable device, a laptop computer, a digital camera, a camcorder, a viewfinder, a micro-display that is less than 5,08 cm/ 2 inches diagonal, a 3-D display, a virtual reality or augmented reality display, a vehicle, a video wall comprising multiple displays tiled together, a theater or stadium screen, a light therapy device, and a sign.

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

Several OLED materials and configurations are described in U.S. Pat. Nos. 5,844,363, 6,303,238, and 5,707,745.

The initial OLEDs used emissive molecules that emitted light from their singlet states ("fluorescence") as disclosed, for example, in U.S. Pat. No. 4,769,292. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"). Phosphorescence is described in more detail in U.S. Pat. No. 7,279,704 at cols. 5-6.

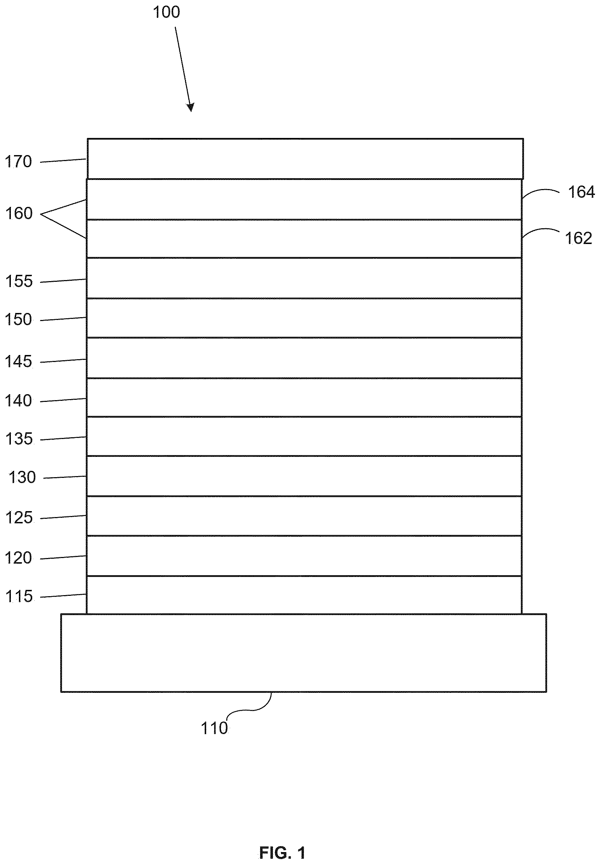

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10.

More examples for each of these layers are available. For example, a flexible and transparent substrate-anode combination is disclosed in U.S. Pat. No. 5,844,363. An example of a p-doped hole transport layer is m-MTDATA doped with F₄-TCNQ at a molar ratio of 50:1, as disclosed in U.S. Patent Application Publication No. 2003/0230980. Examples of emissive and host materials are disclosed in U.S. Pat. No. 6,303,238 to Thompson et al. An example of an n-doped electron transport layer is BPhen doped with Li at a molar ratio of 1:1, as disclosed in U.S. Patent Application Publication No. 2003/0230980. U.S. Pat. Nos. 5,703,436 and 5,707,745, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980. Examples of injection layers are provided in U.S. Patent Application Publication No. 2004/0174116. A description of protective layers may be found in U.S. Patent Application Publication No. 2004/0174116.

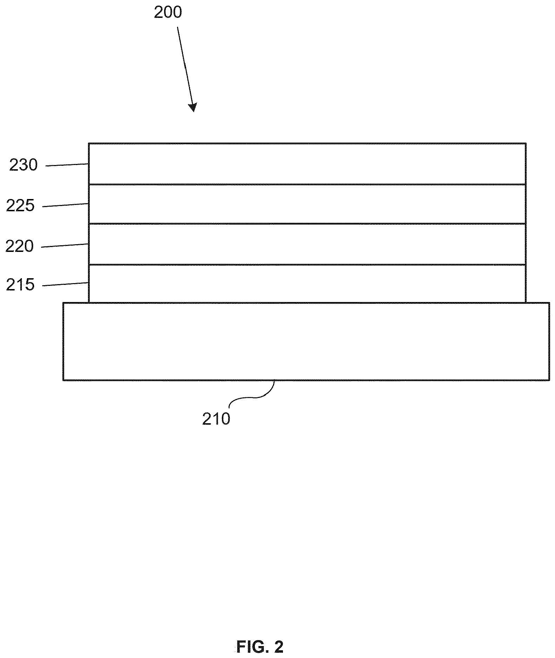

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the present disclosure may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al. By way of further example, OLEDs having a single organic layer may be used. OLEDs may be stacked, for example as described in U.S. Pat. No. 5,707,745 to Forrest et al. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al.

Unless otherwise specified, any of the layers may be deposited by any suitable method. For the organic layers, preferred methods include thermal evaporation, ink-jet, such as described in U.S. Pat. Nos. 6,013,982 and 6,087,196, organic vapor phase deposition (OVPD), such as described in U.S. Pat. No. 6,337,102 to Forrest et al., and deposition by organic vapor jet printing (OVJP), such as described in U.S. Pat. No. 7,431,968. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, and patterning associated with some of the deposition methods such as ink-jet and organic vapor jet printing (OVJP). Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons are a preferred range. Materials with asymmetric structures may have better solution processability than those having symmetric structures, because asymmetric materials may have a lower tendency to recrystallize. Dendrimer substituents may be used to enhance the ability of small molecules to undergo solution processing.

Devices may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the present disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, curved displays, computer monitors, medical monitors, televisions, billboards, lights for interior or exterior illumination and/or signaling, heads-up displays, fully or partially transparent displays, flexible displays, rollable displays, foldable displays, stretchable displays, laser printers, telephones, mobile phones, tablets, phablets, personal digital assistants (PDAs), wearable devices, laptop computers, digital cameras, camcorders, viewfinders, micro-displays (displays that are less than 5,08 cm/ 2 inches diagonal), 3-D displays, virtual reality or augmented reality displays, vehicles, video walls comprising multiple displays tiled together, theater or stadium screen, a light therapy device, and a sign. Various control mechanisms may be used to control devices fabricated in accordance with the present disclosure, including passive matrix and active matrix. Many of the devices are intended for use in a temperature range comfortable to humans, such as 18 degrees C. to 30 degrees C., and more preferably at room temperature (20-25 °C), but could be used outside this temperature range, for example, from -40 degree C to + 80 °C.

More details on OLEDs, and the definitions described above, can be found in U.S. Pat. No. 7,279,704.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

The OLED has one or more characteristics selected from the group consisting of being flexible, being rollable, being foldable, being stretchable, and being curved. The OLED is transparent or semi-transparent. The OLED further comprises a layer comprising carbon nanotubes.

The OLED further comprises a layer comprising a delayed fluorescent emitter. The OLED comprises a RGB pixel arrangement or white plus color filter pixel arrangement. The OLED is a mobile device, a hand held device, or a wearable device. The OLED is a display panel having less than 10 inch diagonal or 50 square inch area. The OLED is a display panel having at least 10 inch diagonal or 50 square inch area. area (1 inch = 2,54 cm). The OLED is a lighting panel.

The compound can be an emissive dopant. The compound can produce emissions via phosphorescence, fluorescence, thermally activated delayed fluorescence, i.e., TADF (also referred to as E-type delayed fluorescence; *see, e.g.,* U.S. Application No. 15/700,352), triplet-triplet annihilation, or combinations of these processes. The emissive dopant can be a racemic mixture, or can be enriched in one enantiomer. The compound can be homoleptic (each ligand is the same). The compound can be heteroleptic (at least one ligand is different from others). When there are more than one ligand coordinated to a metal, the ligands can all be the same. At least one ligand is different from the other ligands. Every ligand can be different from each other. This is also true where a ligand being coordinated to a metal can be linked with other ligands being coordinated to that metal to form a tridentate, tetradentate, pentadentate, or hexadentate ligands. Thus, where the coordinating ligands are being linked together, all of the ligands can be the, and at least one of the ligands being linked can be different from the other ligand(s).

The compound can be used as a phosphorescent sensitizer in an OLED where one or multiple layers in the OLED contains an acceptor in the form of one or more fluorescent and/or delayed fluorescence emitters. In some embodiments, the compound can be used as one component of an exciplex to be used as a sensitizer. As a phosphorescent sensitizer, the compound must be capable of energy transfer to the acceptor and the acceptor will emit the energy or further transfer energy to a final emitter. The acceptor concentrations can range from 0.001% to 100%. The acceptor could be in either the same layer as the phosphorescent sensitizer or in one or more different layers. The acceptor is a TADF emitter. The acceptor is a fluorescent emitter. The emission can arise from any or all of the sensitizer, acceptor, and final emitter.

A formulation comprising the compound described herein is also disclosed.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

A formulation that comprises the novel compound disclosed herein is described. The formulation can include one or more components selected from the group consisting of a solvent, a host, a hole injection material, hole transport material, electron blocking material, hole blocking material, and an electron transport material, disclosed herein.

The present disclosure encompasses any chemical structure comprising the novel compound of the present disclosure, or a monovalent or polyvalent variant thereof. In other words, the inventive compound, or a monovalent or polyvalent variant thereof, can be a part of a larger chemical structure. Such chemical structure can be selected from the group consisting of a monomer, a polymer, a macromolecule, and a supramolecule (also known as supermolecule). As used herein, a "monovalent variant of a compound" refers to a moiety that is identical to the compound except that one hydrogen has been removed and replaced with a bond to the rest of the chemical structure. As used herein, a "polyvalent variant of a compound" refers to a moiety that is identical to the compound except that more than one hydrogen has been removed and replaced with a bond or bonds to the rest of the chemical structure. In the instance of a supramolecule, the inventive compound can also be incorporated into the supramolecule complex without covalent bonds.

### D. Combination of the Compounds of the Present Disclosure with Other Materials

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

### a) Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

Non-limiting examples of the conductivity dopants that may be used in an OLED in combination with materials disclosed herein are exemplified below together with references that disclose those materials: EP01617493, EP01968131, EP2020694, EP2684932, US20050139810, US20070160905, US20090167167, US2010288362, WO06081780, WO2009003455, WO2009008277, WO2009011327, WO2014009310, US2007252140, US2015060804, US20150123047, and US2012146012.

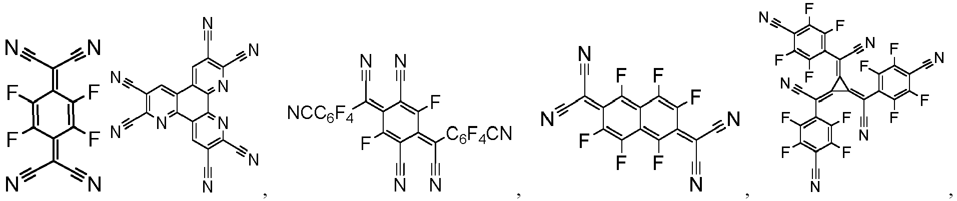

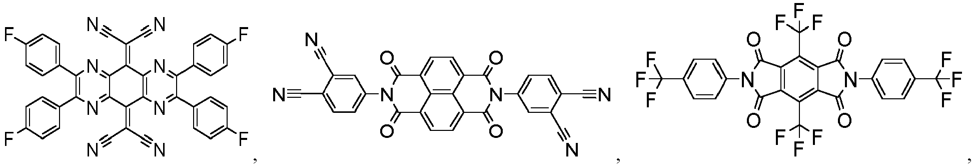

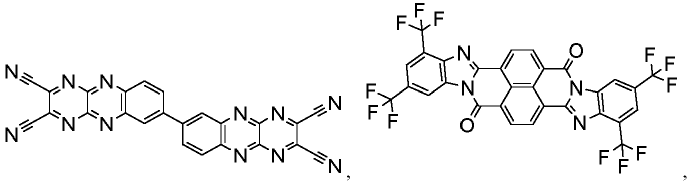

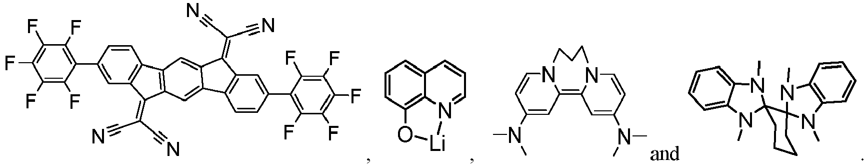

### b) HIL/HTL:

A hole injecting/transporting material to be used in the present disclosure is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; ap-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

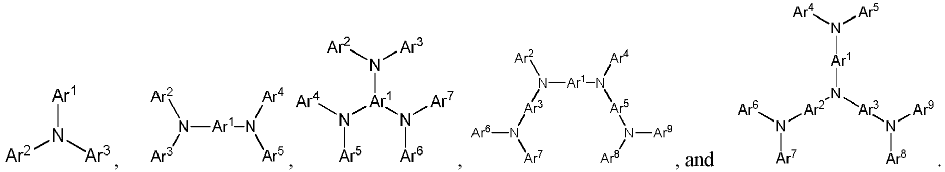

Each of Ar¹ to Ar⁹ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each Ar may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, Ar¹ to Ar⁹ is independently selected from the group consisting of: 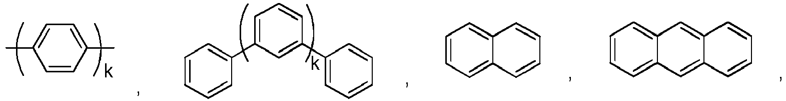 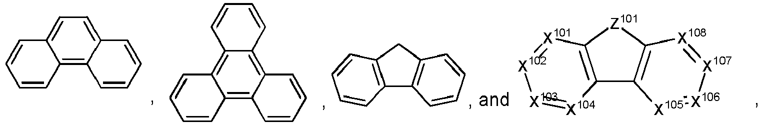 wherein k is an integer from 1 to 20; X¹⁰¹ to X¹⁰⁸ is C (including CH) or N; Z¹⁰¹ is NAr¹, O, or S; Ar¹ has the same group defined above.

Examples of metal complexes used in HIL or HTL include, but are not limited to the following general formula: 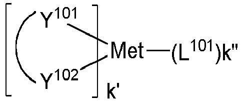 wherein Met is a metal, which can have an atomic weight greater than 40; (Y¹⁰¹-Y¹⁰²) is a bidentate ligand, Y¹⁰¹ and Y¹⁰² are independently selected from C, N, O, P, and S; L¹⁰¹ is an ancillary ligand; k' is an integer value from 1 to the maximum number of ligands that may be attached to the metal; and k'+k" is the maximum number of ligands that may be attached to the metal.

In one aspect, (Y¹⁰¹-Y¹⁰²) is a 2-phenylpyridine derivative. In another aspect, (Y¹⁰¹-Y¹⁰²) is a carbene ligand. In another aspect, Met is selected from Ir, Pt, Os, and Zn. In a further aspect, the metal complex has a smallest oxidation potential in solution vs. Fc⁺/Fc couple less than about 0.6 V.

Non-limiting examples of the HIL and HTL materials that may be used in an OLED in combination with materials disclosed herein are exemplified below together with references that disclose those materials: CN102702075, DE102012005215, EP01624500, EP01698613, EP01806334, EP01930964, EP01972613, EP01997799, EP02011790, EP02055700, EP02055701, EP1725079, EP2085382, EP2660300, EP650955, JP07-073529, JP2005112765, JP2007091719, JP2008021687, JP2014-009196, KR20110088898, KR20130077473, TW201139402, US06517957, US20020158242, US20030162053, US20050123751, US20060182993, US20060240279, US20070145888, US20070181874, US20070278938, US20080014464, US20080091025, US20080106190, US20080124572, US20080145707, US20080220265, US20080233434, US20080303417, US2008107919, US20090115320, US20090167161, US2009066235, US2011007385, US20110163302, US2011240968, US2011278551, US2012205642, US2013241401, US20140117329, US2014183517, US5061569, US5639914, WO05075451, WO07125714, WO08023550, WO08023759, WO2009145016, WO2010061824, WO2011075644, WO2012177006, WO2013018530, WO2013039073, WO2013087142, WO2013118812, WO2013120577, WO2013157367, WO2013175747, WO2014002873, WO2014015935, WO2014015937, WO2014030872, WO2014030921, WO2014034791, WO2014104514, WO2014157018.

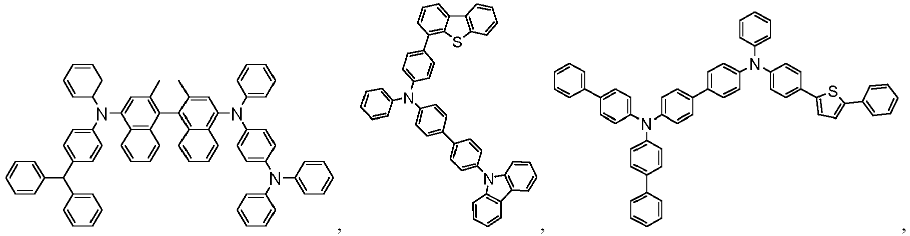

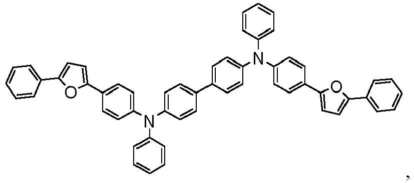

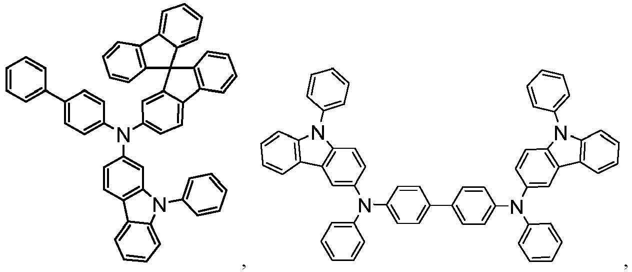

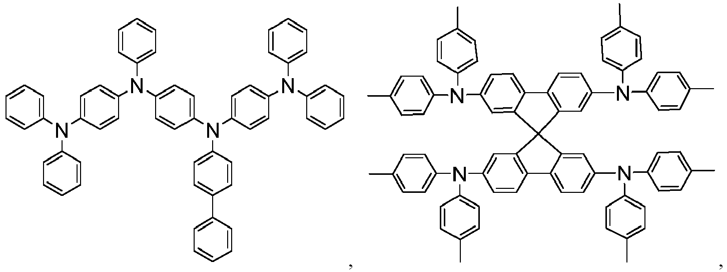

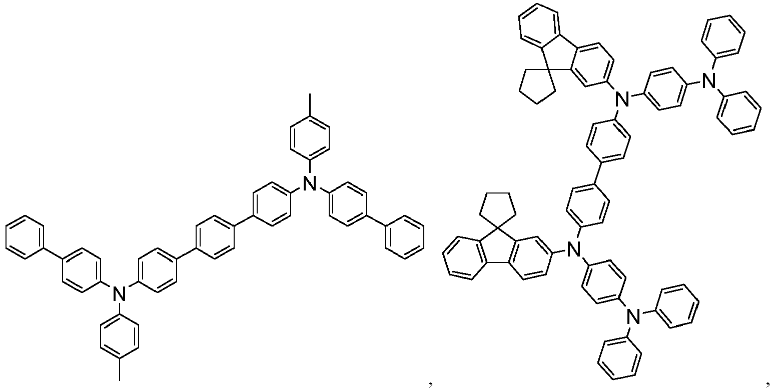

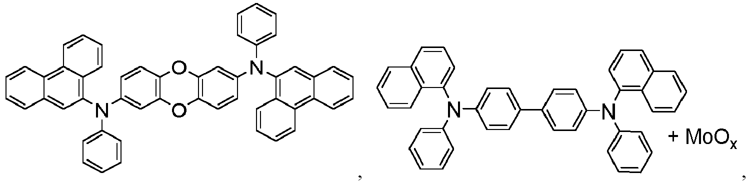

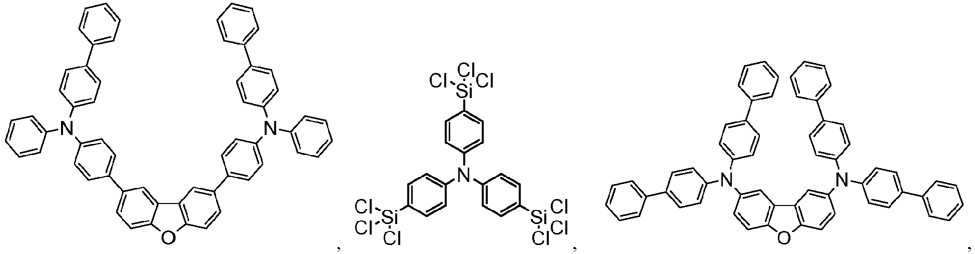

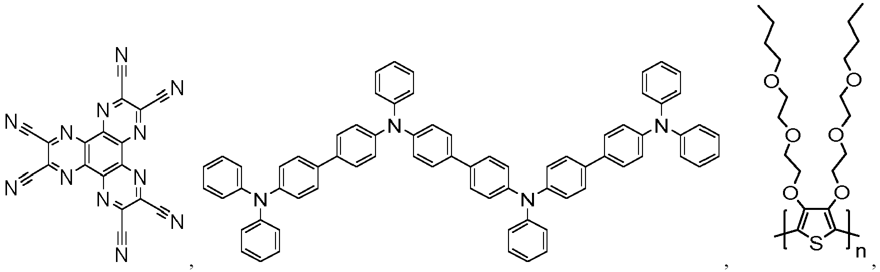

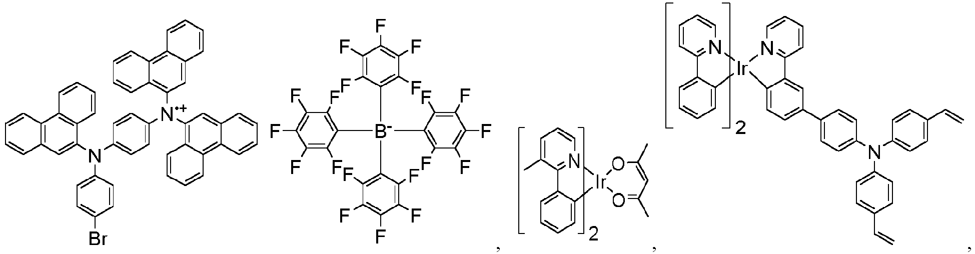

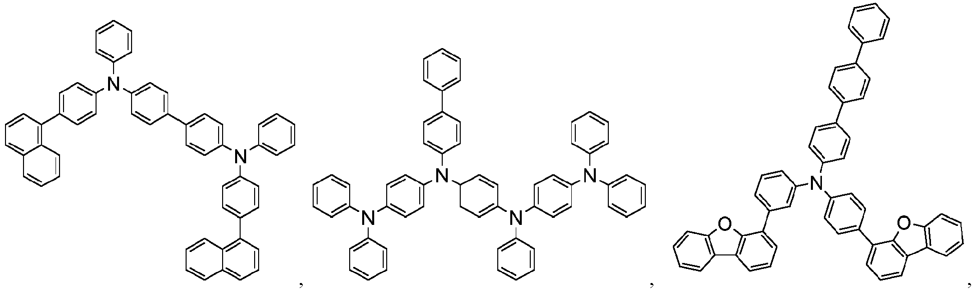

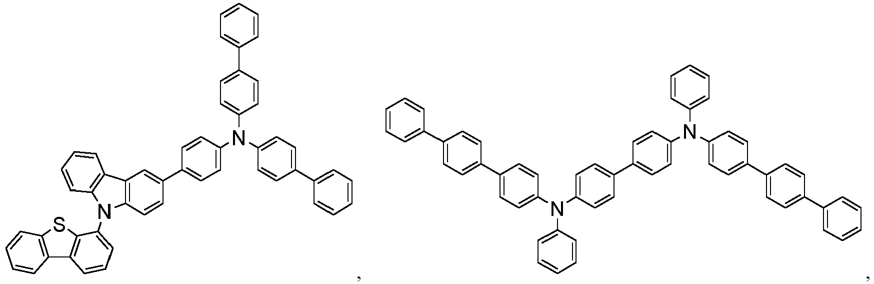

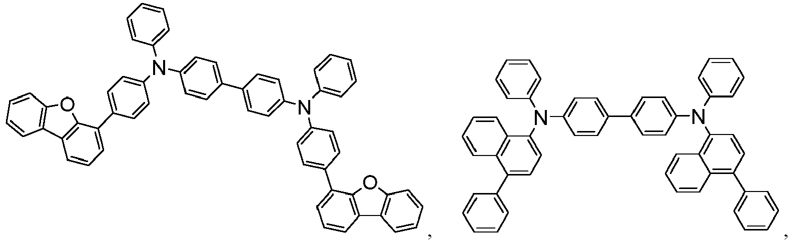

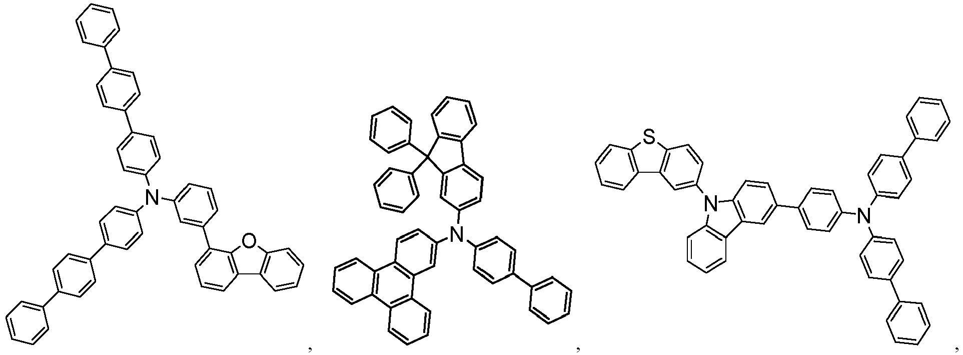

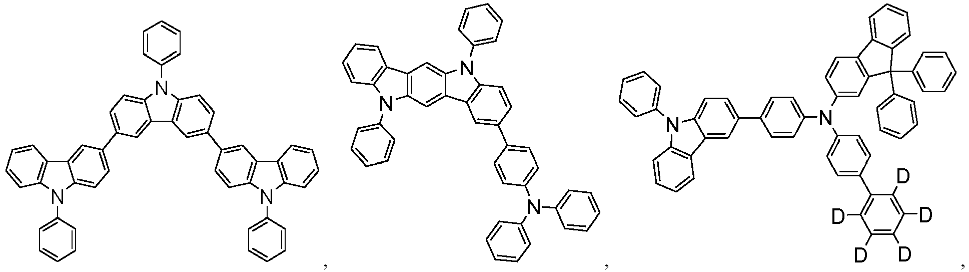

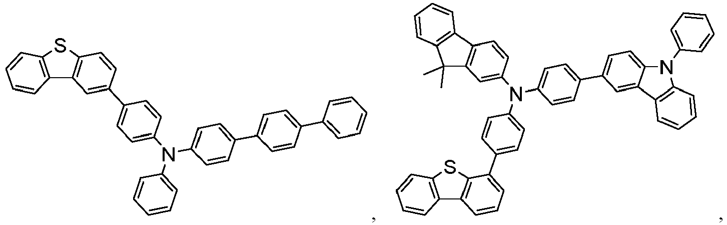

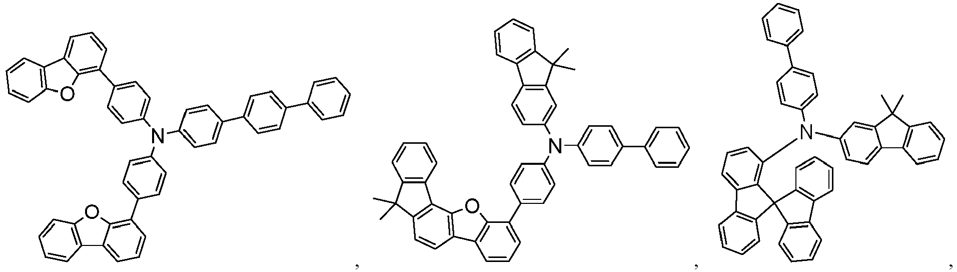

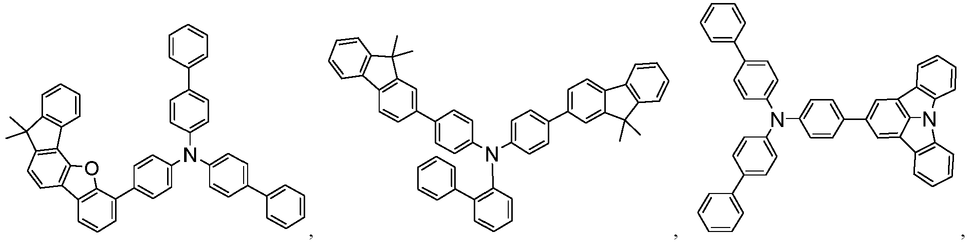

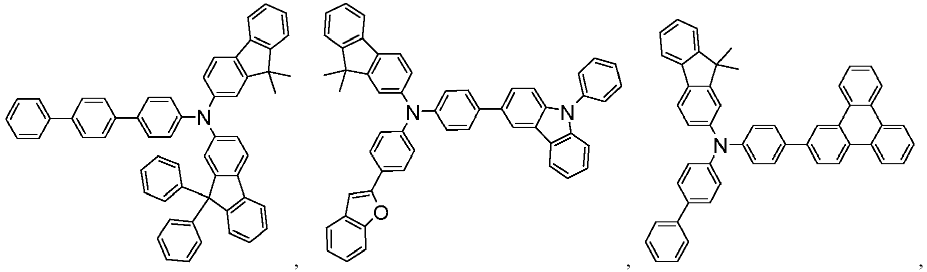

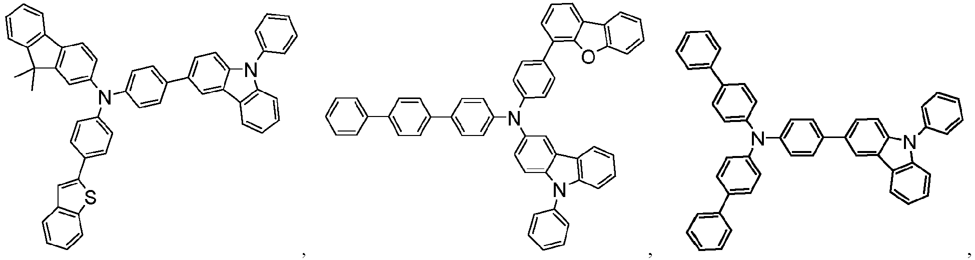

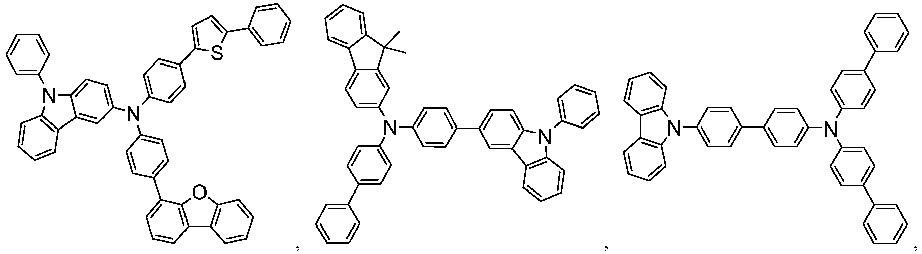

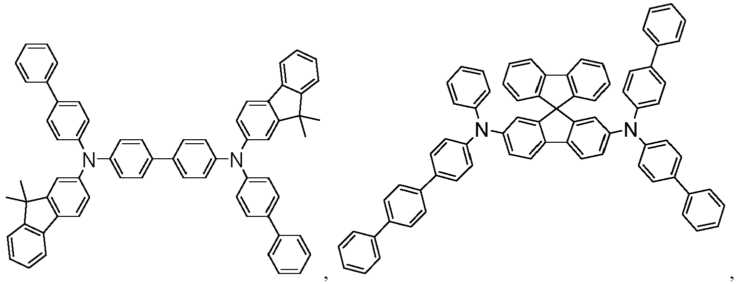

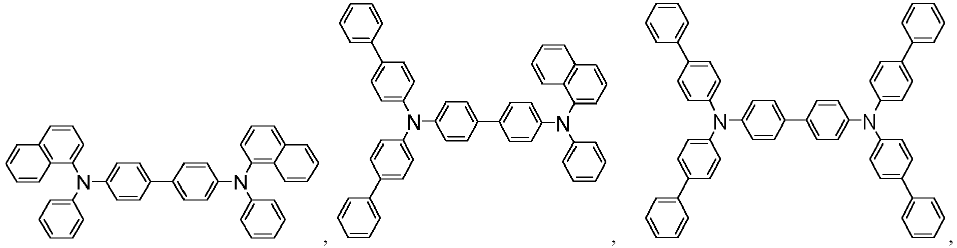

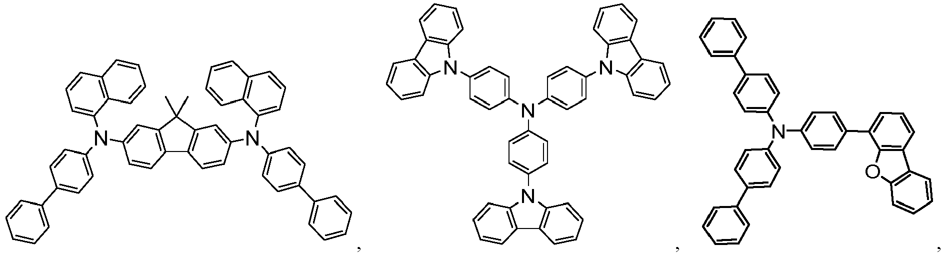

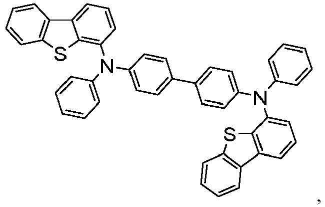

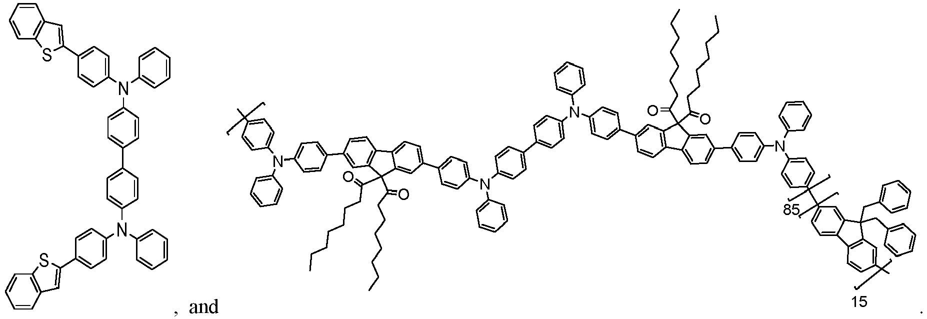

### c) EBL:

An electron blocking layer (EBL) may be used to reduce the number of electrons and/or excitons that leave the emissive layer. The presence of such a blocking layer in a device may result in substantially higher efficiencies, and/or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and/or higher triplet energy than one or more of the hosts closest to the EBL interface. In one aspect, the compound used in EBL contains the same molecule or the same functional groups used as one of the hosts described below.

### d) Hosts:

The light emitting layer of the organic EL device of the present disclosure preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

Examples of metal complexes used as host are preferred to have the following general formula: 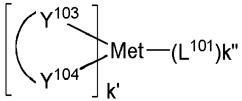 wherein Met is a metal; (Y¹⁰³-Y¹⁰⁴) is a bidentate ligand, Y¹⁰³ and Y¹⁰⁴ are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In one aspect, the metal complexes are: 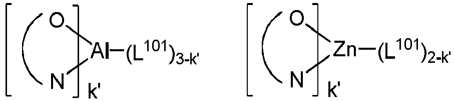 wherein (O-N) is a bidentate ligand, having metal coordinated to atoms O and N.

In another aspect, Met is selected from Ir and Pt. In a further aspect, (Y¹⁰³-Y¹⁰⁴) is a carbene ligand.

In one aspect, the host compound contains at least one of the following groups selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, the host compound contains at least one of the following groups in the molecule: 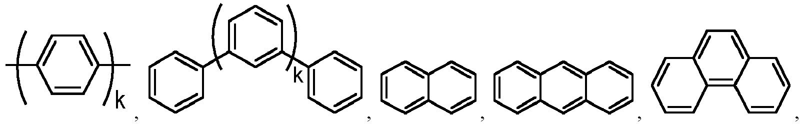 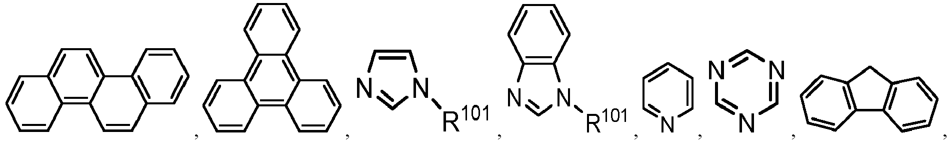 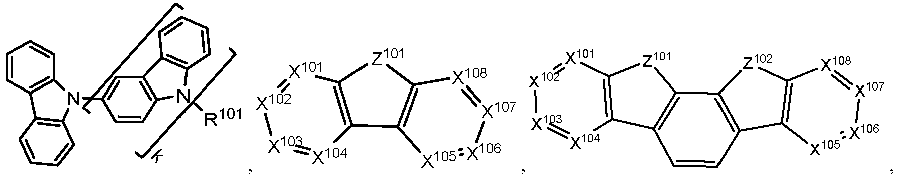 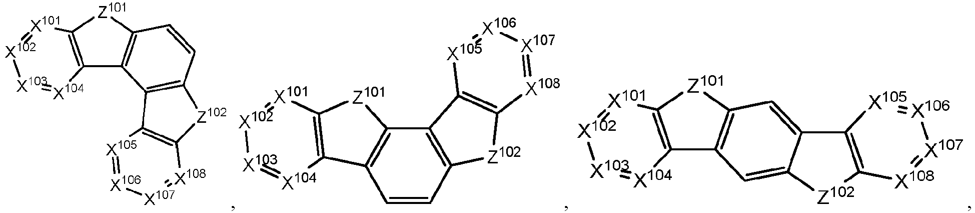 and 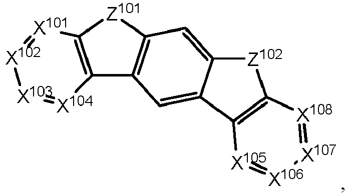 wherein R¹⁰¹ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, and when it is aryl or heteroaryl, it has the similar definition as Ar's mentioned above. k is an integer from 0 to 20 or 1 to 20. X¹⁰¹ to X¹⁰⁸ are independently selected from C (including CH) or N. Z¹⁰¹ and Z¹⁰² are independently selected from NR¹⁰¹, O, or S.

Non-limiting examples of the host materials that may be used in an OLED in combination with materials disclosed herein are exemplified below together with references that disclose those materials: EP2034538, EP2034538A, EP2757608, JP2007254297, KR20100079458, KR20120088644, KR20120129733, KR20130115564, TW201329200, US20030175553, US20050238919, US20060280965, US20090017330, US20090030202, US20090167162, US20090302743, US20090309488, US20100012931, US20100084966, US20100187984, US2010187984, US2012075273, US2012126221, US2013009543, US2013105787, US2013175519, US2014001446, US20140183503, US20140225088, US2014034914, US7154114, WO2001039234, WO2004093207, WO2005014551, WO2005089025, WO2006072002, WO2006114966, WO2007063754, WO2008056746, WO2009003898, WO2009021126, WO2009063833, WO2009066778, WO2009066779, WO2009086028, WO2010056066, WO2010107244, WO2011081423, WO2011081431, WO2011086863, WO2012128298, WO2012133644, WO2012133649, WO2013024872, WO2013035275, WO2013081315, WO2013191404, WO2014142472, US20170263869, US20160163995, US9466803, 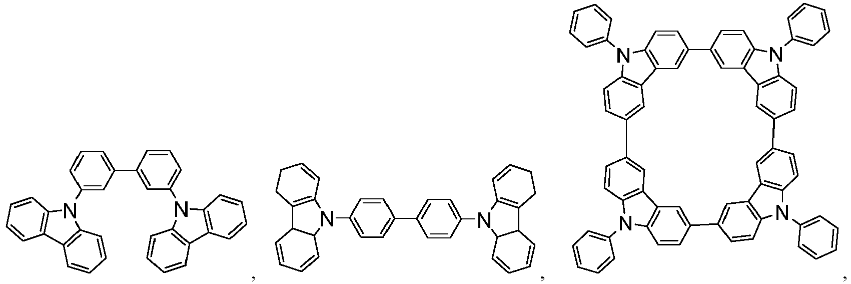 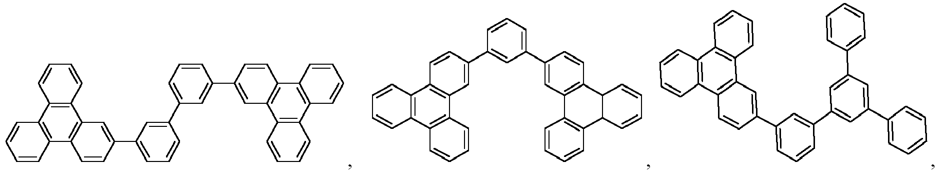 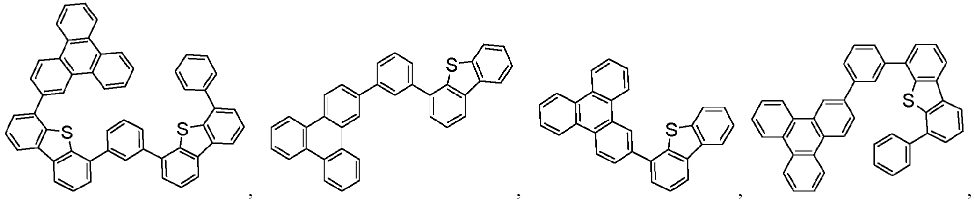 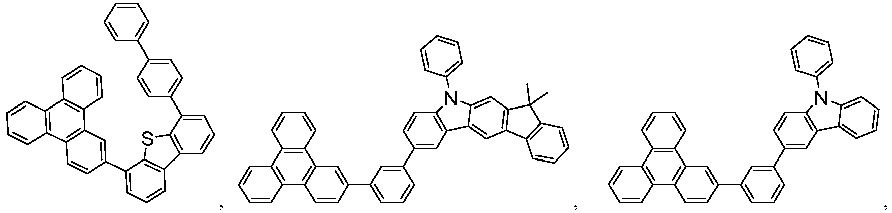 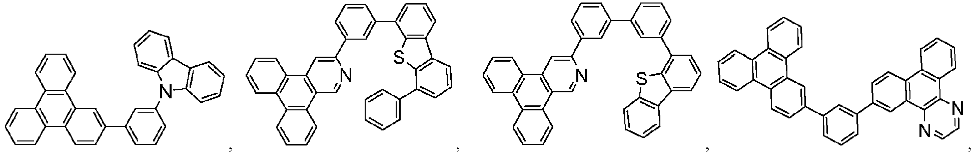 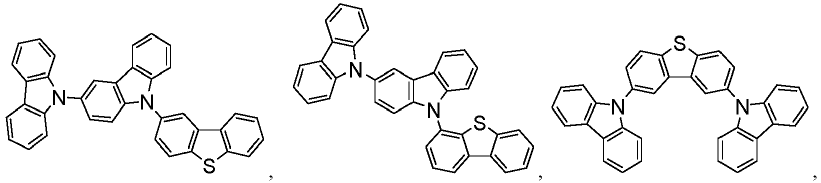 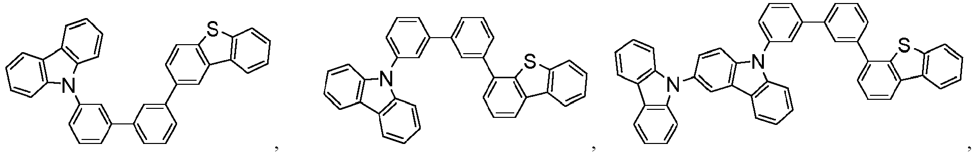 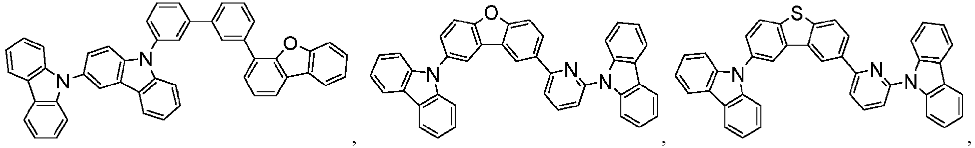 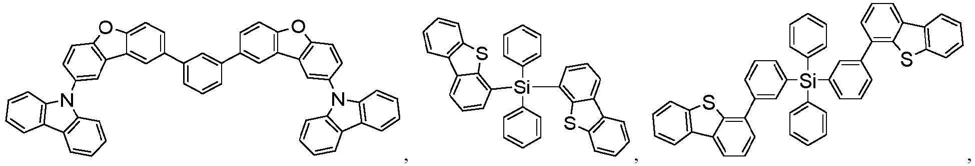 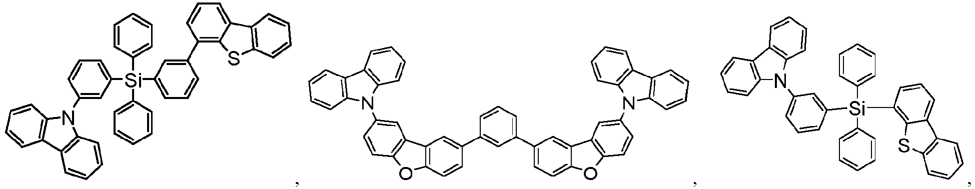 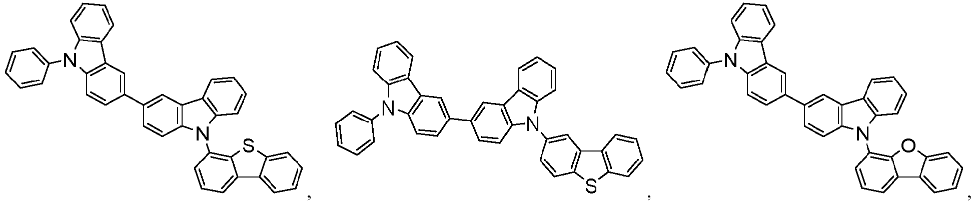 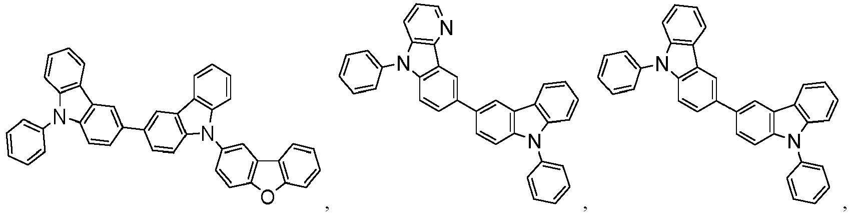 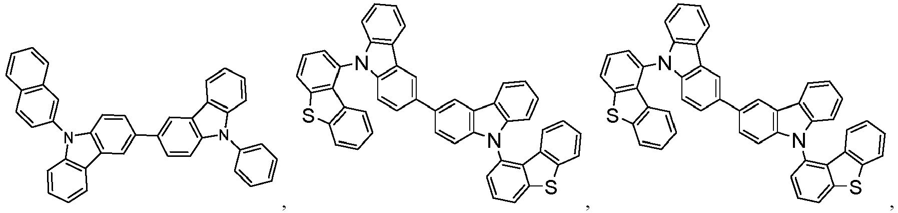 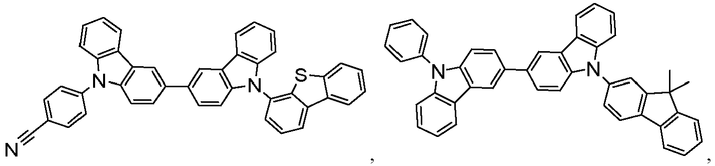 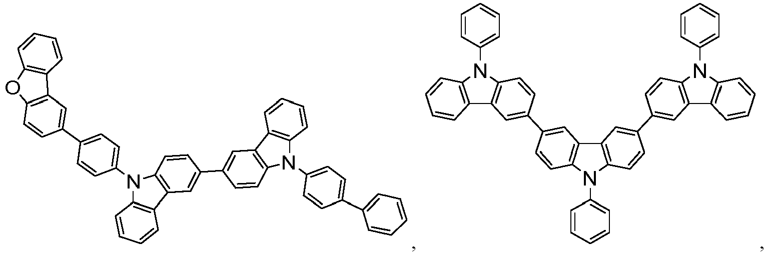 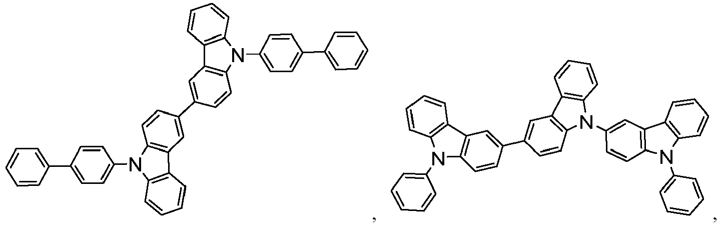 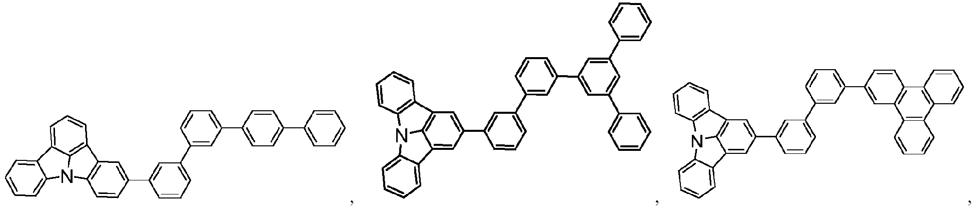 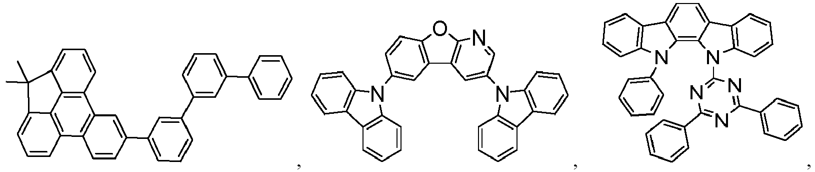 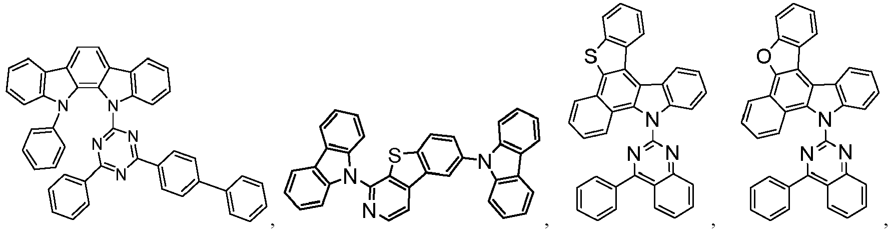 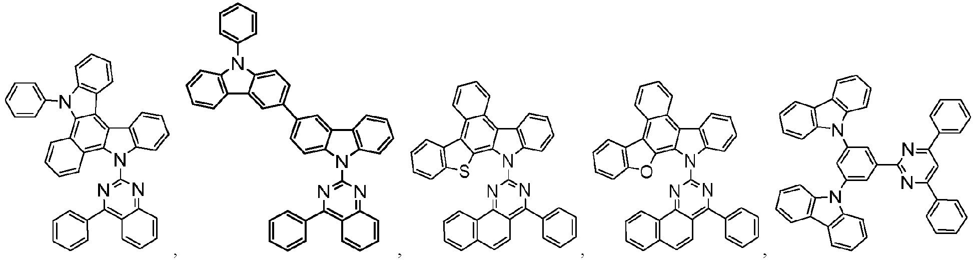 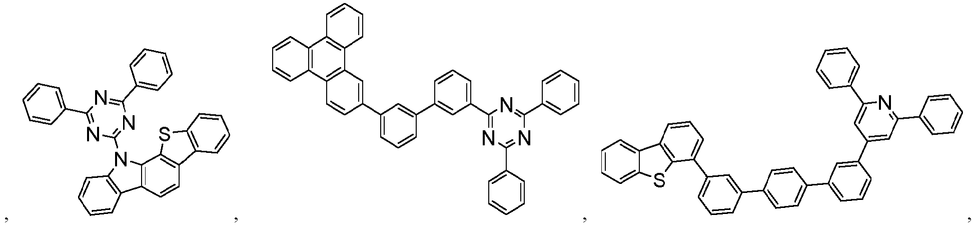 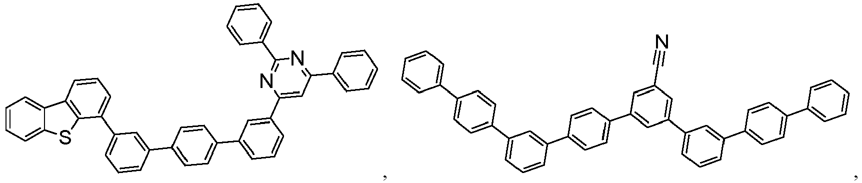 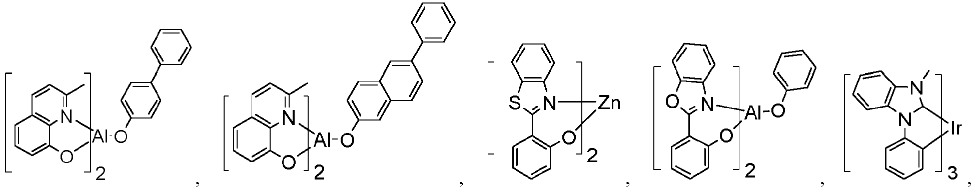 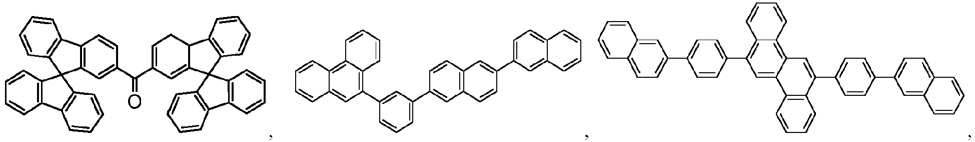 and

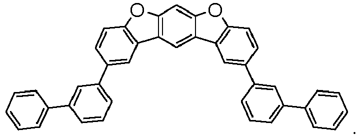

### e) Additional Emitters:

One or more additional emitter dopants may be used in conjunction with the compound of the present disclosure. Examples of the additional emitter dopants are not particularly limited, and any compounds may be used as long as the compounds are typically used as emitter materials. Examples of suitable emitter materials include, but are not limited to, compounds which can produce emissions via phosphorescence, fluorescence, thermally activated delayed fluorescence, i.e., TADF (also referred to as E-type delayed fluorescence), triplet-triplet annihilation, or combinations of these processes.

Non-limiting examples of the emitter materials that may be used in an OLED in combination with materials disclosed herein are exemplified below together with references that disclose those materials: CN103694277, CN1696137, EB01238981, EP01239526, EP01961743, EP1239526, EP1244155, EP1642951, EP1647554, EP1841834, EP1841834B, EP2062907, EP2730583, JP2012074444, JP2013110263, JP4478555, KR1020090133652, KR20120032054, KR20130043460, TW201332980, US06699599, US06916554, US20010019782, US20020034656, US20030068526, US20030072964, US20030138657, US20050123788, US20050244673, US2005123791, US2005260449, US20060008670, US20060065890, US20060127696, US20060134459, US20060134462, US20060202194, US20060251923, US20070034863, US20070087321, US20070103060, US20070111026, US20070190359, US20070231600, US2007034863, US2007104979, US2007104980, US2007138437, US2007224450, US2007278936, US20080020237, US20080233410, US20080261076, US20080297033, US200805851, US2008161567, US2008210930, US20090039776, US20090108737, US20090115322, US20090179555, US2009085476, US2009104472, US20100090591, US20100148663, US20100244004, US20100295032, US2010102716, US2010105902, US2010244004, US2010270916, US20110057559, US20110108822, US20110204333, US2011215710, US2011227049, US2011285275, US2012292601, US20130146848, US2013033172, US2013165653, US2013181190, US2013334521, US20140246656, US2014103305, US6303238, US6413656, US6653654, US6670645, US6687266, US6835469, US6921915, US7279704, US7332232, US7378162, US7534505, US7675228, US7728137, US7740957, US7759489, US7951947, US8067099, US8592586, US8871361, WO06081973, WO06121811, WO07018067, WO07108362, WO07115970, WO07115981, WO08035571, WO2002015645, WO2003040257, WO2005019373, WO2006056418, WO2008054584, WO2008078800, WO2008096609, WO2008101842, WO2009000673, WO2009050281, WO2009100991, WO2010028151, WO2010054731, WO2010086089, WO2010118029, WO2011044988, WO2011051404, WO2011107491, WO2012020327, WO2012163471, WO2013094620, WO2013107487, WO2013174471, WO2014007565, WO2014008982, WO2014023377, WO2014024131, WO2014031977, WO2014038456, WO2014112450.

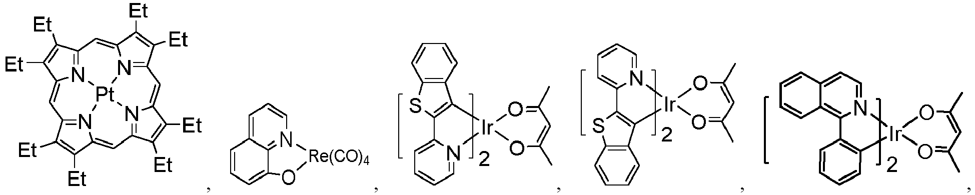

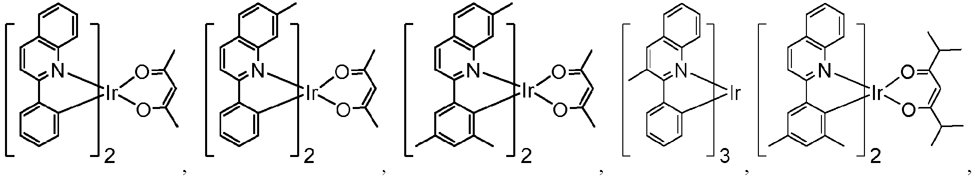

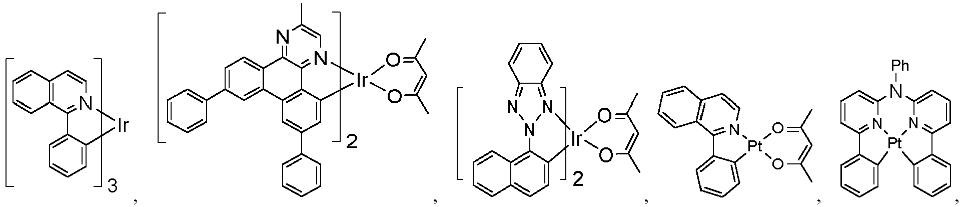

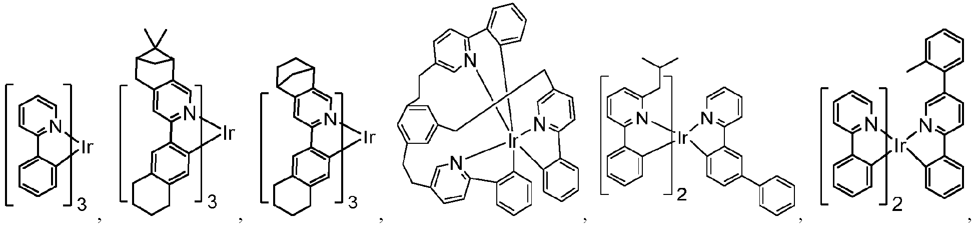

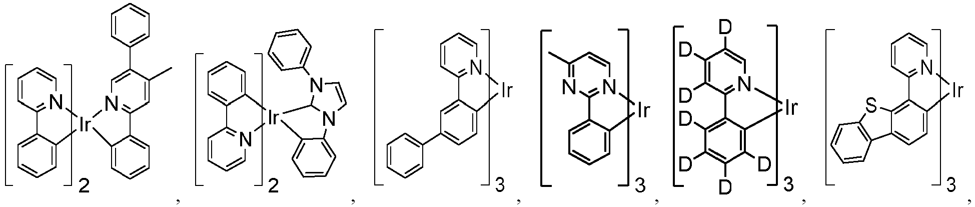

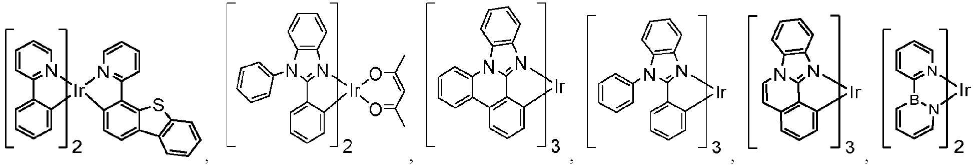

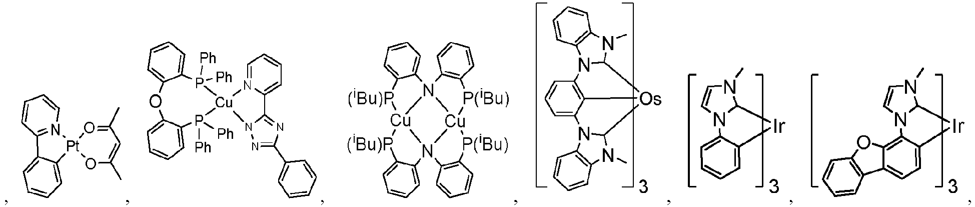

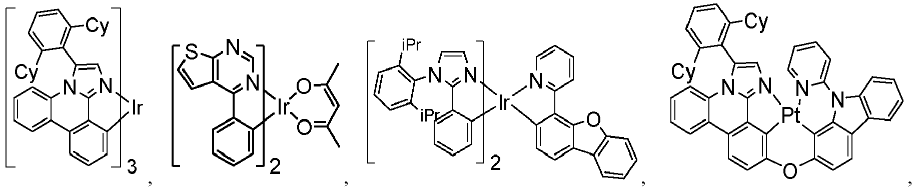

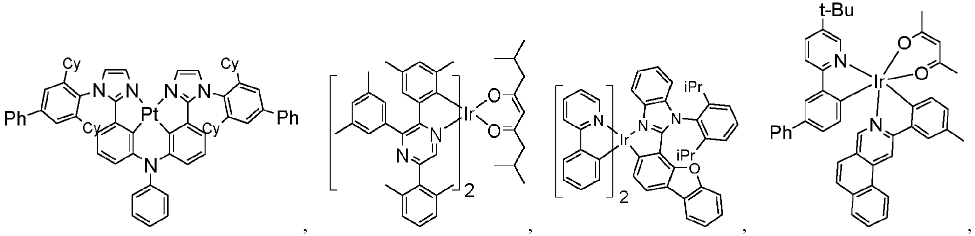

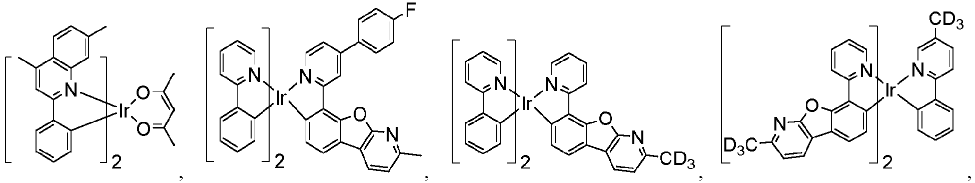

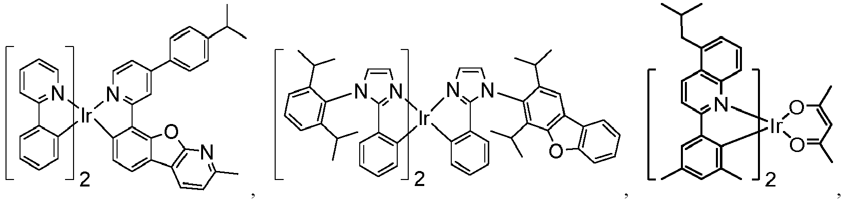

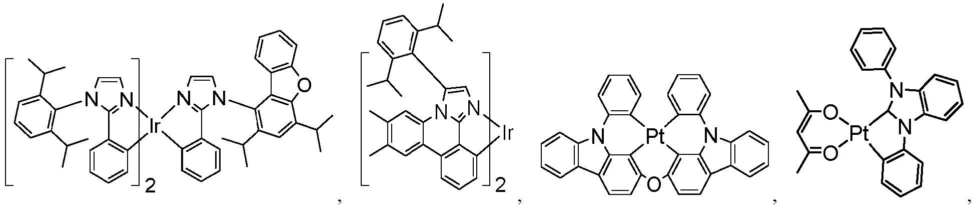

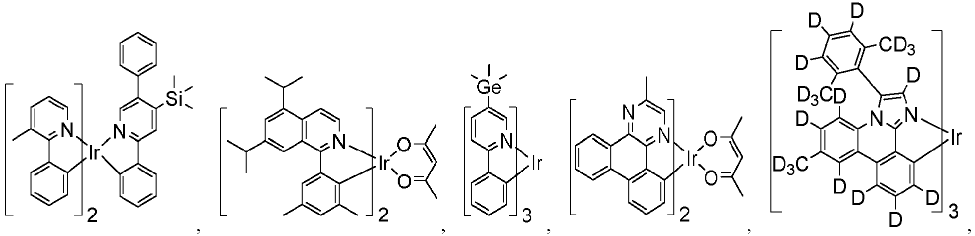

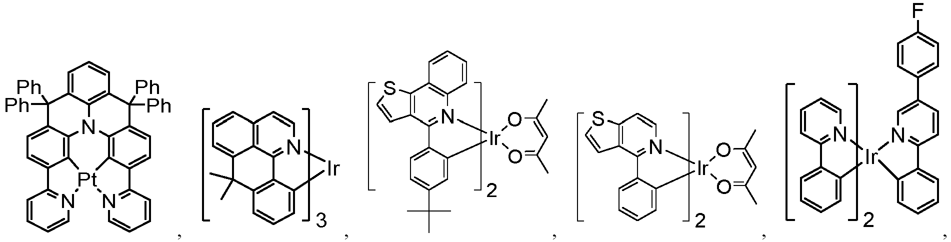

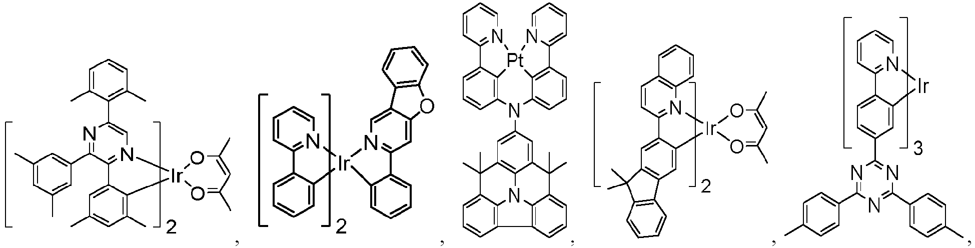

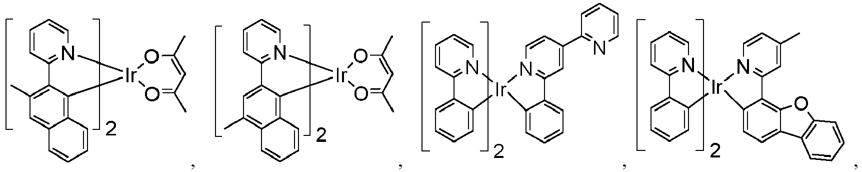

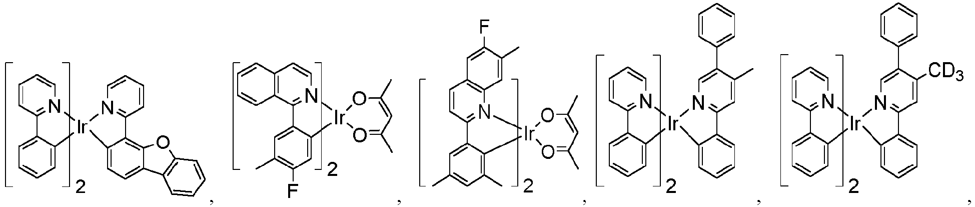

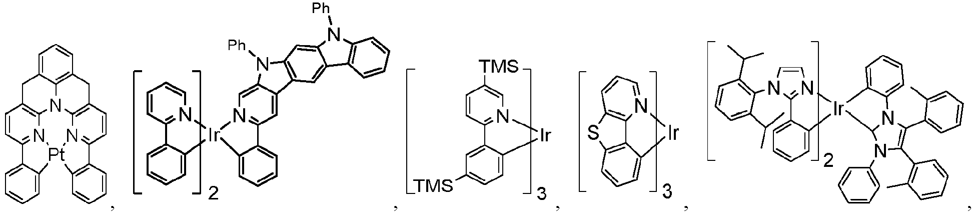

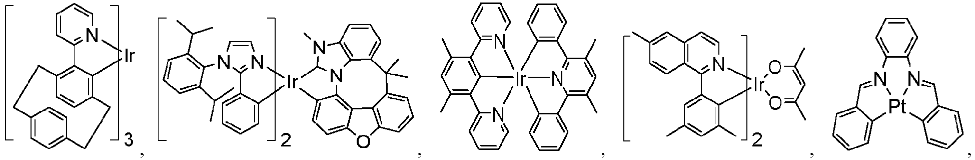

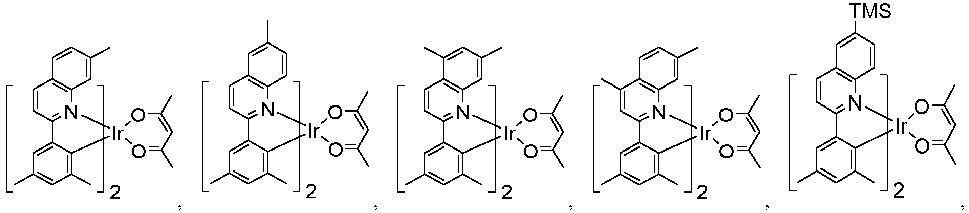

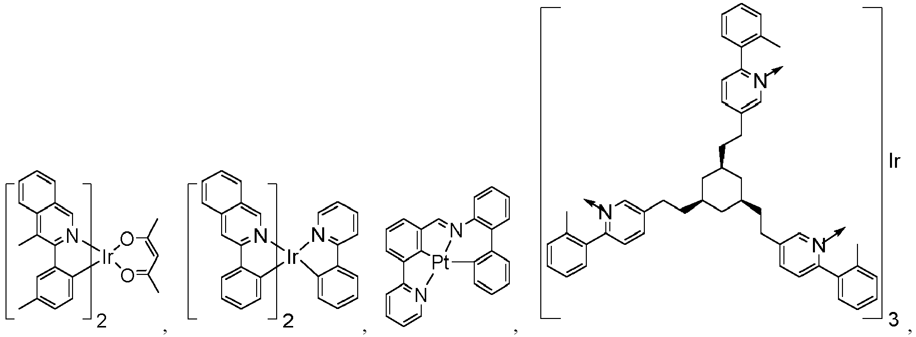

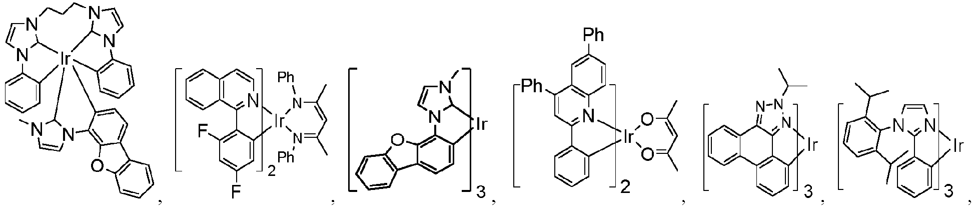

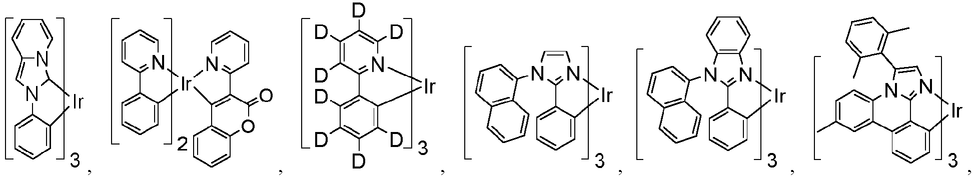

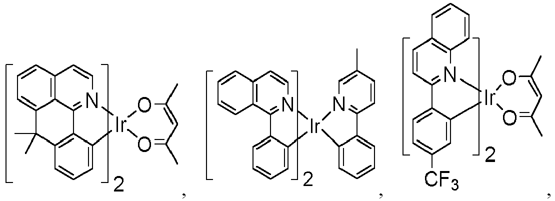

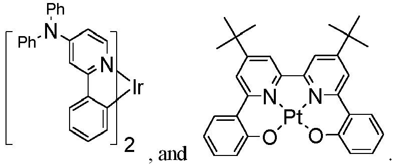

### f) HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and/or higher triplet energy than the emitter closest to the HBL interface. In some embodiments, the HBL material has a lower HOMO (further from the vacuum level) and/or higher triplet energy than one or more of the hosts closest to the HBL interface.

In one aspect, compound used in HBL contains the same molecule or the same functional groups used as host described above.

In another aspect, compound used in HBL contains at least one of the following groups in the molecule: 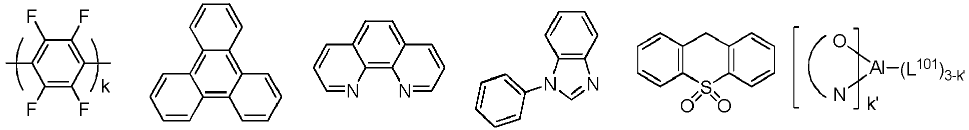 wherein k is an integer from 1 to 20; L¹⁰¹ is another ligand, k' is an integer from 1 to 3.

### g) ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule: 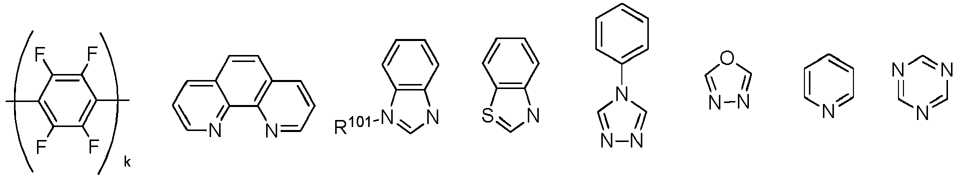 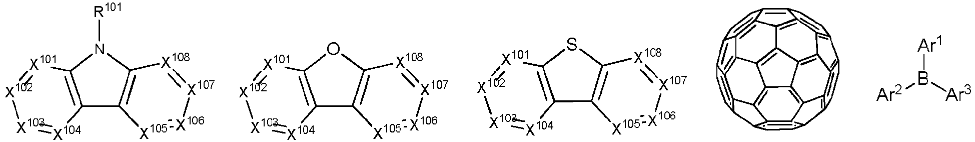 wherein R¹⁰¹ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, when it is aryl or heteroaryl, it has the similar definition as Ar's mentioned above. Ar¹ to Ar³ has the similar definition as Ar's mentioned above. k is an integer from 1 to 20. X¹⁰¹ to X¹⁰⁸ is selected from C (including CH) or N.

In another aspect, the metal complexes used in ETL contains, but not limit to the following general formula: 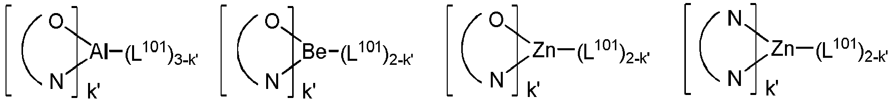 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

Non-limiting examples of the ETL materials that may be used in an OLED in combination with materials disclosed herein are exemplified below together with references that disclose those materials: CN103508940, EP01602648, EP01734038, EP01956007, JP2004-022334, JP2005149918, JP2005-268199, KR0117693, KR20130108183, US20040036077, US20070104977, US2007018155, US20090101870, US20090115316, US20090140637, US20090179554, US2009218940, US2010108990, US2011156017, US2011210320, US2012193612, US2012214993, US2014014925, US2014014927, US20140284580, US6656612, US8415031, WO2003060956, WO2007111263, WO2009148269, WO2010067894, WO2010072300, WO2011074770, WO2011105373, WO2013079217, WO2013145667, WO2013180376, WO2014104499, WO2014104535,

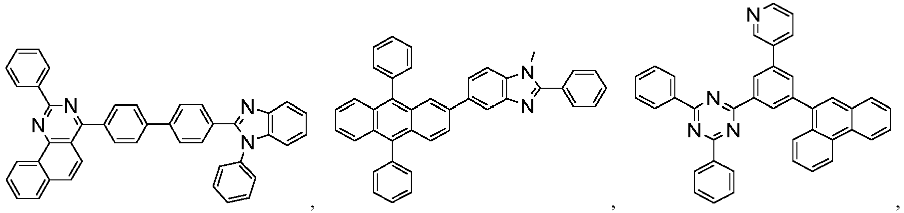

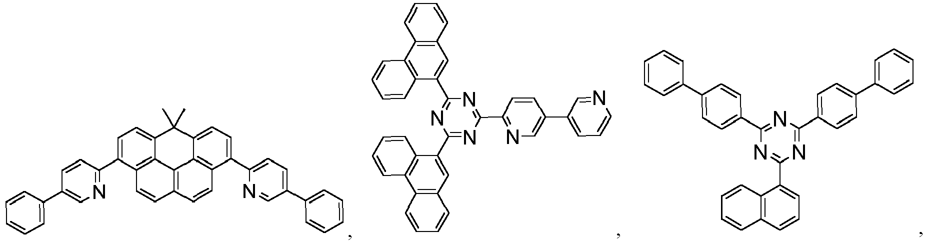

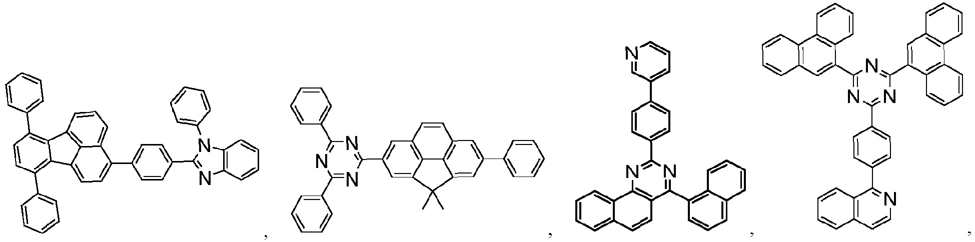

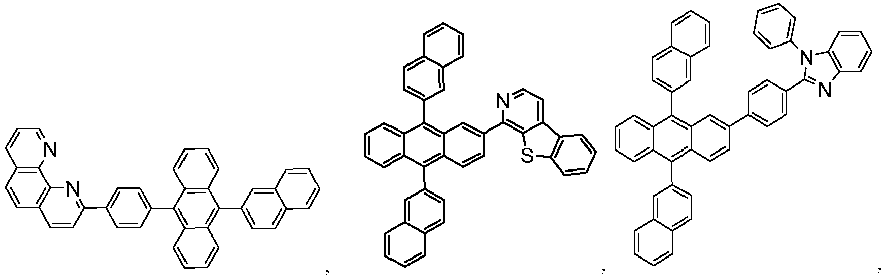

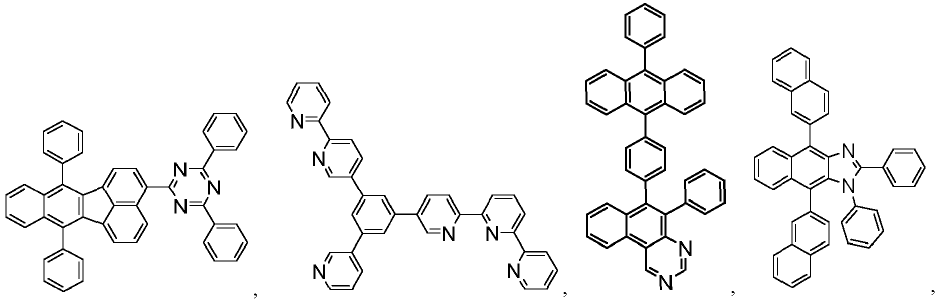

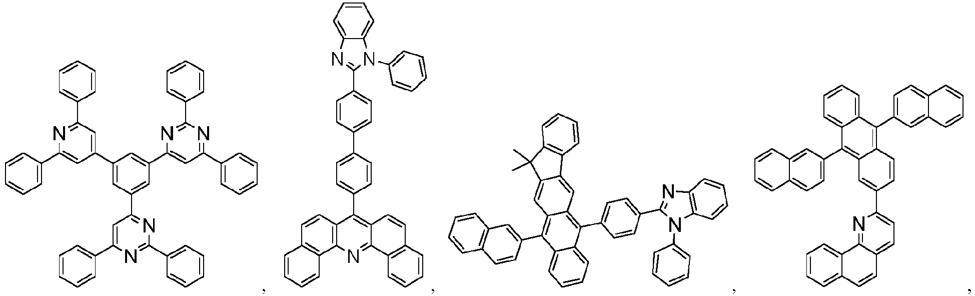

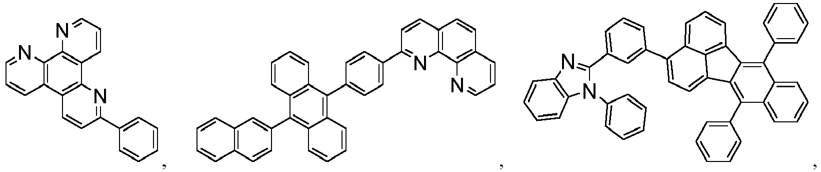

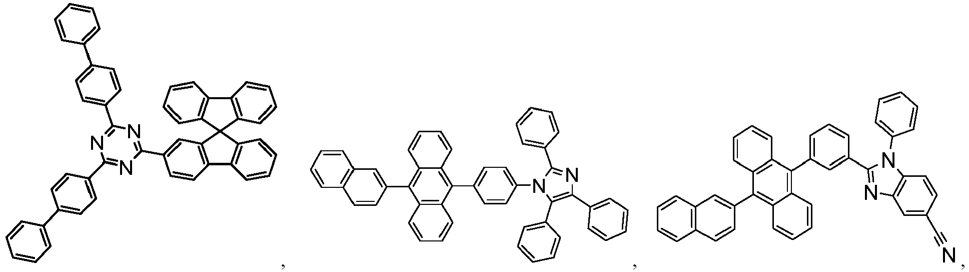

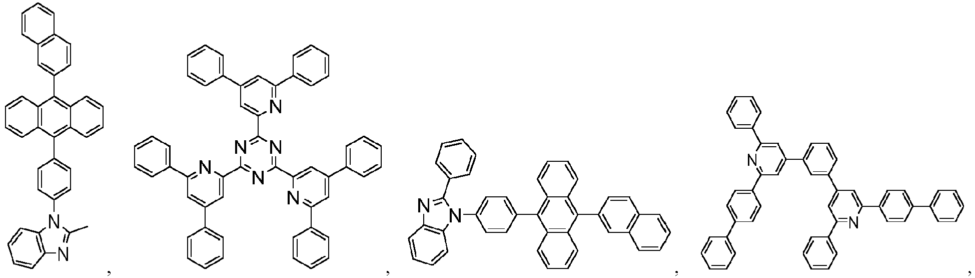

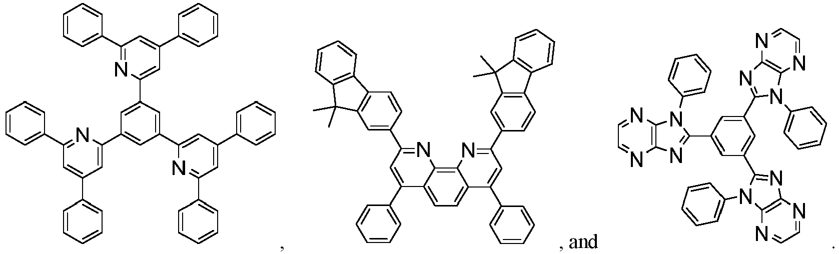

### h) Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any above-mentioned compounds used in each layer of the OLED device, the hydrogen atoms can be partially or fully deuterated. The minimum amount of hydrogen of the compound being deuterated is selected from the group consisting of 30%, 40%, 50%, 60%, 70%, 80%, 90%, 95%, 99%, and 100%. Thus, any specifically listed substituent, such as, without limitation, methyl, phenyl, pyridyl, etc. may be undeuterated, partially deuterated, and fully deuterated versions thereof. Similarly, classes of substituents such as, without limitation, alkyl, aryl, cycloalkyl, heteroaryl, etc. also may be undeuterated, partially deuterated, and fully deuterated versions thereof.

### E. Experimental Data

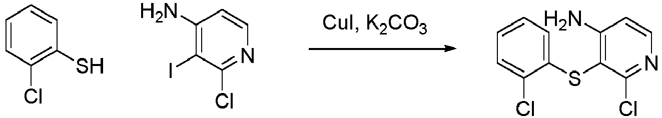

To a 250 mL round bottom flask was added ethylene glycol (6.6 mL, 118 mmol), potassium carbonate (16.3 g, 118 mmol), copper(I) iodide (0.561 g, 2.95 mmol), 2-chloro-3-iodopyridin-4-amine (15 g, 58.9 mmol), 2-chlorobenzenethiol (6.7 mL, 59.1 mmol) and 2-butanol (84 mL) under nitrogen atmosphere and set to reflux for 6 hours. The reaction mixture was cooled to room temperature, filtered and concentrated onto silica gel. Column chromatography (330 g silica column, using 20% ethyl acetate in isohexane) afforded 2-chloro-3-((2-chlorophenyl)thio)pyridin-4-amine (12.4 g, 45.3 mmol, 77 % yield, 99% purity) as a white solid.

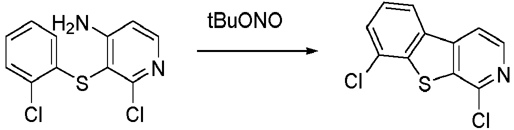

2-chloro-3-((2-chlorophenyl)thio)pyridin-4-amine (12.4 g, 45.7 mmol) was dissolved in acetic acid (150 mL) in an open flask, tert-butyl nitrite (9.1 mL, 68.6 mmol) was added slowly over 2 min and the mixture was stirred at RT for 1 h 40 min. The reaction mixture was poured into ice-water mixture (300 mL) and then stirred for 50 min. The resulting precipitate was collected by filtration and washed with water (3x100 mL), NaHCO3 (100 mL) and hexane (100 mL). The solid was dissolved in DCM (1 liter) and washed with sat. NaHCO3 (3x200 mL) and water (200 mL). The solvent was removed in vacuo to give 1,8-dichlorobenzo[4,5]thieno[2,3-c]pyridine (10.5 g, 38.4 mmol, 84 % yield, 93% purity) as an orange solid.

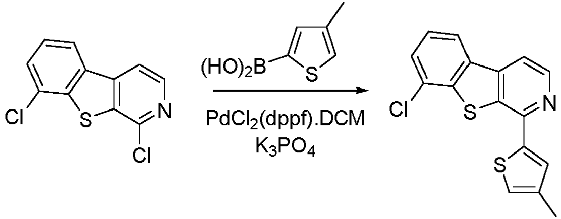

In a 250 mL RBF was added 1,8-dichlorobenzo[4,5]thieno[2,3-c]pyridine (5.0 g, 19.68 mmol), (4-methylthiophen-2-yl)boronic acid (3.07 g, 21.64 mmol), tripotassium phosphate (8.35 g, 39.4 mmol), THF (65.6 mL) and water (32.8 mL) under nitrogen atmosphere. The resulting mixture was purged with nitrogen for 10 min and then was added PdCl2(dppf)-CH2Cl2adduct (0.803 g, 0.984 mmol). The reaction mixture was stirred at 45 °C for 24 h. The reaction mixture was cooled to RT and concentrated under reduced pressure to remove the THF, then extracted with EtOAc (3x50 mL). The combined organics were washed with brine (30 mL) and water (30 mL) and the solvent was removed in vacuo to give the crude compound (4.9 g). The crude compound was purified by flash chromatography (80 g silica column, using 0-100% dichloromethane in isohexane) to give 8-chloro-1-(4-methylthiophen-2-yl)benzo[4,5]thieno[2,3-c]pyridine (3.8 g, 11.79 mmol, 59.9 % yield, 98% purity) as a pale orange solid.

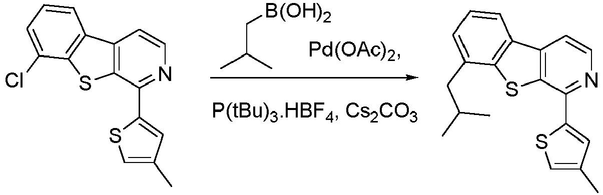

In a 100 mL RBF was charged: 4-chloro-6-(4-methylthiophen-2-yl)dibenzo[b,d]thiophene (3.8 g, 11.22 mmol), isobutylboronic acid (1.72 g, 16.87 mmol), Cs2CO3 (5.5 g, 16.88 mmol), tri-tert-butylphosphonium tetrafluoroborate (0.17 g, 0.586 mmol), toluene (40 mL) and water (20 mL) under nitrogen atmosphere. The resulting mixture was purged with nitrogen for 15 min and then palladium(II) acetate (0.13 g, 0.579 mmol) was added. The resulting reaction mixture was stirred at 100°C for 24 h. The reaction mixture was cooled to RT and degassed the mixture for 20 min and further quantities of isobutylboronic acid (1.72 g, 16.87 mmol), tri-tert-butylphosphonium tetrafluoroborate (0.17 g, 0.586 mmol) and palladium(II) acetate (0.13 g, 0.579 mmol) were added. The reaction mixture was further stirred again at 100°C overnight, cooled to RT, diluted with water (50 mL) and extracted with EtOAc (3x100 mL). The combined organics washed with brine (3x50 mL). The solvent was removed in vacuo and the crude compound was purified by flash chromatography (80 g silica column, using 0-30% EtOAc in isohexane to give 8-isobutyl-1-(4-methylthiophen-2-yl)benzo[4,5]thieno[2,3-c]pyridine (2.45 g, 7.24 mmol, 54.3 % yield) as a white solid.

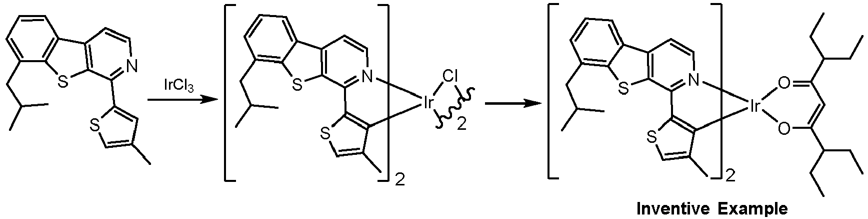

8-Isobutyl-1-(4-methyl-thiophen-2-yl)benzo[4,5]thieno[2,3-c]pyridine (2.025 g, 6.00 mmol, 2.0 equiv) and iridium(III) chloride hydrate (1.112 g, 3.0 mmol, 1.0 equiv) were added to a 40 mL vial equipped with a stir bar. 2-Ethoxyethanol (24 mL) and DIUF water (8 mL) were added. The reaction mixture was sparged with nitrogen for 10 minutes, the vial sealed then the reaction mixture heated at 90 °C for 24 hours. After cooling to room temperature, the reaction mixture was diluted with water (5 mL). The suspension was filtered, the solid washed with methanol (50 mL) then dried on the funnel under vacuum to give di-*µ*-chloro-tetrakis[(8-isobutyl-1-(4-methyl-thiophen-2-yl)-3'-yl)benzo[4,5]thieno[2,3-*c*]pyridine-2-yl]diiridium(III) as (2.57 g, 95% yield) as a red solid.

A 3-necked 250 mL round-bottom flask, equipped with a stir bar, thermocouple and reflux condenser, was charged with di-*µ*-chloro-tetrakis[(8-isobutyl-1-(4-methylthiophen-2-yl)-3'-yl)benzo[4,5]thieno[2,3-*c*]pyridin-2-yl]-diiridium(III) (2.57 g, 1.427 mmol, 1.0 equiv), 3,7-diethylnonane-4,6-dione (1.212 g, 5.71 mmol, 4.0 equiv), dichloromethane (10 mL) and methanol (70 mL) and the mixture sparged with nitrogen for 5 minutes. Powdered potassium carbonate (1.183 g, 8.56 mmol, 6.0 equiv) was added then the reaction mixture heated at 43 °C for 66 hours. After cooling to room temperature, water (30 mL) was added. The red suspension was filtered and the solid washed with methanol (50 mL). The solid were dissolved/suspended in dichloromethane (500 mL) and filtered through a silica gel pad (70 g), rinsing with dichloromethane (2 L). The recovered product was triturated with a 1:1 mixture of dichloromethane (100 mL) and methanol (100 mL) and filtered to give bis[(8-isobutyl-1-(4-methylthio-phenyl-2-yl)-3'-yl)benzo[4,5]thieno[2,3-*c*]pyridine-2-yl]-[3,7-diethylnonane-4,6-dionato-κ₂*O*,*O*']iridium(III) (1.53 g, 50% yield) as a red solid.

### Device Examples

All example devices were fabricated by high vacuum (< 0.0001333224 Pa/ :10⁻⁷ Torr) thermal evaporation. The anode electrode was 1,200 Å of indium tin oxide (ITO). The cathode consisted of 10 Å of Liq (8-hydroxyquinoline lithium) followed by 1,000 Å of Al. All devices were encapsulated with a glass lid sealed with an epoxy resin in a nitrogen glove box (<1 ppm of H₂O and O₂) immediately after fabrication, and a moisture getter was incorporated inside the package. The organic stack of the device examples consisted of sequentially, from the ITO surface, 100Å of LG101 (purchased from LG Chem) as the hole injection layer (HIL); 400 Å of HTM as a hole transporting layer (HTL); 50 Å of EBM as a electron blocking layer (EBL); 400 Å of an emissive layer (EML) containing RH and 18% RH2 as red host and 3% of emitter, and 350 Å of Liq (8-hydroxyquinolinelithium) doped with 35% of ETM as the electron transporting layer (ETL). Table 1 shows the thickness of the device layers and materials.

**Table 1. Device layer materials and thicknesses**

| Layer | Material | Thickness [Å] |
|---|---|---|
| Anode | ITO | 1,200 |
| HIL | LG101 | 100 |
| HTL | HTM | 400 |
| EBL | EBM | 50 |
| EML | RH1:RH2 18%: Red emitter 3% | 400 |
| ETL | Liq: ETM 35% | 350 |
| EIL | Liq | 10 |
| Cathode | Al | 1,000 |

The chemical structures of the device materials are shown below:

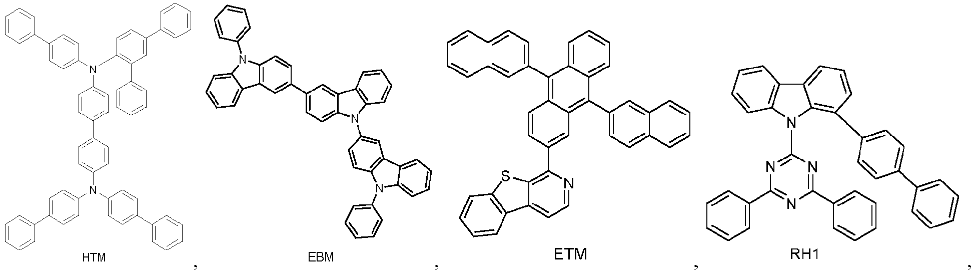

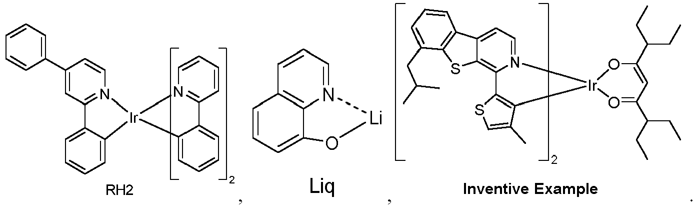

Upon fabrication devices have been EL and JVL tested. For this purpose, the sample was energized by the 2 channel Keysight B2902A SMU at a current density of 10 mA/cm² and measured by the Photo Research PR735 Spectroradiometer. Radiance (W/str/cm²) from 380 nm to 1080 nm, and total integrated photon count were collected. The device was then placed under a large area silicon photodiode for the JVL sweep. The integrated photon count of the device at 10 mA/cm² was used to convert the photodiode current to photon count. The voltage was swept from 0 to a voltage equating to 200 mA/cm². The EQE of the device is calculated using the total integrated photon count. All results are summarized in Table 2.

**Table 2.**

| **Device** | **Red emitter** | **λ max [nm]** | **FWHM [nm]** | **At 10 mA/cm²** | | | |
|---|---|---|---|---|---|---|---|
| | | | | **Voltage [V]** | **LE[cd/A]** | **EQE [%]** | **PE[lm/W]** |
| Device 1 | Inventive example | 612 | 37 | 3.7 | 34.8 | 27.4 | 29.8 |

Table 2 summarizes the performance of electroluminescence device. The inventive device shows good device performance with low voltage (3.7 V) and high EQE (27.4%). because of the narrow electroluminescence spectrum with small FWHM (37 nm), the inventive device gives high luminescence efficacy (34.8 cd/A). As a result, the inventive compounds can be used as emissive dopants to improve the organic light emitting device (OLED) performance.

## Claims

1. A compound comprising a ligand L_{A} having a structure of 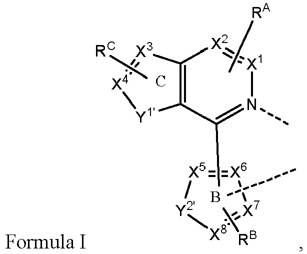 wherein:
each of X¹, X², X³, X⁴, X⁵, X⁶, X⁷, and X⁸ is independently C or N;
each of Y^{1'} and Y^{2'} is independently selected from the group consisting of O, S, Se;
each of R^{A}, R^{B}, and R^{C} is independently represent mono to the maximum allowable substitution, or no substitution;
each of R^{A}, R^{B}, and R^{C} is independently a hydrogen or a substituent selected from the group consisting of deuterium, halogen, alkyl, cycloalkyl, heteroalkyl, heterocycloalkyl, boryl, selenyl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof;
L_{A} is coordinated to metal M through the indicated dashed lines to form a 5-membered chelate ring;
metal M is selected from the group consisting of Ru, Os, Ir, Pd, Pt, Cu, Ag, and Au;
Ring B is coordinated to M by a C-M bond;
M may be coordinated to other ligands;
L_{A} can be joined with other ligands to form a tridentate, tetradentate, pentadentate, or hexadentate ligand; and
any two adjacent R^{A}, and R^{C} can be joined or fused to form a ring.

2. The compound of claim 1, wherein each of R^{A}, R^{B}, and R^{C} is independently a hydrogen or a substituent selected from the group consisting of deuterium, fluorine, alkyl, cycloalkyl, heteroalkyl, alkoxy, aryloxy, amino, silyl, boryl, alkenyl, cycloalkenyl, heteroalkenyl, aryl, heteroaryl, nitrile, isonitrile, sulfanyl, and combinations thereof.

3. The compound of either of claim 1 or claim 2, wherein each of X¹, X², X³, X⁴, X⁵, X⁶, X⁷, and X⁸ is C; or at least one of X¹, X², X³, X⁴, X⁵, X⁶, X⁷, and X⁸ is N.

4. The compound of claim 1, wherein one of X¹ and X² is N; or one of X³ and X⁴ is N.

5. The compound of claim 1, wherein X³ and X⁴ are C, and two R^{C} are joined to form a ring system fused with ring C.

6. The compound of claim 5, wherein the ring system comprises one ring fused to ring C; or at least two rings fused to ring C; or at least three rings fused to ring C.

7. The compound of any one of the previous claims, wherein L_{A} has a structure of 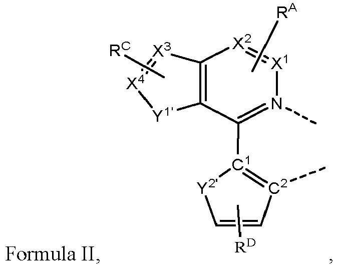
wherein C¹ and C² are carbon atoms joined by a double bond;
wherein R^{D} represents mono- or di- substitution, or no substitution; and
each R^{D} is independently a hydrogen or a substituent selected from the group consisting of deuterium, halogen, alkyl, cycloalkyl, heteroalkyl, heterocycloalkyl, boryl, selenyl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof.

8. The compound of any one of the previous claims, wherein the ligand L_{A} is selected from the group consisting of the structures of: 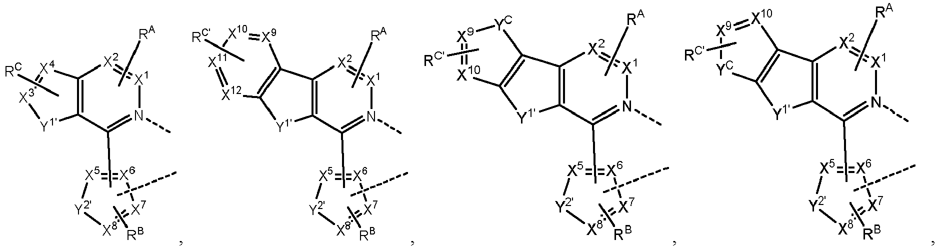 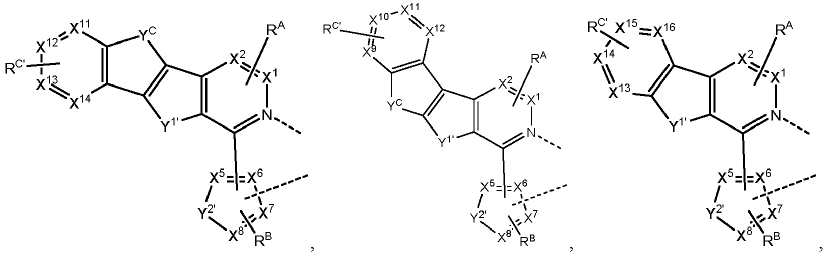 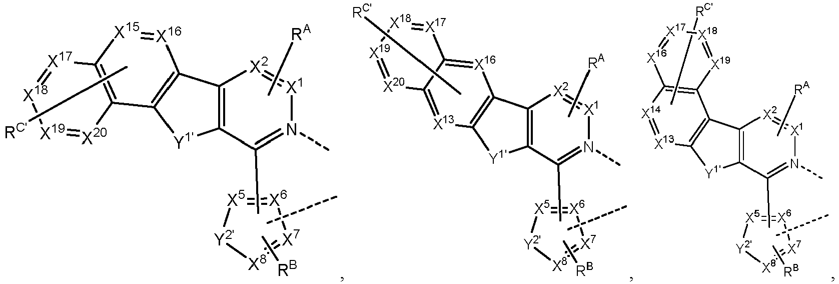 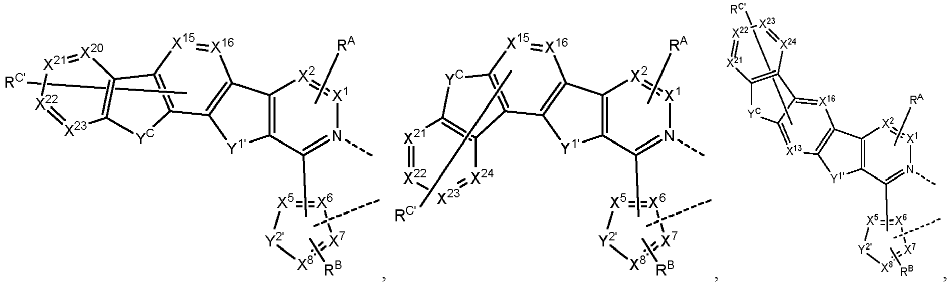 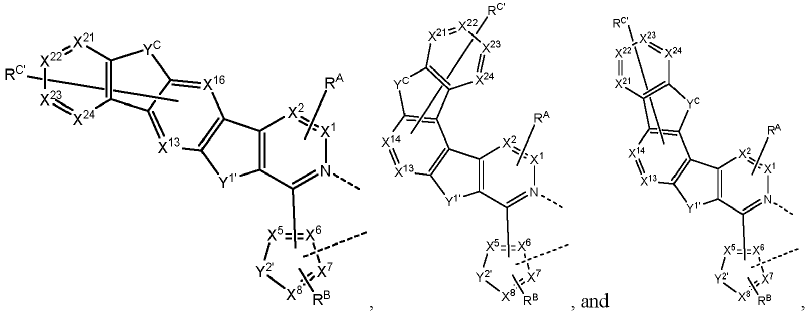 wherein
each of X⁹ to X²⁴ is independently C or N;
Y^{C} is selected from the group consisting of O, S, CR'R", SiR'R", BR', and NR';
R^{C'} represents mono to the maximum allowable substitution, or no substitution; and
each R^{C'} is independently a hydrogen or a substituent selected from the group consisting of deuterium, halogen, alkyl, cycloalkyl, heteroalkyl, heterocycloalkyl, boryl, selenyl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof.

9. The compound of any one of the previous claims, wherein the ligand L_{A} is selected from the group consisting of L_{Ai-m-X}, wherein *i* is an integer from 1 to 2610, *m* is an integer from 1 to 108, and X is from 1 to 3, with 1 being for O, 2 for S, 3 for Se, wherein each of L*_{Ai-1-X}* to L*_{Ai-108-X}* has the structure defined as follows: 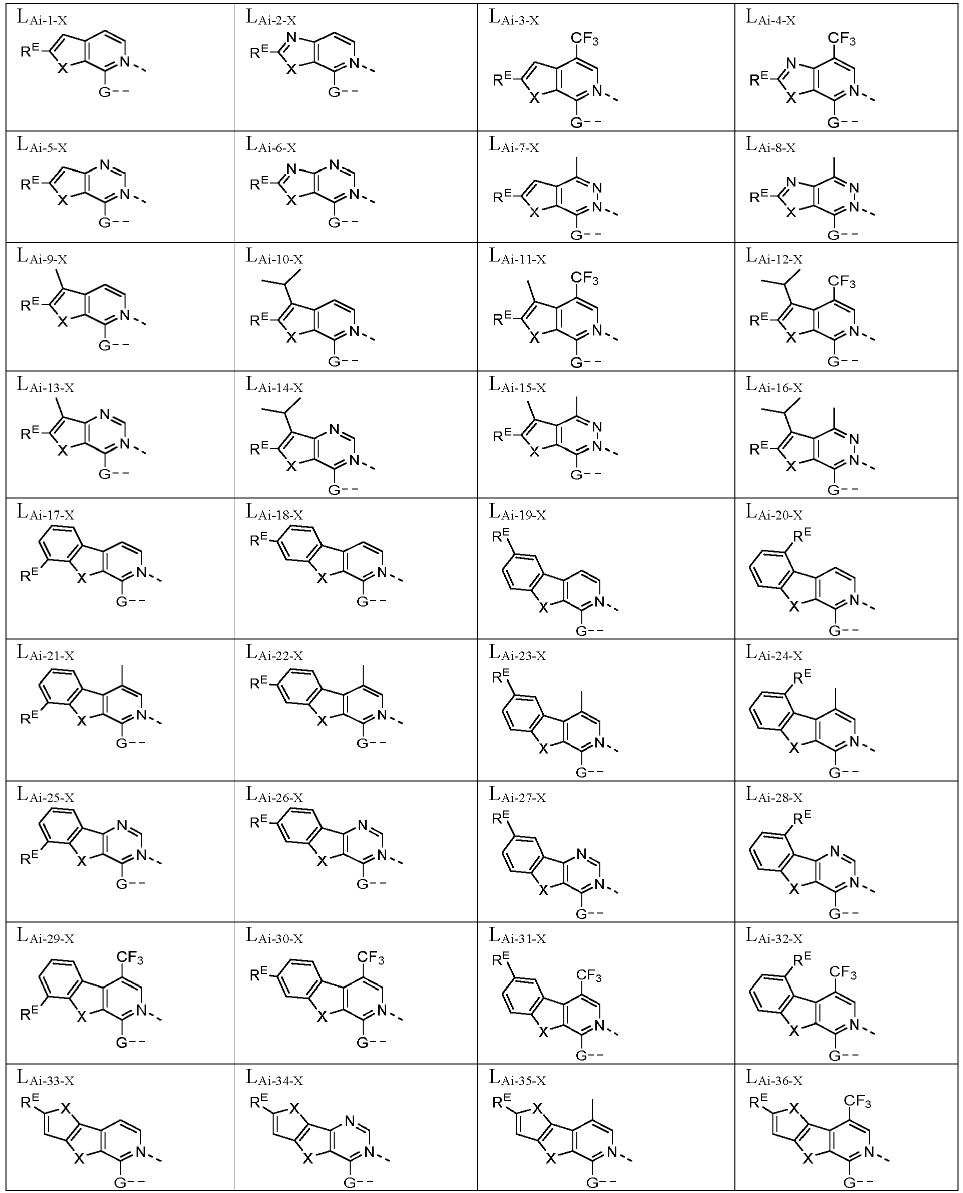 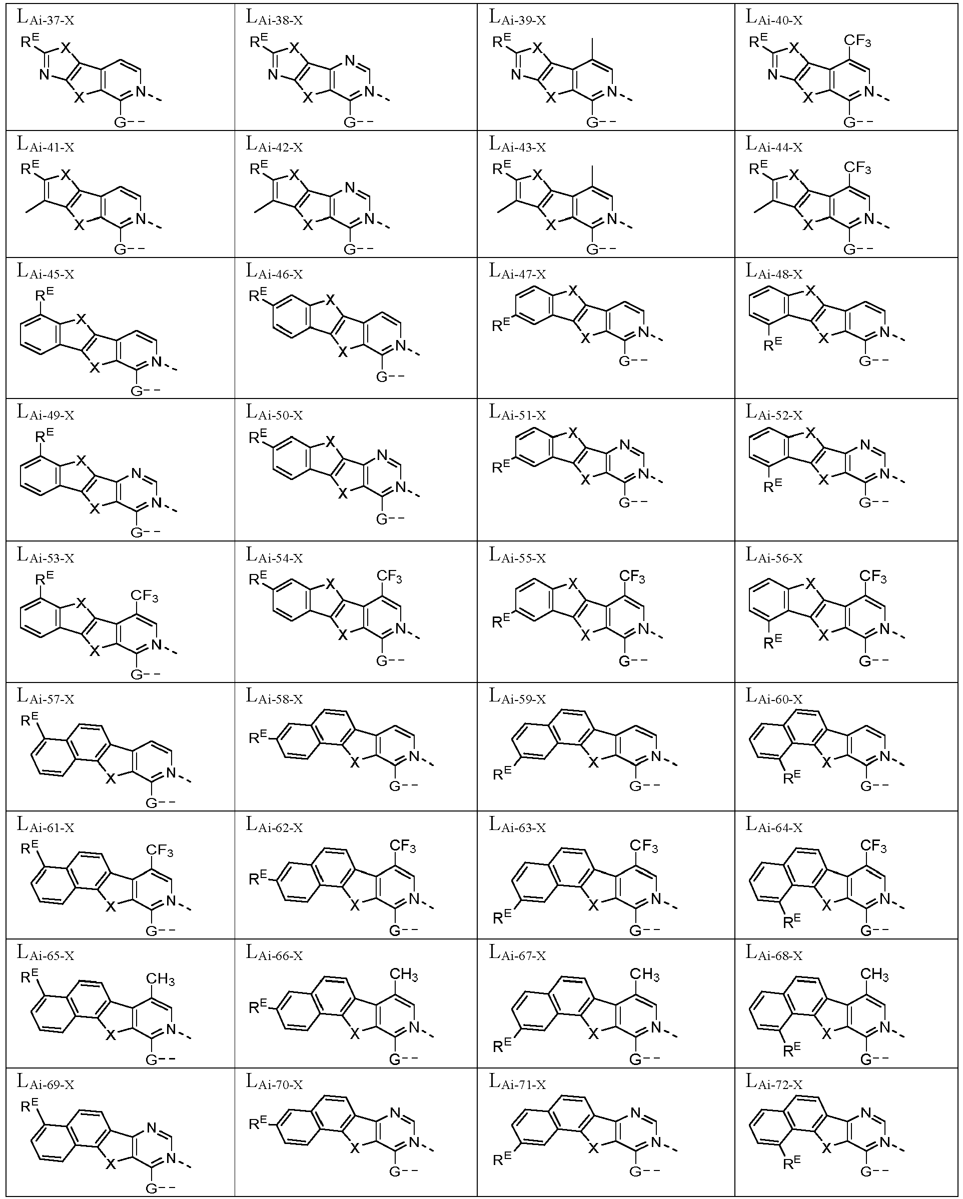 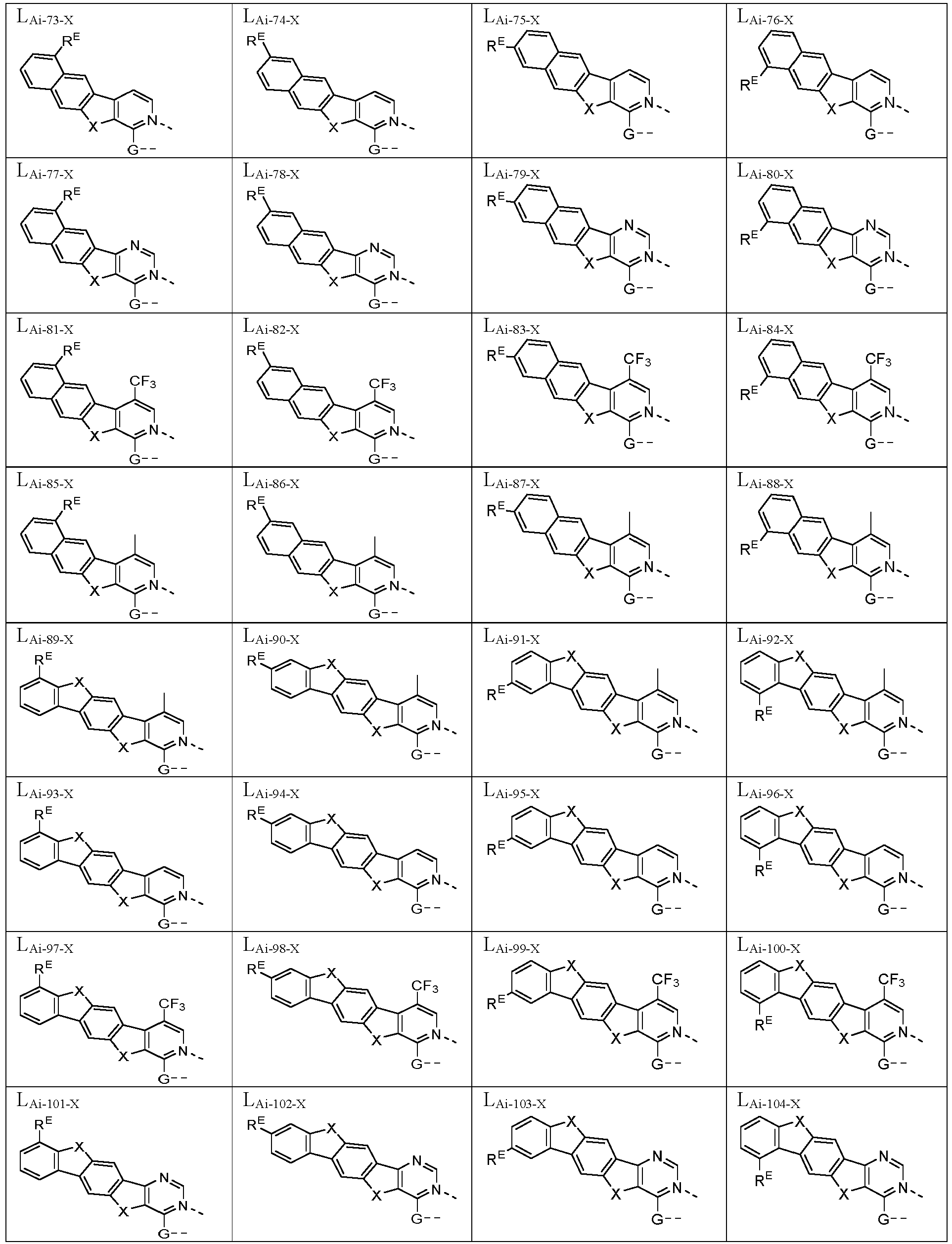 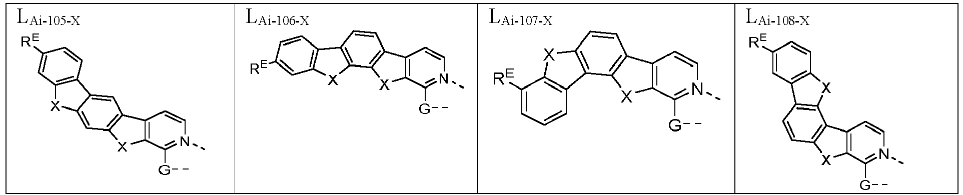 ; wherein for each of L_{A1} to L_{A2610}, R^{E} and G are defined as follows: 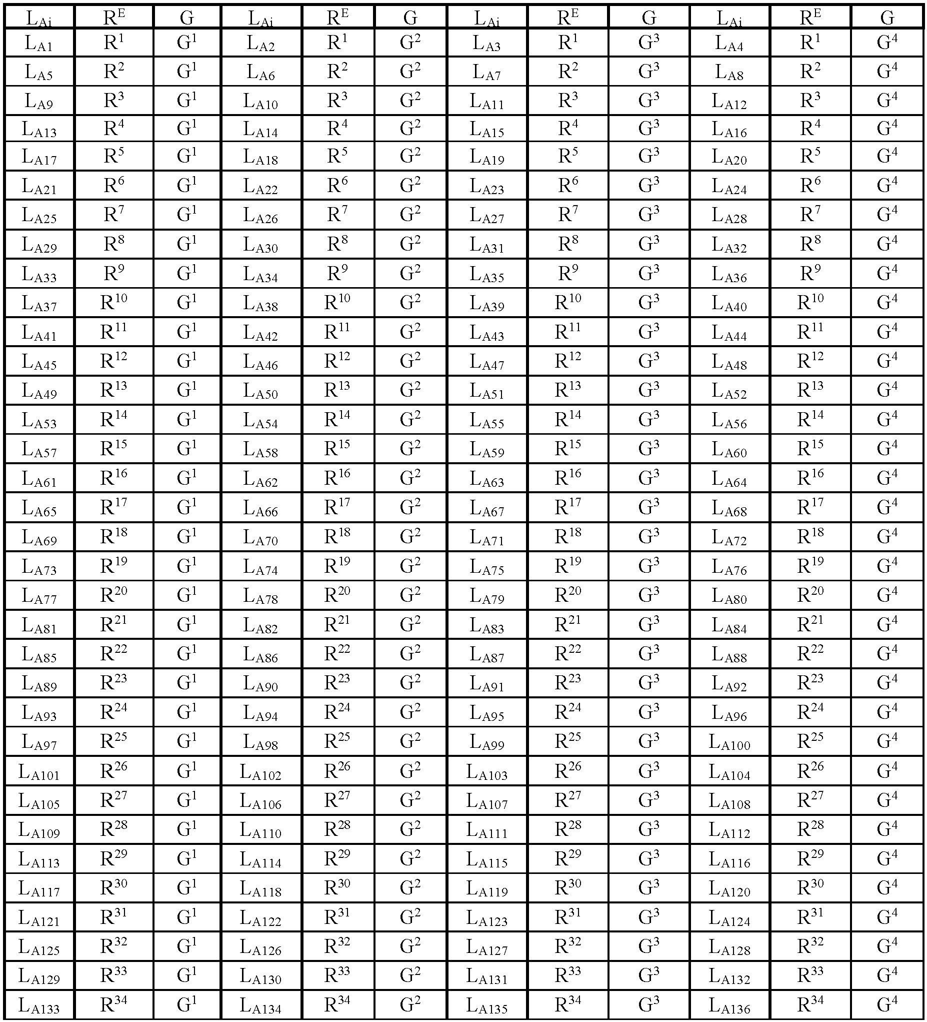 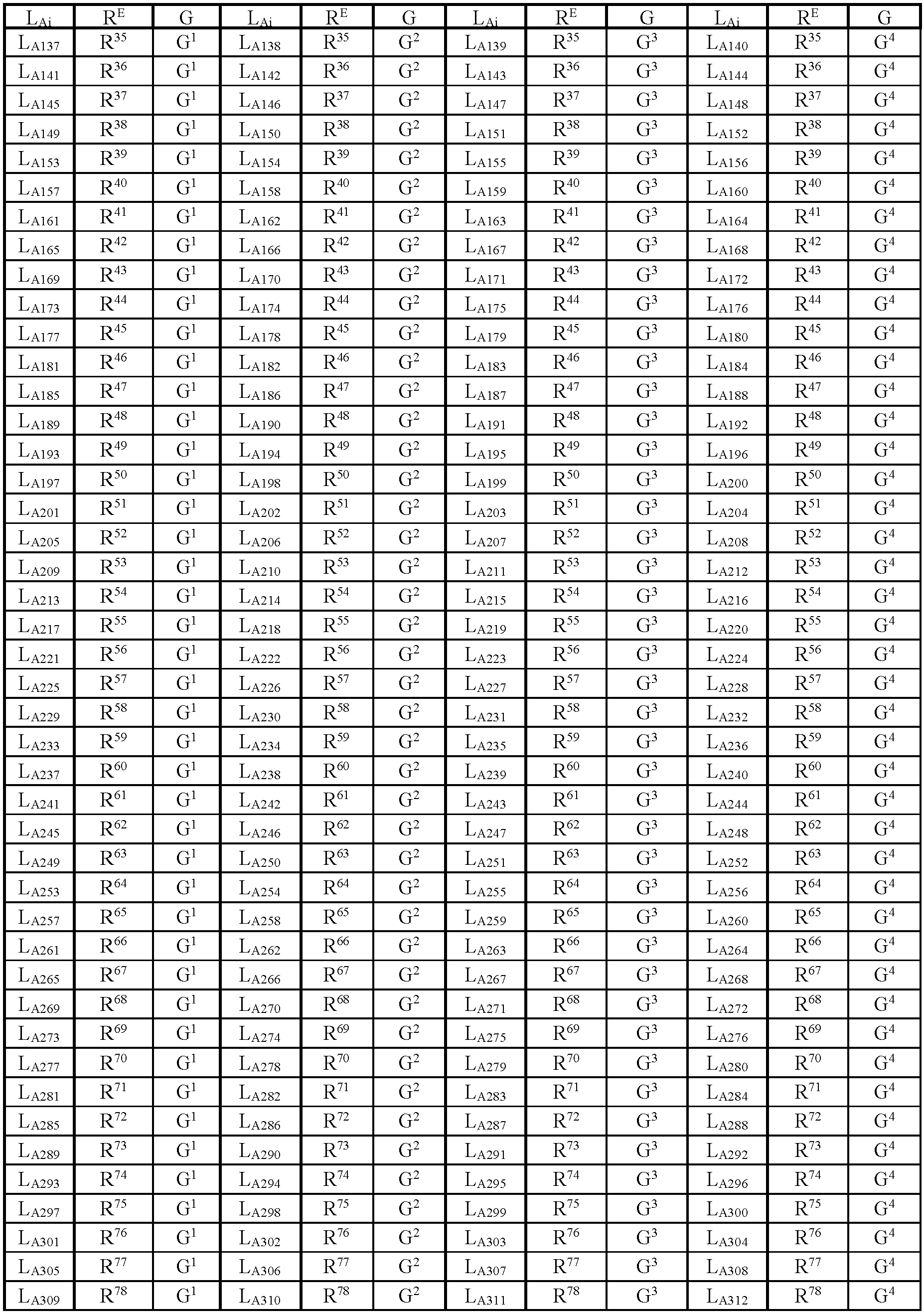 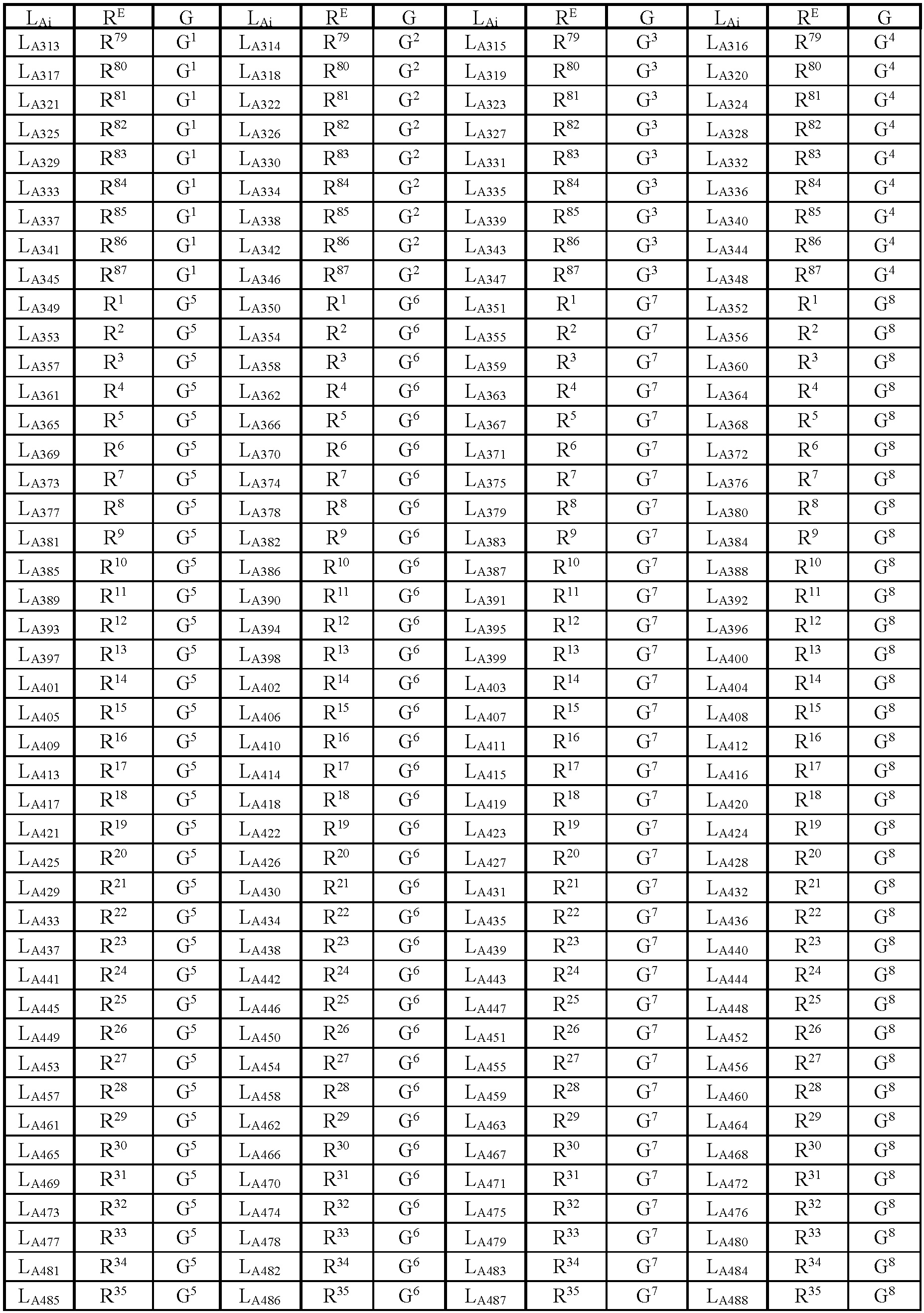 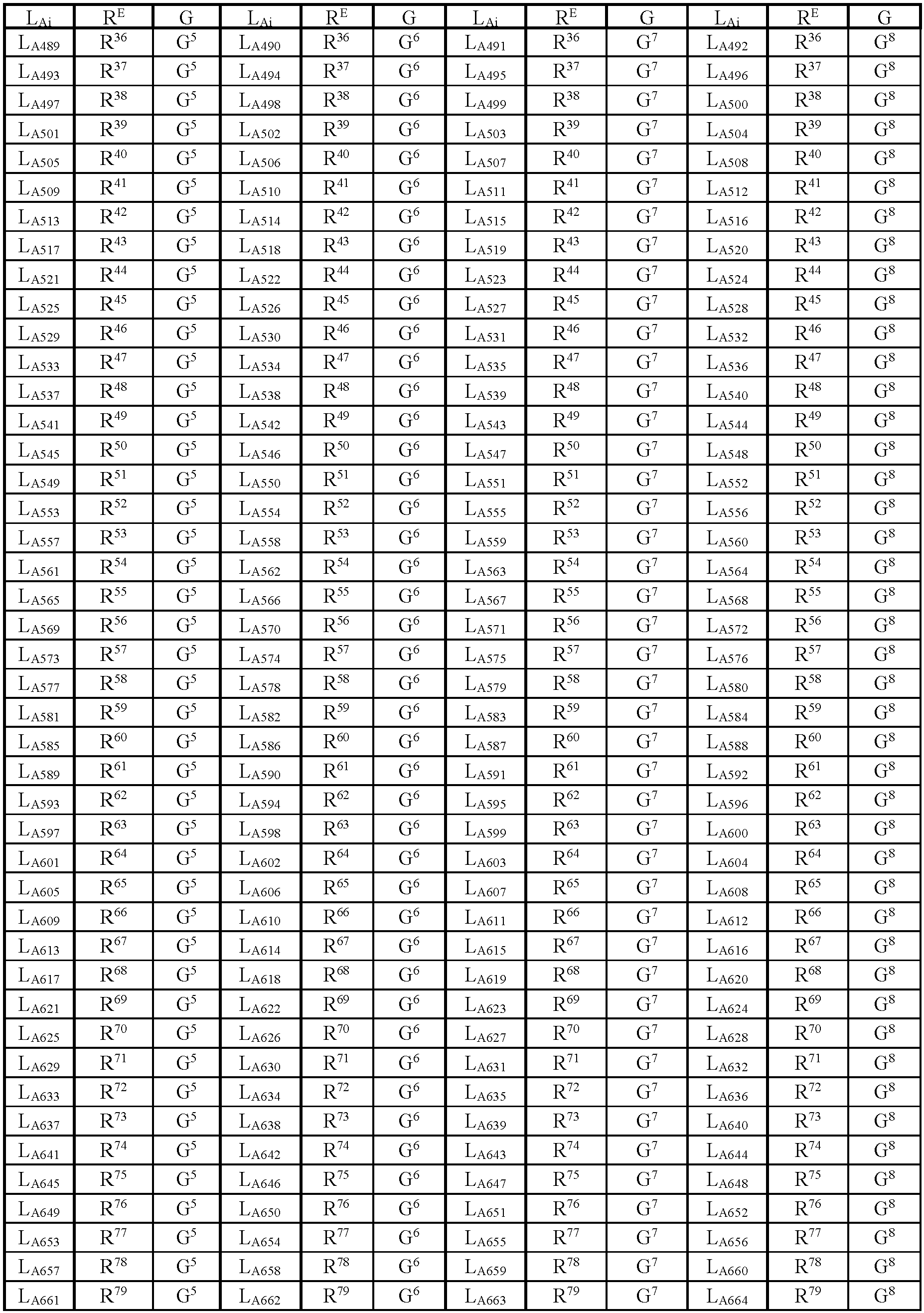 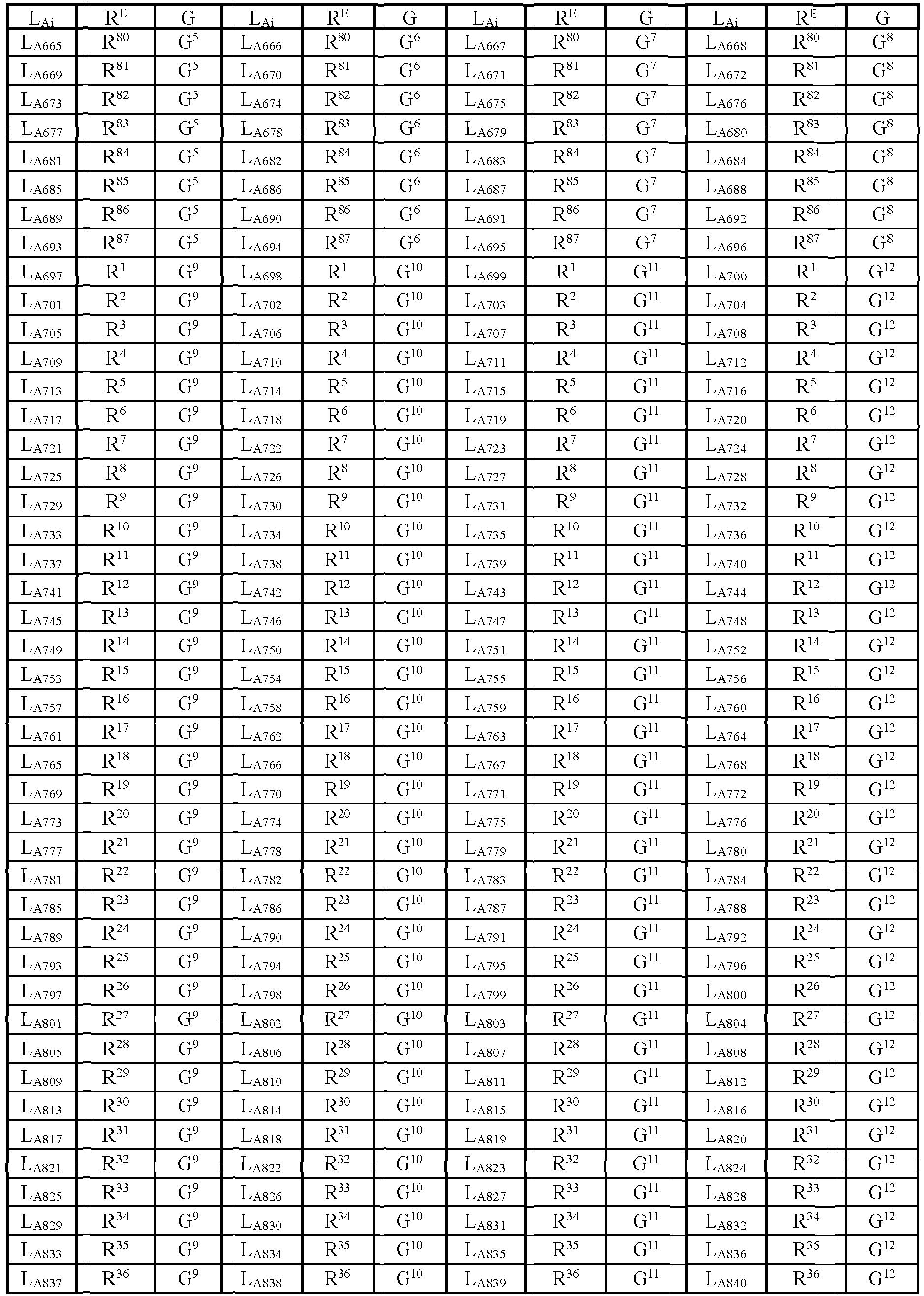 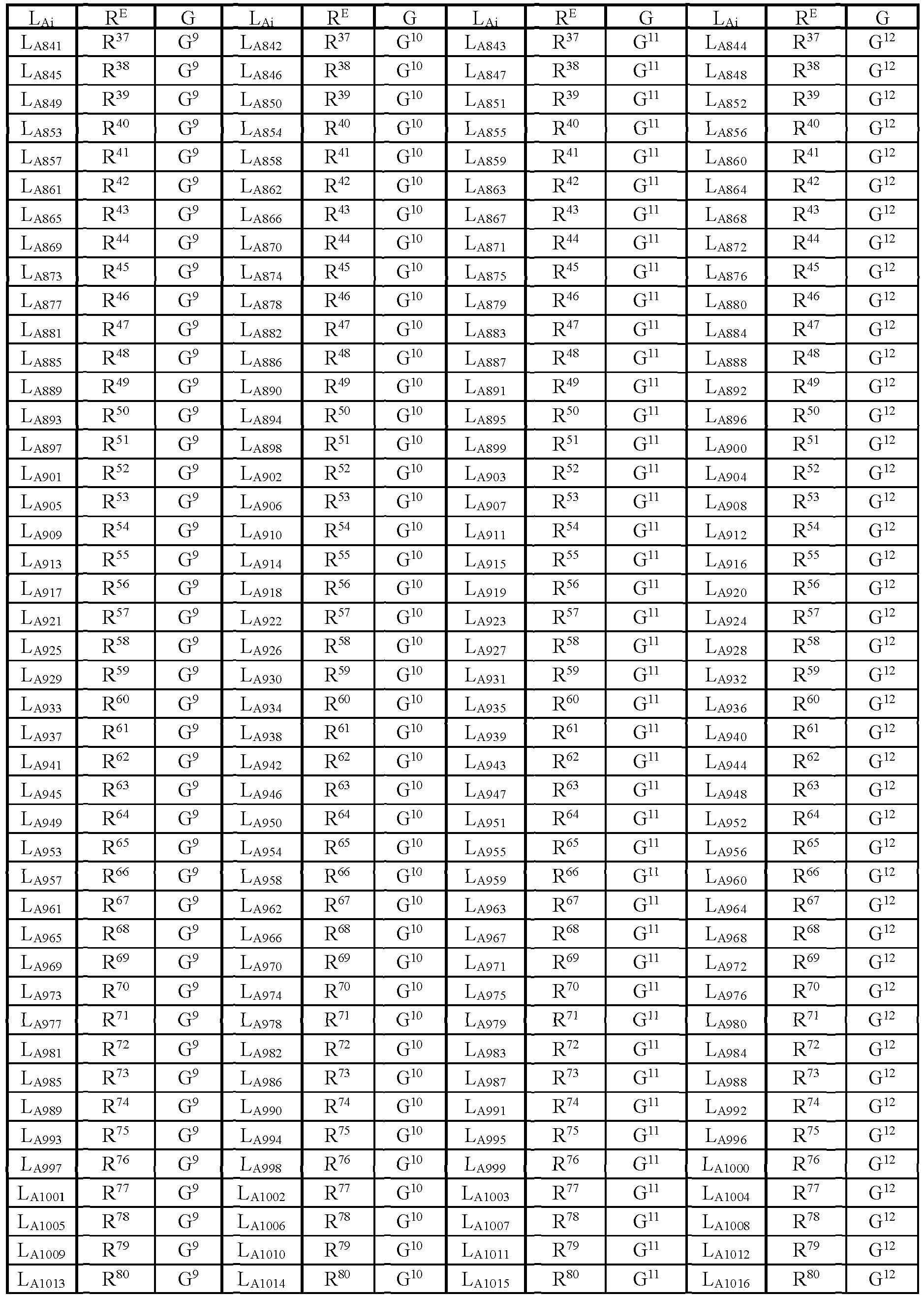 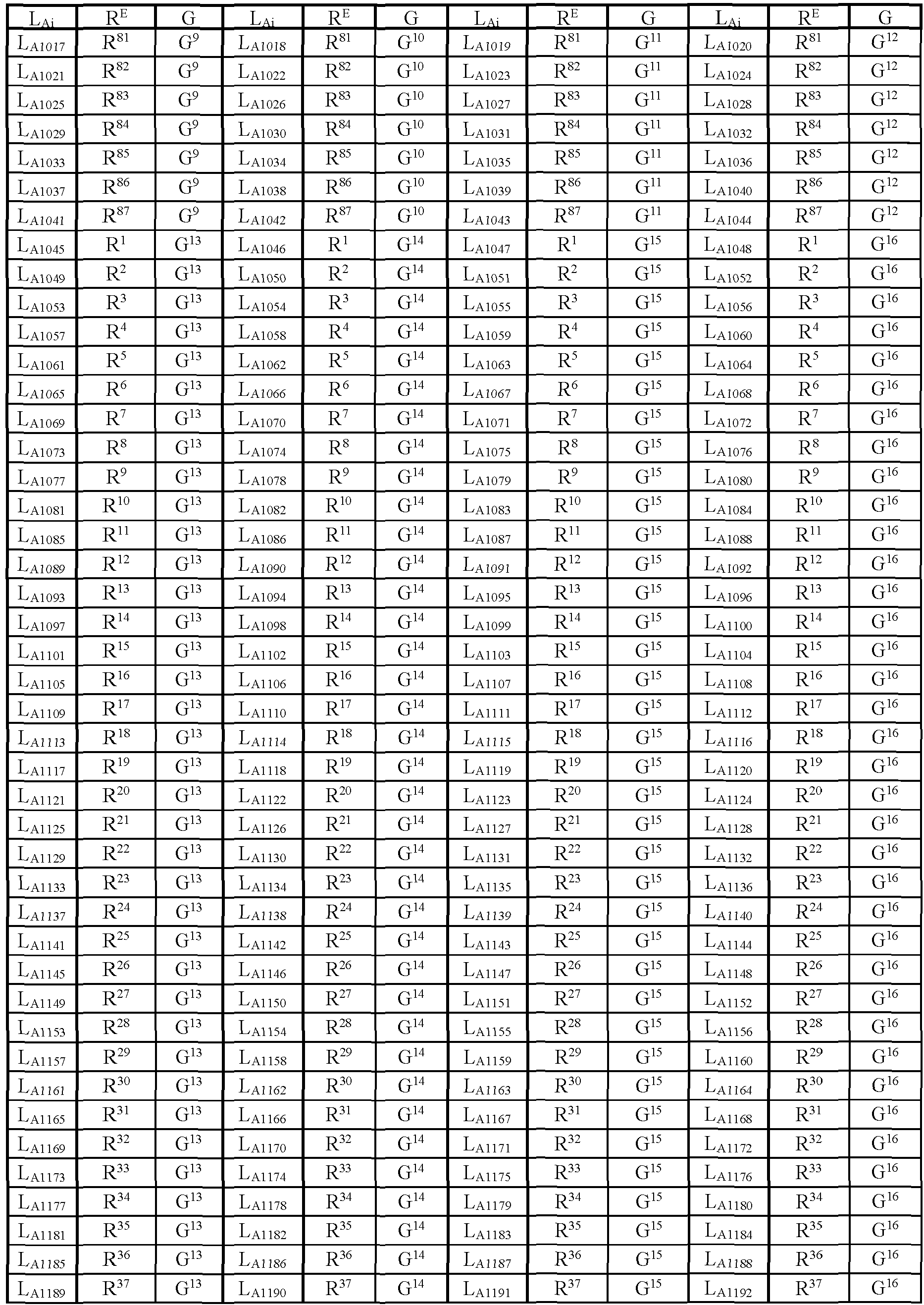 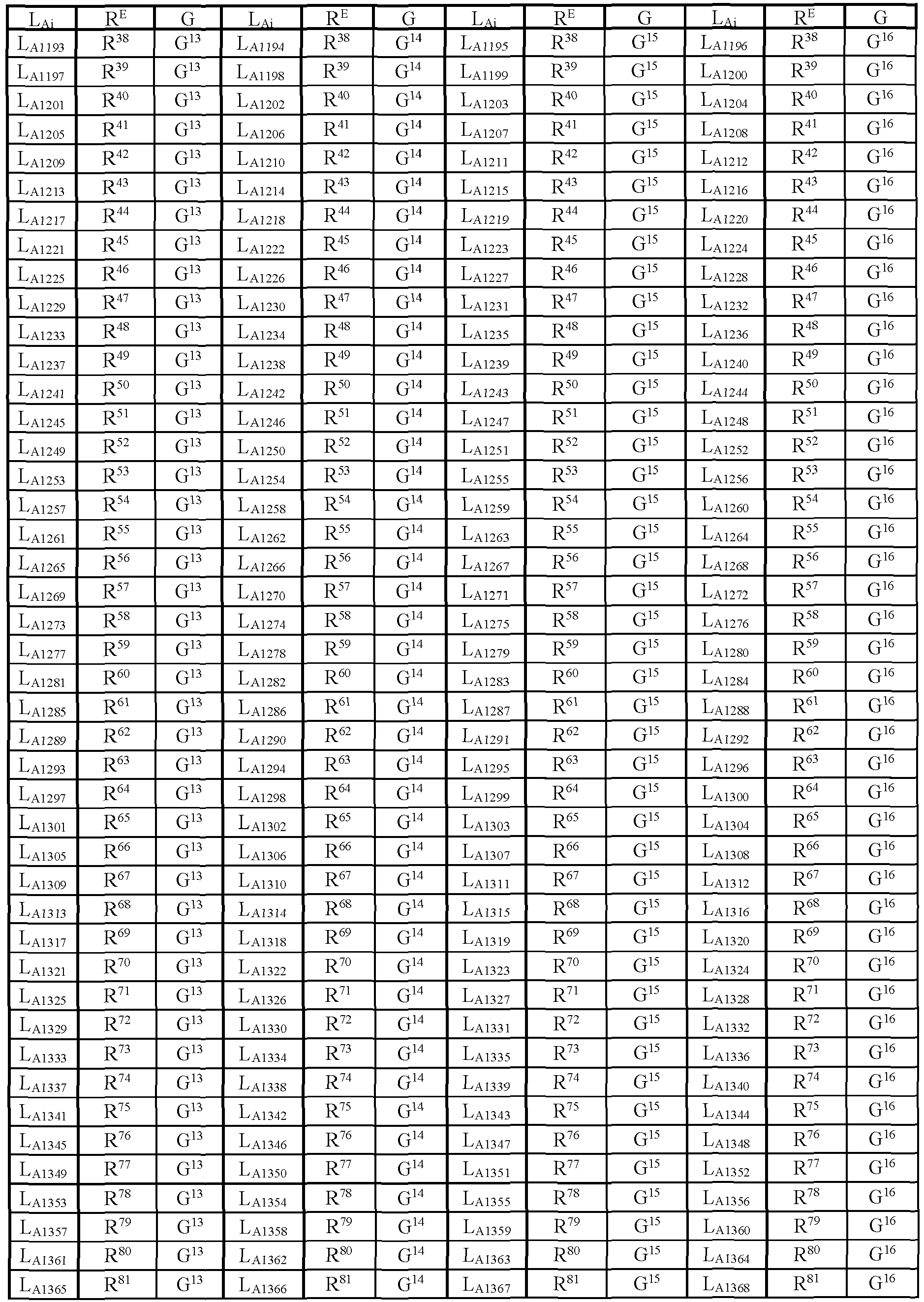 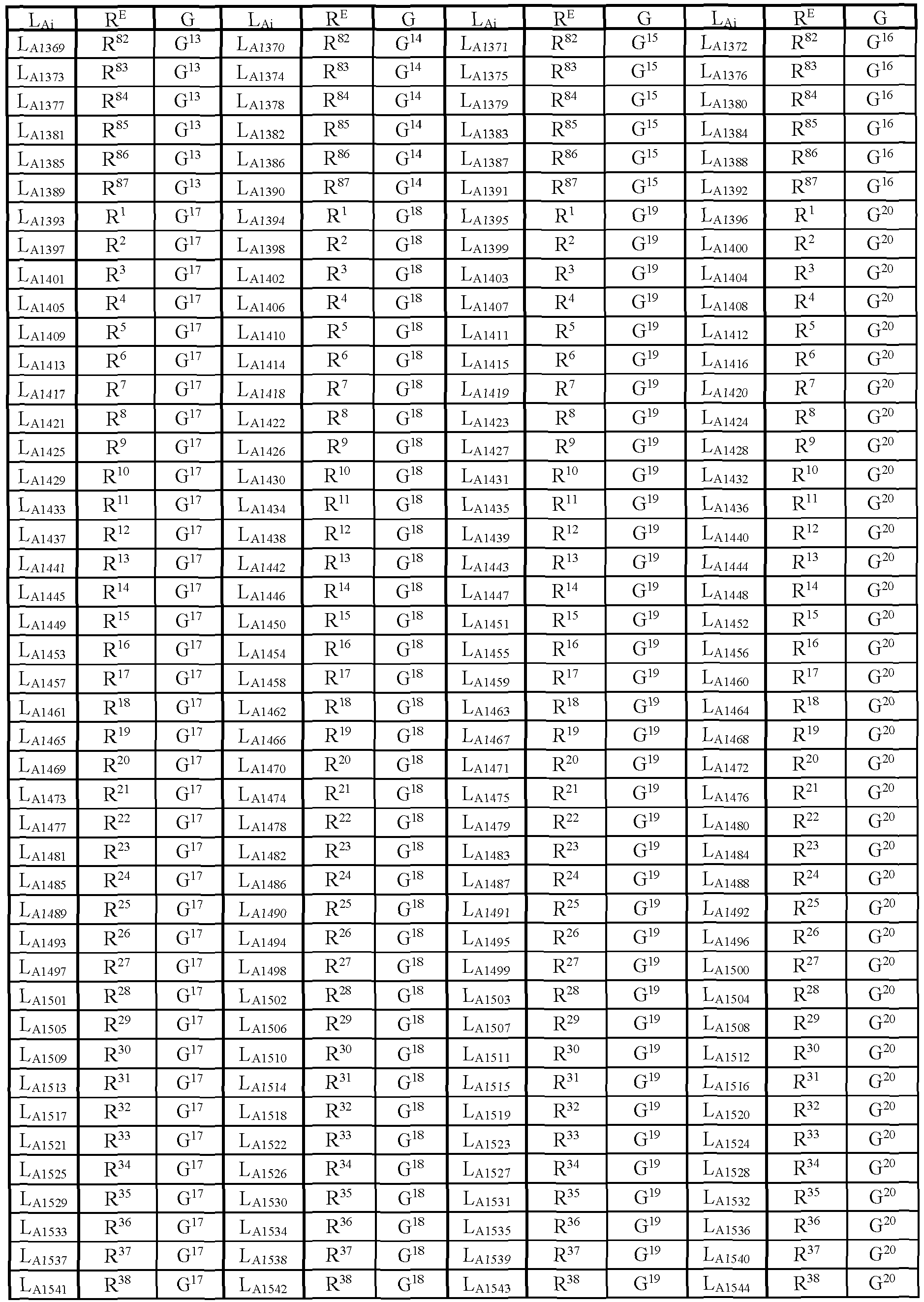 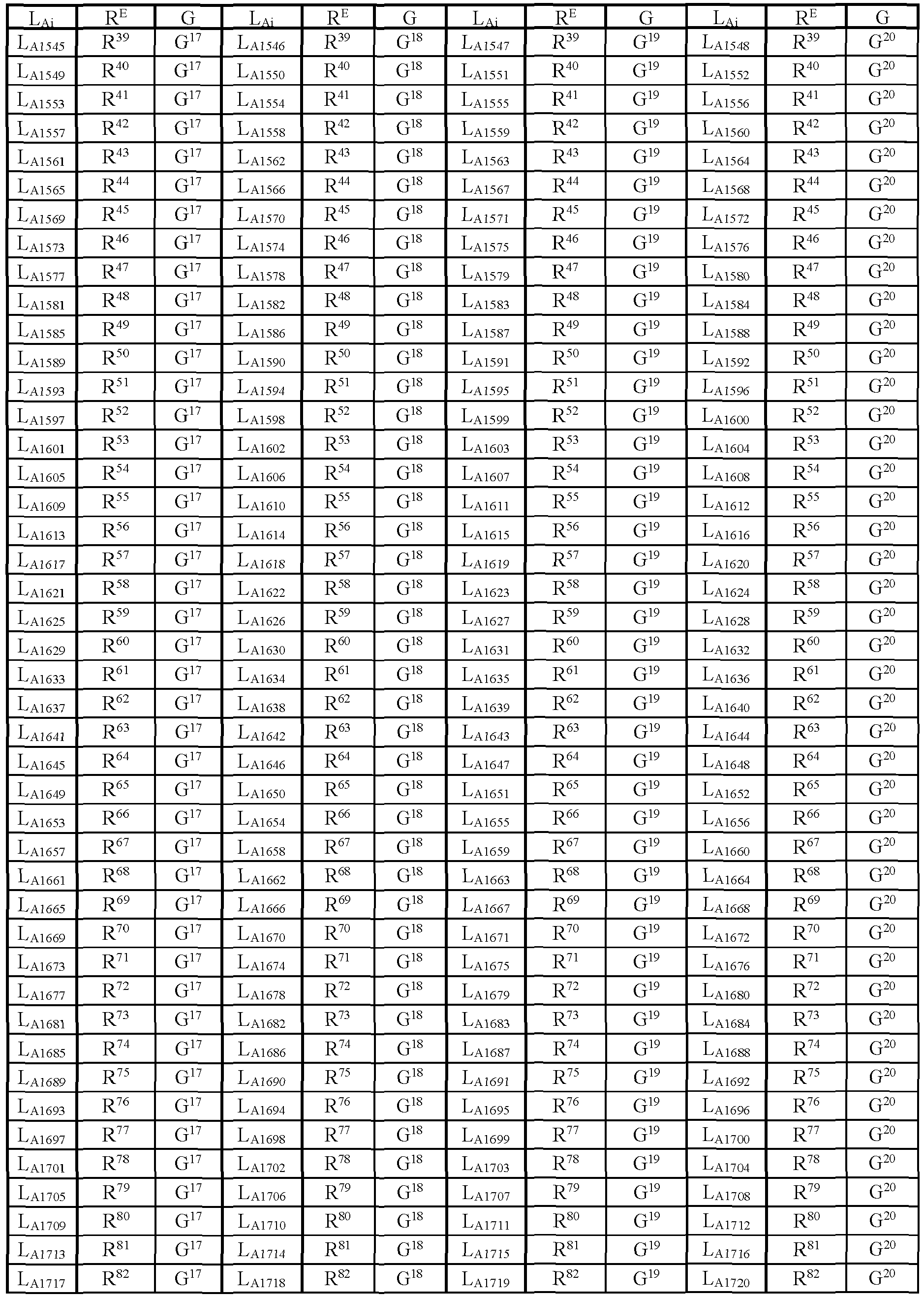 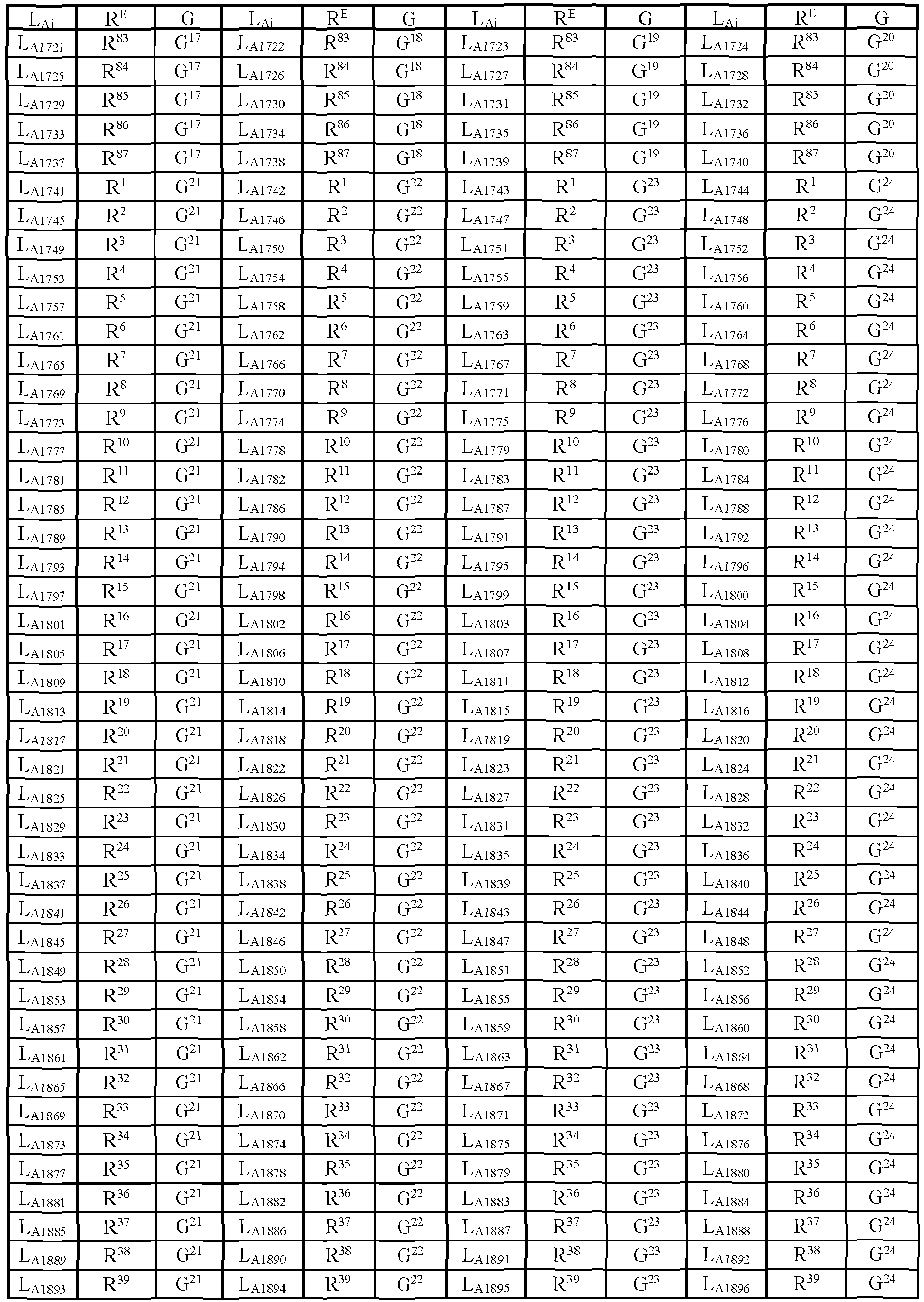 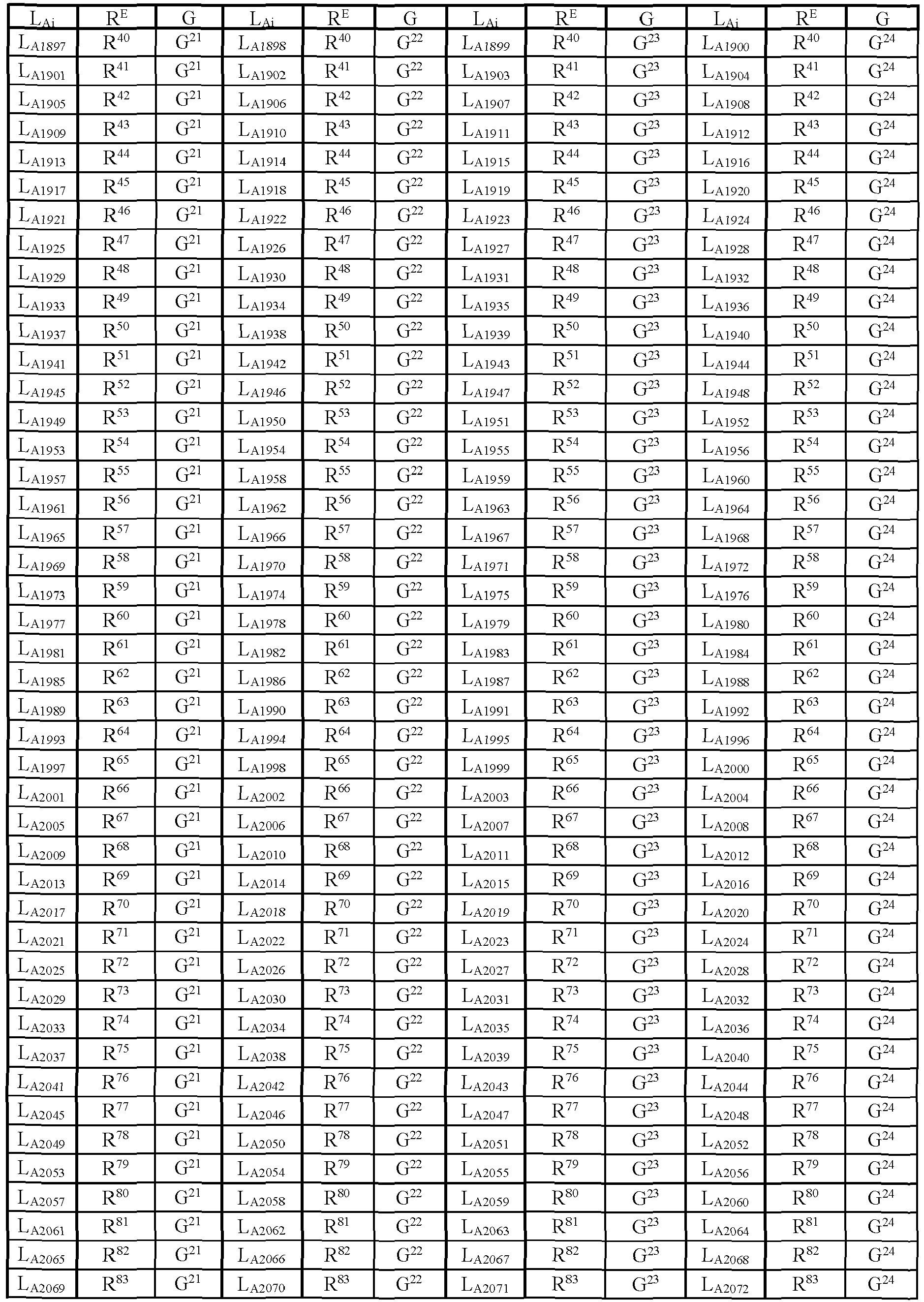 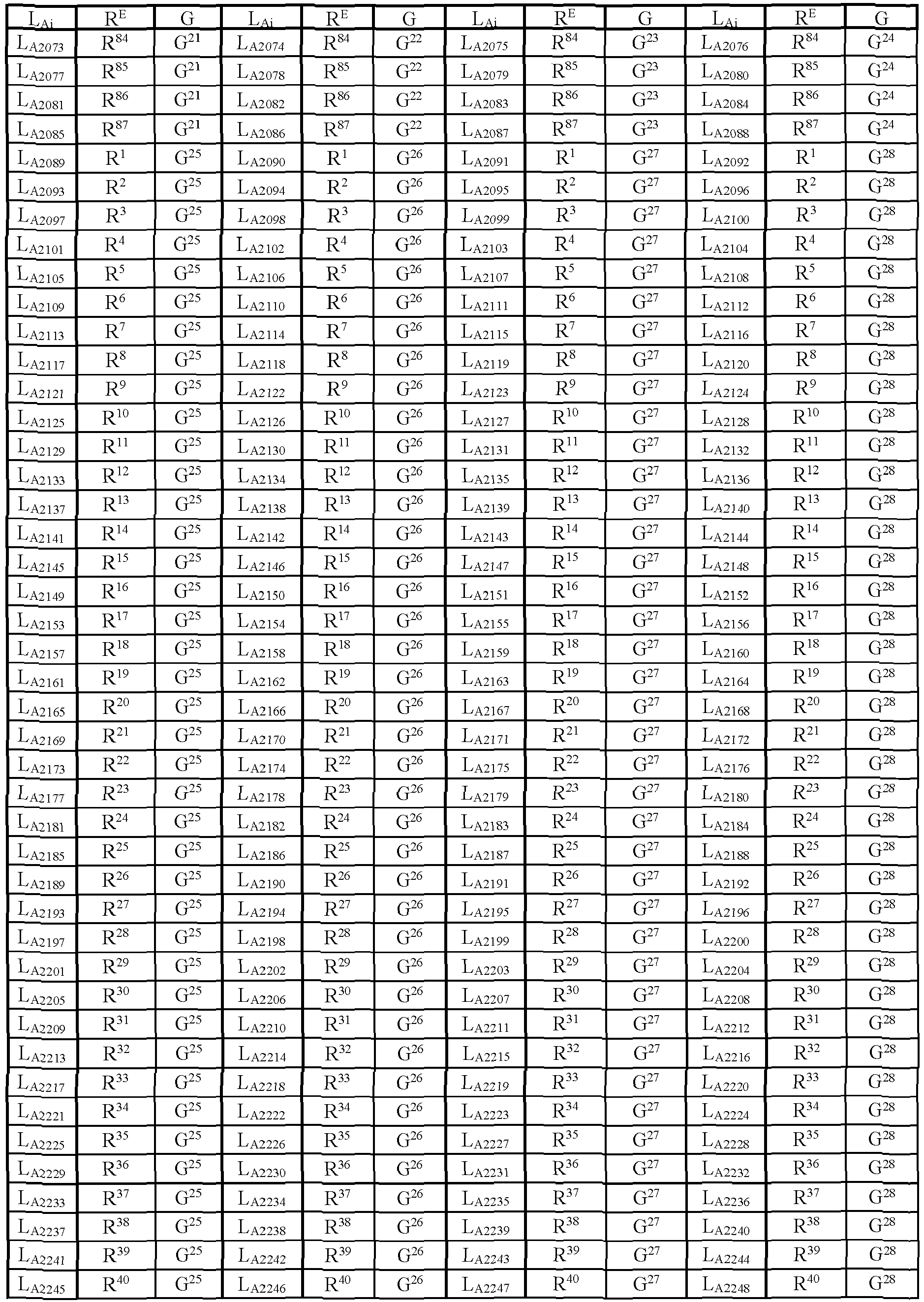 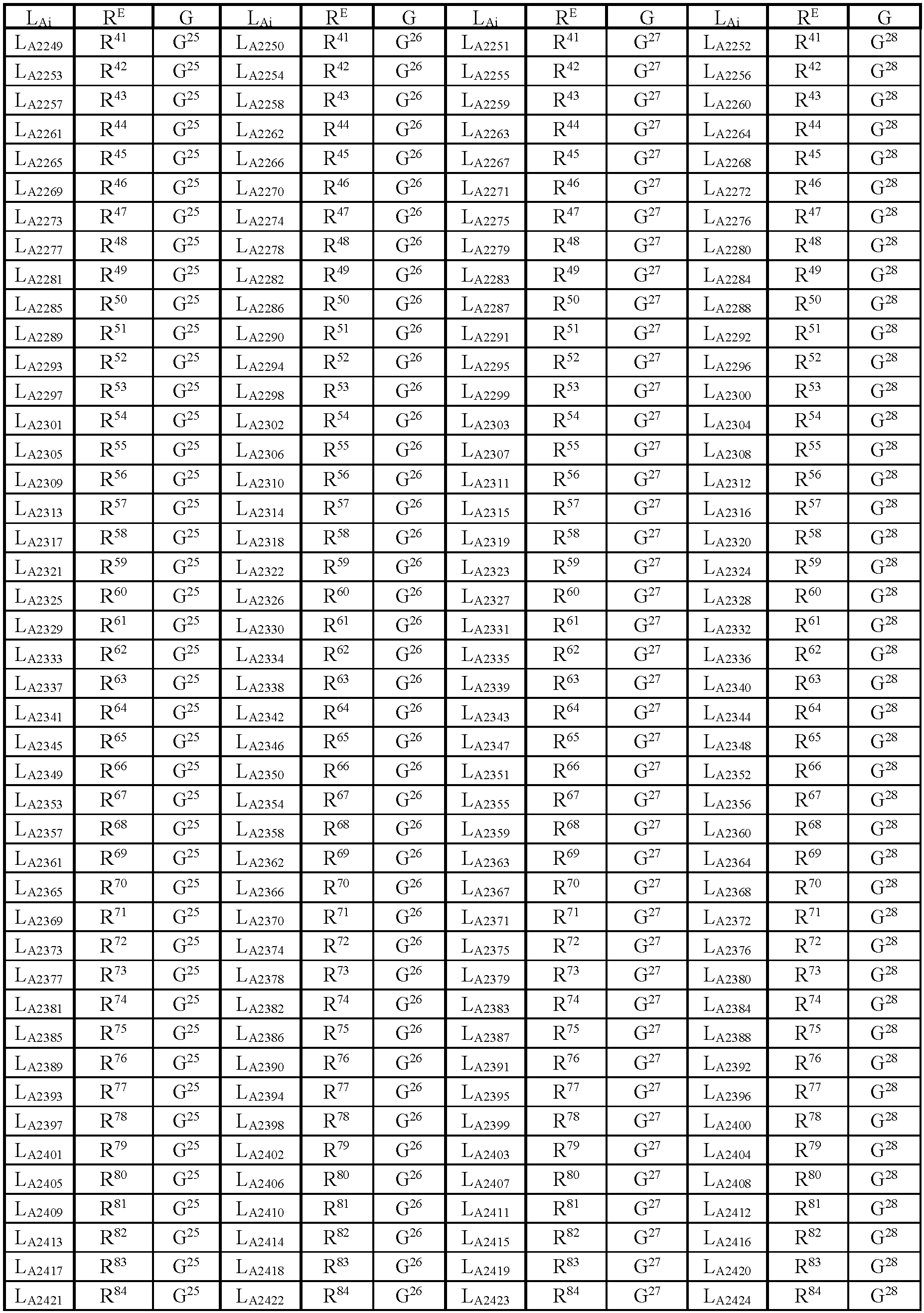 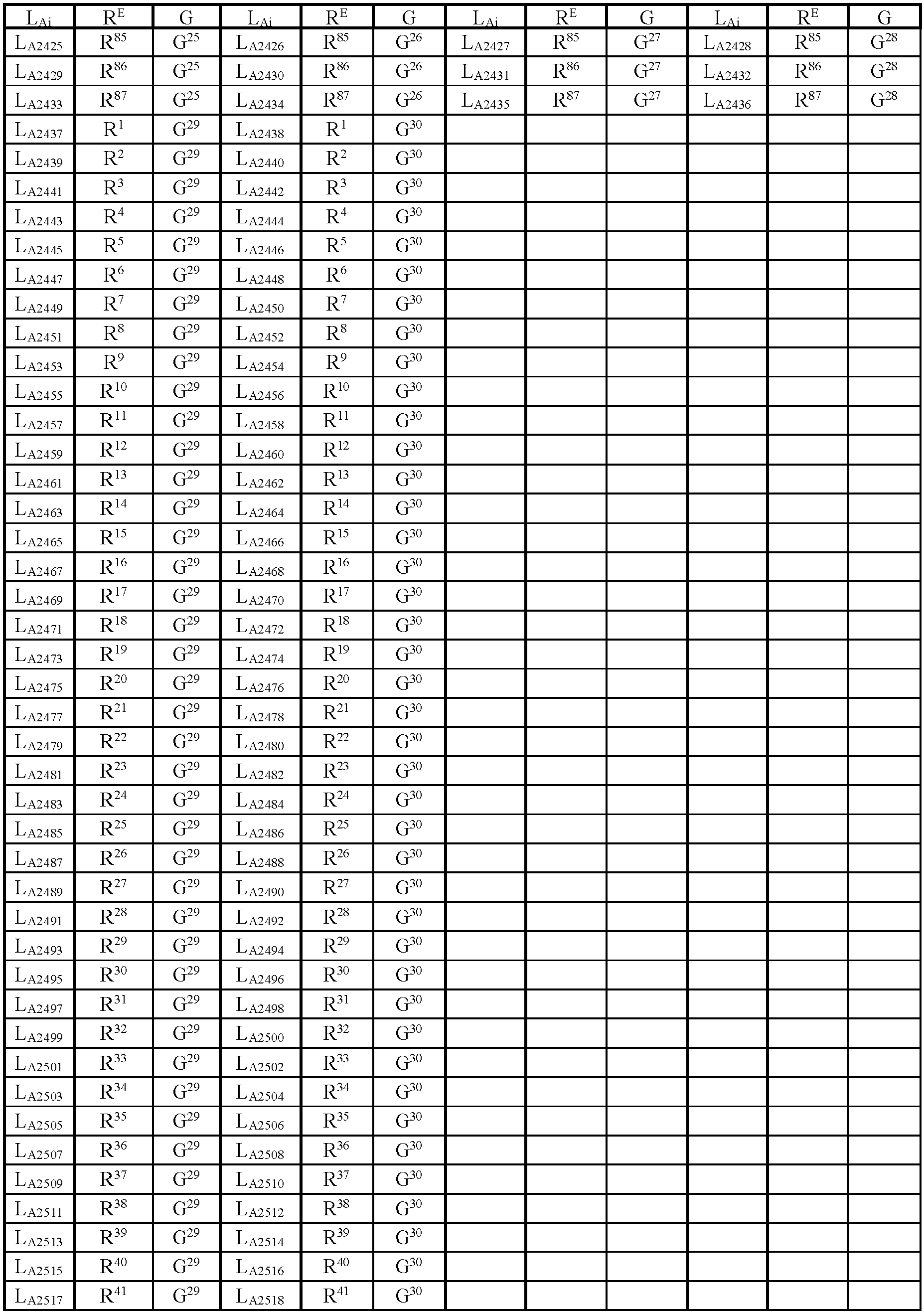 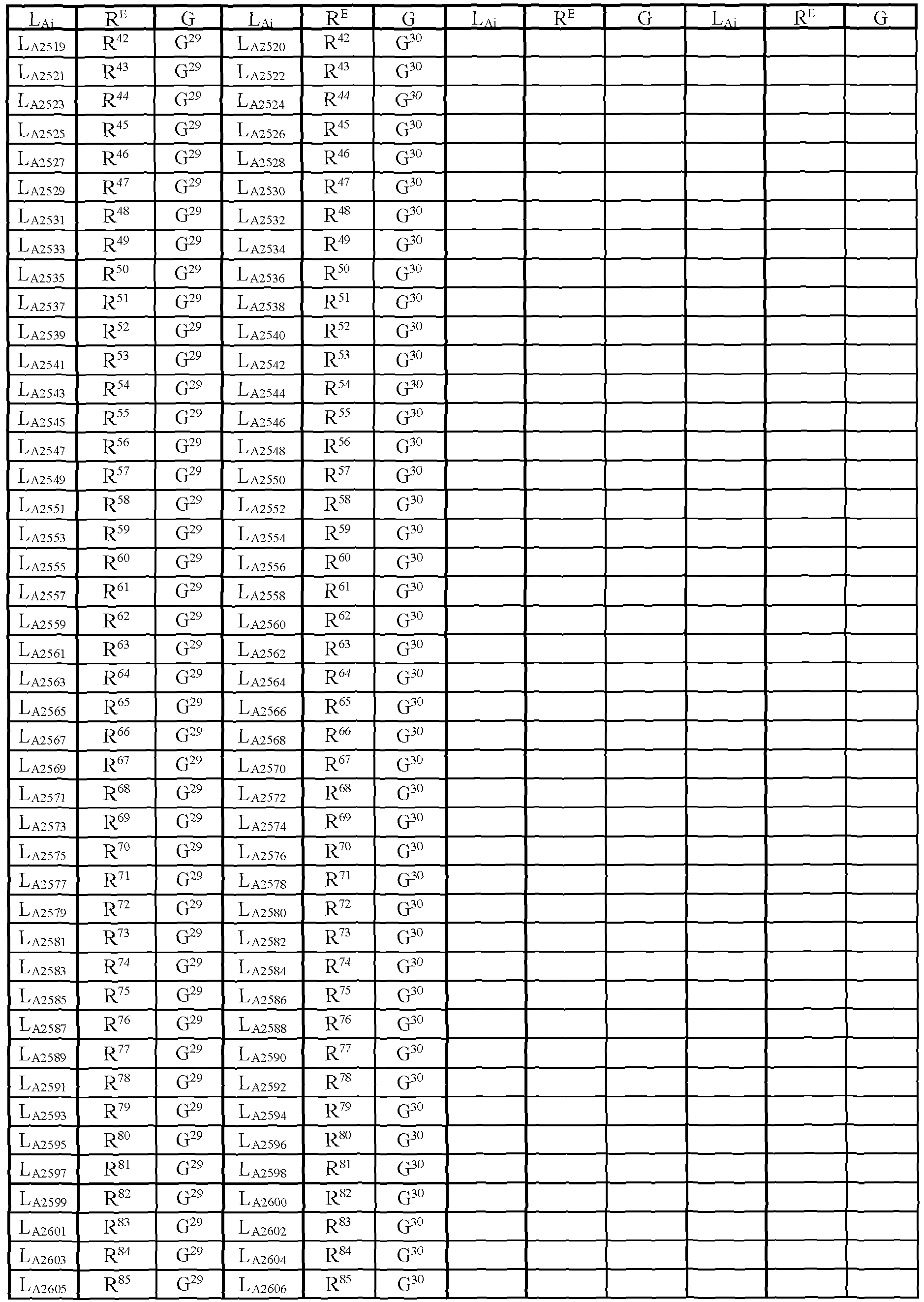 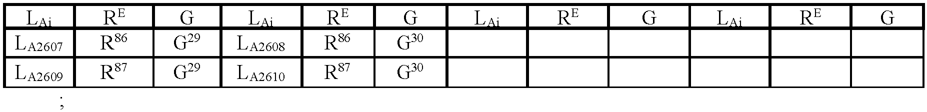 wherein each of R¹ to R⁸⁷ has the structure defined as follows: 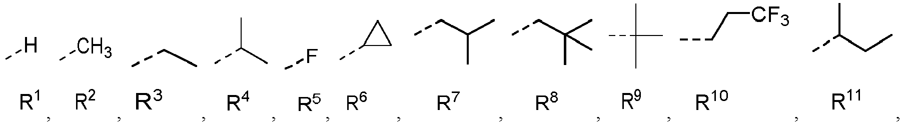 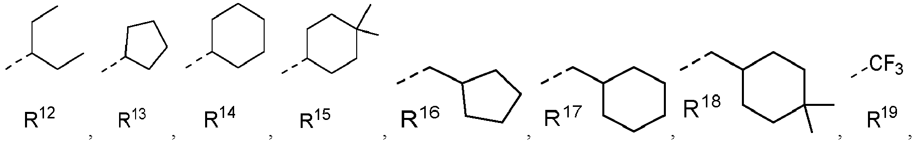 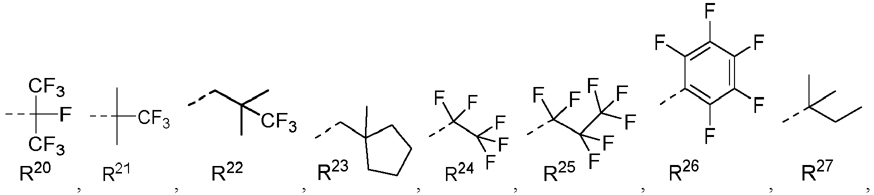 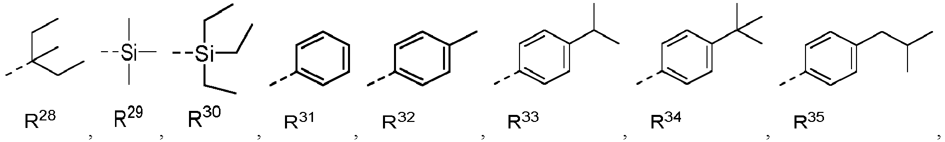 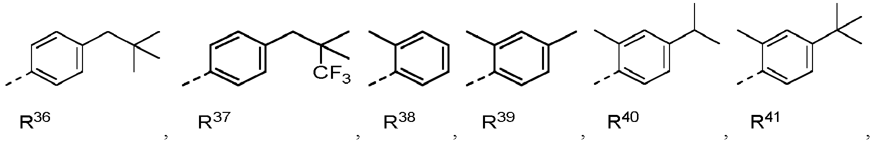 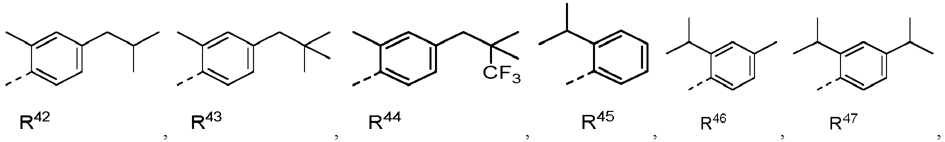 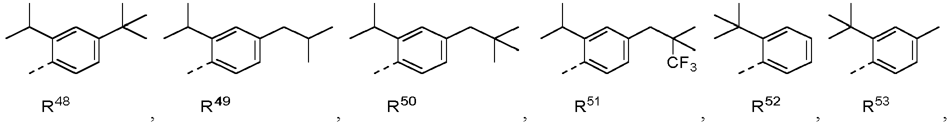 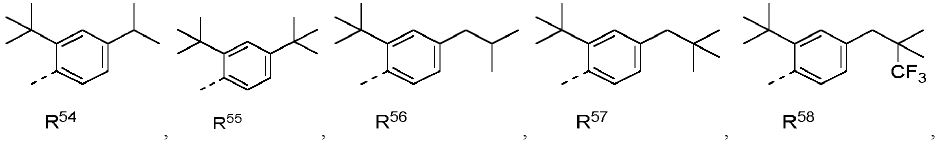 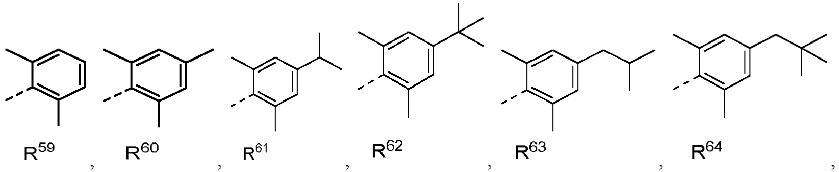 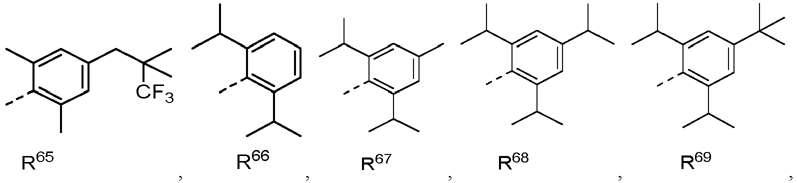 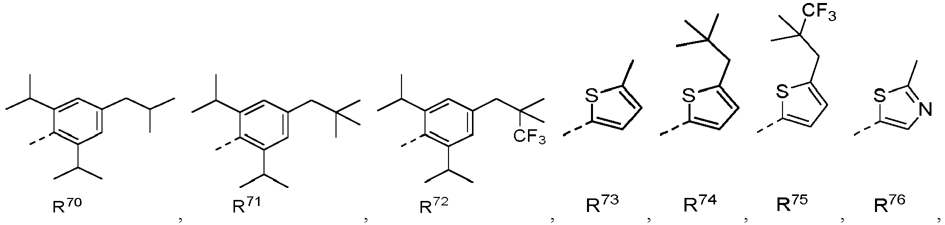 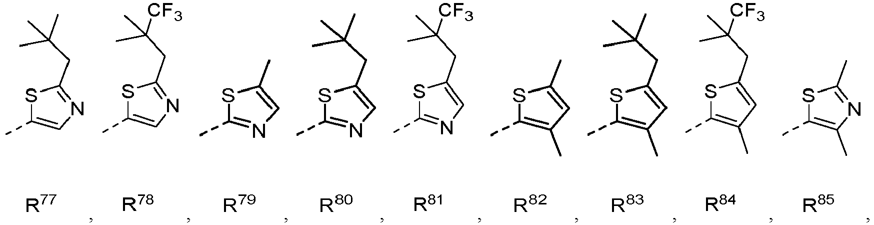 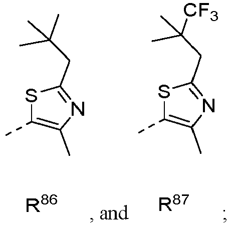 and
wherein each of G¹ to G³⁰ has the structure defined as follows:

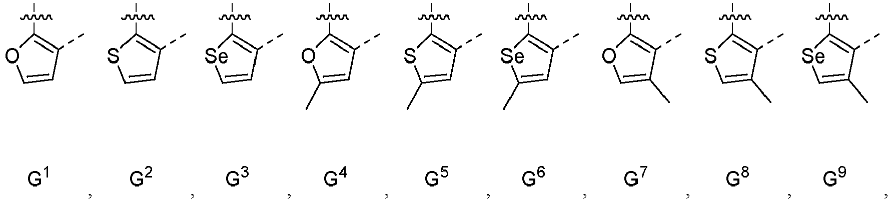

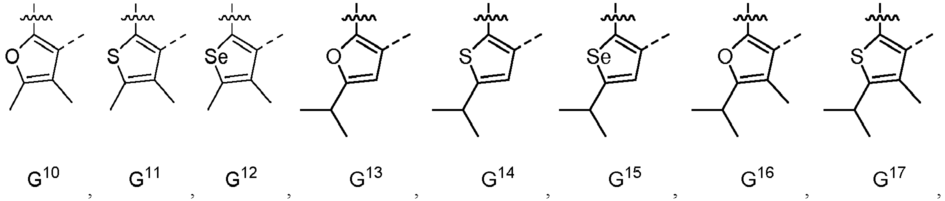

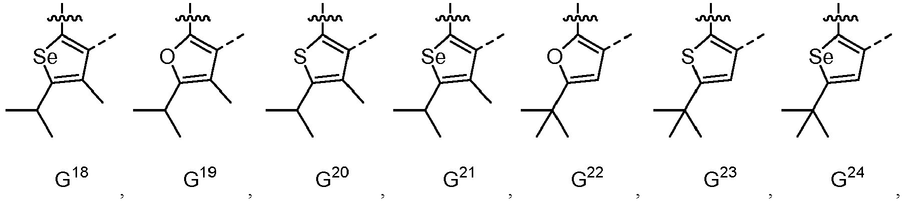

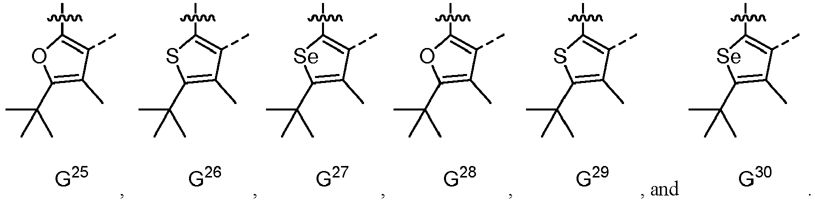

10. The compound of any one of the previous claims, wherein the compound has a formula selected from the group consisting of Ir(L_{A})₃, Ir(L_{A})(L_{B})₂, Ir(L_{A})₂(L_{B}), Ir(L_{A})₂(L_{C}), and Ir(L_{A})(L_{B})(L_{C}); wherein L_{B} and Lc are each a bidentate ligand and L_{A}, L_{B}, and L_{C} are different from each other; or the compound has a formula of Pt(L_{A})(L_{B}) and wherein L_{A} and L_{B} can be same or different.

11. The compound of any one of the previous claims, wherein the compound has a formula of M(L_{A})ₚ(L_{B})_{q}(L_{C})ᵣ wherein L_{B} and L_{C} are each a bidentate ligand; and wherein p is 1, 2, or 3; q is 0, 1, or 2; r is 0, 1, or 2; and p+q+r is the oxidation state of the metal M, wherein L_{B} and Lc are each independently selected from the group consisting of: 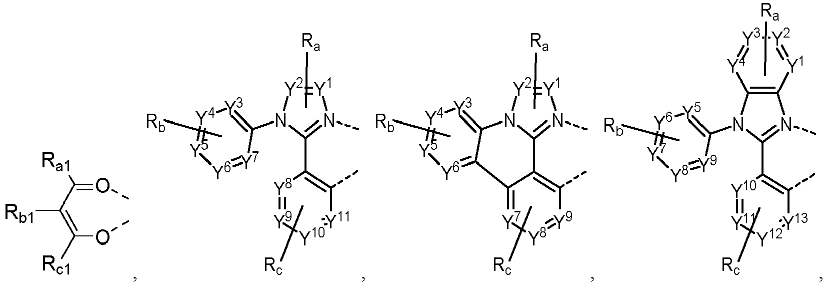 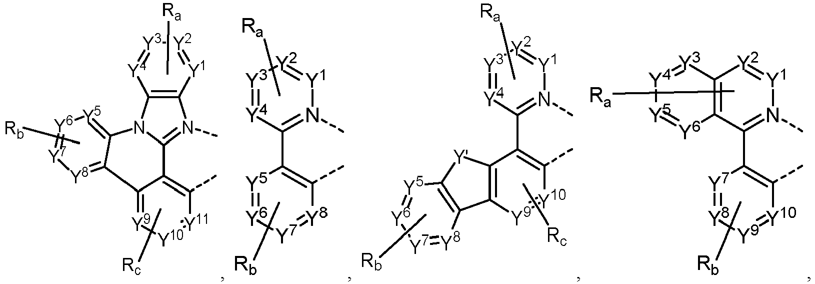 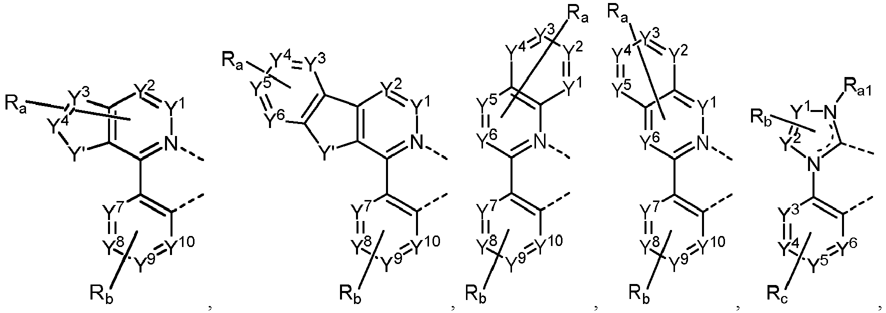 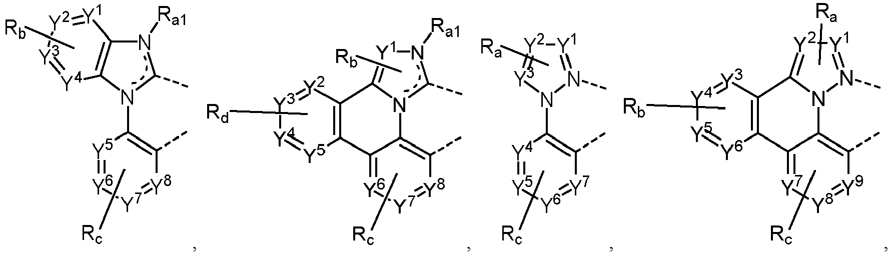 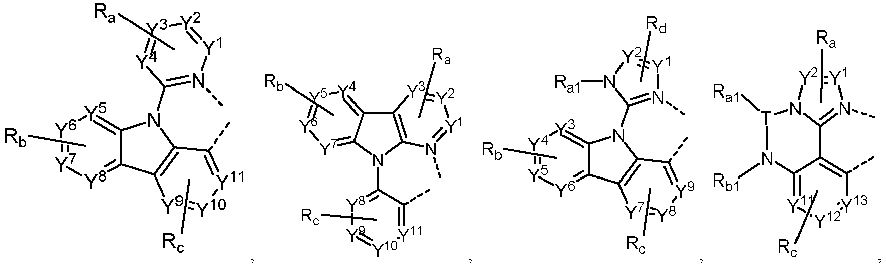 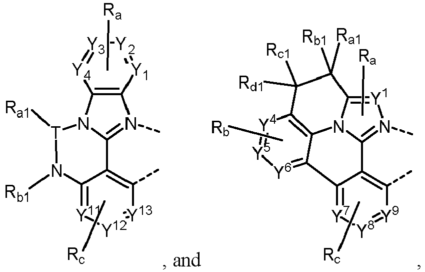 wherein:
T is selected from thr group consisting of B, Al, Ga, and In;
each of Y¹ to Y¹³ is independently selected from the group consisting of carbon and nitrogen;
Y' is selected from the group consisting of BRₑ, NRₑ, PRₑ, O, S, Se, C=O, S=O, SO₂, CRₑR_{f}, SiRₑR_{f}, and GeRₑR_{f};
each Rₐ, R_{b}, R_{c}, and R_{d} independently represent zero, mono, or up to a maximum allowed number of substitutions;
each of Rₐ₁, R_{b1}, R_{c1}, R_{d1}, Rₐ, R_{b}, R_{c}, R_{d}, Rₑ and R_{f} is independently a hydrogen or a substituent selected from the group consisting of the General Substituents defined herein; and
any two adj acent Rₐ, R_{b}, R_{c}, R_{d}, Rₑ and R_{f} can be fused or joined to form a ring or form a multidentate ligand.

12. The compound of claim 9, wherein when the compound has formula Ir(L_{A*i-m-X*})₃, *i* is an integer from 1 to 2610; *m* is an integer from 1 to 108; and the compound is selected from the group consisting of Ir(L_{A*1-1-1*})₃ to Ir(L_{A*2610-108-3*})₃;
when the compound has formula Ir(L_{A*i-m-X*})(L_{B*k*})₂, *i* is an integer from 1 to 2610; *m* is an integer from 1 to 108; *k* is an integer from 1 to 324; and the compound is selected from the group consisting of Ir(L_{A*1-1-1*})(L_{B*1*})₂ to Ir(L_{A*2610-108-3*})(L*_{B324}*)₂;
when the compound has formula Ir(L_{A*i-m*-*X*})₂(L_{B*k*}), *i* is an integer from 1 to 2610; *m* is an integer from 1 to 108; *k* is an integer from 1 to 324; and the compound is selected from the group consisting of Ir(L_{A*1-1-1*})₂(L_{B*1*}) to Ir(L_{A*2610-108-3*})₂(L_{B*324*});
when the compound has formula Ir(L_{A*i-m-X*})₂(L_{C*j-*I}), *i* is an integer from 1 to 2610; *m* is an integer from 1 to 108; *j* is an integer from 1 to 1416; and the compound is selected from the group consisting of Ir(L_{A1-1-1})₂(L_{C*1*-I}) to Ir(L_{A*2610-108-3*})(L_{C*1416*-I}); and
when the compound has formula Ir(L_{A*i*-*m*-*X*})₂(L_{C*j*-II}), *i* is an integer from 1 to 2610; *m* is an integer from 1 to 108; *j* is an integer from 1 to 1416; and the compound is selected from the group consisting of Ir(L_{A*1*-*1*-*1*})₂(L_{C*1-*II}) to Ir(L_{A*2610-108-3*})(L_{C*1416-*II});
wherein each L_{B}*ₖ* from L_{B1} to L_{B324} has the structure defined as follows: 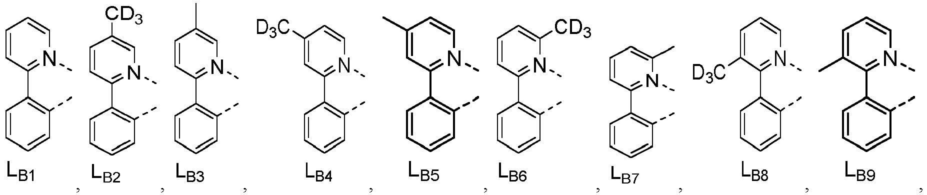 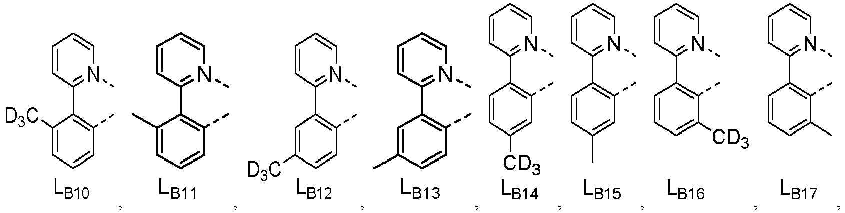 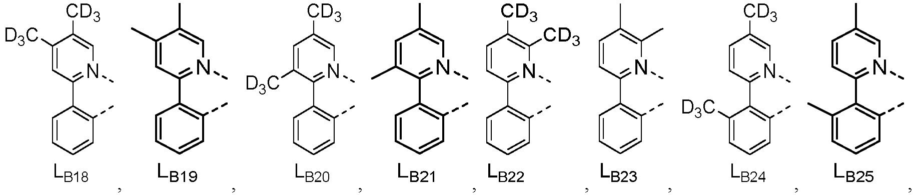 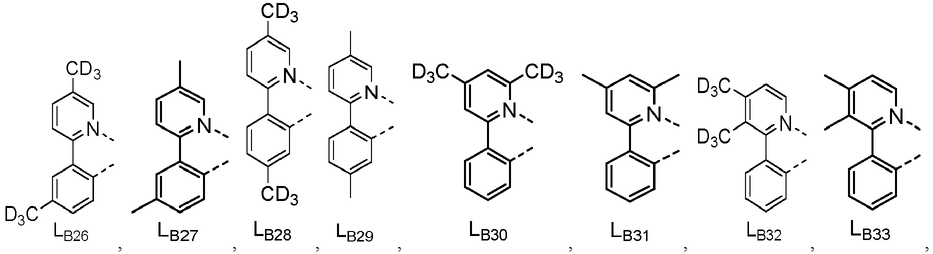 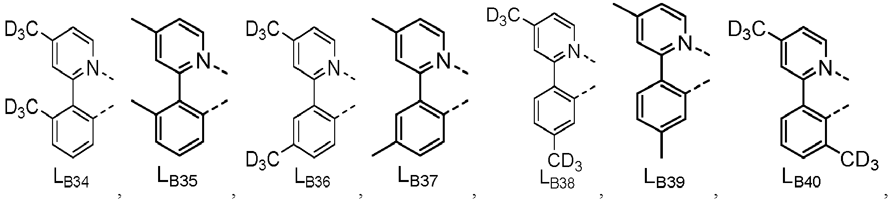 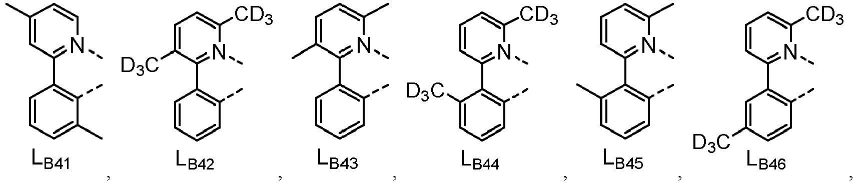 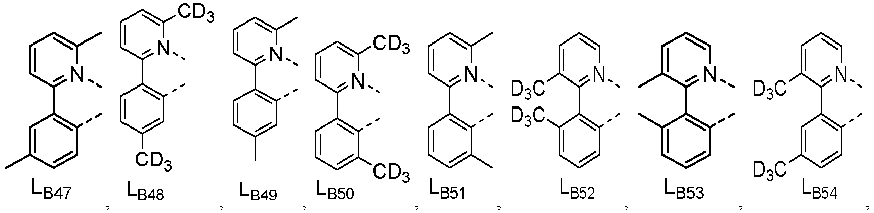 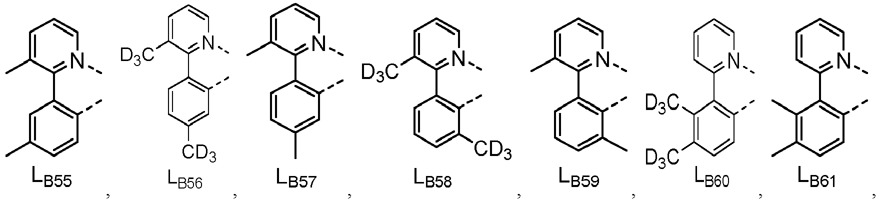 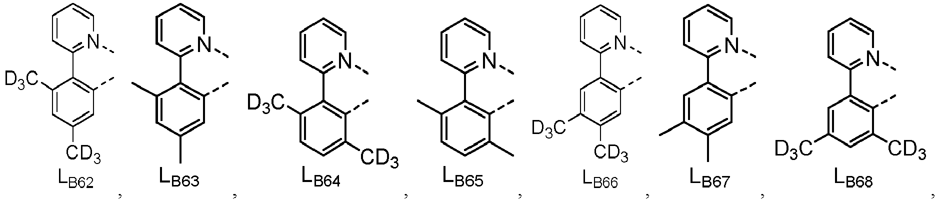 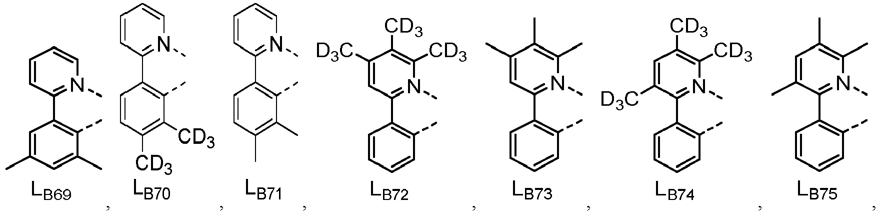 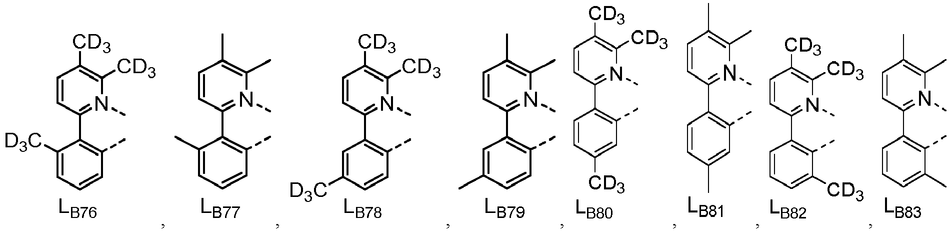 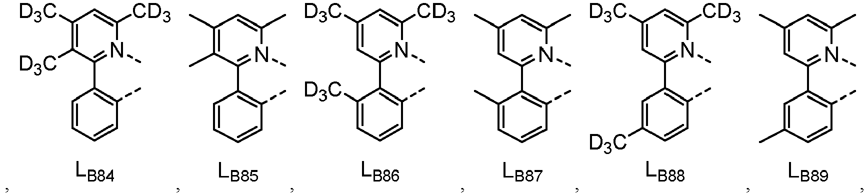 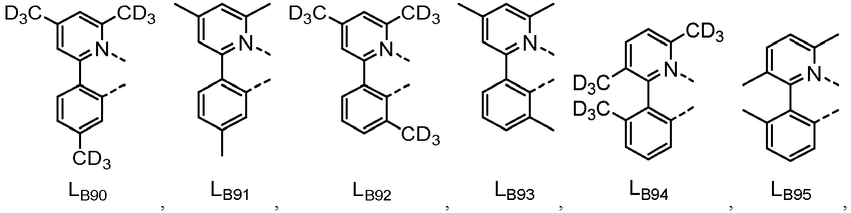 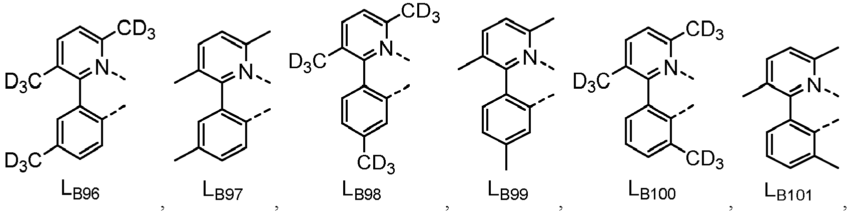 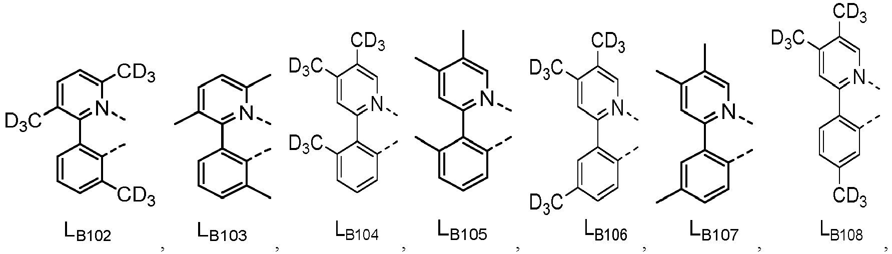 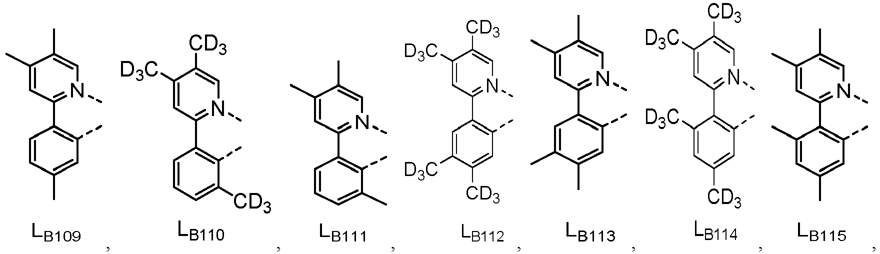 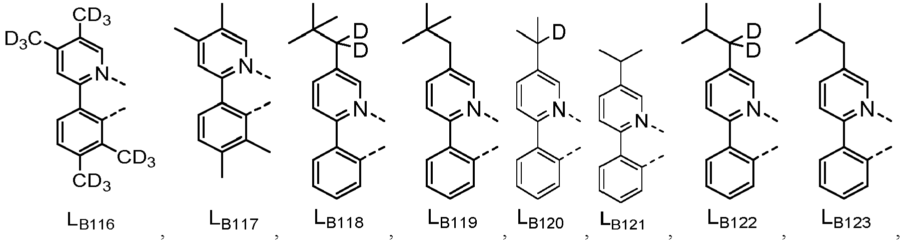 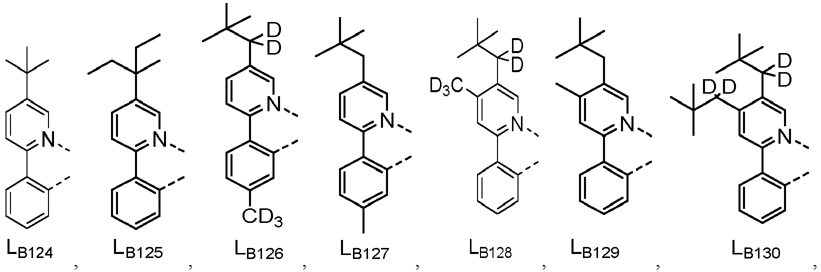 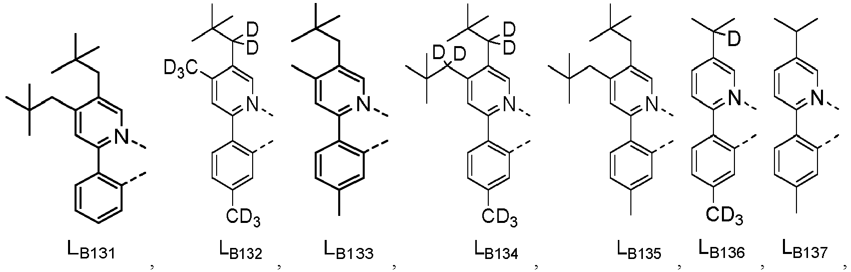 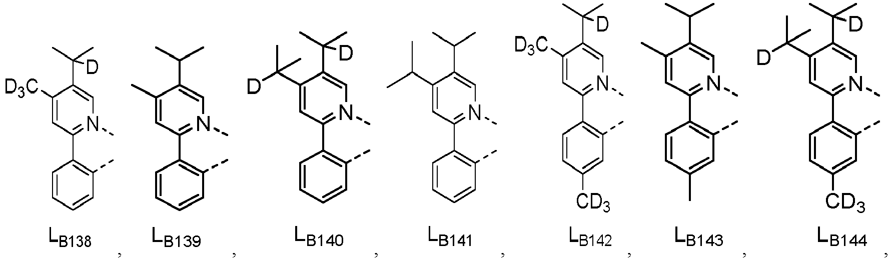 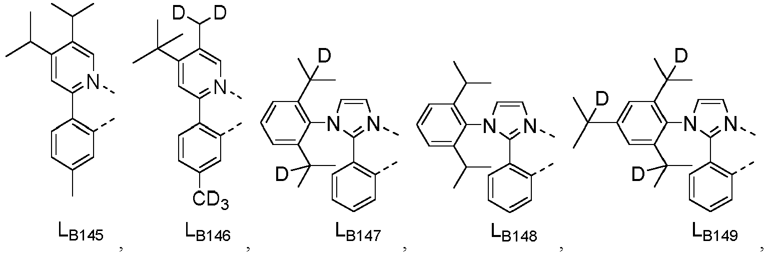 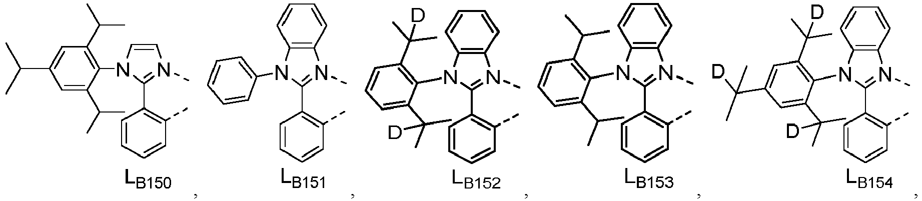 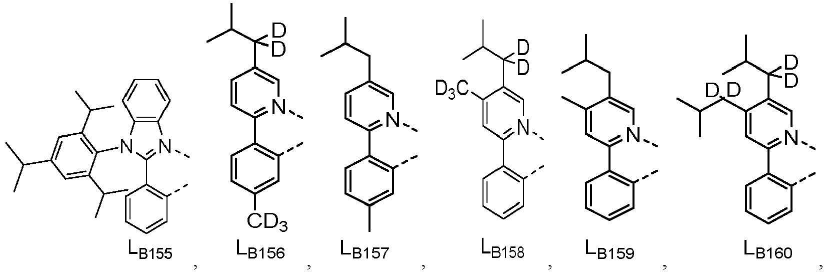 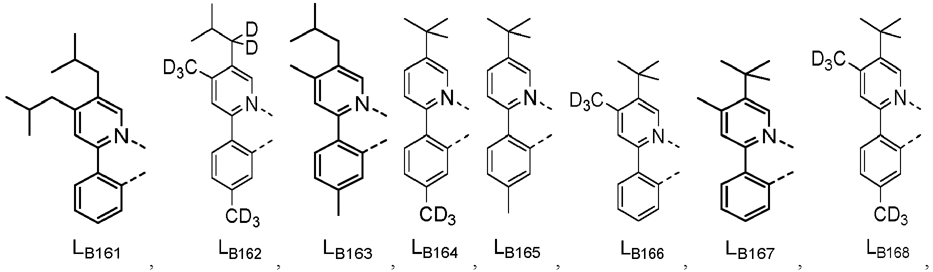 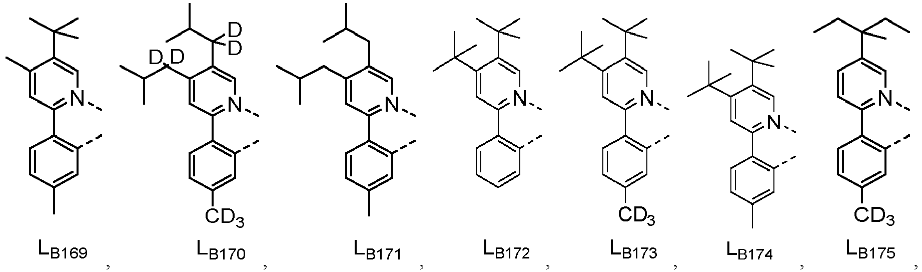 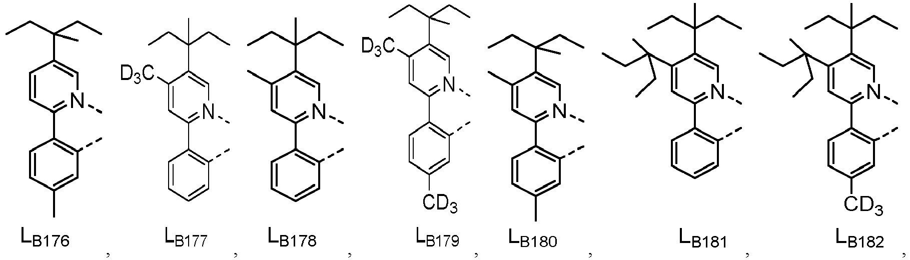 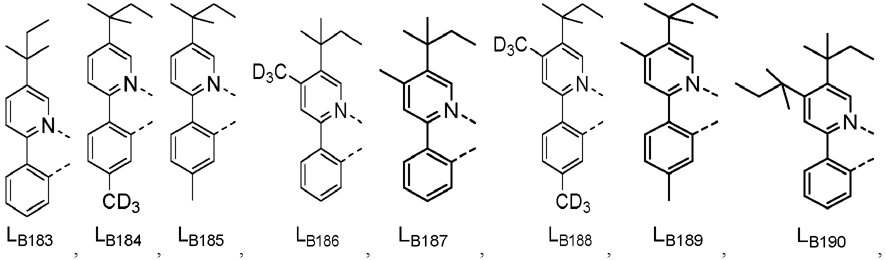 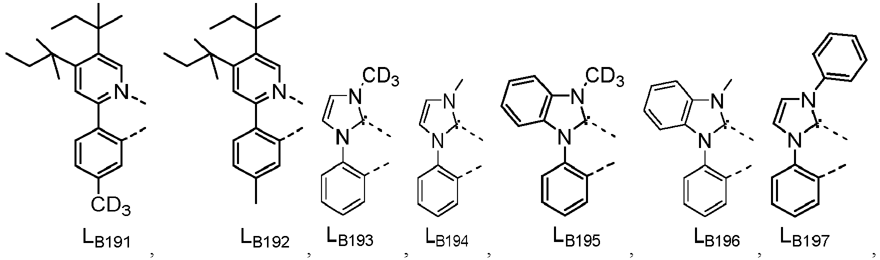 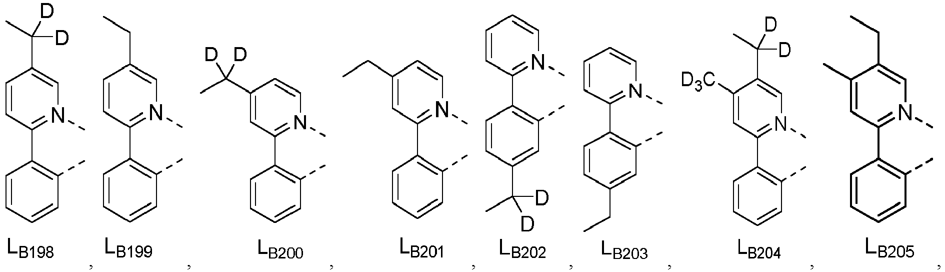 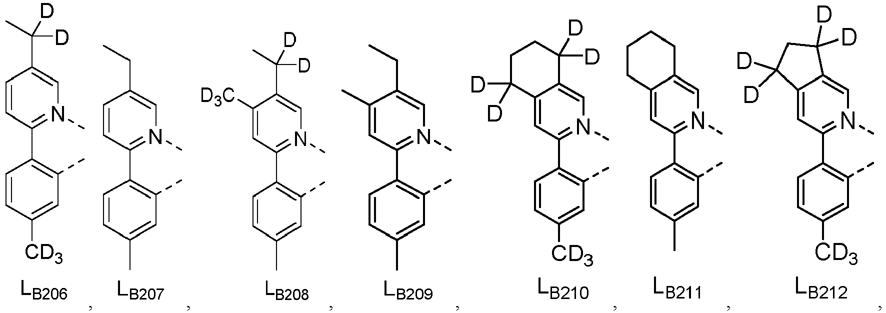 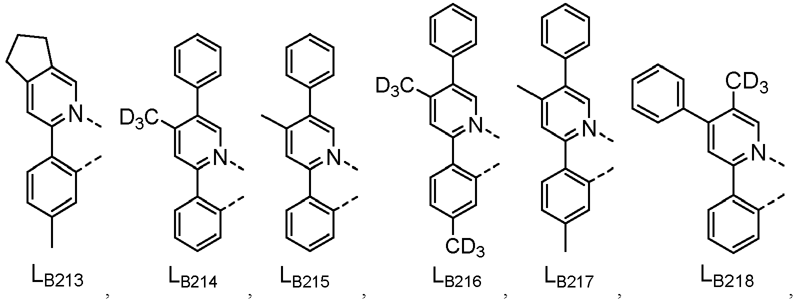 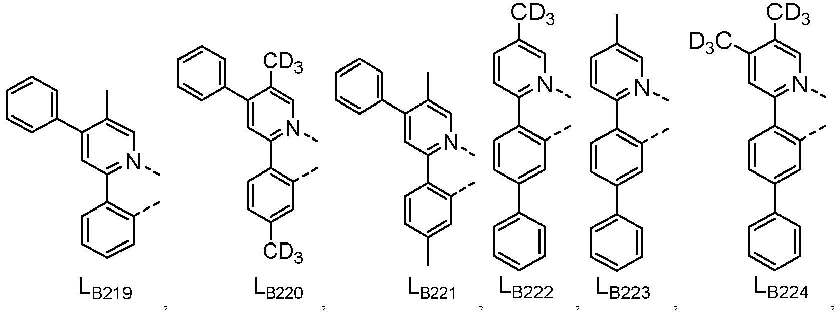 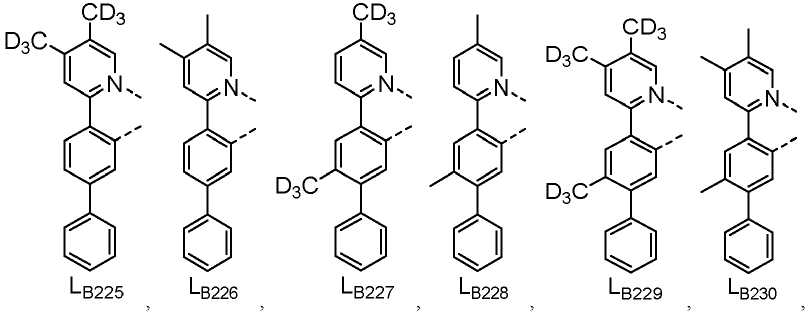 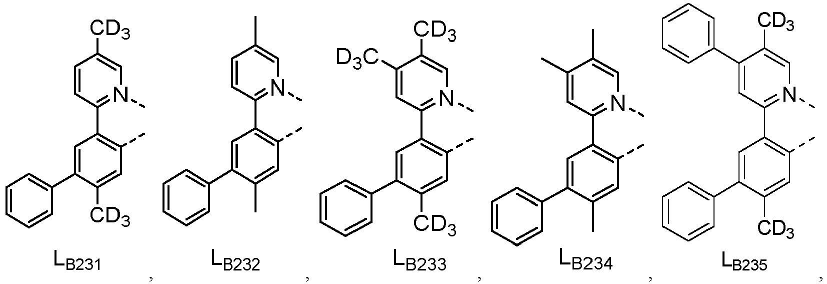 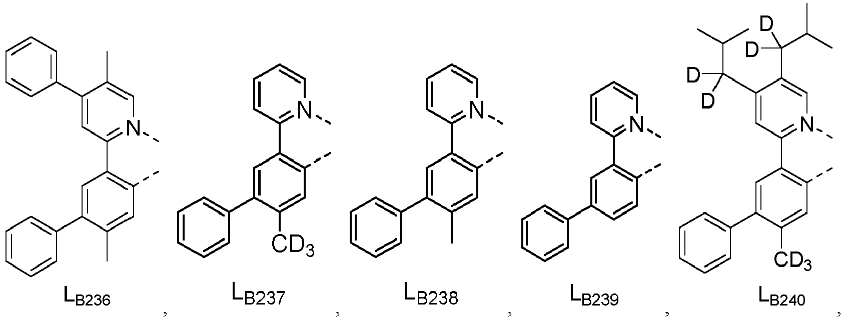 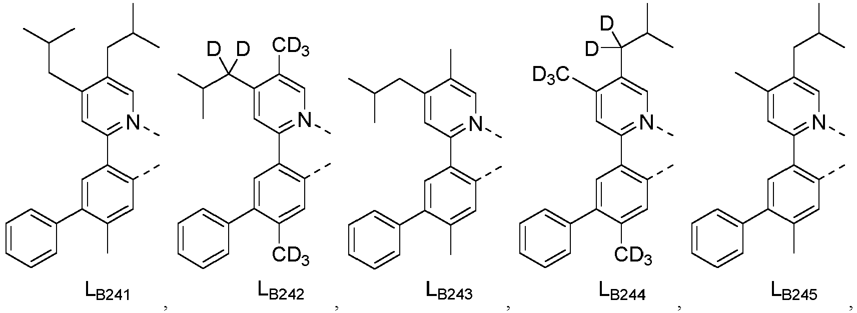 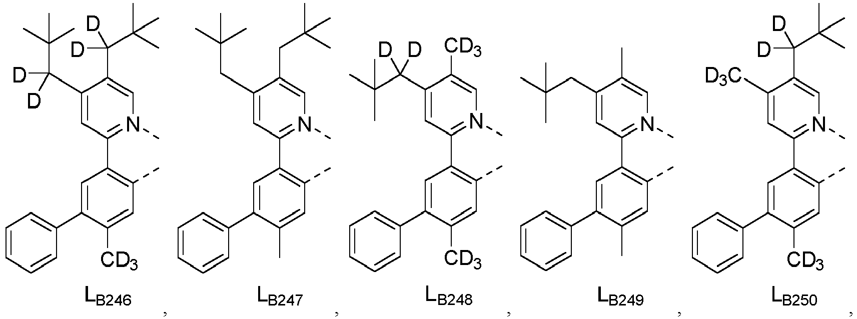 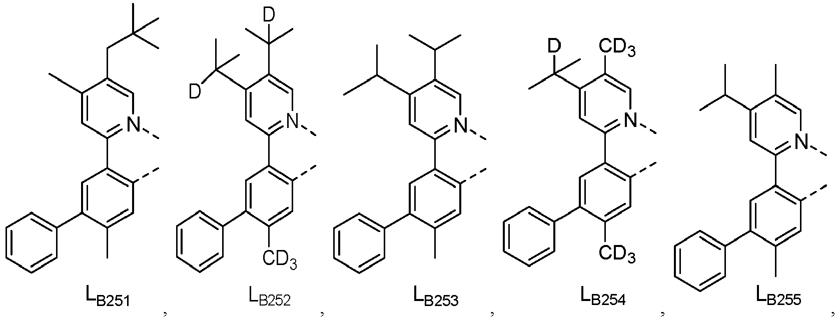 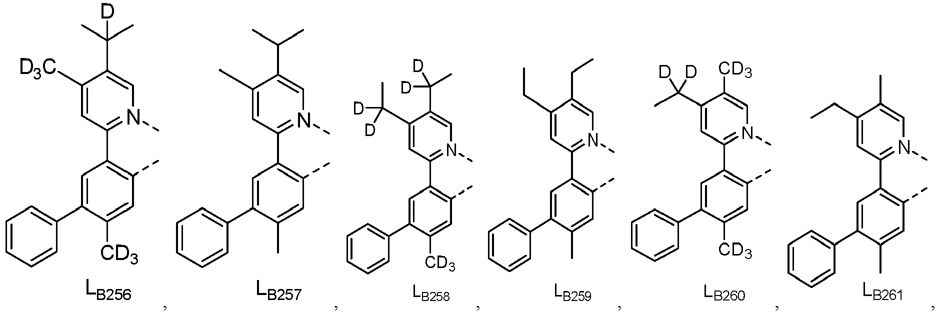 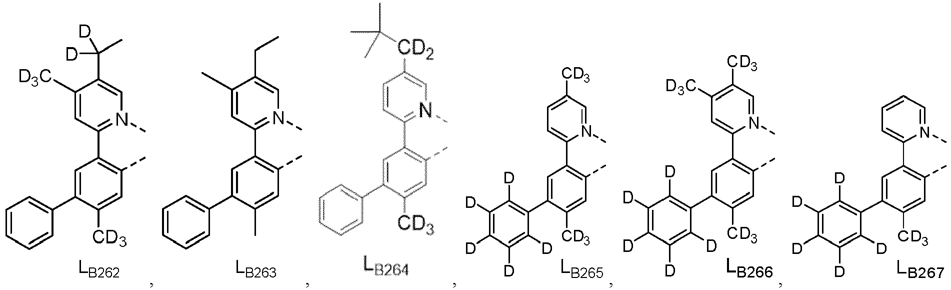 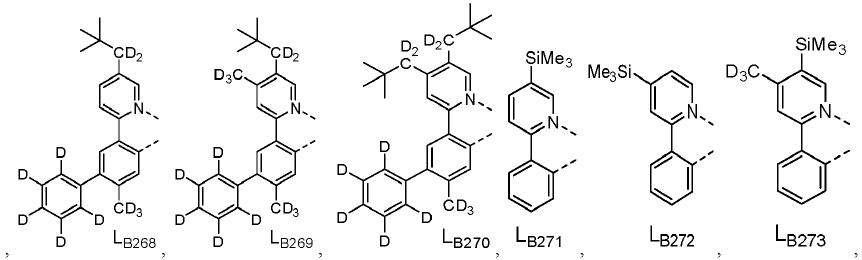 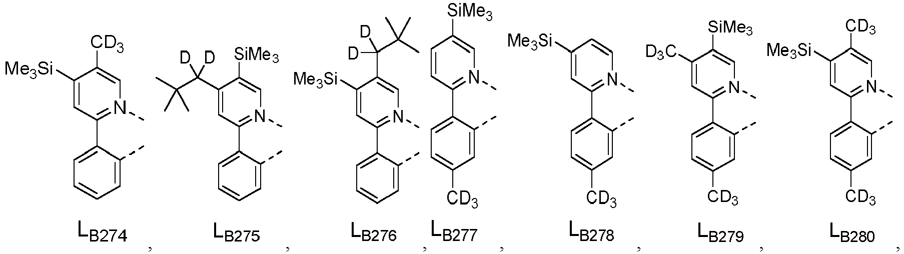 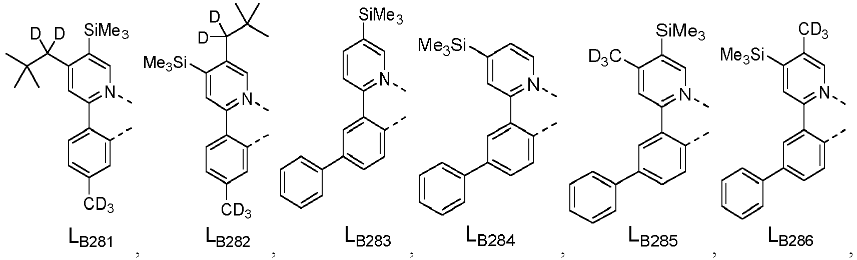 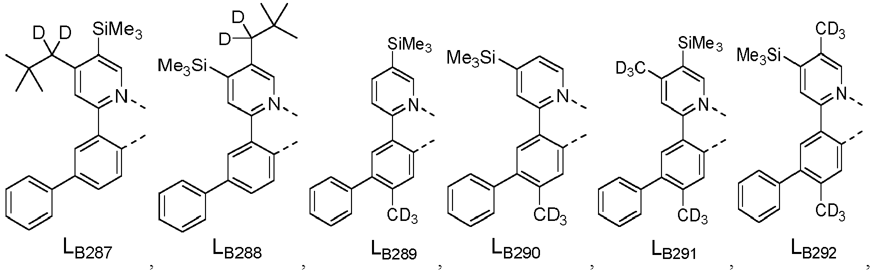 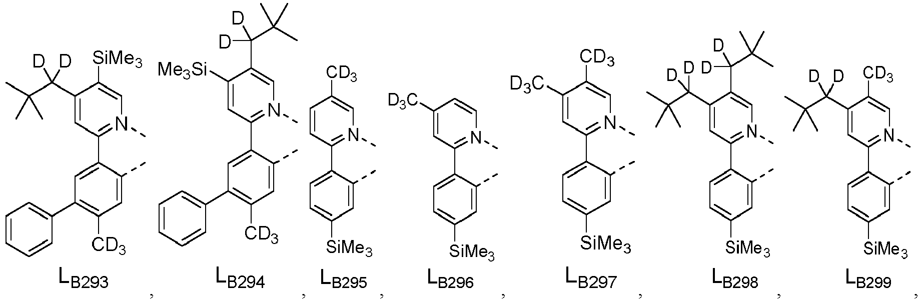 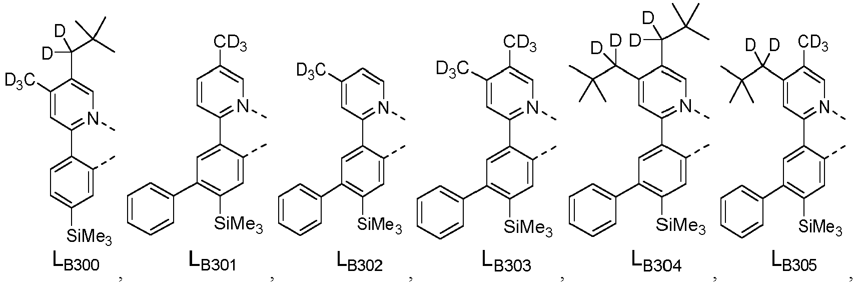 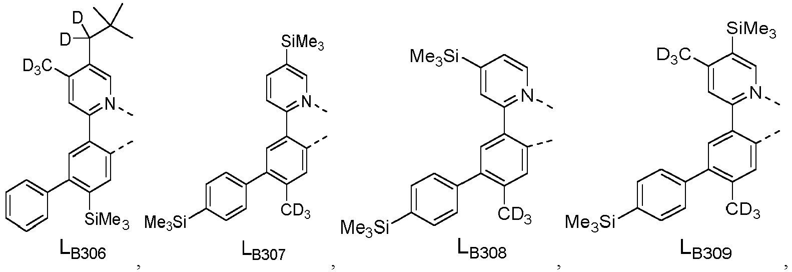 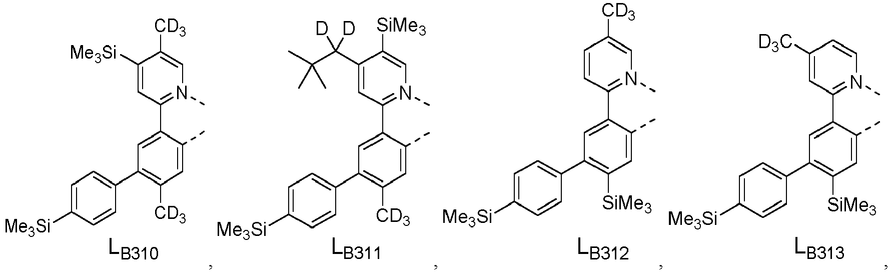 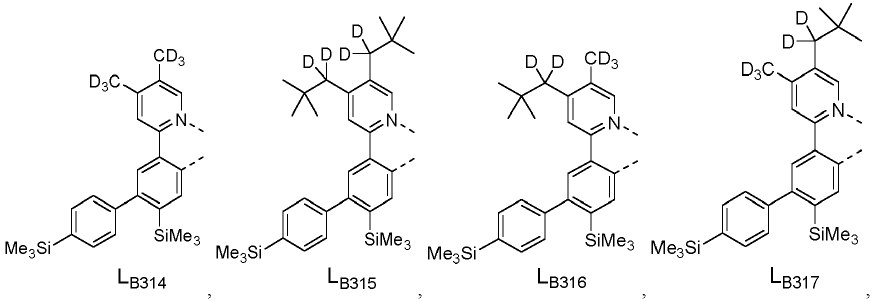 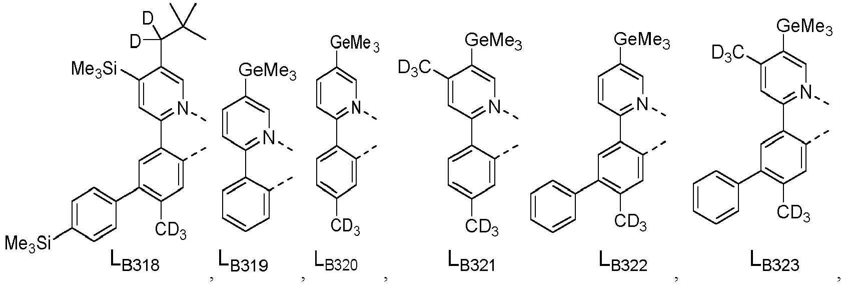 and 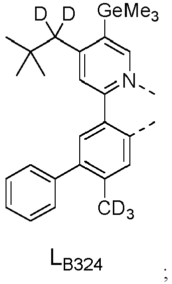
wherein each L_{C*j*-I} has a structure based on formula 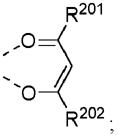 and each L_{C*j*-II} has a structure based on formula 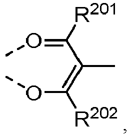 wherein for each L_{C*j*} in L_{C*j*-I} and L_{C*j*-II}, R²⁰¹ and R²⁰² are each independently defined as follows: 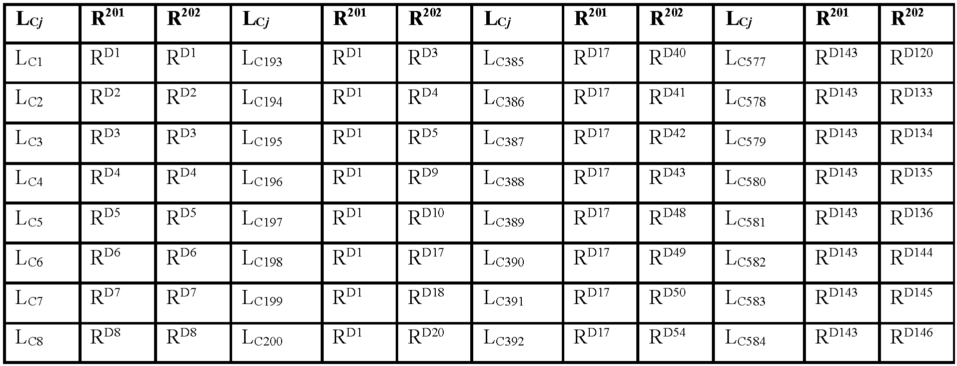 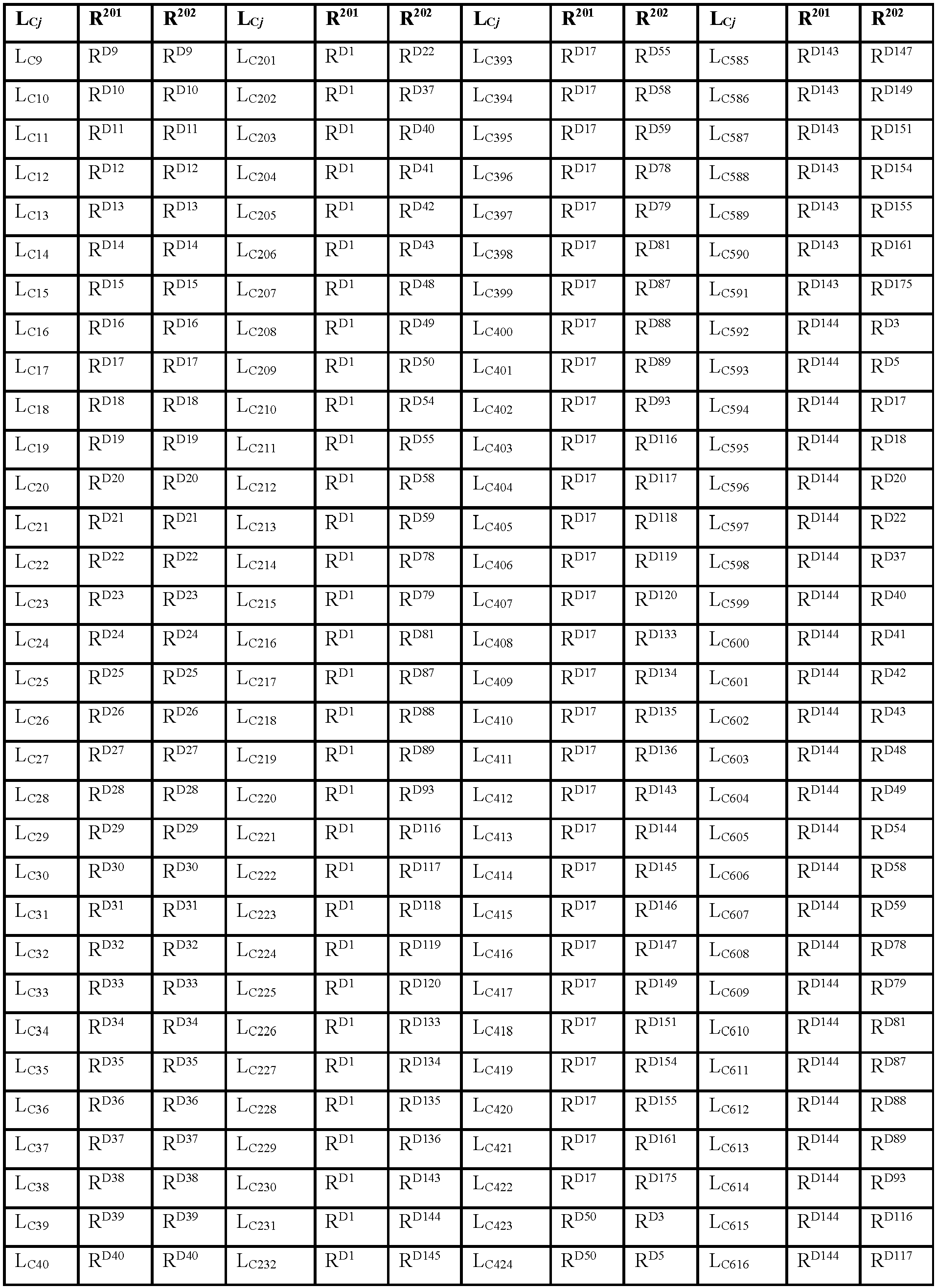 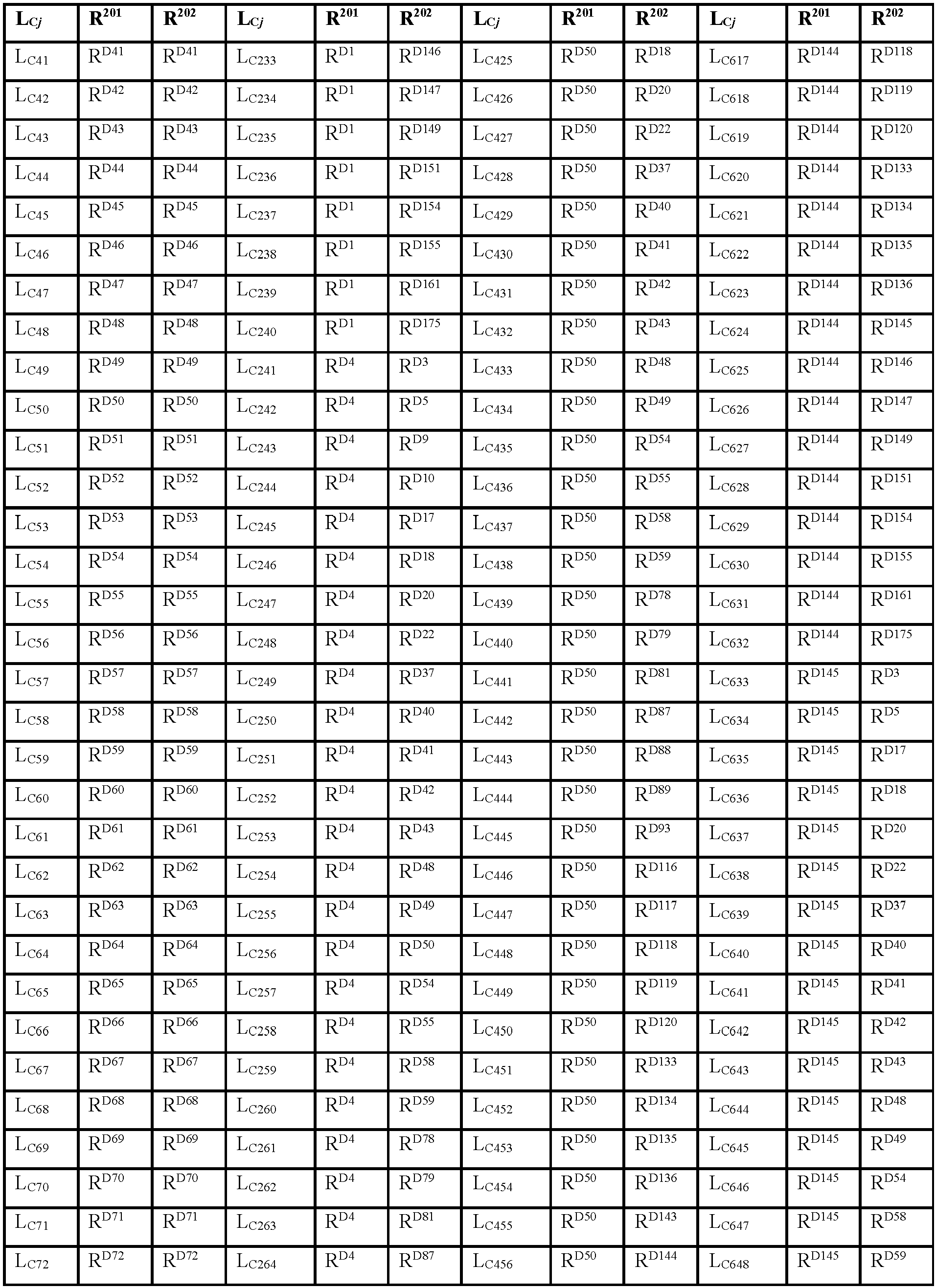 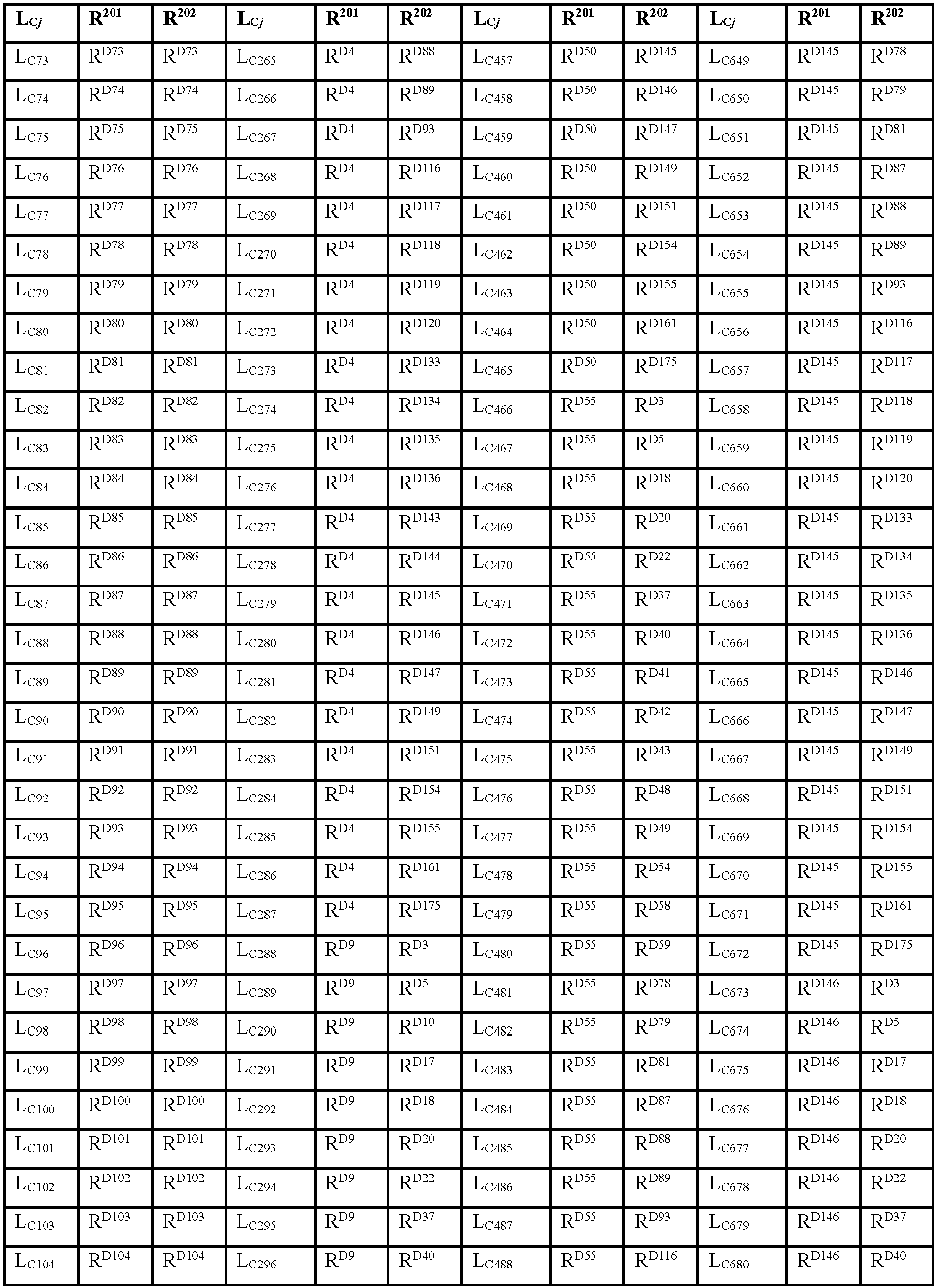 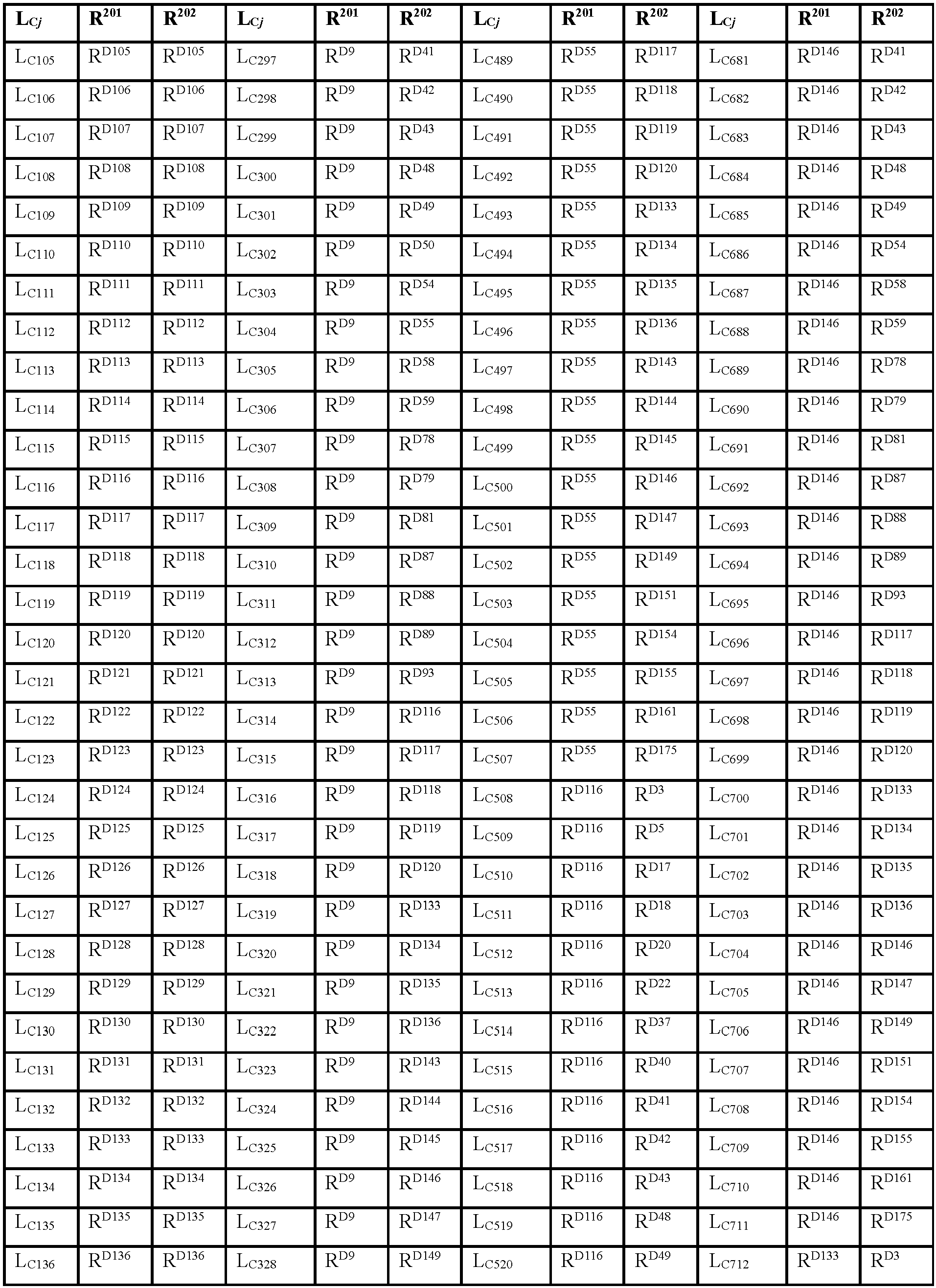 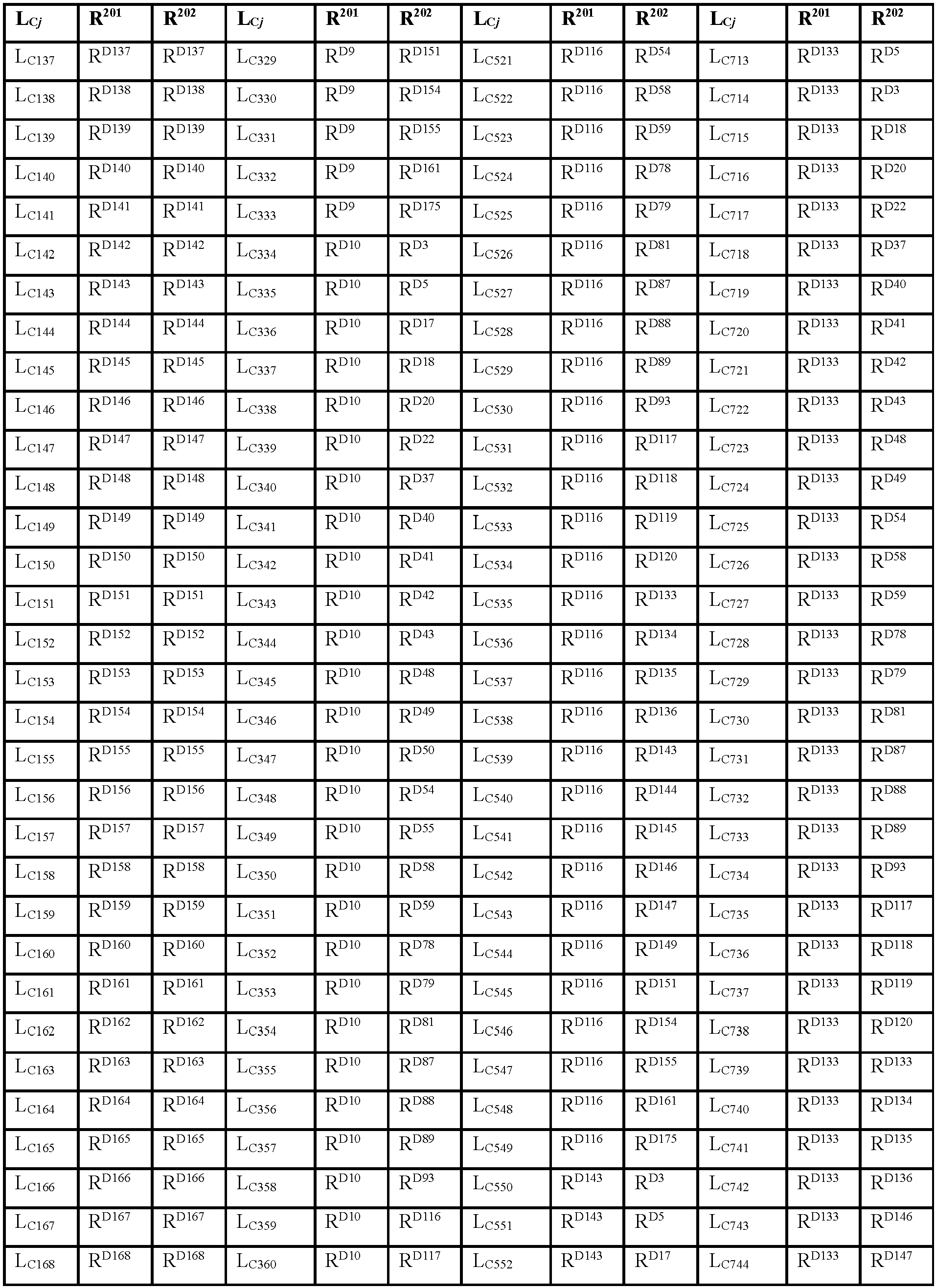 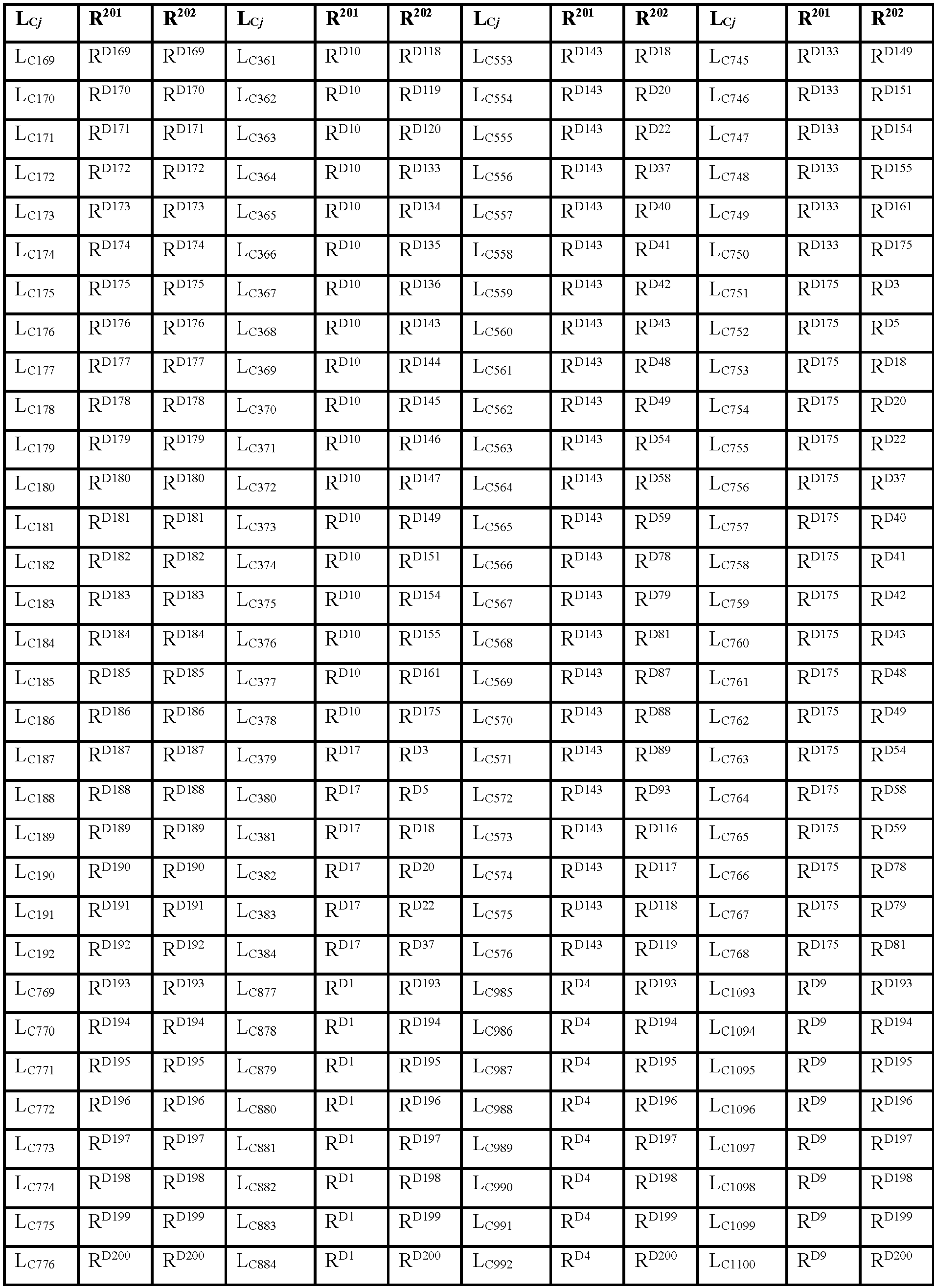 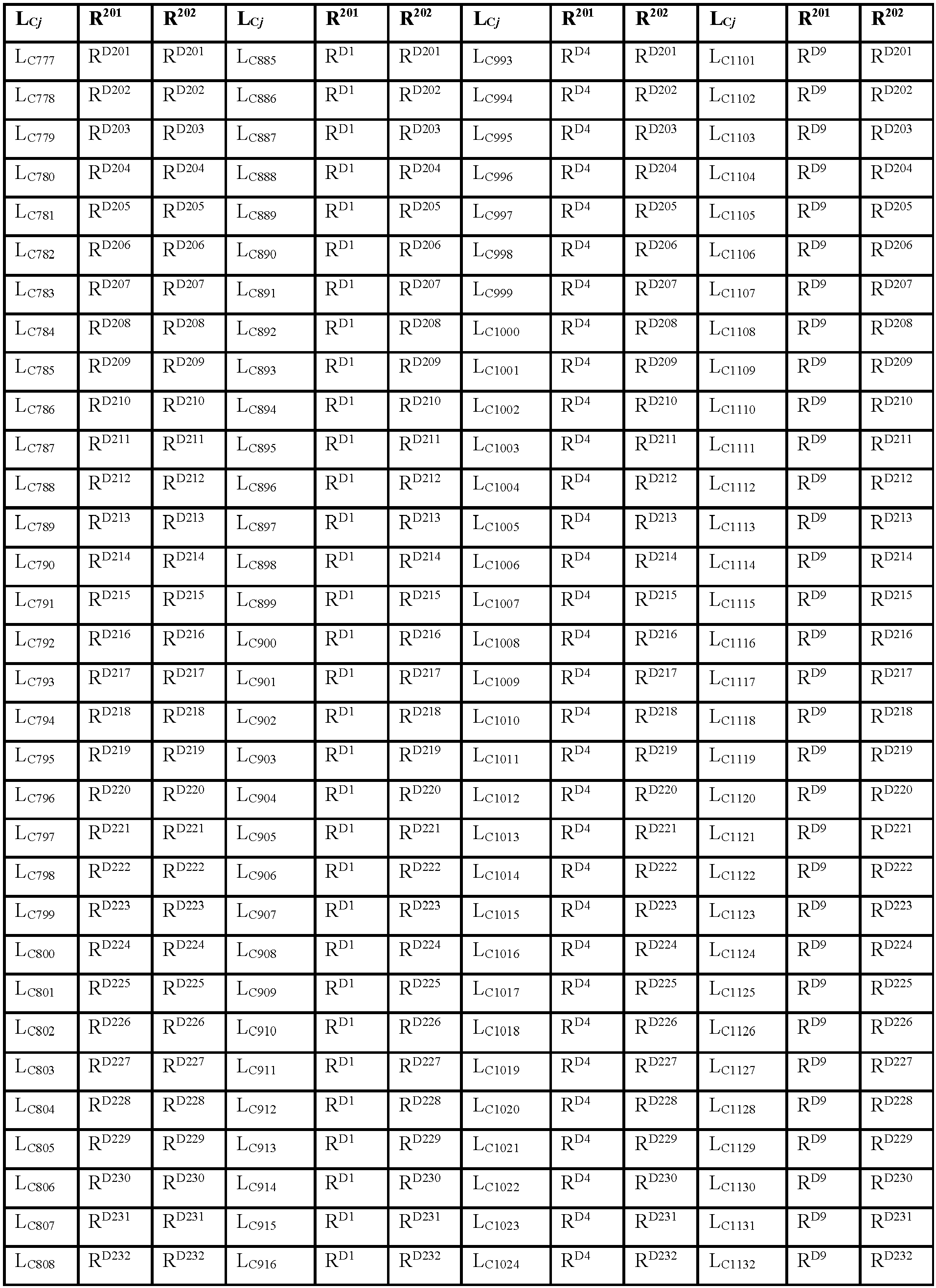 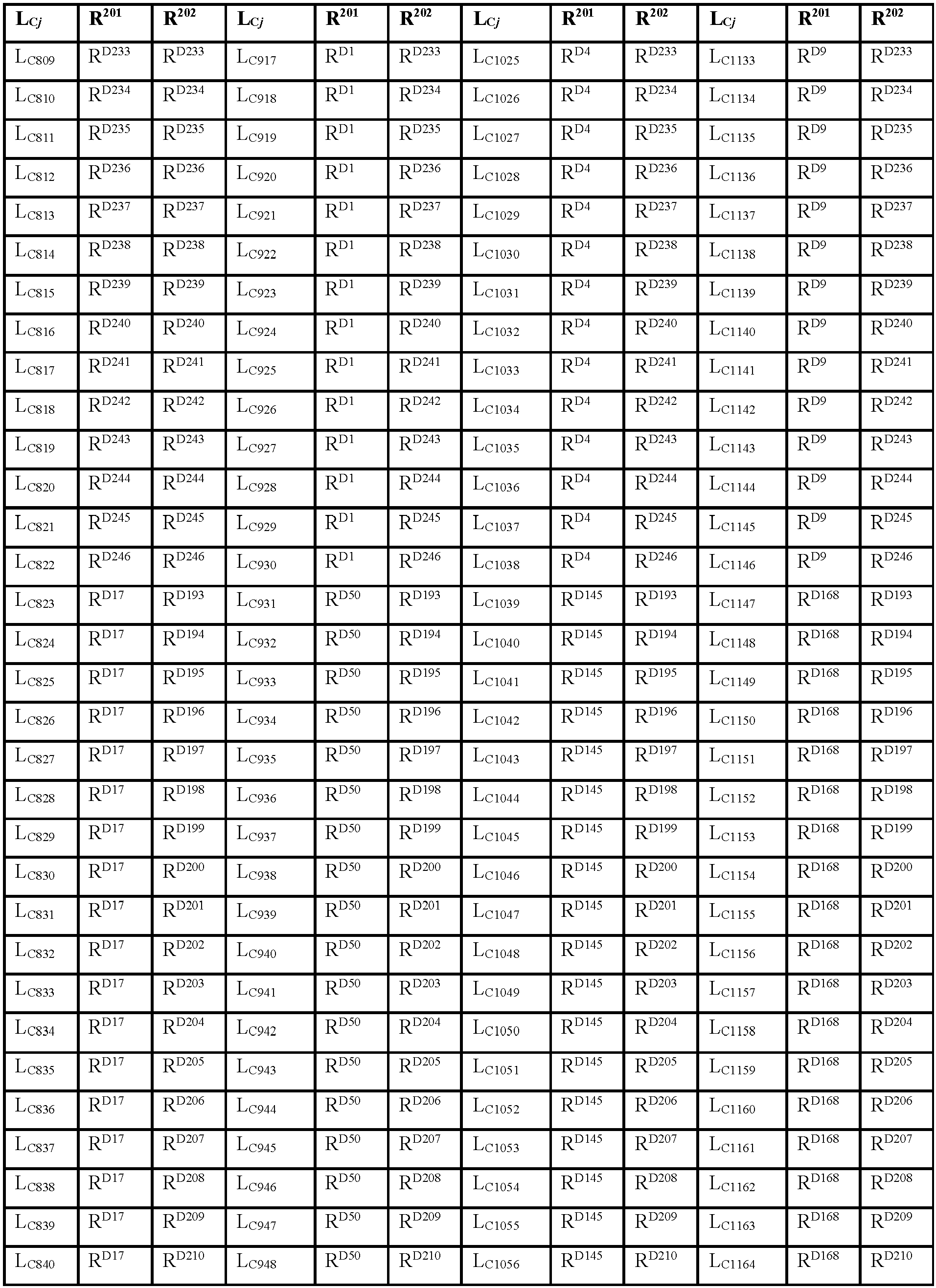 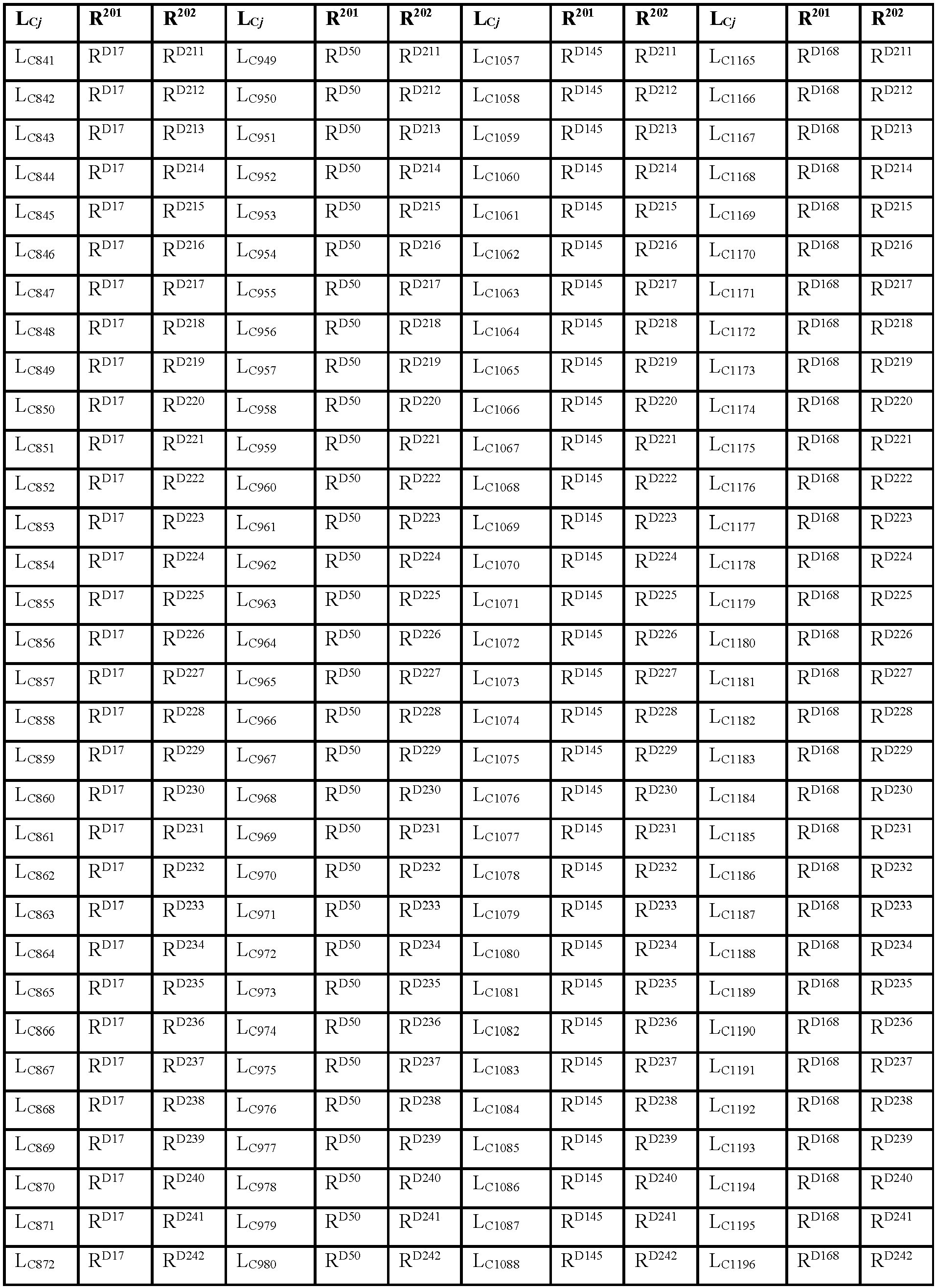 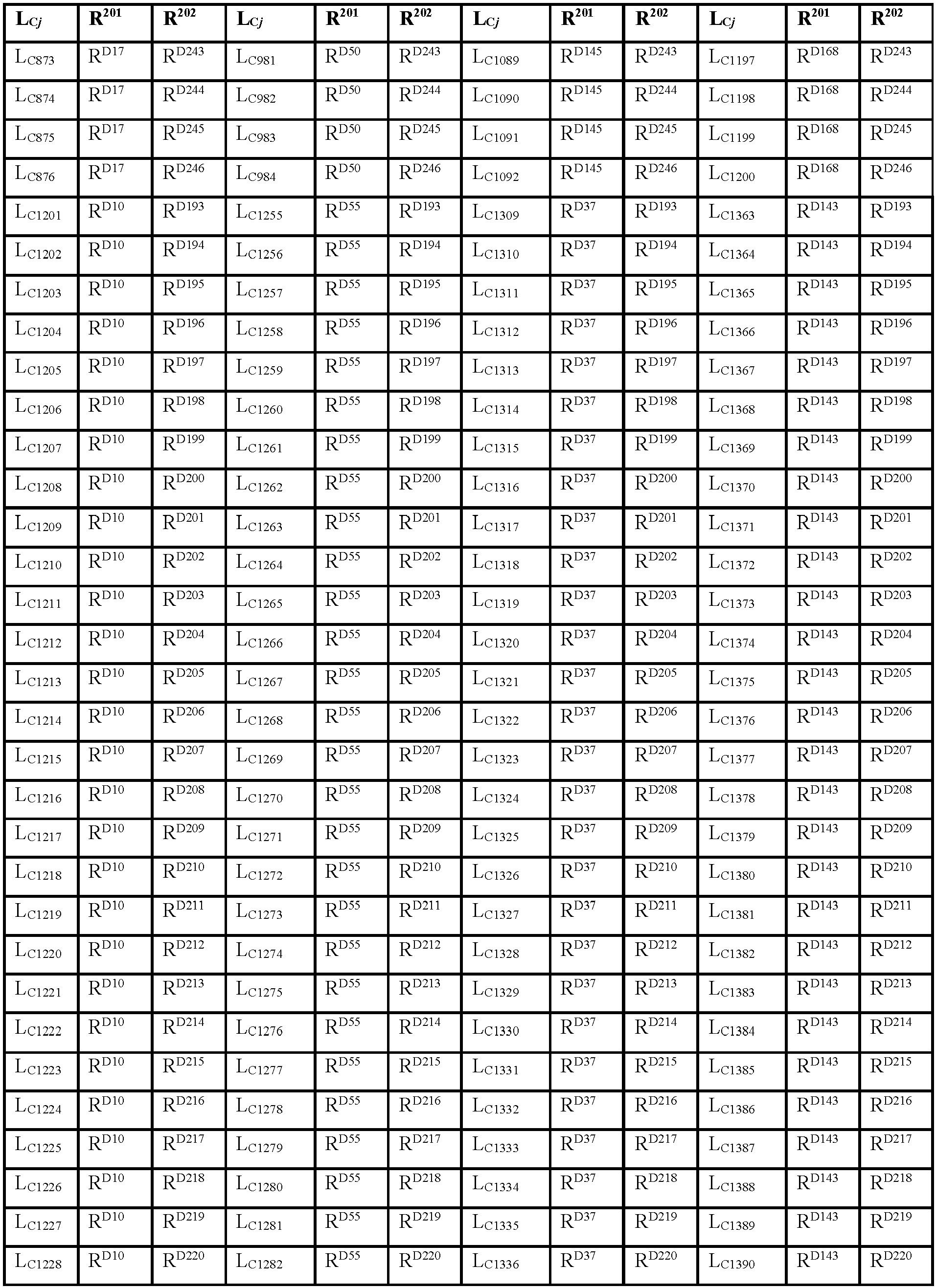 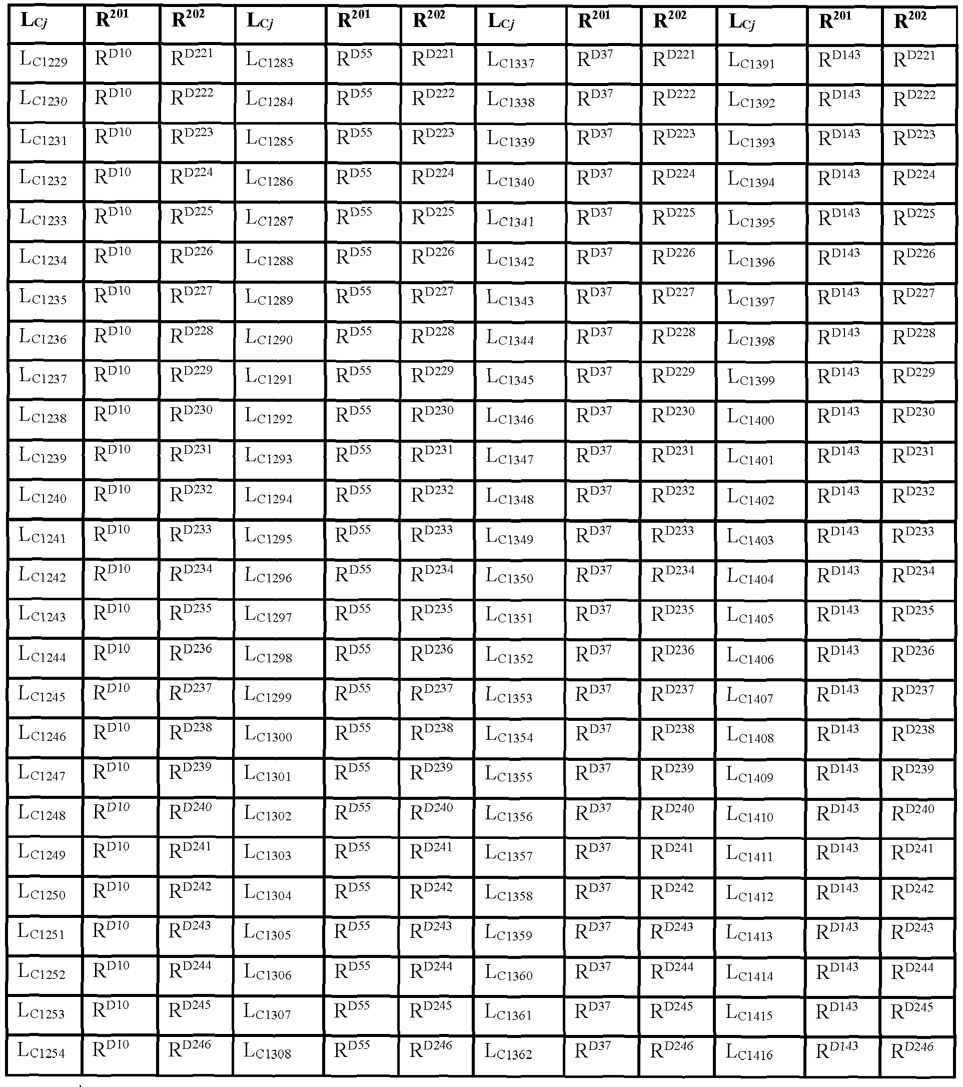
wherein R^{D1} to R^{D246} have the following structures:

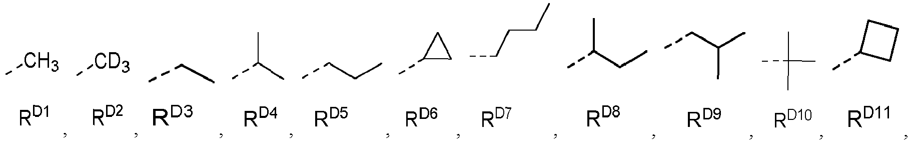

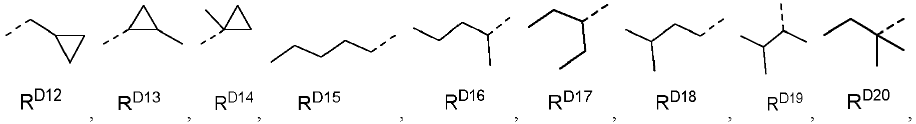

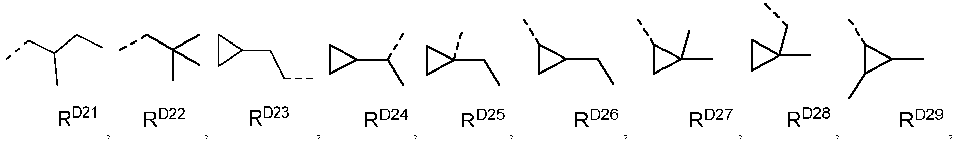

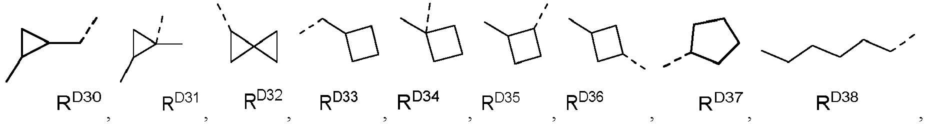

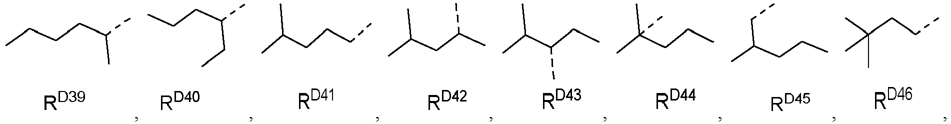

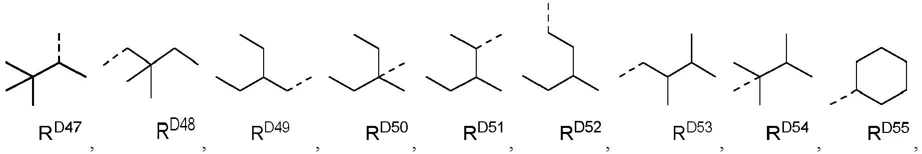

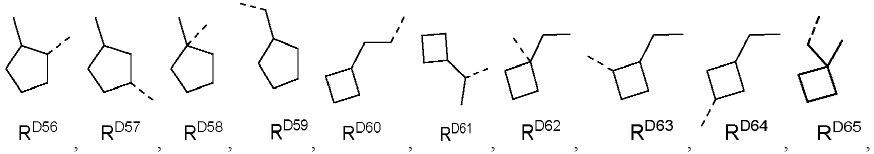

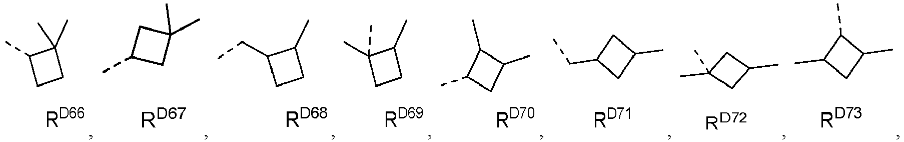

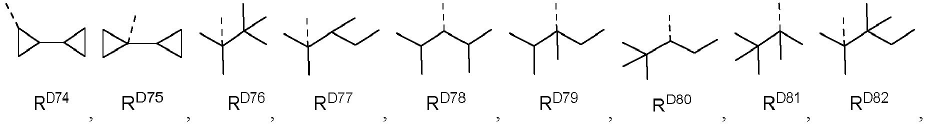

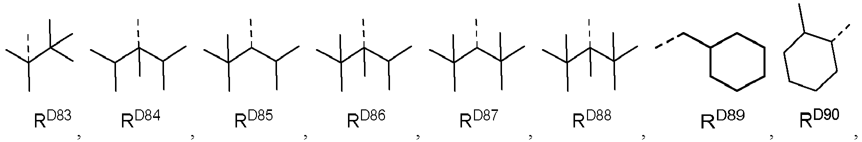

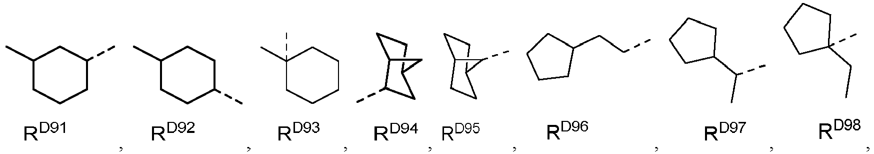

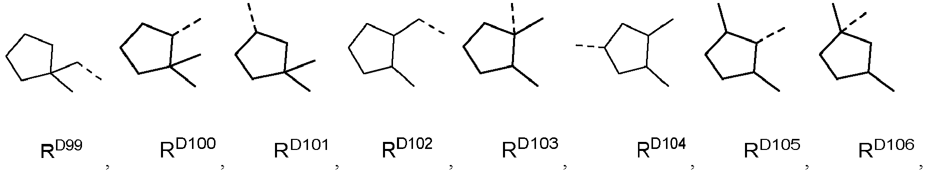

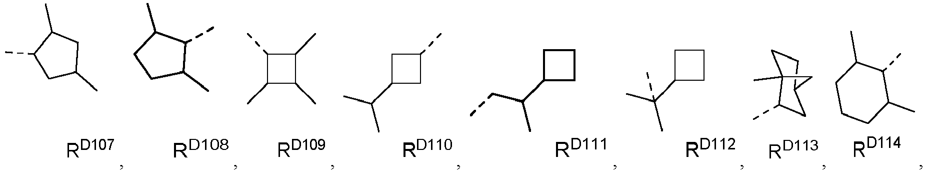

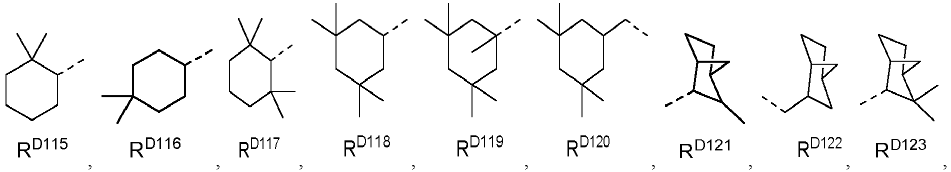

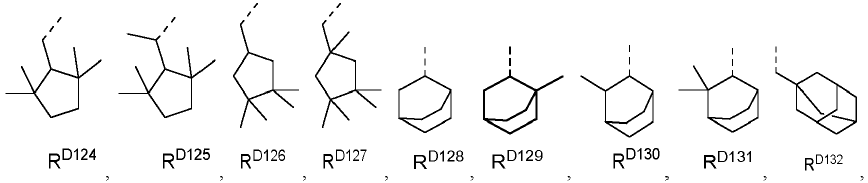

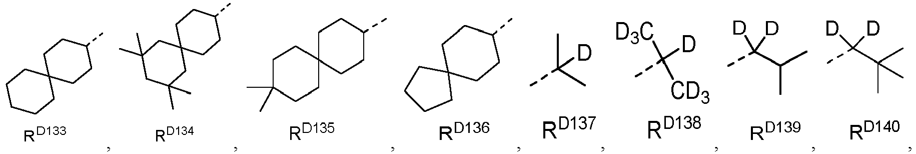

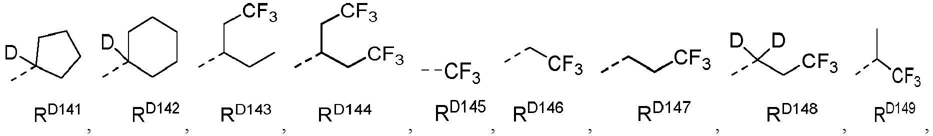

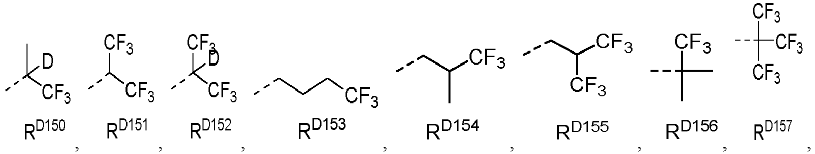

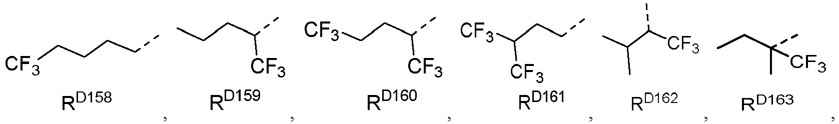

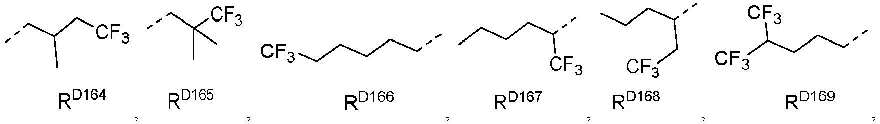

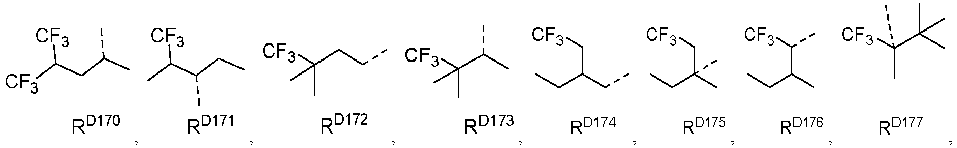

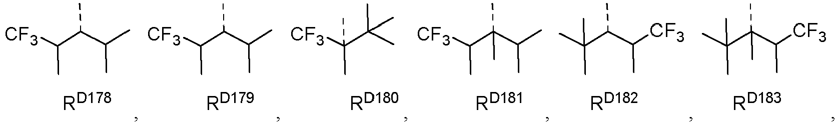

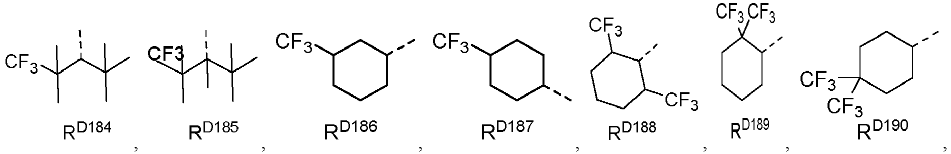

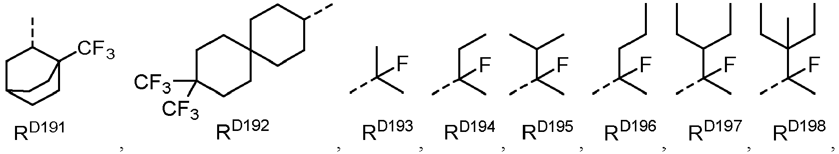

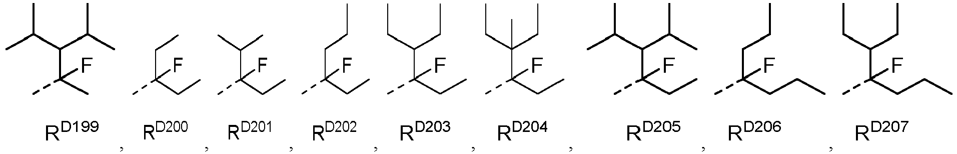

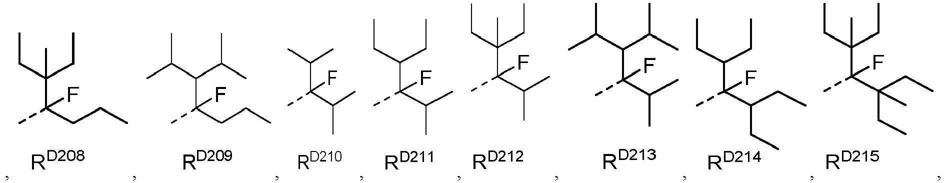

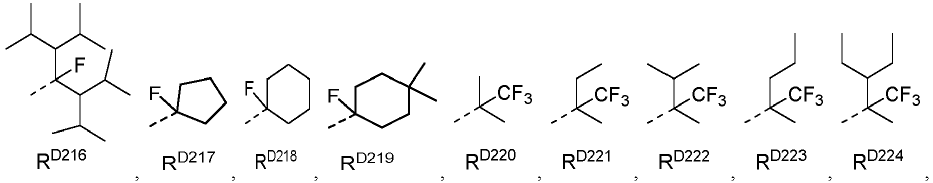

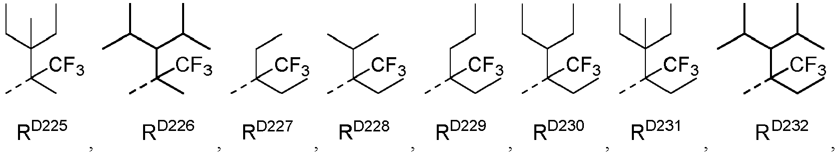

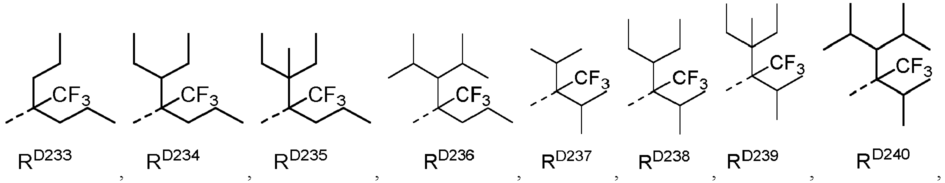

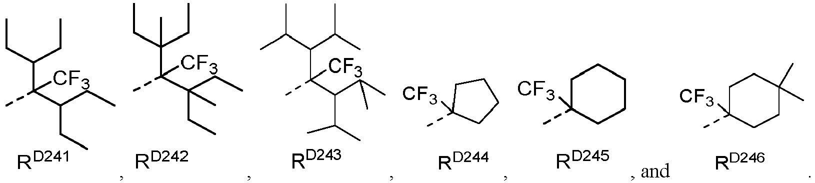

13. The compound of claim 1, wherein the compound is selected from the group consisting of: 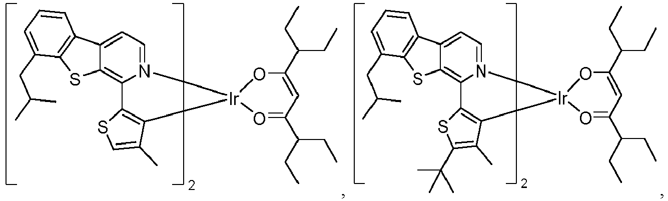 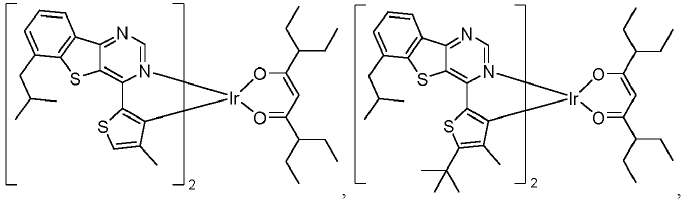 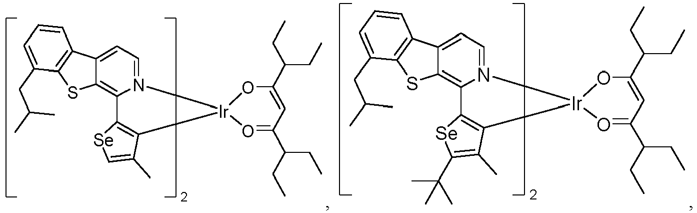 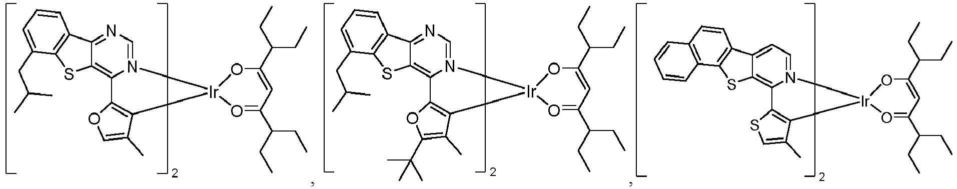 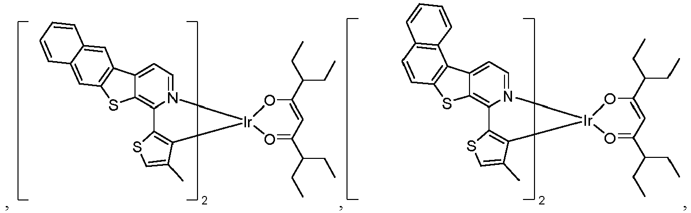 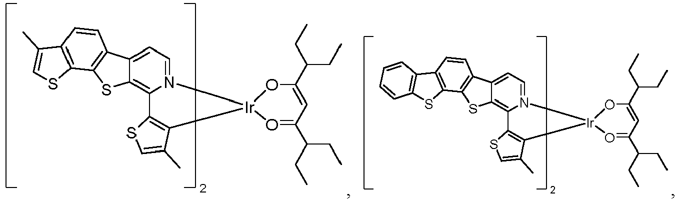 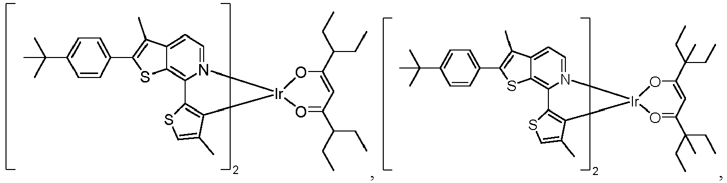 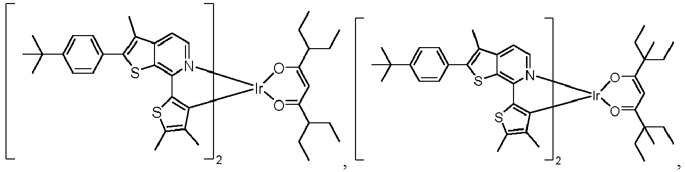 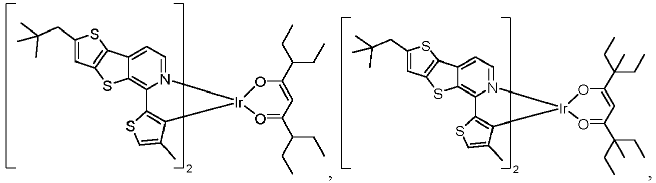 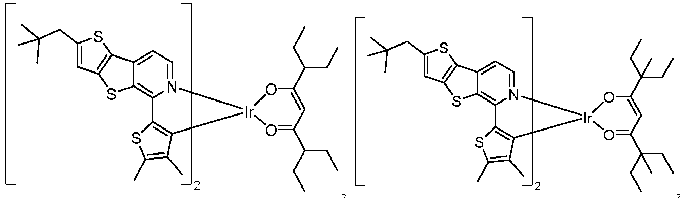 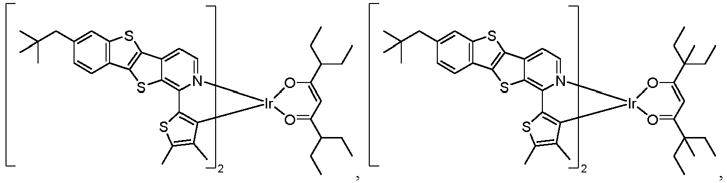 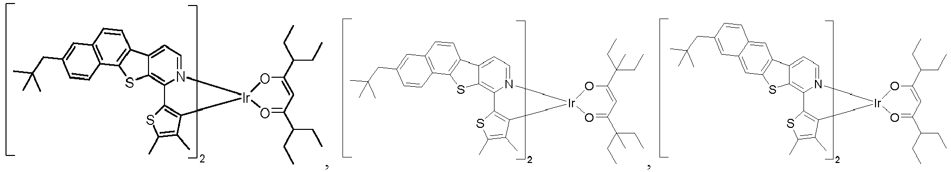 , and

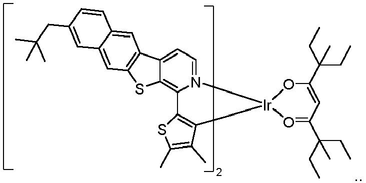

14. The compound of any one of claims 1 to 12, wherein the compound has a structure of Formula III, 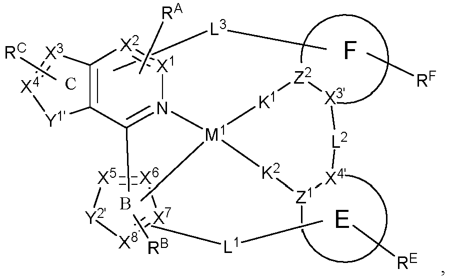 wherein:
M¹ is Pd or Pt;
moieties E and F are each independently a monocyclic or polycyclic fused ring structure comprising 5-membered and/or 6-membered carbocyclic or heterocyclic rings;
Z¹ and Z² are each independently C or N;
K¹ and K² are each independently selected from the group consisting of a direct bond, O, and S, wherein at least one of K¹ and K² is a direct bond;
L¹, L², and L³ are each independently selected from the group consisting of a single bond, absent a bond, O, S, SO, SO₂, C=O, C=NR', C=CR'R", CR'R", SiR'R", BR', and NR', wherein at least one of L¹ and L² is present;
X^{3'} and X^{4'} are each independently C or N;
R^{E} and R^{F} each independently represent mono, or up to a maximum allowed substitution, or no substitutions;
each of R', R", R^{E}, and R^{F} is independently a hydrogen or a substituent selected from the group consisting of deuterium, fluorine, alkyl, cycloalkyl, heteroalkyl, alkoxy, aryloxy, amino, silyl, boryl, alkenyl, cycloalkenyl, heteroalkenyl, aryl, heteroaryl, nitrile, isonitrile, sulfanyl, and combinations thereof; and
any two adjacent R, R', R", R^{A}, R^{C}, R^{E}, and R^{F} can be joined or fused together to form a ring.

15. An organic light emitting device (OLED) comprising:
an anode;
a cathode; and
an organic layer disposed between the anode and the cathode, wherein the organic layer comprises a compound according to any one of the previous claims.

16. A consumer product comprising an organic light-emitting device comprising:
an anode;
a cathode; and
an organic layer disposed between the anode and the cathode, wherein the organic layer comprises a compound according to any one of claims 1 to 14.

## Patentansprüche

1. Verbindung, die einen Liganden L_{A} mit der folgenden Struktur umfasst: 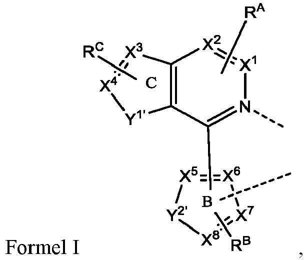 wobei:
jedes von X¹, X², X³, X⁴, X⁵, X⁶, X⁷ und X⁸ unabhängig C oder N ist;
Y^{1'} und Y^{2'} jeweils unabhängig voneinander ausgewählt sind aus der Gruppe bestehend aus O, S, Se;
jeder der Reste R^{A}, R^{B} und R^{C} unabhängig voneinander eine bis zur maximal zulässigen Substitution oder keine Substitution darstellt;
R^{A}, R^{B} und R^{C} jeweils unabhängig voneinander Wasserstoff oder einen Substituenten bedeuten, der ausgewählt ist aus der Gruppe bestehend aus Deuterium, Halogen, Alkyl, Cycloalkyl, Heteroalkyl, Heterocycloalkyl, Boryl, Selenyl, Arylalkyl, Alkoxy, Aryloxy, Amino, Silyl, Germyl, Alkenyl, Cycloalkenyl, Heteroalkenyl, Alkynyl, Aryl, Heteroaryl, Acyl, Carbonsäure, Ether, Ester, Nitril, Isonitril, Sulfanyl, Sulfinyl, Sulfonyl, Phosphino und Kombinationen davon;
L_{A} durch die angegebenen gestrichelten Linien an das Metall M koordiniert ist und einen 5-gliedrigen Chelatring bildet;
das Metall M ausgewählt ist aus der Gruppe bestehend aus Ru, Os, Ir, Pd, Pt, Cu, Ag und Au;
Ring B durch eine C-M-Bindung an M koordiniert ist;
M mit anderen Liganden koordiniert sein kann;
L_{A} mit anderen Liganden verbunden werden kann, um einen dreizähnigen, vierzähnigen, fünfzähnigen oder sechszähnigen Liganden zu bilden; und
zwei beliebige benachbarte R^{A}, und R^{C} miteinander verbunden oder verschmolzen werden können, um einen Ring zu bilden.

2. Verbindung nach Anspruch 1, wobei jeder der Reste R^{A}, R^{B} und R^{C} unabhängig ein Wasserstoffatom oder ein Substituent ist, der aus der Gruppe ausgewählt ist, die aus Deuterium, Fluor, Alkyl, Cycloalkyl, Heteroalkyl, Alkoxy, Aryloxy, Amino, Silyl, Boryl, Alkenyl, Cycloalkenyl, Heteroalkenyl, Aryl, Heteroaryl, Nitril, Isonitril, Sulfanyl, und Kombinationen davon besteht.

3. Verbindung nach einem der Ansprüche 1 oder 2, wobei jedes von X¹, X², X³, X⁴, X⁵, X⁶, X⁷ und X⁸ C ist; oder mindestens eines von X¹, X², X³, X⁴, X⁵, X⁶, X⁷ und X⁸ N ist.

4. Verbindung nach Anspruch 1, wobei eines von X¹ und X² N ist; oder eines von X³ und X⁴ N ist.

5. Verbindung nach Anspruch 1, wobei X³ und X⁴ C sind und zwei R^{C} miteinander verbunden sind, um ein mit Ring C kondensiertes Ringsystem zu bilden.

6. Verbindung nach Anspruch 5, wobei das Ringsystem einen an Ring C kondensierten Ring oder mindestens zwei an Ring C kondensierte Ringe oder mindestens drei an Ring C kondensierte Ringe umfasst.

7. Verbindung nach einem der vorhergehenden Ansprüche, wobei L_{A} die folgende Struktur aufweist 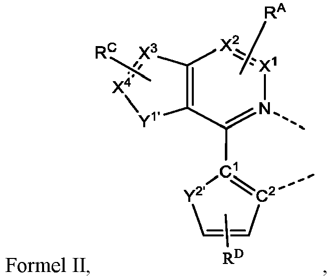
wobei C¹ und C² Kohlenstoffatome sind, die durch eine Doppelbindung verbunden sind;
wobei R^{D} eine Mono- oder Di-Substitution oder keine Substitution darstellt; und
jedes R^{D} unabhängig ein Wasserstoff oder ein Substituent ist, ausgewählt aus der Gruppe bestehend aus Deuterium, Halogen, Alkyl, Cycloalkyl, Heteroalkyl, Heterocycloalkyl, Boryl, Selenyl, Arylalkyl, Alkoxy, Aryloxy, Amino, Silyl, Germyl, Alkenyl, Cycloalkenyl, Heteroalkenyl, Alkynyl, Aryl, Heteroaryl, Acyl, Carbonsäure, Ether, Ester, Nitril, Isonitril, Sulfanyl, Sulfinyl, Sulfonyl, Phosphino und Kombinationen davon.

8. Verbindung nach einem der vorhergehenden Ansprüche, wobei der Ligand L_{A} ausgewählt ist aus der Gruppe bestehend aus den folgenden Strukturen: 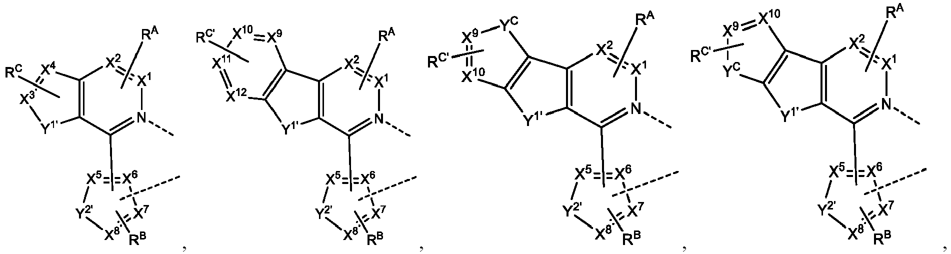 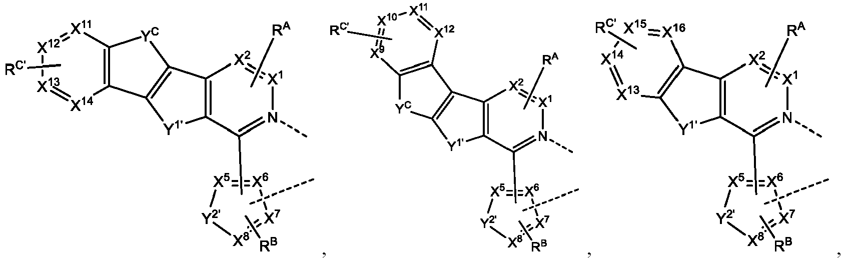 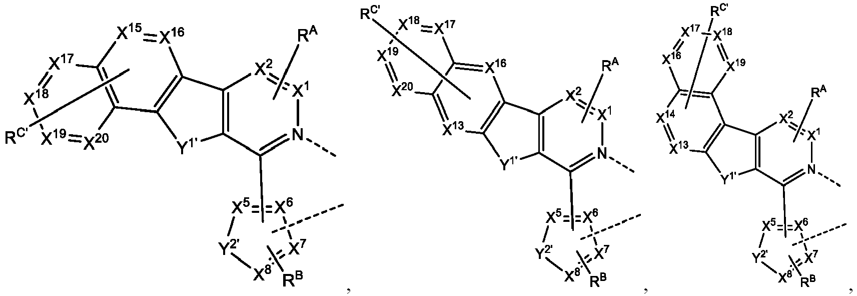 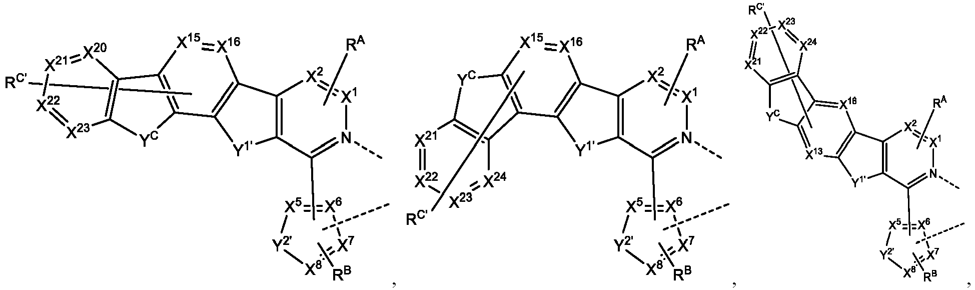 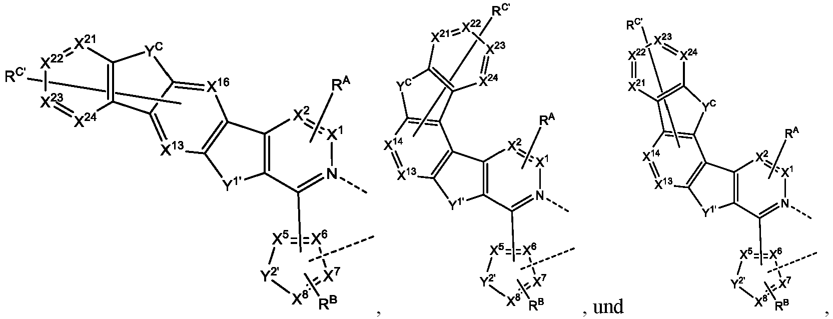 wobei
jeder der Reste X⁹ bis X²⁴ unabhängig voneinander C oder N ist;
Y^{C} ausgewählt ist aus der Gruppe bestehend aus O, S, CR'R", SiR'R", BR' und NR';
R^{C'} steht für Mono- bis zur maximal zulässigen Substitution oder keine Substitution; und
jedes R^{C'} ist unabhängig ein Wasserstoff oder ein Substituent, ausgewählt aus der Gruppe bestehend aus Deuterium, Halogen, Alkyl, Cycloalkyl, Heteroalkyl, Heterocycloalkyl, Boryl, Selenyl, Arylalkyl, Alkoxy, Aryloxy, Amino, Silyl, Germyl, Alkenyl, Cycloalkenyl, Heteroalkenyl, Alkynyl, Aryl, Heteroaryl, Acyl, Carbonsäure, Ether, Ester, Nitril, Isonitril, Sulfanyl, Sulfinyl, Sulfonyl, Phosphino und Kombinationen davon.

9. Verbindung nach einem der vorhergehenden Ansprüche, wobei der Ligand L_{A} aus der Gruppe ausgewählt ist, die aus L_{Ai-m-X} besteht, wobei *i* eine ganze Zahl von 1 bis 2610 ist, *m* eine ganze Zahl von 1 bis 108 ist und X von 1 bis 3 ist, wobei 1 für O, 2 für S und 3 für Se steht, wobei jeder von *L*_{*Ai-1*-}*_{X}* bis L*_{Ai-108-X}* die wie folgt definierte Struktur aufweist: 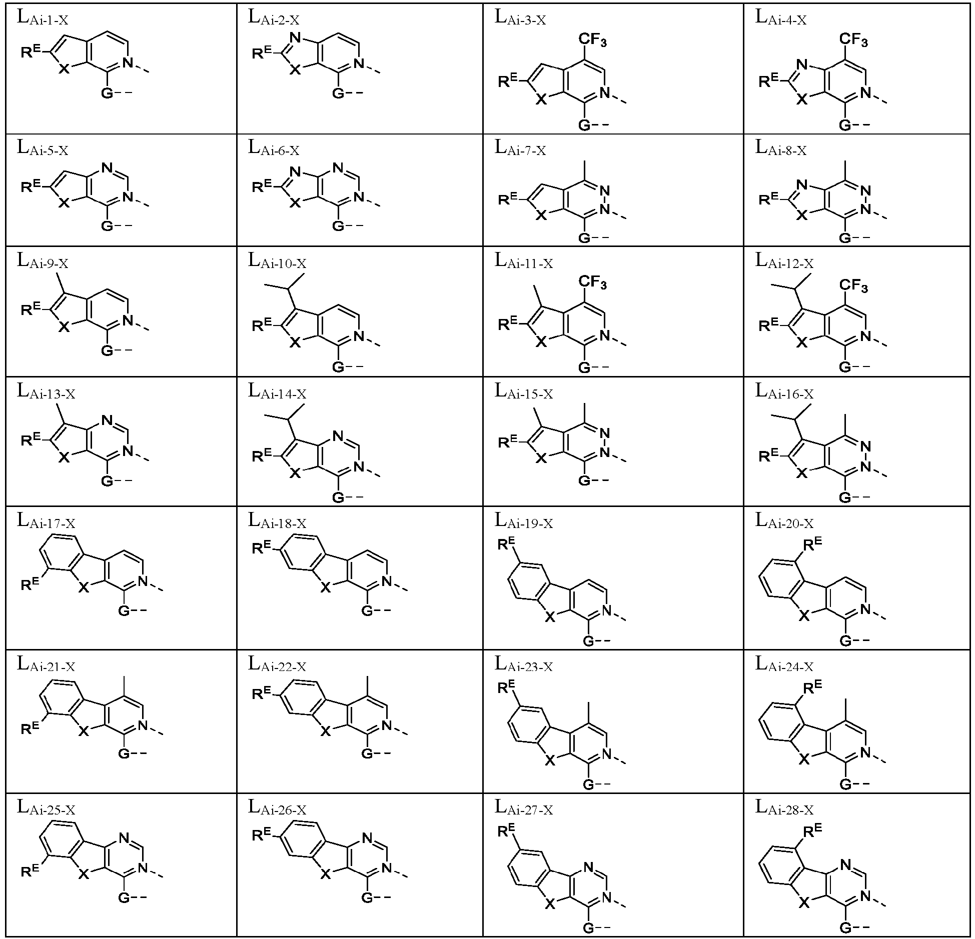 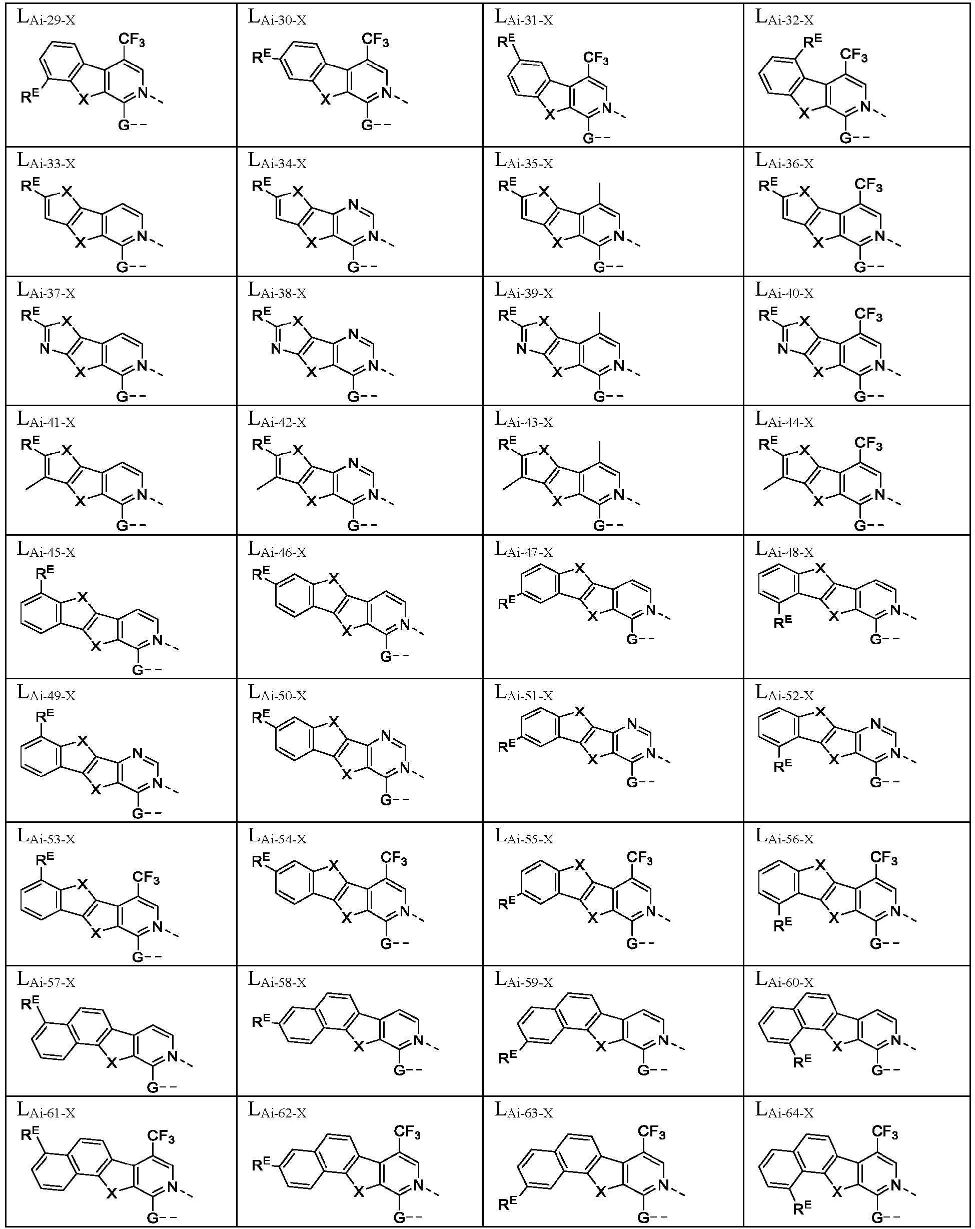 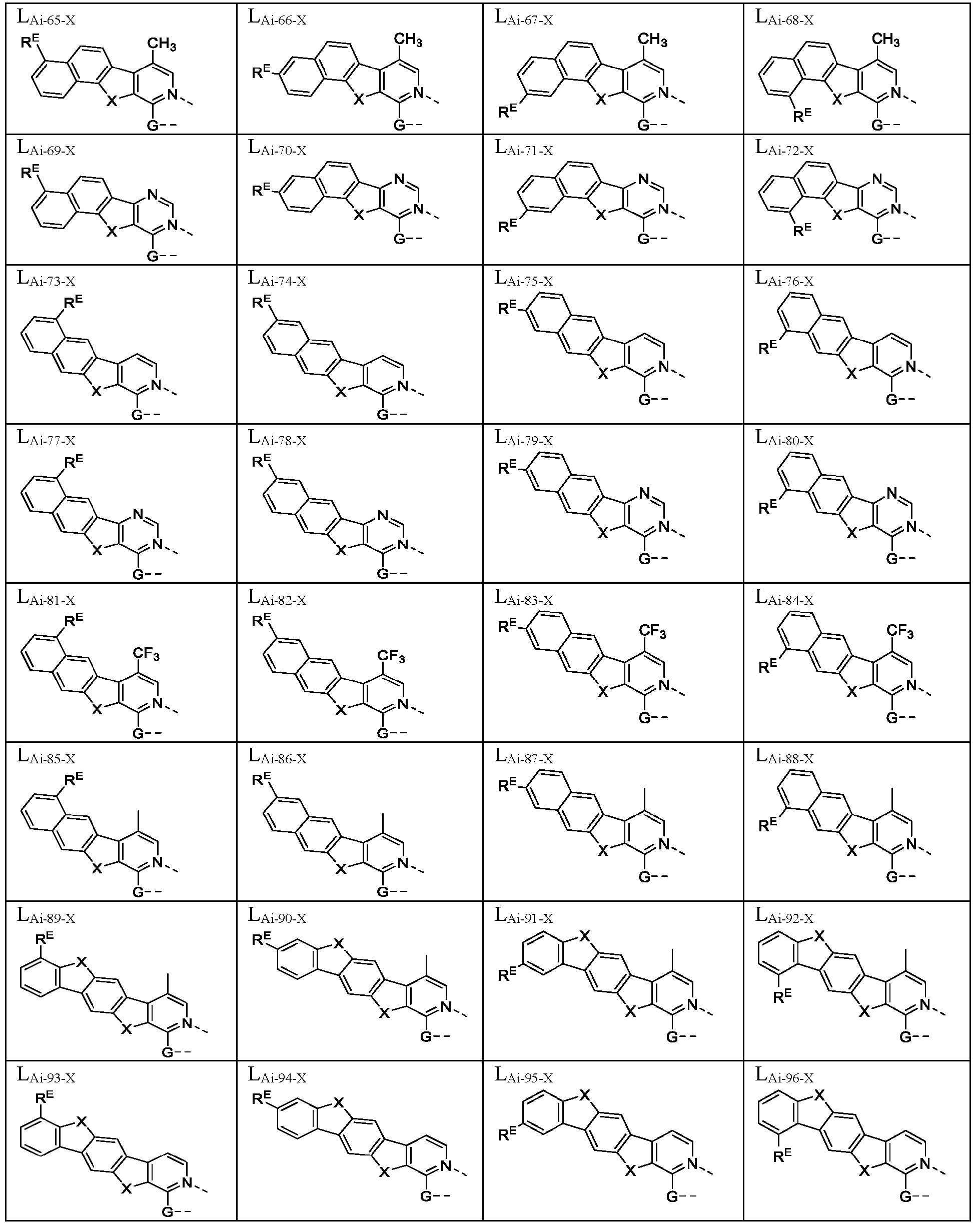 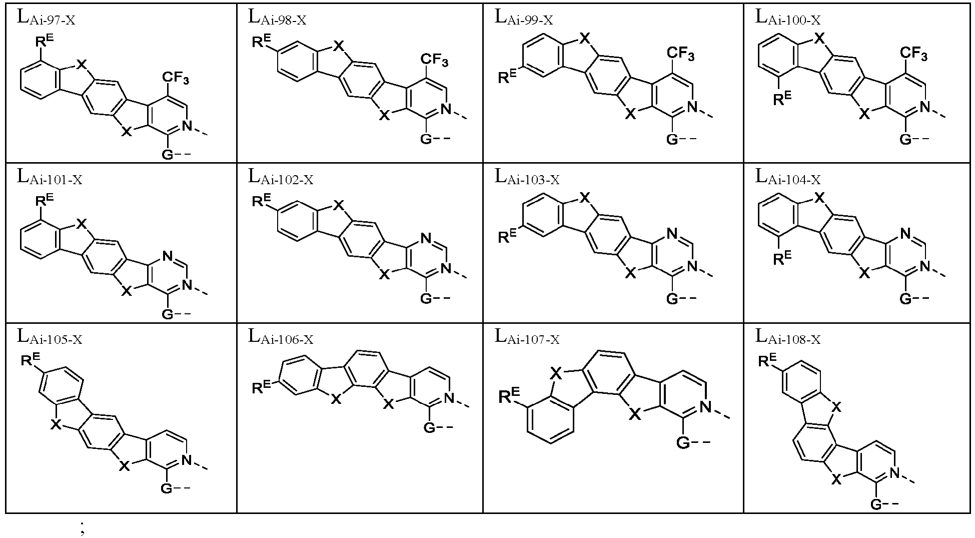 wobei für jedes von L_{A1} bis L_{A2610}, R^{E} und G wie folgt definiert sind: 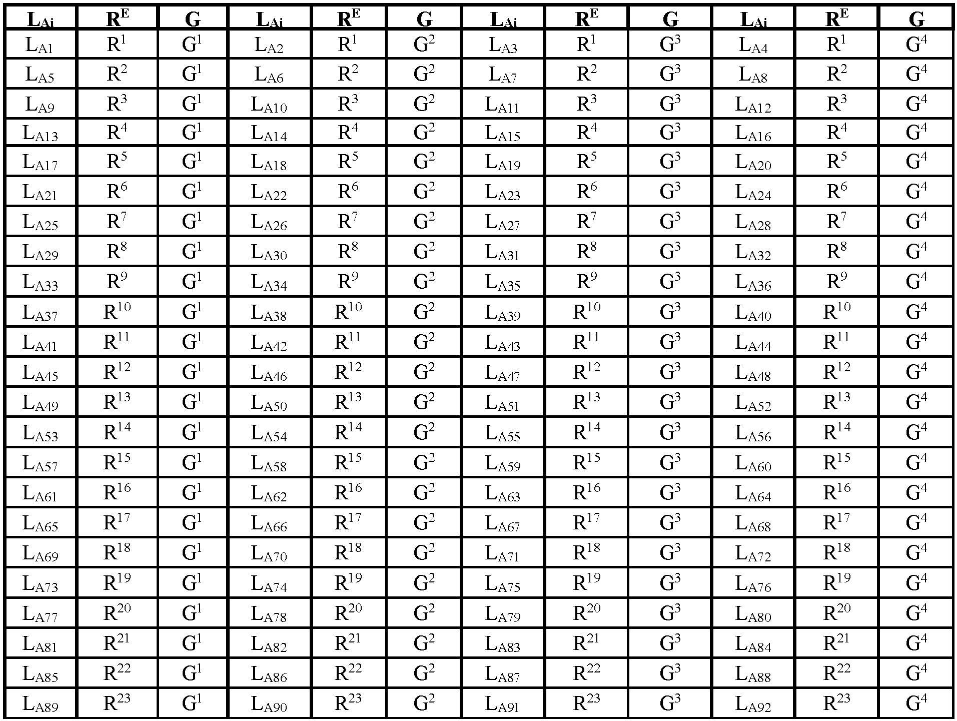 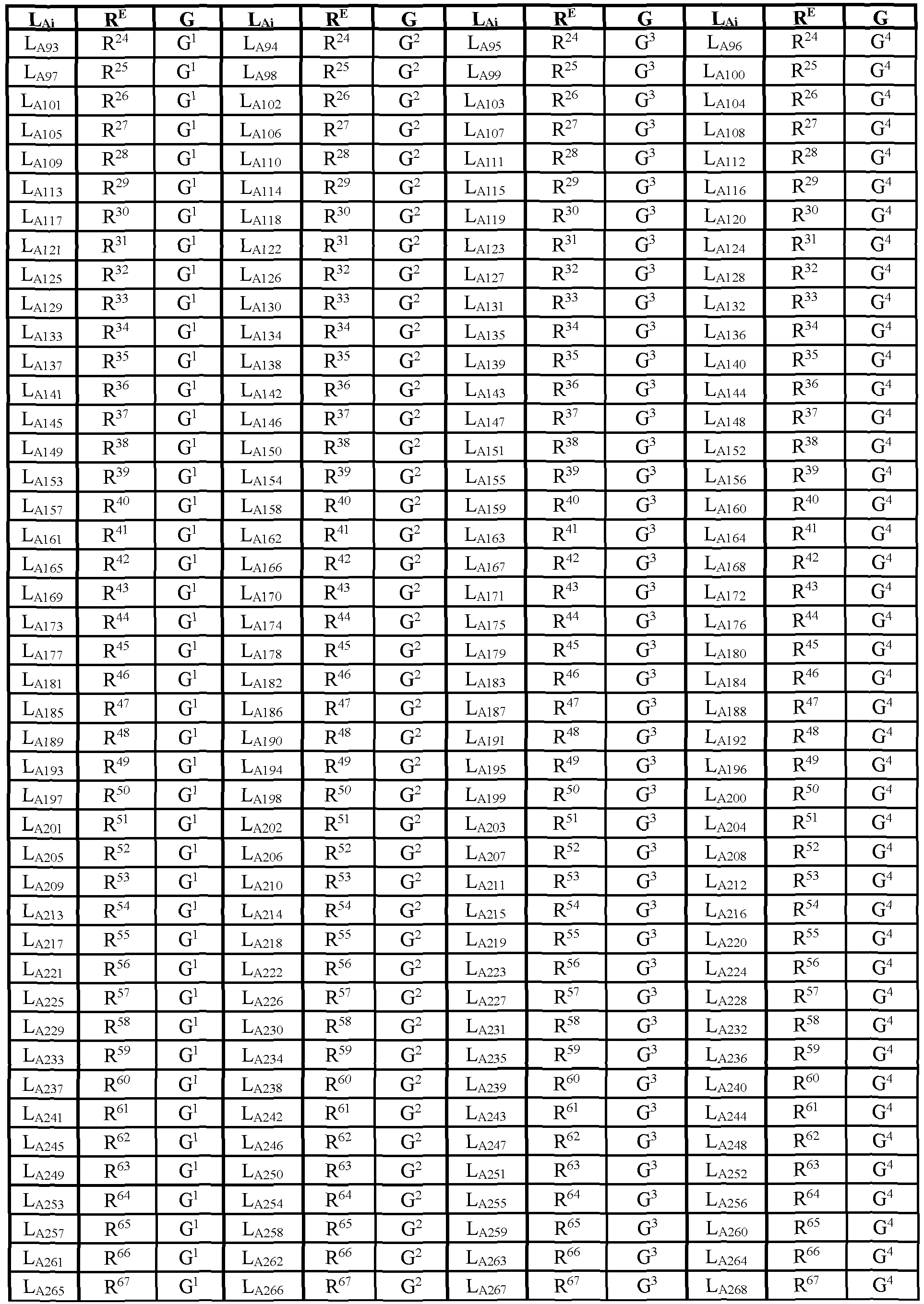 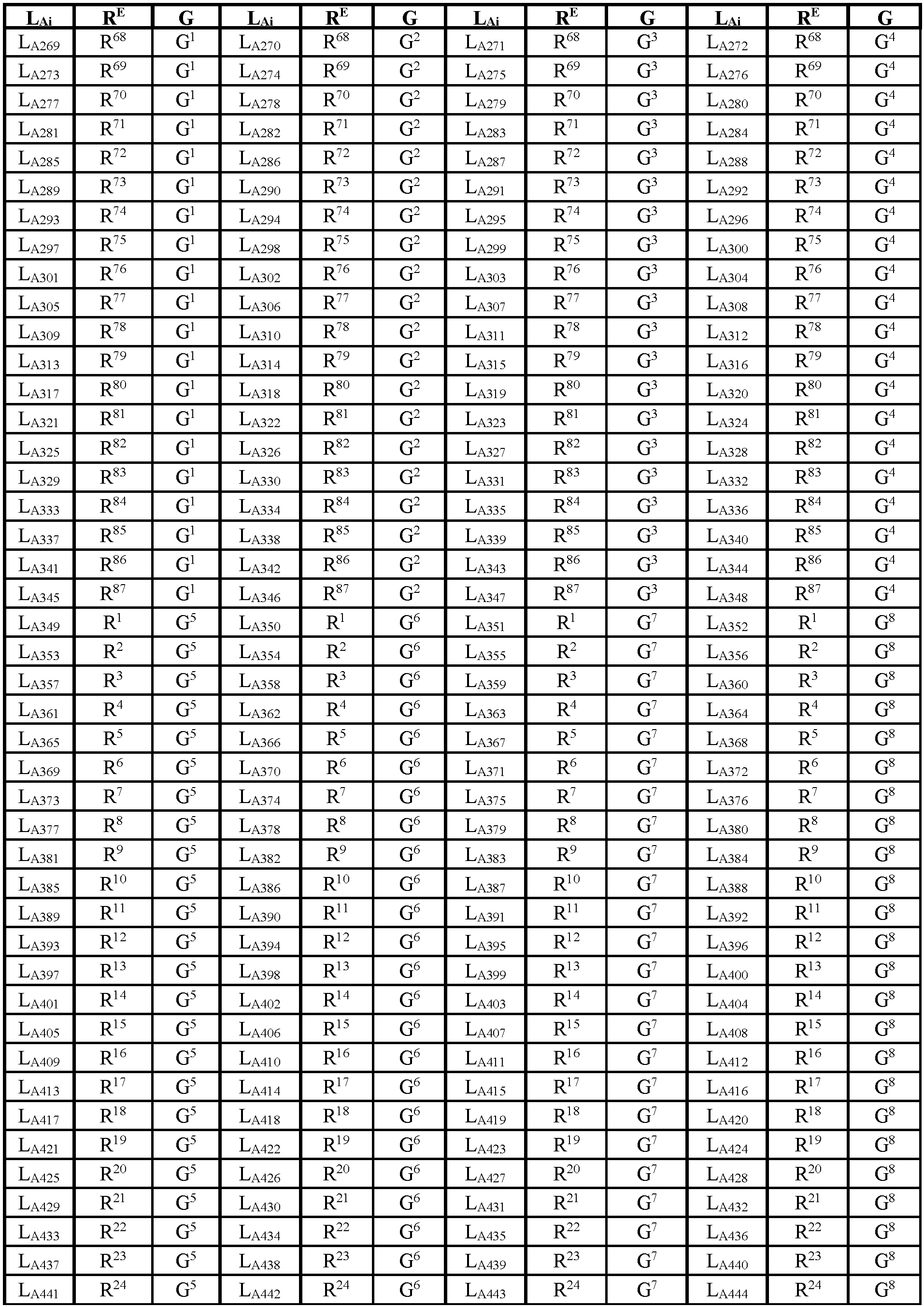 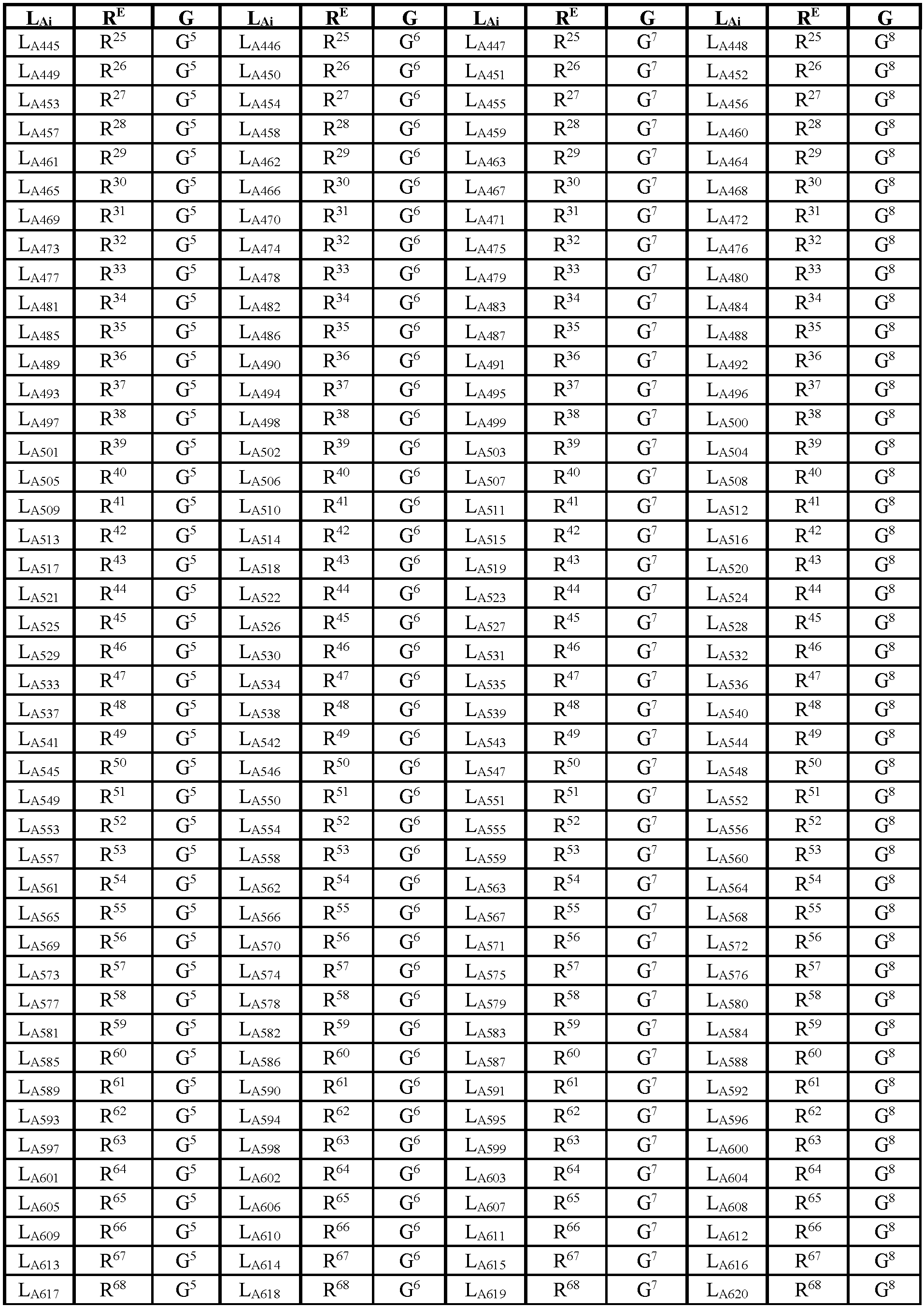 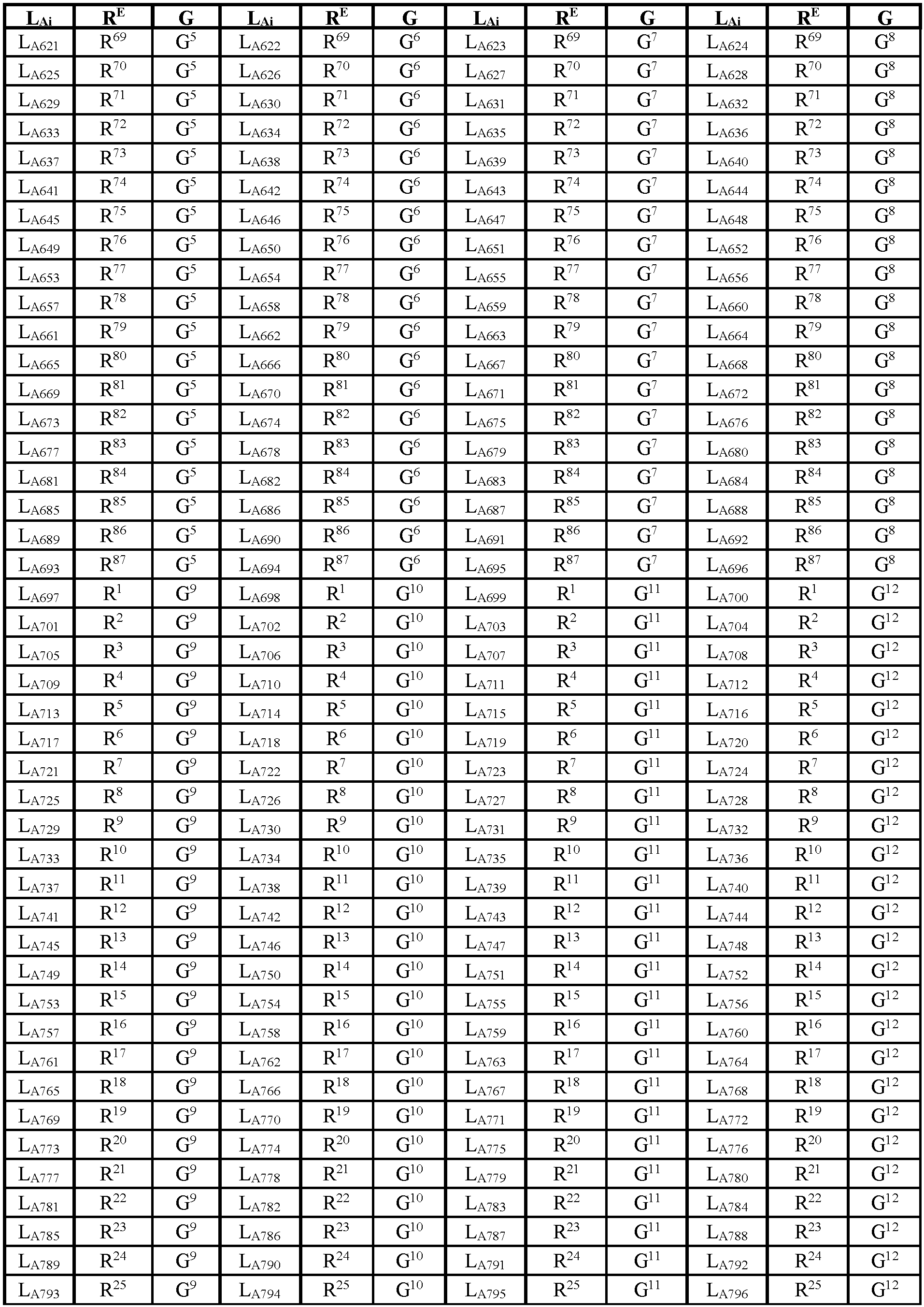 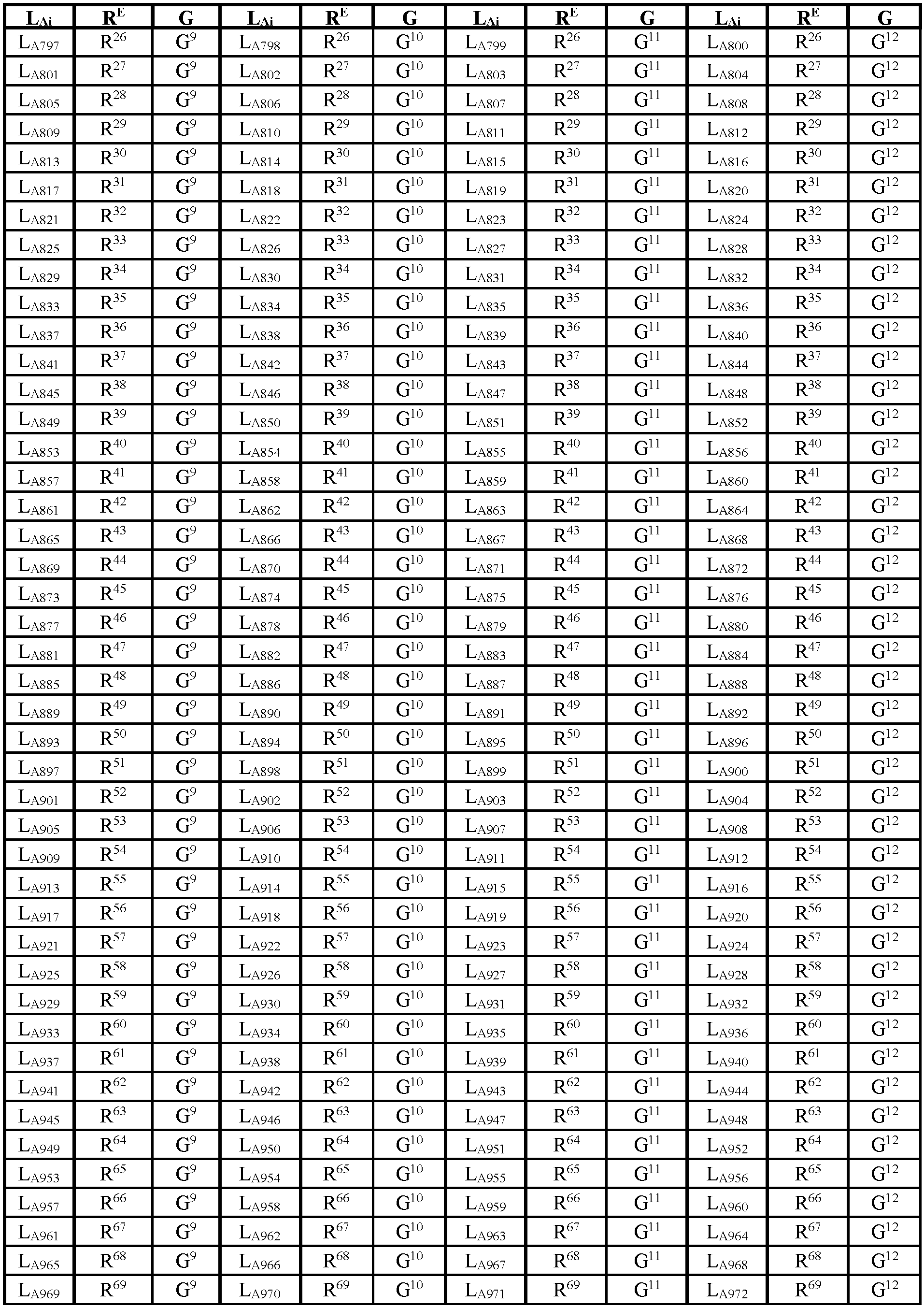 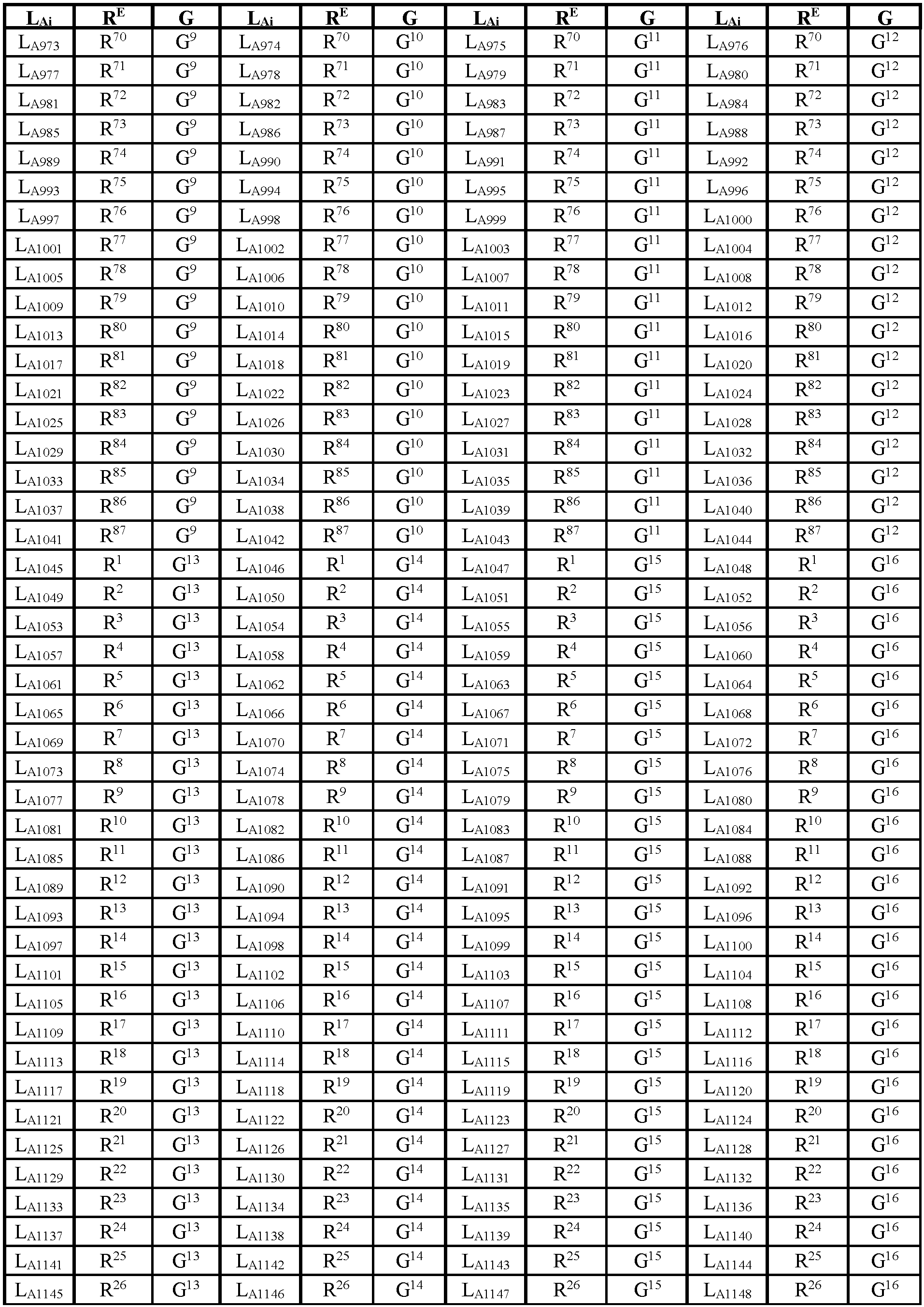 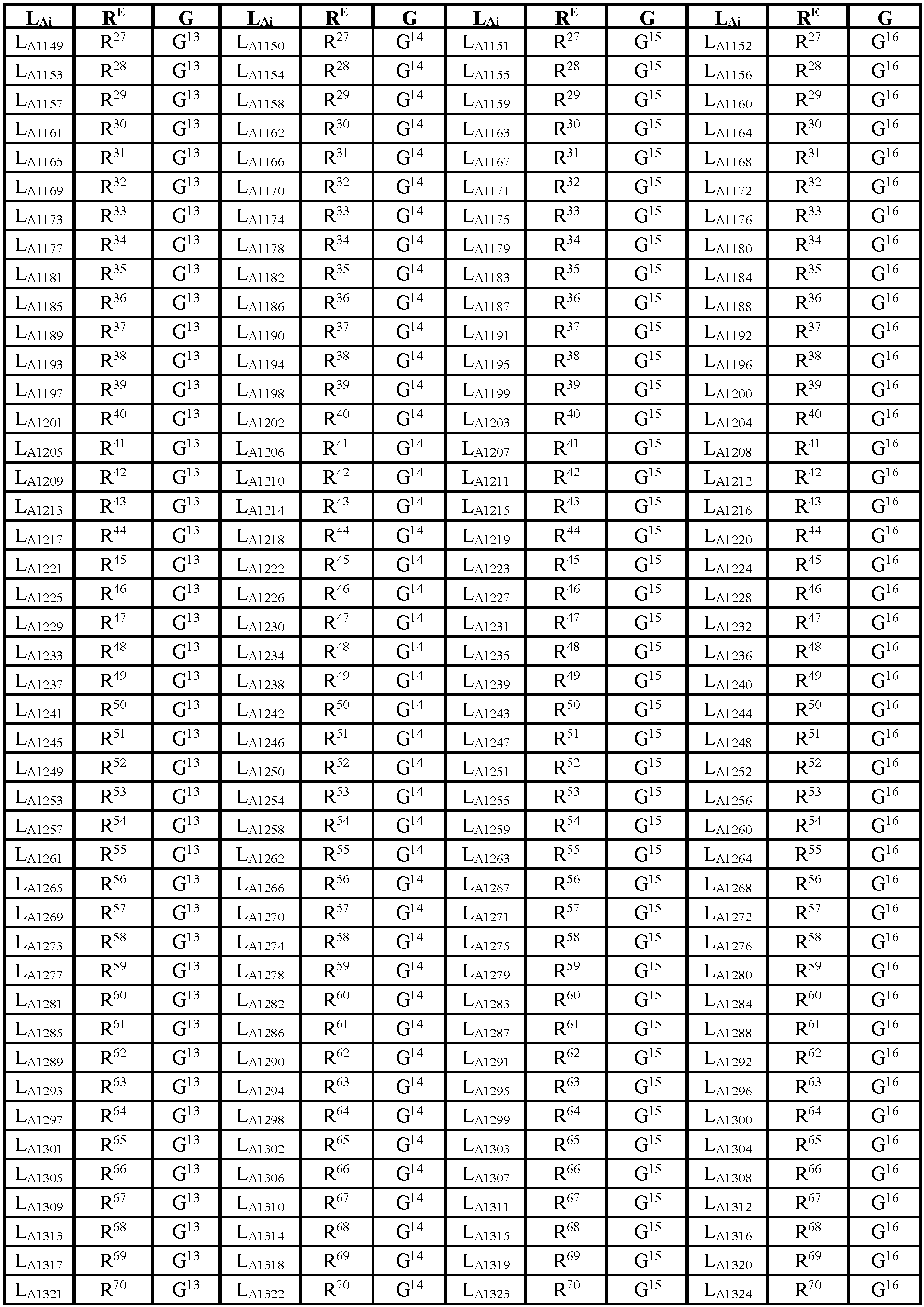 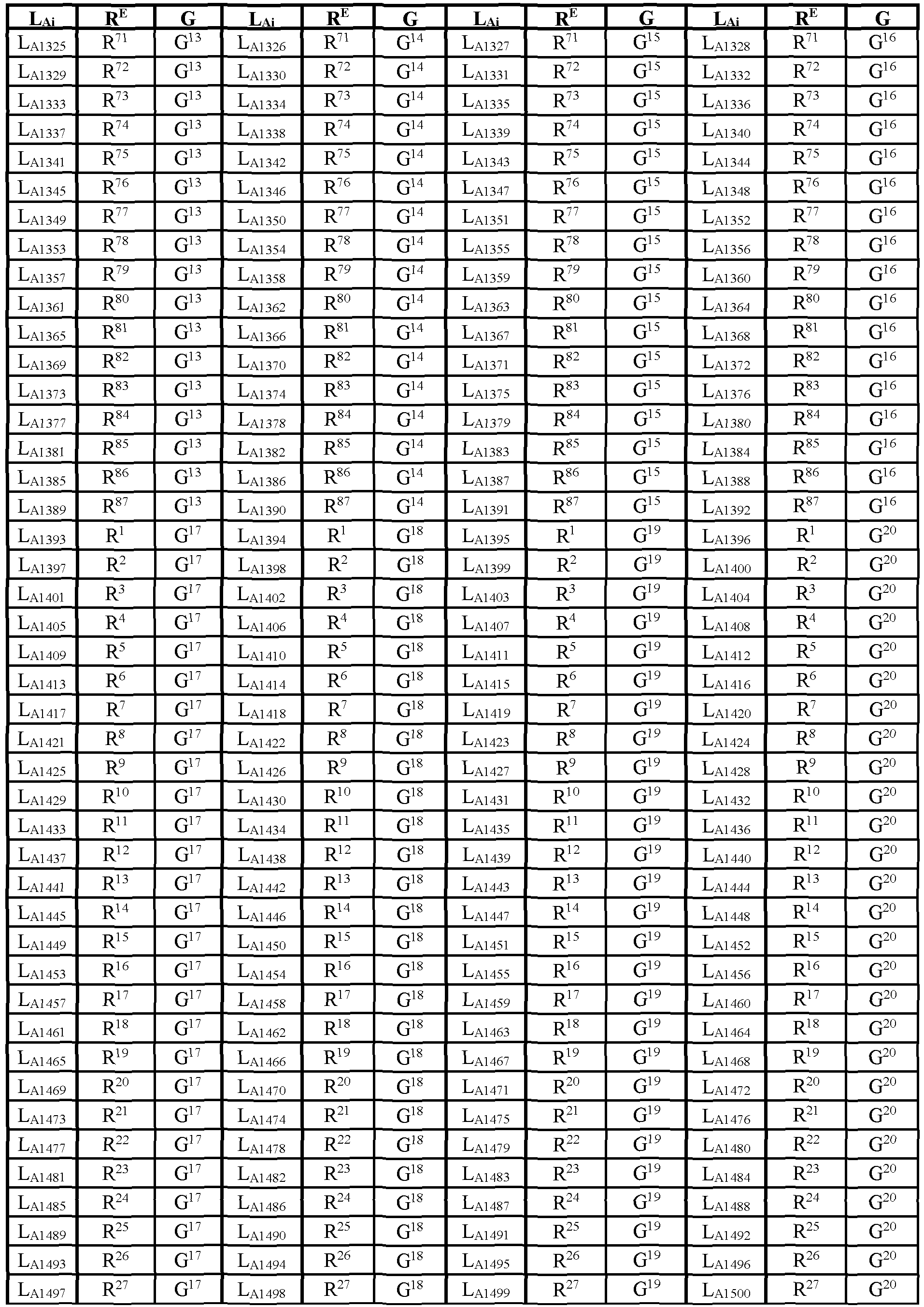 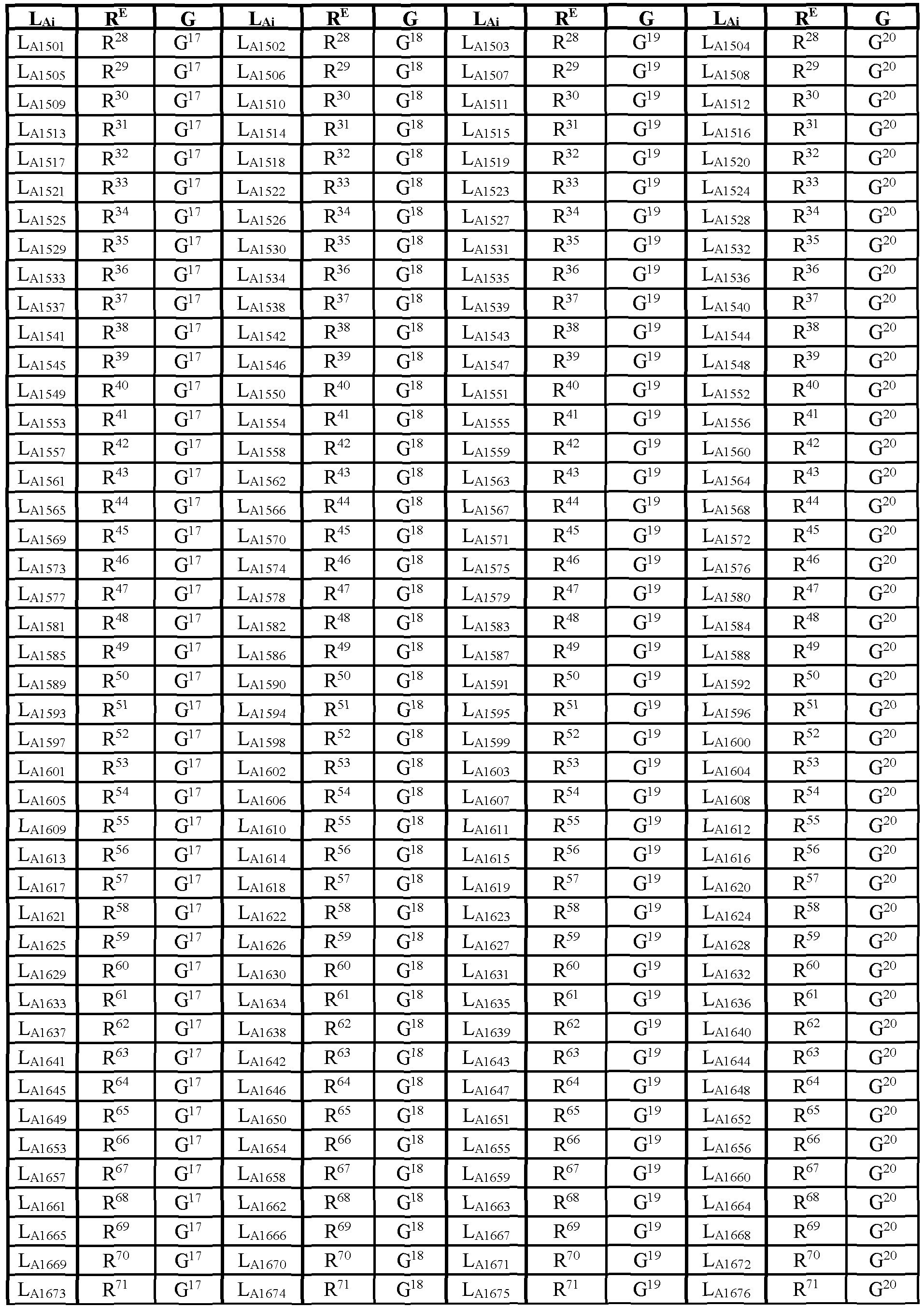 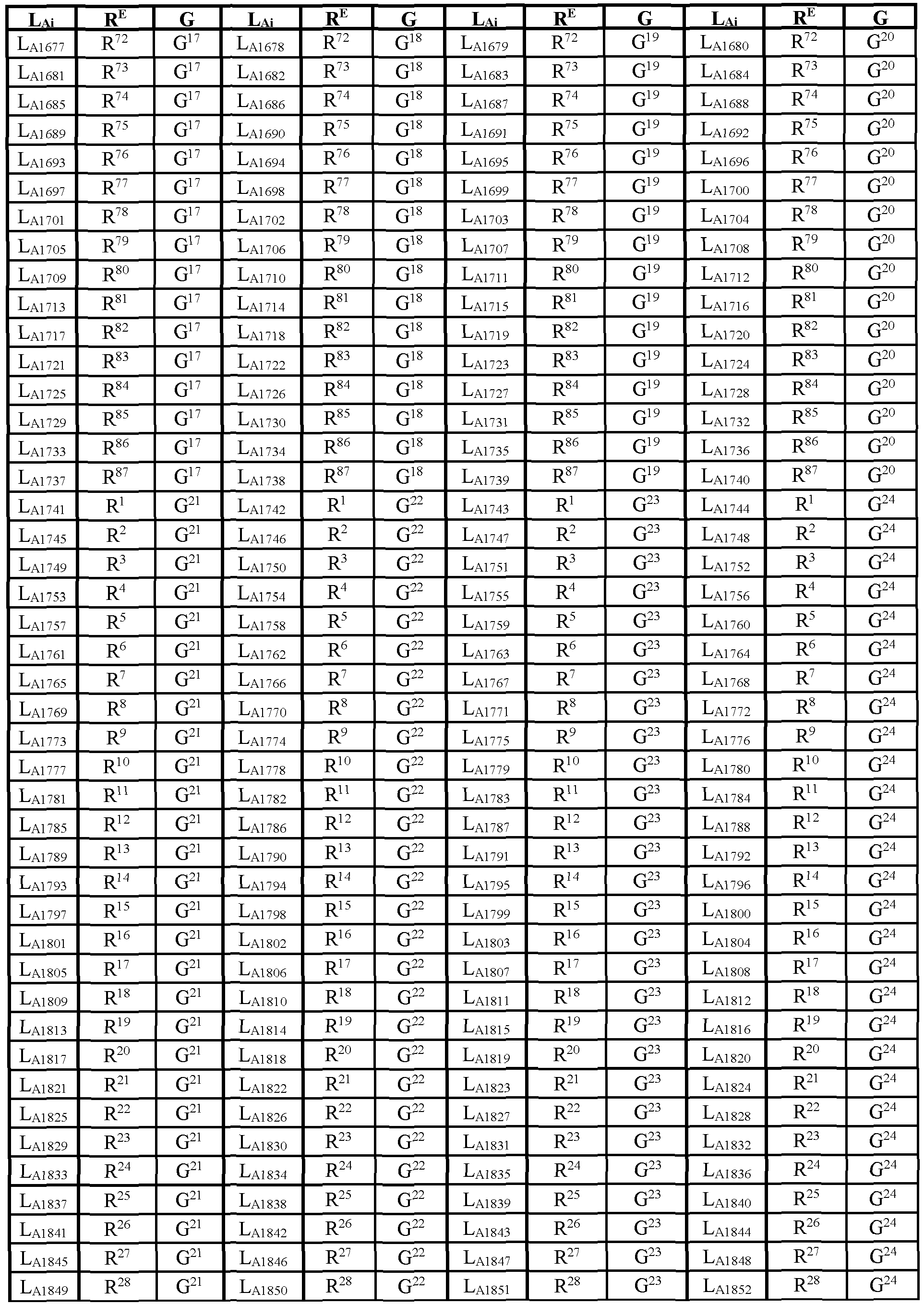 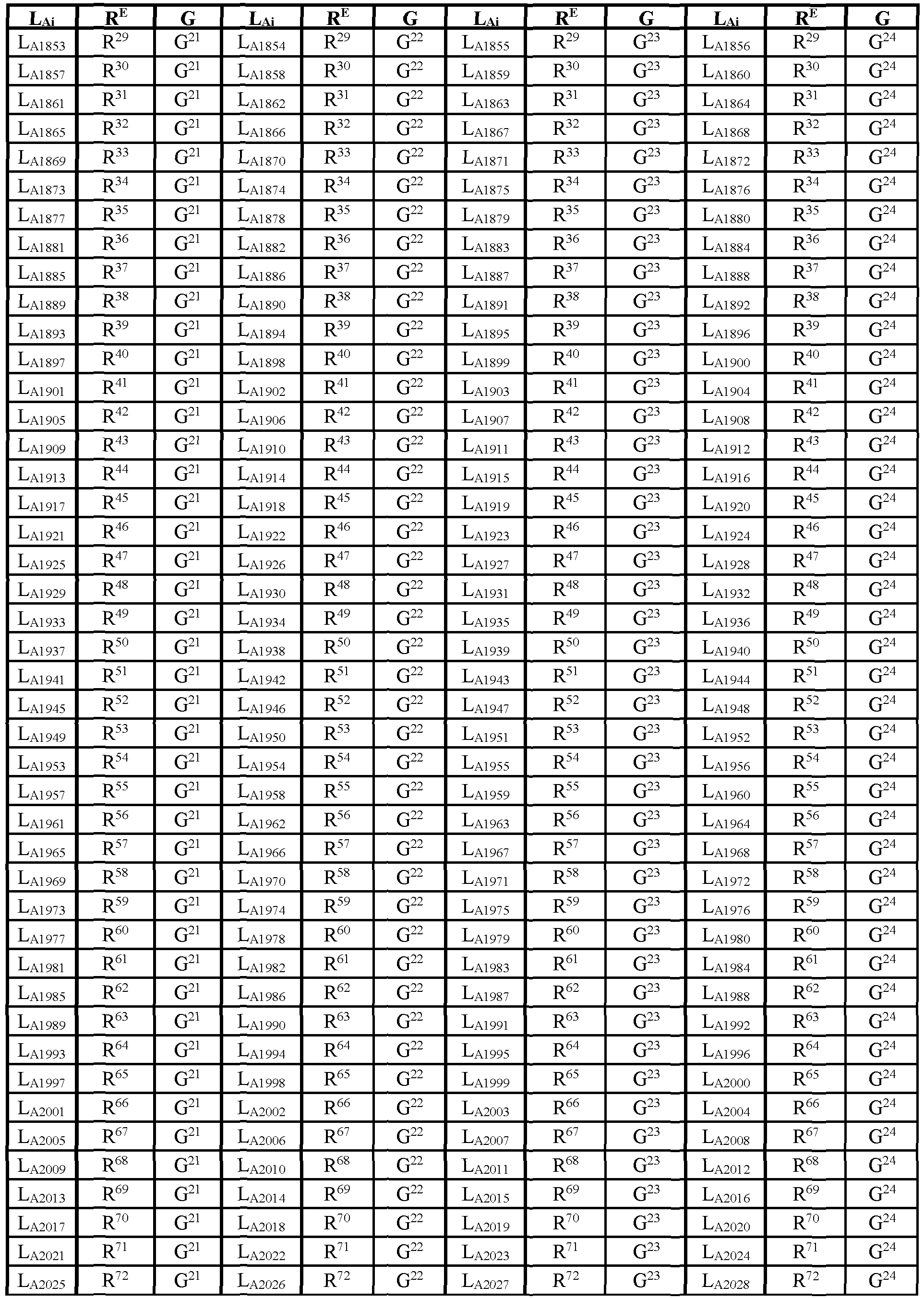 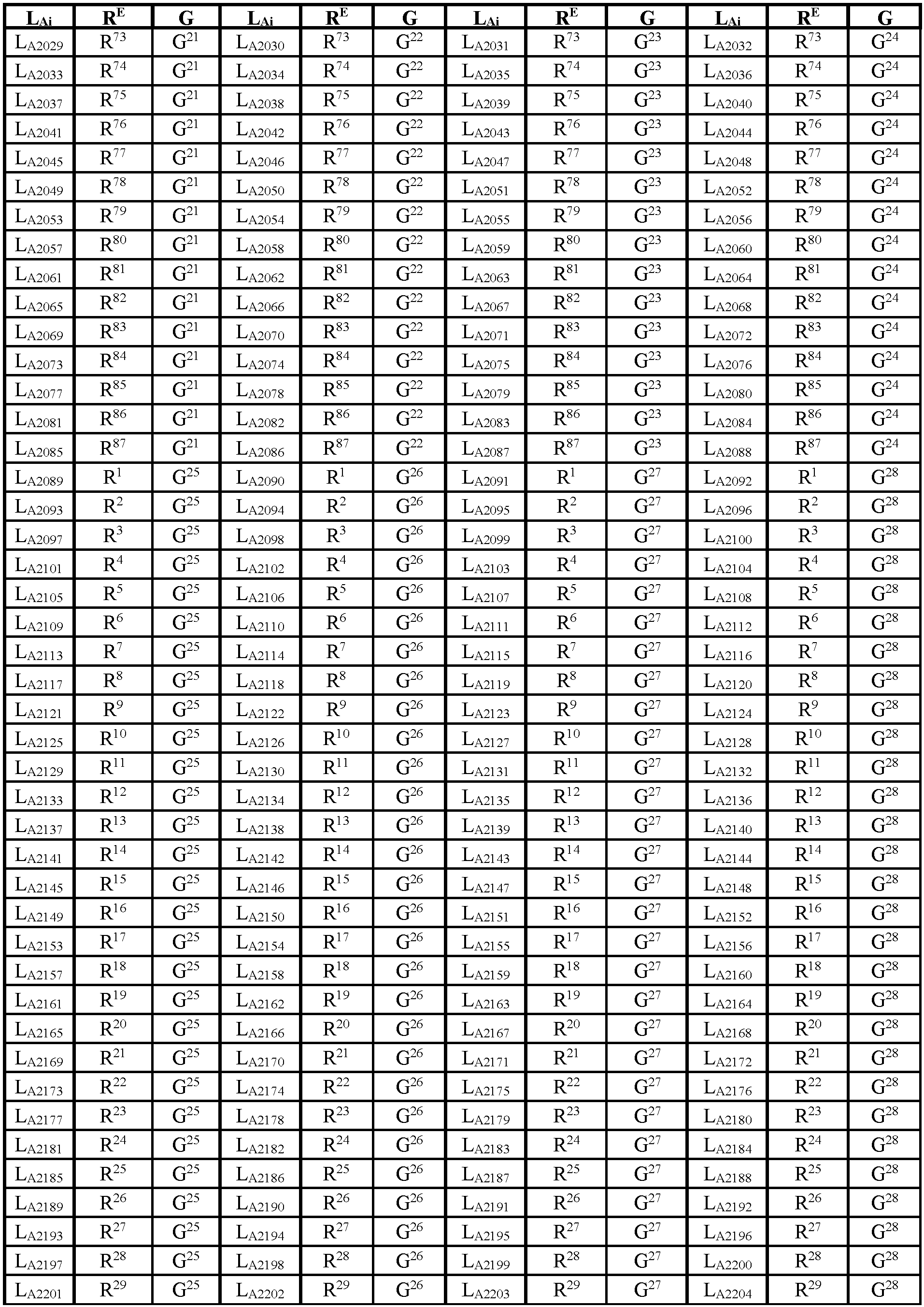 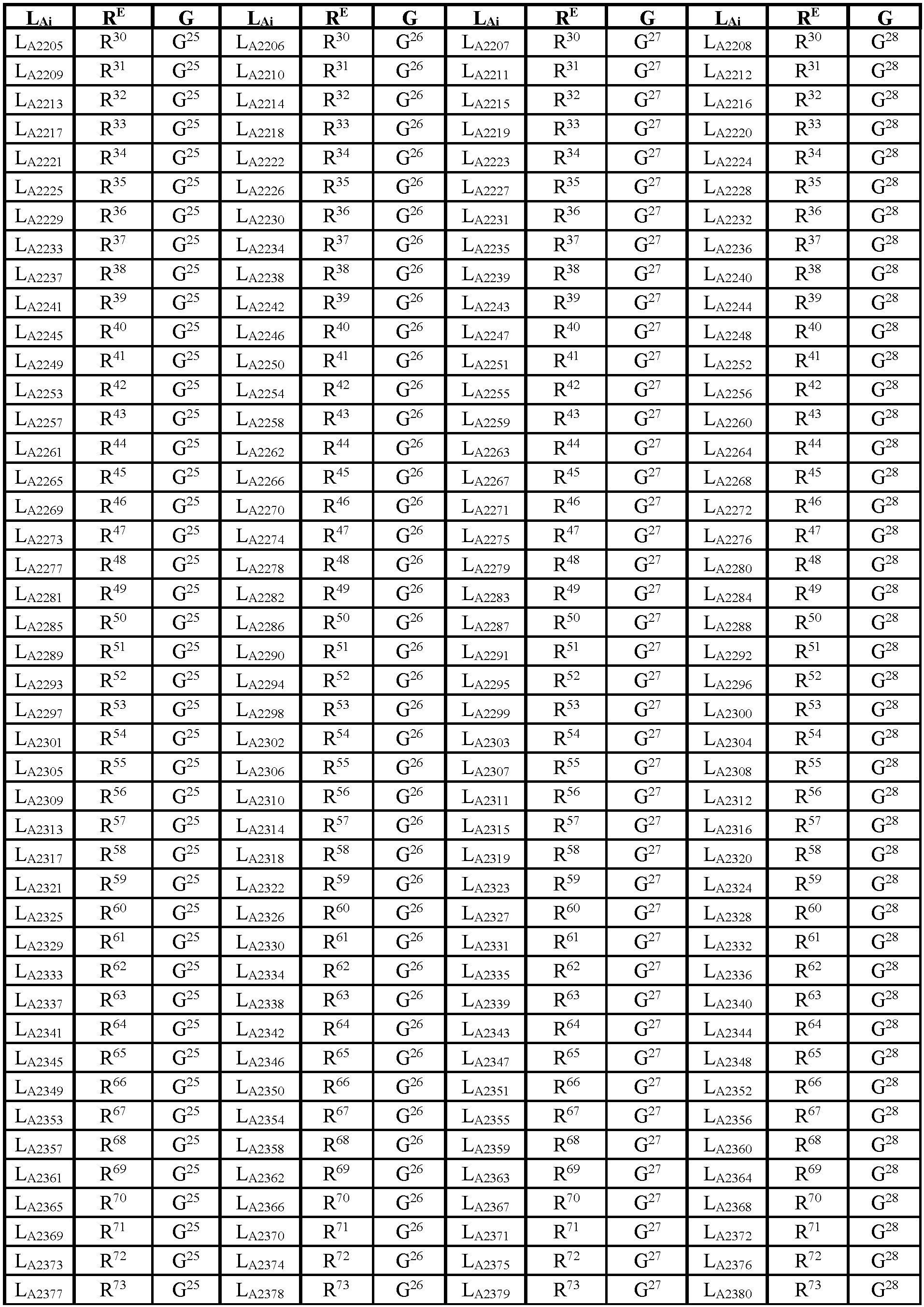 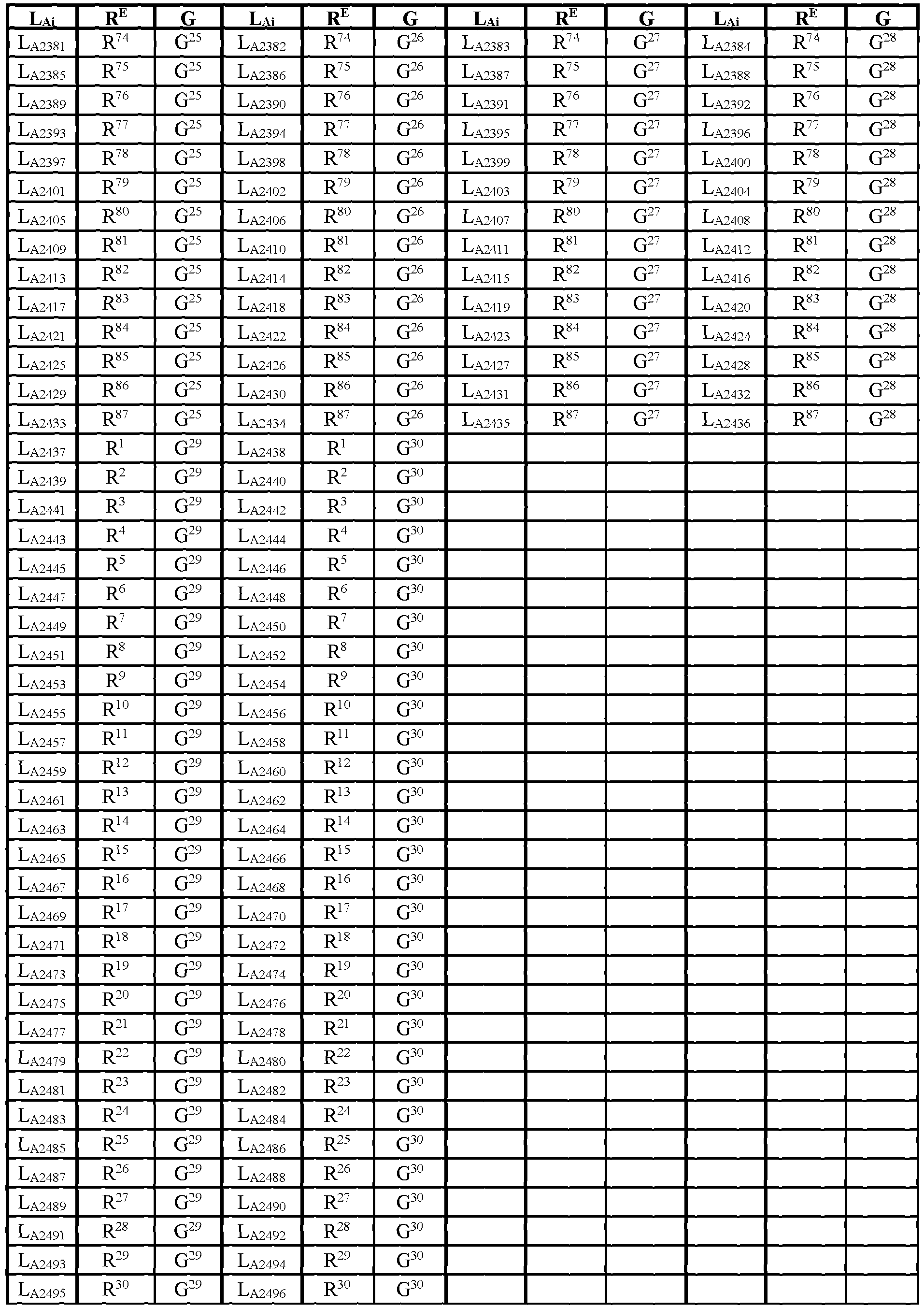 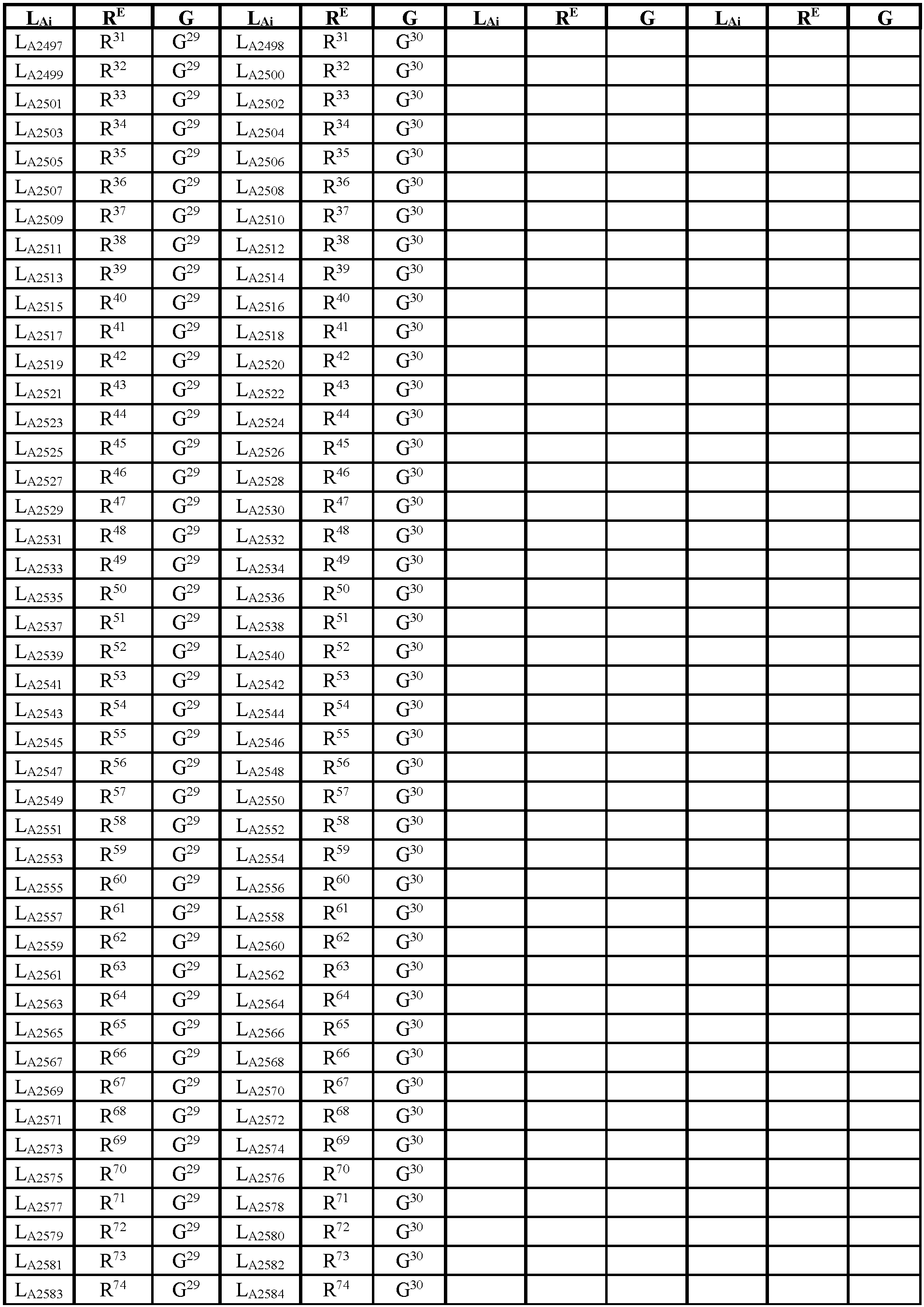 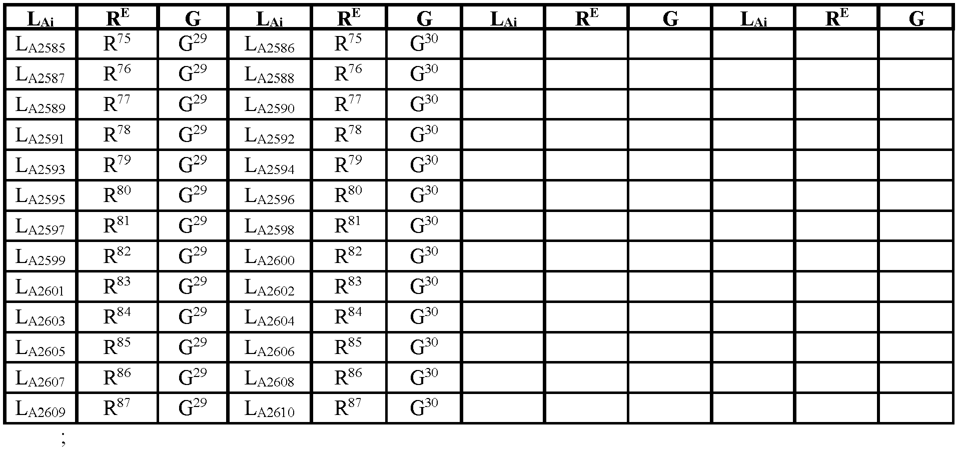 wobei jedes von R¹ bis R⁸⁷ die wie folgt definierte Struktur aufweist: 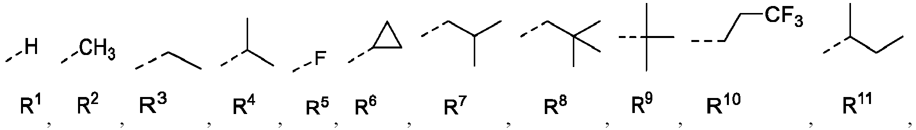 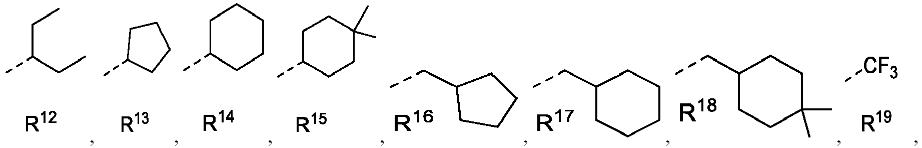 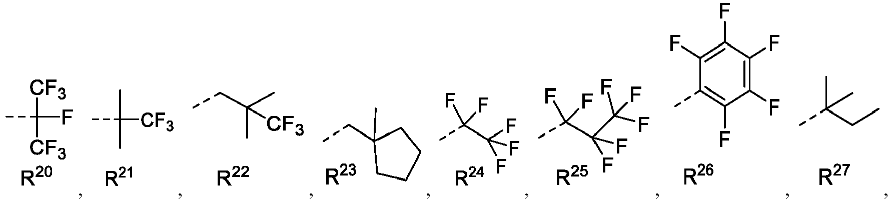 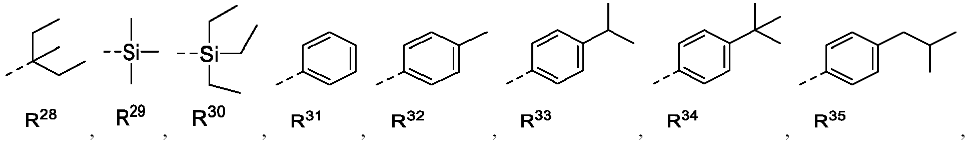 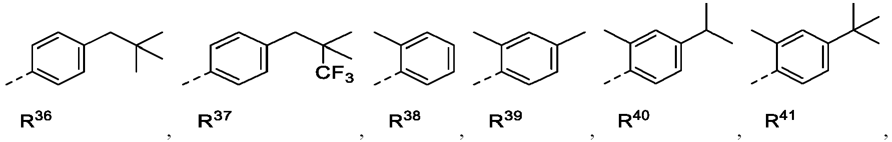 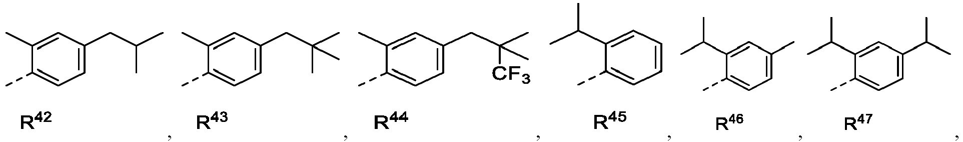 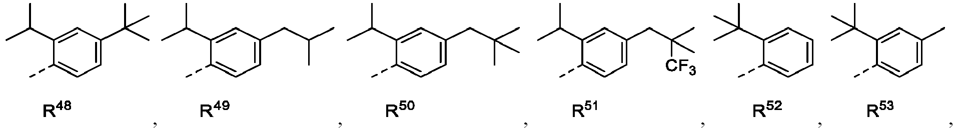 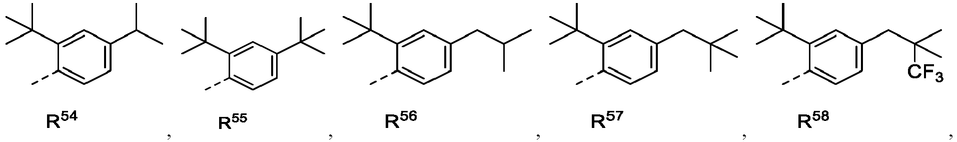 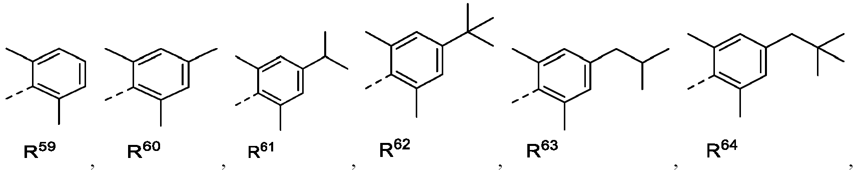 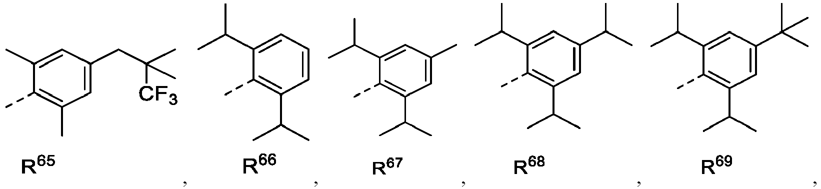 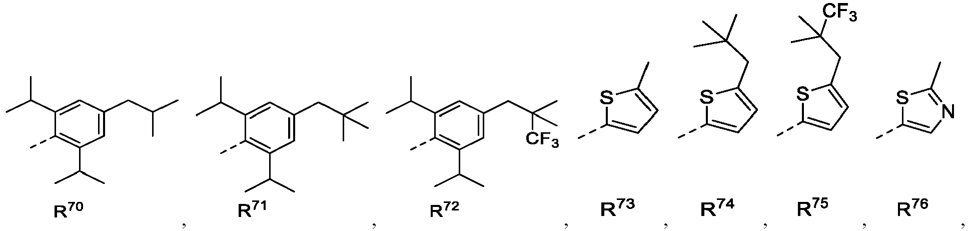 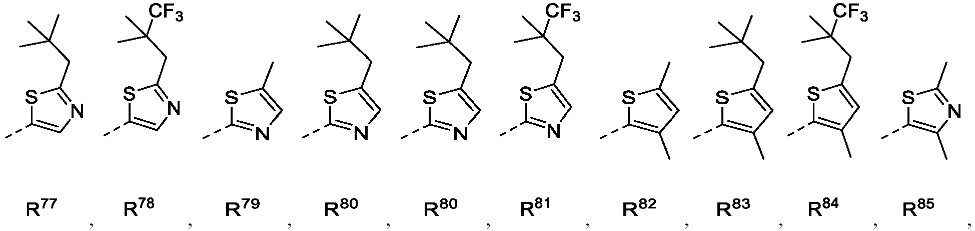 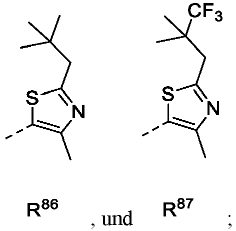 und
wobei jedes von G¹ bis G³⁰ die wie folgt definierte Struktur aufweist:

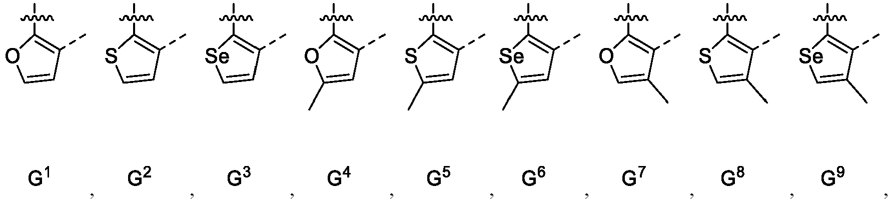

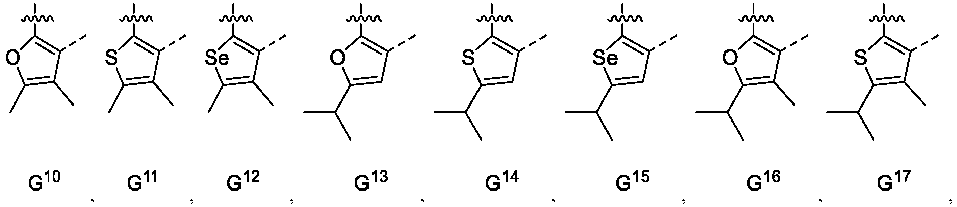

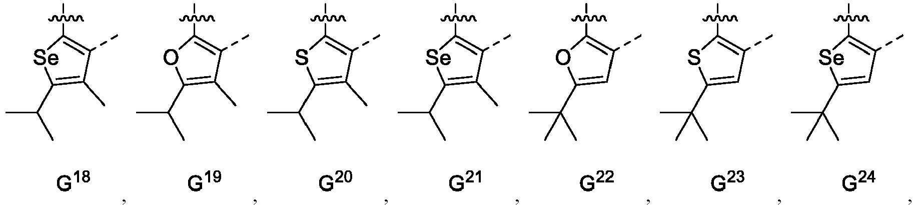

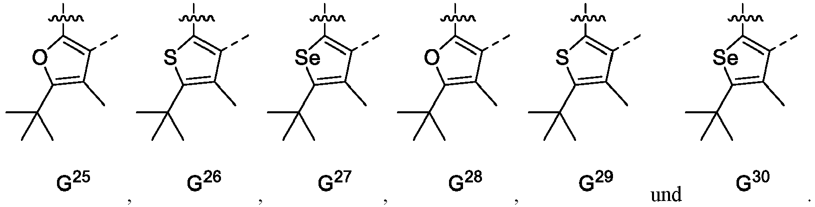

10. Verbindung nach einem der vorhergehenden Ansprüche, wobei die Verbindung eine Formel hat, die ausgewählt ist aus der Gruppe bestehend aus Ir(L_{A})₃, Ir(L_{A})(L _{B})₂, Ir(L _{A})₂(L_{B}), Ir(L _{A})₂(L_{C}) und Ir(L_{A})(L_{B})(L_{C}); wobei L_{B} und Lc jeweils ein zweizähniger Ligand sind und L_{A}, L_{B} und Lc voneinander verschieden sind; oder die Verbindung die Formel Pt(L_{A})(L_{B}) hat und wobei L_{A} und L_{B} gleich oder verschieden sein können.

11. Verbindung nach einem der vorhergehenden Ansprüche, wobei die Verbindung die Formel M(L_{A})ₚ(L_{B})_{q}(L_{C})ᵣ hat, wobei L_{B} und L_{C} jeweils ein zweizähniger Ligand sind; und wobei p 1, 2 oder 3 ist; q 0, 1 oder 2 ist; r 0, 1 oder 2 ist; und p+q+r die Oxidationsstufe des Metalls M ist, wobei L_{B} und L_{C} jeweils unabhängig voneinander ausgewählt sind aus der Gruppe bestehend aus: 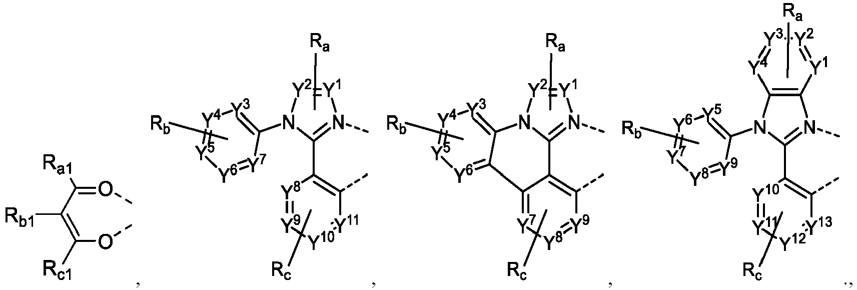 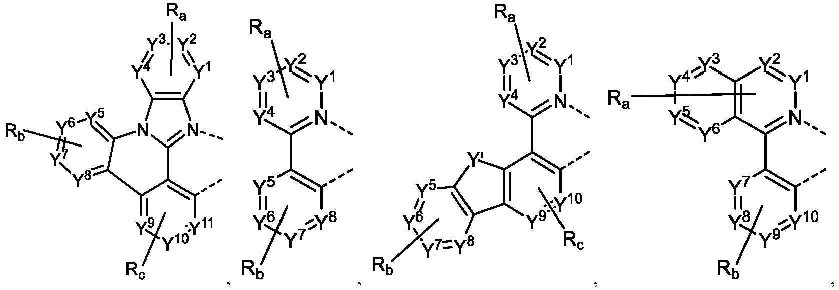 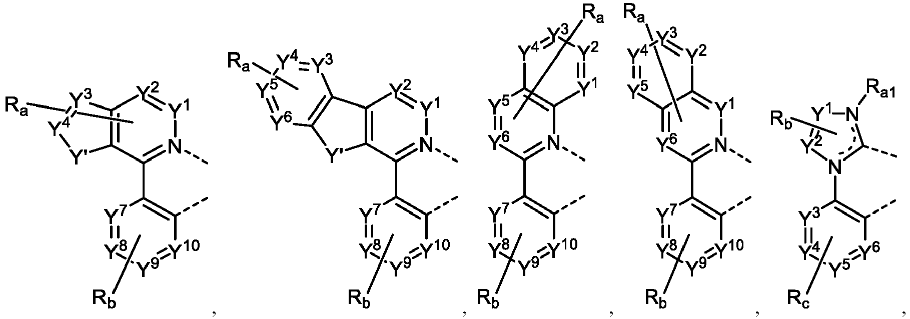 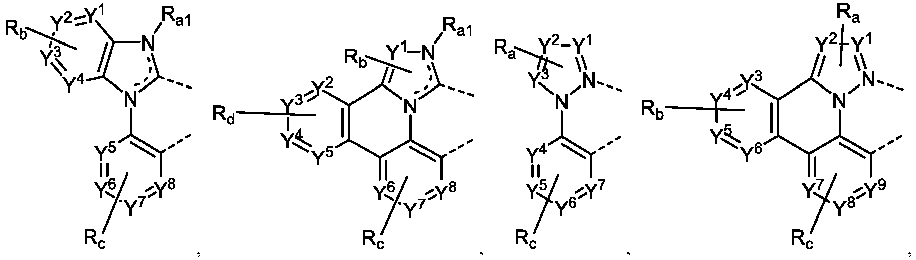 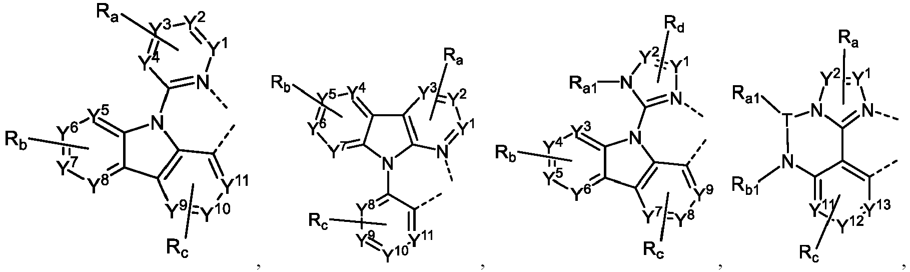 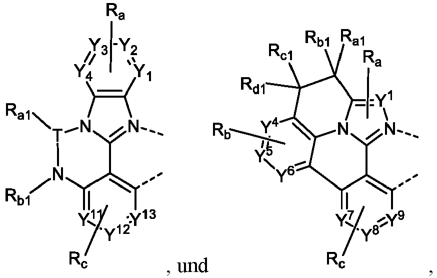 wobei:
T ausgewählt ist aus der Gruppe bestehend aus B, Al, Ga und In;
jeder der Reste Y¹ bis Y¹³ unabhängig voneinander aus der Gruppe ausgewählt ist, die aus Kohlenstoff und Stickstoff besteht;
Y' ausgewählt ist aus der Gruppe bestehend aus BRₑ, NRₑ, PRₑ, O, S, Se, C=O, S=O, SO₂, CRₑR_{f}, SiRₑR_{f}, und GeRₑR_{f};
jedes Rₐ, R_{b}, R_{c} und R_{d} unabhängig voneinander keine, Mono- oder bis zu einer maximal zulässigen Anzahl von Substitutionen darstellt;
jeder der Reste Rₐ₁, R_{b1}, R_{c1}, R_{d1}, Rₐ, R_{b}, R_{c}, R_{d}, Rₑ und R_{f} unabhängig ein Wasserstoffatom oder ein Substituent ist, der aus der Gruppe ausgewählt ist, die aus den hier definierten Allgemeinen Substituenten (General Substituents) besteht; und
zwei beliebige benachbarte Rₐ, R_{b}, R_{c}, R_{d}, Rₑ und R_{f} kondensiert oder verbunden sein können, um einen Ring zu bilden oder einen mehrzähnigen Liganden zu bilden.

12. Verbindung nach Anspruch 9, wobei, wenn die Verbindung die Formel Ir(L_{A*i-m-X*})₃ hat, *i* eine ganze Zahl von 1 bis 2610 ist; *m* eine ganze Zahl von 1 bis 108 ist; und die Verbindung ausgewählt ist aus der Gruppe bestehend aus Ir(L_{A*1-1-1*})₃ bis Ir(L_{A*2610-108-3*})₃;
wenn die Verbindung die Formel Ir(L_{A*i-m*-*X*})(L _{B*k*})₂ hat, *i* eine ganze Zahl von 1 bis 2610 ist; *m* eine ganze Zahl von 1 bis 108 ist; *k* eine ganze Zahl von 1 bis 324 ist; und die Verbindung ausgewählt ist aus der Gruppe bestehend aus Ir(L_{A*1-1-1*})(L_{B*1*})₂ bis Ir(L_{A*2610-108-3*})(L_{B*324*})₂;
wenn die Verbindung die Formel Ir(L_{A*i-m-X*})₂(L_{B*k*}) hat, *i* eine ganze Zahl von 1 bis 2610 ist; *m* eine ganze Zahl von 1 bis 108 ist; *k* eine ganze Zahl von 1 bis 324 ist; und die Verbindung ausgewählt ist aus der Gruppe bestehend aus Ir(L_{A*1-1-1*})₂(L_{B*1*}) bis Ir(L_{A*2610-108-3*})₂(L_{B*324*});
wenn die Verbindung die Formel Ir(L _{A*i-m-X*})₂(L_{C*j-*I}) hat, *i* eine ganze Zahl von 1 bis 2610 ist; *m* eine ganze Zahl von 1 bis 108 ist; *j* eine ganze Zahl von 1 bis 1416 ist; und die Verbindung ausgewählt ist aus der Gruppe bestehend aus Ir(L_{A*1-1-1*})₂(L_{C*1*-I}) bis Ir(L_{A*2610-108-3*})₂(L_{C*1416*-I}); und
wenn die Verbindung die Formel Ir(L_{A*i-m-X*})₂(L_{C*j*-II}) hat, *i* eine ganze Zahl von 1 bis 2610 ist; *m* eine ganze Zahl von 1 bis 108 ist; *j* eine ganze Zahl von 1 bis 1416 ist; und die Verbindung ausgewählt ist aus der Gruppe bestehend aus Ir(L_{A*1-1-1*})₂(L_{C*1*-II}) bis Ir(L_{A*2610-108-3*})₂(L_{C*1416*-II});
wobei jedes L_{B*k*} von L_{B1} bis L_{B324} die wie folgt definierte Struktur aufweist: 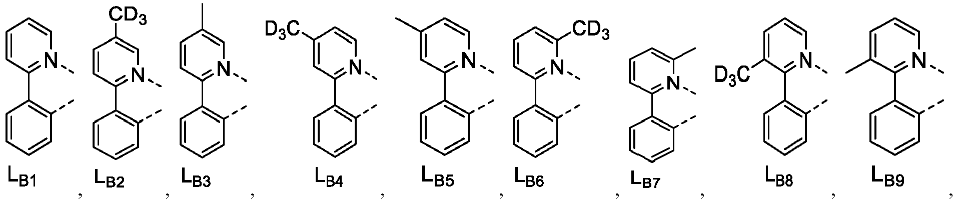 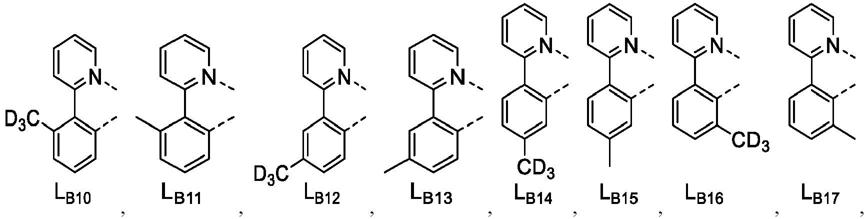 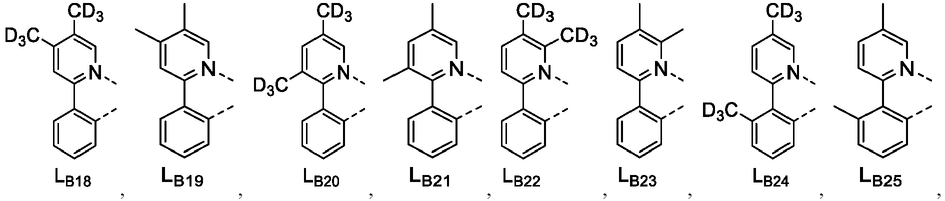 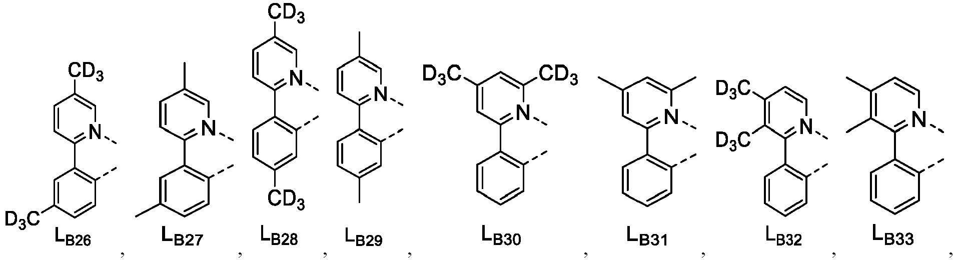 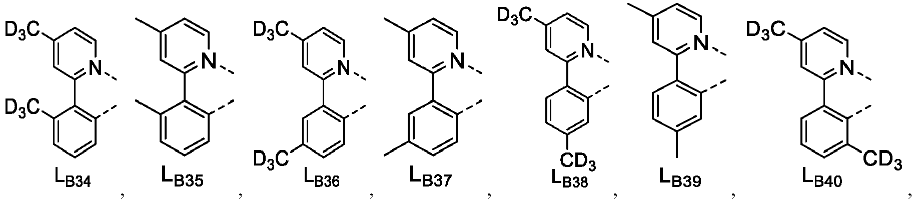 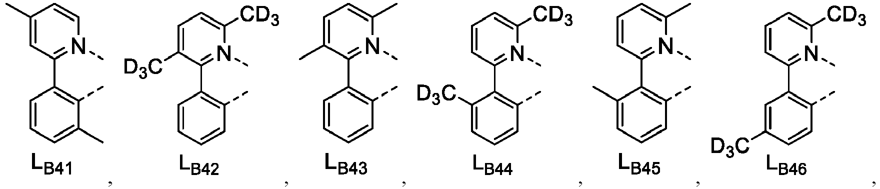 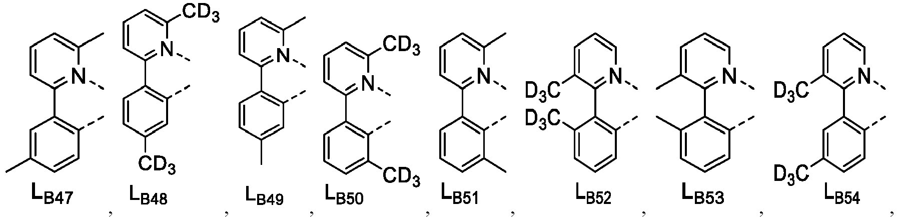 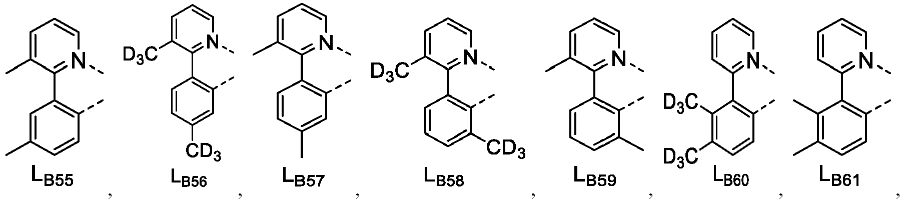 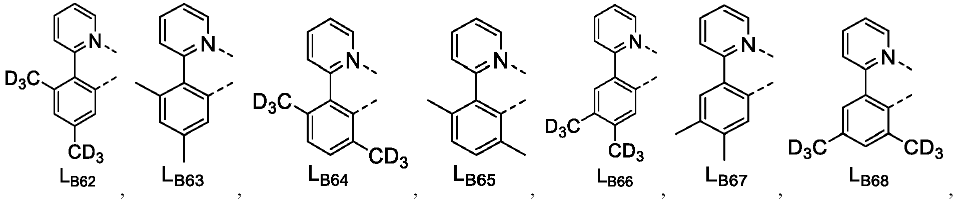 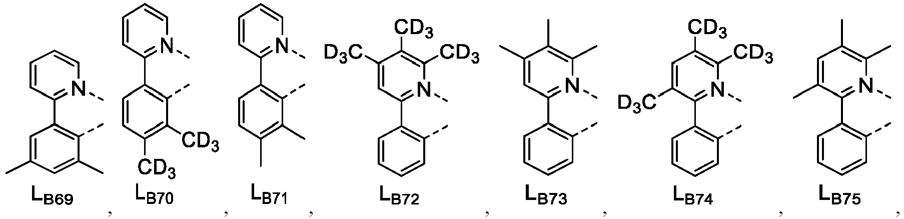 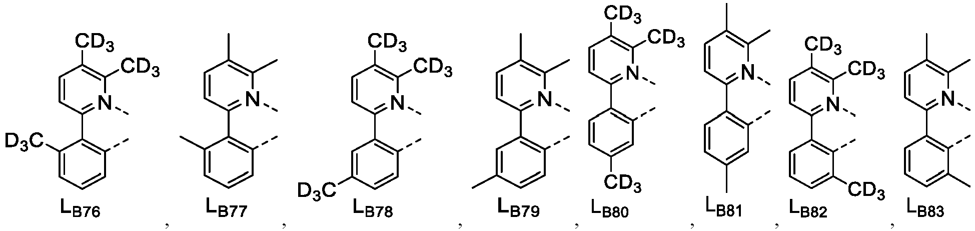 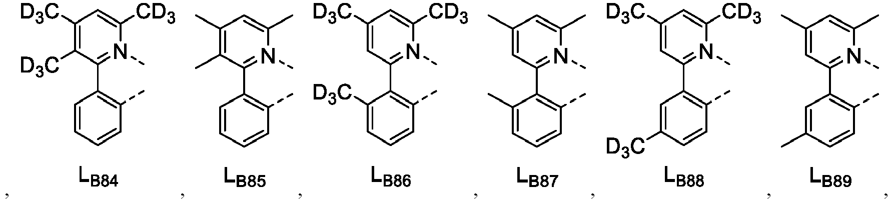 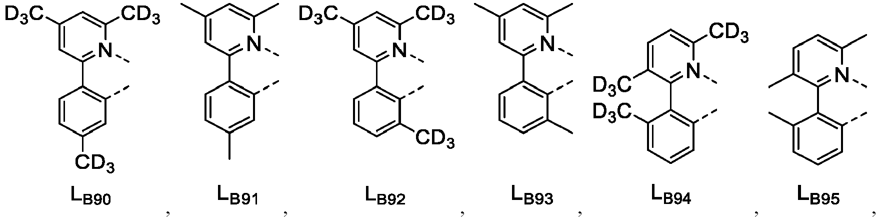 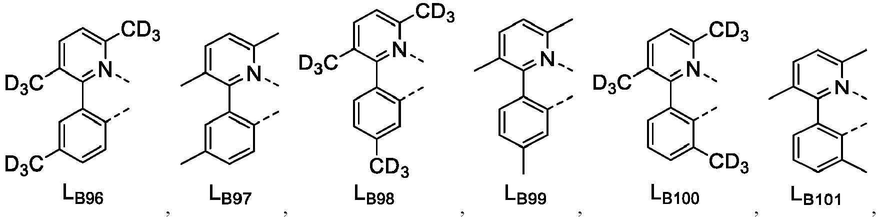 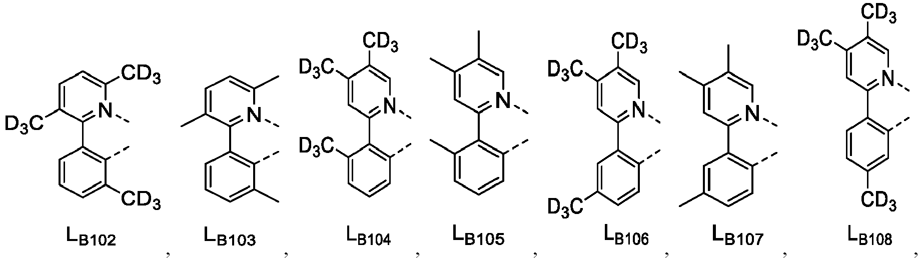 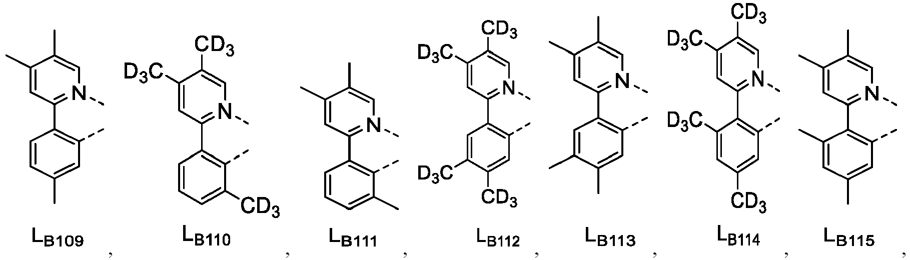 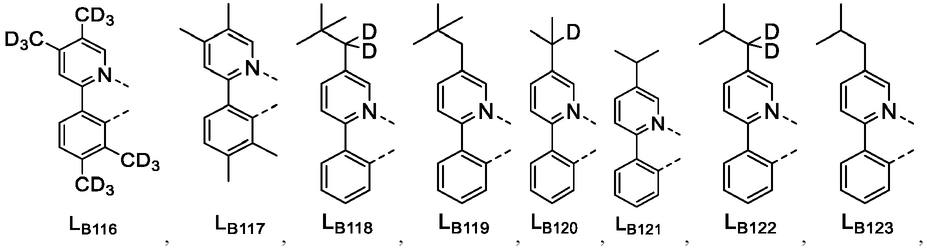 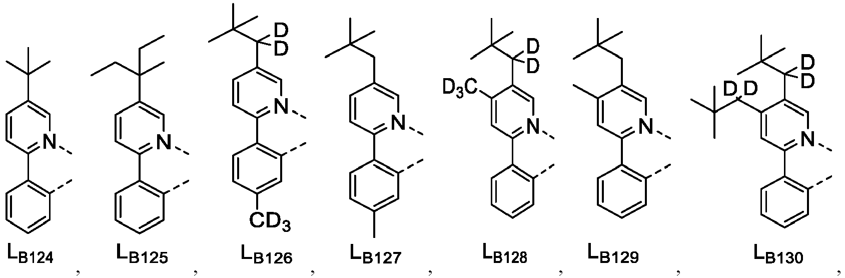 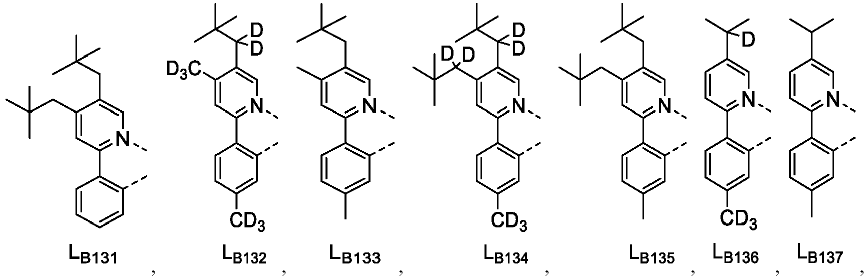 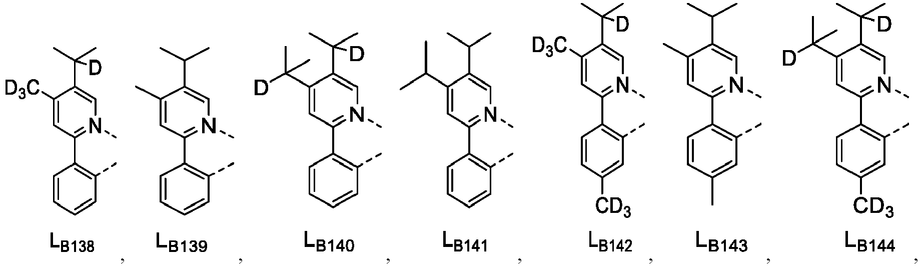 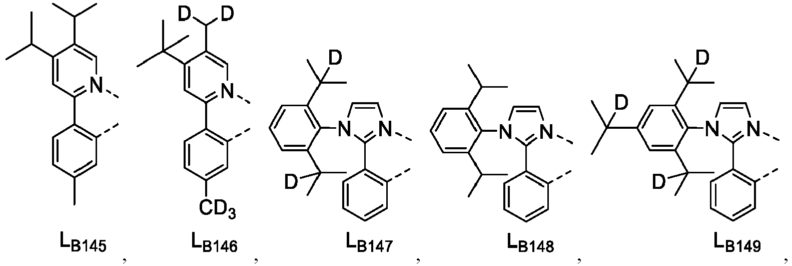 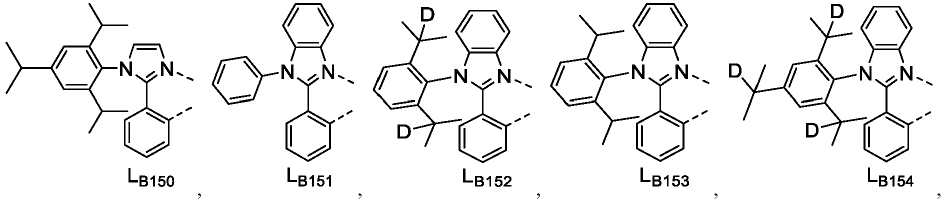 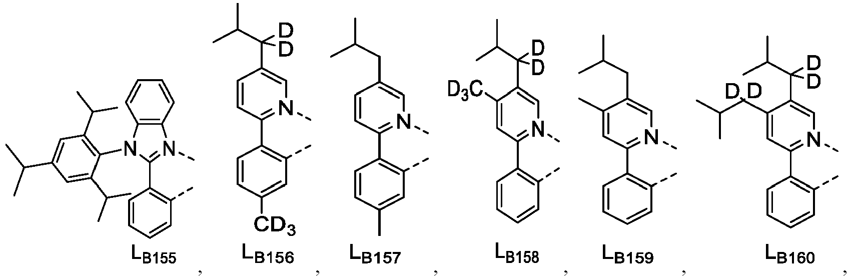 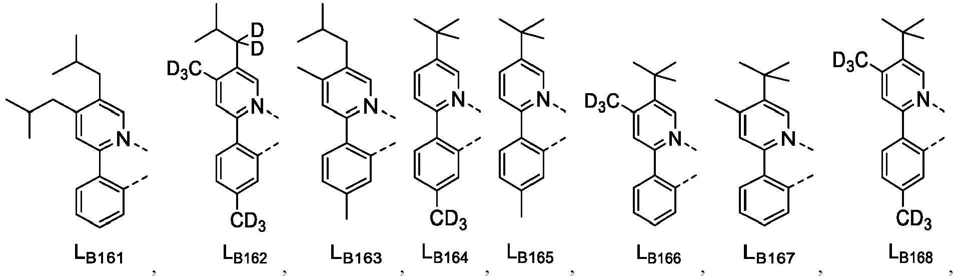 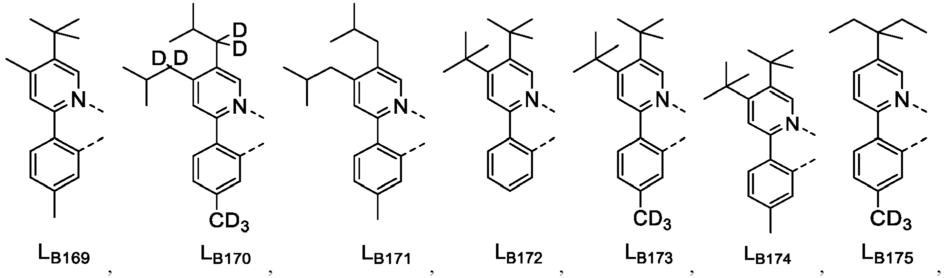 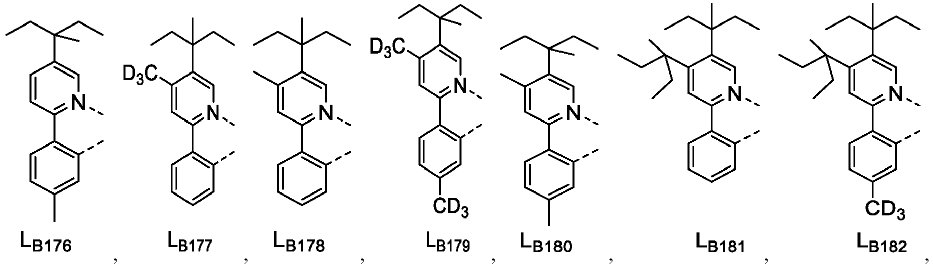 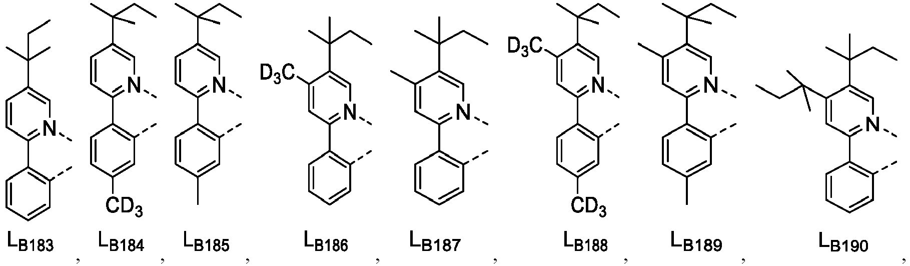 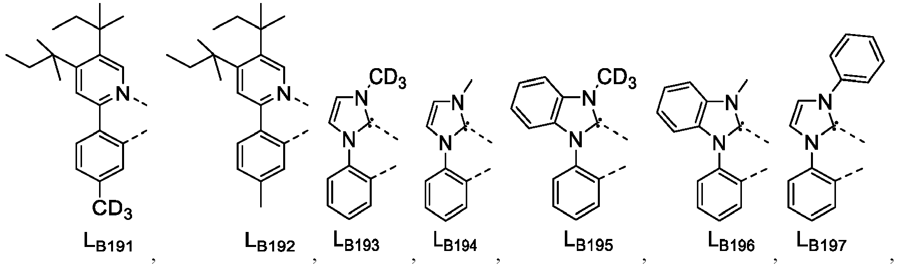 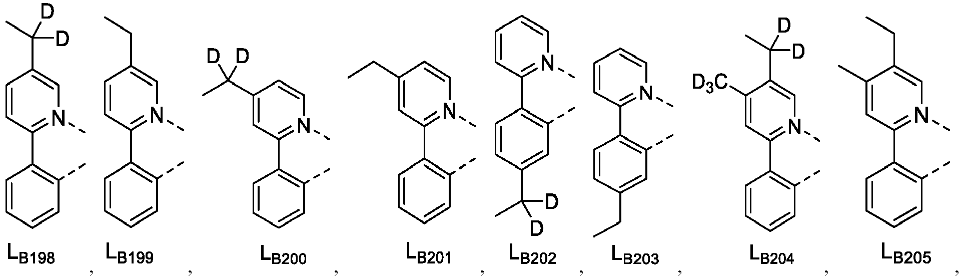 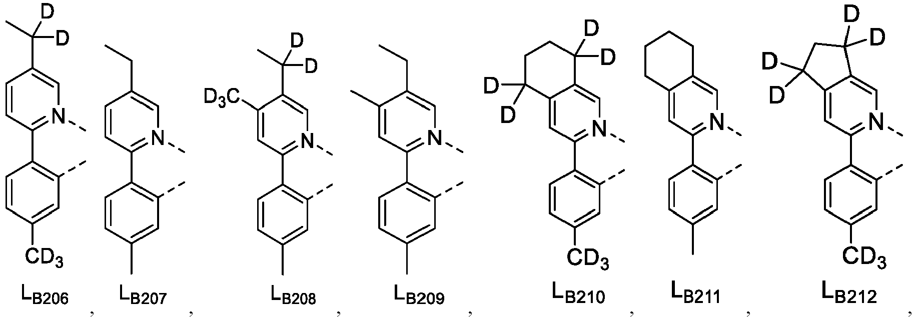 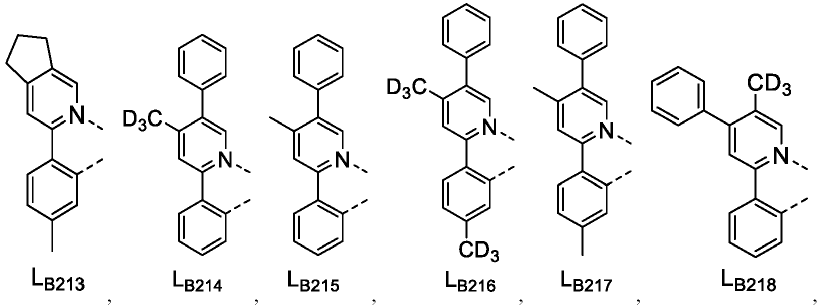 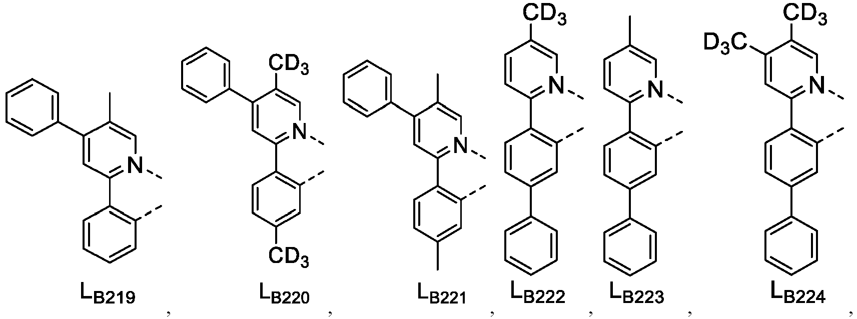 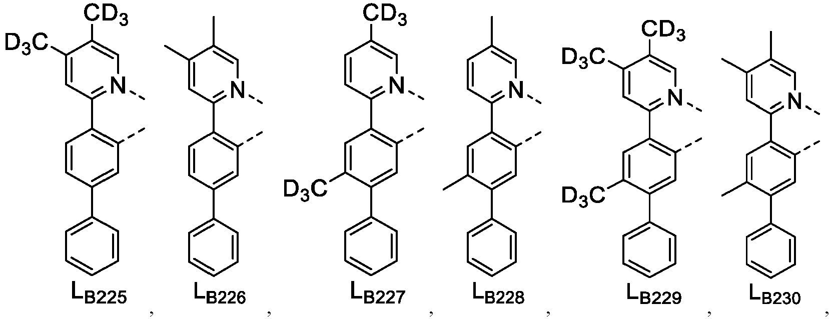 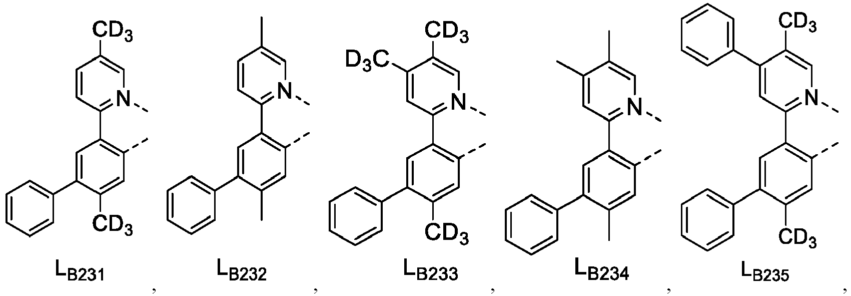 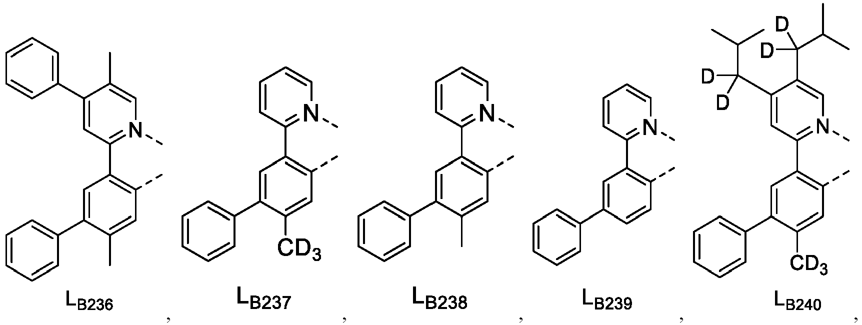 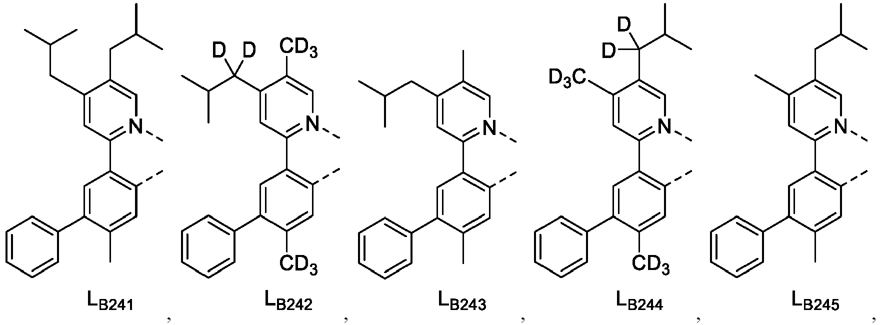 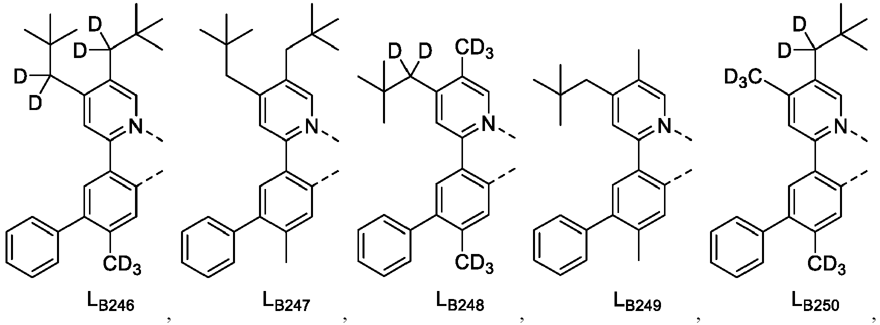 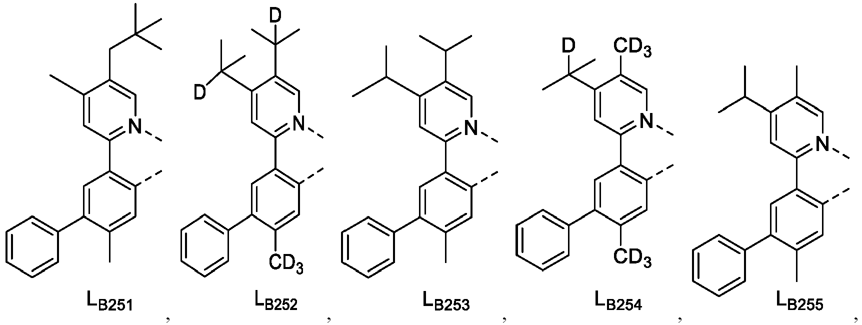 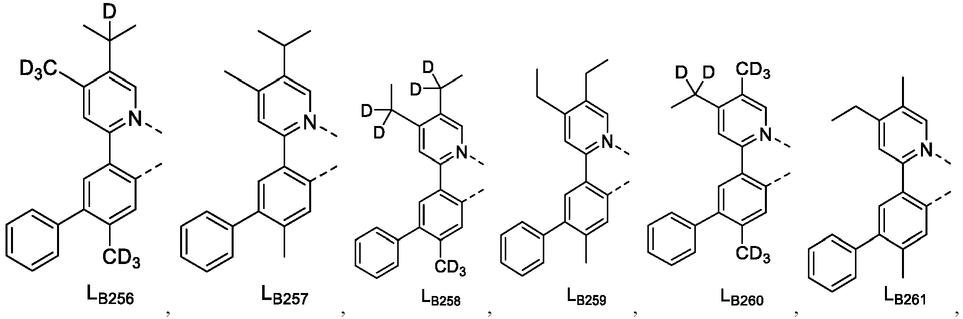 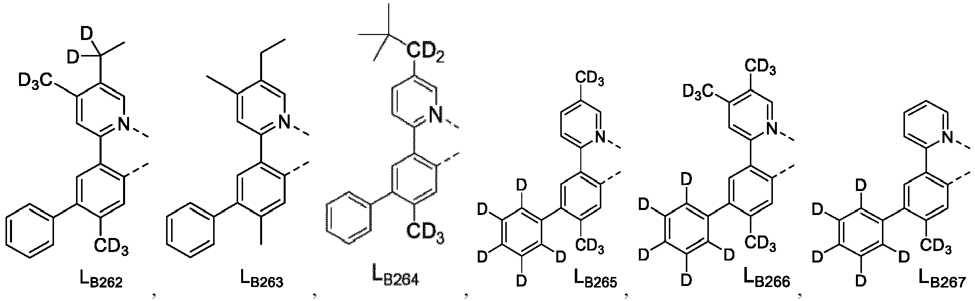 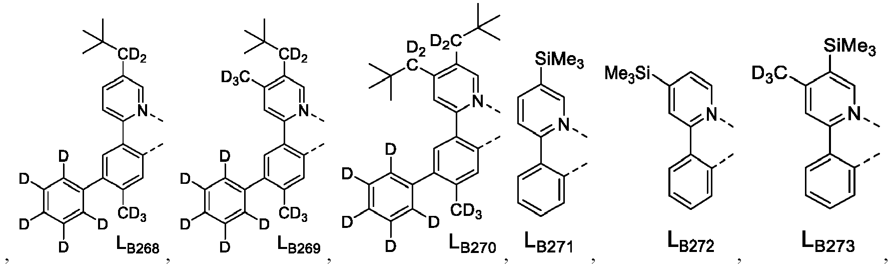 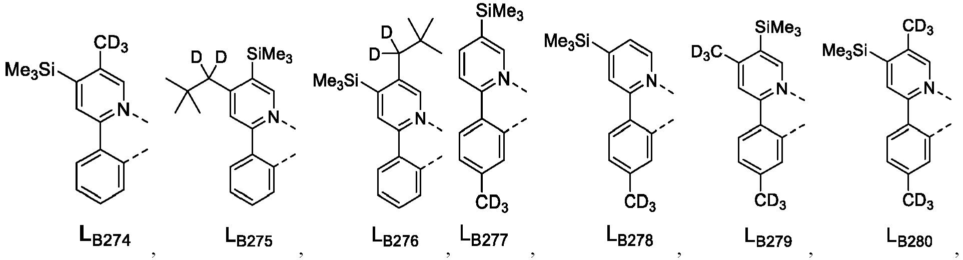 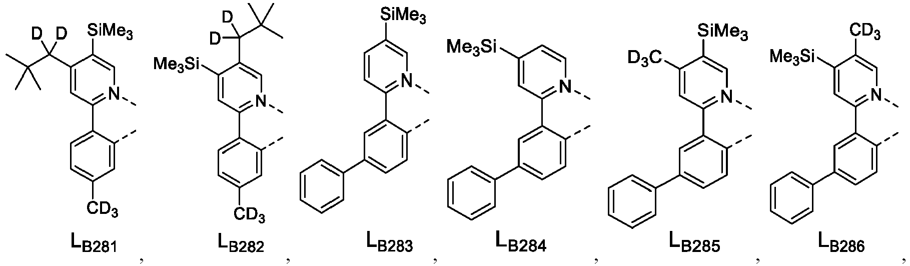 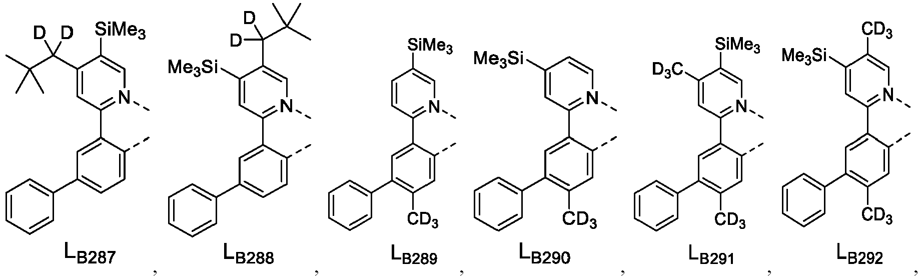 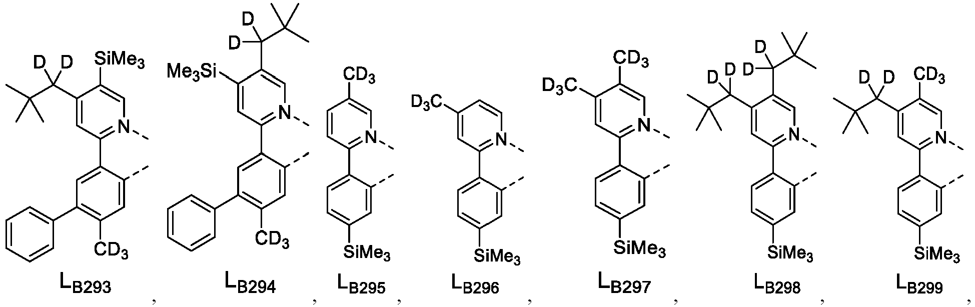 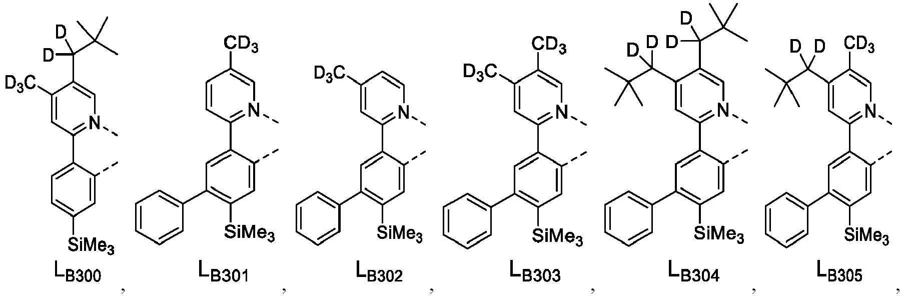 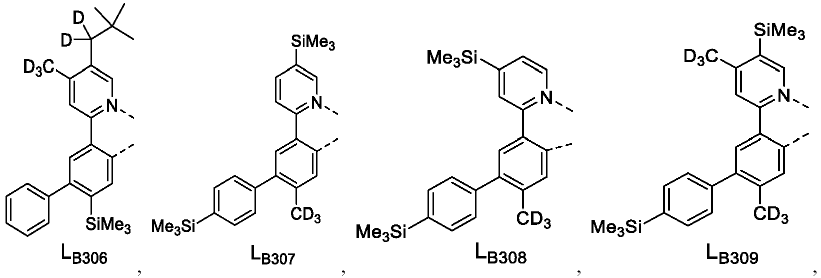 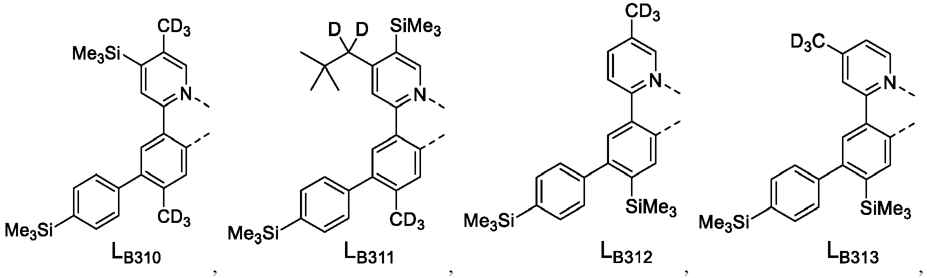 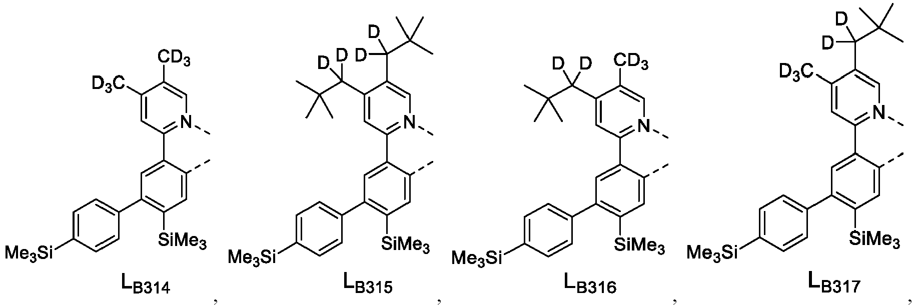 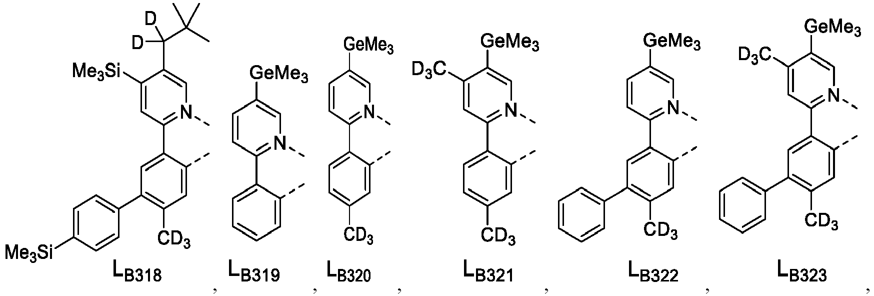 und 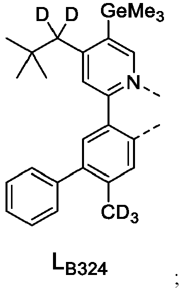
wobei jedes L_{C*j*-I} eine Struktur basierend auf der Formel 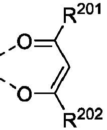 hat; und jedes L_{C*j*-II} eine Struktur basierend auf der Formel 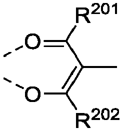 aufweist, wobei für jedes L_{C*j*} in L_{C*j*-I} und L_{C*j*-II} die R²⁰¹ und R²⁰² jeweils unabhängig voneinander wie folgt definiert sind: 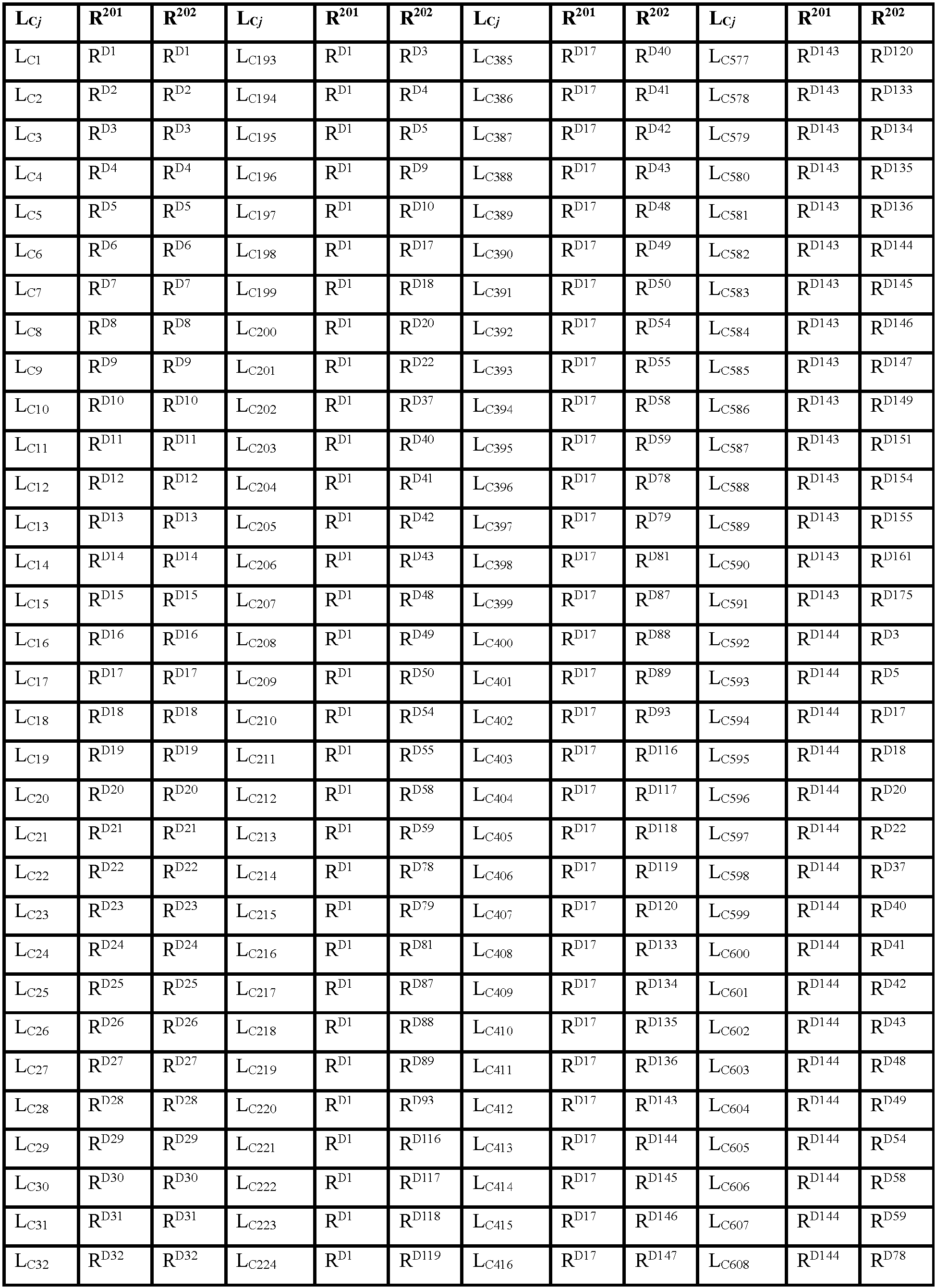 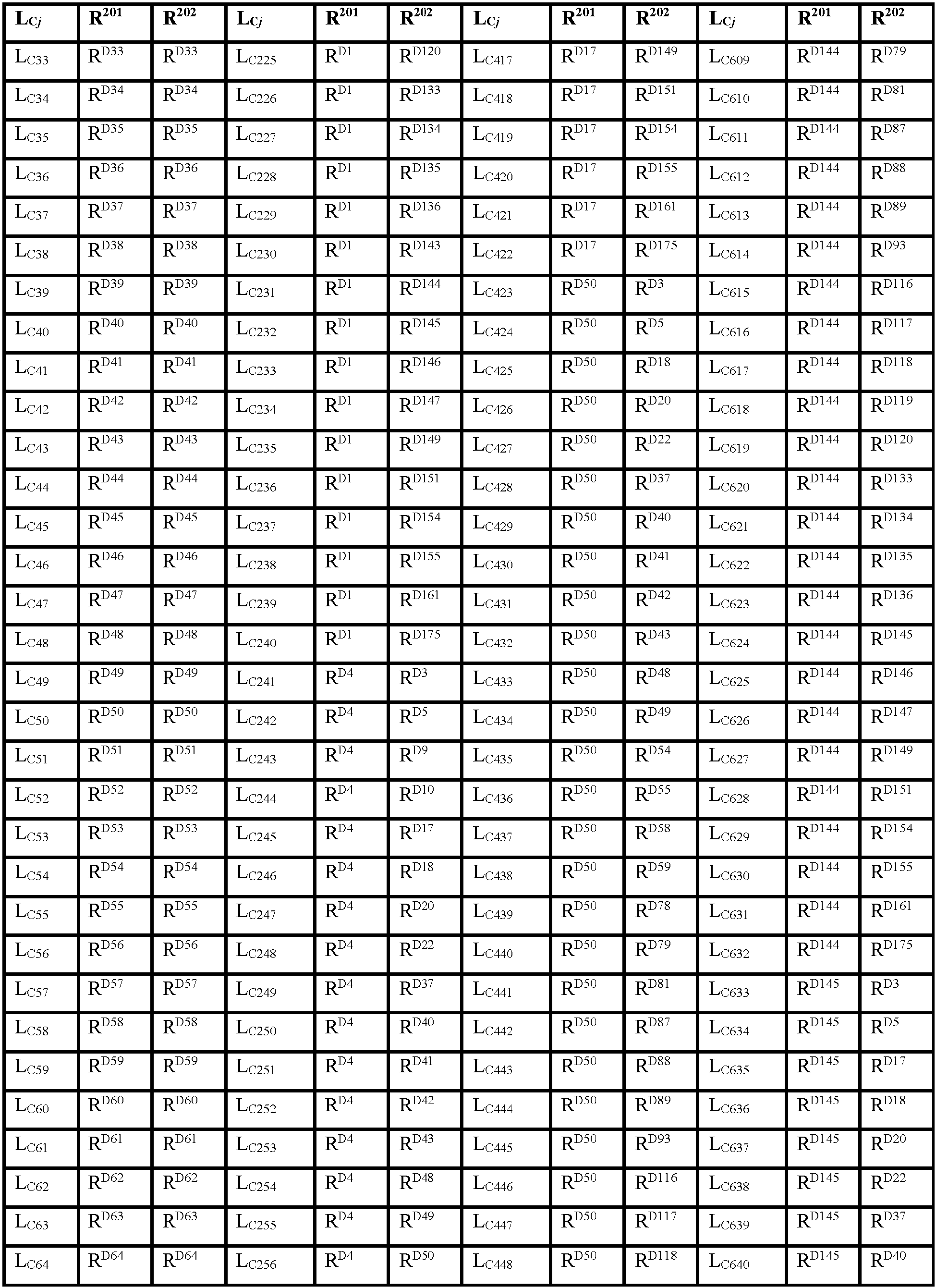 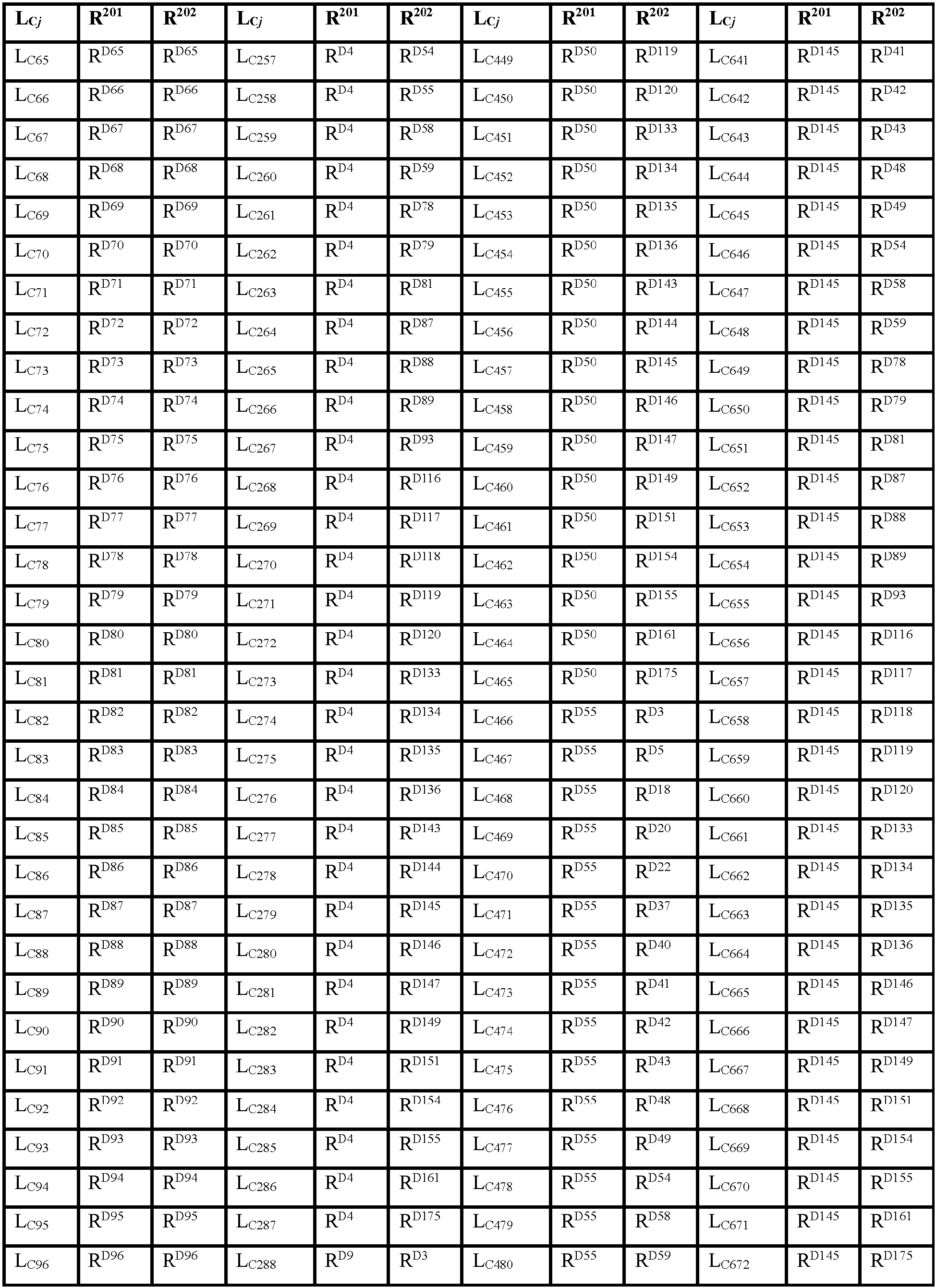 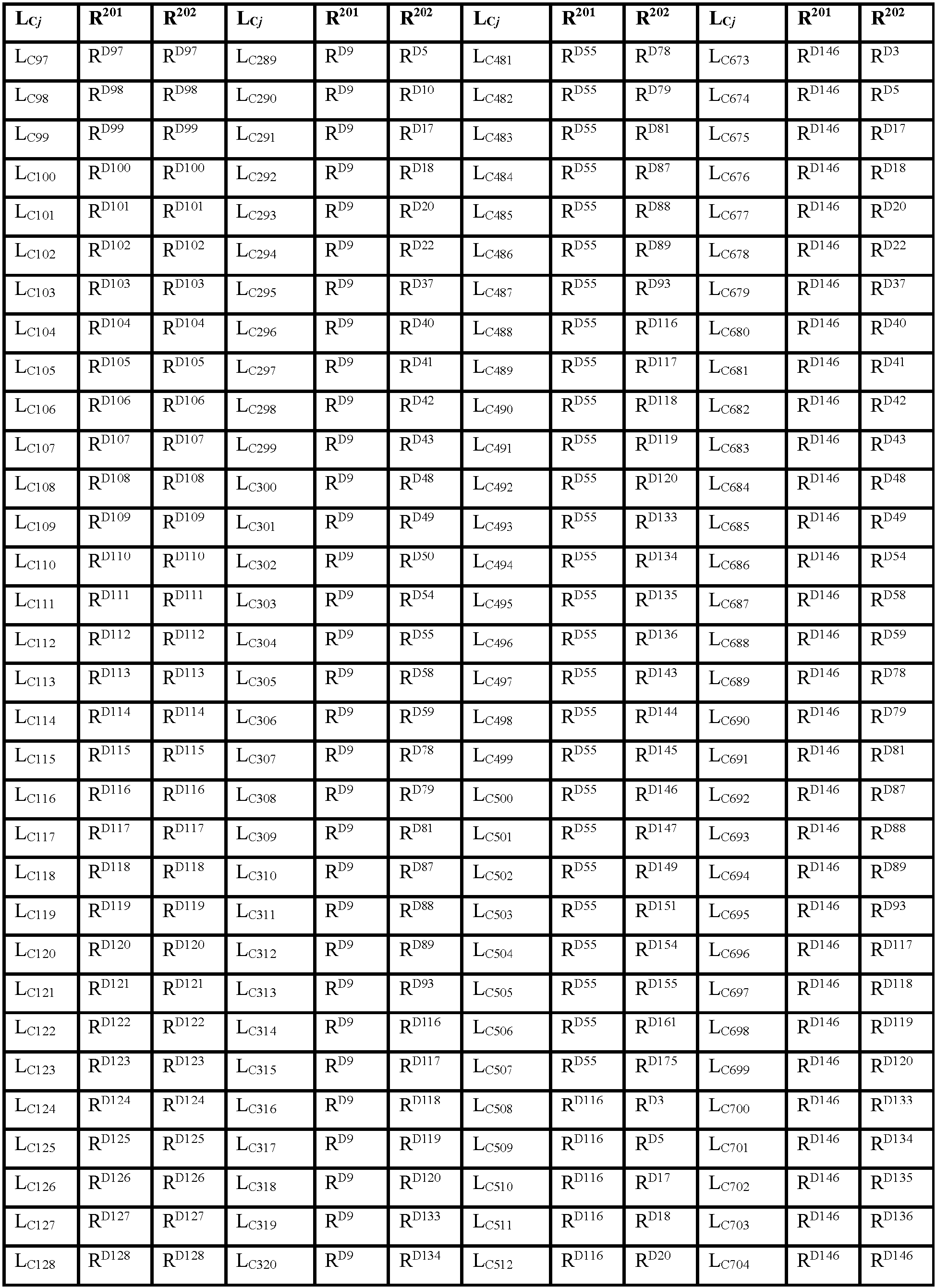 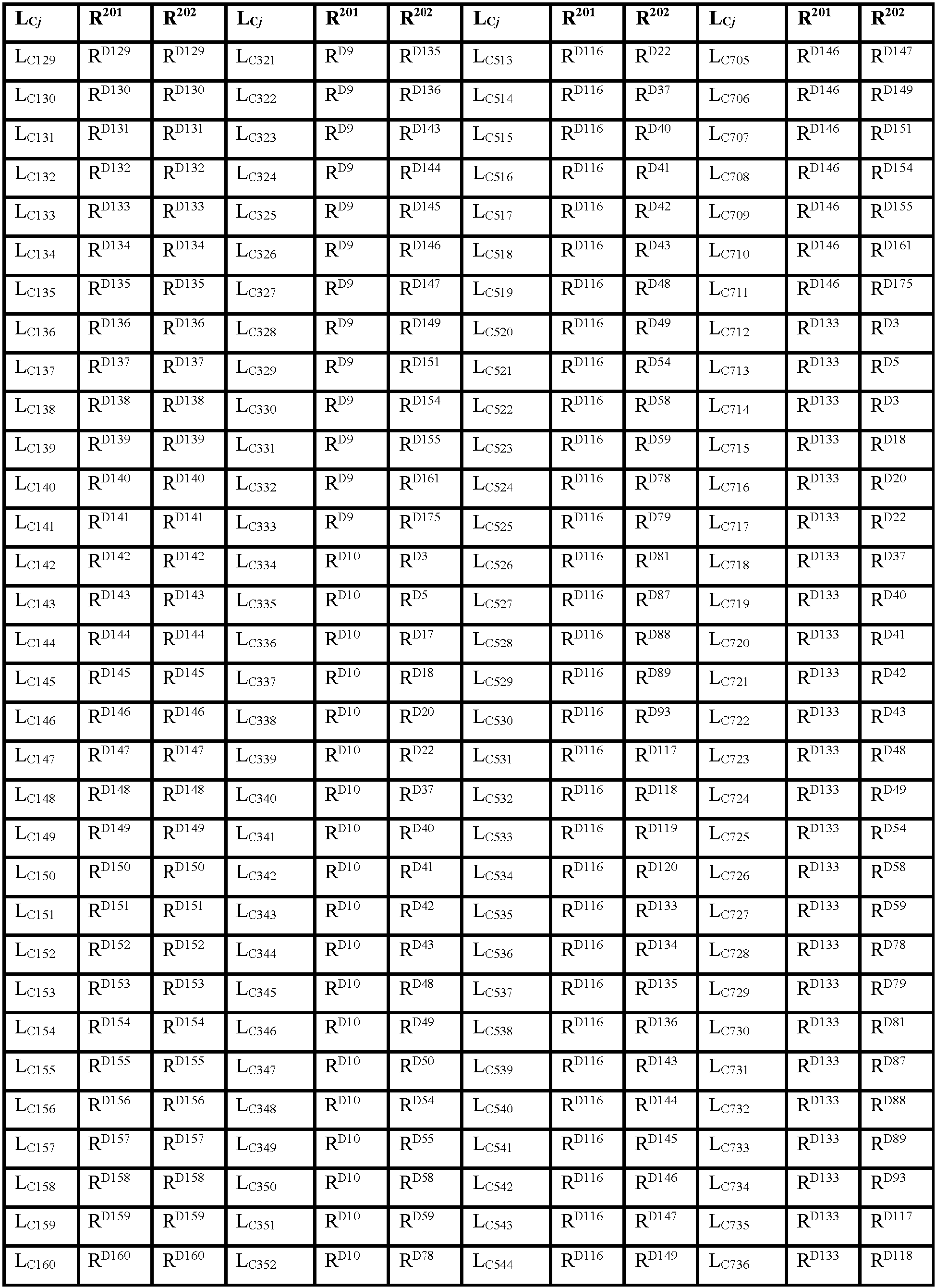 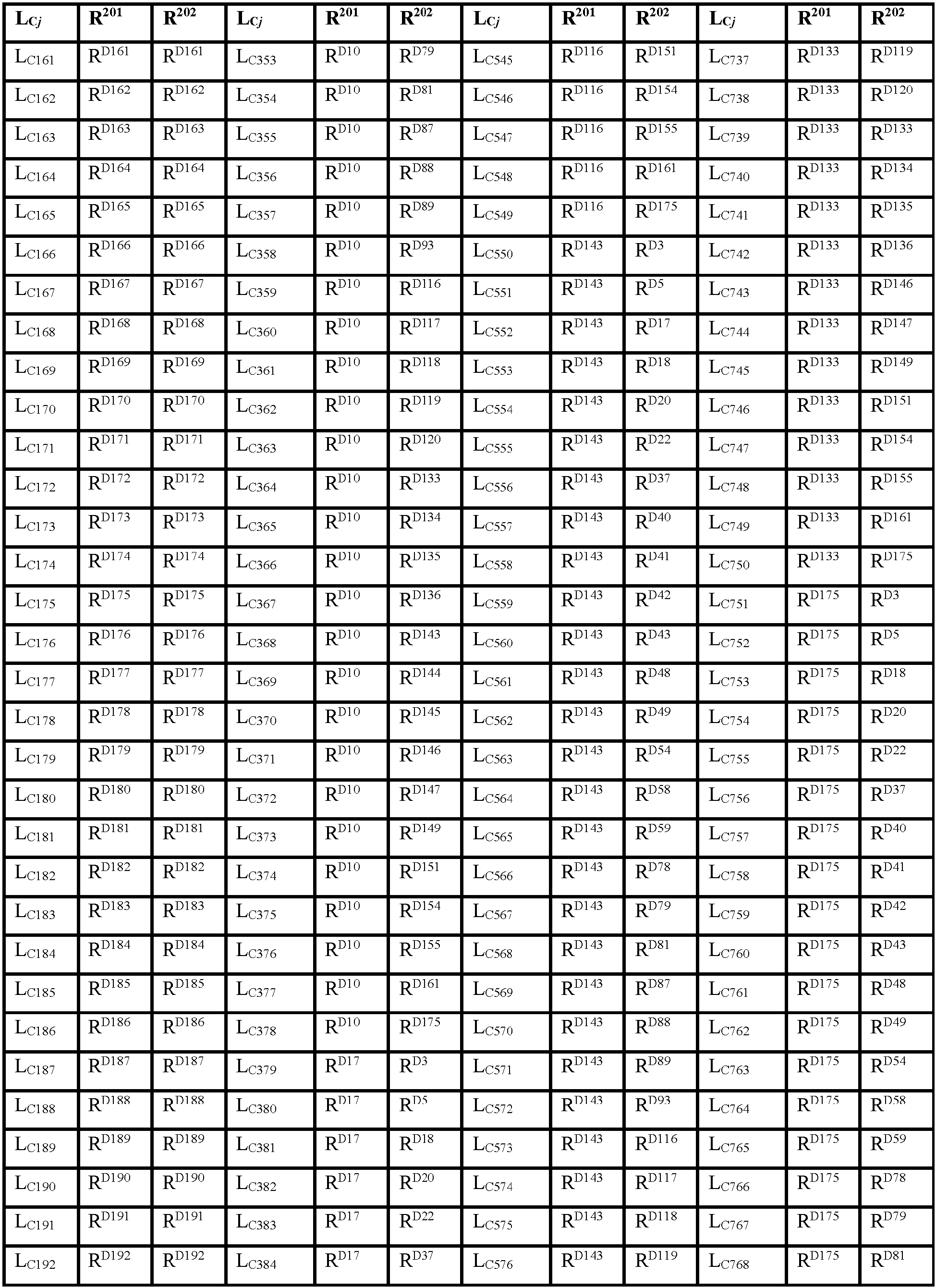 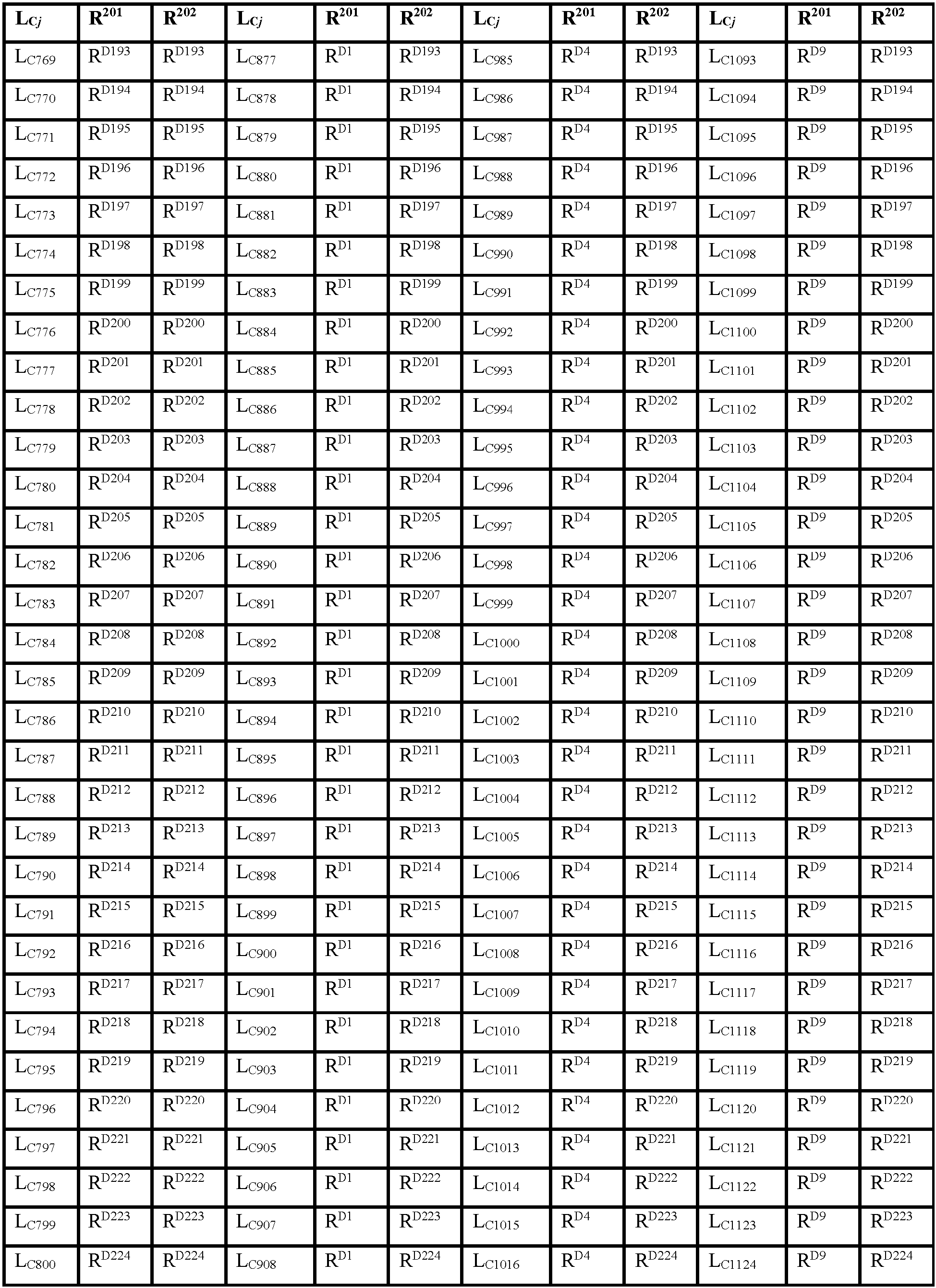 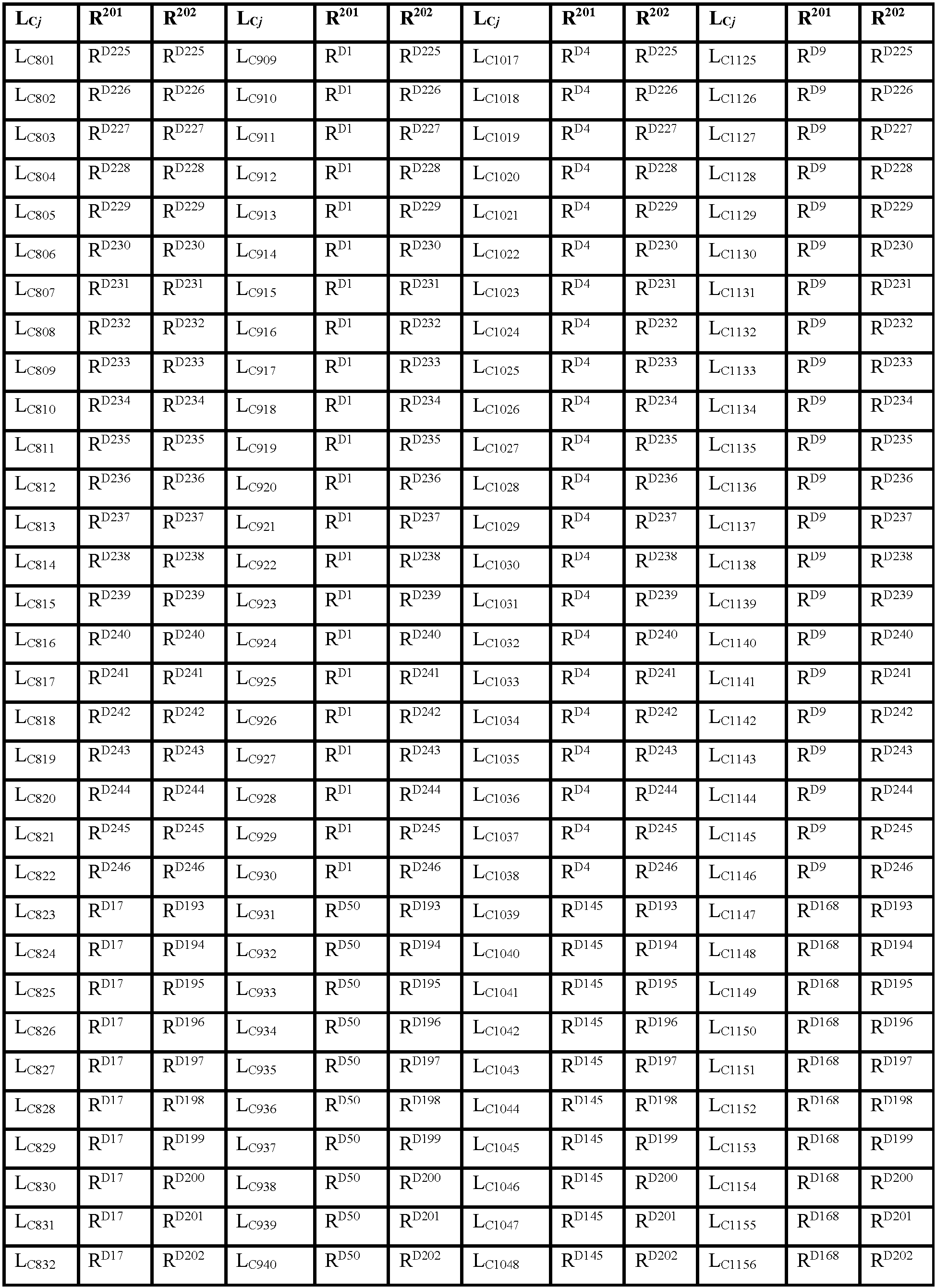 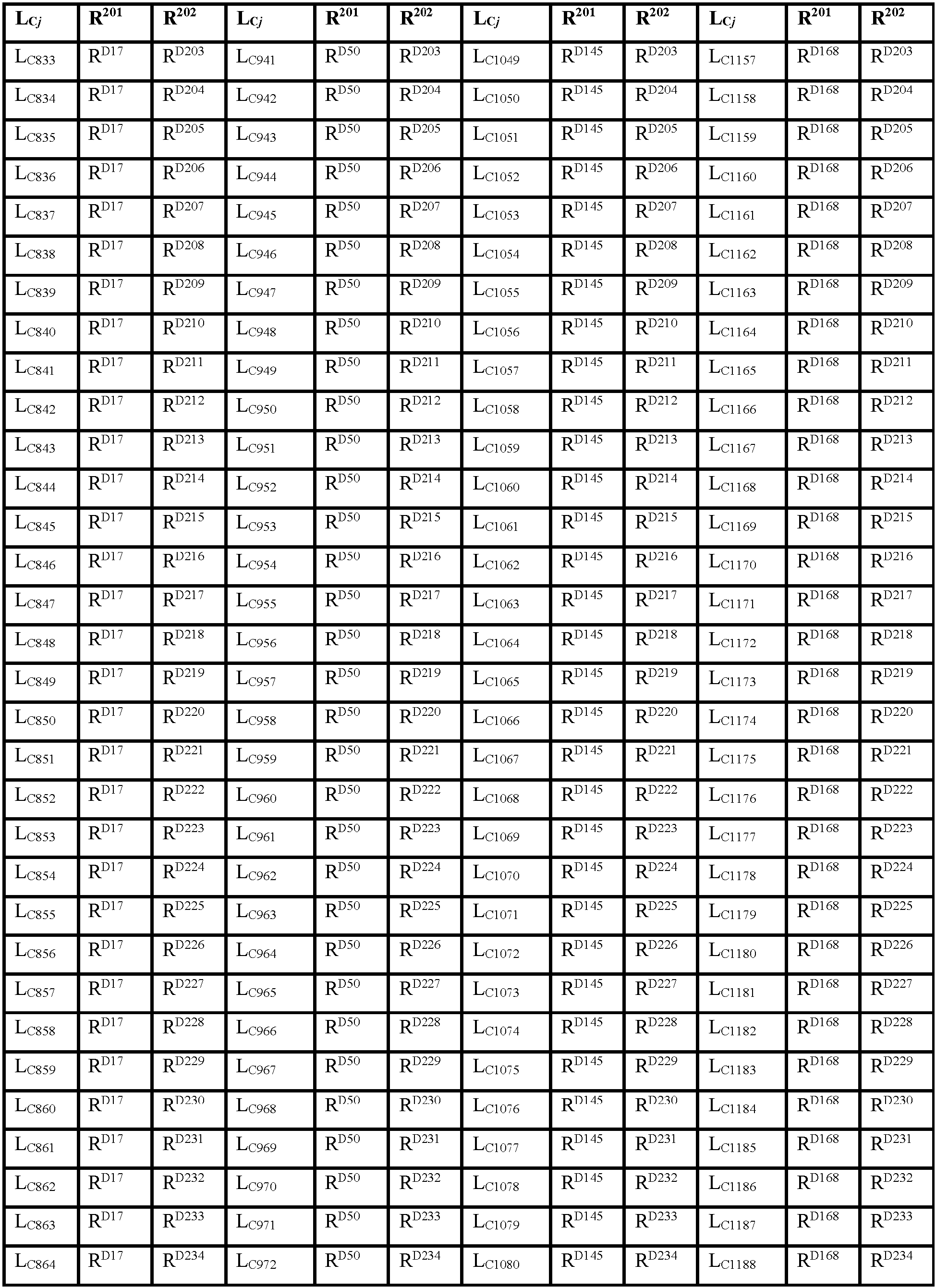 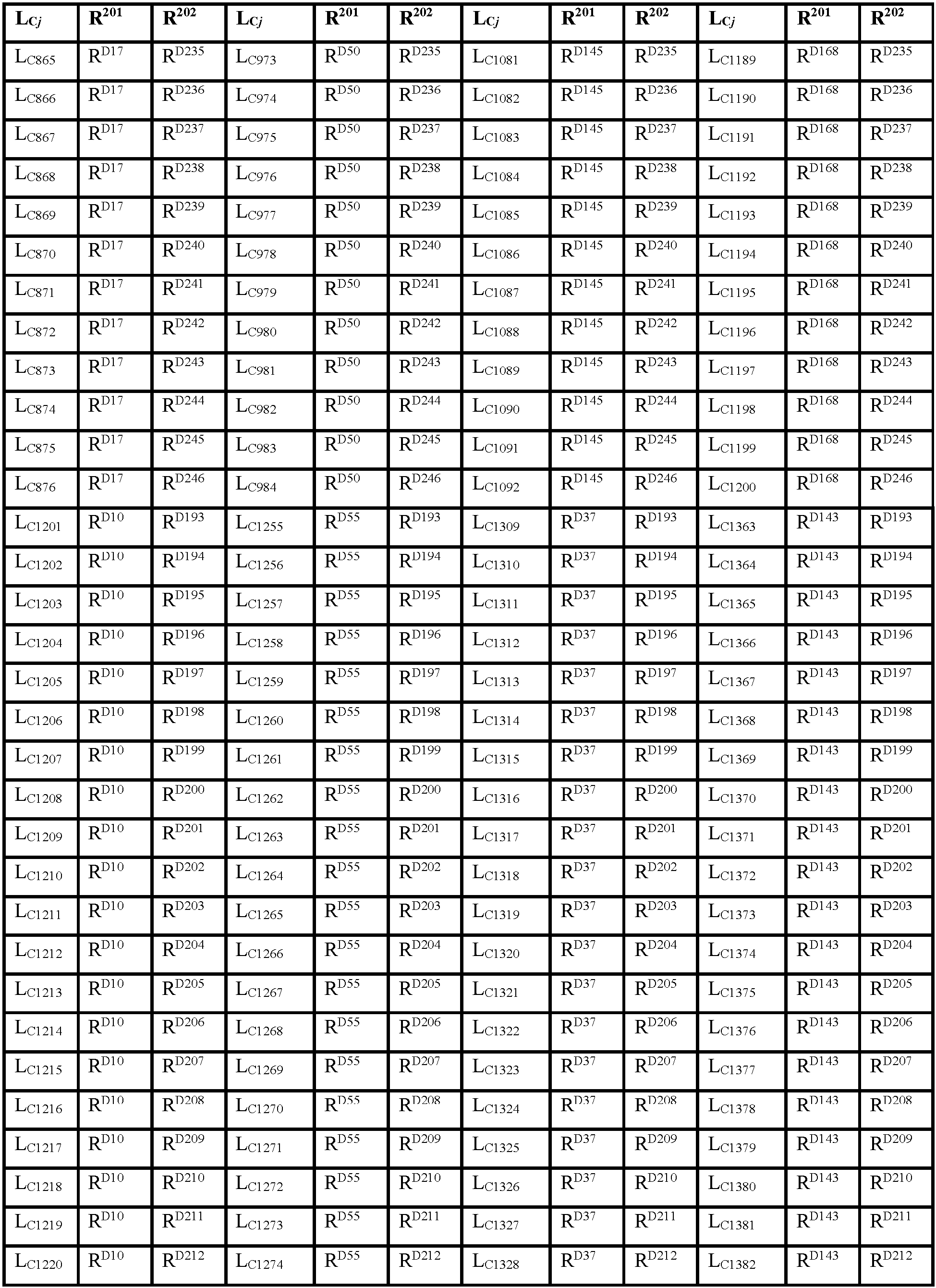 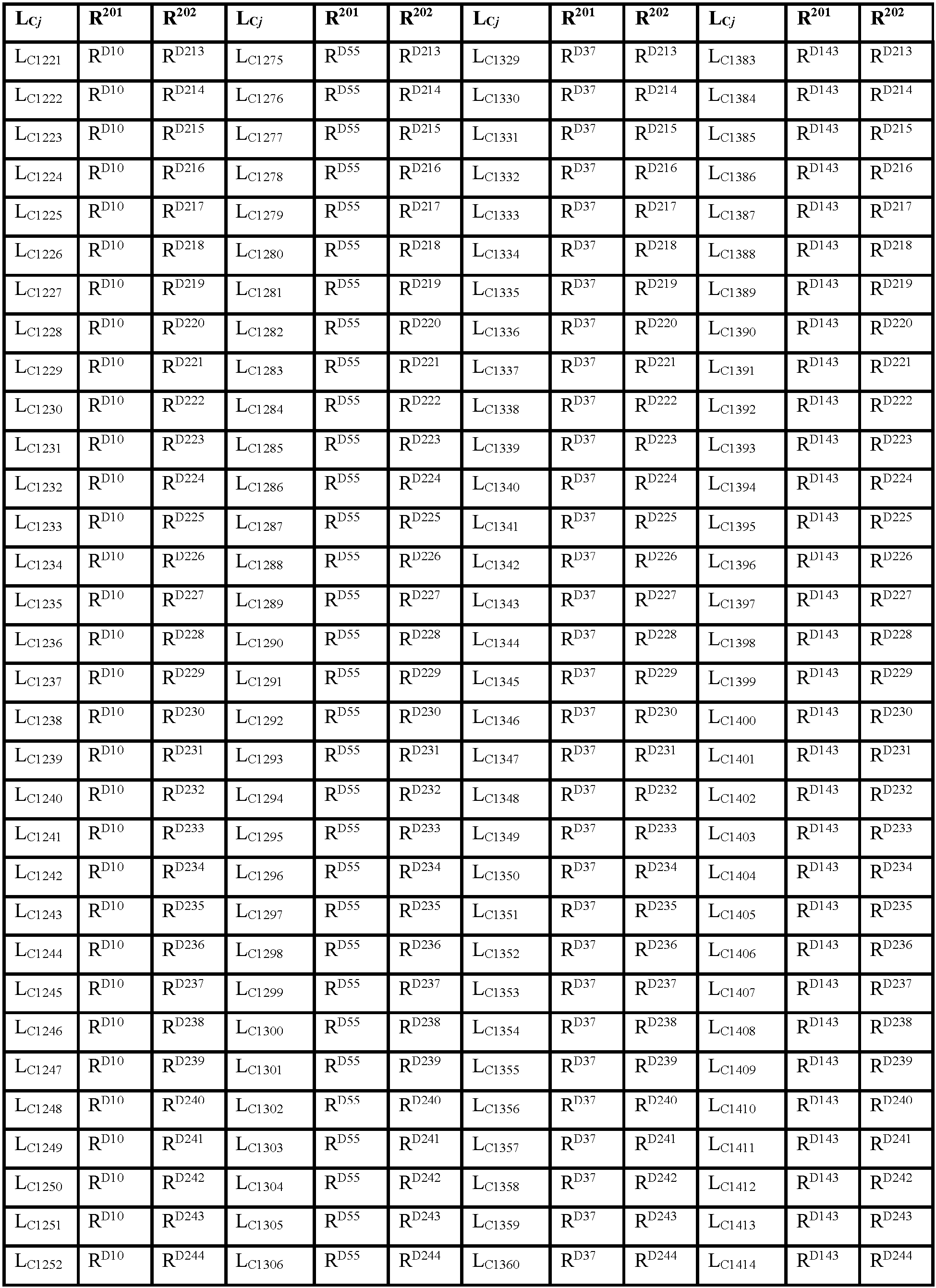 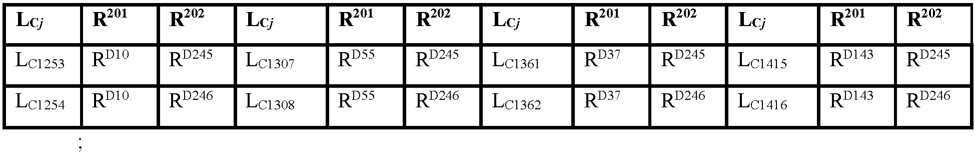
wobei R^{D1} bis R^{D246} die folgenden Strukturen aufweisen:

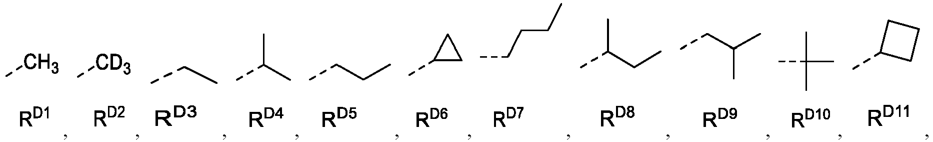

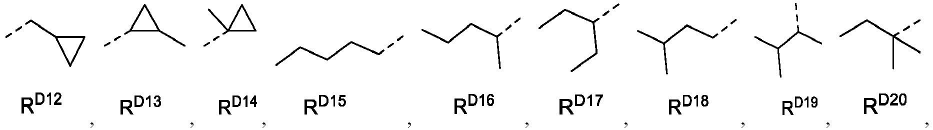

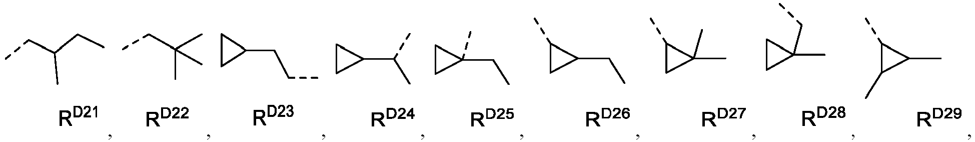

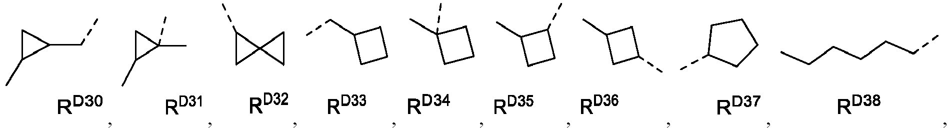

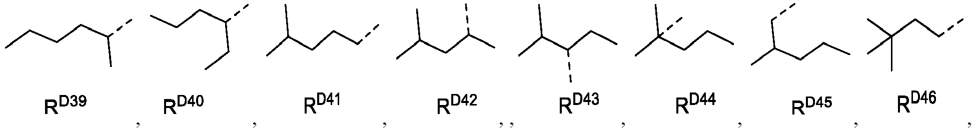

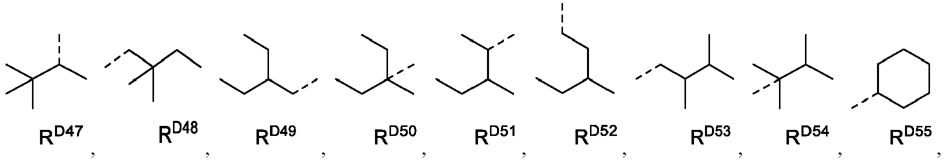

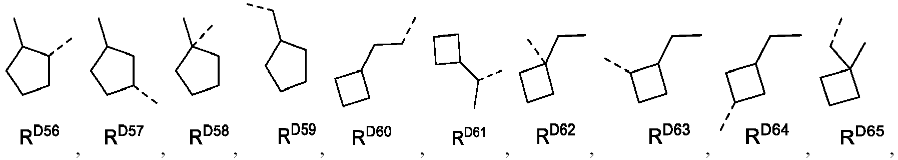

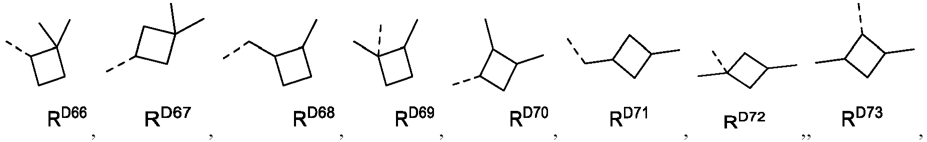

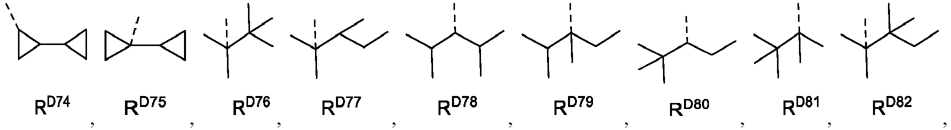

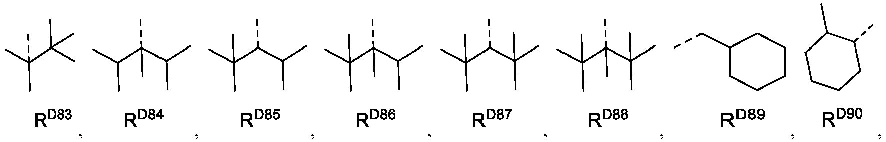

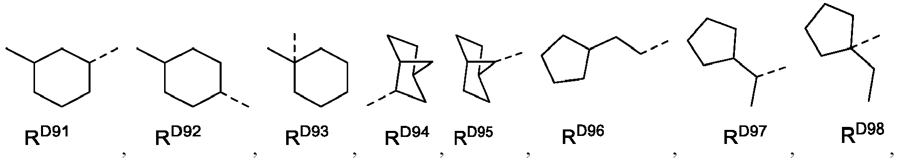

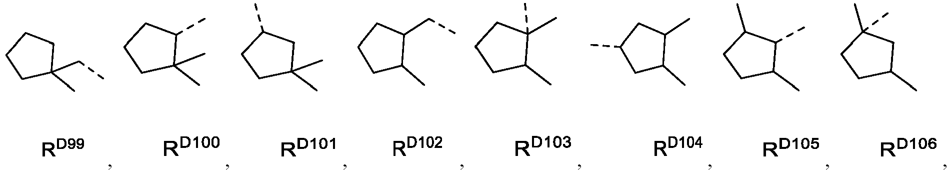

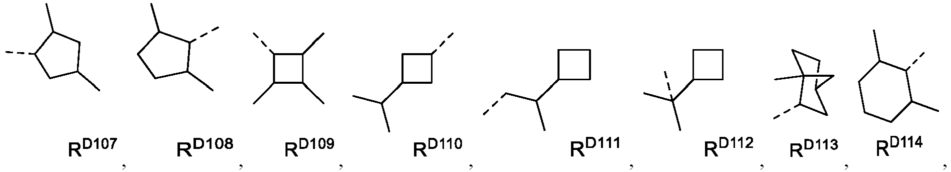

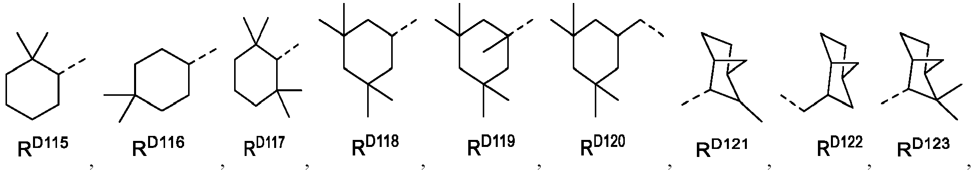

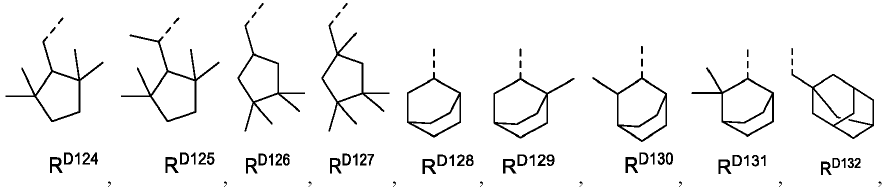

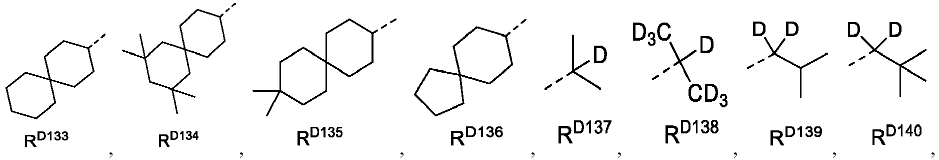

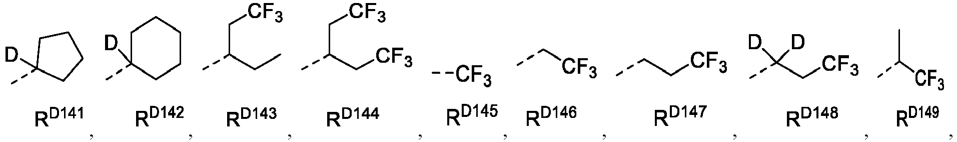

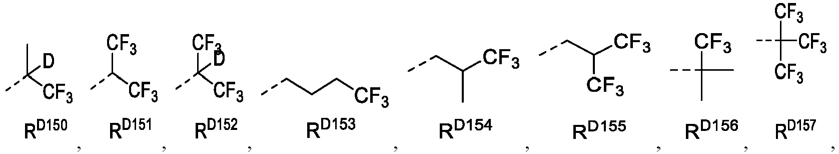

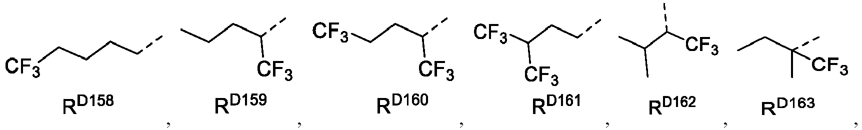

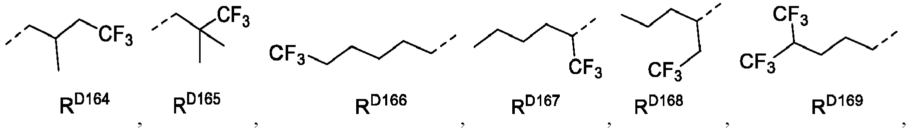

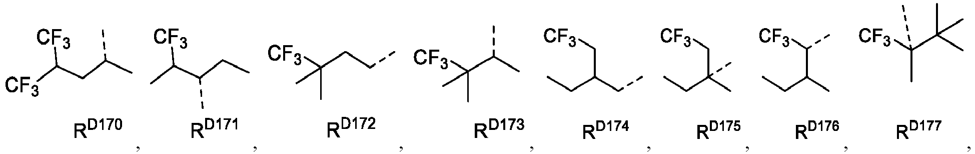

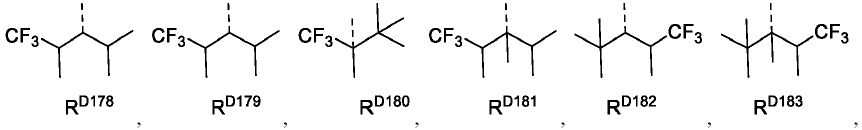

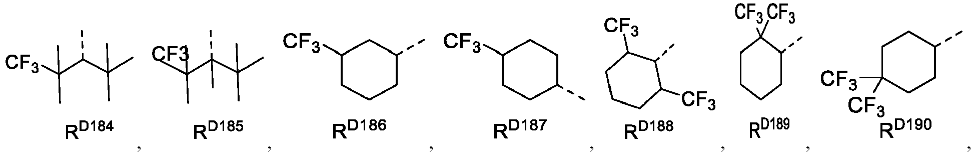

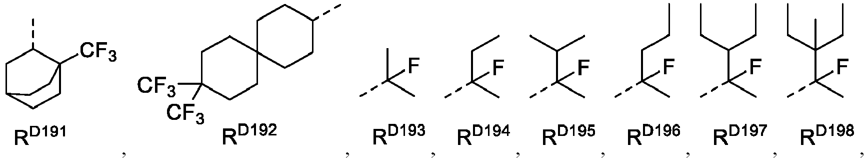

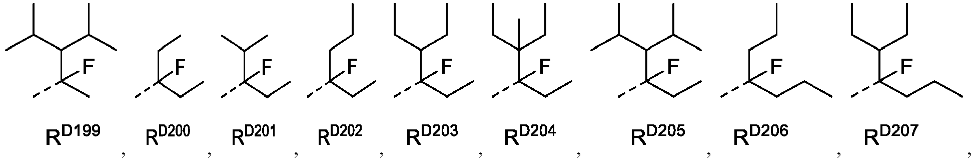

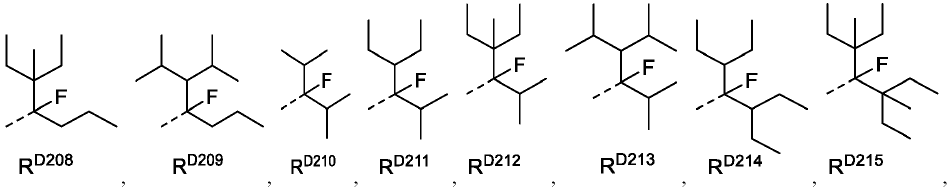

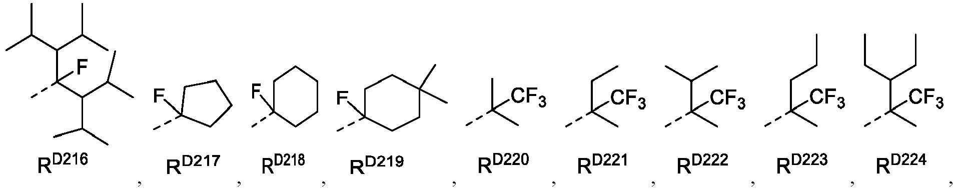

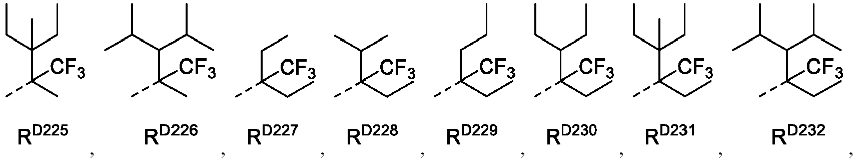

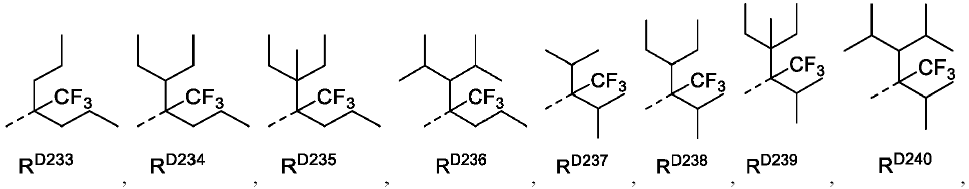

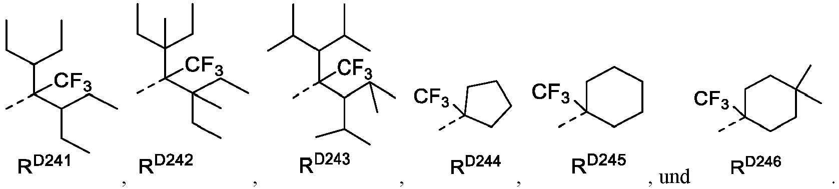

13. die Verbindung nach Anspruch 1, wobei die Verbindung ausgewählt ist aus der Gruppe bestehend aus: 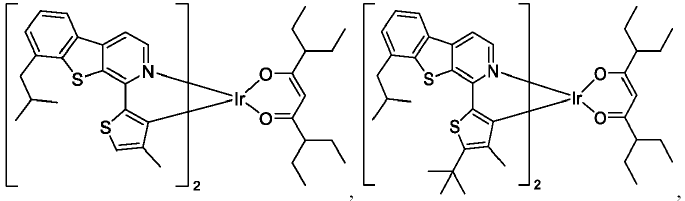 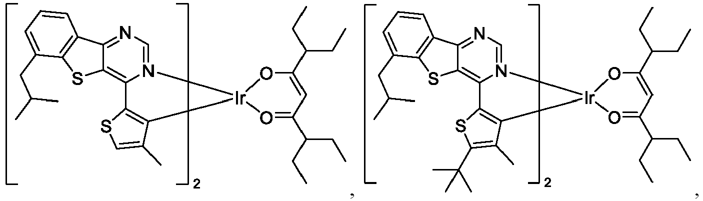 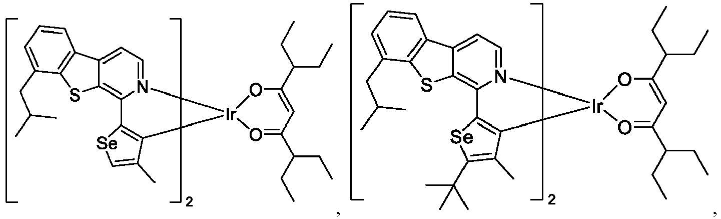 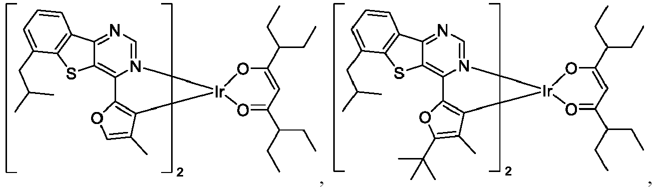 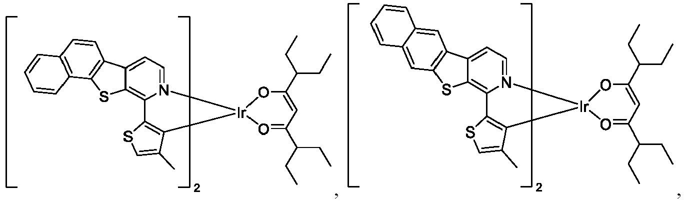 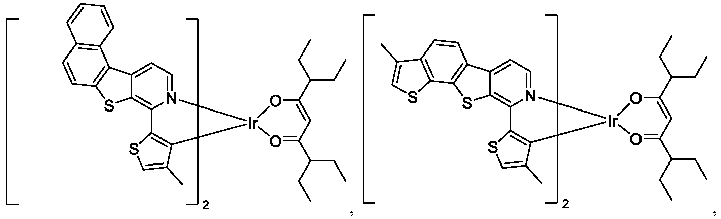 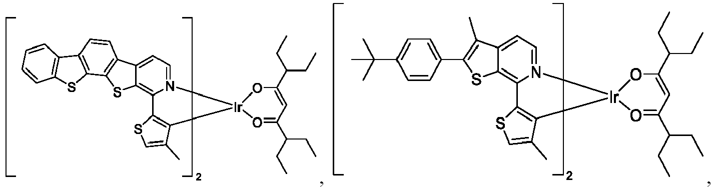 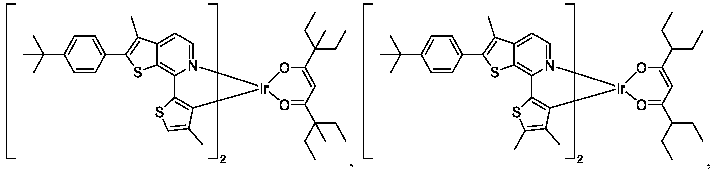 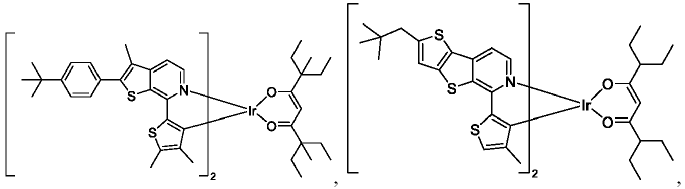 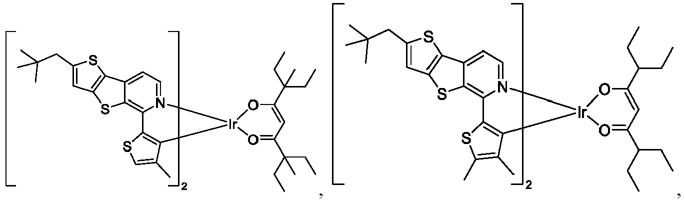 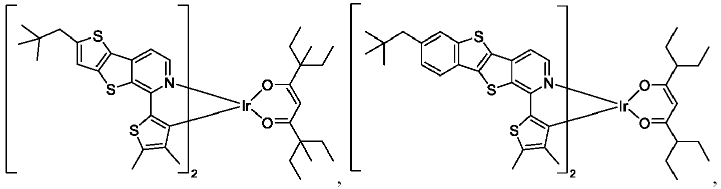 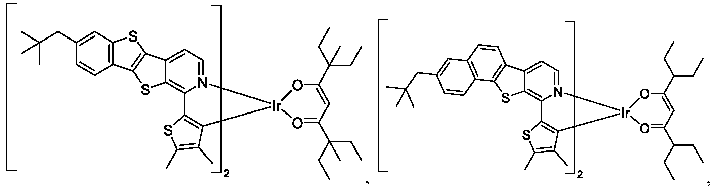 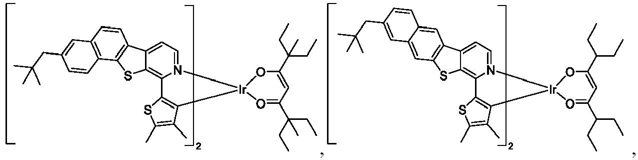 und

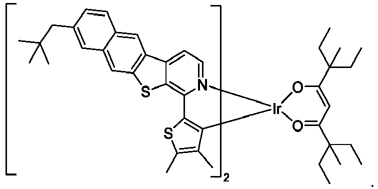

14. Verbindung nach einem der Ansprüche 1 bis 12, wobei die Verbindung eine Struktur der Formel III aufweist, 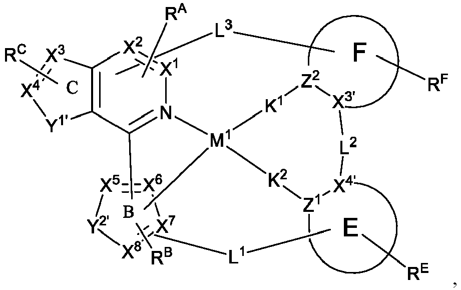 wobei:
M¹ Pd oder Pt ist;
die Einheiten E und F jeweils unabhängig voneinander eine monocyclische oder polycyclische kondensierte Ringstruktur sind, die 5-gliedrige und/oder 6-gliedrige carbocyclische oder heterocyclische Ringe umfasst;
Z¹ und Z² jeweils unabhängig voneinander C oder N sind;
K¹ und K² jeweils unabhängig voneinander aus der Gruppe ausgewählt sind, die aus einer direkten Bindung, O und S besteht, wobei mindestens eines von K¹ und K² eine direkte Bindung ist;
L¹, L² und L³ jeweils unabhängig voneinander aus der Gruppe ausgewählt sind, die aus einer Einfachbindung, dem Fehlen einer Bindung, O, S, SO, SO₂, C=O, C=NR', C=CR'R", CR'R", SiR'R", BR' und NR' besteht, wobei mindestens eines von L¹ und L² vorhanden ist;
X³ und X^{4'} jeweils unabhängig voneinander C oder N sind;
R^{E} und R^{F} jeweils unabhängig voneinander eine Monosubstitution oder bis zu einer maximal zulässigen Substitution oder keine Substitution darstellen;
jedes von R', R", R^{E} und R^{F} unabhängig ein Wasserstoff oder ein Substituent ist, der aus der Gruppe ausgewählt ist, die aus Deuterium, Fluor, Alkyl, Cycloalkyl, Heteroalkyl, Alkoxy, Aryloxy, Amino, Silyl, Boryl, Alkenyl, Cycloalkenyl, Heteroalkenyl, Aryl, Heteroaryl, Nitril, Isonitril, Sulfanyl und Kombinationen davon besteht; und
zwei beliebige benachbarte R, R', R", R^{A}, R^{C}, R^{E} und R^{F} miteinander verbunden oder verschmolzen sein können, um einen Ring zu bilden.

15. Eine organische lichtemittierende Vorrichtung (OLED), die Folgendes umfasst:
eine Anode;
eine Kathode; und
eine organische Schicht, die zwischen der Anode und der Kathode angeordnet ist, wobei die organische Schicht eine Verbindung nach einem der vorhergehenden Ansprüche umfasst.

16. Ein Verbraucherprodukt, das eine organische lichtemittierende Vorrichtung umfasst, die Folgendes umfasst:
eine Anode;
eine Kathode; und
eine organische Schicht, die zwischen der Anode und der Kathode angeordnet ist, wobei die organische Schicht eine Verbindung nach einem der Ansprüche 1 bis 14 umfasst.

## Revendications

1. Composé comportant un ligand L_{A} ayant une structure de 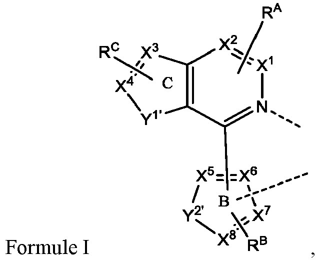 dans laquelle :
X¹, X², X³, X⁴, X⁵, X⁶, X⁷ et X⁸ sont chacun, indépendamment les uns des autres C ou N,
Y¹ et Y² sont chacun choisis indépendamment l'un de l'autre parmi le groupe constitué de O, S et Se, R^{A}, R^{B} et R^{C} représentent chacun, indépendamment les uns des autres, une mono-substitution jusqu'au nombre maximal de substitutions admissibles, ou aucune substitution,
R^{A}, R^{B} et R^{C} sont chacun, indépendamment les uns des autres, un hydrogène ou un substituant choisi parmi le groupe constitué du deutérium, d'un halogène, d'un alkyle, d'un cycloalkyle, d'un hétéroalkyle, d'un hétérocycloalkyle, d'un boryle, d'un sélényle, d'un arylalkyle, d'un alcoxy, d'un aryloxy, d'un amino, d'un silyle, d'un germyle, d'un alcényle, d'un cycloalcényle, d'un hétéroalcényle, d'un alcynyle, d'un aryle, d'un hétéroaryle, d'un acyle, d'un acide carboxylique, d'un éther, d'un ester, d'un nitrile, d'un isonitrile, d'un sulfanyle, d'un sulfinyle, d'un sulfonyle, d'un phosphino et de combinaisons de ceux-ci,
L_{A} est coordonné à un métal M par les traits pointillés indiqués pour former un cycle chélate à 5 chaînons,
le métal M est choisi parmi le groupe constitué de Ru, Os, Ir, Pd, Pt, Cu, Ag et Au,
le cycle B est coordonné à M par une liaison C-M,
M peut être coordonné à d'autres ligands,
L_{A} peut être lié à d'autres ligands pour former un ligand tridentate, tétradentate, pentadentate ou hexadentate, et
deux R^{A} et R^{C} adjacents quelconques peuvent être liés ou fusionnés pour former un cycle.

2. Composé selon la revendication 1, dans lequel R^{A}, R^{B} et R^{C} sont chacun, indépendamment les uns des autres, un hydrogène ou un substituant choisi parmi le groupe constitué du deutérium, du fluor, d'un alkyle, d'un cycloalkyle, d'un hétéroalkyle, d'un alcoxy, d'un aryloxy, d'un amino, d'un silyle, d'un boryle, d'un alcényle, d'un cycloalcényle, d'un hétéroalcényle, d'un aryle, d'un hétéroaryle, d'un nitrile, d'un isonitrile, d'un sulfanyle et de combinaisons de ceux-ci.

3. Composé selon l'une ou l'autre des revendications 1 ou 2, dans lequel chaque élément parmi X¹, X², X³, X⁴, X⁵, X⁶, X⁷ et X⁸ est C, ou au moins un élément parmi X¹, X², X³, X⁴, X⁵, X⁶, X⁷ et X⁸ est N.

4. Composé selon la revendication 1, dans lequel un élément parmi X¹ et X² est N, ou un élément parmi X³ et X⁴ est N.

5. Composé selon la revendication 1, dans lequel X³ et X⁴ sont C, et deux R^{C} sont liés pour former un système cyclique fusionné avec C.

6. Composé selon la revendication 5, dans lequel le système cyclique comporte un cycle fusionné avec le cycle C, ou au moins deux cycles fusionnés au cycle C, ou au moins trois cycles fusionnés au cycle C.

7. Composé selon l'une quelconque des revendications précédentes, dans lequel L_{A} a une structure de 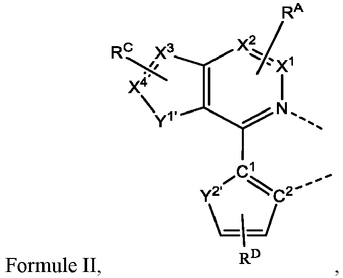
dans laquelle C¹ et C² sont des atomes de carbone liés par une liaison double,
dans laquelle R^{D} représente une mono- ou di- substitution, ou aucune substitution, et
les éléments R^{D} sont chacun, indépendamment les uns des autres, un hydrogène ou un substituant choisi parmi le groupe constitué du deutérium, d'un halogène, d'un alkyle, d'un cycloalkyle, d'un hétéroalkyle, d'un hétérocycloalkyle, d'un boryle, d'un sélényle, d'un arylalkyle, d'un alcoxy, d'un aryloxy, d'un amino, d'un silyle, d'un germyle, d'un alcényle, d'un cycloalcényle, d'un hétéroalcényle, d'un alcynyle, d'un aryle, d'un hétéroaryle, d'un acyle, d'un acide carboxylique, d'un éther, d'un ester, d'un nitrile, d'un isonitrile, d'un sulfanyle, d'un sulfinyle, d'un sulfonyle, d'un phosphino et de combinaisons de ceux-ci.

8. Composé selon l'une quelconque des revendications précédentes, dans lequel le ligand L_{A} est choisi parmi le groupe constitué des structures de : 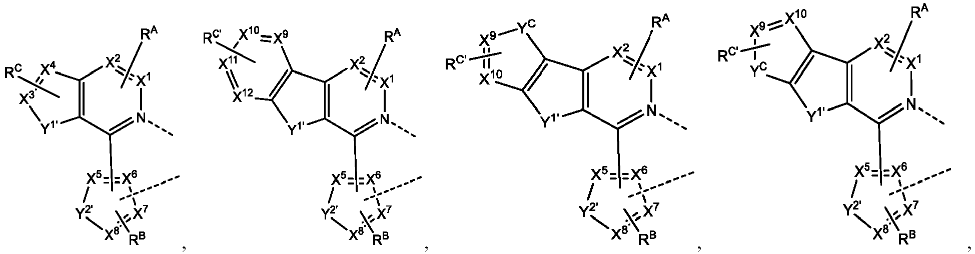 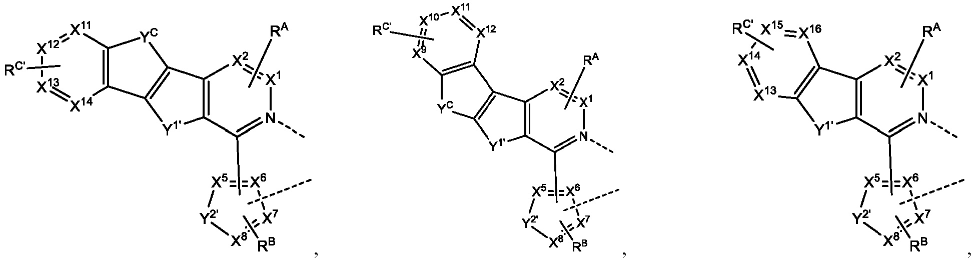 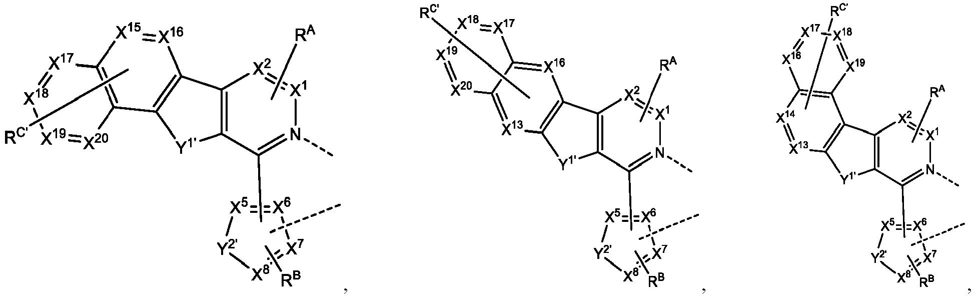 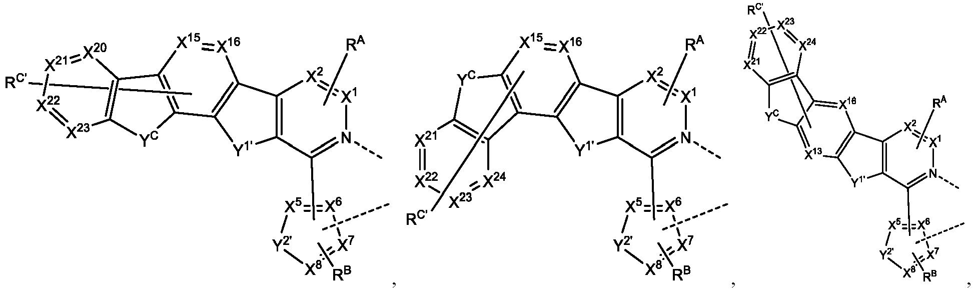 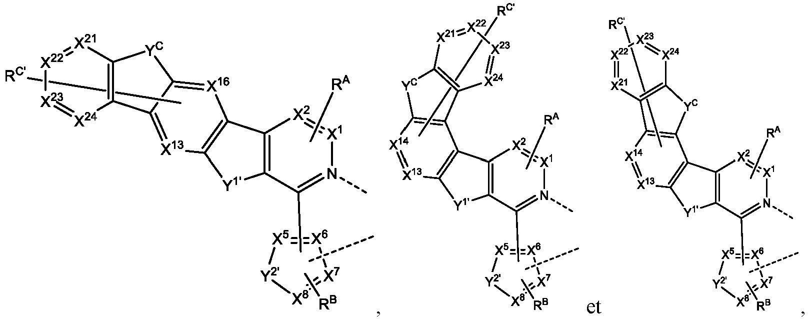 dans lesquelles
les éléments X⁹ à X²⁴ sont chacun, indépendamment les uns des autres, C ou N,
Y^{C} est choisi parmi le groupe constitué de O, S, CR'R", SiR'R", BR' et NR',
R^{C'} représente une mono-substitution, jusqu'au nombre maximal de substitutions admissibles, ou aucune substitution, et
les éléments R^{C'} sont chacun, indépendamment les uns des autres, un hydrogène ou un substituant choisi parmi le groupe constitué du deutérium, d'un halogène, d'un alkyle, d'un cycloalkyle, d'un hétéroalkyle, d'un hétérocycloalkyle, d'un boryle, d'un sélényle, d'un arylalkyle, d'un alcoxy, d'un aryloxy, d'un amino, d'un silyle, d'un germyle, d'un alcényle, d'un cycloalcényle, d'un hétéroalcényle, d'un alcynyle, d'un aryle, d'un hétéroaryle, d'un acyle, d'un acide carboxylique, d'un éther, d'un ester, d'un nitrile, d'un isonitrile, d'un sulfanyle, d'un sulfinyle, d'un sulfonyle, d'un phosphino et de combinaisons de ceux-ci.

9. Composé selon l'une quelconque des revendications précédentes, dans lequel le ligand L_{A} est choisi parmi le groupe constitué de L_{Ai-m-X}, dans lequel *i* est un entier de 1 à 2 610, *m* est un entier de 1 à 108, et X vaut de 1 à 3, avec 1 étant pour O, 2 pour S, 3 pour Se, dans lequel chaque élément de L*_{Ai-1-X}* à L*_{Ai-108-X}* a la structure définie comme suit : 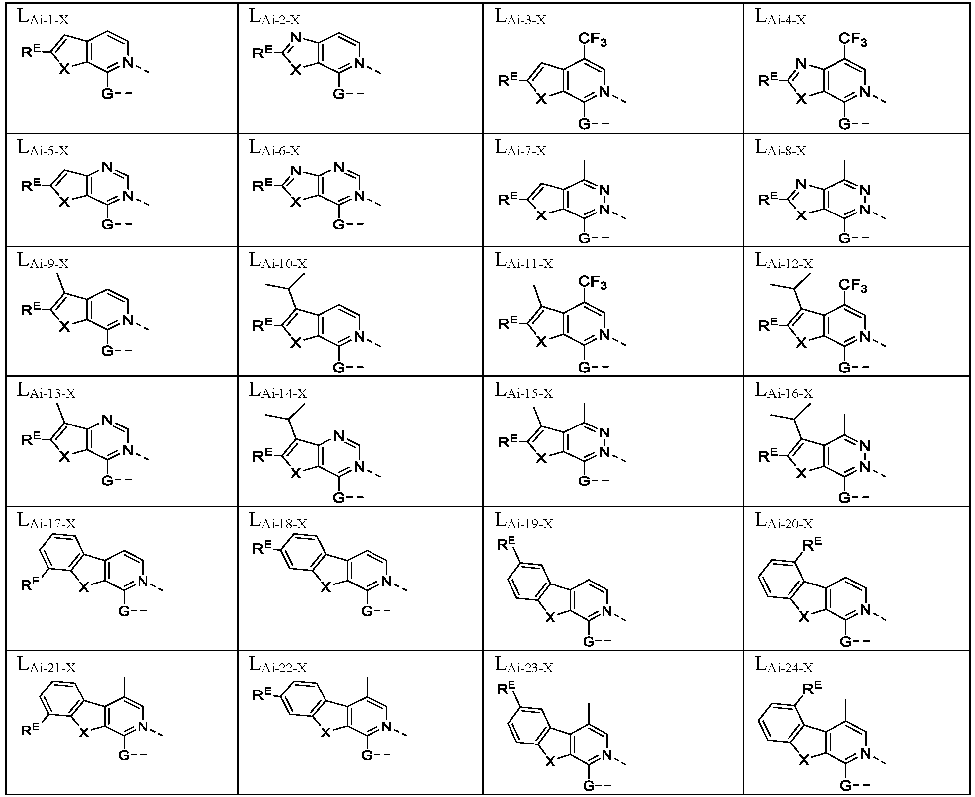 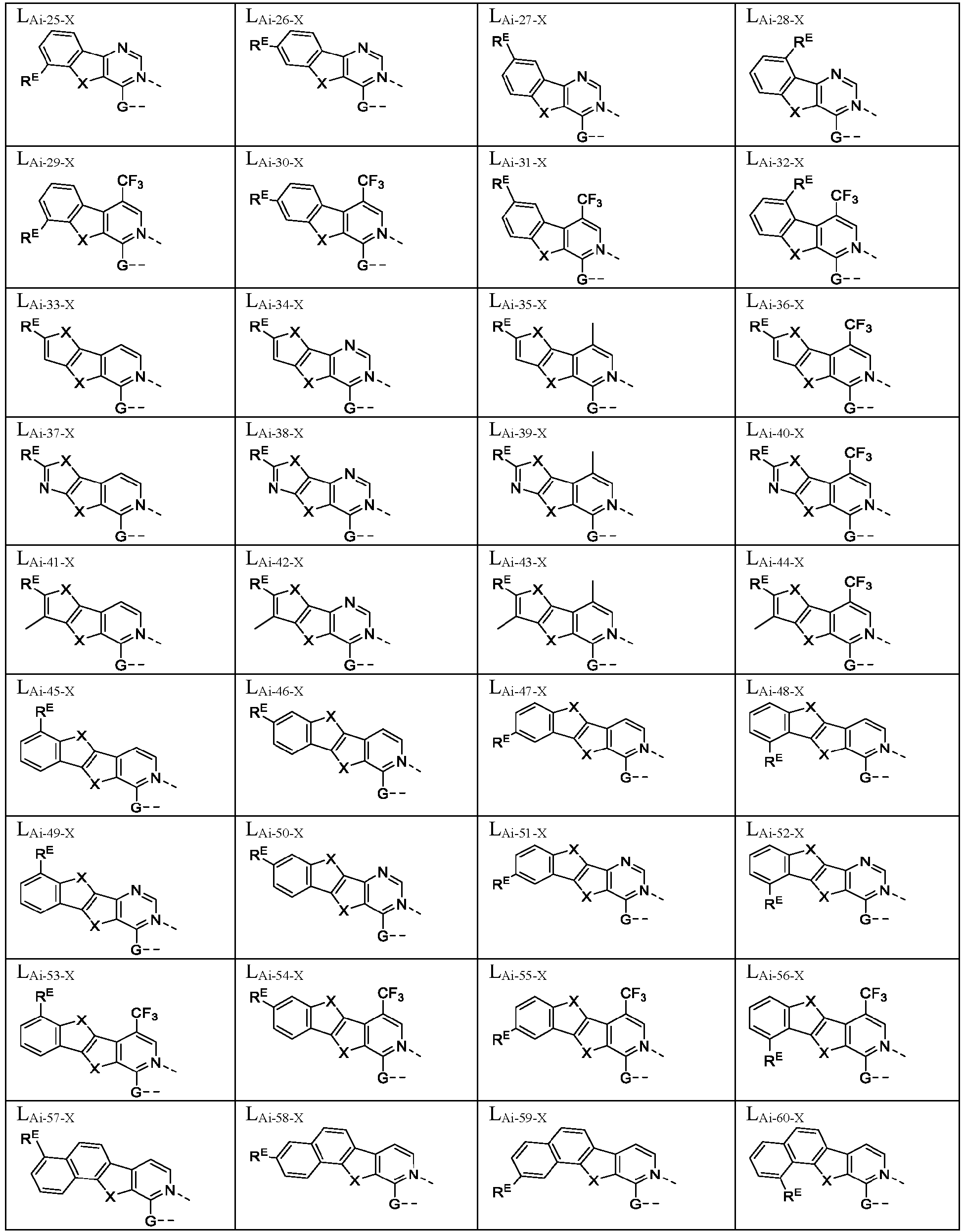 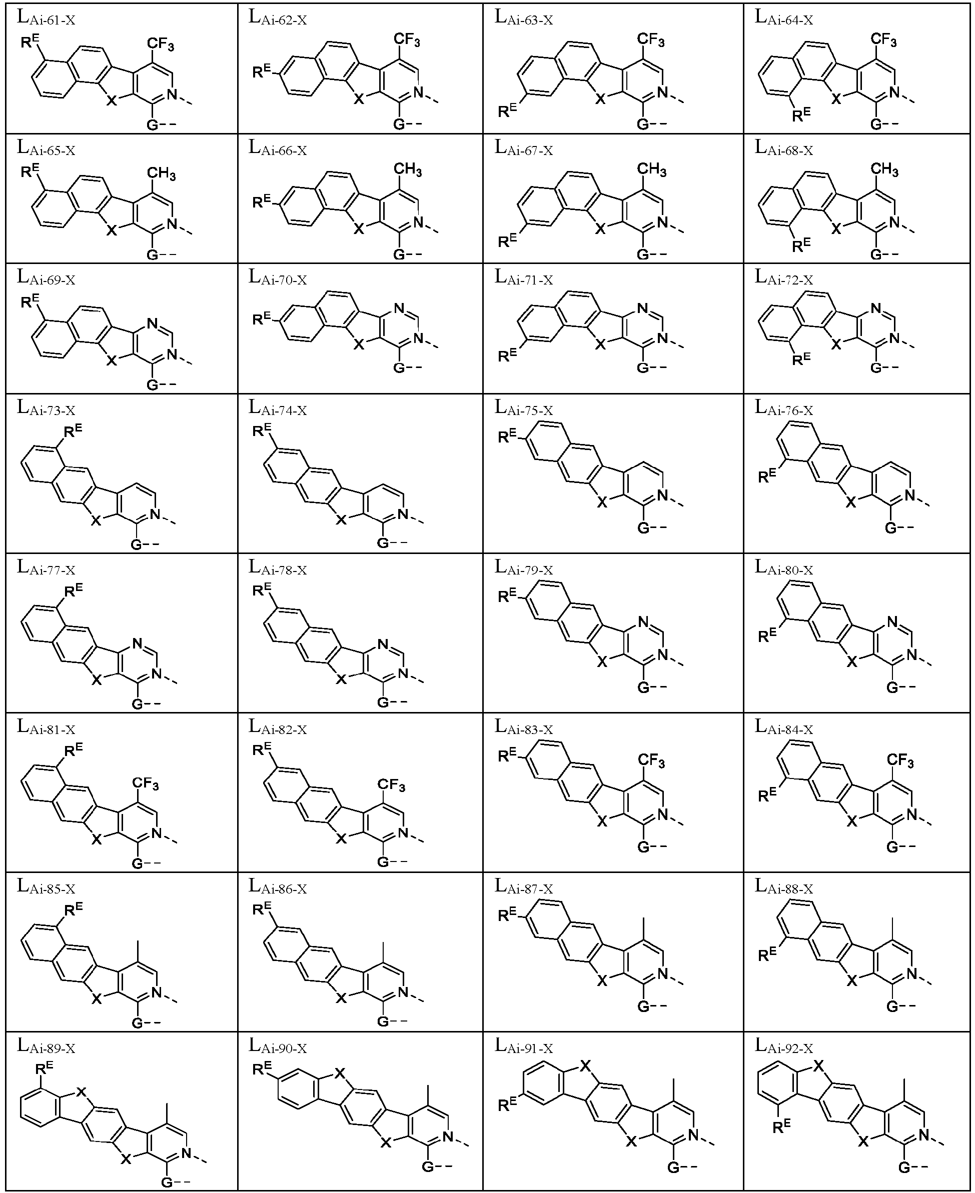 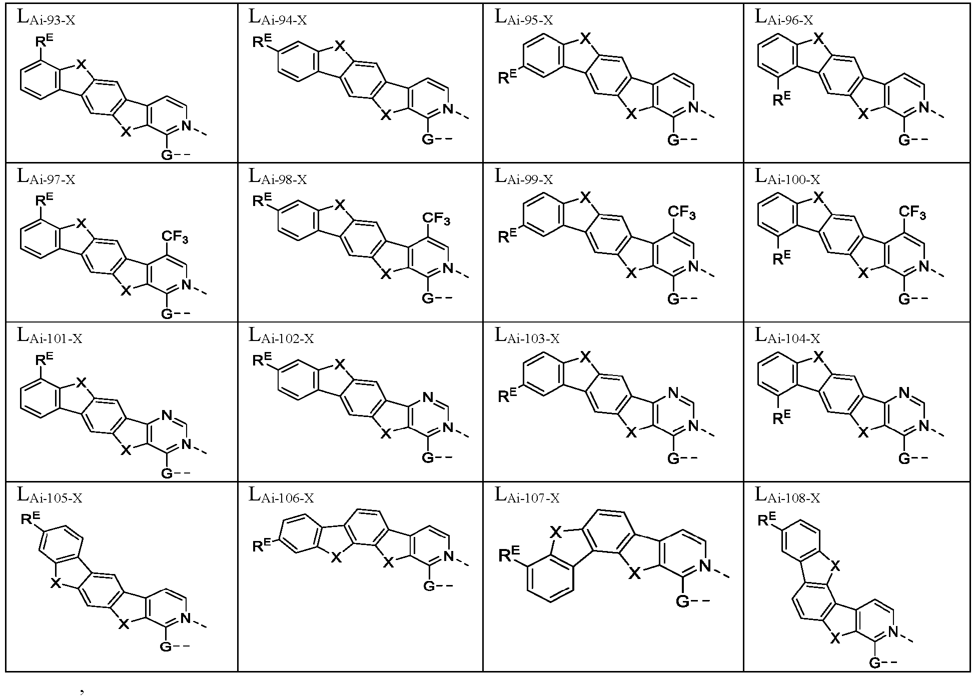 dans lequel pour chaque élément de L_{A1} à L_{A2610}, R^{E} et G sont définis comme suit : 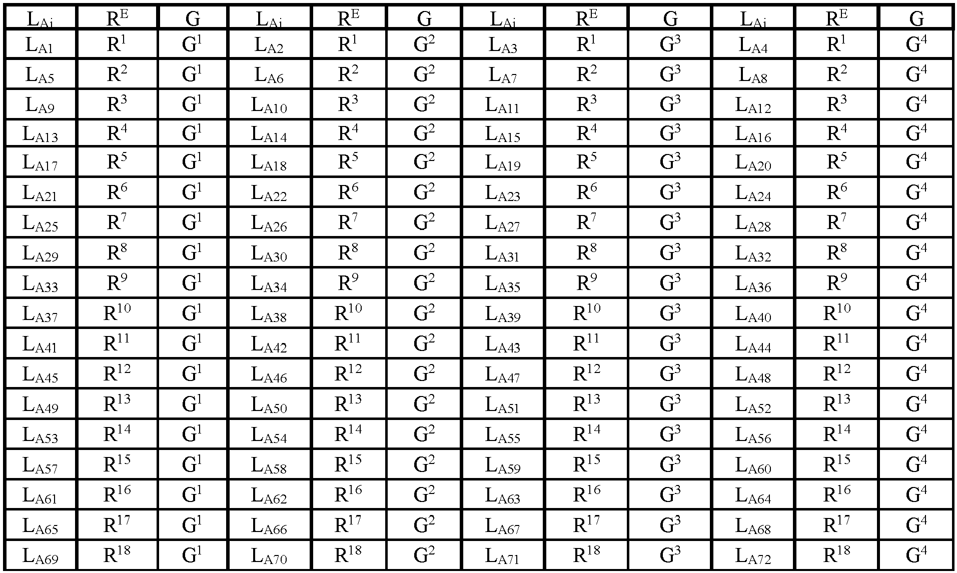 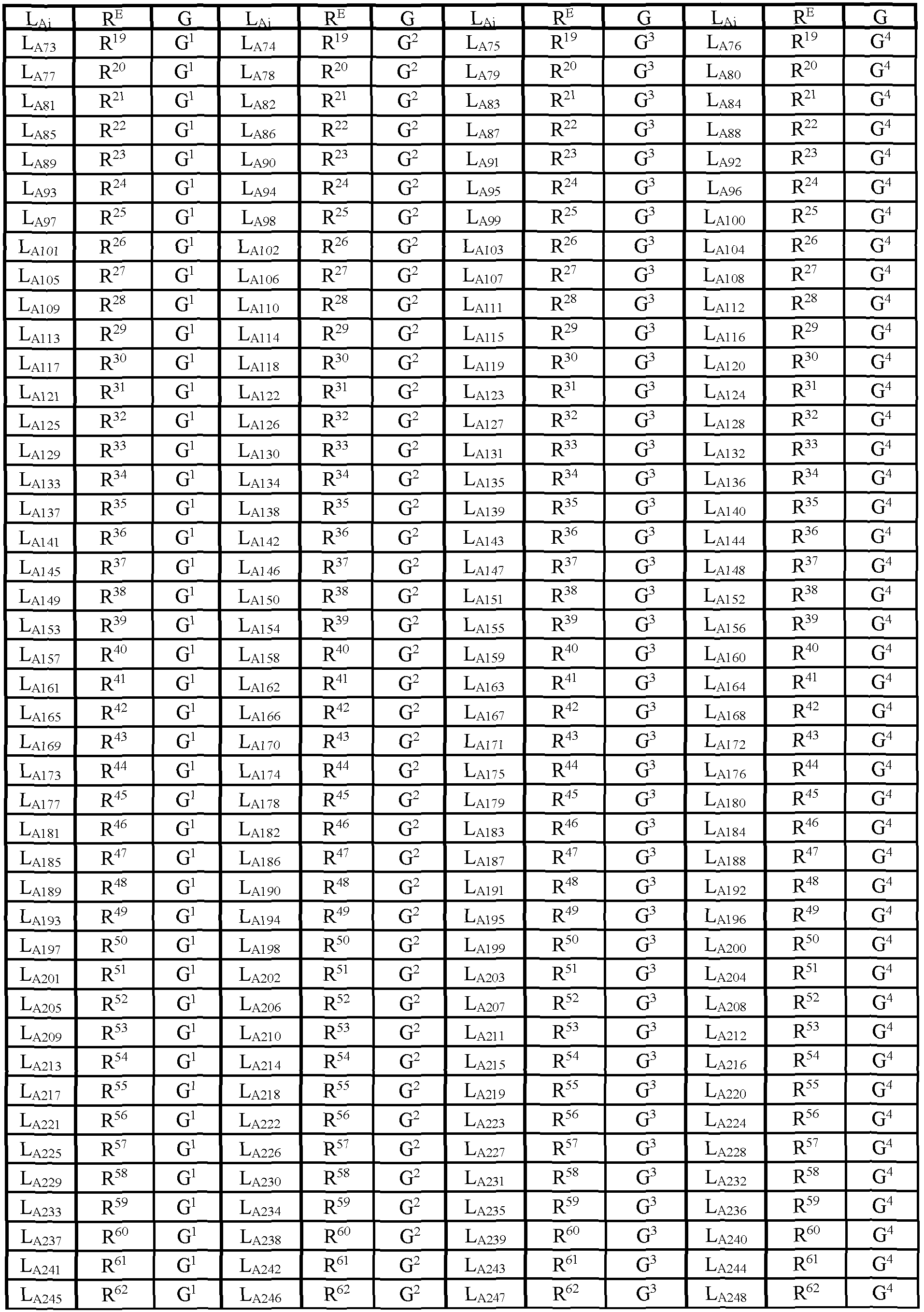 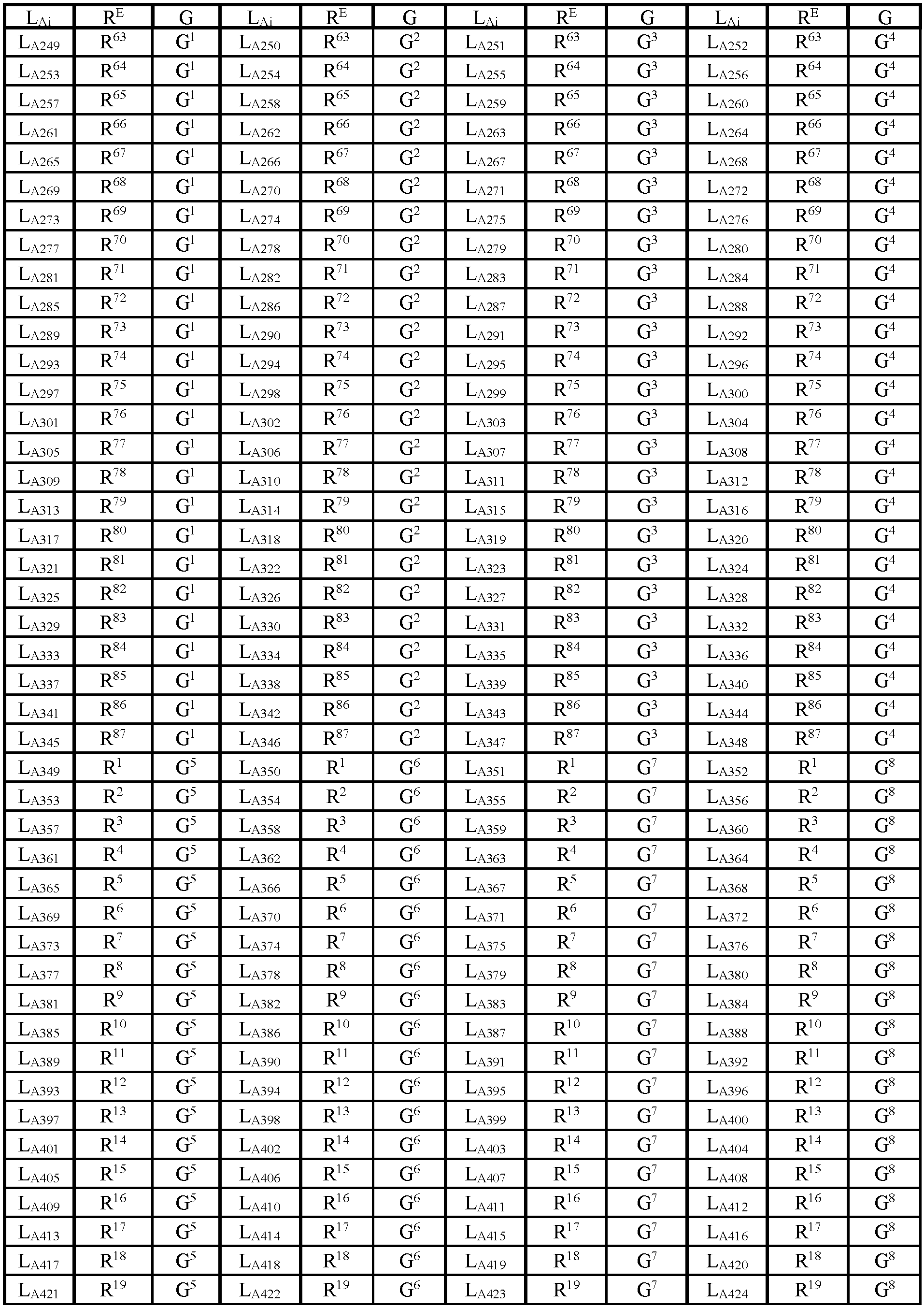 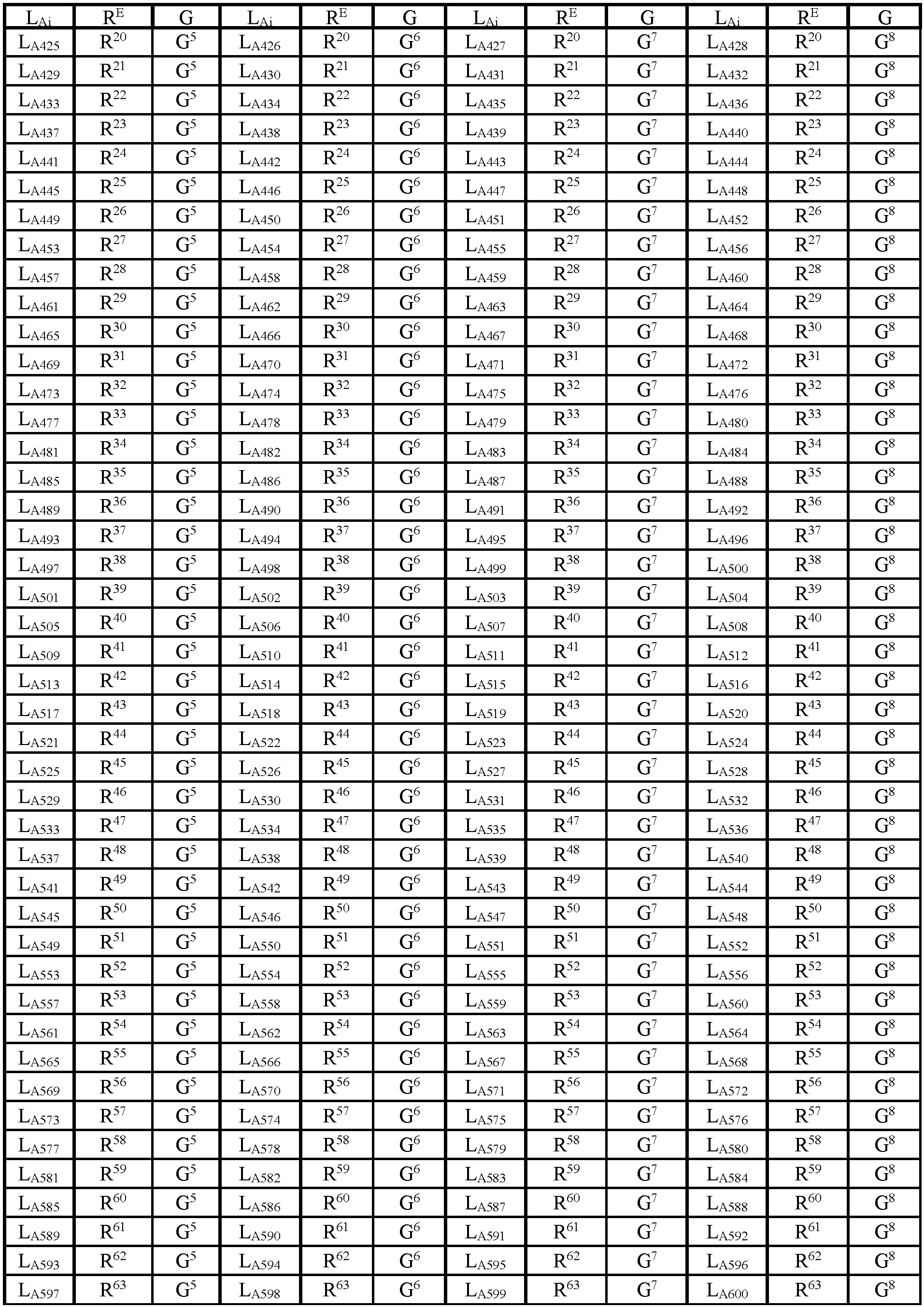 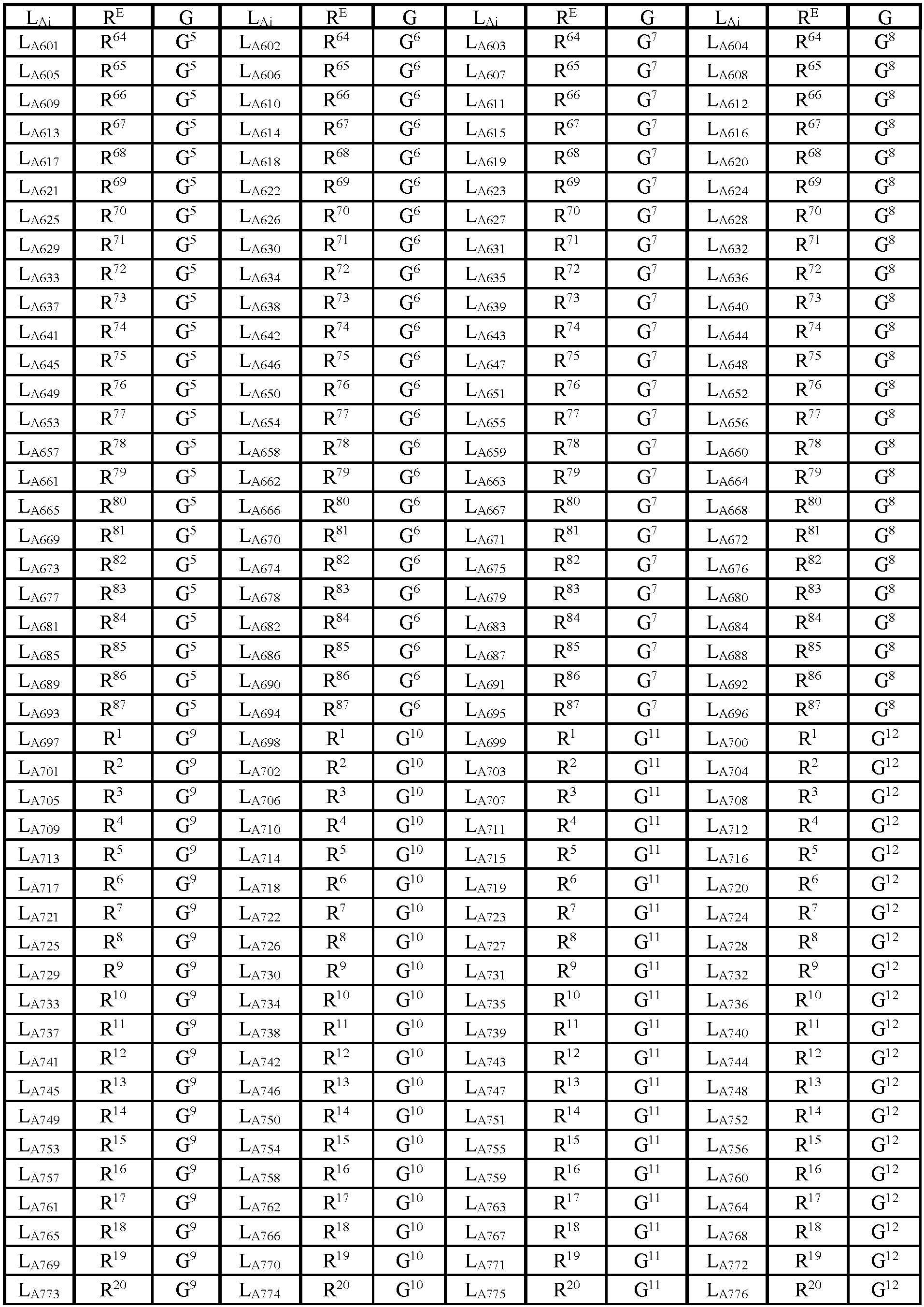 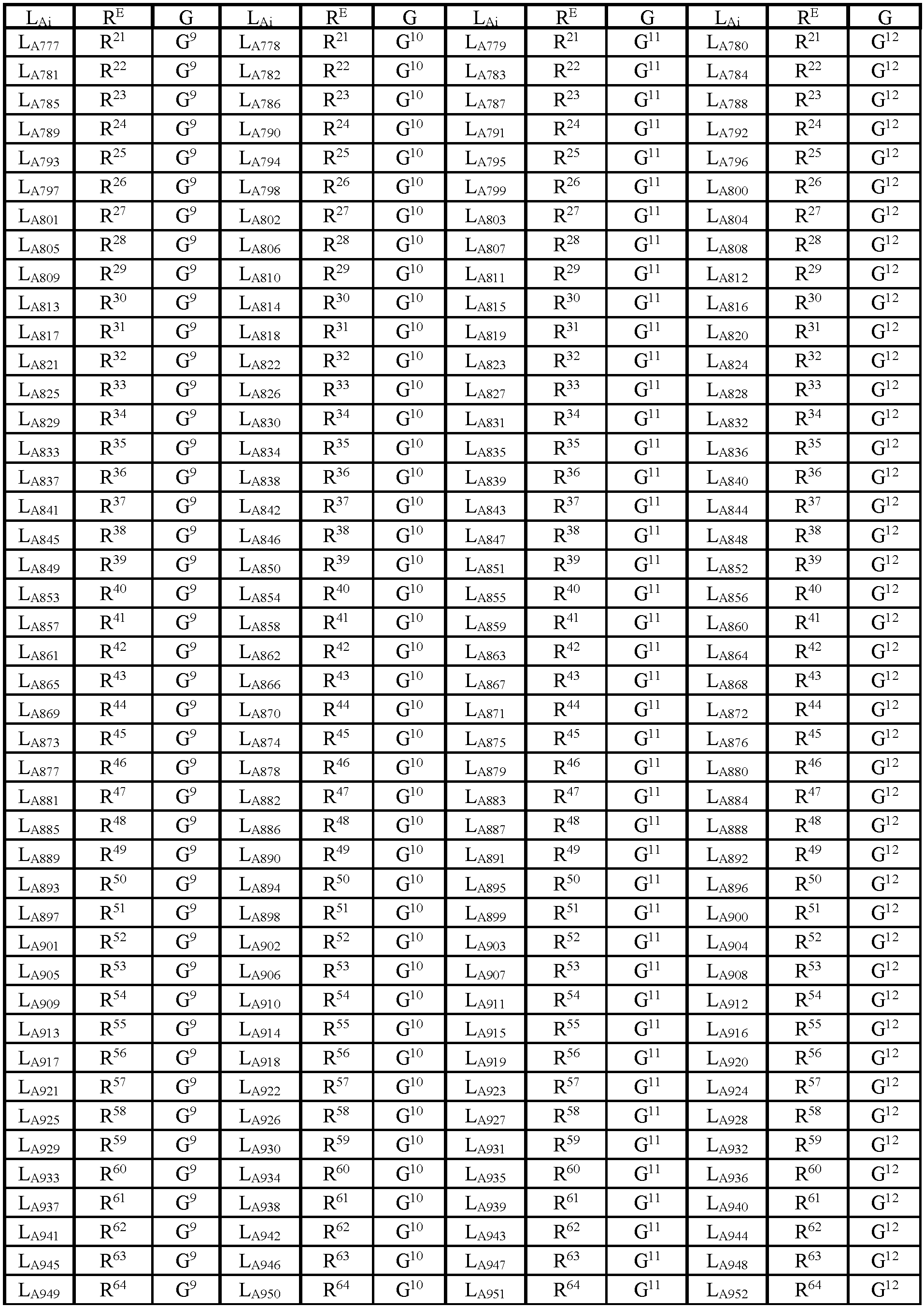 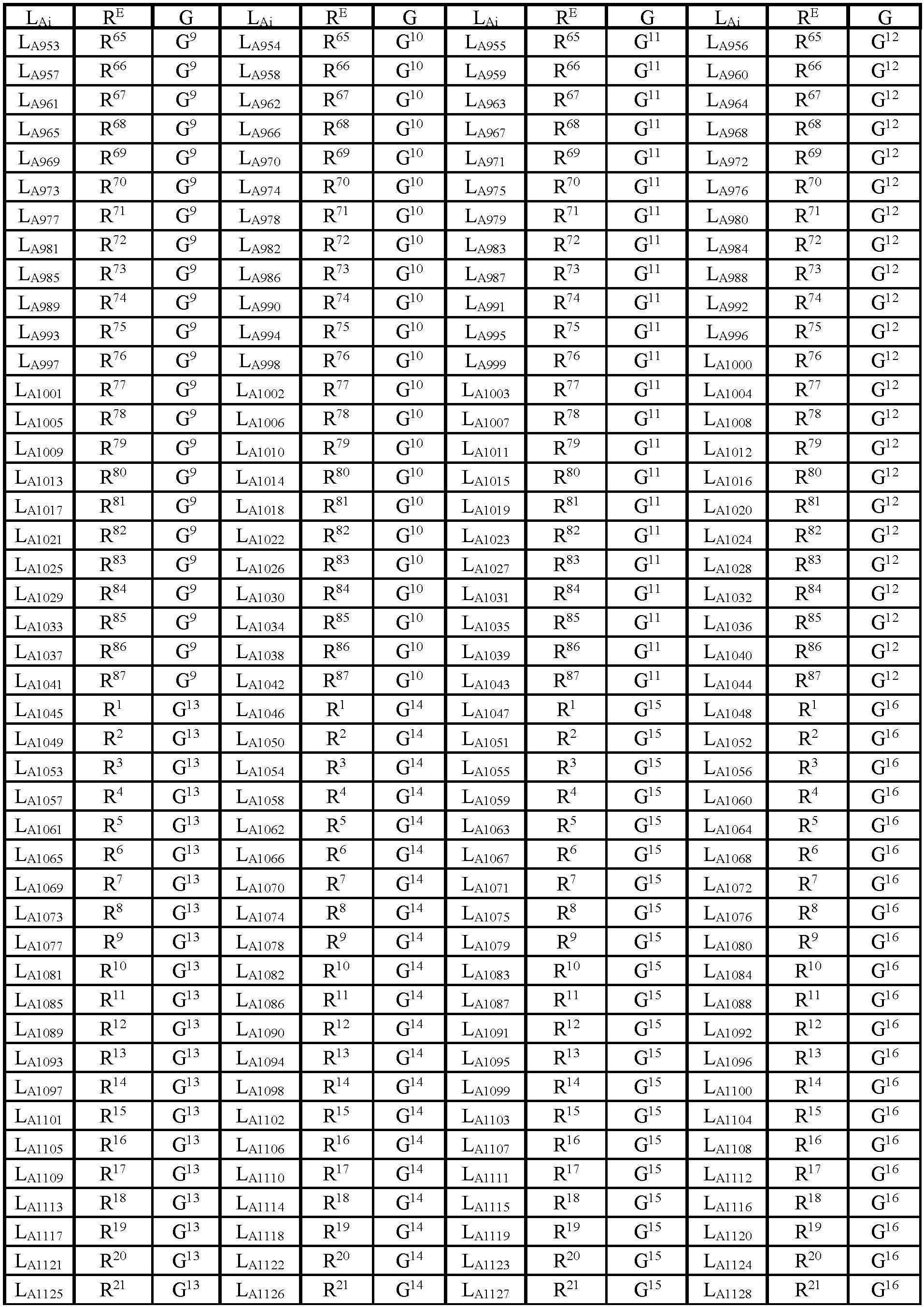 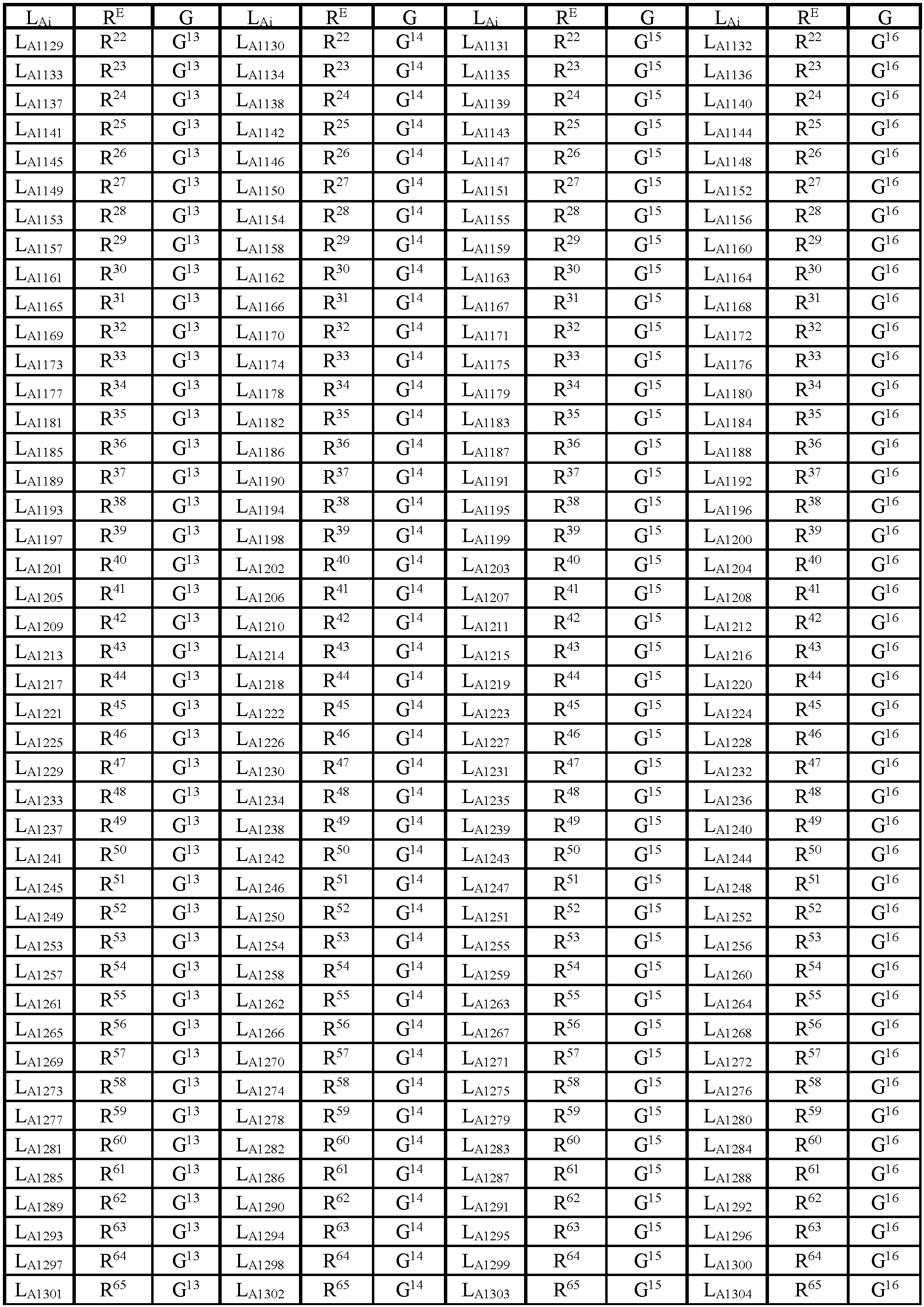 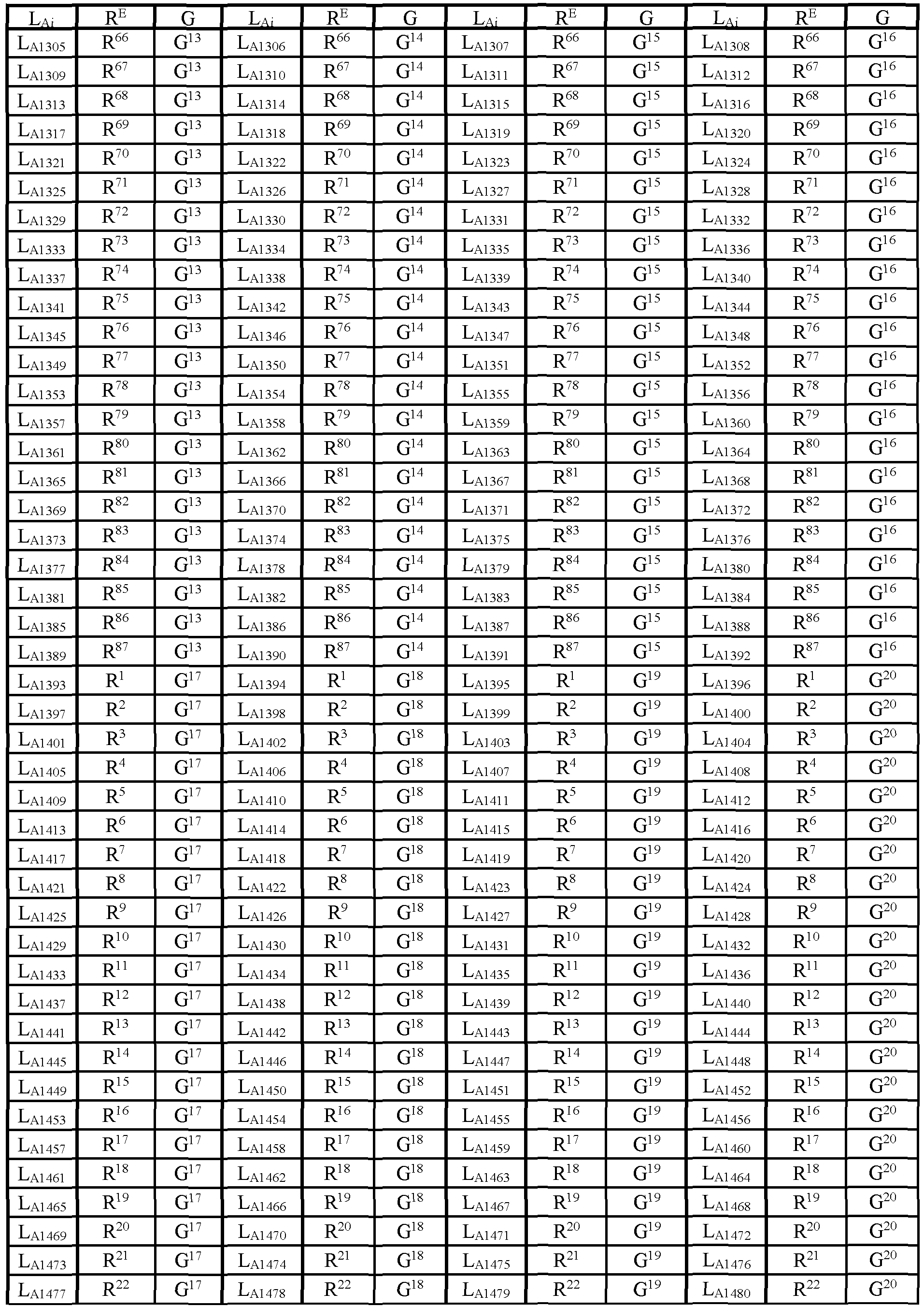 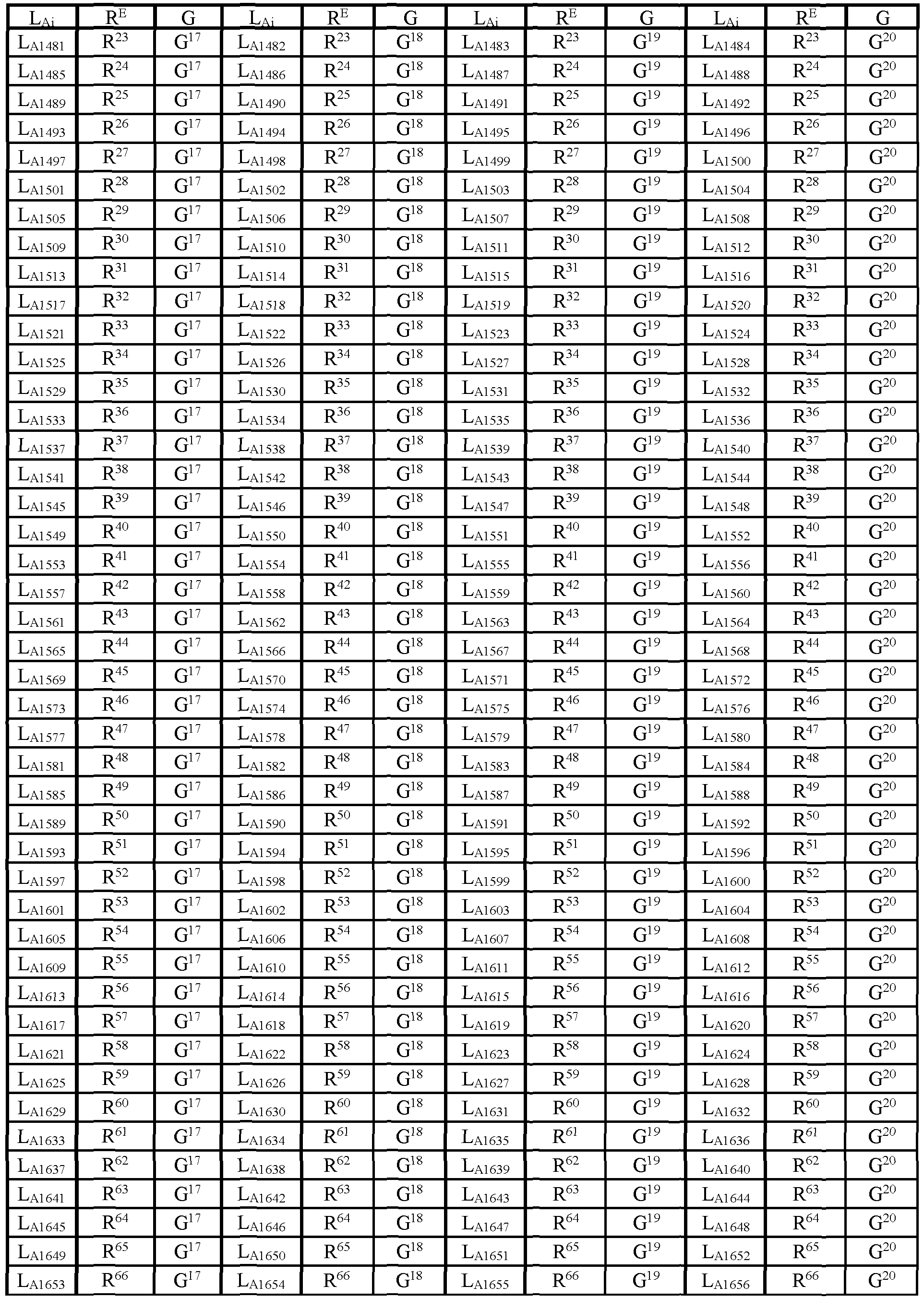 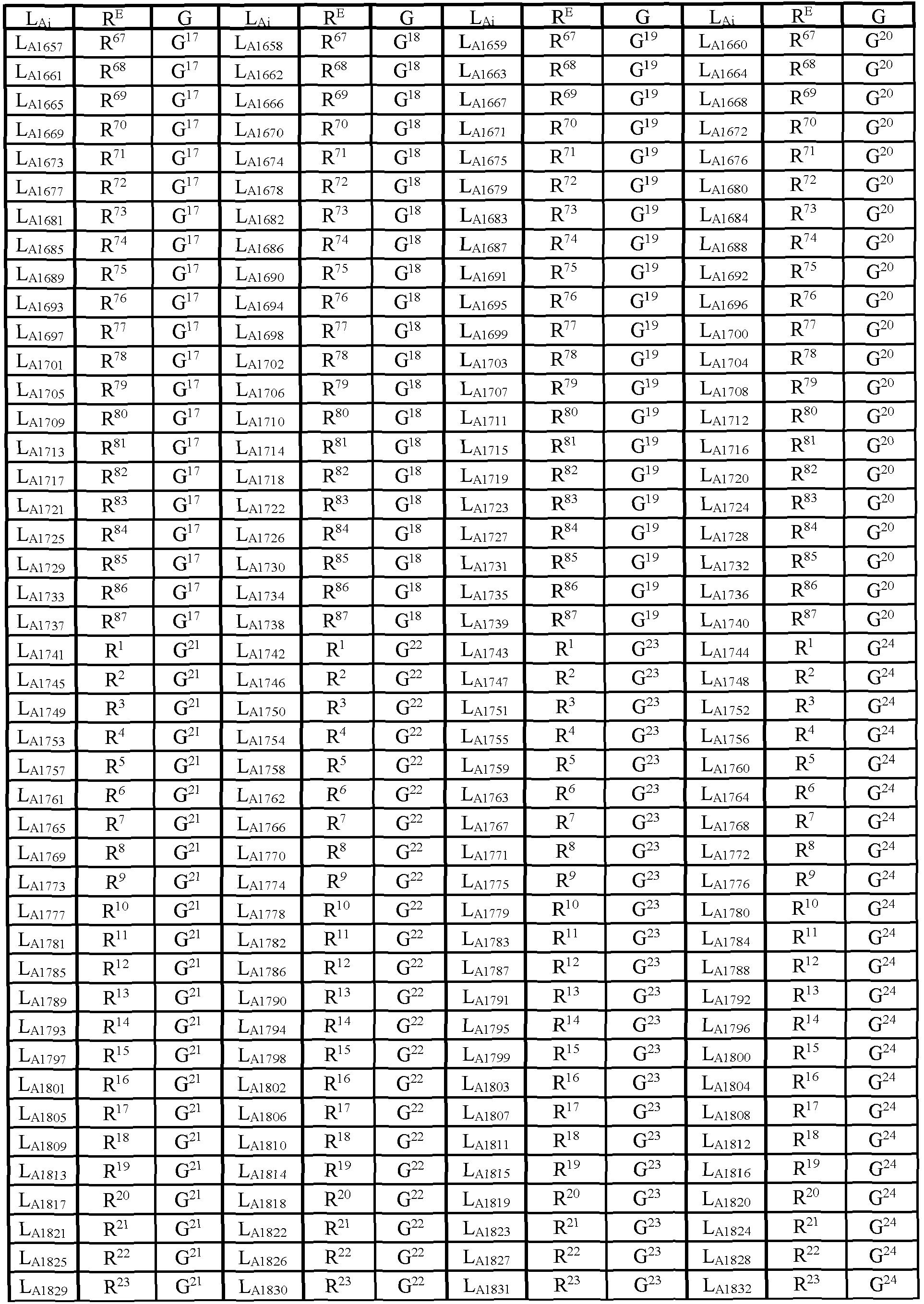 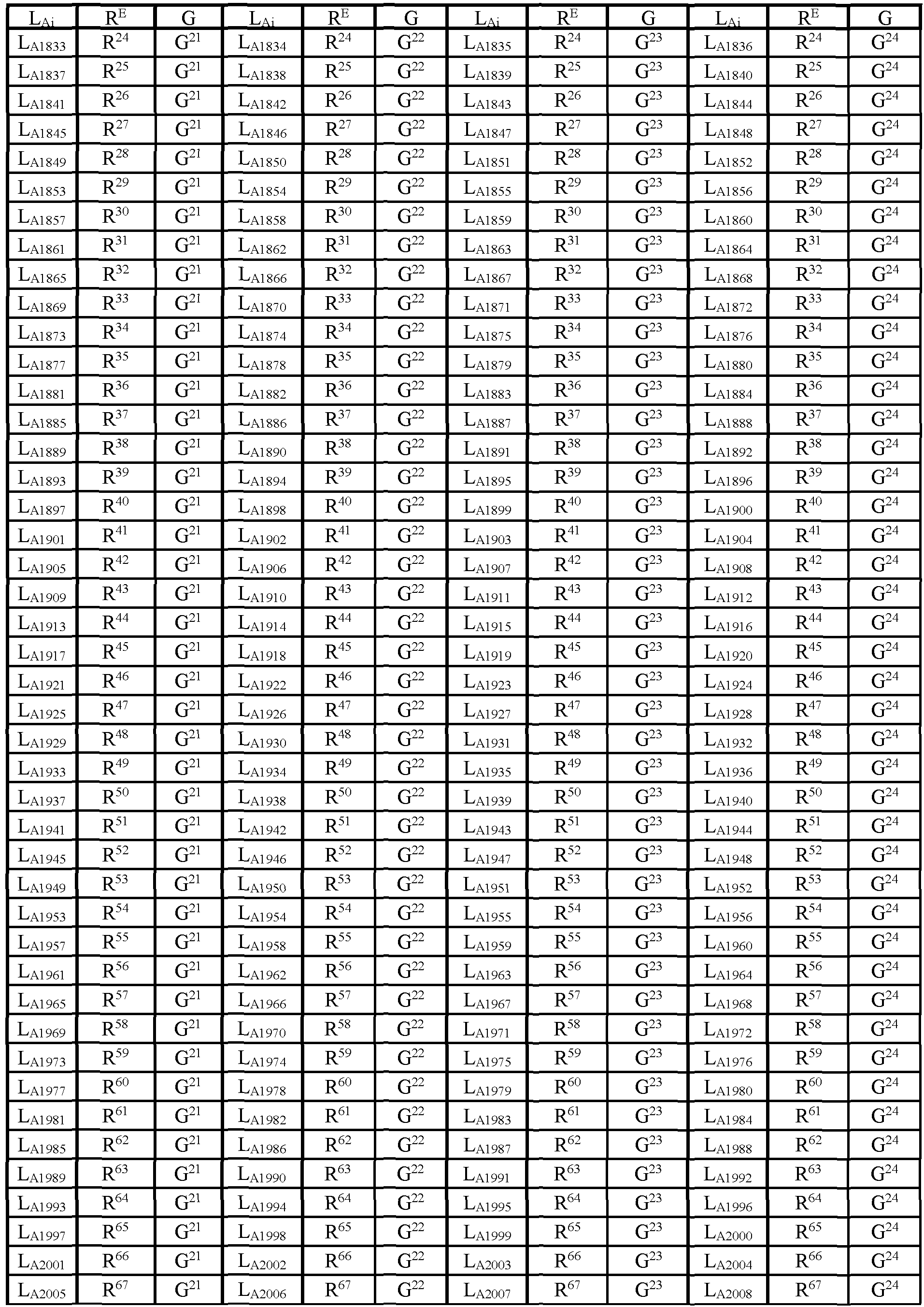 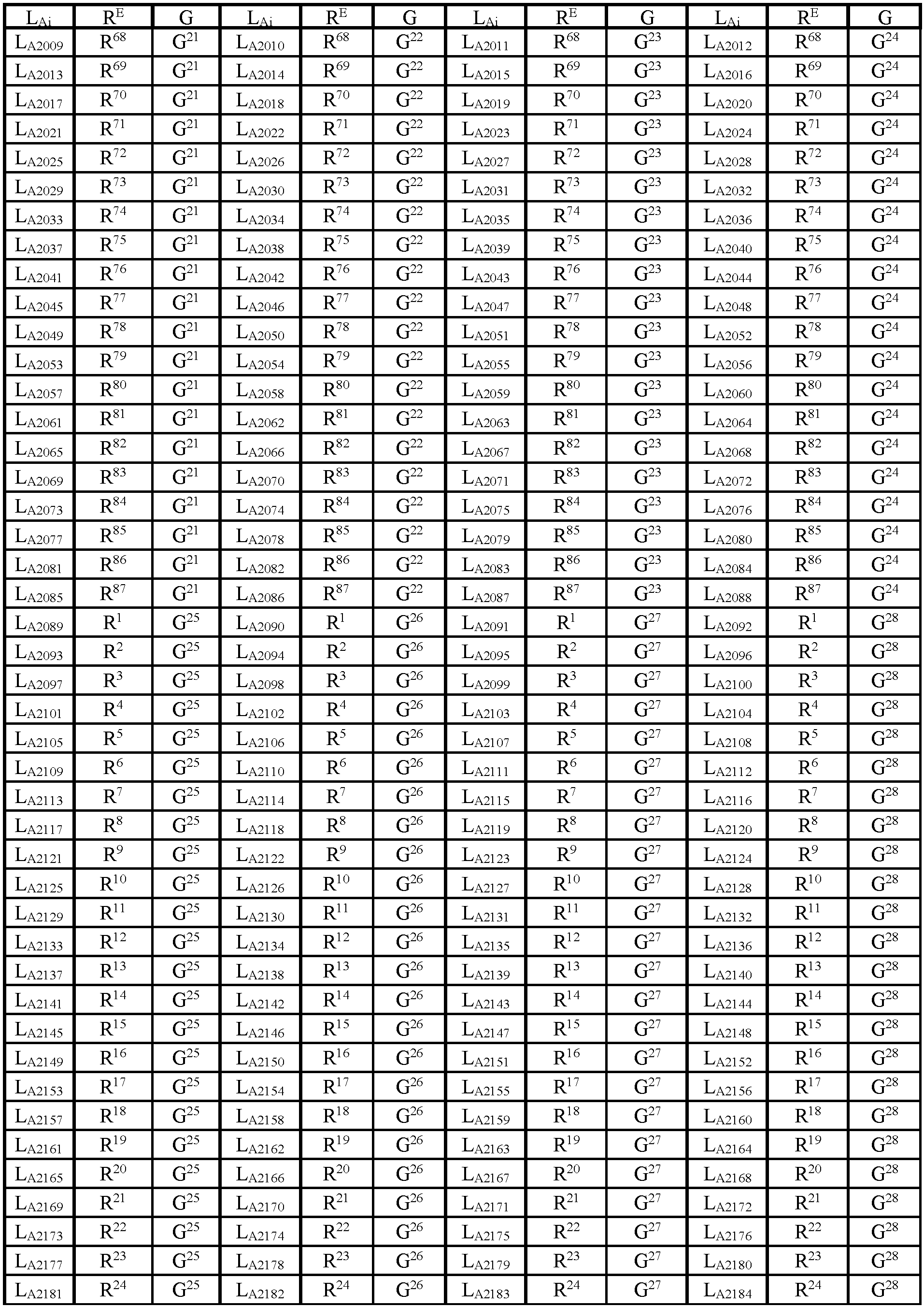 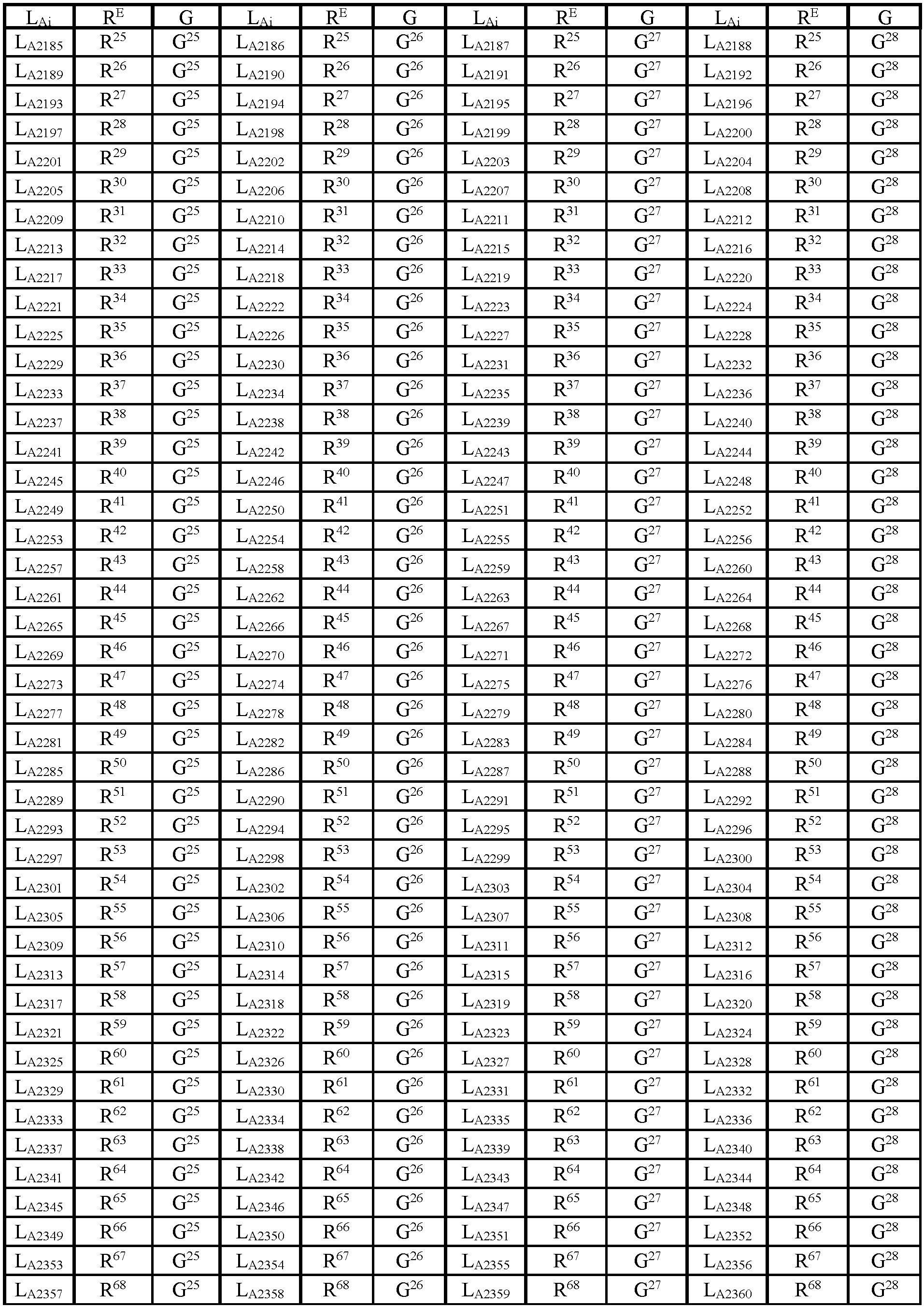 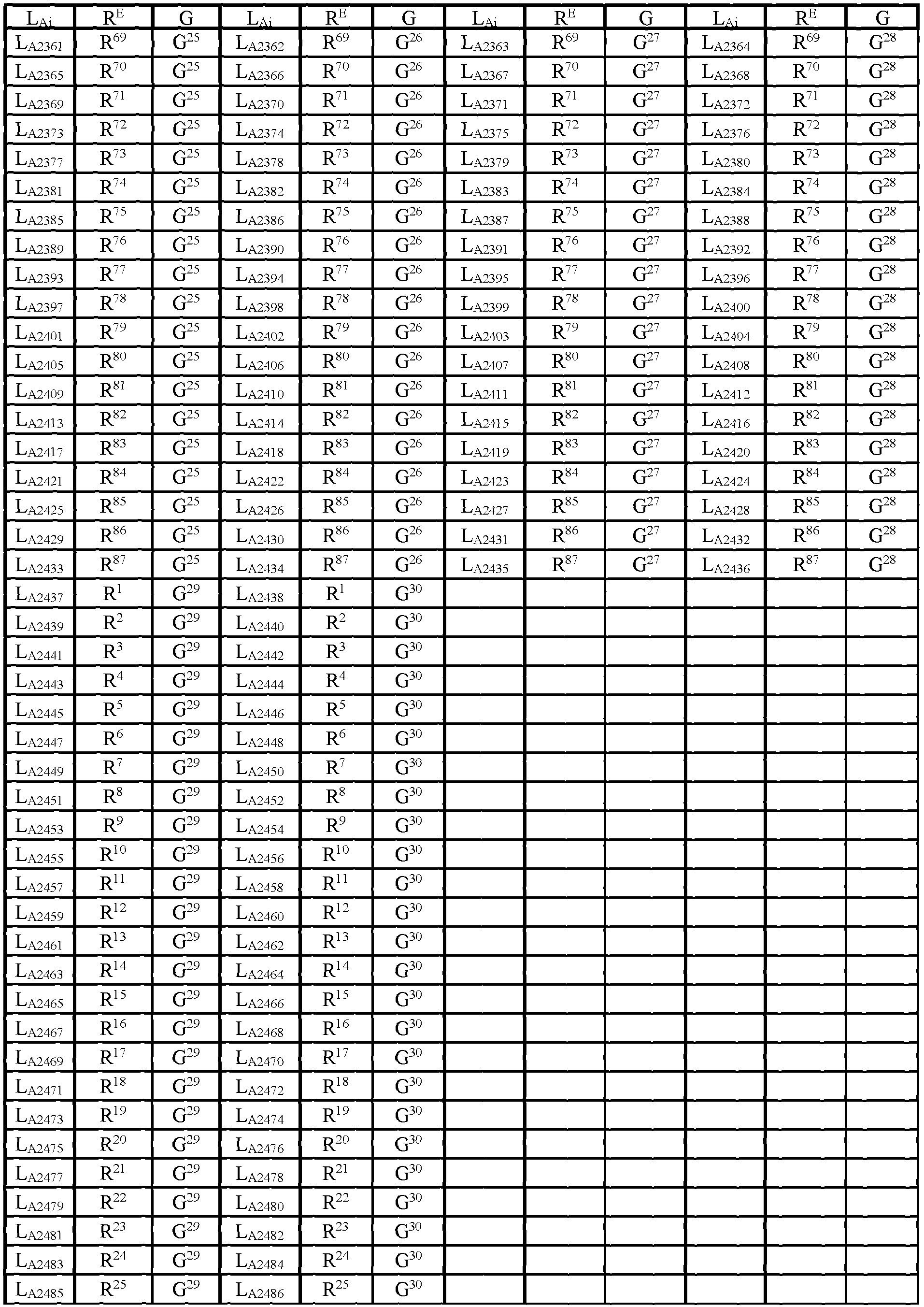 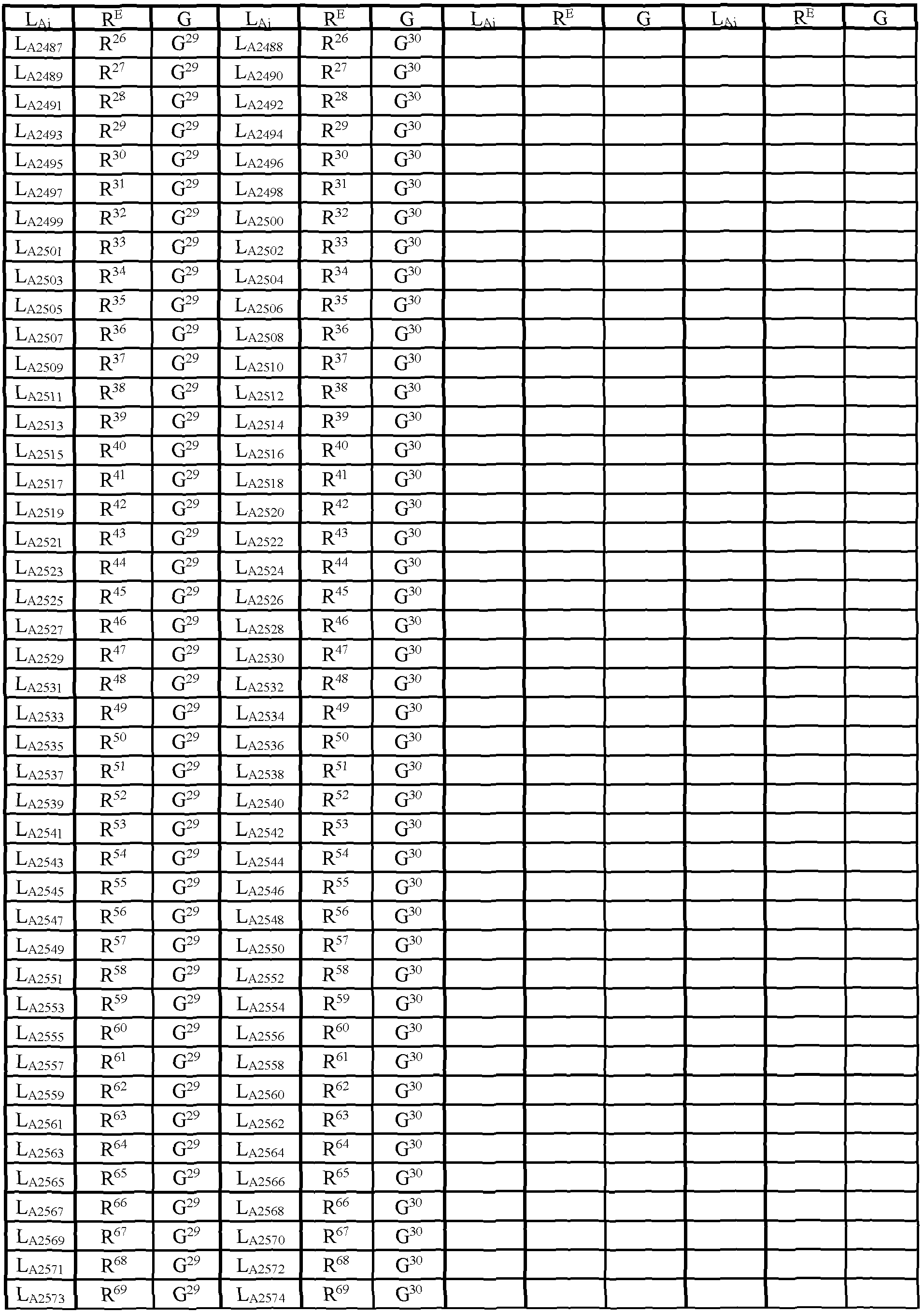 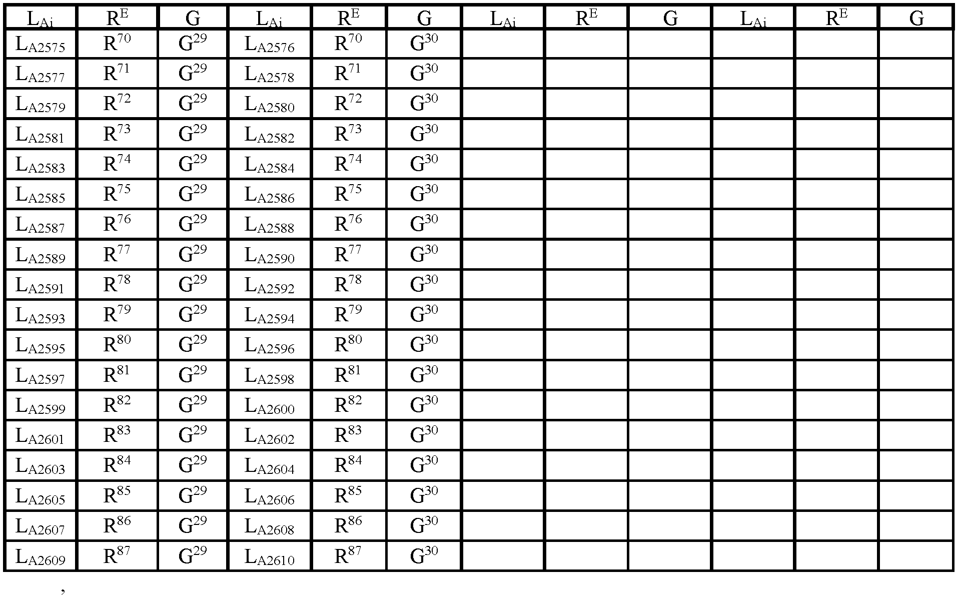 dans lequel chaque élément de R¹ à R⁸⁷ a la structure définie comme suit : 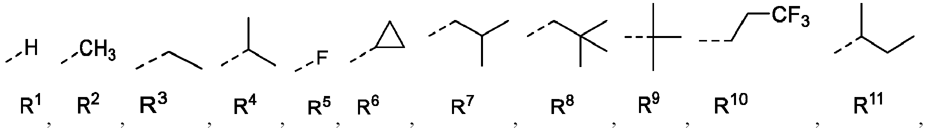 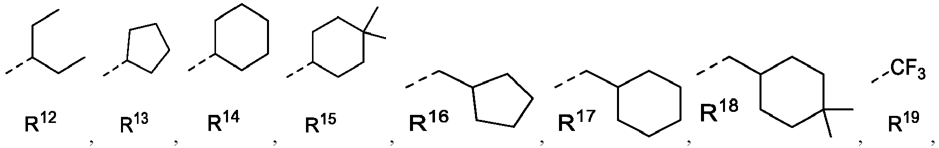 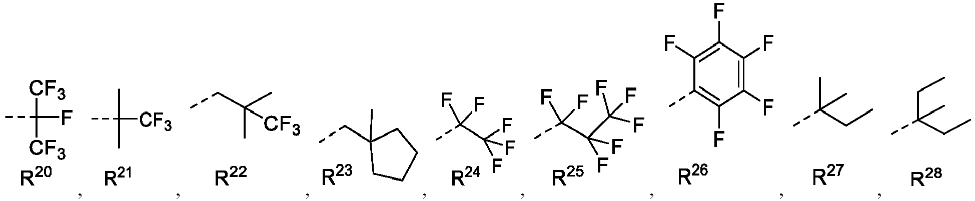 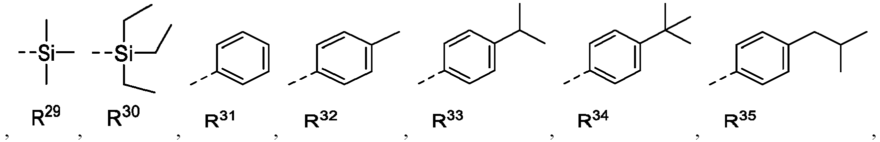 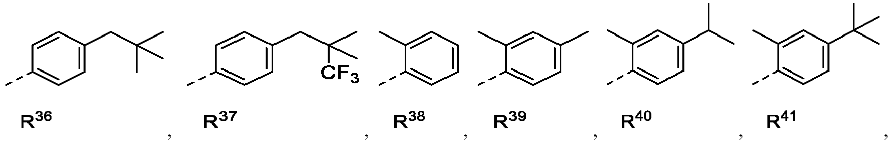 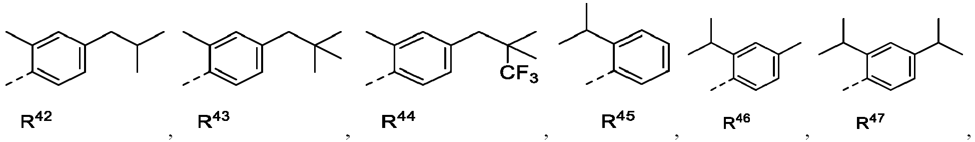 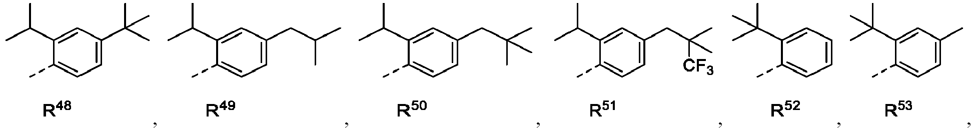 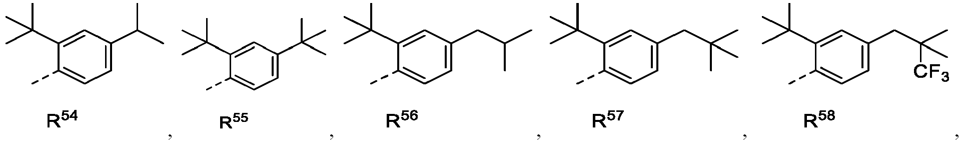 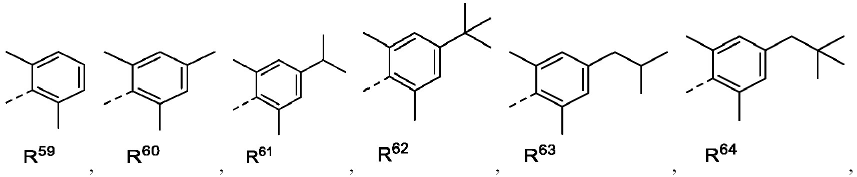 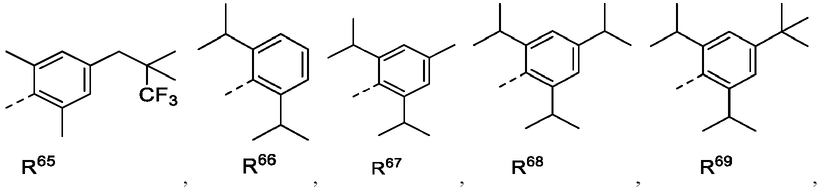 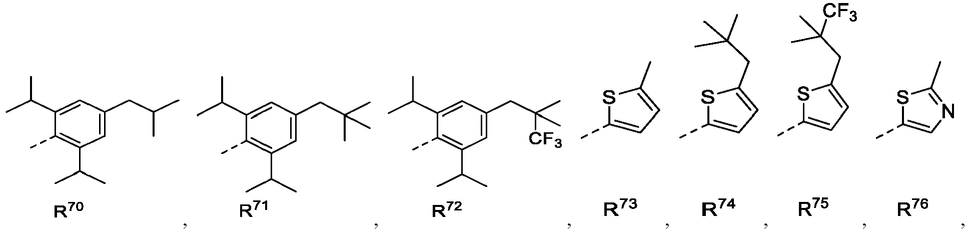 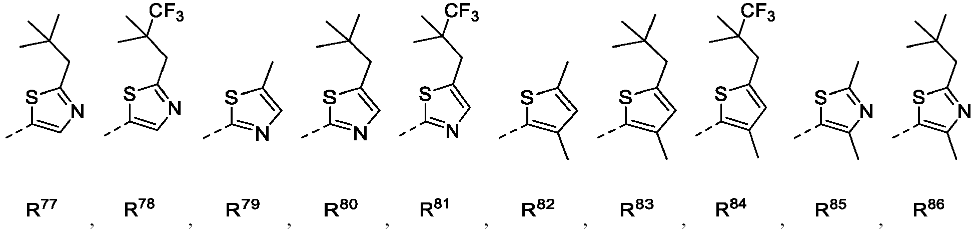 et 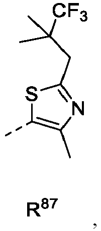 et
dans lequel chaque élément de G¹ à G³⁰ a la structure définie comme suit :

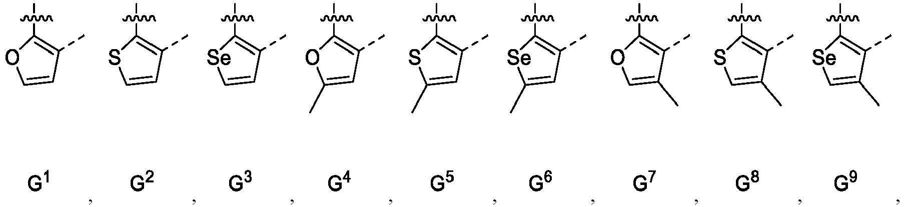

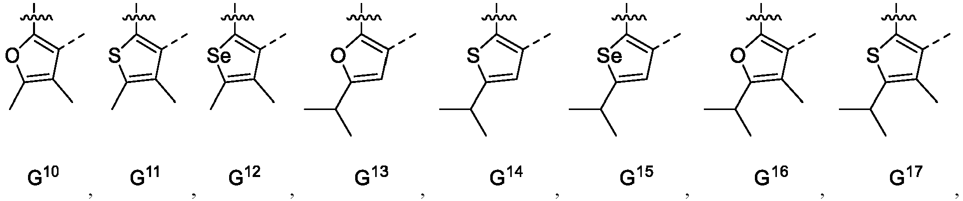

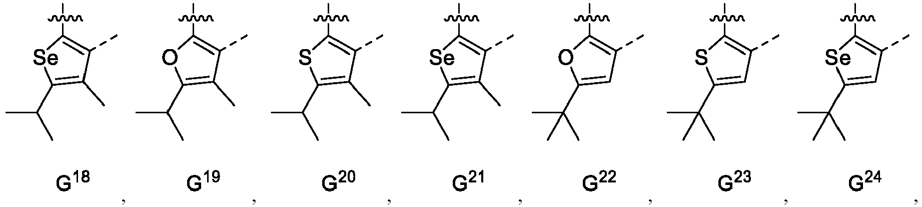

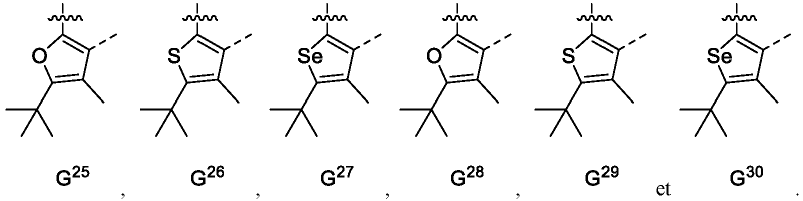

10. Composé selon l'une quelconque des revendications précédentes, dans lequel le composé a une formule choisie parmi le groupe constitué de Ir(L_{A})₃, Ir(L_{A})(L_{B})₂, Ir(L_{A})₂(L_{B}), Ir(L_{A})₂(L_{C}) et Ir(L_{A})(L_{B})(L_{C}), dans lequel L_{B} et Lc sont chacun un ligand bidentate et L_{A}, L_{B} et Lc sont différents les uns des autres, ou le composé a une formule Pt(L_{A})(L_{B}) et dans laquelle L_{A} et L_{B} peuvent être identiques ou différents.

11. Composé selon l'une quelconque des revendications précédentes, dans lequel le composé a une formule M(L_{A})ₚ(L_{B})_{q}(L_{C})ᵣ dans laquelle L_{B} et L_{C} sont chacun un ligand bidentate, et dans laquelle p vaut 1, 2 ou 3, q vaut 0, 1 ou 2, r vaut 0, 1 ou 2, et p+q+r est l'état d'oxydation du métal M, dans laquelle L_{B} et L_{C} sont choisis chacun, indépendamment l'un de l'autre, parmi le groupe constitué de : 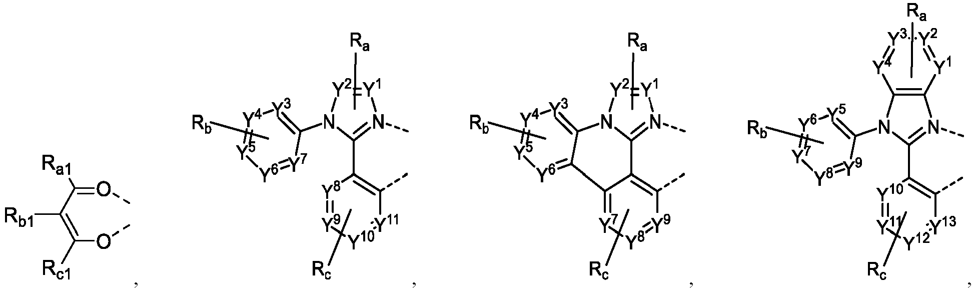 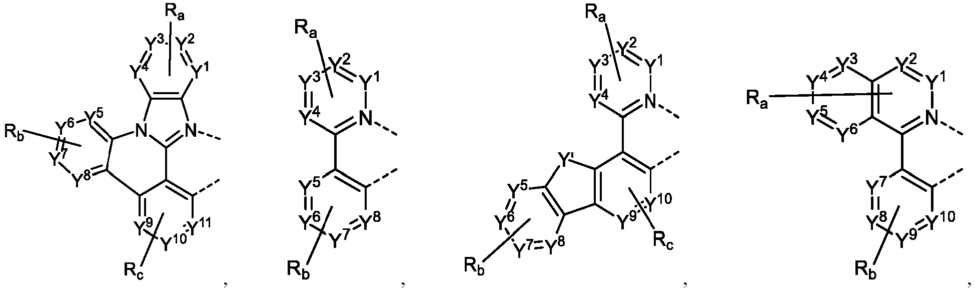 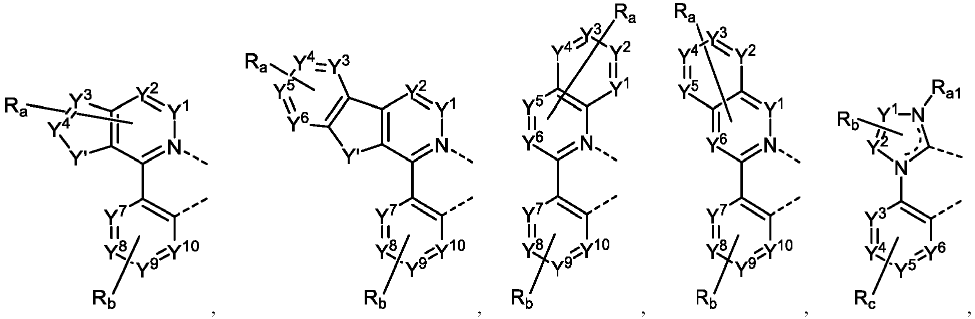 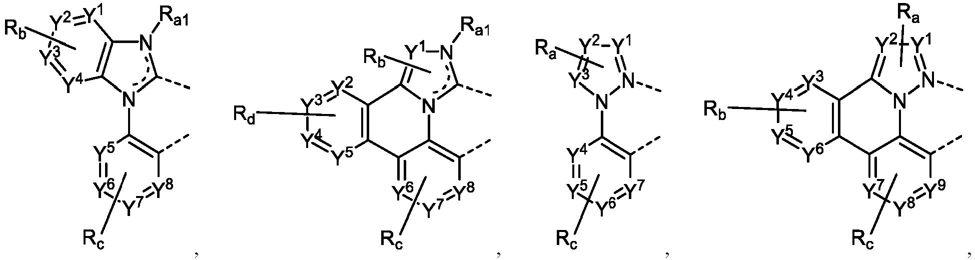 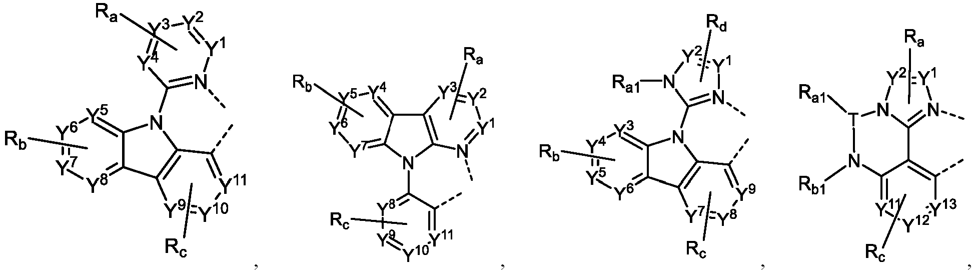 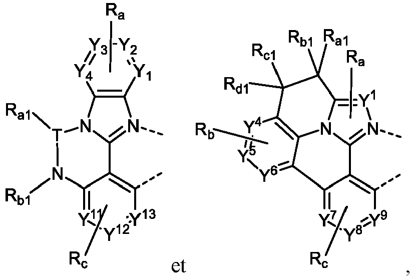 dans lequel :
T est choisi parmi le groupe constitué de B, Al, Ga et In,
les éléments Y¹ à Y¹³ sont choisis chacun, indépendamment les uns des autres, parmi le groupe constitué du carbone et de l'azote,
Y' est choisi parmi le groupe constitué de BRₑ, NRₑ, PRₑ, O, S, Se, C=O, S=O, SO₂, CRₑR_{f}, SiRₑR_{f} et GeRₑR_{f},
les éléments Rₐ, R_{b}, R_{c} et R_{d} représentent chacun, indépendamment les uns des autres, zéro substitution, une mono-substitution ou jusqu'à un nombre maximal de substitutions autorisées,
les éléments Rₐ₁, R_{b1}, R_{c1}, R_{d1}, Rₐ, R_{b}, R_{c}, R_{d}, Rₑ et R_{f} sont chacun, indépendamment les uns des autres, un hydrogène ou un substituant choisi parmi le groupe constitué des substituants généraux définis ici, et
deux éléments adjacents quelconques parmi Rₐ, R_{b}, R_{c}, R_{d}, Rₑ et R_{f} peuvent être fusionnés ou liés pour former un cycle ou former un ligand multidentate.

12. Composé selon la revendication 9, dans lequel lorsque le composé a la formule Ir(L_{A*i-m-X*})₃, *i* est un entier de 1 à 2 610, *m* est un entier de 1 à 108, et le composé est choisi parmi le groupe constitué de Ir(L_{A*1-1-1*})₃ à Ir(L_{A*2610-108-3*})₃,
lorsque le composé a la formule Ir(L_{A*i*-*m*-*X*})(L_{B*k*})₂, *i* est un entier de 1 à 2 610, *m* est un entier de 1 à 108, *k* est un entier de 1 à 324, et le composé est choisi parmi le groupe constitué de Ir(L_{A*1-1-1*})(L_{B*1*})₂ à Ir(L_{A*2610-108-3*})(L_{B*324*})₂,
lorsque le composé a la formule Ir(L_{A*i-m-X*})₂(L_{B*k*}), *i* est un entier de 1 à 2 610, *m* est un entier de 1 à 108, *k* est un entier de 1 à 324, et le composé est choisi parmi le groupe constitué de Ir(L_{A*1-1-1*})₂(L_{B*1*}) à Ir(L_{A*2610-108-3*})₂(L_{B*324*}),
lorsque le composé a la formule Ir(L_{A*i-m-X*})₂(L_{C*j*-I}), *i* est un entier de 1 à 2 610, *m* est un entier de 1 à 108, *j* est un entier de 1 à 1416, et le composé est choisi parmi le groupe constitué de Ir(L_{A*1-1-1*})₂(L_{C*1*-I}) à Ir(L_{A*2610-108-3*})(L_{C*1416-*I}), et
lorsque le composé a la formule Ir(L_{A*i-m-X*})₂(L_{C*j*-II}), *i* est un entier de 1 à 2 610, *m* est un entier de 1 à 108, *j* est un entier de 1 à 1 416, et le composé est choisi parmi le groupe constitué de Ir(L_{A*1*-*1*-*1*})₂(L_{C*1*-II}) à Ir(L_{A*2610-108-3*})(L_{C*1416*-II}),
dans lequel chaque élément L_{B*k*} de L_{B1} à L_{B324} a la structure définie comme suit : 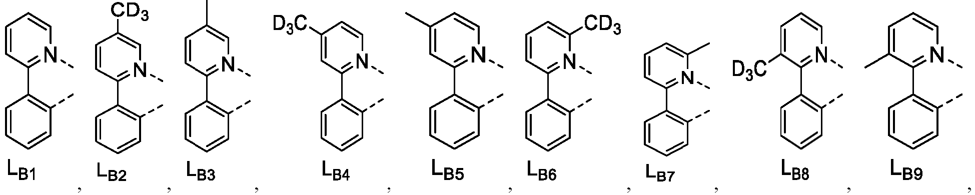 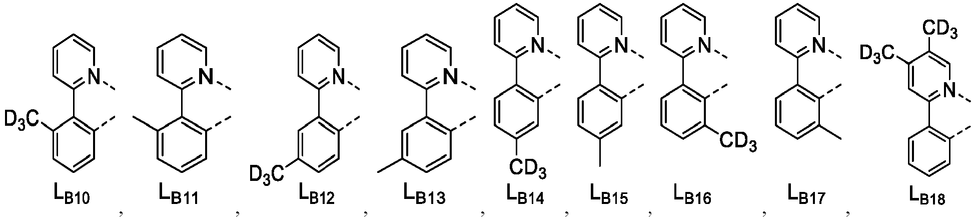 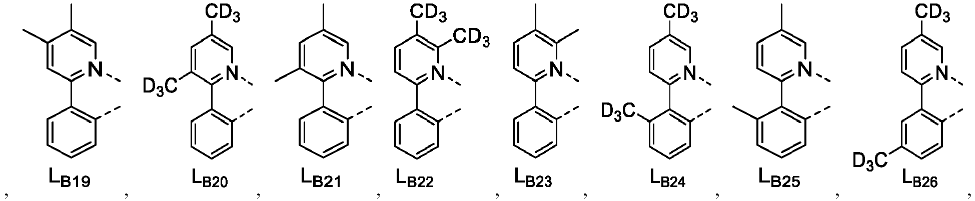 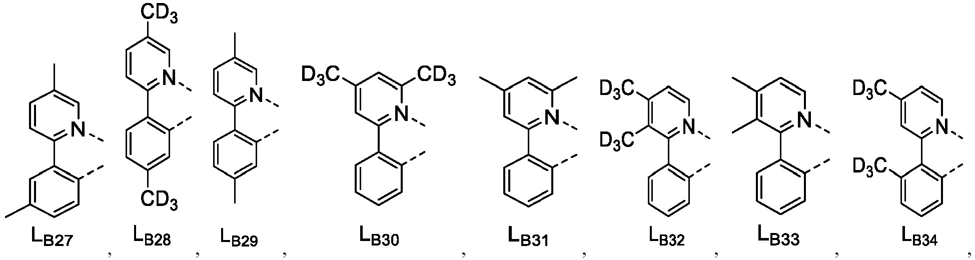 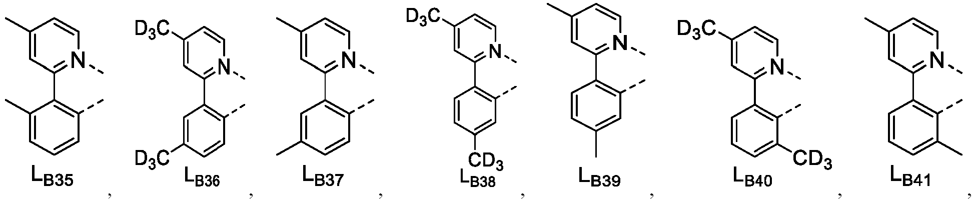 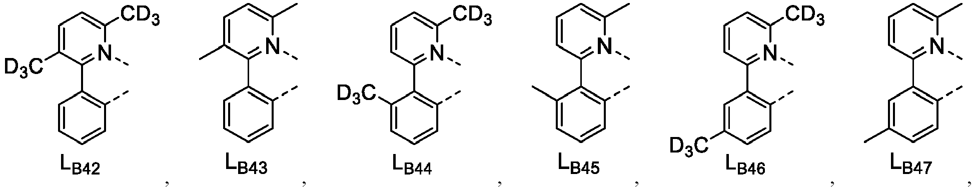 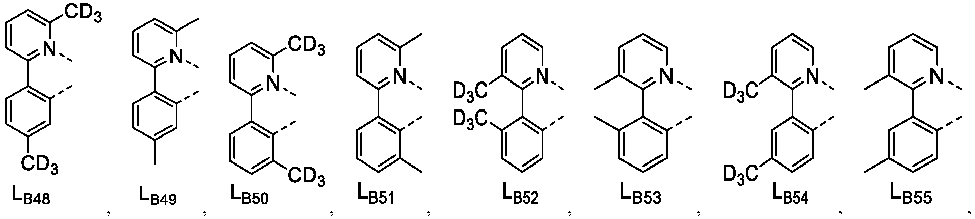 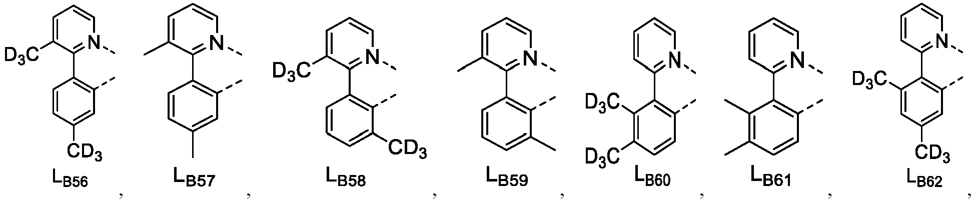 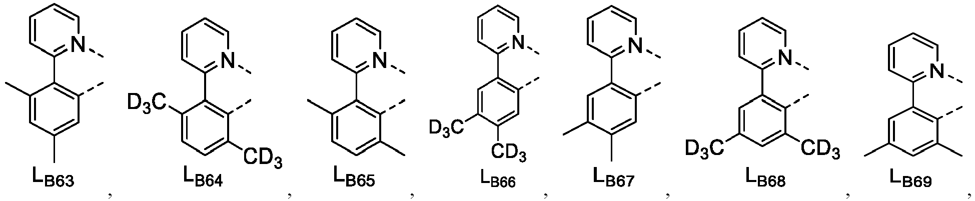 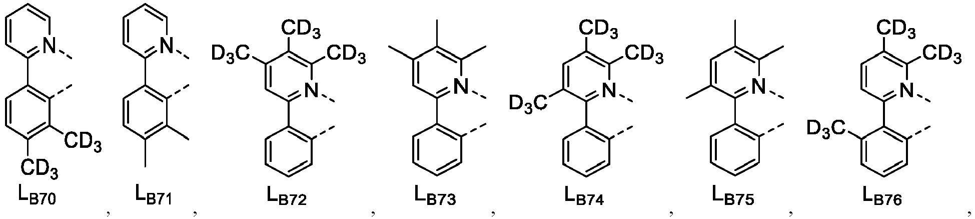 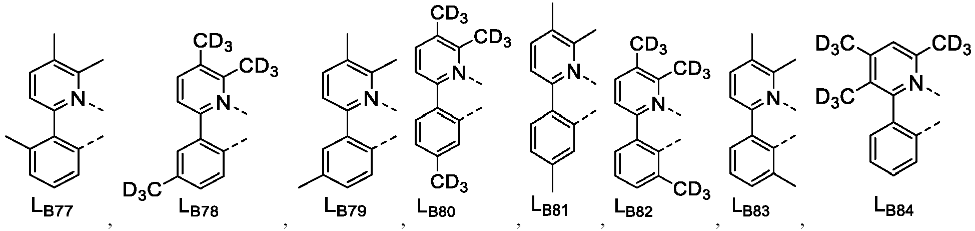 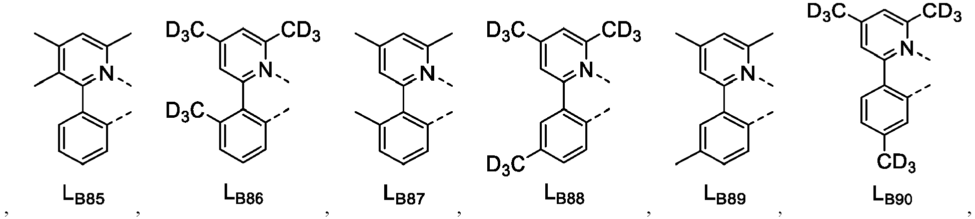 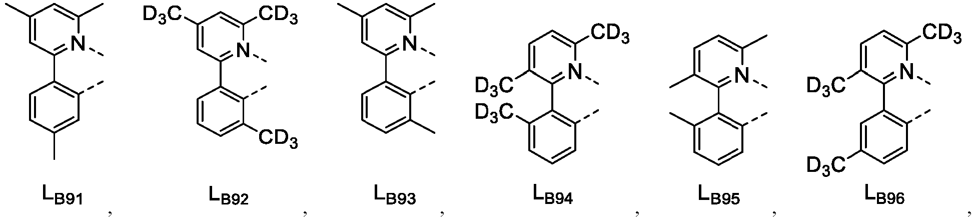 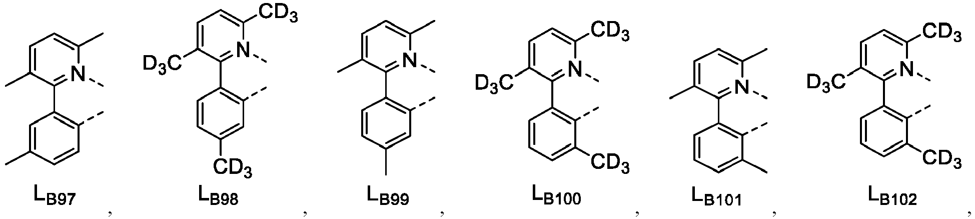 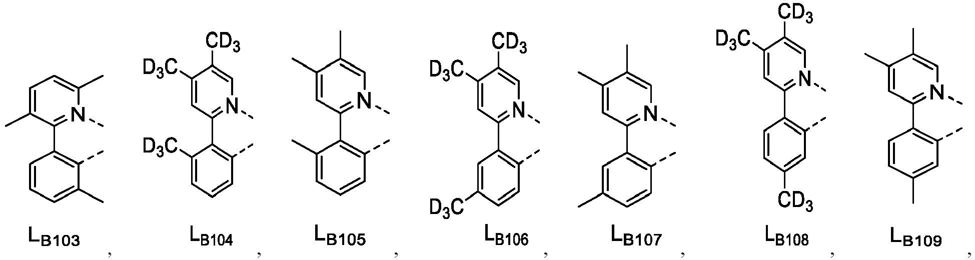 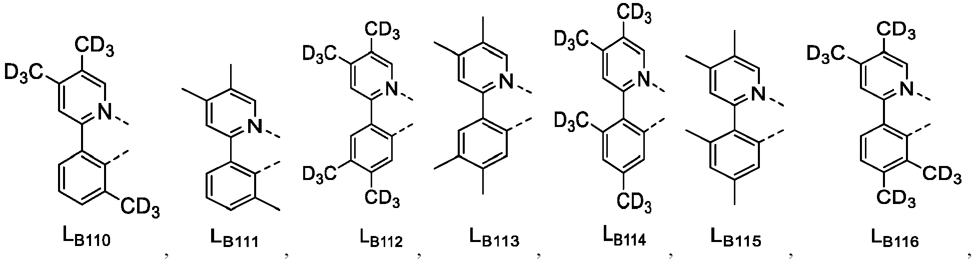 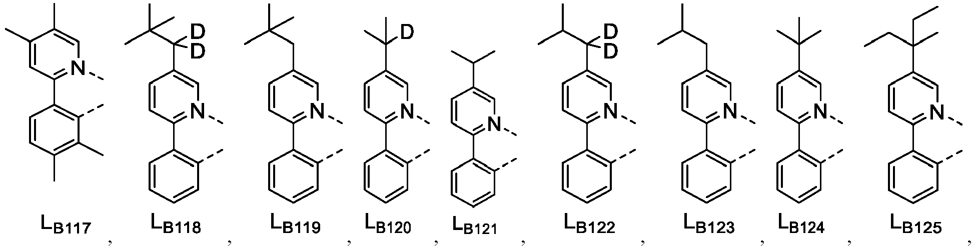 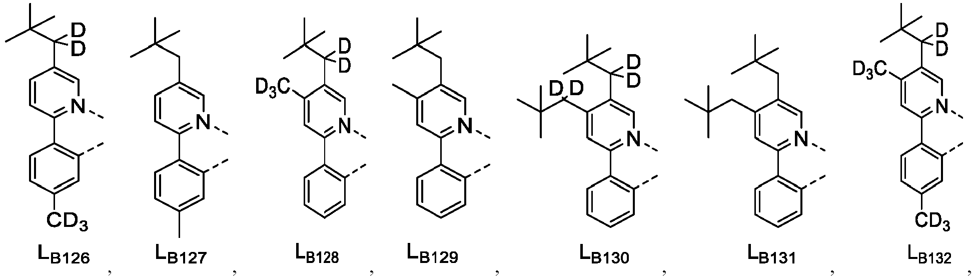 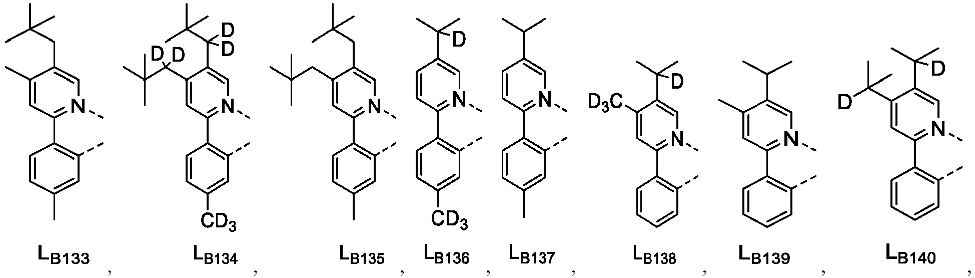 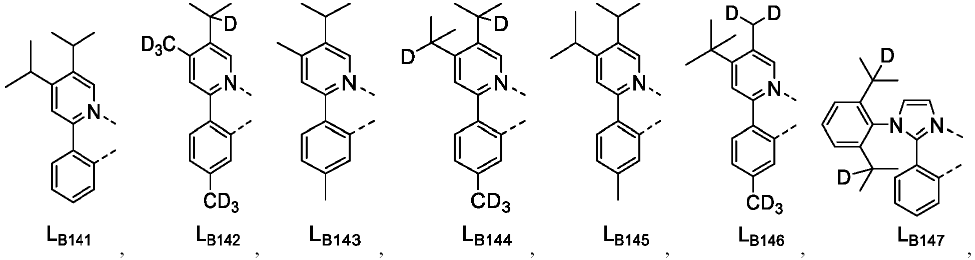 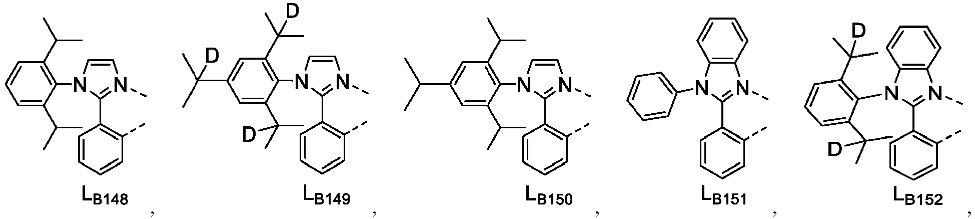 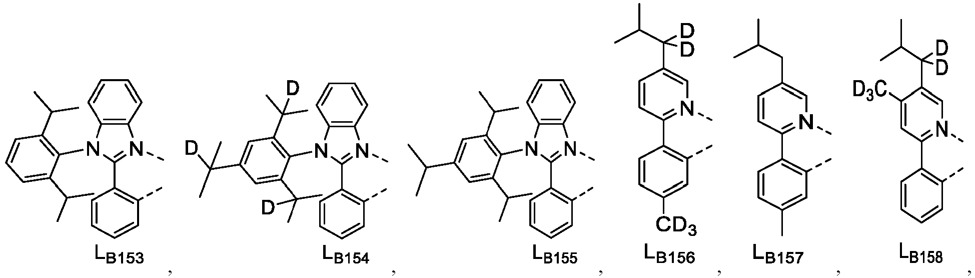 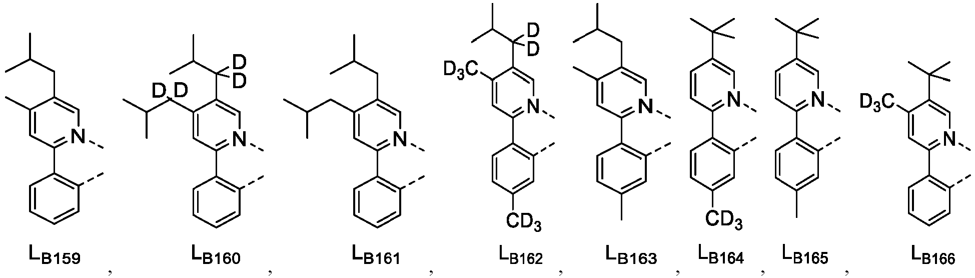 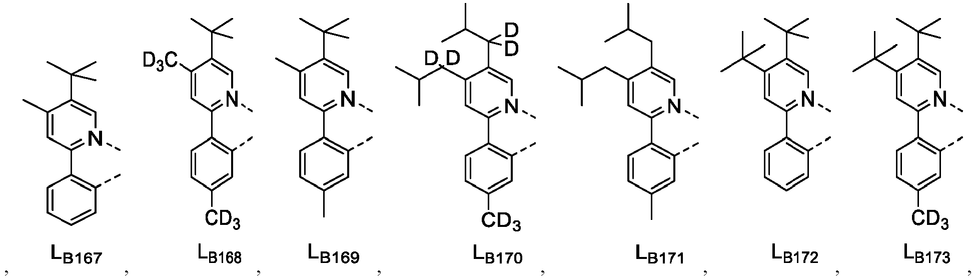 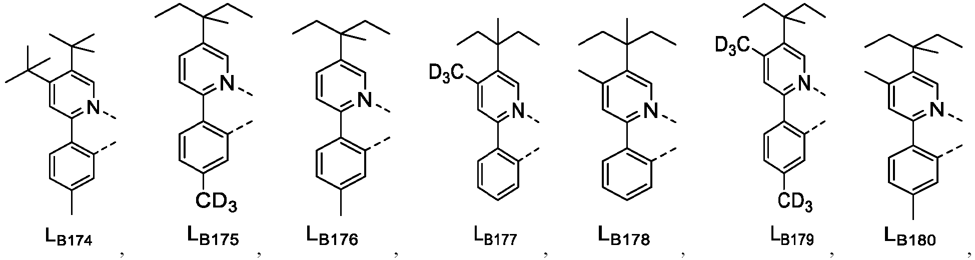 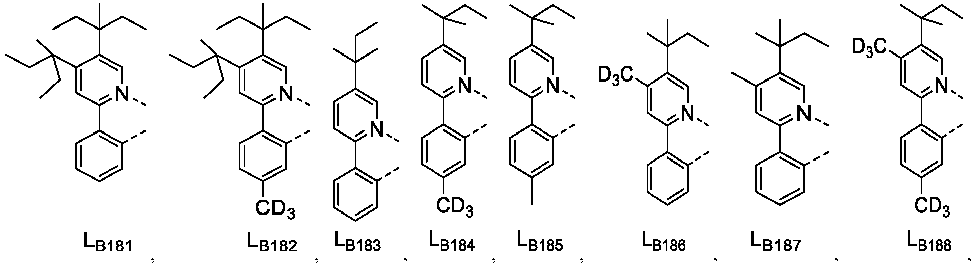 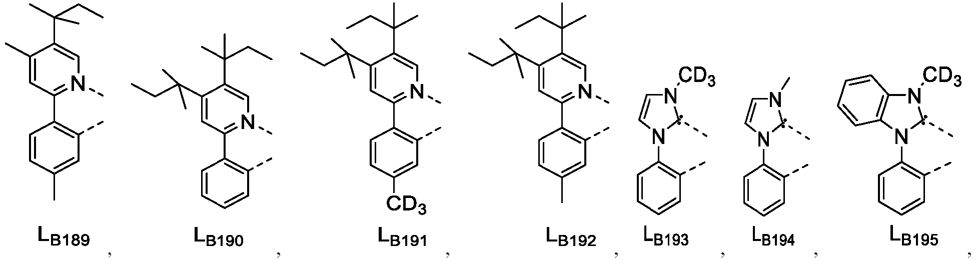 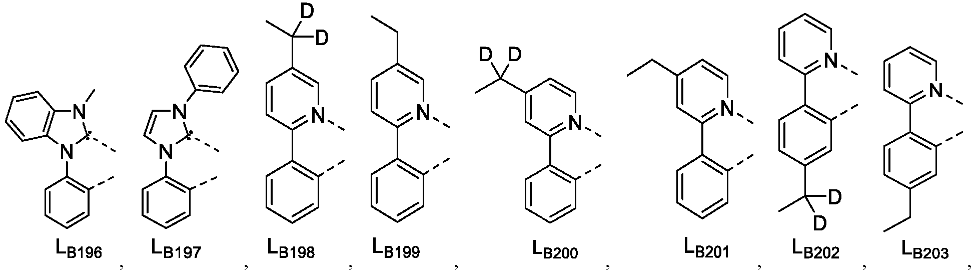 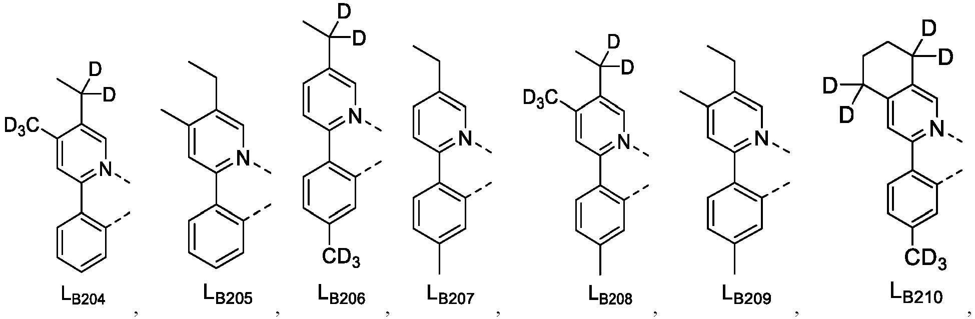 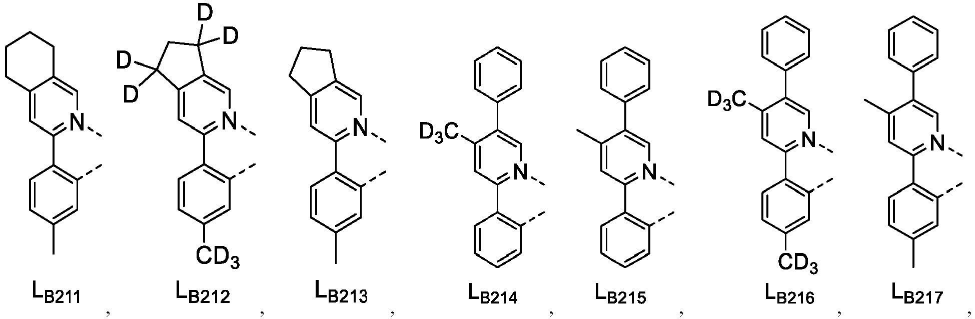 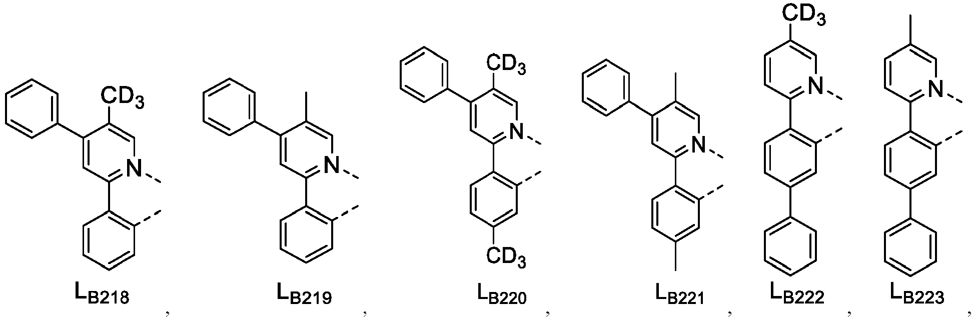 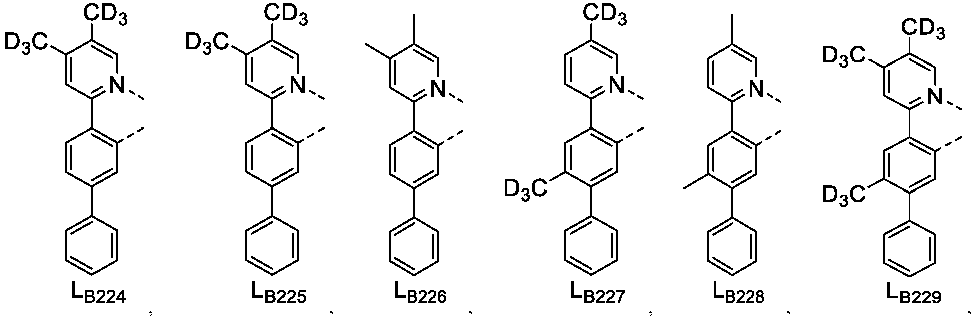 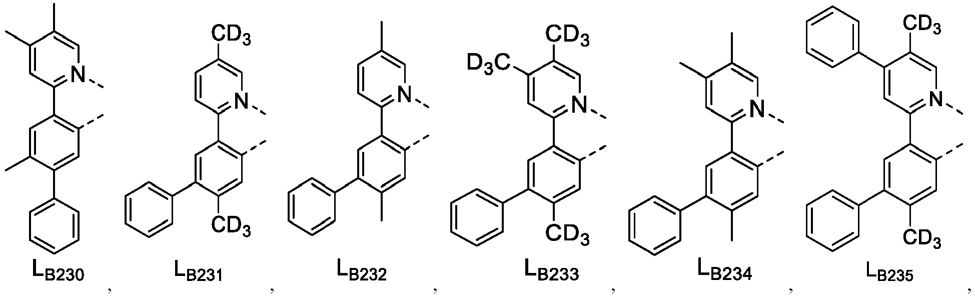 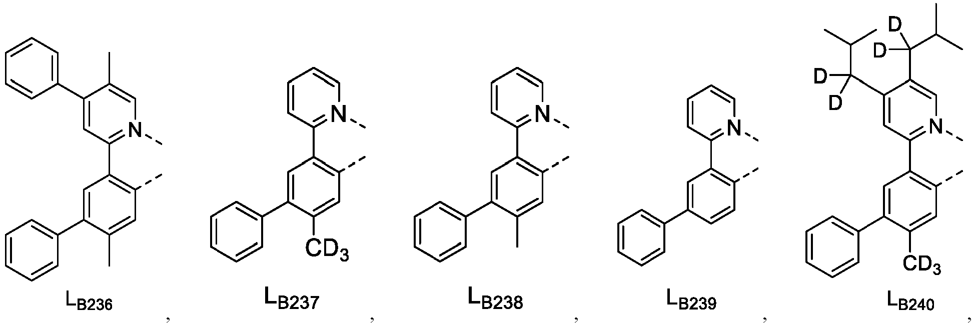 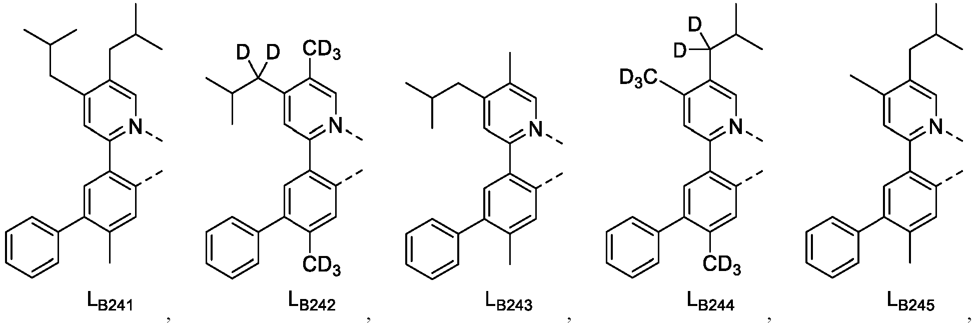 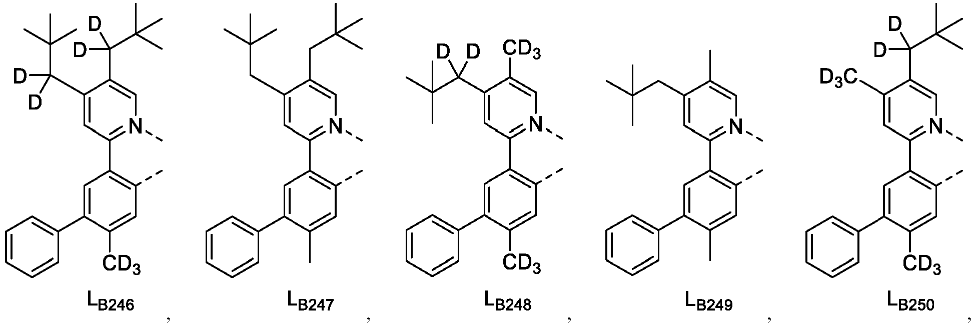 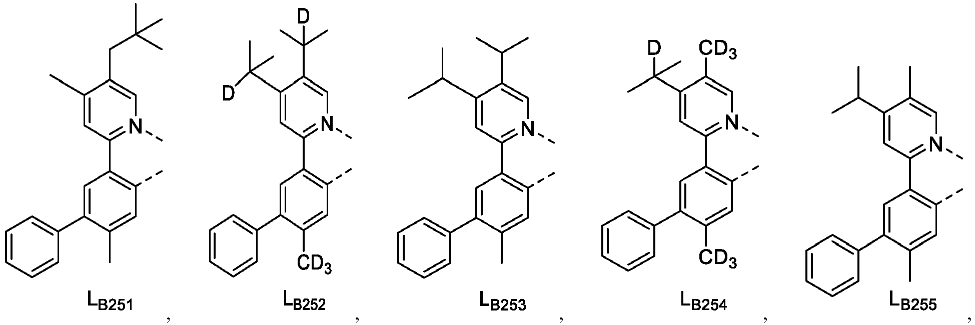 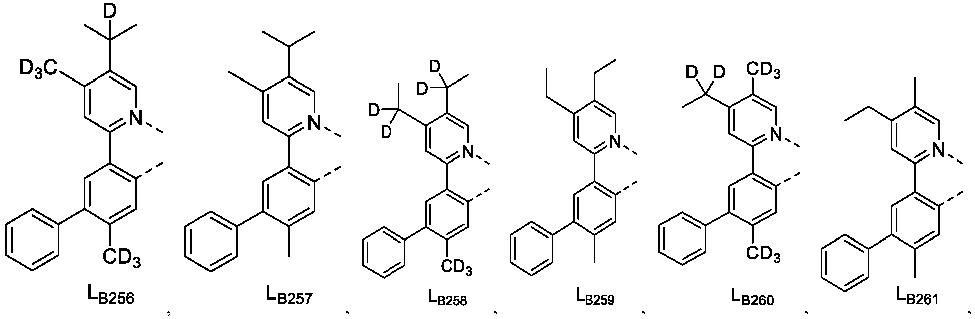 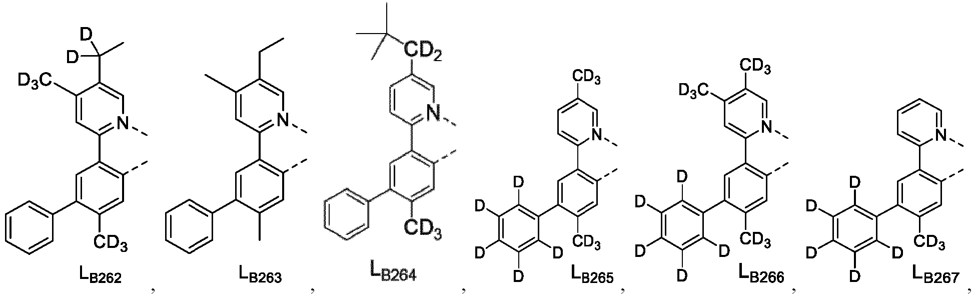 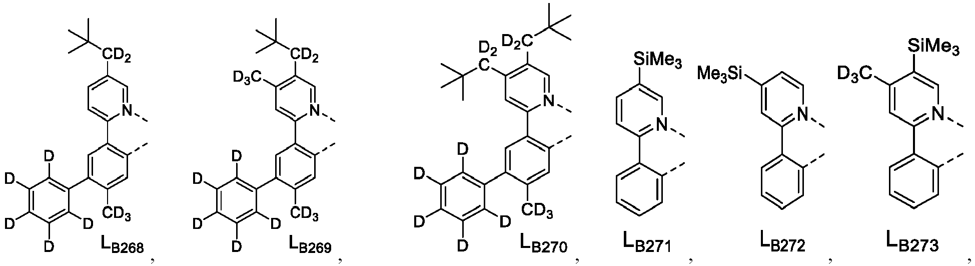 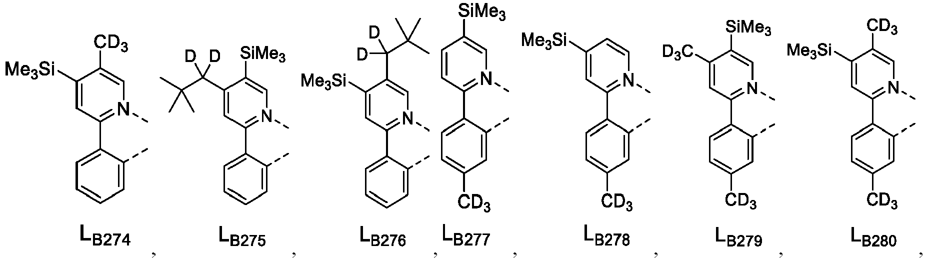 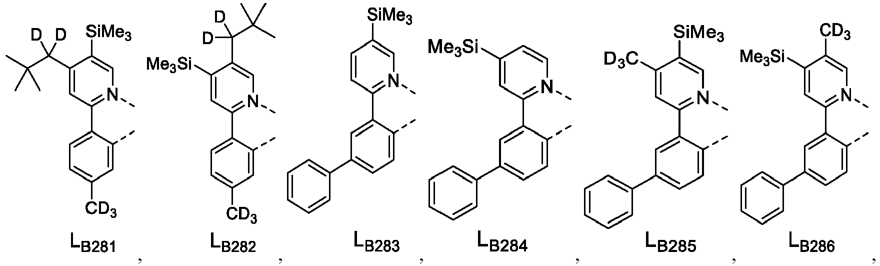 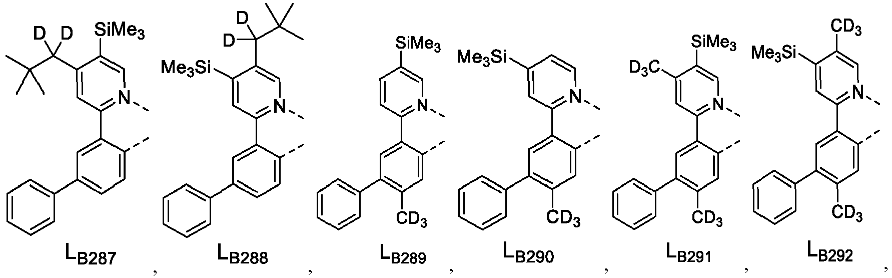 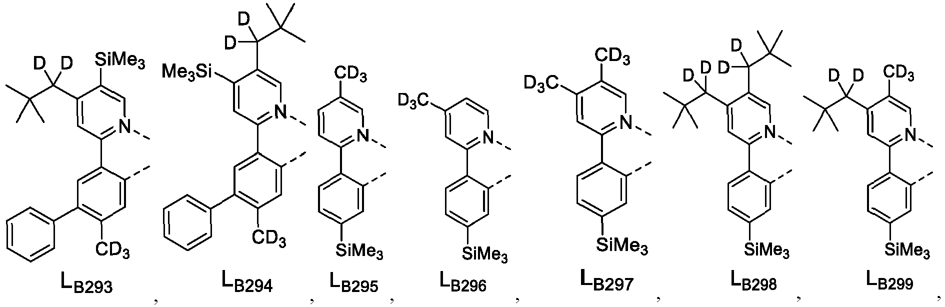 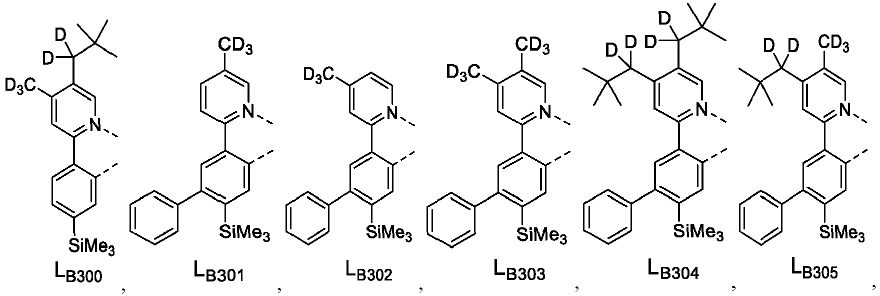 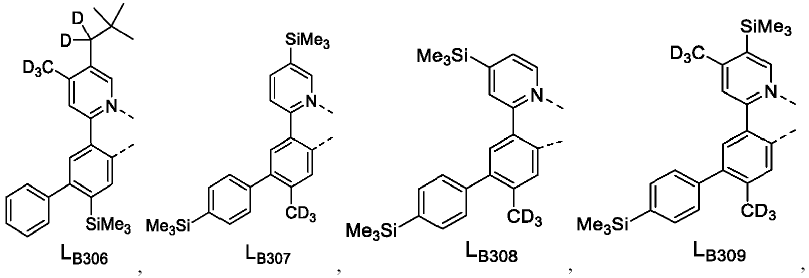 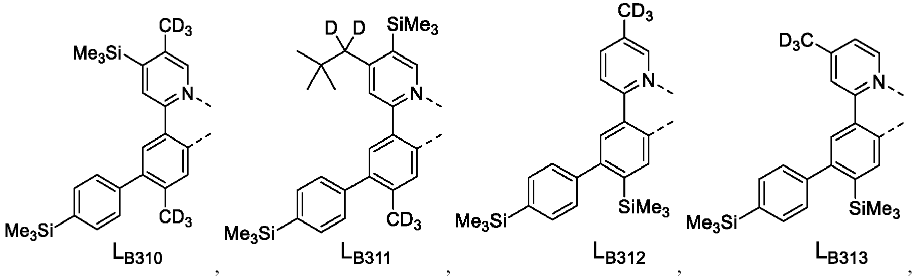 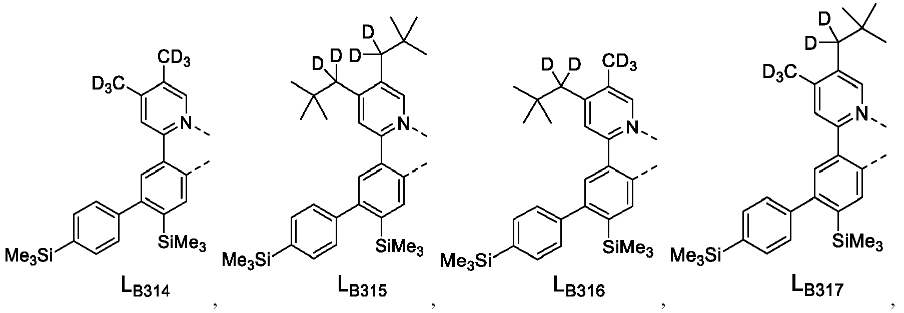 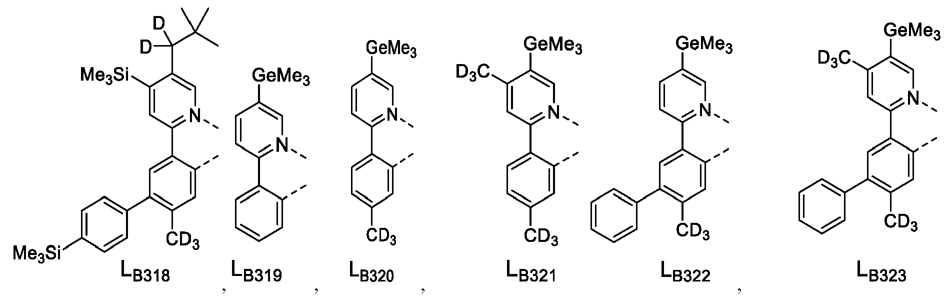 et 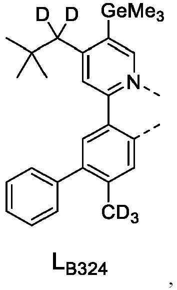
dans lesquel chaque L_{C*j*-I} a une structure basée sur la formule 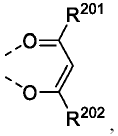 et chaque L_{C*j*-II} a une structure basée sur la formule 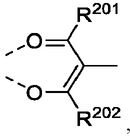 dans lequel pour chaque L_{C*j*} dans L_{C*j*-I} et L_{C*j*-II}, R²⁰¹ et R²⁰² sont définis chacun, indépendamment l'un de l'autre, comme suit : 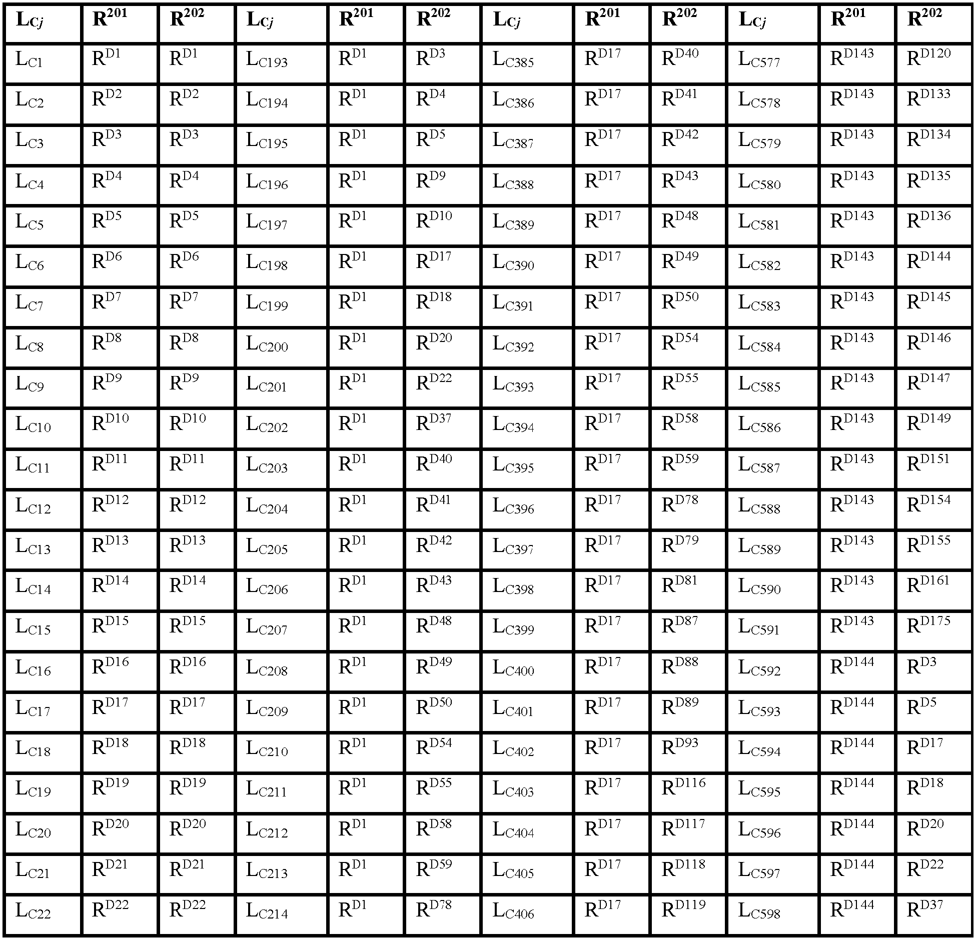 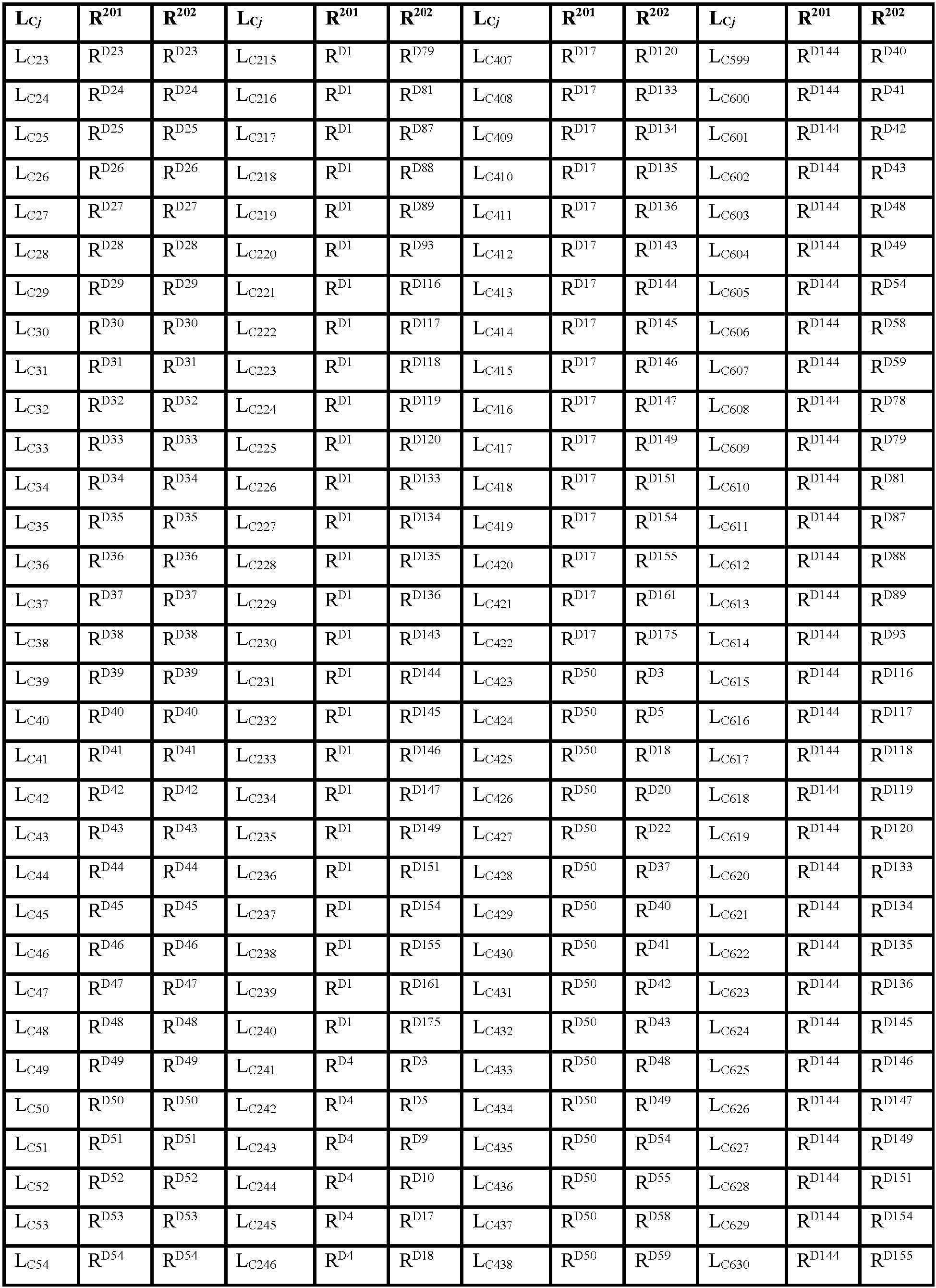 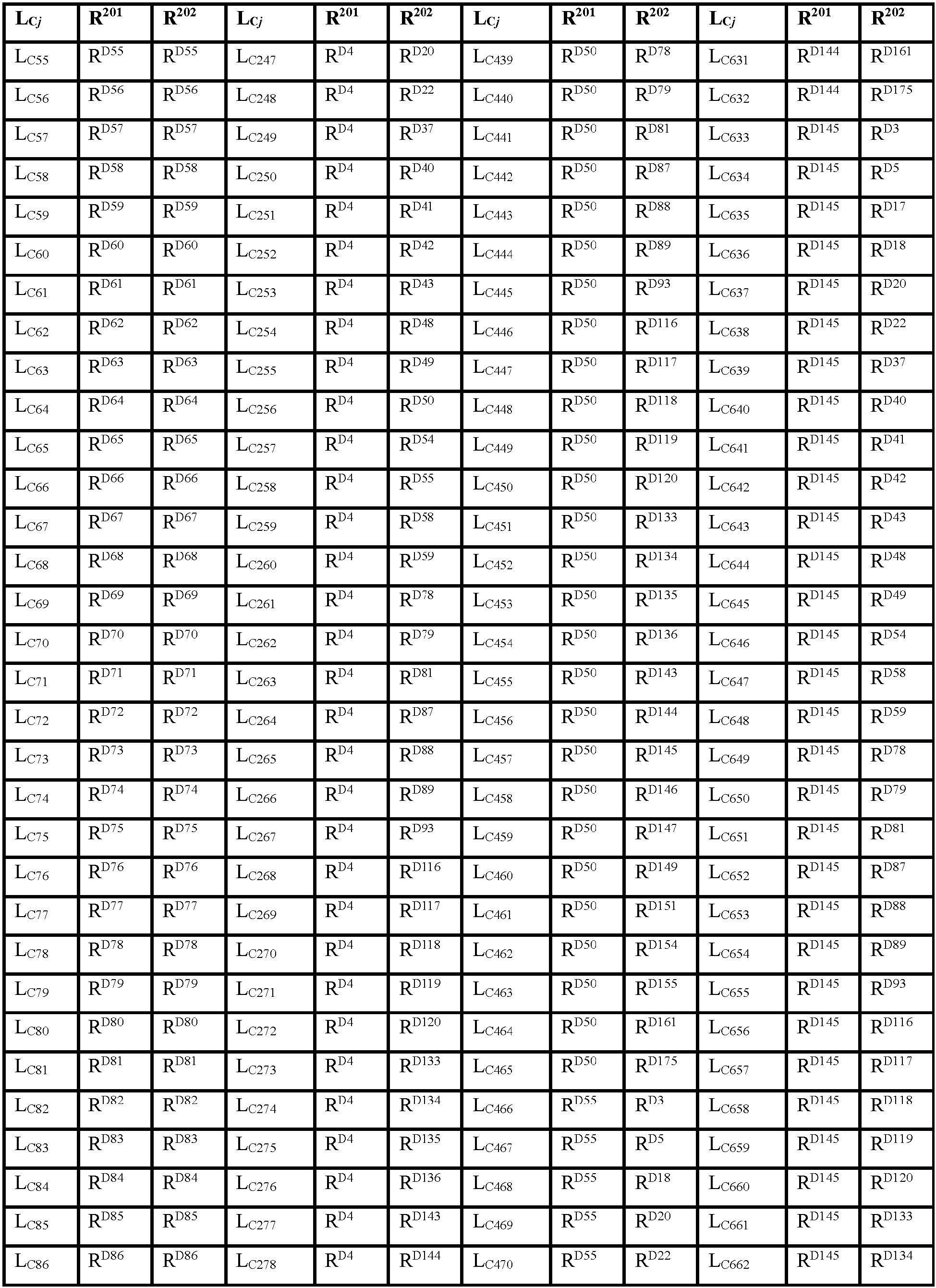 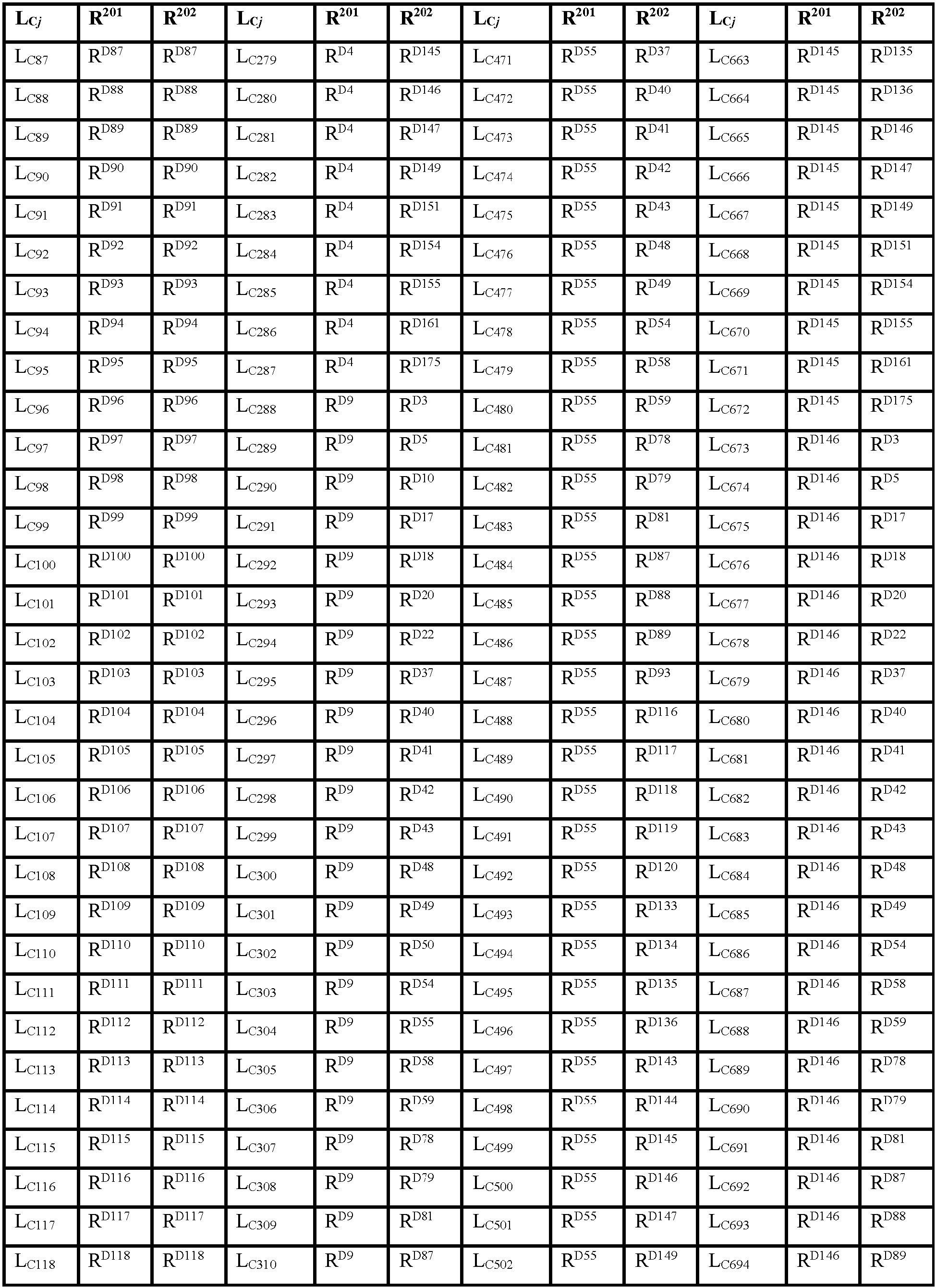 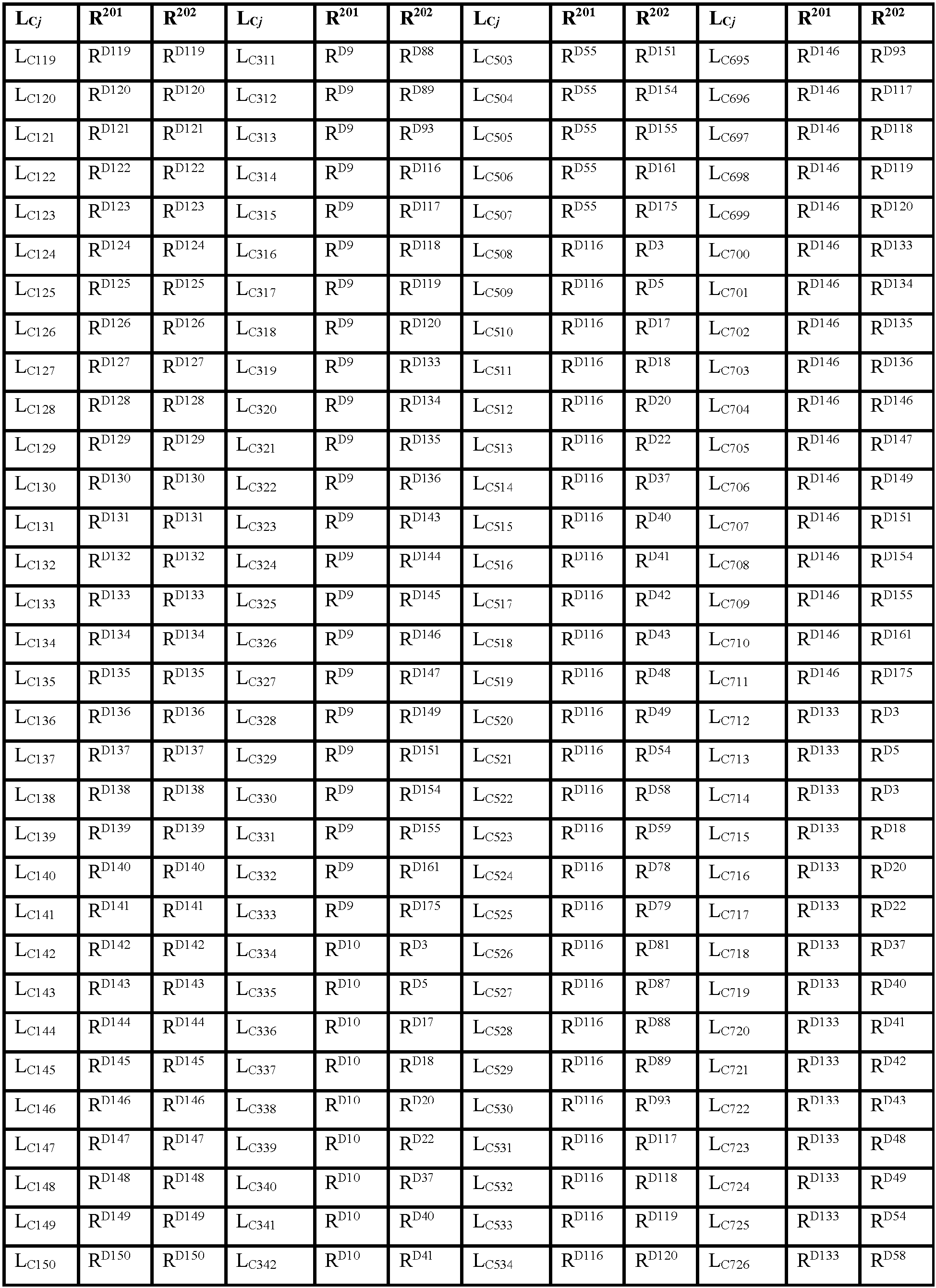 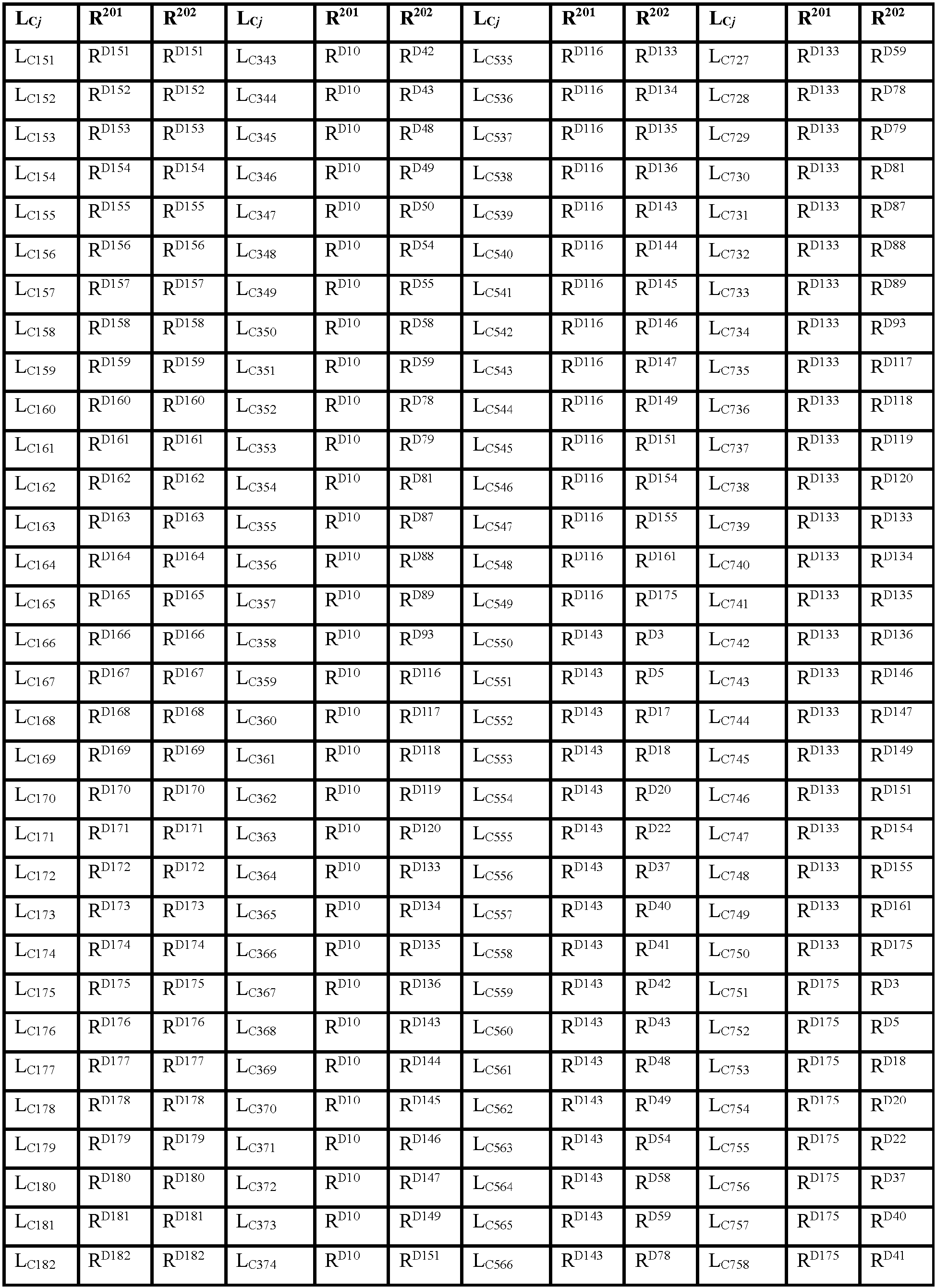 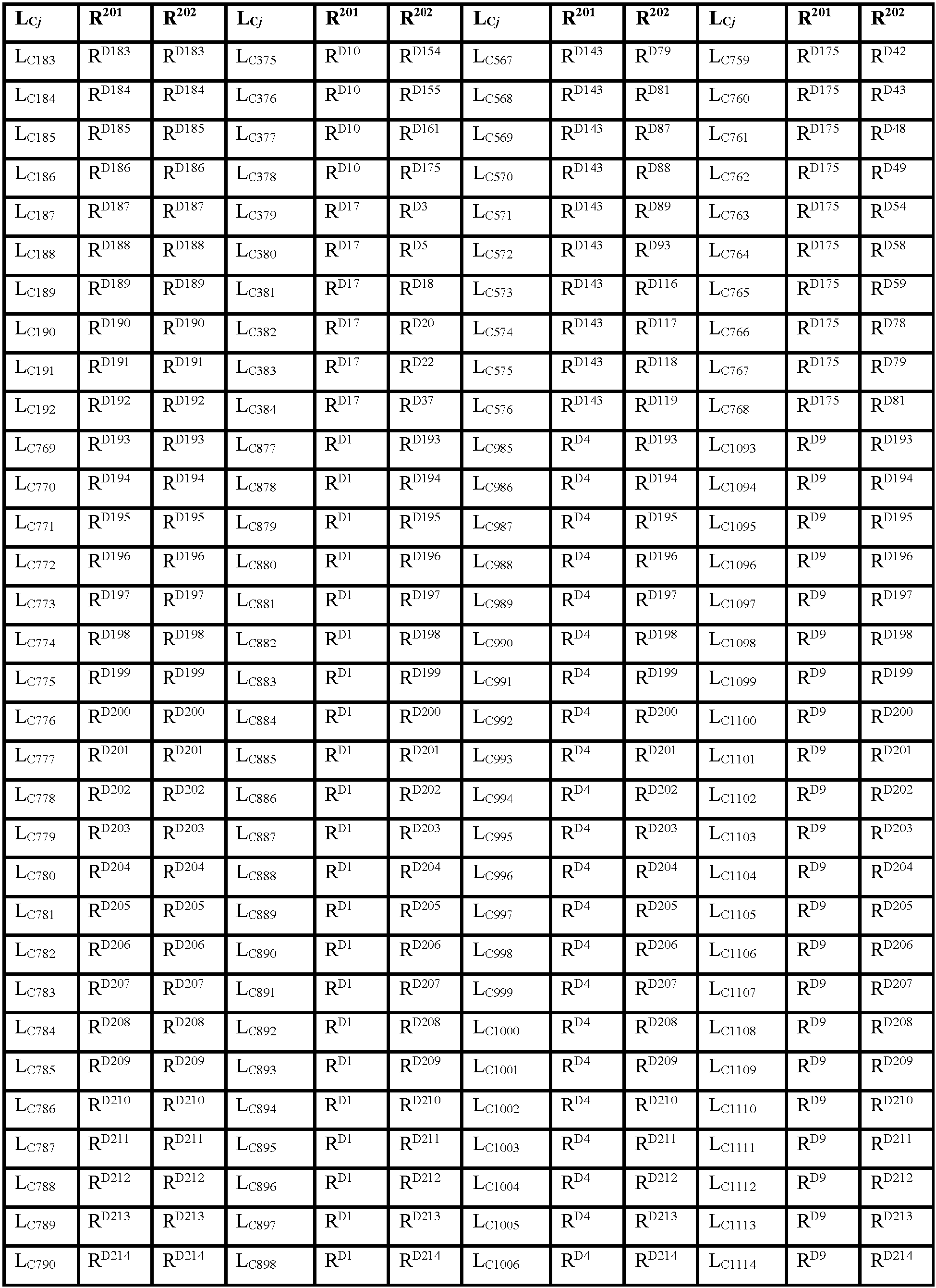 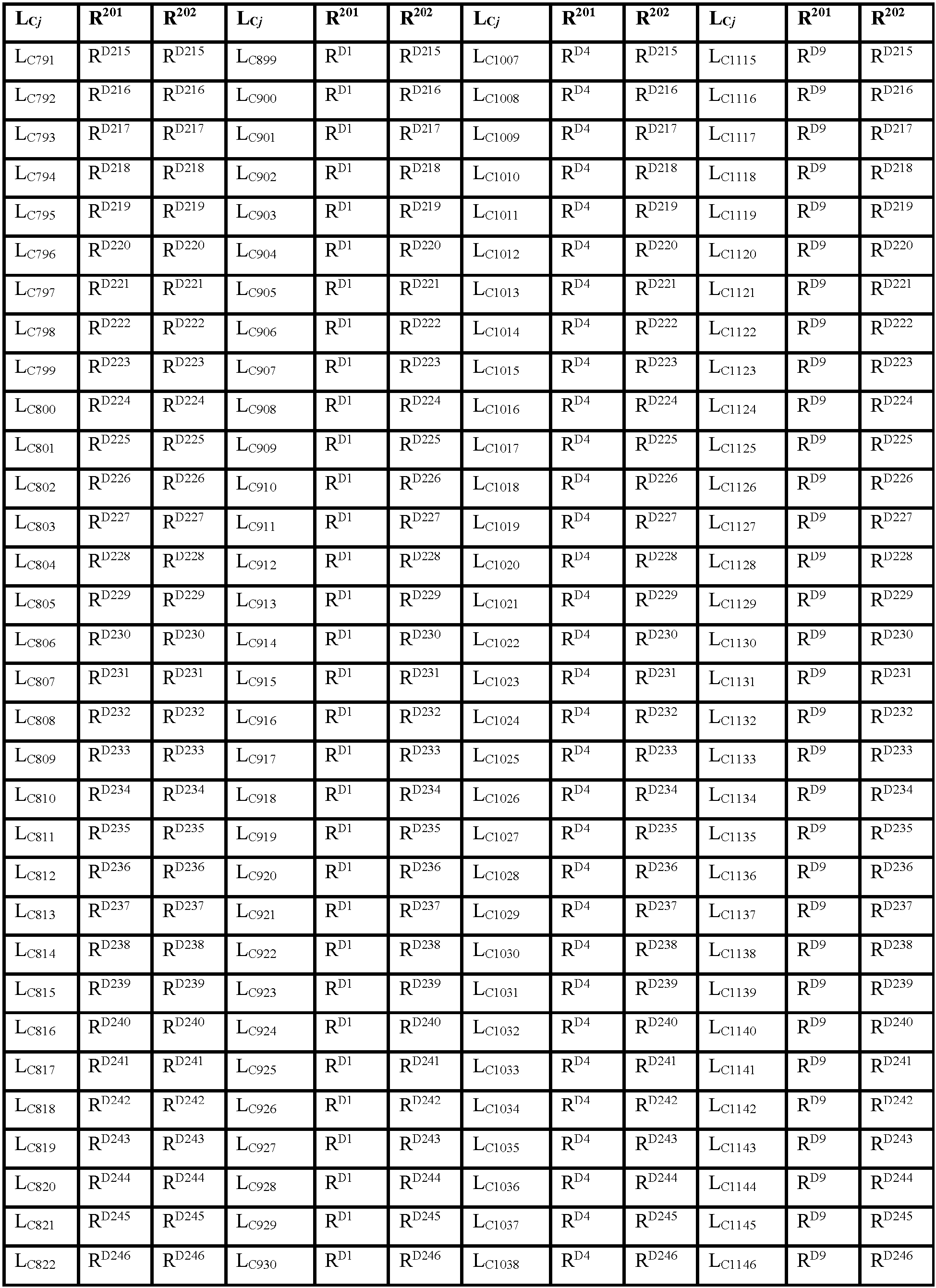 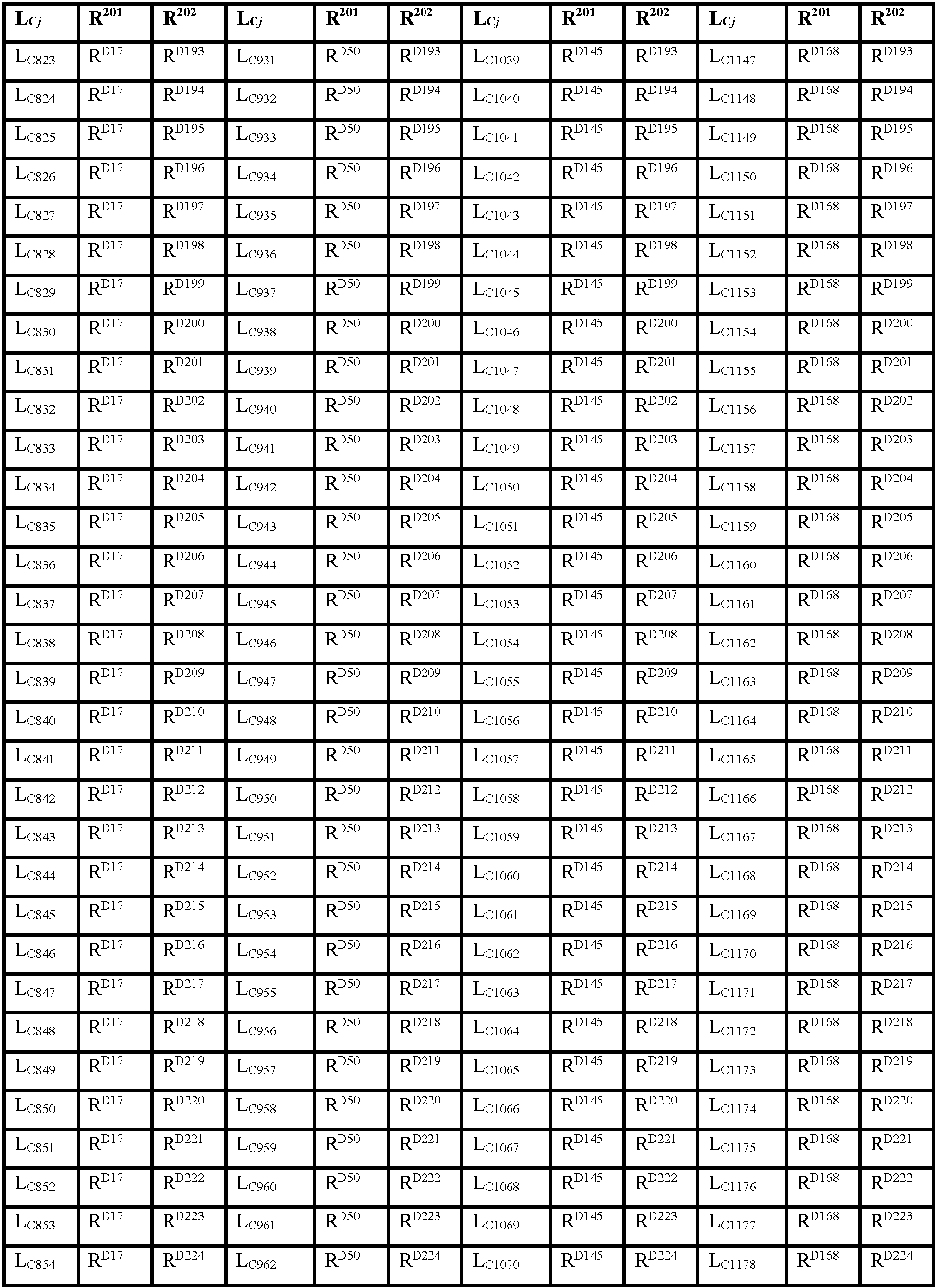 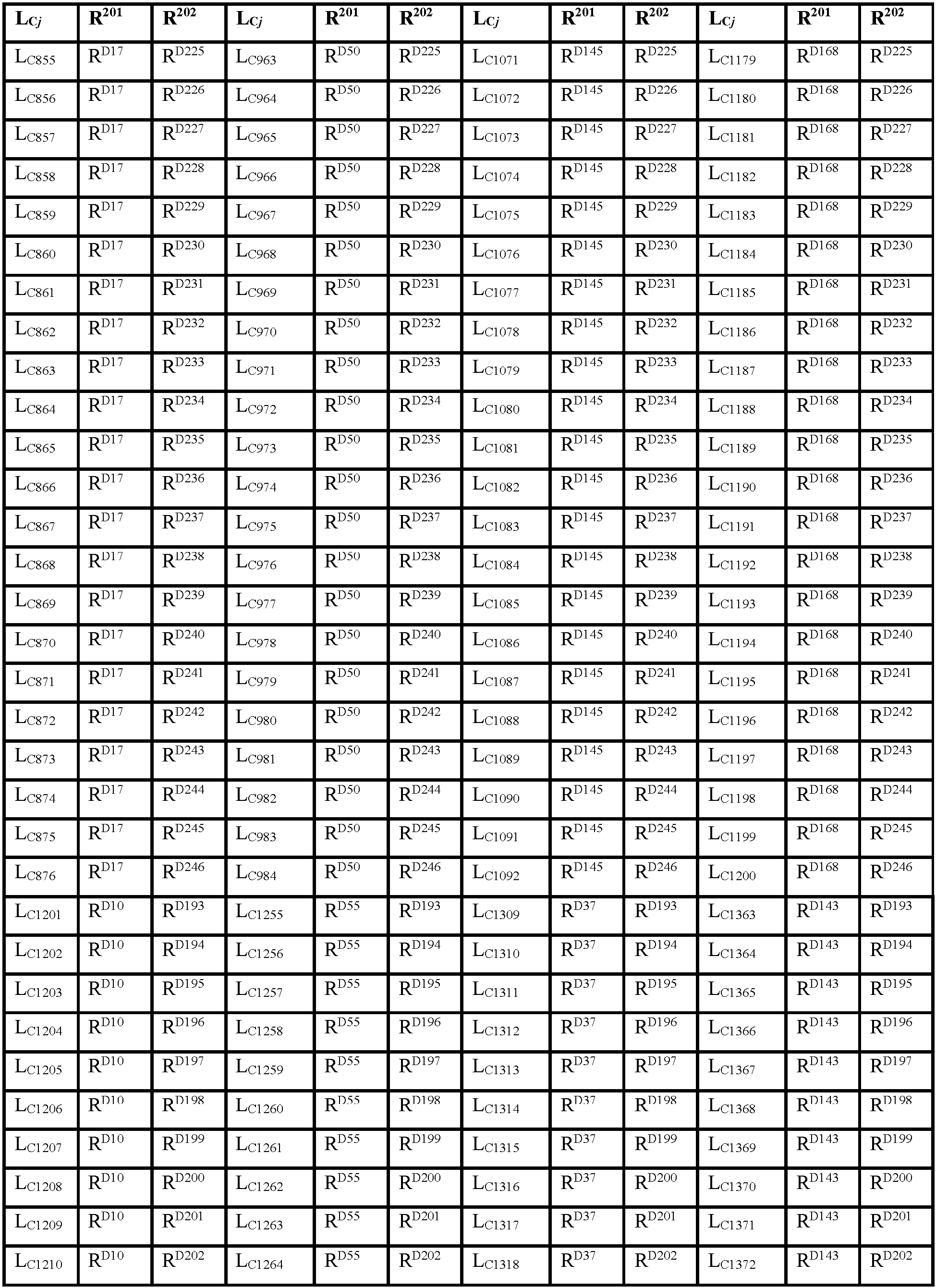 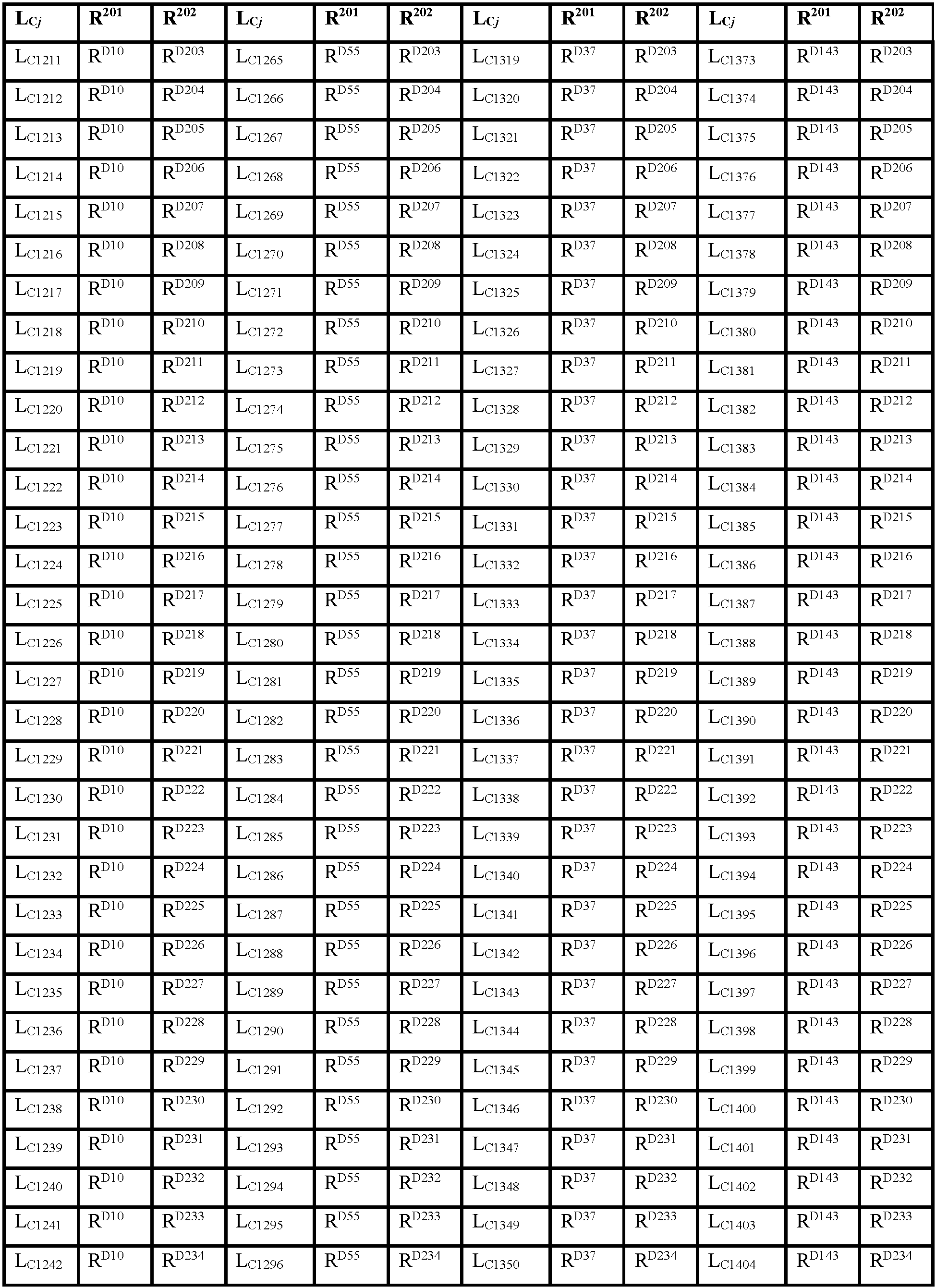 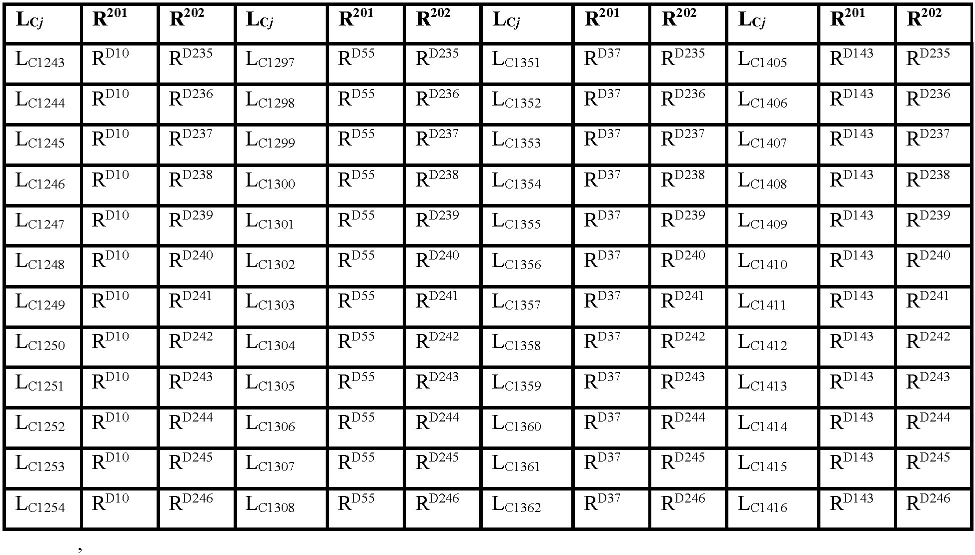
dans lesquelles R^{D1} à R^{D246} ont les structures suivantes :

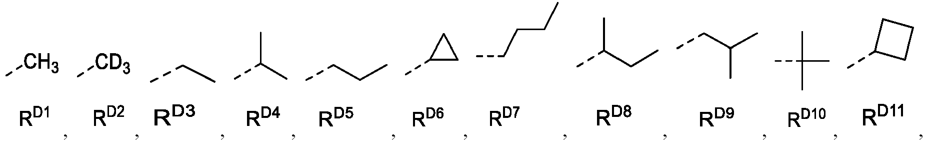

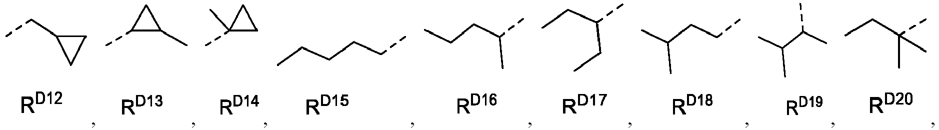

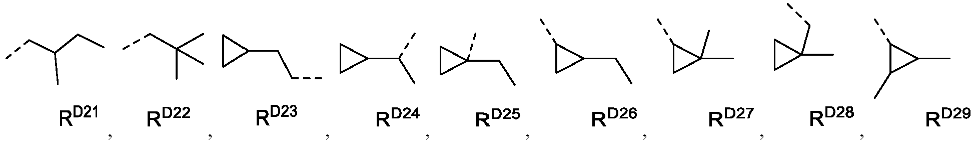

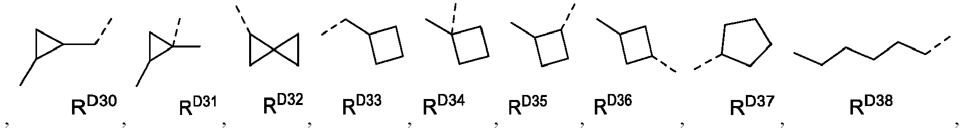

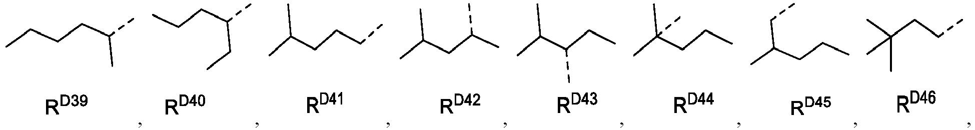

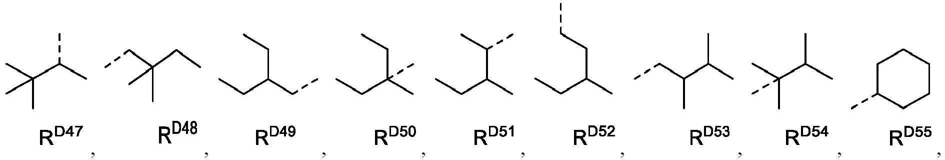

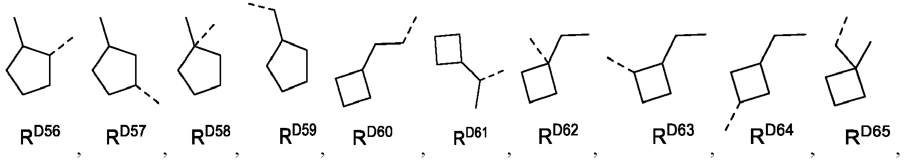

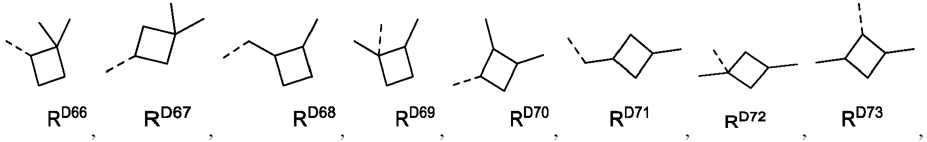

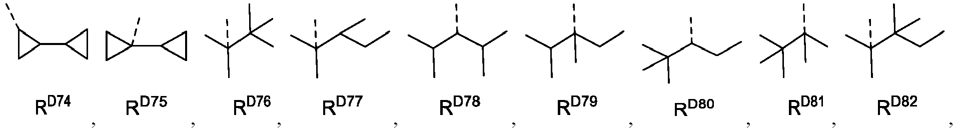

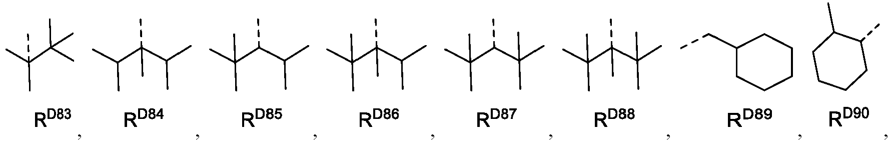

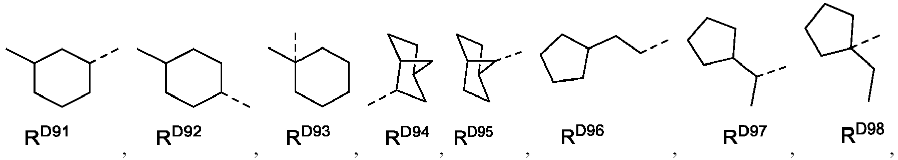

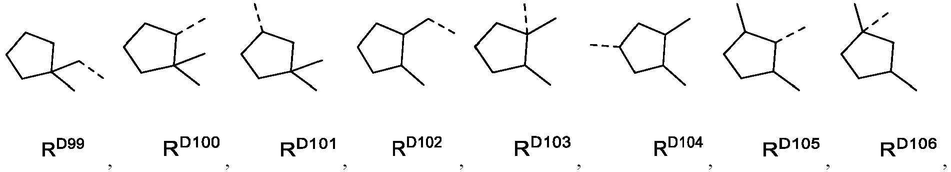

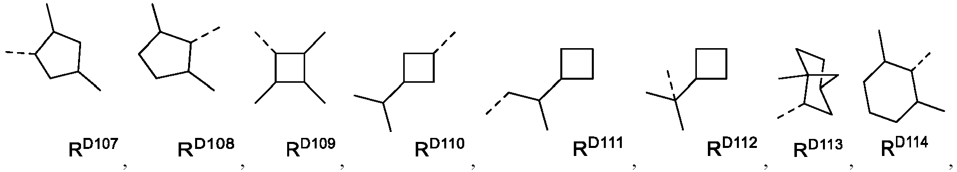

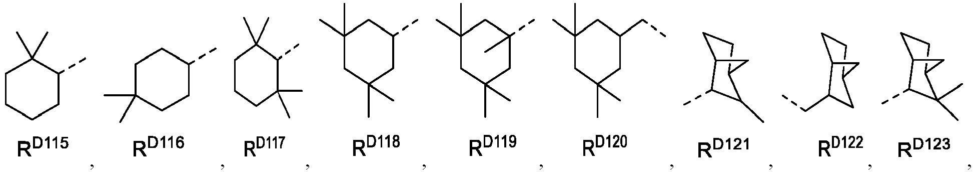

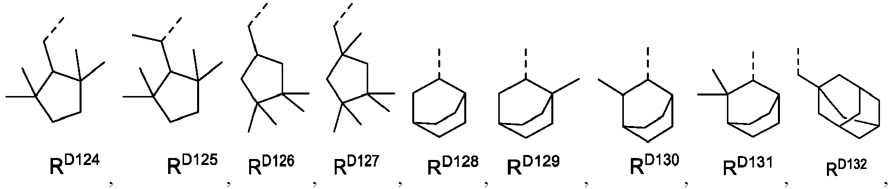

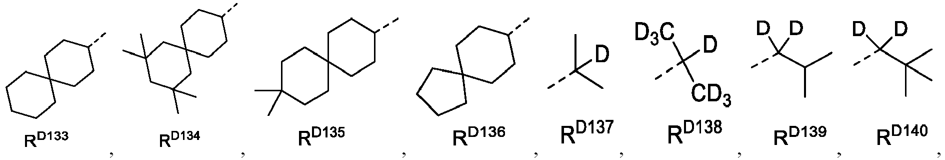

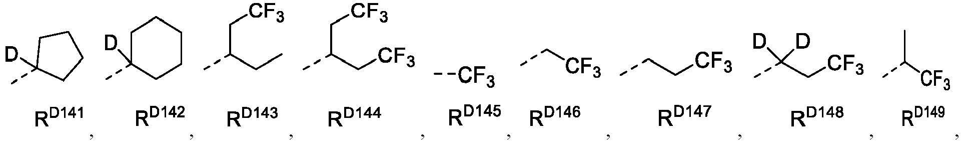

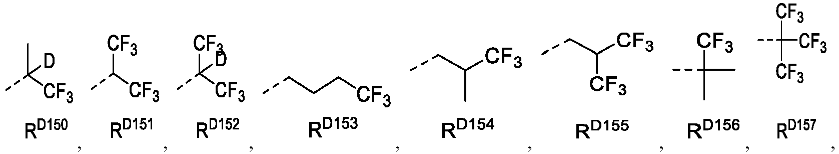

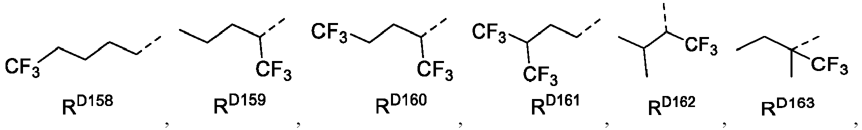

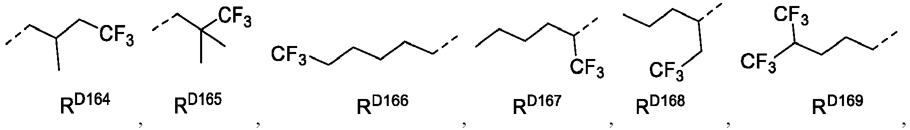

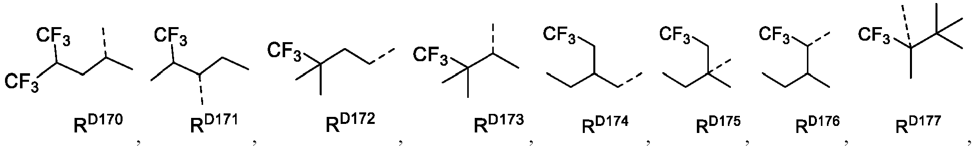

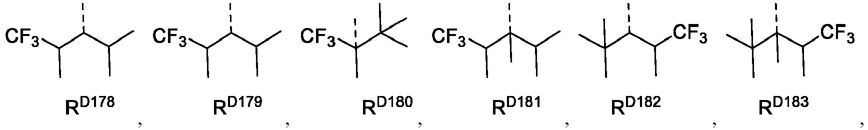

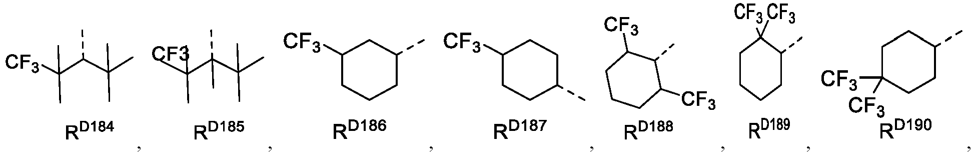

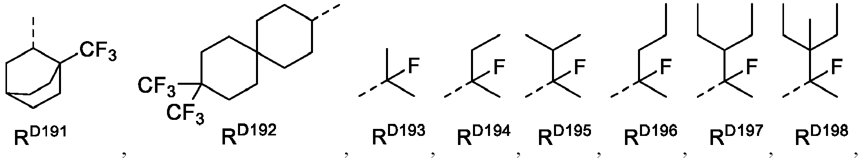

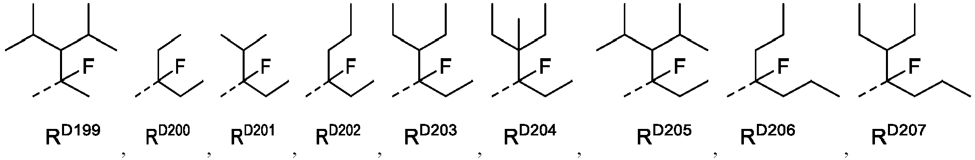

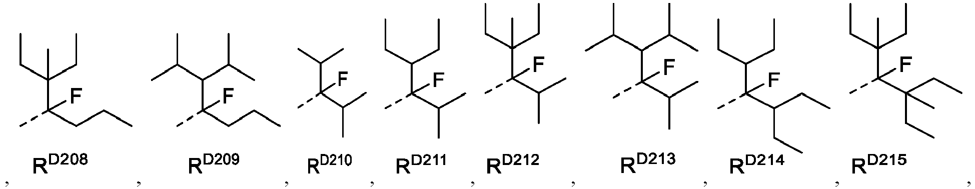

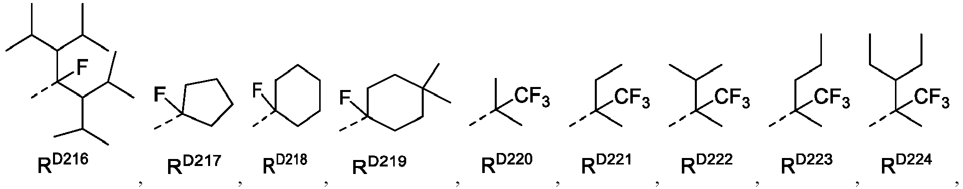

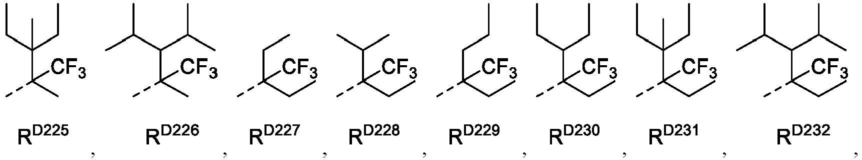

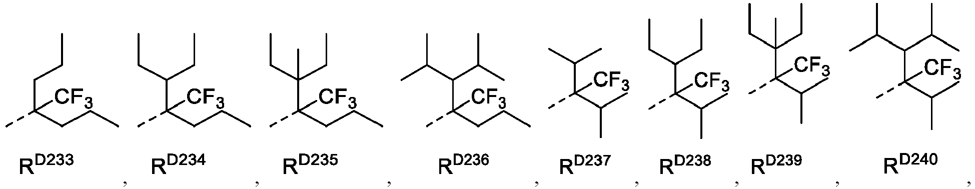

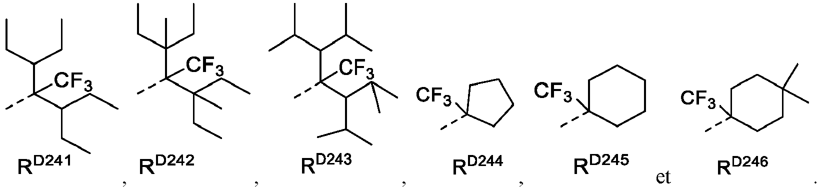

13. Composé selon la revendication 1, dans lequel le composé est choisi parmi le groupe constitué de : 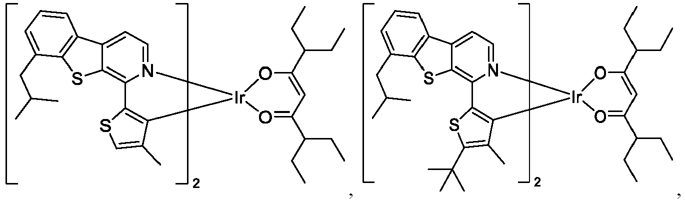 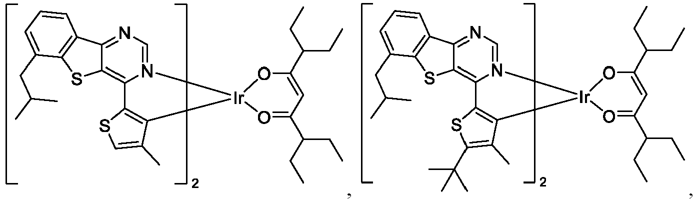 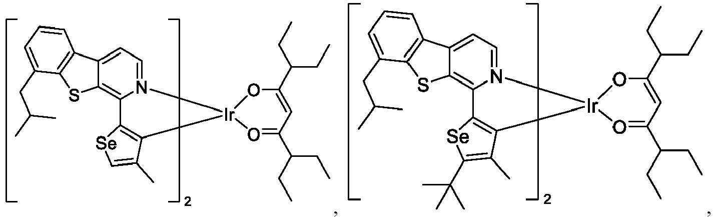 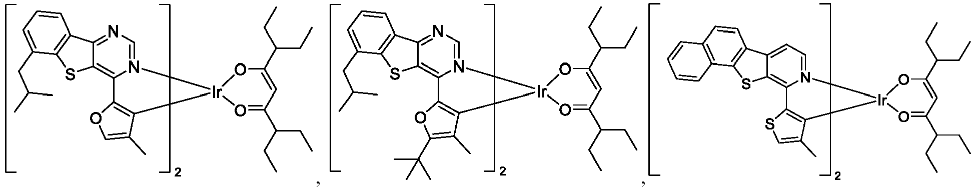 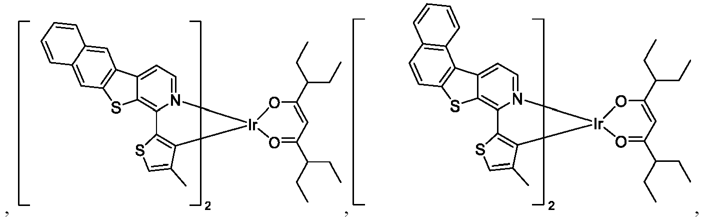 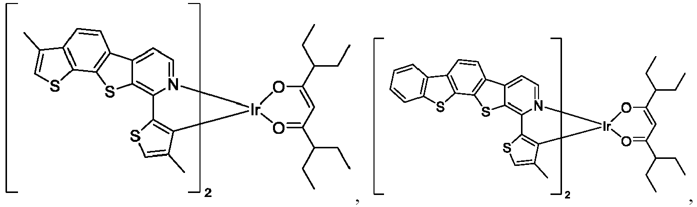 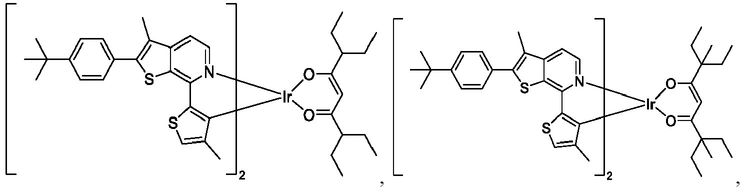 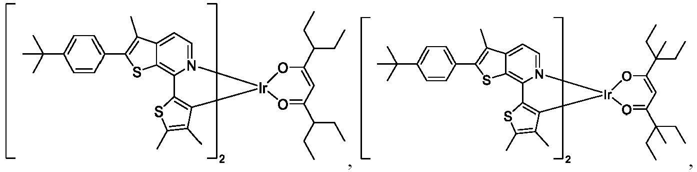 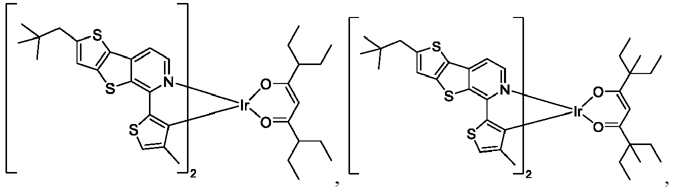 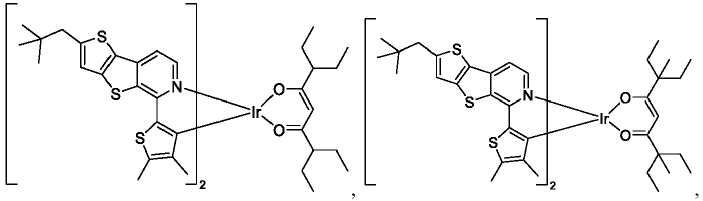 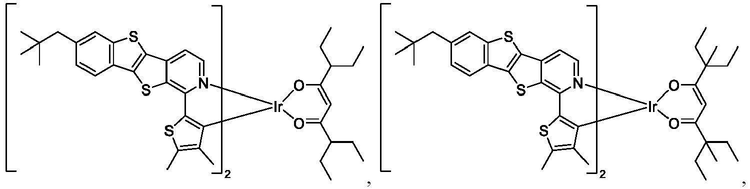 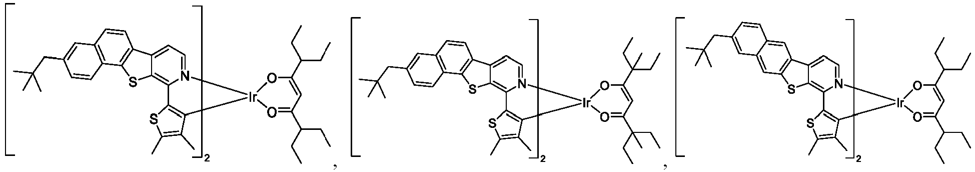 et

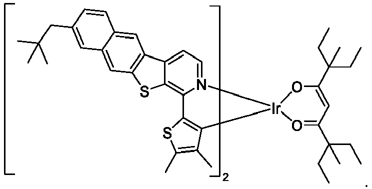

14. Composé selon l'une quelconque des revendications 1 à 12, dans lequel le composé a une structure de 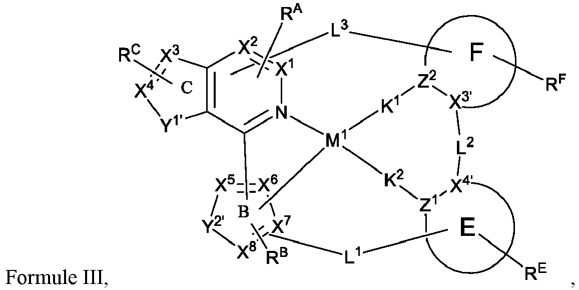 dans laquelle :
M¹ est Pd ou Pt,
les groupements E et F sont chacun, indépendamment l'un de l'autre, une structure à noyau fusionné monocyclique ou polycyclique comportant des noyaux carbocycliques ou hétérocycliques à 5 chaînons et/ou à 6 chaînons,
Z¹ et Z² sont chacun, indépendamment l'un de l'autre, C ou N,
K¹ et K² sont choisis chacun, indépendamment l'un de l'autre, parmi le groupe constitué d'une liaison directe, O, et S, dans lequel au moins un élément parmi K¹ et K² est une liaison directe,
L¹, L² et L³ sont choisis chacun, indépendamment les uns des autres, parmi le groupe constitué d'une liaison simple, à l'exception d'une liaison, O, S, SO, SO₂, C=O, C=NR', C=CR'R", CR'R", SiR'R", BR' et NR', dans lequel au moins un élément parmi L¹ et L² est présent,
X³ et X^{4'} sont chacun, indépendamment l'un de l'autre, C ou N,
R^{E} et R^{F} représentent chacun, indépendamment l'un de l'autre, une mono-substitution ou jusqu'à un nombre maximal de substitutions autorisées, ou aucune substitution,
les éléments R', R", R^{E} et R^{F} sont chacun, indépendamment les uns des autres, un hydrogène ou un substituant choisi parmi le groupe constitué du deutérium, du fluor, d'un alkyle, d'un cycloalkyle, d'un hétéroalkyle, d'un alcoxy, d'un aryloxy, d'un amino, d'un silyle, d'un boryle, d'un alcényle, d'un cycloalcényle, d'un hétéroalcényle, d'un aryle, d'un hétéroaryle, d'un nitrile, d'un isonitrile, d'un sulfanyle et de combinaisons de ceux-ci, et
deux éléments adjacents quelconques parmi R, R', R", R^{A}, R^{C}, R^{E} et R^{F} peuvent être liés ou fusionnés ensemble pour former un cycle.

15. Dispositif électroluminescent organique (OLED) comportant :
une anode,
une cathode, et
une couche organique disposée entre l'anode et la cathode, dans lequel la couche organique comporte un composé selon l'une quelconque des revendications précédentes.

16. Produit de consommation comportant un dispositif électroluminescent organique comportant :
une anode,
une cathode, et
une couche organique disposée entre l'anode et la cathode, dans lequel la couche organique comporte un composé selon l'une quelconque des revendications 1 à 14.
